(19) **Europäisches Patentamt / European Patent Office / Office européen des brevets**

(11) **EP 3 457 606 B1**

(12) **EUROPEAN PATENT SPECIFICATION**

(45) Date of publication and mention of the grant of the patent:
**02.03.2022 Bulletin 2022/09**

(21) Application number: **18765530.3**

(22) Date of filing: **04.05.2018**

(51) International Patent Classification (IPC):
**H04L 1/00** *(2006.01)*    **H03M 13/13** *(2006.01)*
**H03M 13/05** *(2006.01)*

(52) Cooperative Patent Classification (CPC):
**H04L 1/0043; H03M 13/13; H04L 1/0009**

(86) International application number:
**PCT/CN2018/085567**

(87) International publication number:
**WO 2019/024555 (07.02.2019 Gazette 2019/06)**

(54) **METHOD AND DEVICE FOR ENCODING POLAR CODE**

POLARCODE-CODIERUNGSVERFAHREN UND -VORRICHTUNG

DISPOSITIF ET PROCÉDÉ DE CODAGE DE CODE POLAIRE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **02.08.2017 CN 201710653644**

(43) Date of publication of application:
**20.03.2019 Bulletin 2019/12**

(73) Proprietor: **Huawei Technologies Co., Ltd.**
**Shenzhen, Guangdong 518129 (CN)**

(72) Inventors:
- **WANG, Jun**
  **Shenzhen**
  **Guangdong 518129 (CN)**
- **ZHANG, Gongzheng**
  **Shenzhen**
  **Guangdong 518129 (CN)**
- **ZHANG, Huazi**
  **Shenzhen**
  **Guangdong 518129 (CN)**
- **XU, Chen**
  **Shenzhen**
  **Guangdong 518129 (CN)**
- **HUANG, Lingchen**
  **Shenzhen**
  **Guangdong 518129 (CN)**
- **DAI, Shengchen**
  **Shenzhen**
  **Guangdong 518129 (CN)**
- **LUO, Hejia**
  **Shenzhen**
  **Guangdong 518129 (CN)**
- **QIAO, Yunfei**
  **Shenzhen**
  **Guangdong 518129 (CN)**
- **LI, Rong**
  **Shenzhen**
  **Guangdong 518129 (CN)**
- **WANG, Jian**
  **Shenzhen**
  **Guangdong 518129 (CN)**
- **CHEN, Ying**
  **Shenzhen**
  **Guangdong 518129 (CN)**
- **POLIANSKII, Nikita**
  **Shenzhen**
  **Guangdong 518129 (CN)**
- **KAMENEV, Mikhail**
  **Shenzhen**
  **Guangdong 518129 (CN)**
- **SHEN, Zukang**
  **Shenzhen**
  **Guangdong 518129 (CN)**
- **HAUNGFU, Yourui**
  **Shenzhen**
  **Guangdong 518129 (CN)**
- **DU, Yinggang**
  **Shenzhen**
  **Guangdong 518129 (CN)**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**(Cont. next page)**

(74) Representative: **Pfenning, Meinig & Partner mbB**
**Patent- und Rechtsanwälte**
**Joachimsthaler Straße 10-12**
**10719 Berlin (DE)**

(56) References cited:
**CN-A- 105 099 622      CN-A- 105 743 621**
**CN-A- 107 592 181      US-A1- 2014 331 083**

- **QUALCOMM INCORPORATED: "Design of Polar codes for control channel", 3GPP DRAFT; R1-1700832 DESIGN OF POLAR CODES FOR CONTROL CHANNEL, 3RD GENERATION PARTNERSHIP PROJECT (3GPP), MOBILE COMPETENCE CENTRE ; 650, ROUTE DES LUCIOLES ; F-06921 SOPHIA-ANTIPOLIS CEDEX ; FRANC , vol. RAN WG1, no. Spokane, USA; 20170116 - 20170120 16 January 2017 (2017-01-16), XP051208351, Retrieved from the Internet: URL:http://www.3gpp.org/ftp/Meetings_3GPP_ SYNC/RAN1/Docs/ [retrieved on 2017-01-16]**
- **SAMSUNG: "Design of a Nested Sequence for Polar Codes", 3GPP DRAFT; R1-1705425_DESIGN OF A NESTED SEQUENCE FOR POLAR CODES_FINAL, 3RD GENERATION PARTNERSHIP PROJECT (3GPP), MOBILE COMPETENCE CENTRE ; 650, ROUTE DES LUCIOLES ; F-06921 SOPHIA-ANTIPOLIS CEDEX , vol. RAN WG1, no. Spokane, Washington, USA; 20170403 - 20170407 2 April 2017 (2017-04-02), XP051243555, Retrieved from the Internet: URL:http://www.3gpp.org/ftp/Meetings_3GPP_ SYNC/RAN1/Docs/ [retrieved on 2017-04-02]**

- **HUAWEI ET AL: "Channel coding chain for control channel", 3GPP DRAFT; R1-1710003 CHANNEL CODING CHAIN FOR CONTROL CHANNEL, 3RD GENERATION PARTNERSHIP PROJECT (3GPP), MOBILE COMPETENCE CENTRE ; 650, ROUTE DES LUCIOLES ; F-06921 SOPHIA-ANTIPOLIS CEDEX ; FRANCE , vol. RAN WG1, no. Qingdao, China; 20170627 - 20170630 26 June 2017 (2017-06-26), XP051299228, Retrieved from the Internet: URL:http://www.3gpp.org/ftp/Meetings_3GPP_ SYNC/RAN1/Docs/ [retrieved on 2017-06-26]**
- **NTT DOCOMO: "Sequence design of Polar codes", 3GPP DRAFT; R1-1708489, 3RD GENERATION PARTNERSHIP PROJECT (3GPP), MOBILE COMPETENCE CENTRE ; 650, ROUTE DES LUCIOLES ; F-06921 SOPHIA-ANTIPOLIS CEDEX ; FRANCE , vol. RAN WG1, no. Hangzhou, China; 20170515 - 20170519 14 May 2017 (2017-05-14), XP051273681, Retrieved from the Internet: URL:http://www.3gpp.org/ftp/Meetings_3GPP_ SYNC/RAN1/Docs/ [retrieved on 2017-05-14]**

**Description**

**TECHNICAL FIELD**

Embodiments of this application relate to the field of communications technologies, and in particular, to a polar code encoding method and apparatus, a wireless device, a computer storage medium, and a computer program product.

**BACKGROUND**

As the most fundamental wireless access technology, channel coding plays a key role in ensuring reliable transmission of data. In an existing wireless communications system, channel coding is usually performed by using a turbo code, a low-density parity-check (low-density parity-check, LDPC) code, and a polar (Polar) code. The turbo code cannot support information transmission at an excessively low or excessively high bit rate. For medium/short packet transmission, due to encoding/decoding characteristics of the turbo code and the LDPC code, it is very difficult for the turbo code and the LDPC code to achieve ideal performance in a case of a limited code length. In terms of implementation, the turbo code and the LDPC code have relatively high computational complexity in an encoding/decoding implementation process. The polar code is a good code that has been theoretically proved to be able to achieve the Shannon capacity and has relatively low encoding/decoding complexity, and therefore is more widely applied.

However, with rapid evolution of wireless communications systems, future communications systems such as 5th generation (5th generation, 5G) communications systems will have some new characteristics. For example, three most typical communication scenarios include enhanced mobile broadband (enhance mobile broadband, eMBB), massive machine type communications (massive machine type communication, mMTC), and ultra-reliable and low-latency communications (ultra reliable low latency communication, URLLC). The communications scenarios have higher requirements on encoding/decoding performance of the polar code.

Reliability ordering for polarized channels plays a key role in the encoding/decoding performance of the polar code.

However, at present, accuracy of reliability ordering for polarized channels is not desirable, hindering further improvement of the encoding/decoding performance of the polar code during application. R1-1700832 discloses the concept that a single sorted index sequence with a length of 512 is used for code construction for polar coding. The index sequence is sorted in ascending order of reliability and is nested over both variable rates and variable coded block sizes with a length of power of 2. For uplink, the sequence with a length of 1024 is obtained by extending the original sequence with a length of 512.

R1-1705425 discloses an example of a nested code sequence with a length of 1024.

R1-1710003 discloses an ordered nested sequence bit positions (index sequence) is generated according to the reliability of each bit position and stored. $N_{max}$ is the maximum mother code length of Polar codes. The reliability of each bit position is measured through a weight sequence.

R1-1708489 discloses another nested ordered sequence with a length of 1024.

**SUMMARY**

Embodiments of this application provide a polar code encoding method and apparatus, a wireless device, a computer storage medium, and a computer program product, to improve accuracy of reliability ordering for polarized channels.

The embodiments according to the claimed invention correspond to the embodiments with sequence and table Q11. The other sequences and tables are provided as background art.

According to a first aspect, a polar code encoding method according to claim 1 is provided. Possible designs of the first aspect are provided in claims 2 to 5. Therefore, positions of the information bits and fixed bits are determined by calculating reliability of polarized channels of a polar code without considering a channel parameter and a bit rate. In this way, computational complexity of polar code encoding may be reduced.

According to a second aspect, a polar code encoding apparatus according to claim 6 is provided. Possible designs of the second aspect are provided in claims 7 to 11.

According to a third aspect, a computer storage medium storing a computer program is provided. The computer program includes an instruction used to perform the method according to the first aspect and the possible designs of the first aspect.

According to a forth aspect, a computer program product including an instruction is provided. When run on a computer, the instruction causes the computer to perform the method according to the first aspect and the possible designs of the first aspect.

According to a fifth aspect, a wireless device is provided. The wireless device includes an encoding apparatus described in f the second aspect and the possible designs of the second aspect, a modulator, and a transceiver, where

the modulator is configured to modulate a bit sequence after encoding, to obtain a modulated sequence; and
the transceiver is configured to process the modulated sequence.

In a possible design, the wireless device is a terminal or a network device.

**BRIEF DESCRIPTION OF DRAWINGS**

FIG. 1 is a schematic architectural diagram of a communications system applied in an embodiment not covered by the claimed invention;
FIG. 2 is a schematic flowchart of a polar code encoding method according to an embodiment of this application;
FIG. 3 is a first schematic structural diagram of a polar code encoding apparatus according to an embodiment of this application;
FIG. 4 is a second schematic structural diagram of a polar code encoding apparatus according to an embodiment not covered by the claimed invention;
FIG. 5 is a third schematic structural diagram of a polar code encoding apparatus according to an embodiment not covered by the claimed invention; and
FIG. 6 is a fourth schematic structural diagram of a polar code encoding apparatus according to an embodiment of this application.

**DESCRIPTION OF EMBODIMENTS**

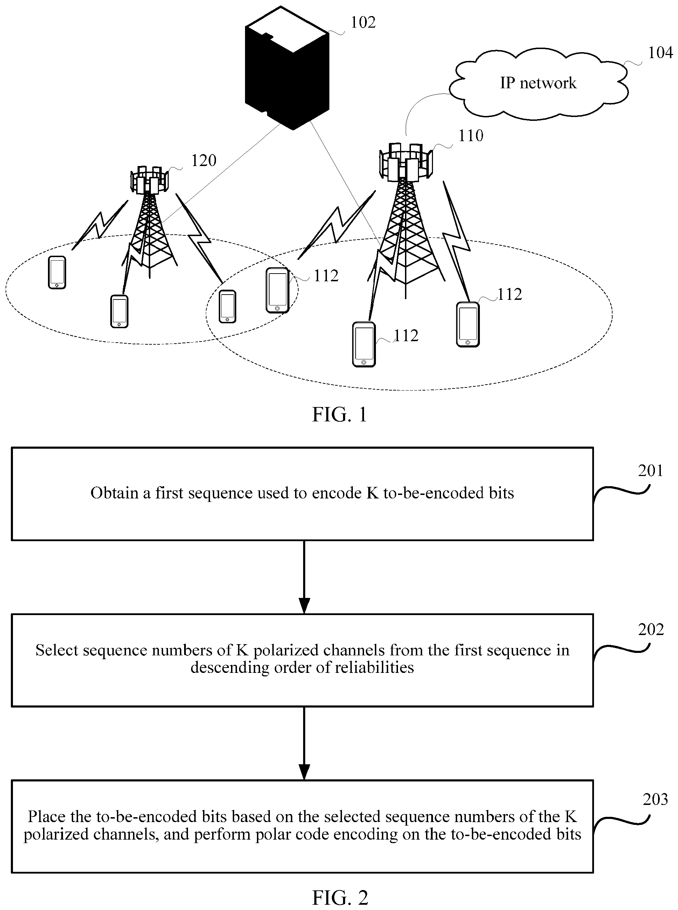

The following describes in detail the embodiments of this application with reference to accompanying drawings. The invention is defined in the embodiments of this application with reference to the accompanying FIG. 2, FIG. 3 and FIG. 6.
The embodiments of this application provide a polar code encoding method and apparatus, a wireless device, a computer storage medium, and a computer program product. A reliability order is obtained based on reliability of polarized channels, sequence numbers of polarized channels used to send information bits are selected based on the reliability order, and polar code encoding is performed based on the sequence numbers selected for the information bits. In the embodiments of this application, a reliability of each subchannel of a polar code can be calculated more accurately. The encoding method and apparatus, the wireless device, the computer storage medium, and the computer program product provided in the embodiments of the present invention are described below in detail with reference to the accompanying drawings.
To facilitate understanding of the embodiments of this application, the following describes the polar code briefly.
In an encoding scheme of the polar code, a noiseless channel is used to transmit information useful for a user, and a pure noisy channel is used to transmit agreed information or is not used to transmit information. The polar code is a linear block code, with its encoding matrix being $G_N$ and its encoding process being $x_1^N = u_1^N G_N$, , where $u_1^N = (u_1, u_2, \ldots, u_N)$ is a binary row vector having a length of $N$ (that is, code length), $G_N$ is an $N \times N$ matrix, and $G_N = F_2^{\otimes(\log_2(N))}$. $F_2^{\otimes(\log_2(N))}$ is defined as a Kronecker (Kronecker) product of $\log_2 N$ matrices $F_2$. The foregoing matrix $F_2 = \begin{bmatrix} 1 & 0 \\ 1 & 1 \end{bmatrix}$.

In the encoding process of the polar code, some bits in $u_1^N$ are used to carry information and are referred to as an information bit set, and an index set of the bits is denoted as A. Other bits are set to fixed values pre-agreed on by a receive end and a transmit end and are referred to as a fixed bit set or a frozen bit set (frozen bits), and an index set of the other bits is represented by a complementary set $A^c$ of A . The encoding process of the polar code is equivalent to $x_1^N = u_A G_N(A) \oplus u_{A^c} G_N(A^c)$, where $G_N(A)$ is a sub-matrix obtained from rows that correspond to the indexes in the set A in $G_N$, and $G_N(A^C)$ is a sub-matrix obtained from rows that correspond to the indexes in the set $A^c$ in $G_N$. $u_A$ is the information bit set in $u_1^N$, and includes K information bits. Usually, various check bits including but not limited to a cyclic redundancy check (Cyclic Redundancy Check, CRC for short) bit and a parity check (Parity Check, PC for short) bit are also included in the information bit set. $u_{Ac}$ is the fixed bit set in $u_1^N$, and includes N - K fixed bits, which are known bits. The fixed bits are usually set to 0. However, the fixed bits may be set arbitrarily provided that the receive end and the transmit end pre-agree. Therefore, an encoding output of the polar code may be simplified to:

$$x_1^N = u_A G_N(A)$$

. Herein, $u_A$ is an information bit set in $u_1^N$, and $u_A$ is a row vector of a length $K$, that is, $|A| = K$, where $|\cdot|$ represents a quantity of elements in a set, and K is a size of an information block; $G_N(A)$ is a sub-matrix obtained by using rows that correspond to the indexes in the set A in the matrix $G_N$, and $G_N(A)$ is a $K \times N$ matrix.

A process of constructing the polar code, that is, a process of selecting the set A , determines performance of the polar code. Usually, the process of constructing the polar code is: determining, based on a mother code length N, that there are a total of N polarized channels that respectively correspond to N rows of the encoding matrix, calculating reliability of the polarized channels, and using indexes of the first K polarized channels having relatively high reliability as elements of the set A, and indexes that correspond to the remaining N-K polarized channels are used as elements of the index set $A^c$ of the fixed bits. The set A determines positions of the information bits, and the set $A^c$ determines positions of the fixed bits. A sequence number of a polarized channel is an index of the position of an information bit or a fixed bit, that is, an index of a position in $u_1^N$.

The solutions provided in the embodiments of this application relate to how to determine reliability of a polarized channel. A basic invention idea of the embodiments of this application is that reliability of the polarized channel may be represented by using a reliability. From a perspective of spectral analysis of signals, an approximation of an existing reliability to the polarized channel reliability may be understood as domain transform of a signal. Similar to Fourier transform in which transformation between a time domain and a frequency domain of a signal is implemented by using a kernel $e^{jw}$, in this method, a signal is transformed from a channel sequence number domain to a reliability weight domain by using a $\beta$ kernel. In the signal time-frequency analysis field, Fourier transform and wavelet transform are most commonly used. For the Fourier transform, limited by a form of the trigonometric function kernel $e^{jw}$, high time domain resolution and high frequency domain resolution cannot be achieved at the same time in a signal time-frequency analysis process. For the wavelet transform, because a wavelet kernel is used and there are various forms of functions, an instantaneous change of a signal in time domain can be captured when domain transform is performed, so that both high time domain resolution and high frequency domain resolution can be achieved. In the embodiments of this application, the polarized channel reliability is estimated by using a changeable transform kernel, so that accuracy of sequence reliability estimation is improved.

FIG. 1 is a schematic structural diagram of a wireless communications network according to an embodiment not covered by the claimed invention. FIG. 1 is merely an example. Other wireless networks to which the encoding method or apparatus of the embodiments of the present invention can be applied shall all fall within the protection scope of the present invention.

As shown in FIG. 1, a wireless communications network 100 includes a network device 110 and a terminal 112. When the wireless communications network 100 includes a core network 102, the network device 110 may further be connected to the core network 102. The network device 110 may further communicate with an IP network 104, for example, an Internet (internet), a private IP network, or another data network. The network device provides a service for a terminal within coverage of the network device. For example, as shown in FIG. 1, the network device 110 provides wireless access for one or more terminals 112 within coverage of the network device 110. In addition, there may be an overlapping area between coverage of network devices, for example, the network device 110 and a network device 120. The network devices may further communicate with each other, for example, the network device 110 may communicate with the network device 120.

The foregoing network device may be a device configured to communicate with a terminal device. For example, the network device may be a base transceiver station (Base Transceiver Station, BTS) in a GSM system or a CDMA system, or may be a NodeB (NodeB, NB) in a WCDMA system, or may further be an evolved NodeB (Evolved Node B, eNB or eNodeB) in an LTE system or a network side device in a future 5G network. Alternatively, the network device may be a relay station, an access point, an in-vehicle device, or the like. In a device to device (Device to Device, D2D) communications system, the network device may alternatively be a terminal that plays a role of a base station.

The foregoing terminal may refer to user equipment (User Equipment, UE), an access terminal, a user unit, a mobile station, a remote station, a remote terminal, a mobile device, a user terminal, a wireless communications device, a user agent, or a user apparatus. The access terminal may be a cellular phone, a cordless phone, a Session Initiation Protocol (Session Initiation Protocol, SIP) phone, a wireless local loop (Wireless Local Loop, WLL) station, a personal digital assistant (Personal Digital Assistant, PDA), a handheld device having a wireless communication function, a computing device, another processing device connected to a wireless modem, an in-vehicle device, a wearable device, a terminal device in a future 5G network, or the like. Based on a communications system architecture shown in FIG. 1, in this embodiment not covered by the claimed invention, the polar code encoding method may be executed by the foregoing network device or terminal. The polar code encoding method may be used when the network device or the terminal serves as a transmit end to send data or information. Correspondingly, when the network device or the terminal serves as a receive end to receive data or information, a subchannel sequence needs to be determined first based on the method of the present invention. The following describes in detail the polar code encoding method provided in the embodiments of this application.

Based on the communications system architecture shown in FIG. 1, as shown in FIG. 2, a specific procedure of a polar code encoding method provided in an embodiment of this application is as follows.

Step 201. Obtain a first sequence used to encode K to-be-encoded bits.

The first sequence includes sequence numbers of N polarized channels, the sequence numbers of the N polarized channels are arranged in the first sequence based on reliability of the N polarized channels, K is a positive integer, N is a mother code length of a polar code, and N is a positive integer power of 2.

Step 202. Sequence numbers of K polarized channels are selected from the first sequence in descending order of reliability.

Step 203. Place the to-be-encoded bits based on the selected sequence numbers of the K polarized channels, and perform polar code encoding on the to-be-encoded bits.

The K to-be-encoded bits are mapped to the K polarized channels in the N polarized channels. The reliability of the K polarized channels are higher than reliability of the remaining N-K polarized channels.

The first sequence is all of or a subset of a second sequence, the second sequence includes sequence numbers of $N_{max}$ polarized channels, the sequence numbers of the $N_{max}$ polarized channels are arranged in the second sequence based on reliability of the $N_{max}$ polarized channels, that is, an order in which the sequence numbers of the polarized channels in the first sequence are arranged is consistent with an order in which sequence numbers less than N in the sequence numbers of the polarized channels in the second sequence are arranged. $N_{max}$ may be a positive integer power of 2 or may not be a positive integer power of 2, and $N_{max} \geq N$. A manner for calculating the reliability of the $N_{max}$ polarized channels is similar to that for calculating the reliability of the N polarized channels. The arrangement based on the reliability herein may be arrangement performed in ascending order of the reliability, or may be arrangement performed in descending order of the reliability. Alternatively, the sequence numbers of the polarized channels are grouped into two or more groups, and the sequence numbers in each group are arranged in descending order or ascending order of the reliability. A specific grouping manner may be grouping based on values of sequence numbers of polarized channels or grouping based on congruential sequence numbers (for example, three groups are divided, and sequence numbers that are congruent modulo 3 are grouped into one group). This is not specifically limited herein.

Optionally, rate matching is performed, based on a target code length, on a sequence obtained after the polar code encoding.

According to the encoding method provided in this embodiment, after input information bits are received, a quantity K of to-be-encoded bits is determined based on a target code length N of a polar code. Regardless of online calculation or a manner in which calculation and storage are performed in advance, if a second sequence is known, a first sequence may be obtained from the second sequence, and when $N_{max}$=N, the second sequence is the first sequence. The second sequence includes an order of reliability of $N_{max}$ polarized channels, where $N_{max}$ is a maximum code length supported by a communications system. Optionally, the first sequence may be obtained from a prestored second sequence, then information bits are determined based on the first sequence, and finally polar encoding is performed on the K to-be-encoded bits, to obtain a bit sequence obtained after the polar encoding. Therefore, positions of the information bits and fixed bits are determined by obtaining a reliability of a polarized channel of a polar code through a combination of online calculation and offline storage.

The following specifically describes a sequence of sequence numbers of polarized channels that is obtained through arrangement based on a reliability of an $i^{th}$ polarized channel in N (or $N_{max}$) polarized channels. The sequence numbers of the N polarized channels may be 0 to N-1, or may be 1 to N. In this embodiment of this application, when the reliability of the $i^{th}$ polarized channel of the N polarized channels is determined, a value of i may be 1, 2, ..., and N, or may be 0, 1, ..., and N-1.

It may be understood that formulas used in the embodiments of this application are merely examples. Any solution that may be obtained by persons skilled in the art by making simple variations to the formulas without affecting performance of the formulas shall fall within the protection scope of the embodiments of this application.

For specific sequence examples, refer to the following six groups of sequences found based on different criteria. The second sequence may be part or all of any sequence shown in Sequence Q1 to Sequence Q30. These sequences may also be represented by using corresponding tables Table Q1 to Table Q30. "Reliability or sequence number of reliability " is a natural sequence of reliability in ascending order, and "polarized channel sequence number" is polarized channel sequence numbers in corresponding sequences. Herein, "part of" has three different meanings:

(1) $N_{max}$ is not a positive integer power of 2, but code lengths in the given examples are all positive integer powers of 2; therefore the second sequence can only be part of any sequence shown in Sequence Q1 to Sequence Q30; or
(2) $N_{max\_encoding-device}$ supported by an encoding device is less than $N_{max\_protocol}$ regulated by a protocol, and therefore only $N_{max\_encoding-device}$ in any sequence shown in Sequence Q1 to Sequence Q30 needs to be selected; or
(3) Part of an actually used sequence having a length of $N_{max}$ is completely consistent with part of any sequence shown in Sequence Q1 to Sequence Q30.

These sequences may also be represented by using Z sequences, that is, an order of reliability of polarized channels that corresponds to a natural order of polarized channel sequence number is used as a Z sequence. To be specific, the second sequence may be part or all of any sequence shown in Sequence Z1 to Sequence Z30. Likewise, the Z sequences may also be represented by using corresponding tables Table Z1 to Table Z30, where the polarized channel sequence numbers are sequentially arranged in ascending order, and "reliability or sequence number of reliability" is a sequence number of ordering of a reliability of a polarized channel that corresponds to the polarized channel sequence number.

For example, an $x^{th}$ Q sequence is Sequence Qx and Table Qx, and Sequence Qx is equivalent to Table Qx. Corresponding Z sequences are Sequence Zx and Table Zx, and Sequence Zx is equivalent to Table Zx, where x = 1, 2, ..., and 30.

First group of sequences (obtained by using a criterion that comprehensively considers performance of code length of 64, 128, 256, 512, and 1024, and preferentially considers performance of a mother code length of 256).

Sequence Q1, having a sequence length of 1024:

[0, 1, 4, 8, 2, 16, 32, 6, 64, 512, 3, 12, 5, 18, 128, 9, 33, 17, 10, 256, 20, 34, 24, 65, 7, 36, 66, 129, 11, 40, 19, 132, 513, 13, 68, 48, 14, 72, 257, 21, 130, 26, 35, 80, 258, 136, 38, 22, 260, 516, 37, 25, 96, 67, 264, 41, 144, 28, 69, 49, 74, 160, 42, 520, 272, 192, 70, 44, 131, 81, 15, 288, 50, 134, 73, 514, 23, 52, 320, 133, 76, 82, 137, 56, 27, 259, 528, 97, 39, 384, 138, 84, 29, 261, 145, 544, 43, 98, 140, 30, 88, 262, 146, 71, 518, 265, 161, 45, 100, 148, 51, 46, 576, 75, 266, 104, 273, 164, 193, 53, 515, 162, 268, 77, 152, 274, 54, 524, 83, 57, 112, 85, 135, 289, 517, 194, 78, 290, 58, 276, 168, 530, 99, 139, 196, 86, 176, 640, 60, 89, 280, 101, 147, 292, 521, 141, 321, 142, 90, 200, 545, 31, 102, 263, 105, 529, 322, 149, 296, 47, 522, 92, 208, 267, 385, 324, 304, 536, 768, 532, 163, 153, 150, 106, 55, 165, 386, 577, 328, 548, 269, 113, 154, 79, 224, 166, 275, 108, 578, 270, 59, 114, 195, 169, 156, 87, 546, 61, 277, 291, 519, 278, 116, 170, 197, 641, 177, 281, 91, 552, 201, 388, 293, 198, 523, 62, 143, 336, 584, 172, 282, 120, 644, 103, 178, 294, 531, 202, 93, 323, 560, 392, 297, 151, 580, 209, 284, 180, 525, 107, 94, 204, 769, 298, 352, 325, 526, 155, 109, 533, 400, 305, 300, 642, 210, 184, 326, 538, 115, 167, 592, 157, 225, 306, 547, 329, 110, 770, 212, 117, 171, 550, 330, 226, 648, 387, 308, 158, 608, 416, 337, 534, 216, 271, 549, 118, 279, 537, 332, 389, 173, 579, 121, 199, 776, 179, 228, 553, 338, 656, 312, 540, 390, 174, 581, 393, 283, 772, 122, 672, 554, 784, 63, 340, 704, 448, 561, 353, 800, 394, 232, 203, 527, 582, 556, 295, 285, 181, 124, 205, 240, 643, 585, 562, 286, 299, 354, 182, 401, 211, 396, 344, 586, 832, 564, 95, 185, 206, 327, 645, 535, 402, 593, 186, 356, 588, 568, 307, 646, 418, 213, 301, 227, 302, 896, 594, 360, 111, 649, 771, 417, 539, 214, 404, 309, 188, 449, 331, 217, 159, 609, 596, 551, 650, 119, 229, 333, 408, 541, 773, 610, 657, 310, 420, 600, 218, 368, 230, 652, 391, 175, 313, 339, 542, 334, 123, 555, 774, 233, 314, 658, 612, 341, 777, 450, 220, 424, 355, 673, 583, 125, 234, 183, 395, 241, 557, 660, 616, 316, 342, 345, 778, 563, 403, 287, 397, 452, 674, 558, 785, 432, 187, 357, 207, 664, 587, 780, 705, 676, 236, 346, 565, 361, 126, 242, 589, 405, 215, 398, 566, 303, 597, 358, 801, 419, 624, 456, 786, 348, 244, 569, 189, 590, 219, 647, 311, 706, 362, 595, 464, 802, 406, 680, 421, 788, 248, 598, 190, 570, 369, 651, 409, 834, 410, 708, 480, 613, 231, 572, 315, 659, 364, 422, 335, 688, 370, 792, 221, 611, 451, 601, 425, 804, 412, 653, 453, 833, 317, 712, 235, 602, 343, 543, 372, 654, 222, 614, 426, 775, 433, 559, 237, 898, 617, 347, 808, 243, 720, 454, 665, 318, 604, 376, 661, 428, 779, 238, 675, 359, 836, 458, 625, 399, 662, 677, 434, 567, 457, 816, 245, 618, 349, 787, 127, 781, 897, 407, 666, 436, 591, 363, 620, 465, 736, 350, 678, 571, 246, 681, 249, 626, 460, 707, 840, 411, 782, 365, 789, 440, 599, 374, 668, 628, 423, 900, 466, 848, 803, 250, 790, 371, 709, 191, 573, 689, 481, 682, 413, 603, 793, 366, 713, 468, 710, 373, 574, 655, 427, 806, 414, 684, 904, 252, 615, 482, 632, 805, 429, 794, 864, 223, 690, 455, 714, 835, 472, 809, 377, 605, 619, 435, 663, 721, 319, 796, 484, 692, 912, 430, 606, 716, 488, 810, 459, 838, 667, 239, 817, 621, 378, 837, 722, 437, 696, 461, 737, 679, 380, 812, 627, 247, 899, 841, 441, 622, 928, 351, 724, 783, 469, 629, 818, 438, 669, 462, 738, 683, 251, 842, 849, 496, 901, 820, 728, 467, 633, 902, 367, 670, 791, 442, 844, 630, 474, 685, 850, 483, 691, 711, 379, 865, 795, 415, 824, 960, 740, 253, 905, 634, 444, 693, 744, 485, 807, 686, 906, 470, 575, 715, 375, 866, 913, 473, 852, 636, 797, 431, 694, 811, 486, 752, 723, 798, 489, 856, 908, 254, 717, 607, 930, 476, 697, 725, 914, 439, 819, 839, 868, 492, 718, 698, 381, 813, 623, 814, 498, 872, 739, 929, 671, 916, 821, 463, 726, 961, 843, 490, 631, 729, 700, 382, 741, 845, 920, 471, 822, 851, 730, 497, 880, 742, 443, 903, 687, 825, 500, 445, 932, 846, 635, 745, 826, 732, 446, 962, 936, 475, 853, 867, 637, 907, 487, 695, 746, 828, 753, 854, 857, 915, 964, 477, 909, 719, 799, 699, 493, 504, 748, 944, 858, 873, 638, 754, 255, 968, 869, 491, 478, 383, 910, 815, 917, 727, 870, 701, 931, 860, 499, 756, 731, 823, 922, 874, 976, 918, 502, 933, 743, 760, 881, 494, 702, 921, 876, 501, 847, 992, 447, 733, 827, 882, 934, 963, 505, 937, 747, 855, 924, 734, 829, 965, 938, 884, 506, 749, 945, 859, 755, 479, 966, 830, 888, 940, 750, 871, 970, 911, 757, 946, 969, 861, 977, 875, 919, 639, 758, 948, 862, 761, 508, 972, 923, 877, 952, 886, 935, 978, 762, 503, 883, 703, 993, 925, 878, 980, 941, 764, 495, 926, 885, 994, 735, 939, 984, 967, 889, 947, 831, 507, 942, 751, 973, 996, 890, 949, 759, 892, 971, 1000, 953, 509, 863, 981, 950, 974, 763, 1008, 979, 879, 954, 986, 995, 891, 927, 510, 765, 956, 997, 982, 887, 985, 943, 998, 1001, 766, 988, 951, 1004, 893, 1010, 957, 975, 511, 1002, 894, 983, 1009, 955, 987, 1012, 958, 999, 1005, 989, 1016, 990, 1011, 767, 1003, 1014, 1006, 1017, 895, 1013, 991, 1018, 959, 1020, 1015, 1007, 1019, 1021, 1022, 1023]

Table Q1, having a sequence length of 1024:

| Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number |
|---|---|---|---|---|---|---|---|---|---|---|---|---|---|---|---|

| | | | | | | | | | | | | | | | |
|---|---|---|---|---|---|---|---|---|---|---|---|---|---|---|---|
| 0 | 0 | 128 | 83 | 256 | 526 | 384 | 309 | 512 | 422 | 640 | 223 | 768 | 492 | 896 | 859 |
| 1 | 1 | 129 | 57 | 257 | 155 | 385 | 188 | 513 | 335 | 641 | 690 | 769 | 718 | 897 | 755 |
| 2 | 4 | 130 | 112 | 258 | 109 | 386 | 449 | 514 | 688 | 642 | 455 | 770 | 698 | 898 | 479 |
| 3 | 8 | 131 | 85 | 259 | 533 | 387 | 331 | 515 | 370 | 643 | 714 | 771 | 381 | 899 | 966 |
| 4 | 2 | 132 | 135 | 260 | 400 | 388 | 217 | 516 | 792 | 644 | 835 | 772 | 813 | 900 | 830 |
| 5 | 16 | 133 | 289 | 261 | 305 | 389 | 159 | 517 | 221 | 645 | 472 | 773 | 623 | 901 | 888 |
| 6 | 32 | 134 | 517 | 262 | 300 | 390 | 609 | 518 | 611 | 646 | 809 | 774 | 814 | 902 | 940 |
| 7 | 6 | 135 | 194 | 263 | 642 | 391 | 596 | 519 | 451 | 647 | 377 | 775 | 498 | 903 | 750 |
| 8 | 64 | 136 | 78 | 264 | 210 | 392 | 551 | 520 | 601 | 648 | 605 | 776 | 872 | 904 | 871 |
| 9 | 512 | 137 | 290 | 265 | 184 | 393 | 650 | 521 | 425 | 649 | 619 | 777 | 739 | 905 | 970 |
| 10 | 3 | 138 | 58 | 266 | 326 | 394 | 119 | 522 | 804 | 650 | 435 | 778 | 929 | 906 | 911 |
| 11 | 12 | 139 | 276 | 267 | 538 | 395 | 229 | 523 | 412 | 651 | 663 | 779 | 671 | 907 | 757 |
| 12 | 5 | 140 | 168 | 268 | 115 | 396 | 333 | 524 | 653 | 652 | 721 | 780 | 916 | 908 | 946 |
| 13 | 18 | 141 | 530 | 269 | 167 | 397 | 408 | 525 | 453 | 653 | 319 | 781 | 821 | 909 | 969 |
| 14 | 128 | 142 | 99 | 270 | 592 | 398 | 541 | 526 | 833 | 654 | 796 | 782 | 463 | 910 | 861 |
| 15 | 9 | 143 | 139 | 271 | 157 | 399 | 773 | 527 | 317 | 655 | 484 | 783 | 726 | 911 | 977 |
| 16 | 33 | 144 | 196 | 272 | 225 | 400 | 610 | 528 | 712 | 656 | 692 | 784 | 961 | 912 | 875 |
| 17 | 17 | 145 | 86 | 273 | 306 | 401 | 657 | 529 | 235 | 657 | 912 | 785 | 843 | 913 | 919 |
| 18 | 10 | 146 | 176 | 274 | 547 | 402 | 310 | 530 | 602 | 658 | 430 | 786 | 490 | 914 | 639 |
| 19 | 256 | 147 | 640 | 275 | 329 | 403 | 420 | 531 | 343 | 659 | 606 | 787 | 631 | 915 | 758 |
| 20 | 20 | 148 | 60 | 276 | 110 | 404 | 600 | 532 | 543 | 660 | 716 | 788 | 729 | 916 | 948 |
| 21 | 34 | 149 | 89 | 277 | 770 | 405 | 218 | 533 | 372 | 661 | 488 | 789 | 700 | 917 | 862 |
| 22 | 24 | 150 | 280 | 278 | 212 | 406 | 368 | 534 | 654 | 662 | 810 | 790 | 382 | 918 | 761 |
| 23 | 65 | 151 | 101 | 279 | 117 | 407 | 230 | 535 | 222 | 663 | 459 | 791 | 741 | 919 | 508 |
| 24 | 7 | 152 | 147 | 280 | 171 | 408 | 652 | 536 | 614 | 664 | 838 | 792 | 845 | 920 | 972 |
| 25 | 36 | 153 | 292 | 281 | 550 | 409 | 391 | 537 | 426 | 665 | 667 | 793 | 920 | 921 | 923 |
| 26 | 66 | 154 | 521 | 282 | 330 | 410 | 175 | 538 | 775 | 666 | 239 | 794 | 471 | 922 | 877 |
| 27 | 129 | 155 | 141 | 283 | 226 | 411 | 313 | 539 | 433 | 667 | 817 | 795 | 822 | 923 | 952 |
| 28 | 11 | 156 | 321 | 284 | 648 | 412 | 339 | 540 | 559 | 668 | 621 | 796 | 851 | 924 | 886 |
| 29 | 40 | 157 | 142 | 285 | 387 | 413 | 542 | 541 | 237 | 669 | 378 | 797 | 730 | 925 | 935 |
| 30 | 19 | 158 | 90 | 286 | 308 | 414 | 334 | 542 | 898 | 670 | 837 | 798 | 497 | 926 | 978 |
| 31 | 132 | 159 | 200 | 287 | 158 | 415 | 123 | 543 | 617 | 671 | 722 | 799 | 880 | 927 | 762 |
| 32 | 513 | 160 | 545 | 288 | 608 | 416 | 555 | 544 | 347 | 672 | 437 | 800 | 742 | 928 | 503 |
| 33 | 13 | 161 | 31 | 289 | 416 | 417 | 774 | 545 | 808 | 673 | 696 | 801 | 443 | 929 | 883 |
| 34 | 68 | 162 | 102 | 290 | 337 | 418 | 233 | 546 | 243 | 674 | 461 | 802 | 903 | 930 | 703 |
| 35 | 48 | 163 | 263 | 291 | 534 | 419 | 314 | 547 | 720 | 675 | 737 | 803 | 687 | 931 | 993 |
| 36 | 14 | 164 | 105 | 292 | 216 | 420 | 658 | 548 | 454 | 676 | 679 | 804 | 825 | 932 | 925 |
| 37 | 72 | 165 | 529 | 293 | 271 | 421 | 612 | 549 | 665 | 677 | 380 | 805 | 500 | 933 | 878 |

| | | | | | | | | | | | | | | | |
|---|---|---|---|---|---|---|---|---|---|---|---|---|---|---|---|
| 38 | 257 | 166 | 322 | 294 | 549 | 422 | 341 | 550 | 318 | 678 | 812 | 806 | 445 | 934 | 980 |
| 39 | 21 | 167 | 149 | 295 | 118 | 423 | 777 | 551 | 604 | 679 | 627 | 807 | 932 | 935 | 941 |
| 40 | 130 | 168 | 296 | 296 | 279 | 424 | 450 | 552 | 376 | 680 | 247 | 808 | 846 | 936 | 764 |
| 41 | 26 | 169 | 47 | 297 | 537 | 425 | 220 | 553 | 661 | 681 | 899 | 809 | 635 | 937 | 495 |
| 42 | 35 | 170 | 522 | 298 | 332 | 426 | 424 | 554 | 428 | 682 | 841 | 810 | 745 | 938 | 926 |
| 43 | 80 | 171 | 92 | 299 | 389 | 427 | 355 | 555 | 779 | 683 | 441 | 811 | 826 | 939 | 885 |
| 44 | 258 | 172 | 208 | 300 | 173 | 428 | 673 | 556 | 238 | 684 | 622 | 812 | 732 | 940 | 994 |
| 45 | 136 | 173 | 267 | 301 | 579 | 429 | 583 | 557 | 675 | 685 | 928 | 813 | 446 | 941 | 735 |
| 46 | 38 | 174 | 385 | 302 | 121 | 430 | 125 | 558 | 359 | 686 | 351 | 814 | 962 | 942 | 939 |
| 47 | 22 | 175 | 324 | 303 | 199 | 431 | 234 | 559 | 836 | 687 | 724 | 815 | 936 | 943 | 984 |
| 48 | 260 | 176 | 304 | 304 | 776 | 432 | 183 | 560 | 458 | 688 | 783 | 816 | 475 | 944 | 967 |
| 49 | 516 | 177 | 536 | 305 | 179 | 433 | 395 | 561 | 625 | 689 | 469 | 817 | 853 | 945 | 889 |
| 50 | 37 | 178 | 768 | 306 | 228 | 434 | 241 | 562 | 399 | 690 | 629 | 818 | 867 | 946 | 947 |
| 51 | 25 | 179 | 532 | 307 | 553 | 435 | 557 | 563 | 662 | 691 | 818 | 819 | 637 | 947 | 831 |
| 52 | 96 | 180 | 163 | 308 | 338 | 436 | 660 | 564 | 677 | 692 | 438 | 820 | 907 | 948 | 507 |
| 53 | 67 | 181 | 153 | 309 | 656 | 437 | 616 | 565 | 434 | 693 | 669 | 821 | 487 | 949 | 942 |
| 54 | 264 | 182 | 150 | 310 | 312 | 438 | 316 | 566 | 567 | 694 | 462 | 822 | 695 | 950 | 751 |
| 55 | 41 | 183 | 106 | 311 | 540 | 439 | 342 | 567 | 457 | 695 | 738 | 823 | 746 | 951 | 973 |
| 56 | 144 | 184 | 55 | 312 | 390 | 440 | 345 | 568 | 816 | 696 | 683 | 824 | 828 | 952 | 996 |
| 57 | 28 | 185 | 165 | 313 | 174 | 441 | 778 | 569 | 245 | 697 | 251 | 825 | 753 | 953 | 890 |
| 58 | 69 | 186 | 386 | 314 | 581 | 442 | 563 | 570 | 618 | 698 | 842 | 826 | 854 | 954 | 949 |
| 59 | 49 | 187 | 577 | 315 | 393 | 443 | 403 | 571 | 349 | 699 | 849 | 827 | 857 | 955 | 759 |
| 60 | 74 | 188 | 328 | 316 | 283 | 444 | 287 | 572 | 787 | 700 | 496 | 828 | 915 | 956 | 892 |
| 61 | 160 | 189 | 548 | 317 | 772 | 445 | 397 | 573 | 127 | 701 | 901 | 829 | 964 | 957 | 971 |
| 62 | 42 | 190 | 269 | 318 | 122 | 446 | 452 | 574 | 781 | 702 | 820 | 830 | 477 | 958 | 1000 |
| 63 | 520 | 191 | 113 | 319 | 672 | 447 | 674 | 575 | 897 | 703 | 728 | 831 | 909 | 959 | 953 |
| 64 | 272 | 192 | 154 | 320 | 554 | 448 | 558 | 576 | 407 | 704 | 467 | 832 | 719 | 960 | 509 |
| 65 | 192 | 193 | 79 | 321 | 784 | 449 | 785 | 577 | 666 | 705 | 633 | 833 | 799 | 961 | 863 |
| 66 | 70 | 194 | 224 | 322 | 63 | 450 | 432 | 578 | 436 | 706 | 902 | 834 | 699 | 962 | 981 |
| 67 | 44 | 195 | 166 | 323 | 340 | 451 | 187 | 579 | 591 | 707 | 367 | 835 | 493 | 963 | 950 |
| 68 | 131 | 196 | 275 | 324 | 704 | 452 | 357 | 580 | 363 | 708 | 670 | 836 | 504 | 964 | 974 |
| 69 | 81 | 197 | 108 | 325 | 448 | 453 | 207 | 581 | 620 | 709 | 791 | 837 | 748 | 965 | 763 |
| 70 | 15 | 198 | 578 | 326 | 561 | 454 | 664 | 582 | 465 | 710 | 442 | 838 | 944 | 966 | 1008 |
| 71 | 288 | 199 | 270 | 327 | 353 | 455 | 587 | 583 | 736 | 711 | 844 | 839 | 858 | 967 | 979 |
| 72 | 50 | 200 | 59 | 328 | 800 | 456 | 780 | 584 | 350 | 712 | 630 | 840 | 873 | 968 | 879 |
| 73 | 134 | 201 | 114 | 329 | 394 | 457 | 705 | 585 | 678 | 713 | 474 | 841 | 638 | 969 | 954 |
| 74 | 73 | 202 | 195 | 330 | 232 | 458 | 676 | 586 | 571 | 714 | 685 | 842 | 754 | 970 | 986 |
| 75 | 514 | 203 | 169 | 331 | 203 | 459 | 236 | 587 | 246 | 715 | 850 | 843 | 255 | 971 | 995 |

| | | | | | | | | | | | | | | | |
|---|---|---|---|---|---|---|---|---|---|---|---|---|---|---|---|
| 76 | 23 | 204 | 156 | 332 | 527 | 460 | 346 | 588 | 681 | 716 | 483 | 844 | 968 | 972 | 891 |
| 77 | 52 | 205 | 87 | 333 | 582 | 461 | 565 | 589 | 249 | 717 | 691 | 845 | 869 | 973 | 927 |
| 78 | 320 | 206 | 546 | 334 | 556 | 462 | 361 | 590 | 626 | 718 | 711 | 846 | 491 | 974 | 510 |
| 79 | 133 | 207 | 61 | 335 | 295 | 463 | 126 | 591 | 460 | 719 | 379 | 847 | 478 | 975 | 765 |
| 80 | 76 | 208 | 277 | 336 | 285 | 464 | 242 | 592 | 707 | 720 | 865 | 848 | 383 | 976 | 956 |
| 81 | 82 | 209 | 291 | 337 | 181 | 465 | 589 | 593 | 840 | 721 | 795 | 849 | 910 | 977 | 997 |
| 82 | 137 | 210 | 519 | 338 | 124 | 466 | 405 | 594 | 411 | 722 | 415 | 850 | 815 | 978 | 982 |
| 83 | 56 | 211 | 278 | 339 | 205 | 467 | 215 | 595 | 782 | 723 | 824 | 851 | 917 | 979 | 887 |
| 84 | 27 | 212 | 116 | 340 | 240 | 468 | 398 | 596 | 365 | 724 | 960 | 852 | 727 | 980 | 985 |
| 85 | 259 | 213 | 170 | 341 | 643 | 469 | 566 | 597 | 789 | 725 | 740 | 853 | 870 | 981 | 943 |
| 86 | 528 | 214 | 197 | 342 | 585 | 470 | 303 | 598 | 440 | 726 | 253 | 854 | 701 | 982 | 998 |
| 87 | 97 | 215 | 641 | 343 | 562 | 471 | 597 | 599 | 599 | 727 | 905 | 855 | 931 | 983 | 1001 |
| 88 | 39 | 216 | 177 | 344 | 286 | 472 | 358 | 600 | 374 | 728 | 634 | 856 | 860 | 984 | 766 |
| 89 | 384 | 217 | 281 | 345 | 299 | 473 | 801 | 601 | 668 | 729 | 444 | 857 | 499 | 985 | 988 |
| 90 | 138 | 218 | 91 | 346 | 354 | 474 | 419 | 602 | 628 | 730 | 693 | 858 | 756 | 986 | 951 |
| 91 | 84 | 219 | 552 | 347 | 182 | 475 | 624 | 603 | 423 | 731 | 744 | 859 | 731 | 987 | 1004 |
| 92 | 29 | 220 | 201 | 348 | 401 | 476 | 456 | 604 | 900 | 732 | 485 | 860 | 823 | 988 | 893 |
| 93 | 261 | 221 | 388 | 349 | 211 | 477 | 786 | 605 | 466 | 733 | 807 | 861 | 922 | 989 | 1010 |
| 94 | 145 | 222 | 293 | 350 | 396 | 478 | 348 | 606 | 848 | 734 | 686 | 862 | 874 | 990 | 957 |
| 95 | 544 | 223 | 198 | 351 | 344 | 479 | 244 | 607 | 803 | 735 | 906 | 863 | 976 | 991 | 975 |
| 96 | 43 | 224 | 523 | 352 | 586 | 480 | 569 | 608 | 250 | 736 | 470 | 864 | 918 | 992 | 511 |
| 97 | 98 | 225 | 62 | 353 | 832 | 481 | 189 | 609 | 790 | 737 | 575 | 865 | 502 | 993 | 1002 |
| 98 | 140 | 226 | 143 | 354 | 564 | 482 | 590 | 610 | 371 | 738 | 715 | 866 | 933 | 994 | 894 |
| 99 | 30 | 227 | 336 | 355 | 95 | 483 | 219 | 611 | 709 | 739 | 375 | 867 | 743 | 995 | 983 |
| 100 | 88 | 228 | 584 | 356 | 185 | 484 | 647 | 612 | 191 | 740 | 866 | 868 | 760 | 996 | 1009 |
| 101 | 262 | 229 | 172 | 357 | 206 | 485 | 311 | 613 | 573 | 741 | 913 | 869 | 881 | 997 | 955 |
| 102 | 146 | 230 | 282 | 358 | 327 | 486 | 706 | 614 | 689 | 742 | 473 | 870 | 494 | 998 | 987 |
| 103 | 71 | 231 | 120 | 359 | 645 | 487 | 362 | 615 | 481 | 743 | 852 | 871 | 702 | 999 | 1012 |
| 104 | 518 | 232 | 644 | 360 | 535 | 488 | 595 | 616 | 682 | 744 | 636 | 872 | 921 | 1000 | 958 |
| 105 | 265 | 233 | 103 | 361 | 402 | 489 | 464 | 617 | 413 | 745 | 797 | 873 | 876 | 1001 | 999 |
| 106 | 161 | 234 | 178 | 362 | 593 | 490 | 802 | 618 | 603 | 746 | 431 | 874 | 501 | 1002 | 1005 |
| 107 | 45 | 235 | 294 | 363 | 186 | 491 | 406 | 619 | 793 | 747 | 694 | 875 | 847 | 1003 | 989 |
| 108 | 100 | 236 | 531 | 364 | 356 | 492 | 680 | 620 | 366 | 748 | 811 | 876 | 992 | 1004 | 1016 |
| 109 | 148 | 237 | 202 | 365 | 588 | 493 | 421 | 621 | 713 | 749 | 486 | 877 | 447 | 1005 | 990 |
| 110 | 51 | 238 | 93 | 366 | 568 | 494 | 788 | 622 | 468 | 750 | 752 | 878 | 733 | 1006 | 1011 |
| 111 | 46 | 239 | 323 | 367 | 307 | 495 | 248 | 623 | 710 | 751 | 723 | 879 | 827 | 1007 | 767 |
| 112 | 576 | 240 | 560 | 368 | 646 | 496 | 598 | 624 | 373 | 752 | 798 | 880 | 882 | 1008 | 1003 |
| 113 | 75 | 241 | 392 | 369 | 418 | 497 | 190 | 625 | 574 | 753 | 489 | 881 | 934 | 1009 | 1014 |

| | | | | | | | | | | | | | | | |
|---|---|---|---|---|---|---|---|---|---|---|---|---|---|---|---|
| 114 | 266 | 242 | 297 | 370 | 213 | 498 | 570 | 626 | 655 | 754 | 856 | 882 | 963 | 1010 | 1006 |
| 115 | 104 | 243 | 151 | 371 | 301 | 499 | 369 | 627 | 427 | 755 | 908 | 883 | 505 | 1011 | 1017 |
| 116 | 273 | 244 | 580 | 372 | 227 | 500 | 651 | 628 | 806 | 756 | 254 | 884 | 937 | 1012 | 895 |
| 117 | 164 | 245 | 209 | 373 | 302 | 501 | 409 | 629 | 414 | 757 | 717 | 885 | 747 | 1013 | 1013 |
| 118 | 193 | 246 | 284 | 374 | 896 | 502 | 834 | 630 | 684 | 758 | 607 | 886 | 855 | 1014 | 991 |
| 119 | 53 | 247 | 180 | 375 | 594 | 503 | 410 | 631 | 904 | 759 | 930 | 887 | 924 | 1015 | 1018 |
| 120 | 515 | 248 | 525 | 376 | 360 | 504 | 708 | 632 | 252 | 760 | 476 | 888 | 734 | 1016 | 959 |
| 121 | 162 | 249 | 107 | 377 | 111 | 505 | 480 | 633 | 615 | 761 | 697 | 889 | 829 | 1017 | 1020 |
| 122 | 268 | 250 | 94 | 378 | 649 | 506 | 613 | 634 | 482 | 762 | 725 | 890 | 965 | 1018 | 1015 |
| 123 | 77 | 251 | 204 | 379 | 771 | 507 | 231 | 635 | 632 | 763 | 914 | 891 | 938 | 1019 | 1007 |
| 124 | 152 | 252 | 769 | 380 | 417 | 508 | 572 | 636 | 805 | 764 | 439 | 892 | 884 | 1020 | 1019 |
| 125 | 274 | 253 | 298 | 381 | 539 | 509 | 315 | 637 | 429 | 765 | 819 | 893 | 506 | 1021 | 1021 |
| 126 | 54 | 254 | 352 | 382 | 214 | 510 | 659 | 638 | 794 | 766 | 839 | 894 | 749 | 1022 | 1022 |
| 127 | 524 | 255 | 325 | 383 | 404 | 511 | 364 | 639 | 864 | 767 | 868 | 895 | 945 | 1023 | 1023 |

Sequence Q2, having a sequence length of 512:

[0, 1, 4, 8, 2, 16, 32, 6, 64, 3, 12, 5, 18, 128, 9, 33, 17, 10, 256, 20, 34, 24, 65, 7, 36, 66, 129, 11, 40, 19, 132, 13, 68, 48, 14, 72, 257, 21, 130, 26, 35, 80, 258, 136, 38, 22, 260, 37, 25, 96, 67, 264, 41, 144, 28, 69, 49, 74, 160, 42, 272, 192, 70, 44, 131, 81, 15, 288, 50, 134, 73, 23, 52, 320, 133, 76, 82, 137, 56, 27, 259, 97, 39, 384, 138, 84, 29, 261, 145, 43, 98, 140, 30, 88, 262, 146, 71, 265, 161, 45, 100, 148, 51, 46, 75, 266, 104, 273, 164, 193, 53, 162, 268, 77, 152, 274, 54, 83, 57, 112, 85, 135, 289, 194, 78, 290, 58, 276, 168, 99, 139, 196, 86, 176, 60, 89, 280, 101, 147, 292, 141, 321, 142, 90, 200, 31, 102, 263, 105, 322, 149, 296, 47, 92, 208, 267, 385, 324, 304, 163, 153, 150, 106, 55, 165, 386, 328, 269, 113, 154, 79, 224, 166, 275, 108, 270, 59, 114, 195, 169, 156, 87, 61, 277, 291, 278, 116, 170, 197, 177, 281, 91, 201, 388, 293, 198, 62, 143, 336, 172, 282, 120, 103,178, 294, 202, 93, 323, 392, 297, 151, 209, 284, 180, 107, 94, 204, 298, 352, 325, 155, 109, 400, 305, 300, 210, 184, 326, 115, 167, 157, 225, 306, 329, 110, 212, 117, 171, 330, 226, 387, 308, 158, 416, 337, 216, 271, 118, 279, 332, 389, 173, 121, 199, 179, 228, 338, 312, 390, 174, 393, 283, 122, 63, 340, 448, 353, 394, 232, 203, 295, 285, 181, 124, 205, 240, 286, 299, 354, 182, 401, 211, 396, 344, 95, 185, 206, 327, 402, 186, 356, 307, 418, 213, 301, 227, 302, 360, 111, 417, 214, 404, 309, 188, 449, 331, 217, 159, 119, 229, 333, 408, 310, 420, 218, 368, 230, 391, 175, 313, 339, 334, 123, 233, 314, 341, 450, 220, 424, 355, 125, 234, 183, 395, 241, 316, 342, 345, 403, 287, 397, 452, 432, 187, 357, 207, 236, 346, 361, 126, 242, 405, 215, 398, 303, 358, 419, 456, 348, 244, 189, 219, 311, 362, 464, 406, 421, 248, 190, 369, 409, 410, 480, 231, 315, 364, 422, 335, 370, 221, 451, 425, 412, 453, 317, 235, 343, 372, 222, 426, 433, 237, 347, 243, 454, 318, 376, 428, 238, 359, 458, 399, 434, 457, 245, 349, 127, 407, 436, 363, 465, 350, 246, 249, 460, 411, 365, 440, 374, 423, 466, 250, 371, 191, 481, 413, 366, 468, 373, 427, 414, 252, 482, 429, 223, 455, 472, 377, 435, 319, 484, 430, 488, 459, 239, 378, 437, 461, 380, 247, 441, 351, 469, 438, 462, 251, 496, 467, 367, 442, 474, 483, 379, 415, 253, 444, 485, 470, 375, 473, 431, 486, 489, 254, 476, 439, 492, 381, 498, 463, 490, 382, 471, 497, 443, 500, 445, 446, 475, 487, 477, 493, 504, 255, 491, 478, 383, 499, 502, 494, 501, 447, 505, 506, 479, 508, 503, 495,507,509,510,511]

Table Q2, having a sequence length of 512:

| Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number |
|---|---|---|---|---|---|---|---|---|---|---|---|---|---|---|---|
| 0 | 0 | 64 | 131 | 128 | 168 | 192 | 201 | 256 | 338 | 320 | 339 | 384 | 317 | 448 | 380 |
| 1 | 1 | 65 | 81 | 129 | 99 | 193 | 388 | 257 | 312 | 321 | 334 | 385 | 235 | 449 | 247 |
| 2 | 4 | 66 | 15 | 130 | 139 | 194 | 293 | 258 | 390 | 322 | 123 | 386 | 343 | 450 | 441 |
| 3 | 8 | 67 | 288 | 131 | 196 | 195 | 198 | 259 | 174 | 323 | 233 | 387 | 372 | 451 | 351 |
| 4 | 2 | 68 | 50 | 132 | 86 | 196 | 62 | 260 | 393 | 324 | 314 | 388 | 222 | 452 | 469 |
| 5 | 16 | 69 | 134 | 133 | 176 | 197 | 143 | 261 | 283 | 325 | 341 | 389 | 426 | 453 | 438 |
| 6 | 32 | 70 | 73 | 134 | 60 | 198 | 336 | 262 | 122 | 326 | 450 | 390 | 433 | 454 | 462 |
| 7 | 6 | 71 | 23 | 135 | 89 | 199 | 172 | 263 | 63 | 327 | 220 | 391 | 237 | 455 | 251 |
| 8 | 64 | 72 | 52 | 136 | 280 | 200 | 282 | 264 | 340 | 328 | 424 | 392 | 347 | 456 | 496 |
| 9 | 3 | 73 | 320 | 137 | 101 | 201 | 120 | 265 | 448 | 329 | 355 | 393 | 243 | 457 | 467 |
| 10 | 12 | 74 | 133 | 138 | 147 | 202 | 103 | 266 | 353 | 330 | 125 | 394 | 454 | 458 | 367 |
| 11 | 5 | 75 | 76 | 139 | 292 | 203 | 178 | 267 | 394 | 331 | 234 | 395 | 318 | 459 | 442 |
| 12 | 18 | 76 | 82 | 140 | 141 | 204 | 294 | 268 | 232 | 332 | 183 | 396 | 376 | 460 | 474 |
| 13 | 128 | 77 | 137 | 141 | 321 | 205 | 202 | 269 | 203 | 333 | 395 | 397 | 428 | 461 | 483 |
| 14 | 9 | 78 | 56 | 142 | 142 | 206 | 93 | 270 | 295 | 334 | 241 | 398 | 238 | 462 | 379 |
| 15 | 33 | 79 | 27 | 143 | 90 | 207 | 323 | 271 | 285 | 335 | 316 | 399 | 359 | 463 | 415 |
| 16 | 17 | 80 | 259 | 144 | 200 | 208 | 392 | 272 | 181 | 336 | 342 | 400 | 458 | 464 | 253 |
| 17 | 10 | 81 | 97 | 145 | 31 | 209 | 297 | 273 | 124 | 337 | 345 | 401 | 399 | 465 | 444 |
| 18 | 256 | 82 | 39 | 146 | 102 | 210 | 151 | 274 | 205 | 338 | 403 | 402 | 434 | 466 | 485 |
| 19 | 20 | 83 | 384 | 147 | 263 | 211 | 209 | 275 | 240 | 339 | 287 | 403 | 457 | 467 | 470 |
| 20 | 34 | 84 | 138 | 148 | 105 | 212 | 284 | 276 | 286 | 340 | 397 | 404 | 245 | 468 | 375 |
| 21 | 24 | 85 | 84 | 149 | 322 | 213 | 180 | 277 | 299 | 341 | 452 | 405 | 349 | 469 | 473 |
| 22 | 65 | 86 | 29 | 150 | 149 | 214 | 107 | 278 | 354 | 342 | 432 | 406 | 127 | 470 | 431 |
| 23 | 7 | 87 | 261 | 151 | 296 | 215 | 94 | 279 | 182 | 343 | 187 | 407 | 407 | 471 | 486 |

| | | | | | | | | | | | | | | | |
|---|---|---|---|---|---|---|---|---|---|---|---|---|---|---|---|
| 24 | 36 | 88 | 145 | 152 | 47 | 216 | 204 | 280 | 401 | 344 | 357 | 408 | 436 | 472 | 489 |
| 25 | 66 | 89 | 43 | 153 | 92 | 217 | 298 | 281 | 211 | 345 | 207 | 409 | 363 | 473 | 254 |
| 26 | 129 | 90 | 98 | 154 | 208 | 218 | 352 | 282 | 396 | 346 | 236 | 410 | 465 | 474 | 476 |
| 27 | 11 | 91 | 140 | 155 | 267 | 219 | 325 | 283 | 344 | 347 | 346 | 411 | 350 | 475 | 439 |
| 28 | 40 | 92 | 30 | 156 | 385 | 220 | 155 | 284 | 95 | 348 | 361 | 412 | 246 | 476 | 492 |
| 29 | 19 | 93 | 88 | 157 | 324 | 221 | 109 | 285 | 185 | 349 | 126 | 413 | 249 | 477 | 381 |
| 30 | 132 | 94 | 262 | 158 | 304 | 222 | 400 | 286 | 206 | 350 | 242 | 414 | 460 | 478 | 498 |
| 31 | 13 | 95 | 146 | 159 | 163 | 223 | 305 | 287 | 327 | 351 | 405 | 415 | 411 | 479 | 463 |
| 32 | 68 | 96 | 71 | 160 | 153 | 224 | 300 | 288 | 402 | 352 | 215 | 416 | 365 | 480 | 490 |
| 33 | 48 | 97 | 265 | 161 | 150 | 225 | 210 | 289 | 186 | 353 | 398 | 417 | 440 | 481 | 382 |
| 34 | 14 | 98 | 161 | 162 | 106 | 226 | 184 | 290 | 356 | 354 | 303 | 418 | 374 | 482 | 471 |
| 35 | 72 | 99 | 45 | 163 | 55 | 227 | 326 | 291 | 307 | 355 | 358 | 419 | 423 | 483 | 497 |
| 36 | 257 | 100 | 100 | 164 | 165 | 228 | 115 | 292 | 418 | 356 | 419 | 420 | 466 | 484 | 443 |
| 37 | 21 | 101 | 148 | 165 | 386 | 229 | 167 | 293 | 213 | 357 | 456 | 421 | 250 | 485 | 500 |
| 38 | 130 | 102 | 51 | 166 | 328 | 230 | 157 | 294 | 301 | 358 | 348 | 422 | 371 | 486 | 445 |
| 39 | 26 | 103 | 46 | 167 | 269 | 231 | 225 | 295 | 227 | 359 | 244 | 423 | 191 | 487 | 446 |
| 40 | 35 | 104 | 75 | 168 | 113 | 232 | 306 | 296 | 302 | 360 | 189 | 424 | 481 | 488 | 475 |
| 41 | 80 | 105 | 266 | 169 | 154 | 233 | 329 | 297 | 360 | 361 | 219 | 425 | 413 | 489 | 487 |
| 42 | 258 | 106 | 104 | 170 | 79 | 234 | 110 | 298 | 111 | 362 | 311 | 426 | 366 | 490 | 477 |
| 43 | 136 | 107 | 273 | 171 | 224 | 235 | 212 | 299 | 417 | 363 | 362 | 427 | 468 | 491 | 493 |
| 44 | 38 | 108 | 164 | 172 | 166 | 236 | 117 | 300 | 214 | 364 | 464 | 428 | 373 | 492 | 504 |
| 45 | 22 | 109 | 193 | 173 | 275 | 237 | 171 | 301 | 404 | 365 | 406 | 429 | 427 | 493 | 255 |
| 46 | 260 | 110 | 53 | 174 | 108 | 238 | 330 | 302 | 309 | 366 | 421 | 430 | 414 | 494 | 491 |
| 47 | 37 | 111 | 162 | 175 | 270 | 239 | 226 | 303 | 188 | 367 | 248 | 431 | 252 | 495 | 478 |
| 48 | 25 | 112 | 268 | 176 | 59 | 240 | 387 | 304 | 449 | 368 | 190 | 432 | 482 | 496 | 383 |
| 49 | 96 | 113 | 77 | 177 | 114 | 241 | 308 | 305 | 331 | 369 | 369 | 433 | 429 | 497 | 499 |
| 50 | 67 | 114 | 152 | 178 | 195 | 242 | 158 | 306 | 217 | 370 | 409 | 434 | 223 | 498 | 502 |
| 51 | 264 | 115 | 274 | 179 | 169 | 243 | 416 | 307 | 159 | 371 | 410 | 435 | 455 | 499 | 494 |
| 52 | 41 | 116 | 54 | 180 | 156 | 244 | 337 | 308 | 119 | 372 | 480 | 436 | 472 | 500 | 501 |
| 53 | 144 | 117 | 83 | 181 | 87 | 245 | 216 | 309 | 229 | 373 | 231 | 437 | 377 | 501 | 447 |
| 54 | 28 | 118 | 57 | 182 | 61 | 246 | 271 | 310 | 333 | 374 | 315 | 438 | 435 | 502 | 505 |
| 55 | 69 | 119 | 112 | 183 | 277 | 247 | 118 | 311 | 408 | 375 | 364 | 439 | 319 | 503 | 506 |
| 56 | 49 | 120 | 85 | 184 | 291 | 248 | 279 | 312 | 310 | 376 | 422 | 440 | 484 | 504 | 479 |
| 57 | 74 | 121 | 135 | 185 | 278 | 249 | 332 | 313 | 420 | 377 | 335 | 441 | 430 | 505 | 508 |
| 58 | 160 | 122 | 289 | 186 | 116 | 250 | 389 | 314 | 218 | 378 | 370 | 442 | 488 | 506 | 503 |
| 59 | 42 | 123 | 194 | 187 | 170 | 251 | 173 | 315 | 368 | 379 | 221 | 443 | 459 | 507 | 495 |
| 60 | 272 | 124 | 78 | 188 | 197 | 252 | 121 | 316 | 230 | 380 | 451 | 444 | 239 | 508 | 507 |
| 61 | 192 | 125 | 290 | 189 | 177 | 253 | 199 | 317 | 391 | 381 | 425 | 445 | 378 | 509 | 509 |

| 62 | 70 | 126 | 58 | 190 | 281 | 254 | 179 | 318 | 175 | 382 | 412 | 446 | 437 | 510 | 510 |
| 63 | 44 | 127 | 276 | 191 | 91 | 255 | 228 | 319 | 313 | 383 | 453 | 447 | 461 | 511 | 511 |

Sequence Q3, having a sequence length of 256:
[0, 1, 4, 8, 2, 16, 32, 6, 64, 3, 12, 5, 18, 128, 9, 33, 17, 10, 20, 34, 24, 65, 7, 36, 66, 129, 11, 40, 19, 132, 13, 68, 48, 14, 72, 21, 130, 26, 35, 80, 136, 38, 22, 37, 25, 96, 67, 41, 144, 28, 69, 49, 74, 160, 42, 192, 70, 44, 131, 81, 15, 50, 134, 73, 23, 52, 133, 76, 82, 137, 56, 27, 97, 39, 138, 84, 29, 145, 43, 98, 140, 30, 88, 146, 71, 161, 45, 100, 148, 51, 46, 75, 104, 164, 193, 53, 162, 77, 152, 54, 83, 57, 112, 85, 135, 194, 78, 58, 168, 99, 139, 196, 86, 176, 60, 89, 101, 147, 141, 142, 90, 200, 31, 102, 105, 149, 47, 92, 208, 163, 153, 150, 106, 55, 165, 113, 154, 79, 224, 166, 108, 59, 114, 195, 169, 156, 87, 61, 116, 170, 197, 177, 91, 201, 198, 62, 143, 172, 120, 103, 178, 202, 93, 151, 209, 180, 107, 94, 204, 155, 109, 210, 184, 115, 167, 157, 225, 110, 212, 117, 171, 226, 158, 216, 118, 173, 121, 199, 179, 228, 174, 122, 63, 232, 203, 181, 124, 205, 240, 182, 211, 95, 185, 206, 186, 213, 227, 111, 214, 188, 217, 159, 119, 229, 218, 230, 175, 123, 233, 220, 125, 234, 183, 241, 187, 207, 236, 126, 242, 215, 244, 189, 219, 248, 190, 231, 221, 235, 222, 237, 243, 238, 245, 127, 246, 249, 250, 191, 252, 223, 239, 247, 251, 253, 254, 255]

Table Q3, having a sequence length of 256:

| Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number |
|---|---|---|---|---|---|---|---|---|---|---|---|---|---|---|---|
| 0 | 0 | 32 | 48 | 64 | 23 | 96 | 162 | 128 | 208 | 160 | 178 | 192 | 63 | 224 | 187 |
| 1 | 1 | 33 | 14 | 65 | 52 | 97 | 77 | 129 | 163 | 161 | 202 | 193 | 232 | 225 | 207 |
| 2 | 4 | 34 | 72 | 66 | 133 | 98 | 152 | 130 | 153 | 162 | 93 | 194 | 203 | 226 | 236 |
| 3 | 8 | 35 | 21 | 67 | 76 | 99 | 54 | 131 | 150 | 163 | 151 | 195 | 181 | 227 | 126 |
| 4 | 2 | 36 | 130 | 68 | 82 | 100 | 83 | 132 | 106 | 164 | 209 | 196 | 124 | 228 | 242 |
| 5 | 16 | 37 | 26 | 69 | 137 | 101 | 57 | 133 | 55 | 165 | 180 | 197 | 205 | 229 | 215 |
| 6 | 32 | 38 | 35 | 70 | 56 | 102 | 112 | 134 | 165 | 166 | 107 | 198 | 240 | 230 | 244 |
| 7 | 6 | 39 | 80 | 71 | 27 | 103 | 85 | 135 | 113 | 167 | 94 | 199 | 182 | 231 | 189 |
| 8 | 64 | 40 | 136 | 72 | 97 | 104 | 135 | 136 | 154 | 168 | 204 | 200 | 211 | 232 | 219 |
| 9 | 3 | 41 | 38 | 73 | 39 | 105 | 194 | 137 | 79 | 169 | 155 | 201 | 95 | 233 | 248 |
| 10 | 12 | 42 | 22 | 74 | 138 | 106 | 78 | 138 | 224 | 170 | 109 | 202 | 185 | 234 | 190 |
| 11 | 5 | 43 | 37 | 75 | 84 | 107 | 58 | 139 | 166 | 171 | 210 | 203 | 206 | 235 | 231 |
| 12 | 18 | 44 | 25 | 76 | 29 | 108 | 168 | 140 | 108 | 172 | 184 | 204 | 186 | 236 | 221 |

| | | | | | | | | | | | | | | | |
|---|---|---|---|---|---|---|---|---|---|---|---|---|---|---|---|
| 13 | 128 | 45 | 96 | 77 | 145 | 109 | 99 | 141 | 59 | 173 | 115 | 205 | 213 | 237 | 235 |
| 14 | 9 | 46 | 67 | 78 | 43 | 110 | 139 | 142 | 114 | 174 | 167 | 206 | 227 | 238 | 222 |
| 15 | 33 | 47 | 41 | 79 | 98 | 111 | 196 | 143 | 195 | 175 | 157 | 207 | 111 | 239 | 237 |
| 16 | 17 | 48 | 144 | 80 | 140 | 112 | 86 | 144 | 169 | 176 | 225 | 208 | 214 | 240 | 243 |
| 17 | 10 | 49 | 28 | 81 | 30 | 113 | 176 | 145 | 156 | 177 | 110 | 209 | 188 | 241 | 238 |
| 18 | 20 | 50 | 69 | 82 | 88 | 114 | 60 | 146 | 87 | 178 | 212 | 210 | 217 | 242 | 245 |
| 19 | 34 | 51 | 49 | 83 | 146 | 115 | 89 | 147 | 61 | 179 | 117 | 211 | 159 | 243 | 127 |
| 20 | 24 | 52 | 74 | 84 | 71 | 116 | 101 | 148 | 116 | 180 | 171 | 212 | 119 | 244 | 246 |
| 21 | 65 | 53 | 160 | 85 | 161 | 117 | 147 | 149 | 170 | 181 | 226 | 213 | 229 | 245 | 249 |
| 22 | 7 | 54 | 42 | 86 | 45 | 118 | 141 | 150 | 197 | 182 | 158 | 214 | 218 | 246 | 250 |
| 23 | 36 | 55 | 192 | 87 | 100 | 119 | 142 | 151 | 177 | 183 | 216 | 215 | 230 | 247 | 191 |
| 24 | 66 | 56 | 70 | 88 | 148 | 120 | 90 | 152 | 91 | 184 | 118 | 216 | 175 | 248 | 252 |
| 25 | 129 | 57 | 44 | 89 | 51 | 121 | 200 | 153 | 201 | 185 | 173 | 217 | 123 | 249 | 223 |
| 26 | 11 | 58 | 131 | 90 | 46 | 122 | 31 | 154 | 198 | 186 | 121 | 218 | 233 | 250 | 239 |
| 27 | 40 | 59 | 81 | 91 | 75 | 123 | 102 | 155 | 62 | 187 | 199 | 219 | 220 | 251 | 247 |
| 28 | 19 | 60 | 15 | 92 | 104 | 124 | 105 | 156 | 143 | 188 | 179 | 220 | 125 | 252 | 251 |
| 29 | 132 | 61 | 50 | 93 | 164 | 125 | 149 | 157 | 172 | 189 | 228 | 221 | 234 | 253 | 253 |
| 30 | 13 | 62 | 134 | 94 | 193 | 126 | 47 | 158 | 120 | 190 | 174 | 222 | 183 | 254 | 254 |
| 31 | 68 | 63 | 73 | 95 | 53 | 127 | 92 | 159 | 103 | 191 | 122 | 223 | 241 | 255 | 255 |

Sequence Q4, having a sequence length of 128:
[0, 1, 4, 8, 2, 16, 32, 6, 64, 3, 12, 5, 18, 9, 33, 17, 10, 20, 34, 24, 65, 7, 36, 66, 11, 40, 19, 13, 68, 48, 14, 72, 21, 26, 35, 80, 38, 22, 37, 25, 96, 67, 41, 28, 69, 49, 74, 42, 70, 44, 81, 15, 50, 73, 23, 52, 76, 82, 56, 27, 97, 39, 84, 29, 43, 98, 30, 88, 71, 45, 100, 51, 46, 75, 104, 53, 77, 54, 83, 57, 112, 85, 78, 58, 99, 86, 60, 89, 101, 90, 31, 102, 105, 47, 92, 106, 55, 113, 79, 108, 59, 114, 87, 61, 116, 91, 62, 120, 103, 93, 107, 94, 109, 115, 110, 117, 118, 121, 122, 63, 124, 95, 111, 119, 123, 125, 126, 127]

[0063]    Table Q4, having a sequence length of 128:

| Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number |
|---|---|---|---|---|---|---|---|---|---|---|---|---|---|---|---|
| 0 | 0 | 16 | 10 | 32 | 21 | 48 | 70 | 64 | 43 | 80 | 112 | 96 | 55 | 112 | 109 |
| 1 | 1 | 17 | 20 | 33 | 26 | 49 | 44 | 65 | 98 | 81 | 85 | 97 | 113 | 113 | 115 |
| 2 | 4 | 18 | 34 | 34 | 35 | 50 | 81 | 66 | 30 | 82 | 78 | 98 | 79 | 114 | 110 |

16

| | | | | | | | | | | | | | | | |
|---|---|---|---|---|---|---|---|---|---|---|---|---|---|---|---|
| 3 | 8 | 19 | 24 | 35 | 80 | 51 | 15 | 67 | 88 | 83 | 58 | 99 | 108 | 115 | 117 |
| 4 | 2 | 20 | 65 | 36 | 38 | 52 | 50 | 68 | 71 | 84 | 99 | 100 | 59 | 116 | 118 |
| 5 | 16 | 21 | 7 | 37 | 22 | 53 | 73 | 69 | 45 | 85 | 86 | 101 | 114 | 117 | 121 |
| 6 | 32 | 22 | 36 | 38 | 37 | 54 | 23 | 70 | 100 | 86 | 60 | 102 | 87 | 118 | 122 |
| 7 | 6 | 23 | 66 | 39 | 25 | 55 | 52 | 71 | 51 | 87 | 89 | 103 | 61 | 119 | 63 |
| 8 | 64 | 24 | 11 | 40 | 96 | 56 | 76 | 72 | 46 | 88 | 101 | 104 | 116 | 120 | 124 |
| 9 | 3 | 25 | 40 | 41 | 67 | 57 | 82 | 73 | 75 | 89 | 90 | 105 | 91 | 121 | 95 |
| 10 | 12 | 26 | 19 | 42 | 41 | 58 | 56 | 74 | 104 | 90 | 31 | 106 | 62 | 122 | 111 |
| 11 | 5 | 27 | 13 | 43 | 28 | 59 | 27 | 75 | 53 | 91 | 102 | 107 | 120 | 123 | 119 |
| 12 | 18 | 28 | 68 | 44 | 69 | 60 | 97 | 76 | 77 | 92 | 105 | 108 | 103 | 124 | 123 |
| 13 | 9 | 29 | 48 | 45 | 49 | 61 | 39 | 77 | 54 | 93 | 47 | 109 | 93 | 125 | 125 |
| 14 | 33 | 30 | 14 | 46 | 74 | 62 | 84 | 78 | 83 | 94 | 92 | 110 | 107 | 126 | 126 |
| 15 | 17 | 31 | 72 | 47 | 42 | 63 | 29 | 79 | 57 | 95 | 106 | 111 | 94 | 127 | 127 |

Sequence Q5, having a sequence length of 64:
[0, 1, 4, 8, 2, 16, 32, 6, 3, 12, 5, 18, 9, 33, 17, 10, 20, 34, 24, 7, 36, 11, 40, 19, 13, 48, 14, 21, 26, 35, 38, 22, 37, 25, 41, 28, 49, 42, 44, 15, 50, 23, 52, 56, 27, 39, 29, 43, 30, 45, 51, 46, 53, 54, 57, 58, 60, 31, 47, 55, 59, 61, 62, 63]

## Table Q5, having a sequence length of 64:

| Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number |
|---|---|---|---|---|---|---|---|---|---|---|---|---|---|---|---|
| 0 | 0 | 8 | 3 | 16 | 20 | 24 | 13 | 32 | 37 | 40 | 50 | 48 | 30 | 56 | 60 |
| 1 | 1 | 9 | 12 | 17 | 34 | 25 | 48 | 33 | 25 | 41 | 23 | 49 | 45 | 57 | 31 |
| 2 | 4 | 10 | 5 | 18 | 24 | 26 | 14 | 34 | 41 | 42 | 52 | 50 | 51 | 58 | 47 |
| 3 | 8 | 11 | 18 | 19 | 7 | 27 | 21 | 35 | 28 | 43 | 56 | 51 | 46 | 59 | 55 |
| 4 | 2 | 12 | 9 | 20 | 36 | 28 | 26 | 36 | 49 | 44 | 27 | 52 | 53 | 60 | 59 |
| 5 | 16 | 13 | 33 | 21 | 11 | 29 | 35 | 37 | 42 | 45 | 39 | 53 | 54 | 61 | 61 |
| 6 | 32 | 14 | 17 | 22 | 40 | 30 | 38 | 38 | 44 | 46 | 29 | 54 | 57 | 62 | 62 |
| 7 | 6 | 15 | 10 | 23 | 19 | 31 | 22 | 39 | 15 | 47 | 43 | 55 | 58 | 63 | 63 |

Sequence Z1, having a sequence length of 1024:
[0, 1, 4, 10, 2, 12, 7, 24, 3, 15, 18, 28, 11, 33, 36, 70, 5, 17, 13, 30, 20, 39, 47, 76, 22, 51, 41, 84, 57, 92, 99, 161, 6, 16, 21, 42, 25, 50, 46, 88, 29, 55, 62, 96, 67, 107, 111, 169, 35, 59, 72, 110, 77, 119, 126, 184, 83, 129, 138, 200, 148, 207, 225, 322, 8, 23, 26, 53, 34, 58, 66, 103, 37, 74, 60, 113, 80, 123, 136, 193, 43, 69, 81, 128, 91, 131, 145, 205, 100, 149, 158, 218, 171, 238, 250, 355, 52, 87, 97, 142, 108, 151, 162, 233, 115, 164, 183, 249, 197, 258, 276, 377, 130, 191, 201, 268, 212, 279, 295, 394, 231, 302, 318, 415, 338, 430, 463, 573, 14, 27, 40, 68, 31, 79, 73, 132, 45, 82, 90, 143, 98, 155, 157, 226, 56, 94, 102, 152, 109, 167, 182, 243, 124, 181, 192, 257, 204, 271, 287, 389, 61, 106, 121, 180, 117, 185, 195, 269, 140, 203, 213, 280, 229, 300, 313, 410, 146, 216, 234, 305, 247, 337, 347, 432, 265, 356, 363, 451, 385, 481, 497, 612, 65, 118, 135, 202, 144, 214, 223, 303, 159, 220, 237, 331, 251, 339, 357, 453, 172, 245, 264, 349, 278, 370, 382, 467, 292, 388, 405, 483, 425, 517, 535, 640, 194, 272, 283, 372, 306, 395, 407, 507, 330, 418, 431, 529, 459, 541, 556, 666, 340, 434, 464, 546, 479, 569, 587, 680, 495, 589, 608, 697, 632, 726, 756, 843, 19, 38, 44, 85, 48, 93, 101, 163, 54, 105, 114, 173, 122, 190, 199, 293, 64, 116, 125, 196, 139, 208, 211, 296, 150, 217, 230, 316, 246, 336, 344, 444, 71, 133, 137, 209, 153, 222, 235, 335, 168, 242, 253, 345, 262, 371, 373, 470, 176, 261, 273, 367, 286, 384, 402, 485, 310, 411, 419, 509, 438, 527, 550, 653, 78, 156, 166, 239, 175, 255, 266, 358, 188, 275, 282, 387, 298, 396, 414, 513, 227, 290, 308, 412, 323, 422, 439, 531, 351, 440, 460, 544, 478, 571, 584, 686, 254, 327, 346, 427, 364, 452, 472, 558, 376, 462, 487, 580, 511, 596, 620, 707, 406, 499, 515, 610, 533, 624, 600, 739, 552, 647, 669, 719, 677, 771, 790, 848, 89, 174, 186, 285, 221, 299, 312, 409, 241, 315, 329, 433, 350, 445, 468, 562, 260, 348, 361, 443, 383, 466, 491, 576, 397, 501, 503, 594, 523, 617, 629, 722, 289, 380, 369, 474, 403, 493, 512, 603, 426, 521, 537, 627, 554, 637, 658, 746, 450, 539, 565, 650, 578, 672, 692, 764, 598, 683, 710, 801, 729, 806, 813, 877, 325, 386, 424, 519, 446, 525, 548, 642, 476, 567, 560, 663, 591, 674, 694, 782, 489, 582, 605, 704, 622, 689, 736, 794, 645, 742, 713, 816, 760, 830, 847, 898, 505, 615, 634, 716, 655, 732, 749, 821, 661, 753, 786, 846, 768, 835, 870, 937, 700, 798, 775, 857, 805, 874, 865, 928, 836, 883, 893, 948, 919, 960, 974, 992, 9, 32, 75, 120, 49, 134, 104, 210, 63, 154, 170, 224, 127, 248, 256, 332, 86, 165, 141, 236, 179, 259, 291, 360, 177, 297, 267, 381, 311, 398, 413, 532, 95,160, 206, 274, 189, 294, 281, 392, 219, 307, 320, 416, 334, 435, 448, 540, 240, 326, 343, 442, 354, 461, 469, 566, 366, 480, 498, 586, 508, 613, 625, 737, 112, 187, 198, 301, 244, 314, 333, 429, 228, 342, 352, 455, 365, 465, 482, 579, 270, 362, 375, 488, 391, 471, 496, 599, 404, 520, 530, 618, 551, 648, 659, 758, 288, 390, 400, 518, 421, 506, 536, 633, 437, 543, 570, 649, 581, 668, 684, 773, 475, 561, 590, 679, 602, 690, 712, 787, 635, 705, 728, 809, 744, 819, 841, 914, 147, 215, 263, 341, 232, 359, 368, 484, 284, 378, 393, 500, 408, 524, 534, 626, 309, 401, 420, 510, 436, 553, 563, 651, 454, 549, 577, 665, 601, 693, 708, 779, 319, 428, 447, 557, 458, 564, 585, 676, 492, 588, 616, 696, 630, 714, 734, 803, 514, 614, 641, 717, 656, 730, 747, 822, 673, 761, 770, 834, 789, 854, 871, 930, 324, 457, 486, 592, 504, 611, 623, 718, 528, 621, 643, 738, 660, 757, 769, 832, 547, 652, 671, 751, 687, 762, 783, 852, 703, 788, 797, 859, 812, 878, 888, 941, 583, 675, 695, 777, 725, 791, 800, 867, 731, 810, 823, 885, 837, 894, 903, 950, 750, 825, 842, 897, 858, 907, 915, 955, 868, 918, 927, 965, 936, 975, 984, 1007, 178, 252, 277, 379, 317, 399, 417, 538, 304, 423, 441, 555, 456, 574, 595, 688, 321, 449, 477, 572, 494, 597, 609, 709, 516, 619, 638, 721, 654, 745, 752, 833, 328, 473, 490, 607, 522, 636, 628, 733, 545, 646, 662, 748, 678, 772, 774, 850, 568, 667, 691, 765, 702, 781, 795, 860, 723, 804, 811, 879, 824, 889, 900, 947, 353, 526, 502, 644, 559, 670, 664, 766, 593, 682, 698, 785, 711, 792, 808, 875, 606, 699, 715, 796, 743, 817, 826, 886, 754, 827, 839, 896, 856, 910, 917, 961, 639, 720, 740, 818, 767, 845, 853, 904, 776, 840, 862, 912, 873, 922, 933, 968, 799, 869, 880, 929, 892, 939, 924, 979, 901, 945, 953, 972, 956, 988, 994, 1012, 374, 575, 542, 681, 604, 701, 706, 802, 631, 727, 735, 820, 755, 831, 849, 906, 657, 741, 763, 828, 780, 851, 864, 913, 793, 872, 861, 921, 887, 932, 938, 973, 685, 778, 759, 855, 807, 866, 881, 925, 815, 884, 891, 942, 902, 935, 949, 981, 838, 895, 908, 946, 916, 954, 963, 986, 923, 959, 969, 997, 976, 990, 1000, 1016, 724, 784, 814, 882, 829, 890, 899, 944, 844, 909, 905, 957, 920, 951, 964, 991, 863, 911, 926, 967, 934, 962, 978, 995, 943, 980, 970, 998, 985, 1003, 1005, 1014, 876, 931, 940, 971, 952, 977, 982, 1001, 958, 983, 993, 1008, 987, 1002, 1010, 1019, 966, 996, 989, 1006, 999, 1013, 1009, 1018, 1004, 1011, 1015, 1020, 1017, 1021, 1022, 1023]

Table Z1, having a sequence length of 1024:

| Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability |
|---|---|---|---|---|---|---|---|---|---|---|---|---|---|---|---|
| 0 | 0 | 128 | 14 | 256 | 19 | 384 | 89 | 512 | 9 | 640 | 147 | 768 | 178 | 896 | 374 |
| 1 | 1 | 129 | 27 | 257 | 38 | 385 | 174 | 513 | 32 | 641 | 215 | 769 | 252 | 897 | 575 |
| 2 | 4 | 130 | 40 | 258 | 44 | 386 | 186 | 514 | 75 | 642 | 263 | 770 | 277 | 898 | 542 |
| 3 | 10 | 131 | 68 | 259 | 85 | 387 | 285 | 515 | 120 | 643 | 341 | 771 | 379 | 899 | 681 |
| 4 | 2 | 132 | 31 | 260 | 48 | 388 | 221 | 516 | 49 | 644 | 232 | 772 | 317 | 900 | 604 |
| 5 | 12 | 133 | 79 | 261 | 93 | 389 | 299 | 517 | 134 | 645 | 359 | 773 | 399 | 901 | 701 |
| 6 | 7 | 134 | 73 | 262 | 101 | 390 | 312 | 518 | 104 | 646 | 368 | 774 | 417 | 902 | 706 |
| 7 | 24 | 135 | 132 | 263 | 163 | 391 | 409 | 519 | 210 | 647 | 484 | 775 | 538 | 903 | 802 |
| 8 | 3 | 136 | 45 | 264 | 54 | 392 | 241 | 520 | 63 | 648 | 284 | 776 | 304 | 904 | 631 |
| 9 | 15 | 137 | 82 | 265 | 105 | 393 | 315 | 521 | 154 | 649 | 378 | 777 | 423 | 905 | 727 |
| 10 | 18 | 138 | 90 | 266 | 114 | 394 | 329 | 522 | 170 | 650 | 393 | 778 | 441 | 906 | 735 |
| 11 | 28 | 139 | 143 | 267 | 173 | 395 | 433 | 523 | 224 | 651 | 500 | 779 | 555 | 907 | 820 |
| 12 | 11 | 140 | 98 | 268 | 122 | 396 | 350 | 524 | 127 | 652 | 408 | 780 | 456 | 908 | 755 |
| 13 | 33 | 141 | 155 | 269 | 190 | 397 | 445 | 525 | 248 | 653 | 524 | 781 | 574 | 909 | 831 |
| 14 | 36 | 142 | 157 | 270 | 199 | 398 | 468 | 526 | 256 | 654 | 534 | 782 | 595 | 910 | 849 |
| 15 | 70 | 143 | 226 | 271 | 293 | 399 | 562 | 527 | 332 | 655 | 626 | 783 | 688 | 911 | 906 |

| | | | | | | | | | | | | | | | |
|---|---|---|---|---|---|---|---|---|---|---|---|---|---|---|---|
| 16 | 5 | 144 | 56 | 272 | 64 | 400 | 260 | 528 | 86 | 656 | 309 | 784 | 321 | 912 | 657 |
| 17 | 17 | 145 | 94 | 273 | 116 | 401 | 348 | 529 | 165 | 657 | 401 | 785 | 449 | 913 | 741 |
| 18 | 13 | 146 | 102 | 274 | 125 | 402 | 361 | 530 | 141 | 658 | 420 | 786 | 477 | 914 | 763 |
| 19 | 30 | 147 | 152 | 275 | 196 | 403 | 443 | 531 | 236 | 659 | 510 | 787 | 572 | 915 | 828 |
| 20 | 20 | 148 | 109 | 276 | 139 | 404 | 383 | 532 | 179 | 660 | 436 | 788 | 494 | 916 | 780 |
| 21 | 39 | 149 | 167 | 277 | 208 | 405 | 466 | 533 | 259 | 661 | 553 | 789 | 597 | 917 | 851 |
| 22 | 47 | 150 | 182 | 278 | 211 | 406 | 491 | 534 | 291 | 662 | 563 | 790 | 609 | 918 | 864 |
| 23 | 76 | 151 | 243 | 279 | 296 | 407 | 576 | 535 | 360 | 663 | 651 | 791 | 709 | 919 | 913 |
| 24 | 22 | 152 | 124 | 280 | 150 | 408 | 397 | 536 | 177 | 664 | 454 | 792 | 516 | 920 | 793 |
| 25 | 51 | 153 | 181 | 281 | 217 | 409 | 501 | 537 | 297 | 665 | 549 | 793 | 619 | 921 | 872 |
| 26 | 41 | 154 | 192 | 282 | 230 | 410 | 503 | 538 | 267 | 666 | 577 | 794 | 638 | 922 | 861 |
| 27 | 84 | 155 | 257 | 283 | 316 | 411 | 594 | 539 | 381 | 667 | 665 | 795 | 721 | 923 | 921 |
| 28 | 57 | 156 | 204 | 284 | 246 | 412 | 523 | 540 | 311 | 668 | 601 | 796 | 654 | 924 | 887 |
| 29 | 92 | 157 | 271 | 285 | 336 | 413 | 617 | 541 | 398 | 669 | 693 | 797 | 745 | 925 | 932 |
| 30 | 99 | 158 | 287 | 286 | 344 | 414 | 629 | 542 | 413 | 670 | 708 | 798 | 752 | 926 | 938 |
| 31 | 161 | 159 | 389 | 287 | 444 | 415 | 722 | 543 | 532 | 671 | 779 | 799 | 833 | 927 | 973 |
| 32 | 6 | 160 | 61 | 288 | 71 | 416 | 289 | 544 | 95 | 672 | 319 | 800 | 328 | 928 | 685 |
| 33 | 16 | 161 | 106 | 289 | 133 | 417 | 380 | 545 | 160 | 673 | 428 | 801 | 473 | 929 | 778 |
| 34 | 21 | 162 | 121 | 290 | 137 | 418 | 369 | 546 | 206 | 674 | 447 | 802 | 490 | 930 | 759 |
| 35 | 42 | 163 | 180 | 291 | 209 | 419 | 474 | 547 | 274 | 675 | 557 | 803 | 607 | 931 | 855 |
| 36 | 25 | 164 | 117 | 292 | 153 | 420 | 403 | 548 | 189 | 676 | 458 | 804 | 522 | 932 | 807 |
| 37 | 50 | 165 | 185 | 293 | 222 | 421 | 493 | 549 | 294 | 677 | 564 | 805 | 636 | 933 | 866 |
| 38 | 46 | 166 | 195 | 294 | 235 | 422 | 512 | 550 | 281 | 678 | 585 | 806 | 628 | 934 | 881 |
| 39 | 88 | 167 | 269 | 295 | 335 | 423 | 603 | 551 | 392 | 679 | 676 | 807 | 733 | 935 | 925 |
| 40 | 29 | 168 | 140 | 296 | 168 | 424 | 426 | 552 | 219 | 680 | 492 | 808 | 545 | 936 | 815 |
| 41 | 55 | 169 | 203 | 297 | 242 | 425 | 521 | 553 | 307 | 681 | 588 | 809 | 646 | 937 | 884 |
| 42 | 62 | 170 | 213 | 298 | 253 | 426 | 537 | 554 | 320 | 682 | 616 | 810 | 662 | 938 | 891 |
| 43 | 96 | 171 | 280 | 299 | 345 | 427 | 627 | 555 | 416 | 683 | 696 | 811 | 748 | 939 | 942 |
| 44 | 67 | 172 | 229 | 300 | 262 | 428 | 554 | 556 | 334 | 684 | 630 | 812 | 678 | 940 | 902 |
| 45 | 107 | 173 | 300 | 301 | 371 | 429 | 637 | 557 | 435 | 685 | 714 | 813 | 772 | 941 | 935 |
| 46 | 111 | 174 | 313 | 302 | 373 | 430 | 658 | 558 | 448 | 686 | 734 | 814 | 774 | 942 | 949 |
| 47 | 169 | 175 | 410 | 303 | 470 | 431 | 746 | 559 | 540 | 687 | 803 | 815 | 850 | 943 | 981 |
| 48 | 35 | 176 | 146 | 304 | 176 | 432 | 450 | 560 | 240 | 688 | 514 | 816 | 568 | 944 | 838 |
| 49 | 59 | 177 | 216 | 305 | 261 | 433 | 539 | 561 | 326 | 689 | 614 | 817 | 667 | 945 | 895 |
| 50 | 72 | 178 | 234 | 306 | 273 | 434 | 565 | 562 | 343 | 690 | 641 | 818 | 691 | 946 | 908 |
| 51 | 110 | 179 | 305 | 307 | 367 | 435 | 650 | 563 | 442 | 691 | 717 | 819 | 765 | 947 | 946 |
| 52 | 77 | 180 | 247 | 308 | 286 | 436 | 578 | 564 | 354 | 692 | 656 | 820 | 702 | 948 | 916 |
| 53 | 119 | 181 | 337 | 309 | 384 | 437 | 672 | 565 | 461 | 693 | 730 | 821 | 781 | 949 | 954 |

| 54 | 126 | 182 | 347 | 310 | 402 | 438 | 692 | 566 | 469 | 694 | 747 | 822 | 795 | 950 | 963 |
|---|---|---|---|---|---|---|---|---|---|---|---|---|---|---|---|
| 55 | 184 | 183 | 432 | 311 | 485 | 439 | 764 | 567 | 566 | 695 | 822 | 823 | 860 | 951 | 986 |
| 56 | 83 | 184 | 265 | 312 | 310 | 440 | 598 | 568 | 366 | 696 | 673 | 824 | 723 | 952 | 923 |
| 57 | 129 | 185 | 356 | 313 | 411 | 441 | 683 | 569 | 480 | 697 | 761 | 825 | 804 | 953 | 959 |
| 58 | 138 | 186 | 363 | 314 | 419 | 442 | 710 | 570 | 498 | 698 | 770 | 826 | 811 | 954 | 969 |
| 59 | 200 | 187 | 451 | 315 | 509 | 443 | 801 | 571 | 586 | 699 | 834 | 827 | 879 | 955 | 997 |
| 60 | 148 | 188 | 385 | 316 | 438 | 444 | 729 | 572 | 508 | 700 | 789 | 828 | 824 | 956 | 976 |
| 61 | 207 | 189 | 481 | 317 | 527 | 445 | 806 | 573 | 613 | 701 | 854 | 829 | 889 | 957 | 990 |
| 62 | 225 | 190 | 497 | 318 | 550 | 446 | 813 | 574 | 625 | 702 | 871 | 830 | 900 | 958 | 1000 |
| 63 | 322 | 191 | 612 | 319 | 653 | 447 | 877 | 575 | 737 | 703 | 930 | 831 | 947 | 959 | 1016 |
| 64 | 8 | 192 | 65 | 320 | 78 | 448 | 325 | 576 | 112 | 704 | 324 | 832 | 353 | 960 | 724 |
| 65 | 23 | 193 | 118 | 321 | 156 | 449 | 386 | 577 | 187 | 705 | 457 | 833 | 526 | 961 | 784 |
| 66 | 26 | 194 | 135 | 322 | 166 | 450 | 424 | 578 | 198 | 706 | 486 | 834 | 502 | 962 | 814 |
| 67 | 53 | 195 | 202 | 323 | 239 | 451 | 519 | 579 | 301 | 707 | 592 | 835 | 644 | 963 | 882 |
| 68 | 34 | 196 | 144 | 324 | 175 | 452 | 446 | 580 | 244 | 708 | 504 | 836 | 559 | 964 | 829 |
| 69 | 58 | 197 | 214 | 325 | 255 | 453 | 525 | 581 | 314 | 709 | 611 | 837 | 670 | 965 | 890 |
| 70 | 66 | 198 | 223 | 326 | 266 | 454 | 548 | 582 | 333 | 710 | 623 | 838 | 664 | 966 | 899 |
| 71 | 103 | 199 | 303 | 327 | 358 | 455 | 642 | 583 | 429 | 711 | 718 | 839 | 766 | 967 | 944 |
| 72 | 37 | 200 | 159 | 328 | 188 | 456 | 476 | 584 | 228 | 712 | 528 | 840 | 593 | 968 | 844 |
| 73 | 74 | 201 | 220 | 329 | 275 | 457 | 567 | 585 | 342 | 713 | 621 | 841 | 682 | 969 | 909 |
| 74 | 60 | 202 | 237 | 330 | 282 | 458 | 560 | 586 | 352 | 714 | 643 | 842 | 698 | 970 | 905 |
| 75 | 113 | 203 | 331 | 331 | 387 | 459 | 663 | 587 | 455 | 715 | 738 | 843 | 785 | 971 | 957 |
| 76 | 80 | 204 | 251 | 332 | 298 | 460 | 591 | 588 | 365 | 716 | 660 | 844 | 711 | 972 | 920 |
| 77 | 123 | 205 | 339 | 333 | 396 | 461 | 674 | 589 | 465 | 717 | 757 | 845 | 792 | 973 | 951 |
| 78 | 136 | 206 | 357 | 334 | 414 | 462 | 694 | 590 | 482 | 718 | 769 | 846 | 808 | 974 | 964 |
| 79 | 193 | 207 | 453 | 335 | 513 | 463 | 782 | 591 | 579 | 719 | 832 | 847 | 875 | 975 | 991 |
| 80 | 43 | 208 | 172 | 336 | 227 | 464 | 489 | 592 | 270 | 720 | 547 | 848 | 606 | 976 | 863 |
| 81 | 69 | 209 | 245 | 337 | 290 | 465 | 582 | 593 | 362 | 721 | 652 | 849 | 699 | 977 | 911 |
| 82 | 81 | 210 | 264 | 338 | 308 | 466 | 605 | 594 | 375 | 722 | 671 | 850 | 715 | 978 | 926 |
| 83 | 128 | 211 | 349 | 339 | 412 | 467 | 704 | 595 | 488 | 723 | 751 | 851 | 796 | 979 | 967 |
| 84 | 91 | 212 | 278 | 340 | 323 | 468 | 622 | 596 | 391 | 724 | 687 | 852 | 743 | 980 | 934 |
| 85 | 131 | 213 | 370 | 341 | 422 | 469 | 689 | 597 | 471 | 725 | 762 | 853 | 817 | 981 | 962 |
| 86 | 145 | 214 | 382 | 342 | 439 | 470 | 736 | 598 | 496 | 726 | 783 | 854 | 826 | 982 | 978 |
| 87 | 205 | 215 | 467 | 343 | 531 | 471 | 794 | 599 | 599 | 727 | 852 | 855 | 886 | 983 | 995 |
| 88 | 100 | 216 | 292 | 344 | 351 | 472 | 645 | 600 | 404 | 728 | 703 | 856 | 754 | 984 | 943 |
| 89 | 149 | 217 | 388 | 345 | 440 | 473 | 742 | 601 | 520 | 729 | 788 | 857 | 827 | 985 | 980 |
| 90 | 158 | 218 | 405 | 346 | 460 | 474 | 713 | 602 | 530 | 730 | 797 | 858 | 839 | 986 | 970 |
| 91 | 218 | 219 | 483 | 347 | 544 | 475 | 816 | 603 | 618 | 731 | 859 | 859 | 896 | 987 | 998 |

| | | | | | | | | | | | | | | | |
|---|---|---|---|---|---|---|---|---|---|---|---|---|---|---|---|
| 92 | 171 | 220 | 425 | 348 | 478 | 476 | 760 | 604 | 551 | 732 | 812 | 860 | 856 | 988 | 985 |
| 93 | 238 | 221 | 517 | 349 | 571 | 477 | 830 | 605 | 648 | 733 | 878 | 861 | 910 | 989 | 1003 |
| 94 | 250 | 222 | 535 | 350 | 584 | 478 | 847 | 606 | 659 | 734 | 888 | 862 | 917 | 990 | 1005 |
| 95 | 355 | 223 | 640 | 351 | 686 | 479 | 898 | 607 | 758 | 735 | 941 | 863 | 961 | 991 | 1014 |
| 96 | 52 | 224 | 194 | 352 | 254 | 480 | 505 | 608 | 288 | 736 | 583 | 864 | 639 | 992 | 876 |
| 97 | 87 | 225 | 272 | 353 | 327 | 481 | 615 | 609 | 390 | 737 | 675 | 865 | 720 | 993 | 931 |
| 98 | 97 | 226 | 283 | 354 | 346 | 482 | 634 | 610 | 400 | 738 | 695 | 866 | 740 | 994 | 940 |
| 99 | 142 | 227 | 372 | 355 | 427 | 483 | 716 | 611 | 518 | 739 | 777 | 867 | 818 | 995 | 971 |
| 100 | 108 | 228 | 306 | 356 | 364 | 484 | 655 | 612 | 421 | 740 | 725 | 868 | 767 | 996 | 952 |
| 101 | 151 | 229 | 395 | 357 | 452 | 485 | 732 | 613 | 506 | 741 | 791 | 869 | 845 | 997 | 977 |
| 102 | 162 | 230 | 407 | 358 | 472 | 486 | 749 | 614 | 536 | 742 | 800 | 870 | 853 | 998 | 982 |
| 103 | 233 | 231 | 507 | 359 | 558 | 487 | 821 | 615 | 633 | 743 | 867 | 871 | 904 | 999 | 1001 |
| 104 | 115 | 232 | 330 | 360 | 376 | 488 | 661 | 616 | 437 | 744 | 731 | 872 | 776 | 1000 | 958 |
| 105 | 164 | 233 | 418 | 361 | 462 | 489 | 753 | 617 | 543 | 745 | 810 | 873 | 840 | 1001 | 983 |
| 106 | 183 | 234 | 431 | 362 | 487 | 490 | 786 | 618 | 570 | 746 | 823 | 874 | 862 | 1002 | 993 |
| 107 | 249 | 235 | 529 | 363 | 580 | 491 | 846 | 619 | 649 | 747 | 885 | 875 | 912 | 1003 | 1008 |
| 108 | 197 | 236 | 459 | 364 | 511 | 492 | 768 | 620 | 581 | 748 | 837 | 876 | 873 | 1004 | 987 |
| 109 | 258 | 237 | 541 | 365 | 596 | 493 | 835 | 621 | 668 | 749 | 894 | 877 | 922 | 1005 | 1002 |
| 110 | 276 | 238 | 556 | 366 | 620 | 494 | 870 | 622 | 684 | 750 | 903 | 878 | 933 | 1006 | 1010 |
| 111 | 377 | 239 | 666 | 367 | 707 | 495 | 937 | 623 | 773 | 751 | 950 | 879 | 968 | 1007 | 1019 |
| 112 | 130 | 240 | 340 | 368 | 406 | 496 | 700 | 624 | 475 | 752 | 750 | 880 | 799 | 1008 | 966 |
| 113 | 191 | 241 | 434 | 369 | 499 | 497 | 798 | 625 | 561 | 753 | 825 | 881 | 869 | 1009 | 996 |
| 114 | 201 | 242 | 464 | 370 | 515 | 498 | 775 | 626 | 590 | 754 | 842 | 882 | 880 | 1010 | 989 |
| 115 | 268 | 243 | 546 | 371 | 610 | 499 | 857 | 627 | 679 | 755 | 897 | 883 | 929 | 1011 | 1006 |
| 116 | 212 | 244 | 479 | 372 | 533 | 500 | 805 | 628 | 602 | 756 | 858 | 884 | 892 | 1012 | 999 |
| 117 | 279 | 245 | 569 | 373 | 624 | 501 | 874 | 629 | 690 | 757 | 907 | 885 | 939 | 1013 | 1013 |
| 118 | 295 | 246 | 587 | 374 | 600 | 502 | 865 | 630 | 712 | 758 | 915 | 886 | 924 | 1014 | 1009 |
| 119 | 394 | 247 | 680 | 375 | 739 | 503 | 928 | 631 | 787 | 759 | 955 | 887 | 979 | 1015 | 1018 |
| 120 | 231 | 248 | 495 | 376 | 552 | 504 | 836 | 632 | 635 | 760 | 868 | 888 | 901 | 1016 | 1004 |
| 121 | 302 | 249 | 589 | 377 | 647 | 505 | 883 | 633 | 705 | 761 | 918 | 889 | 945 | 1017 | 1011 |
| 122 | 318 | 250 | 608 | 378 | 669 | 506 | 893 | 634 | 728 | 762 | 927 | 890 | 953 | 1018 | 1015 |
| 123 | 415 | 251 | 697 | 379 | 719 | 507 | 948 | 635 | 809 | 763 | 965 | 891 | 972 | 1019 | 1020 |
| 124 | 338 | 252 | 632 | 380 | 677 | 508 | 919 | 636 | 744 | 764 | 936 | 892 | 956 | 1020 | 1017 |
| 125 | 430 | 253 | 726 | 381 | 771 | 509 | 960 | 637 | 819 | 765 | 975 | 893 | 988 | 1021 | 1021 |
| 126 | 463 | 254 | 756 | 382 | 790 | 510 | 974 | 638 | 841 | 766 | 984 | 894 | 994 | 1022 | 1022 |
| 127 | 573 | 255 | 843 | 383 | 848 | 511 | 992 | 639 | 914 | 767 | 1007 | 895 | 1012 | 1023 | 1023 |

Sequence Z2, having a sequence length of 512:
[0, 1, 4, 9, 2, 11, 7, 23, 3, 14, 17, 27, 10, 31, 34, 66, 5, 16, 12, 29, 19, 37, 45, 71, 21, 48, 39, 79, 54, 86, 92, 145, 6, 15, 20, 40, 24, 47, 44, 82, 28, 52, 59, 89, 63, 99, 103, 152, 33, 56, 68, 102, 72, 110, 116, 163, 78, 118, 126, 176, 134, 182, 196, 263, 8, 22, 25, 50, 32, 55, 62, 96, 35, 70, 57, 104, 75, 113, 124, 170, 41, 65, 76, 117, 85, 120, 132, 181, 93, 135, 143, 191, 153, 206, 215, 284, 49, 81, 90, 129, 100, 137, 146, 202, 106, 148, 162, 214, 174, 221, 234, 298, 119, 168, 177, 228, 186, 236, 247, 308, 201, 252, 262, 322, 273, 330, 349, 406, 13, 26, 38, 64, 30, 74, 69, 121, 43, 77, 84, 130, 91, 140, 142, 197, 53, 88, 95, 138, 101, 150, 161, 210, 114, 160, 169, 220, 180, 230, 242, 307, 58, 98, 111, 159, 108, 164, 172, 229, 128, 179, 187, 237, 199, 251, 259, 318, 133, 189, 203, 254, 213, 272, 279, 332, 226, 285, 289, 343, 303, 360, 368, 423, 61, 109, 123, 178, 131, 188, 195, 253, 144, 192, 205, 269, 216, 274, 286, 345, 154, 211, 225, 281, 235, 293, 300, 352, 245, 306, 314, 361, 327, 379, 388, 434, 171, 231, 239, 295, 255, 309, 316, 373, 268, 323, 331, 385, 346, 391, 398, 444, 275, 334, 350, 393, 359, 404, 412, 449, 367, 413, 421, 455, 431, 464, 473, 493, 18, 36, 42, 80, 46, 87, 94, 147, 51, 97, 105, 155, 112, 167, 175, 246, 60, 107, 115, 173, 127, 183, 185, 248, 136, 190, 200, 261, 212, 271, 276, 339, 67, 122, 125, 184, 139, 194, 204, 270, 151, 209, 217, 277, 224, 294, 296, 354, 158, 223, 232, 291, 241, 302, 312, 362, 257, 319, 324, 374, 335, 384, 395, 439, 73, 141, 149, 207, 157, 219, 227, 287, 166, 233, 238, 305, 249, 310, 321, 377, 198, 244, 256, 320, 264, 325, 336, 386, 283, 337, 347, 392, 358, 405, 411, 451, 218, 266, 278, 329, 290, 344, 355, 399, 297, 348, 363, 409, 375, 416, 426, 458, 315, 369, 378, 422, 387, 428, 418, 468, 396, 437, 445, 462, 448, 477, 481, 496, 83, 156, 165, 240, 193, 250, 258, 317, 208, 260, 267, 333, 282, 340, 353, 401, 222, 280, 288, 338, 301, 351, 365, 407, 311, 370, 371, 415, 382, 425, 430, 463, 243, 299, 292, 356, 313, 366, 376, 419, 328, 381, 389, 429, 397, 433, 441, 470, 342, 390, 402, 438, 408, 446, 453, 475, 417, 450, 459, 484, 465, 486, 487, 501, 265, 304, 326, 380, 341, 383, 394, 435, 357, 403, 400, 443, 414, 447, 454, 479, 364, 410, 420, 457, 427, 452, 467, 482, 436, 469, 460, 488, 474, 490, 495, 504, 372, 424, 432, 461, 440, 466, 471, 489, 442, 472, 480, 494, 476, 491, 499, 507, 456, 483, 478, 497, 485, 500, 498, 506, 492, 502, 503, 508, 505, 509, 510, 511]

Table Z2, having a sequence length of 512:

| Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability |
|---|---|---|---|---|---|---|---|---|---|---|---|---|---|---|---|
| 0 | 0 | 64 | 8 | 128 | 13 | 192 | 61 | 256 | 18 | 320 | 73 | 384 | 83 | 448 | 265 |
| 1 | 1 | 65 | 22 | 129 | 26 | 193 | 109 | 257 | 36 | 321 | 141 | 385 | 156 | 449 | 304 |
| 2 | 4 | 66 | 25 | 130 | 38 | 194 | 123 | 258 | 42 | 322 | 149 | 386 | 165 | 450 | 326 |

| | | | | | | | | | | | | | | | |
|---|---|---|---|---|---|---|---|---|---|---|---|---|---|---|---|
| 3 | 9 | 67 | 50 | 131 | 64 | 195 | 178 | 259 | 80 | 323 | 207 | 387 | 240 | 451 | 380 |
| 4 | 2 | 68 | 32 | 132 | 30 | 196 | 131 | 260 | 46 | 324 | 157 | 388 | 193 | 452 | 341 |
| 5 | 11 | 69 | 55 | 133 | 74 | 197 | 188 | 261 | 87 | 325 | 219 | 389 | 250 | 453 | 383 |
| 6 | 7 | 70 | 62 | 134 | 69 | 198 | 195 | 262 | 94 | 326 | 227 | 390 | 258 | 454 | 394 |
| 7 | 23 | 71 | 96 | 135 | 121 | 199 | 253 | 263 | 147 | 327 | 287 | 391 | 317 | 455 | 435 |
| 8 | 3 | 72 | 35 | 136 | 43 | 200 | 144 | 264 | 51 | 328 | 166 | 392 | 208 | 456 | 357 |
| 9 | 14 | 73 | 70 | 137 | 77 | 201 | 192 | 265 | 97 | 329 | 233 | 393 | 260 | 457 | 403 |
| 10 | 17 | 74 | 57 | 138 | 84 | 202 | 205 | 266 | 105 | 330 | 238 | 394 | 267 | 458 | 400 |
| 11 | 27 | 75 | 104 | 139 | 130 | 203 | 269 | 267 | 155 | 331 | 305 | 395 | 333 | 459 | 443 |
| 12 | 10 | 76 | 75 | 140 | 91 | 204 | 216 | 268 | 112 | 332 | 249 | 396 | 282 | 460 | 414 |
| 13 | 31 | 77 | 113 | 141 | 140 | 205 | 274 | 269 | 167 | 333 | 310 | 397 | 340 | 461 | 447 |
| 14 | 34 | 78 | 124 | 142 | 142 | 206 | 286 | 270 | 175 | 334 | 321 | 398 | 353 | 462 | 454 |
| 15 | 66 | 79 | 170 | 143 | 197 | 207 | 345 | 271 | 246 | 335 | 377 | 399 | 401 | 463 | 479 |
| 16 | 5 | 80 | 41 | 144 | 53 | 208 | 154 | 272 | 60 | 336 | 198 | 400 | 222 | 464 | 364 |
| 17 | 16 | 81 | 65 | 145 | 88 | 209 | 211 | 273 | 107 | 337 | 244 | 401 | 280 | 465 | 410 |
| 18 | 12 | 82 | 76 | 146 | 95 | 210 | 225 | 274 | 115 | 338 | 256 | 402 | 288 | 466 | 420 |
| 19 | 29 | 83 | 117 | 147 | 138 | 211 | 281 | 275 | 173 | 339 | 320 | 403 | 338 | 467 | 457 |
| 20 | 19 | 84 | 85 | 148 | 101 | 212 | 235 | 276 | 127 | 340 | 264 | 404 | 301 | 468 | 427 |
| 21 | 37 | 85 | 120 | 149 | 150 | 213 | 293 | 277 | 183 | 341 | 325 | 405 | 351 | 469 | 452 |
| 22 | 45 | 86 | 132 | 150 | 161 | 214 | 300 | 278 | 185 | 342 | 336 | 406 | 365 | 470 | 467 |
| 23 | 71 | 87 | 181 | 151 | 210 | 215 | 352 | 279 | 248 | 343 | 386 | 407 | 407 | 471 | 482 |
| 24 | 21 | 88 | 93 | 152 | 114 | 216 | 245 | 280 | 136 | 344 | 283 | 408 | 311 | 472 | 436 |
| 25 | 48 | 89 | 135 | 153 | 160 | 217 | 306 | 281 | 190 | 345 | 337 | 409 | 370 | 473 | 469 |
| 26 | 39 | 90 | 143 | 154 | 169 | 218 | 314 | 282 | 200 | 346 | 347 | 410 | 371 | 474 | 460 |
| 27 | 79 | 91 | 191 | 155 | 220 | 219 | 361 | 283 | 261 | 347 | 392 | 411 | 415 | 475 | 488 |
| 28 | 54 | 92 | 153 | 156 | 180 | 220 | 327 | 284 | 212 | 348 | 358 | 412 | 382 | 476 | 474 |
| 29 | 86 | 93 | 206 | 157 | 230 | 221 | 379 | 285 | 271 | 349 | 405 | 413 | 425 | 477 | 490 |
| 30 | 92 | 94 | 215 | 158 | 242 | 222 | 388 | 286 | 276 | 350 | 411 | 414 | 430 | 478 | 495 |
| 31 | 145 | 95 | 284 | 159 | 307 | 223 | 434 | 287 | 339 | 351 | 451 | 415 | 463 | 479 | 504 |
| 32 | 6 | 96 | 49 | 160 | 58 | 224 | 171 | 288 | 67 | 352 | 218 | 416 | 243 | 480 | 372 |
| 33 | 15 | 97 | 81 | 161 | 98 | 225 | 231 | 289 | 122 | 353 | 266 | 417 | 299 | 481 | 424 |
| 34 | 20 | 98 | 90 | 162 | 111 | 226 | 239 | 290 | 125 | 354 | 278 | 418 | 292 | 482 | 432 |
| 35 | 40 | 99 | 129 | 163 | 159 | 227 | 295 | 291 | 184 | 355 | 329 | 419 | 356 | 483 | 461 |
| 36 | 24 | 100 | 100 | 164 | 108 | 228 | 255 | 292 | 139 | 356 | 290 | 420 | 313 | 484 | 440 |
| 37 | 47 | 101 | 137 | 165 | 164 | 229 | 309 | 293 | 194 | 357 | 344 | 421 | 366 | 485 | 466 |
| 38 | 44 | 102 | 146 | 166 | 172 | 230 | 316 | 294 | 204 | 358 | 355 | 422 | 376 | 486 | 471 |
| 39 | 82 | 103 | 202 | 167 | 229 | 231 | 373 | 295 | 270 | 359 | 399 | 423 | 419 | 487 | 489 |
| 40 | 28 | 104 | 106 | 168 | 128 | 232 | 268 | 296 | 151 | 360 | 297 | 424 | 328 | 488 | 442 |

| | | | | | | | | | | | | | | | |
|---|---|---|---|---|---|---|---|---|---|---|---|---|---|---|---|
| 41 | 52 | 105 | 148 | 169 | 179 | 233 | 323 | 297 | 209 | 361 | 348 | 425 | 381 | 489 | 472 |
| 42 | 59 | 106 | 162 | 170 | 187 | 234 | 331 | 298 | 217 | 362 | 363 | 426 | 389 | 490 | 480 |
| 43 | 89 | 107 | 214 | 171 | 237 | 235 | 385 | 299 | 277 | 363 | 409 | 427 | 429 | 491 | 494 |
| 44 | 63 | 108 | 174 | 172 | 199 | 236 | 346 | 300 | 224 | 364 | 375 | 428 | 397 | 492 | 476 |
| 45 | 99 | 109 | 221 | 173 | 251 | 237 | 391 | 301 | 294 | 365 | 416 | 429 | 433 | 493 | 491 |
| 46 | 103 | 110 | 234 | 174 | 259 | 238 | 398 | 302 | 296 | 366 | 426 | 430 | 441 | 494 | 499 |
| 47 | 152 | 111 | 298 | 175 | 318 | 239 | 444 | 303 | 354 | 367 | 458 | 431 | 470 | 495 | 507 |
| 48 | 33 | 112 | 119 | 176 | 133 | 240 | 275 | 304 | 158 | 368 | 315 | 432 | 342 | 496 | 456 |
| 49 | 56 | 113 | 168 | 177 | 189 | 241 | 334 | 305 | 223 | 369 | 369 | 433 | 390 | 497 | 483 |
| 50 | 68 | 114 | 177 | 178 | 203 | 242 | 350 | 306 | 232 | 370 | 378 | 434 | 402 | 498 | 478 |
| 51 | 102 | 115 | 228 | 179 | 254 | 243 | 393 | 307 | 291 | 371 | 422 | 435 | 438 | 499 | 497 |
| 52 | 72 | 116 | 186 | 180 | 213 | 244 | 359 | 308 | 241 | 372 | 387 | 436 | 408 | 500 | 485 |
| 53 | 110 | 117 | 236 | 181 | 272 | 245 | 404 | 309 | 302 | 373 | 428 | 437 | 446 | 501 | 500 |
| 54 | 116 | 118 | 247 | 182 | 279 | 246 | 412 | 310 | 312 | 374 | 418 | 438 | 453 | 502 | 498 |
| 55 | 163 | 119 | 308 | 183 | 332 | 247 | 449 | 311 | 362 | 375 | 468 | 439 | 475 | 503 | 506 |
| 56 | 78 | 120 | 201 | 184 | 226 | 248 | 367 | 312 | 257 | 376 | 396 | 440 | 417 | 504 | 492 |
| 57 | 118 | 121 | 252 | 185 | 285 | 249 | 413 | 313 | 319 | 377 | 437 | 441 | 450 | 505 | 502 |
| 58 | 126 | 122 | 262 | 186 | 289 | 250 | 421 | 314 | 324 | 378 | 445 | 442 | 459 | 506 | 503 |
| 59 | 176 | 123 | 322 | 187 | 343 | 251 | 455 | 315 | 374 | 379 | 462 | 443 | 484 | 507 | 508 |
| 60 | 134 | 124 | 273 | 188 | 303 | 252 | 431 | 316 | 335 | 380 | 448 | 444 | 465 | 508 | 505 |
| 61 | 182 | 125 | 330 | 189 | 360 | 253 | 464 | 317 | 384 | 381 | 477 | 445 | 486 | 509 | 509 |
| 62 | 196 | 126 | 349 | 190 | 368 | 254 | 473 | 318 | 395 | 382 | 481 | 446 | 487 | 510 | 510 |
| 63 | 263 | 127 | 406 | 191 | 423 | 255 | 493 | 319 | 439 | 383 | 496 | 447 | 501 | 511 | 511 |

Sequence Z3, having a sequence length of 256:
[0, 1, 4, 9, 2, 11, 7, 22, 3, 14, 17, 26, 10, 30, 33, 60, 5, 16, 12, 28, 18, 35, 42, 64, 20, 44, 37, 71, 49, 76, 81, 122, 6, 15, 19, 38, 23, 43, 41, 73, 27, 47, 54, 78, 57, 86, 90, 126, 32, 51, 61, 89, 65, 95, 99, 133, 70, 101, 107, 141, 114, 147, 155, 192, 8, 21, 24, 46, 31, 50, 56, 84, 34, 63, 52, 91, 67, 97, 106, 137, 39, 59, 68, 100, 75, 103, 112, 146, 82, 115, 120, 152, 127, 162, 167, 201, 45, 72, 79, 109, 87, 116, 123, 159, 92, 124, 132, 166, 140, 170, 177, 207, 102, 135, 142, 173, 148, 179, 184, 212, 158, 186, 191, 217, 196, 220, 227, 243, 13, 25, 36, 58, 29, 66, 62, 104, 40, 69, 74, 110, 80, 118, 119, 156, 48, 77, 83, 117, 88, 125, 131, 163, 98, 130, 136, 169, 145, 175, 182, 211, 53, 85, 96, 129, 93, 134, 139, 174, 108, 144, 149, 180, 157, 185, 190, 216, 113, 151, 160, 188, 165, 195, 199, 222, 172, 202, 204, 224, 209, 231, 234, 247, 55, 94, 105, 143, 111, 150, 154, 187, 121, 153, 161, 194, 168, 197, 203, 225, 128, 164, 171, 200, 178, 205, 208, 229, 183, 210, 214, 232, 219, 236, 238, 249, 138, 176, 181, 206, 189, 213, 215, 235, 193, 218, 221, 237, 226, 239, 241, 250, 198, 223, 228, 240, 230, 242, 244, 251, 233, 245, 246, 252, 248, 253, 254, 255]

Table Z3, having a sequence length of 256:

| Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability |
|---|---|---|---|---|---|---|---|---|---|---|---|---|---|---|---|
| 0 | 0 | 32 | 6 | 64 | 8 | 96 | 45 | 128 | 13 | 160 | 53 | 192 | 55 | 224 | 138 |
| 1 | 1 | 33 | 15 | 65 | 21 | 97 | 72 | 129 | 25 | 161 | 85 | 193 | 94 | 225 | 176 |
| 2 | 4 | 34 | 19 | 66 | 24 | 98 | 79 | 130 | 36 | 162 | 96 | 194 | 105 | 226 | 181 |
| 3 | 9 | 35 | 38 | 67 | 46 | 99 | 109 | 131 | 58 | 163 | 129 | 195 | 143 | 227 | 206 |
| 4 | 2 | 36 | 23 | 68 | 31 | 100 | 87 | 132 | 29 | 164 | 93 | 196 | 111 | 228 | 189 |
| 5 | 11 | 37 | 43 | 69 | 50 | 101 | 116 | 133 | 66 | 165 | 134 | 197 | 150 | 229 | 213 |
| 6 | 7 | 38 | 41 | 70 | 56 | 102 | 123 | 134 | 62 | 166 | 139 | 198 | 154 | 230 | 215 |
| 7 | 22 | 39 | 73 | 71 | 84 | 103 | 159 | 135 | 104 | 167 | 174 | 199 | 187 | 231 | 235 |
| 8 | 3 | 40 | 27 | 72 | 34 | 104 | 92 | 136 | 40 | 168 | 108 | 200 | 121 | 232 | 193 |
| 9 | 14 | 41 | 47 | 73 | 63 | 105 | 124 | 137 | 69 | 169 | 144 | 201 | 153 | 233 | 218 |
| 10 | 17 | 42 | 54 | 74 | 52 | 106 | 132 | 138 | 74 | 170 | 149 | 202 | 161 | 234 | 221 |
| 11 | 26 | 43 | 78 | 75 | 91 | 107 | 166 | 139 | 110 | 171 | 180 | 203 | 194 | 235 | 237 |
| 12 | 10 | 44 | 57 | 76 | 67 | 108 | 140 | 140 | 80 | 172 | 157 | 204 | 168 | 236 | 226 |
| 13 | 30 | 45 | 86 | 77 | 97 | 109 | 170 | 141 | 118 | 173 | 185 | 205 | 197 | 237 | 239 |
| 14 | 33 | 46 | 90 | 78 | 106 | 110 | 177 | 142 | 119 | 174 | 190 | 206 | 203 | 238 | 241 |
| 15 | 60 | 47 | 126 | 79 | 137 | 111 | 207 | 143 | 156 | 175 | 216 | 207 | 225 | 239 | 250 |
| 16 | 5 | 48 | 32 | 80 | 39 | 112 | 102 | 144 | 48 | 176 | 113 | 208 | 128 | 240 | 198 |
| 17 | 16 | 49 | 51 | 81 | 59 | 113 | 135 | 145 | 77 | 177 | 151 | 209 | 164 | 241 | 223 |
| 18 | 12 | 50 | 61 | 82 | 68 | 114 | 142 | 146 | 83 | 178 | 160 | 210 | 171 | 242 | 228 |
| 19 | 28 | 51 | 89 | 83 | 100 | 115 | 173 | 147 | 117 | 179 | 188 | 211 | 200 | 243 | 240 |
| 20 | 18 | 52 | 65 | 84 | 75 | 116 | 148 | 148 | 88 | 180 | 165 | 212 | 178 | 244 | 230 |
| 21 | 35 | 53 | 95 | 85 | 103 | 117 | 179 | 149 | 125 | 181 | 195 | 213 | 205 | 245 | 242 |
| 22 | 42 | 54 | 99 | 86 | 112 | 118 | 184 | 150 | 131 | 182 | 199 | 214 | 208 | 246 | 244 |
| 23 | 64 | 55 | 133 | 87 | 146 | 119 | 212 | 151 | 163 | 183 | 222 | 215 | 229 | 247 | 251 |
| 24 | 20 | 56 | 70 | 88 | 82 | 120 | 158 | 152 | 98 | 184 | 172 | 216 | 183 | 248 | 233 |
| 25 | 44 | 57 | 101 | 89 | 115 | 121 | 186 | 153 | 130 | 185 | 202 | 217 | 210 | 249 | 245 |
| 26 | 37 | 58 | 107 | 90 | 120 | 122 | 191 | 154 | 136 | 186 | 204 | 218 | 214 | 250 | 246 |
| 27 | 71 | 59 | 141 | 91 | 152 | 123 | 217 | 155 | 169 | 187 | 224 | 219 | 232 | 251 | 252 |
| 28 | 49 | 60 | 114 | 92 | 127 | 124 | 196 | 156 | 145 | 188 | 209 | 220 | 219 | 252 | 248 |
| 29 | 76 | 61 | 147 | 93 | 162 | 125 | 220 | 157 | 175 | 189 | 231 | 221 | 236 | 253 | 253 |
| 30 | 81 | 62 | 155 | 94 | 167 | 126 | 227 | 158 | 182 | 190 | 234 | 222 | 238 | 254 | 254 |
| 31 | 122 | 63 | 192 | 95 | 201 | 127 | 243 | 159 | 211 | 191 | 247 | 223 | 249 | 255 | 255 |

Sequence Z4, having a sequence length of 128:
[0, 1, 4, 9, 2, 11, 7, 21, 3, 13, 16, 24, 10, 27, 30, 51, 5, 15, 12, 26, 17, 32, 37, 54, 19, 39, 33, 59, 43, 63, 66, 90, 6, 14, 18, 34, 22, 38, 36, 61, 25, 42, 47, 64, 49, 69, 72, 93, 29, 45, 52, 71, 55, 75, 77, 96, 58, 79, 83, 100, 86, 103, 106, 119, 8, 20, 23, 41, 28, 44, 48, 68, 31, 53, 46, 73, 56, 76, 82, 98, 35, 50, 57, 78, 62, 81, 85, 102, 67, 87, 89, 105, 94, 109, 111, 121, 40, 60, 65, 84, 70, 88, 91, 108, 74, 92, 95, 110, 99, 112, 114, 122, 80, 97, 101, 113, 104, 115, 116, 123, 107, 117, 118, 124, 120, 125, 126, 127]

Table Z4, having a sequence length of 128:

| Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability |
|---|---|---|---|---|---|---|---|---|---|---|---|---|---|---|---|
| 0 | 0 | 16 | 5 | 32 | 6 | 48 | 29 | 64 | 8 | 80 | 35 | 96 | 40 | 112 | 80 |
| 1 | 1 | 17 | 15 | 33 | 14 | 49 | 45 | 65 | 20 | 81 | 50 | 97 | 60 | 113 | 97 |
| 2 | 4 | 18 | 12 | 34 | 18 | 50 | 52 | 66 | 23 | 82 | 57 | 98 | 65 | 114 | 101 |
| 3 | 9 | 19 | 26 | 35 | 34 | 51 | 71 | 67 | 41 | 83 | 78 | 99 | 84 | 115 | 113 |
| 4 | 2 | 20 | 17 | 36 | 22 | 52 | 55 | 68 | 28 | 84 | 62 | 100 | 70 | 116 | 104 |
| 5 | 11 | 21 | 32 | 37 | 38 | 53 | 75 | 69 | 44 | 85 | 81 | 101 | 88 | 117 | 115 |
| 6 | 7 | 22 | 37 | 38 | 36 | 54 | 77 | 70 | 48 | 86 | 85 | 102 | 91 | 118 | 116 |
| 7 | 21 | 23 | 54 | 39 | 61 | 55 | 96 | 71 | 68 | 87 | 102 | 103 | 108 | 119 | 123 |
| 8 | 3 | 24 | 19 | 40 | 25 | 56 | 58 | 72 | 31 | 88 | 67 | 104 | 74 | 120 | 107 |
| 9 | 13 | 25 | 39 | 41 | 42 | 57 | 79 | 73 | 53 | 89 | 87 | 105 | 92 | 121 | 117 |
| 10 | 16 | 26 | 33 | 42 | 47 | 58 | 83 | 74 | 46 | 90 | 89 | 106 | 95 | 122 | 118 |
| 11 | 24 | 27 | 59 | 43 | 64 | 59 | 100 | 75 | 73 | 91 | 105 | 107 | 110 | 123 | 124 |
| 12 | 10 | 28 | 43 | 44 | 49 | 60 | 86 | 76 | 56 | 92 | 94 | 108 | 99 | 124 | 120 |
| 13 | 27 | 29 | 63 | 45 | 69 | 61 | 103 | 77 | 76 | 93 | 109 | 109 | 112 | 125 | 125 |
| 14 | 30 | 30 | 66 | 46 | 72 | 62 | 106 | 78 | 82 | 94 | 111 | 110 | 114 | 126 | 126 |
| 15 | 51 | 31 | 90 | 47 | 93 | 63 | 119 | 79 | 98 | 95 | 121 | 111 | 122 | 127 | 127 |

Sequence Z5, having a sequence length of 64:
[0, 1, 4, 8, 2, 10, 7, 19, 3, 12, 15, 21, 9, 24, 26, 39, 5, 14, 11, 23, 16, 27, 31, 41, 18, 33, 28, 44, 35, 46, 48, 57, 6, 13, 17, 29, 20, 32, 30, 45, 22, 34, 37, 47, 38, 49, 51, 58, 25, 36, 40, 50, 42, 52, 53, 59, 43, 54, 55, 60, 56, 61, 62, 63]
Table Z5, having a sequence length of 64:

| Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability |
|---|---|---|---|---|---|---|---|---|---|---|---|---|---|---|---|
| 0 | 0 | 8 | 3 | 16 | 5 | 24 | 18 | 32 | 6 | 40 | 22 | 48 | 25 | 56 | 43 |
| 1 | 1 | 9 | 12 | 17 | 14 | 25 | 33 | 33 | 13 | 41 | 34 | 49 | 36 | 57 | 54 |
| 2 | 4 | 10 | 15 | 18 | 11 | 26 | 28 | 34 | 17 | 42 | 37 | 50 | 40 | 58 | 55 |
| 3 | 8 | 11 | 21 | 19 | 23 | 27 | 44 | 35 | 29 | 43 | 47 | 51 | 50 | 59 | 60 |
| 4 | 2 | 12 | 9 | 20 | 16 | 28 | 35 | 36 | 20 | 44 | 38 | 52 | 42 | 60 | 56 |
| 5 | 10 | 13 | 24 | 21 | 27 | 29 | 46 | 37 | 32 | 45 | 49 | 53 | 52 | 61 | 61 |
| 6 | 7 | 14 | 26 | 22 | 31 | 30 | 48 | 38 | 30 | 46 | 51 | 54 | 53 | 62 | 62 |
| 7 | 19 | 15 | 39 | 23 | 41 | 31 | 57 | 39 | 45 | 47 | 58 | 55 | 59 | 63 | 63 |

Second group of sequences (obtained by using a criterion that comprehensively considers performance obtained by List (list) whose sizes are respectively 1, 2, 4, 8, and 16, and preferentially considers performance of Lists 1 and 16).

Sequence Q6, having a sequence length of 1024:

[0, 1, 2, 4, 8, 16, 32, 3, 5, 64, 9, 6, 17, 10, 18, 128, 12, 33, 256, 36, 24, 20, 65, 34, 7, 129, 66, 512, 11, 40, 68, 13, 19, 130, 48, 14, 72, 257, 21, 132, 35, 258, 26, 513, 80, 37, 25, 22, 136, 38, 260, 96, 514, 264, 67, 41, 144, 28, 69, 42, 516, 49, 74, 272, 160, 520, 288, 528, 70, 131, 544, 192, 44, 81, 50, 73, 133, 15, 52, 320, 23, 134, 76, 82, 56, 384, 137, 97, 27, 39, 259, 84, 138, 145, 261, 29, 43, 98, 515, 88, 140, 30, 146, 71, 262, 265, 161, 576, 45, 100, 640, 51, 148, 46, 75, 266, 273, 517, 104, 162, 53, 193, 152, 77, 164, 768, 268, 274, 518, 54, 83, 57, 521, 112, 135, 78, 289, 194, 85, 276, 522, 58, 168, 139, 99, 86, 60, 280, 89, 290, 529, 524, 196, 141, 101, 147, 176, 142, 530, 31, 292, 200, 263, 90, 149, 321, 322, 102, 545, 105, 532, 92, 47, 296, 163, 150, 546, 208, 385, 267, 304, 324, 153, 165, 536, 386, 106, 55, 328, 577, 548, 113, 154, 79, 224, 108, 269, 166, 578, 519, 552, 195, 270, 641, 523, 580, 560, 275, 59, 169, 156, 291, 277, 114, 87, 197, 116, 170, 61, 531, 525, 642, 281, 278, 526, 177, 293, 388, 91, 584, 769, 198, 172, 120, 201, 336, 62, 282, 143, 103, 178, 294, 93, 644, 202, 592, 323, 392, 297, 151, 209, 284, 180, 107, 94, 204, 770, 648, 298, 352, 533, 325, 608, 155, 210, 400, 305, 547, 300, 109, 184, 534, 772, 326, 656, 115, 167, 157, 537, 225, 306, 329, 110, 117, 212, 171, 330, 226, 549, 776, 538, 387, 308, 216, 416, 672, 337, 158, 271, 118, 279, 550, 332, 579, 540, 389, 173, 121, 553, 199, 784, 179, 228, 338, 312, 704, 390, 122, 554, 581, 393, 283, 174, 203, 340, 448, 561, 353, 394, 181, 527, 582, 556, 63, 295, 285, 232, 124, 643, 585, 562, 205, 182, 286, 299, 354, 211, 401, 185, 396, 344, 586, 645, 593, 535, 240, 206, 95, 327, 564, 800, 402, 356, 307, 301, 417, 186, 404, 213, 418, 539, 568, 594, 649, 771, 227, 832, 588, 646, 302, 111, 360, 214, 551, 609, 896, 188, 309, 449, 331, 217, 408, 229, 541, 159, 420, 596, 650, 773, 310, 333, 119, 339, 218, 368, 657, 230, 391, 542, 610, 233, 313, 334, 774, 658, 612, 175, 123, 314, 555, 600, 583, 341, 450, 652, 220, 557, 424, 395, 777, 673, 355, 287, 183, 234, 125, 241, 563, 660, 558, 616, 778, 674, 316, 342, 345, 397, 452, 432, 207, 785, 403, 357, 187, 587, 565, 664, 624, 780, 236, 126, 242, 398, 705, 346, 456, 358, 405, 303, 569, 595, 244, 786, 189, 676, 589, 566, 647, 361, 706, 215, 348, 419, 406, 464, 801, 590, 409, 680, 788, 362, 570, 597, 572, 311, 708, 219, 598, 601, 651, 611, 410, 802, 421, 792, 231, 602, 653, 248, 688, 369, 190, 480, 335, 364, 613, 659, 654, 422, 315, 221, 370, 425, 235, 451, 412, 343, 372, 317, 614, 775, 222, 543, 426, 453, 237, 559, 833, 804, 712, 834, 661, 808, 779, 617, 604, 433, 720, 816, 836, 347, 897, 243, 662, 454, 318, 675, 376, 567, 618, 665, 736, 898, 840, 781, 428, 625, 238, 359, 458, 399, 245, 434, 677, 457, 591, 349, 127, 666, 787, 678, 620, 782, 626, 571, 191, 407, 350, 436, 465, 246, 460, 363, 681, 599, 249, 411, 668, 707, 573, 789, 803, 790, 682, 365, 440, 628, 709, 374, 423, 466, 250, 371, 689, 793, 481, 413, 603, 574, 366, 468, 655, 900, 805, 429, 615, 710, 252, 373, 848, 684, 713, 605, 690, 632, 482, 794, 806, 427, 414, 663, 835, 904, 809, 714, 619, 796, 472, 223, 455, 692, 721, 837, 716, 864, 810, 606, 912, 722, 696, 377, 817, 435, 812, 319, 484, 430, 621, 838, 667, 239, 461, 378, 459, 627, 622, 437, 488, 380, 818, 496, 669, 679, 724, 841, 629, 351, 467, 438, 737, 251, 462, 442, 441, 469, 247, 683, 842, 738, 899, 670, 783, 849, 820, 728, 928, 791, 367, 901, 630, 685, 844, 633, 711, 253, 691, 824, 902, 686, 740, 850, 375, 444, 470, 483, 415, 485, 905, 795, 473, 634, 744, 852, 960, 865, 693, 797, 906, 715, 807, 474, 636, 694, 254, 717, 575, 811, 697, 866, 798, 379, 431, 913, 607, 489, 723, 486, 908, 718, 813, 476, 856, 839, 725, 698, 914, 752, 868, 819, 814, 439, 929, 490, 623, 671, 739, 916, 872, 381, 930, 497, 821, 463, 726, 961, 843, 492, 631, 729, 700, 443, 741, 845, 920, 382, 822, 851, 730, 498, 880, 742, 445, 903, 687, 825, 932, 471, 635, 846, 500, 745, 962, 826, 732, 446, 936, 255, 853, 475, 753, 695, 867, 637, 907, 487, 746, 828, 854, 504, 799, 909, 857, 964, 719, 477, 915, 699, 493, 748, 944, 858, 873, 638, 968, 478, 383, 754, 869, 491, 910, 815, 917, 727, 870, 701, 931, 499, 860, 756, 922, 731, 976, 918, 874, 823, 502, 933, 743, 760, 881, 494, 702, 921, 827, 876, 501, 847, 992, 934, 447, 733, 882, 937, 963, 747, 505, 855, 924, 734, 829, 965, 884, 938, 506, 749, 945, 966, 755, 859, 940, 830, 911, 871, 639, 888, 479, 946, 750, 969, 508, 861, 757, 970, 919, 875, 862, 758, 948, 977, 923, 972, 761, 877, 952, 495, 703, 935, 978, 883, 762, 503, 925, 878, 735, 993, 885, 939, 994, 980, 926, 764, 941, 967, 886, 831, 947, 507, 889, 984, 751, 942, 996, 971, 890, 509, 949, 973, 1000, 892, 950, 863, 759, 1008, 510, 979, 953, 763, 974, 954, 879, 981, 982, 927, 995, 765, 956, 887, 985, 997, 986, 943, 891, 998, 766, 511, 988, 1001, 951, 1002, 893, 975, 894, 1009, 955, 1004, 1010, 957, 983, 958, 987, 1012, 999, 1016, 767, 989, 1003, 990, 1005, 959, 1011, 1013, 895, 1006, 1014, 1017, 1018, 991, 1020, 1007, 1015, 1019, 1021, 1022, 1023]

Table Q6, having a sequence length of 1024:

| Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number |
|---|---|---|---|---|---|---|---|---|---|---|---|---|---|---|---|
| 0 | 0 | 128 | 518 | 256 | 770 | 384 | 609 | 512 | 480 | 640 | 663 | 768 | 819 | 896 | 966 |
| 1 | 1 | 129 | 54 | 257 | 648 | 385 | 896 | 513 | 335 | 641 | 835 | 769 | 814 | 897 | 755 |
| 2 | 2 | 130 | 83 | 258 | 298 | 386 | 188 | 514 | 364 | 642 | 904 | 770 | 439 | 898 | 859 |
| 3 | 4 | 131 | 57 | 259 | 352 | 387 | 309 | 515 | 613 | 643 | 809 | 771 | 929 | 899 | 940 |
| 4 | 8 | 132 | 521 | 260 | 533 | 388 | 449 | 516 | 659 | 644 | 714 | 772 | 490 | 900 | 830 |
| 5 | 16 | 133 | 112 | 261 | 325 | 389 | 331 | 517 | 654 | 645 | 619 | 773 | 623 | 901 | 911 |
| 6 | 32 | 134 | 135 | 262 | 608 | 390 | 217 | 518 | 422 | 646 | 796 | 774 | 671 | 902 | 871 |
| 7 | 3 | 135 | 78 | 263 | 155 | 391 | 408 | 519 | 315 | 647 | 472 | 775 | 739 | 903 | 639 |
| 8 | 5 | 136 | 289 | 264 | 210 | 392 | 229 | 520 | 221 | 648 | 223 | 776 | 916 | 904 | 888 |
| 9 | 64 | 137 | 194 | 265 | 400 | 393 | 541 | 521 | 370 | 649 | 455 | 777 | 872 | 905 | 479 |
| 10 | 9 | 138 | 85 | 266 | 305 | 394 | 159 | 522 | 425 | 650 | 692 | 778 | 381 | 906 | 946 |
| 11 | 6 | 139 | 276 | 267 | 547 | 395 | 420 | 523 | 235 | 651 | 721 | 779 | 930 | 907 | 750 |
| 12 | 17 | 140 | 522 | 268 | 300 | 396 | 596 | 524 | 451 | 652 | 837 | 780 | 497 | 908 | 969 |
| 13 | 10 | 141 | 58 | 269 | 109 | 397 | 650 | 525 | 412 | 653 | 716 | 781 | 821 | 909 | 508 |
| 14 | 18 | 142 | 168 | 270 | 184 | 398 | 773 | 526 | 343 | 654 | 864 | 782 | 463 | 910 | 861 |
| 15 | 128 | 143 | 139 | 271 | 534 | 399 | 310 | 527 | 372 | 655 | 810 | 783 | 726 | 911 | 757 |
| 16 | 12 | 144 | 99 | 272 | 772 | 400 | 333 | 528 | 317 | 656 | 606 | 784 | 961 | 912 | 970 |
| 17 | 33 | 145 | 86 | 273 | 326 | 401 | 119 | 529 | 614 | 657 | 912 | 785 | 843 | 913 | 919 |
| 18 | 256 | 146 | 60 | 274 | 656 | 402 | 339 | 530 | 775 | 658 | 722 | 786 | 492 | 914 | 875 |
| 19 | 36 | 147 | 280 | 275 | 115 | 403 | 218 | 531 | 222 | 659 | 696 | 787 | 631 | 915 | 862 |
| 20 | 24 | 148 | 89 | 276 | 167 | 404 | 368 | 532 | 543 | 660 | 377 | 788 | 729 | 916 | 758 |
| 21 | 20 | 149 | 290 | 277 | 157 | 405 | 657 | 533 | 426 | 661 | 817 | 789 | 700 | 917 | 948 |
| 22 | 65 | 150 | 529 | 278 | 537 | 406 | 230 | 534 | 453 | 662 | 435 | 790 | 443 | 918 | 977 |
| 23 | 34 | 151 | 524 | 279 | 225 | 407 | 391 | 535 | 237 | 663 | 812 | 791 | 741 | 919 | 923 |
| 24 | 7 | 152 | 196 | 280 | 306 | 408 | 542 | 536 | 559 | 664 | 319 | 792 | 845 | 920 | 972 |
| 25 | 129 | 153 | 141 | 281 | 329 | 409 | 610 | 537 | 833 | 665 | 484 | 793 | 920 | 921 | 761 |
| 26 | 66 | 154 | 101 | 282 | 110 | 410 | 233 | 538 | 804 | 666 | 430 | 794 | 382 | 922 | 877 |
| 27 | 512 | 155 | 147 | 283 | 117 | 411 | 313 | 539 | 712 | 667 | 621 | 795 | 822 | 923 | 952 |
| 28 | 11 | 156 | 176 | 284 | 212 | 412 | 334 | 540 | 834 | 668 | 838 | 796 | 851 | 924 | 495 |
| 29 | 40 | 157 | 142 | 285 | 171 | 413 | 774 | 541 | 661 | 669 | 667 | 797 | 730 | 925 | 703 |
| 30 | 68 | 158 | 530 | 286 | 330 | 414 | 658 | 542 | 808 | 670 | 239 | 798 | 498 | 926 | 935 |

| 31 | 13 | 159 | 31 | 287 | 226 | 415 | 612 | 543 | 779 | 671 | 461 | 799 | 880 | 927 | 978 |
|---|---|---|---|---|---|---|---|---|---|---|---|---|---|---|---|
| 32 | 19 | 160 | 292 | 288 | 549 | 416 | 175 | 544 | 617 | 672 | 378 | 800 | 742 | 928 | 883 |
| 33 | 130 | 161 | 200 | 289 | 776 | 417 | 123 | 545 | 604 | 673 | 459 | 801 | 445 | 929 | 762 |
| 34 | 48 | 162 | 263 | 290 | 538 | 418 | 314 | 546 | 433 | 674 | 627 | 802 | 903 | 930 | 503 |
| 35 | 14 | 163 | 90 | 291 | 387 | 419 | 555 | 547 | 720 | 675 | 622 | 803 | 687 | 931 | 925 |
| 36 | 72 | 164 | 149 | 292 | 308 | 420 | 600 | 548 | 816 | 676 | 437 | 804 | 825 | 932 | 878 |
| 37 | 257 | 165 | 321 | 293 | 216 | 421 | 583 | 549 | 836 | 677 | 488 | 805 | 932 | 933 | 735 |
| 38 | 21 | 166 | 322 | 294 | 416 | 422 | 341 | 550 | 347 | 678 | 380 | 806 | 471 | 934 | 993 |
| 39 | 132 | 167 | 102 | 295 | 672 | 423 | 450 | 551 | 897 | 679 | 818 | 807 | 635 | 935 | 885 |
| 40 | 35 | 168 | 545 | 296 | 337 | 424 | 652 | 552 | 243 | 680 | 496 | 808 | 846 | 936 | 939 |
| 41 | 258 | 169 | 105 | 297 | 158 | 425 | 220 | 553 | 662 | 681 | 669 | 809 | 500 | 937 | 994 |
| 42 | 26 | 170 | 532 | 298 | 271 | 426 | 557 | 554 | 454 | 682 | 679 | 810 | 745 | 938 | 980 |
| 43 | 513 | 171 | 92 | 299 | 118 | 427 | 424 | 555 | 318 | 683 | 724 | 811 | 962 | 939 | 926 |
| 44 | 80 | 172 | 47 | 300 | 279 | 428 | 395 | 556 | 675 | 684 | 841 | 812 | 826 | 940 | 764 |
| 45 | 37 | 173 | 296 | 301 | 550 | 429 | 777 | 557 | 376 | 685 | 629 | 813 | 732 | 941 | 941 |
| 46 | 25 | 174 | 163 | 302 | 332 | 430 | 673 | 558 | 567 | 686 | 351 | 814 | 446 | 942 | 967 |
| 47 | 22 | 175 | 150 | 303 | 579 | 431 | 355 | 559 | 618 | 687 | 467 | 815 | 936 | 943 | 886 |
| 48 | 136 | 176 | 546 | 304 | 540 | 432 | 287 | 560 | 665 | 688 | 438 | 816 | 255 | 944 | 831 |
| 49 | 38 | 177 | 208 | 305 | 389 | 433 | 183 | 561 | 736 | 689 | 737 | 817 | 853 | 945 | 947 |
| 50 | 260 | 178 | 385 | 306 | 173 | 434 | 234 | 562 | 898 | 690 | 251 | 818 | 475 | 946 | 507 |
| 51 | 96 | 179 | 267 | 307 | 121 | 435 | 125 | 563 | 840 | 691 | 462 | 819 | 753 | 947 | 889 |
| 52 | 514 | 180 | 304 | 308 | 553 | 436 | 241 | 564 | 781 | 692 | 442 | 820 | 695 | 948 | 984 |
| 53 | 264 | 181 | 324 | 309 | 199 | 437 | 563 | 565 | 428 | 693 | 441 | 821 | 867 | 949 | 751 |
| 54 | 67 | 182 | 153 | 310 | 784 | 438 | 660 | 566 | 625 | 694 | 469 | 822 | 637 | 950 | 942 |
| 55 | 41 | 183 | 165 | 311 | 179 | 439 | 558 | 567 | 238 | 695 | 247 | 823 | 907 | 951 | 996 |
| 56 | 144 | 184 | 536 | 312 | 228 | 440 | 616 | 568 | 359 | 696 | 683 | 824 | 487 | 952 | 971 |
| 57 | 28 | 185 | 386 | 313 | 338 | 441 | 778 | 569 | 458 | 697 | 842 | 825 | 746 | 953 | 890 |
| 58 | 69 | 186 | 106 | 314 | 312 | 442 | 674 | 570 | 399 | 698 | 738 | 826 | 828 | 954 | 509 |
| 59 | 42 | 187 | 55 | 315 | 704 | 443 | 316 | 571 | 245 | 699 | 899 | 827 | 854 | 955 | 949 |
| 60 | 516 | 188 | 328 | 316 | 390 | 444 | 342 | 572 | 434 | 700 | 670 | 828 | 504 | 956 | 973 |
| 61 | 49 | 189 | 577 | 317 | 122 | 445 | 345 | 573 | 677 | 701 | 783 | 829 | 799 | 957 | 1000 |
| 62 | 74 | 190 | 548 | 318 | 554 | 446 | 397 | 574 | 457 | 702 | 849 | 830 | 909 | 958 | 892 |
| 63 | 272 | 191 | 113 | 319 | 581 | 447 | 452 | 575 | 591 | 703 | 820 | 831 | 857 | 959 | 950 |
| 64 | 160 | 192 | 154 | 320 | 393 | 448 | 432 | 576 | 349 | 704 | 728 | 832 | 964 | 960 | 863 |
| 65 | 520 | 193 | 79 | 321 | 283 | 449 | 207 | 577 | 127 | 705 | 928 | 833 | 719 | 961 | 759 |
| 66 | 288 | 194 | 224 | 322 | 174 | 450 | 785 | 578 | 666 | 706 | 791 | 834 | 477 | 962 | 1008 |
| 67 | 528 | 195 | 108 | 323 | 203 | 451 | 403 | 579 | 787 | 707 | 367 | 835 | 915 | 963 | 510 |
| 68 | 70 | 196 | 269 | 324 | 340 | 452 | 357 | 580 | 678 | 708 | 901 | 836 | 699 | 964 | 979 |

| 69 | 131 | 197 | 166 | 325 | 448 | 453 | 187 | 581 | 620 | 709 | 630 | 837 | 493 | 965 | 953 |
|---|---|---|---|---|---|---|---|---|---|---|---|---|---|---|---|
| 70 | 544 | 198 | 578 | 326 | 561 | 454 | 587 | 582 | 782 | 710 | 685 | 838 | 748 | 966 | 763 |
| 71 | 192 | 199 | 519 | 327 | 353 | 455 | 565 | 583 | 626 | 711 | 844 | 839 | 944 | 967 | 974 |
| 72 | 44 | 200 | 552 | 328 | 394 | 456 | 664 | 584 | 571 | 712 | 633 | 840 | 858 | 968 | 954 |
| 73 | 81 | 201 | 195 | 329 | 181 | 457 | 624 | 585 | 191 | 713 | 711 | 841 | 873 | 969 | 879 |
| 74 | 50 | 202 | 270 | 330 | 527 | 458 | 780 | 586 | 407 | 714 | 253 | 842 | 638 | 970 | 981 |
| 75 | 73 | 203 | 641 | 331 | 582 | 459 | 236 | 587 | 350 | 715 | 691 | 843 | 968 | 971 | 982 |
| 76 | 133 | 204 | 523 | 332 | 556 | 460 | 126 | 588 | 436 | 716 | 824 | 844 | 478 | 972 | 927 |
| 77 | 15 | 205 | 580 | 333 | 63 | 461 | 242 | 589 | 465 | 717 | 902 | 845 | 383 | 973 | 995 |
| 78 | 52 | 206 | 560 | 334 | 295 | 462 | 398 | 590 | 246 | 718 | 686 | 846 | 754 | 974 | 765 |
| 79 | 320 | 207 | 275 | 335 | 285 | 463 | 705 | 591 | 460 | 719 | 740 | 847 | 869 | 975 | 956 |
| 80 | 23 | 208 | 59 | 336 | 232 | 464 | 346 | 592 | 363 | 720 | 850 | 848 | 491 | 976 | 887 |
| 81 | 134 | 209 | 169 | 337 | 124 | 465 | 456 | 593 | 681 | 721 | 375 | 849 | 910 | 977 | 985 |
| 82 | 76 | 210 | 156 | 338 | 643 | 466 | 358 | 594 | 599 | 722 | 444 | 850 | 815 | 978 | 997 |
| 83 | 82 | 211 | 291 | 339 | 585 | 467 | 405 | 595 | 249 | 723 | 470 | 851 | 917 | 979 | 986 |
| 84 | 56 | 212 | 277 | 340 | 562 | 468 | 303 | 596 | 411 | 724 | 483 | 852 | 727 | 980 | 943 |
| 85 | 384 | 213 | 114 | 341 | 205 | 469 | 569 | 597 | 668 | 725 | 415 | 853 | 870 | 981 | 891 |
| 86 | 137 | 214 | 87 | 342 | 182 | 470 | 595 | 598 | 707 | 726 | 485 | 854 | 701 | 982 | 998 |
| 87 | 97 | 215 | 197 | 343 | 286 | 471 | 244 | 599 | 573 | 727 | 905 | 855 | 931 | 983 | 766 |
| 88 | 27 | 216 | 116 | 344 | 299 | 472 | 786 | 600 | 789 | 728 | 795 | 856 | 499 | 984 | 511 |
| 89 | 39 | 217 | 170 | 345 | 354 | 473 | 189 | 601 | 803 | 729 | 473 | 857 | 860 | 985 | 988 |
| 90 | 259 | 218 | 61 | 346 | 211 | 474 | 676 | 602 | 790 | 730 | 634 | 858 | 756 | 986 | 1001 |
| 91 | 84 | 219 | 531 | 347 | 401 | 475 | 589 | 603 | 682 | 731 | 744 | 859 | 922 | 987 | 951 |
| 92 | 138 | 220 | 525 | 348 | 185 | 476 | 566 | 604 | 365 | 732 | 852 | 860 | 731 | 988 | 1002 |
| 93 | 145 | 221 | 642 | 349 | 396 | 477 | 647 | 605 | 440 | 733 | 960 | 861 | 976 | 989 | 893 |
| 94 | 261 | 222 | 281 | 350 | 344 | 478 | 361 | 606 | 628 | 734 | 865 | 862 | 918 | 990 | 975 |
| 95 | 29 | 223 | 278 | 351 | 586 | 479 | 706 | 607 | 709 | 735 | 693 | 863 | 874 | 991 | 894 |
| 96 | 43 | 224 | 526 | 352 | 645 | 480 | 215 | 608 | 374 | 736 | 797 | 864 | 823 | 992 | 1009 |
| 97 | 98 | 225 | 177 | 353 | 593 | 481 | 348 | 609 | 423 | 737 | 906 | 865 | 502 | 993 | 955 |
| 98 | 515 | 226 | 293 | 354 | 535 | 482 | 419 | 610 | 466 | 738 | 715 | 866 | 933 | 994 | 1004 |
| 99 | 88 | 227 | 388 | 355 | 240 | 483 | 406 | 611 | 250 | 739 | 807 | 867 | 743 | 995 | 1010 |
| 100 | 140 | 228 | 91 | 356 | 206 | 484 | 464 | 612 | 371 | 740 | 474 | 868 | 760 | 996 | 957 |
| 101 | 30 | 229 | 584 | 357 | 95 | 485 | 801 | 613 | 689 | 741 | 636 | 869 | 881 | 997 | 983 |
| 102 | 146 | 230 | 769 | 358 | 327 | 486 | 590 | 614 | 793 | 742 | 694 | 870 | 494 | 998 | 958 |
| 103 | 71 | 231 | 198 | 359 | 564 | 487 | 409 | 615 | 481 | 743 | 254 | 871 | 702 | 999 | 987 |
| 104 | 262 | 232 | 172 | 360 | 800 | 488 | 680 | 616 | 413 | 744 | 717 | 872 | 921 | 1000 | 1012 |
| 105 | 265 | 233 | 120 | 361 | 402 | 489 | 788 | 617 | 603 | 745 | 575 | 873 | 827 | 1001 | 999 |
| 106 | 161 | 234 | 201 | 362 | 356 | 490 | 362 | 618 | 574 | 746 | 811 | 874 | 876 | 1002 | 1016 |

| | | | | | | | | | | | | | | | |
|---|---|---|---|---|---|---|---|---|---|---|---|---|---|---|---|
| 107 | 576 | 235 | 336 | 363 | 307 | 491 | 570 | 619 | 366 | 747 | 697 | 875 | 501 | 1003 | 767 |
| 108 | 45 | 236 | 62 | 364 | 301 | 492 | 597 | 620 | 468 | 748 | 866 | 876 | 847 | 1004 | 989 |
| 109 | 100 | 237 | 282 | 365 | 417 | 493 | 572 | 621 | 655 | 749 | 798 | 877 | 992 | 1005 | 1003 |
| 110 | 640 | 238 | 143 | 366 | 186 | 494 | 311 | 622 | 900 | 750 | 379 | 878 | 934 | 1006 | 990 |
| 111 | 51 | 239 | 103 | 367 | 404 | 495 | 708 | 623 | 805 | 751 | 431 | 879 | 447 | 1007 | 1005 |
| 112 | 148 | 240 | 178 | 368 | 213 | 496 | 219 | 624 | 429 | 752 | 913 | 880 | 733 | 1008 | 959 |
| 113 | 46 | 241 | 294 | 369 | 418 | 497 | 598 | 625 | 615 | 753 | 607 | 881 | 882 | 1009 | 1011 |
| 114 | 75 | 242 | 93 | 370 | 539 | 498 | 601 | 626 | 710 | 754 | 489 | 882 | 937 | 1010 | 1013 |
| 115 | 266 | 243 | 644 | 371 | 568 | 499 | 651 | 627 | 252 | 755 | 723 | 883 | 963 | 1011 | 895 |
| 116 | 273 | 244 | 202 | 372 | 594 | 500 | 611 | 628 | 373 | 756 | 486 | 884 | 747 | 1012 | 1006 |
| 117 | 517 | 245 | 592 | 373 | 649 | 501 | 410 | 629 | 848 | 757 | 908 | 885 | 505 | 1013 | 1014 |
| 118 | 104 | 246 | 323 | 374 | 771 | 502 | 802 | 630 | 684 | 758 | 718 | 886 | 855 | 1014 | 1017 |
| 119 | 162 | 247 | 392 | 375 | 227 | 503 | 421 | 631 | 713 | 759 | 813 | 887 | 924 | 1015 | 1018 |
| 120 | 53 | 248 | 297 | 376 | 832 | 504 | 792 | 632 | 605 | 760 | 476 | 888 | 734 | 1016 | 991 |
| 121 | 193 | 249 | 151 | 377 | 588 | 505 | 231 | 633 | 690 | 761 | 856 | 889 | 829 | 1017 | 1020 |
| 122 | 152 | 250 | 209 | 378 | 646 | 506 | 602 | 634 | 632 | 762 | 839 | 890 | 965 | 1018 | 1007 |
| 123 | 77 | 251 | 284 | 379 | 302 | 507 | 653 | 635 | 482 | 763 | 725 | 891 | 884 | 1019 | 1015 |
| 124 | 164 | 252 | 180 | 380 | 111 | 508 | 248 | 636 | 794 | 764 | 698 | 892 | 938 | 1020 | 1019 |
| 125 | 768 | 253 | 107 | 381 | 360 | 509 | 688 | 637 | 806 | 765 | 914 | 893 | 506 | 1021 | 1021 |
| 126 | 268 | 254 | 94 | 382 | 214 | 510 | 369 | 638 | 427 | 766 | 752 | 894 | 749 | 1022 | 1022 |
| 127 | 274 | 255 | 204 | 383 | 551 | 511 | 190 | 639 | 414 | 767 | 868 | 895 | 945 | 1023 | 1023 |

Sequence Q7, having a sequence length of 512:

[0, 1, 2, 4, 8, 16, 32, 3, 5, 64, 9, 6, 17, 10, 18, 128, 12, 33, 256, 36, 24, 20, 65, 34, 7, 129, 66, 11, 40, 68, 13, 19, 130, 48, 14, 72, 257, 21, 132, 35, 258, 26, 80, 37, 25, 22, 136, 38, 260, 96, 264, 67, 41, 144, 28, 69, 42, 49, 74, 272, 160, 288, 70, 131, 192, 44, 81, 50, 73, 133, 15, 52, 320, 23, 134, 76, 82, 56, 384, 137, 97, 27, 39, 259, 84, 138, 145, 261, 29, 43, 98, 88, 140, 30, 146, 71, 262, 265, 161, 45, 100, 51, 148, 46, 75, 266, 273, 104, 162, 53, 193, 152, 77, 164, 268, 274, 54, 83, 57, 112, 135, 78, 289, 194, 85, 276, 58, 168, 139, 99, 86, 60, 280, 89, 290, 196, 141, 101, 147, 176, 142, 31, 292, 200, 263, 90, 149, 321, 322, 102, 105, 92, 47, 296, 163, 150, 208, 385, 267, 304, 324, 153, 165, 386, 106, 55, 328, 113, 154, 79, 224, 108, 269, 166, 195, 270, 275, 59, 169, 156, 291, 277, 114, 87, 197, 116, 170, 61, 281, 278, 177, 293, 388, 91, 198, 172, 120, 201, 336, 62, 282, 143, 103, 178, 294, 93, 202, 323, 392, 297, 151, 209, 284, 180, 107, 94, 204, 298, 352, 325, 155, 210, 400, 305, 300, 109, 184, 326, 115, 167, 157, 225, 306, 329, 110, 117, 212, 171, 330, 226, 387, 308, 216, 416, 337, 158, 271, 118, 279, 332, 389, 173, 121, 199, 179, 228, 338, 312, 390, 122, 393, 283, 174, 203, 340, 448, 353, 394, 181, 63, 295, 285, 232, 124, 205, 182, 286, 299, 354, 211, 401, 185, 396, 344, 240, 206, 95, 327, 402, 356, 307, 301, 417, 186, 404, 213, 418, 227, 302, 111, 360, 214, 188, 309, 449, 331, 217, 408, 229, 159, 420, 310, 333, 119, 339, 218, 368, 230, 391, 233, 313, 334, 175, 123, 314, 341, 450, 220, 424, 395, 355, 287, 183, 234, 125, 241, 316, 342, 345, 397, 452, 432, 207, 403, 357, 187, 236, 126, 242, 398, 346, 456, 358, 405, 303, 244, 189, 361, 215, 348, 419, 406, 464, 409, 362, 311, 219, 410, 421, 231, 248, 369, 190, 480, 335, 364, 422, 315, 221, 370, 425, 235, 451, 412, 343, 372, 317, 222, 426, 453, 237, 433, 347, 243, 454, 318, 376, 428, 238, 359, 458, 399, 245, 434, 457, 349, 127, 191, 407, 350, 436, 465, 246, 460, 363, 249, 411, 365, 440, 374, 423, 466, 250, 371, 481, 413, 366, 468, 429, 252, 373, 482, 427, 414, 472, 223, 455, 377, 435, 319, 484, 430, 239, 461, 378, 459, 437, 488, 380, 496, 351, 467, 438, 251, 462, 442, 441, 469, 247, 367, 253, 375, 444, 470, 483, 415, 485, 473, 474, 254, 379, 431, 489, 486, 476, 439, 490, 381, 497, 463, 492, 443, 382, 498, 445, 471, 500, 446, 255, 475, 487, 504, 477, 493, 478, 383, 491, 499, 502, 494, 501, 447, 505, 506, 479, 508, 495, 503,507,509,510,511]

Table Q7, having a sequence length of 512:

| Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number |
|---|---|---|---|---|---|---|---|---|---|---|---|---|---|---|---|
| 0 | 0 | 64 | 192 | 128 | 139 | 192 | 388 | 256 | 338 | 320 | 313 | 384 | 343 | 448 | 380 |
| 1 | 1 | 65 | 44 | 129 | 99 | 193 | 91 | 257 | 312 | 321 | 334 | 385 | 372 | 449 | 496 |
| 2 | 2 | 66 | 81 | 130 | 86 | 194 | 198 | 258 | 390 | 322 | 175 | 386 | 317 | 450 | 351 |
| 3 | 4 | 67 | 50 | 131 | 60 | 195 | 172 | 259 | 122 | 323 | 123 | 387 | 222 | 451 | 467 |
| 4 | 8 | 68 | 73 | 132 | 280 | 196 | 120 | 260 | 393 | 324 | 314 | 388 | 426 | 452 | 438 |
| 5 | 16 | 69 | 133 | 133 | 89 | 197 | 201 | 261 | 283 | 325 | 341 | 389 | 453 | 453 | 251 |
| 6 | 32 | 70 | 15 | 134 | 290 | 198 | 336 | 262 | 174 | 326 | 450 | 390 | 237 | 454 | 462 |
| 7 | 3 | 71 | 52 | 135 | 196 | 199 | 62 | 263 | 203 | 327 | 220 | 391 | 433 | 455 | 442 |
| 8 | 5 | 72 | 320 | 136 | 141 | 200 | 282 | 264 | 340 | 328 | 424 | 392 | 347 | 456 | 441 |
| 9 | 64 | 73 | 23 | 137 | 101 | 201 | 143 | 265 | 448 | 329 | 395 | 393 | 243 | 457 | 469 |
| 10 | 9 | 74 | 134 | 138 | 147 | 202 | 103 | 266 | 353 | 330 | 355 | 394 | 454 | 458 | 247 |
| 11 | 6 | 75 | 76 | 139 | 176 | 203 | 178 | 267 | 394 | 331 | 287 | 395 | 318 | 459 | 367 |
| 12 | 17 | 76 | 82 | 140 | 142 | 204 | 294 | 268 | 181 | 332 | 183 | 396 | 376 | 460 | 253 |
| 13 | 10 | 77 | 56 | 141 | 31 | 205 | 93 | 269 | 63 | 333 | 234 | 397 | 428 | 461 | 375 |
| 14 | 18 | 78 | 384 | 142 | 292 | 206 | 202 | 270 | 295 | 334 | 125 | 398 | 238 | 462 | 444 |
| 15 | 128 | 79 | 137 | 143 | 200 | 207 | 323 | 271 | 285 | 335 | 241 | 399 | 359 | 463 | 470 |
| 16 | 12 | 80 | 97 | 144 | 263 | 208 | 392 | 272 | 232 | 336 | 316 | 400 | 458 | 464 | 483 |
| 17 | 33 | 81 | 27 | 145 | 90 | 209 | 297 | 273 | 124 | 337 | 342 | 401 | 399 | 465 | 415 |
| 18 | 256 | 82 | 39 | 146 | 149 | 210 | 151 | 274 | 205 | 338 | 345 | 402 | 245 | 466 | 485 |

| | | | | | | | | | | | | | | | |
|---|---|---|---|---|---|---|---|---|---|---|---|---|---|---|---|
| 19 | 36 | 83 | 259 | 147 | 321 | 211 | 209 | 275 | 182 | 339 | 397 | 403 | 434 | 467 | 473 |
| 20 | 24 | 84 | 84 | 148 | 322 | 212 | 284 | 276 | 286 | 340 | 452 | 404 | 457 | 468 | 474 |
| 21 | 20 | 85 | 138 | 149 | 102 | 213 | 180 | 277 | 299 | 341 | 432 | 405 | 349 | 469 | 254 |
| 22 | 65 | 86 | 145 | 150 | 105 | 214 | 107 | 278 | 354 | 342 | 207 | 406 | 127 | 470 | 379 |
| 23 | 34 | 87 | 261 | 151 | 92 | 215 | 94 | 279 | 211 | 343 | 403 | 407 | 191 | 471 | 431 |
| 24 | 7 | 88 | 29 | 152 | 47 | 216 | 204 | 280 | 401 | 344 | 357 | 408 | 407 | 472 | 489 |
| 25 | 129 | 89 | 43 | 153 | 296 | 217 | 298 | 281 | 185 | 345 | 187 | 409 | 350 | 473 | 486 |
| 26 | 66 | 90 | 98 | 154 | 163 | 218 | 352 | 282 | 396 | 346 | 236 | 410 | 436 | 474 | 476 |
| 27 | 11 | 91 | 88 | 155 | 150 | 219 | 325 | 283 | 344 | 347 | 126 | 411 | 465 | 475 | 439 |
| 28 | 40 | 92 | 140 | 156 | 208 | 220 | 155 | 284 | 240 | 348 | 242 | 412 | 246 | 476 | 490 |
| 29 | 68 | 93 | 30 | 157 | 385 | 221 | 210 | 285 | 206 | 349 | 398 | 413 | 460 | 477 | 381 |
| 30 | 13 | 94 | 146 | 158 | 267 | 222 | 400 | 286 | 95 | 350 | 346 | 414 | 363 | 478 | 497 |
| 31 | 19 | 95 | 71 | 159 | 304 | 223 | 305 | 287 | 327 | 351 | 456 | 415 | 249 | 479 | 463 |
| 32 | 130 | 96 | 262 | 160 | 324 | 224 | 300 | 288 | 402 | 352 | 358 | 416 | 411 | 480 | 492 |
| 33 | 48 | 97 | 265 | 161 | 153 | 225 | 109 | 289 | 356 | 353 | 405 | 417 | 365 | 481 | 443 |
| 34 | 14 | 98 | 161 | 162 | 165 | 226 | 184 | 290 | 307 | 354 | 303 | 418 | 440 | 482 | 382 |
| 35 | 72 | 99 | 45 | 163 | 386 | 227 | 326 | 291 | 301 | 355 | 244 | 419 | 374 | 483 | 498 |
| 36 | 257 | 100 | 100 | 164 | 106 | 228 | 115 | 292 | 417 | 356 | 189 | 420 | 423 | 484 | 445 |
| 37 | 21 | 101 | 51 | 165 | 55 | 229 | 167 | 293 | 186 | 357 | 361 | 421 | 466 | 485 | 471 |
| 38 | 132 | 102 | 148 | 166 | 328 | 230 | 157 | 294 | 404 | 358 | 215 | 422 | 250 | 486 | 500 |
| 39 | 35 | 103 | 46 | 167 | 113 | 231 | 225 | 295 | 213 | 359 | 348 | 423 | 371 | 487 | 446 |
| 40 | 258 | 104 | 75 | 168 | 154 | 232 | 306 | 296 | 418 | 360 | 419 | 424 | 481 | 488 | 255 |
| 41 | 26 | 105 | 266 | 169 | 79 | 233 | 329 | 297 | 227 | 361 | 406 | 425 | 413 | 489 | 475 |
| 42 | 80 | 106 | 273 | 170 | 224 | 234 | 110 | 298 | 302 | 362 | 464 | 426 | 366 | 490 | 487 |
| 43 | 37 | 107 | 104 | 171 | 108 | 235 | 117 | 299 | 111 | 363 | 409 | 427 | 468 | 491 | 504 |
| 44 | 25 | 108 | 162 | 172 | 269 | 236 | 212 | 300 | 360 | 364 | 362 | 428 | 429 | 492 | 477 |
| 45 | 22 | 109 | 53 | 173 | 166 | 237 | 171 | 301 | 214 | 365 | 311 | 429 | 252 | 493 | 493 |
| 46 | 136 | 110 | 193 | 174 | 195 | 238 | 330 | 302 | 188 | 366 | 219 | 430 | 373 | 494 | 478 |
| 47 | 38 | 111 | 152 | 175 | 270 | 239 | 226 | 303 | 309 | 367 | 410 | 431 | 482 | 495 | 383 |
| 48 | 260 | 112 | 77 | 176 | 275 | 240 | 387 | 304 | 449 | 368 | 421 | 432 | 427 | 496 | 491 |
| 49 | 96 | 113 | 164 | 177 | 59 | 241 | 308 | 305 | 331 | 369 | 231 | 433 | 414 | 497 | 499 |
| 50 | 264 | 114 | 268 | 178 | 169 | 242 | 216 | 306 | 217 | 370 | 248 | 434 | 472 | 498 | 502 |
| 51 | 67 | 115 | 274 | 179 | 156 | 243 | 416 | 307 | 408 | 371 | 369 | 435 | 223 | 499 | 494 |
| 52 | 41 | 116 | 54 | 180 | 291 | 244 | 337 | 308 | 229 | 372 | 190 | 436 | 455 | 500 | 501 |
| 53 | 144 | 117 | 83 | 181 | 277 | 245 | 158 | 309 | 159 | 373 | 480 | 437 | 377 | 501 | 447 |
| 54 | 28 | 118 | 57 | 182 | 114 | 246 | 271 | 310 | 420 | 374 | 335 | 438 | 435 | 502 | 505 |
| 55 | 69 | 119 | 112 | 183 | 87 | 247 | 118 | 311 | 310 | 375 | 364 | 439 | 319 | 503 | 506 |
| 56 | 42 | 120 | 135 | 184 | 197 | 248 | 279 | 312 | 333 | 376 | 422 | 440 | 484 | 504 | 479 |

| | | | | | | | | | | | | | | | |
|---|---|---|---|---|---|---|---|---|---|---|---|---|---|---|---|
| 57 | 49 | 121 | 78 | 185 | 116 | 249 | 332 | 313 | 119 | 377 | 315 | 441 | 430 | 505 | 508 |
| 58 | 74 | 122 | 289 | 186 | 170 | 250 | 389 | 314 | 339 | 378 | 221 | 442 | 239 | 506 | 495 |
| 59 | 272 | 123 | 194 | 187 | 61 | 251 | 173 | 315 | 218 | 379 | 370 | 443 | 461 | 507 | 503 |
| 60 | 160 | 124 | 85 | 188 | 281 | 252 | 121 | 316 | 368 | 380 | 425 | 444 | 378 | 508 | 507 |
| 61 | 288 | 125 | 276 | 189 | 278 | 253 | 199 | 317 | 230 | 381 | 235 | 445 | 459 | 509 | 509 |
| 62 | 70 | 126 | 58 | 190 | 177 | 254 | 179 | 318 | 391 | 382 | 451 | 446 | 437 | 510 | 510 |
| 63 | 131 | 127 | 168 | 191 | 293 | 255 | 228 | 319 | 233 | 383 | 412 | 447 | 488 | 511 | 511 |

Sequence Q8, having a sequence length of 256:
[0, 1, 2, 4, 8, 16, 32, 3, 5, 64, 9, 6, 17, 10, 18, 128, 12, 33, 36, 24, 20, 65, 34, 7, 129, 66, 11, 40, 68, 13, 19, 130, 48, 14, 72, 21, 132, 35, 26, 80, 37, 25, 22, 136, 38, 96, 67, 41, 144, 28, 69, 42, 49, 74, 160, 70, 131, 192, 44, 81, 50, 73, 133, 15, 52, 23, 134, 76, 82, 56, 137, 97, 27, 39, 84, 138, 145, 29, 43, 98, 88, 140, 30, 146, 71, 161, 45, 100, 51, 148, 46, 75, 104, 162, 53, 193, 152, 77, 164, 54, 83, 57, 112, 135, 78, 194, 85, 58, 168, 139, 99, 86, 60, 89, 196, 141, 101, 147, 176, 142, 31, 200, 90, 149, 102, 105, 92, 47, 163, 150, 208, 153, 165, 106, 55, 113, 154, 79, 224, 108, 166, 195, 59, 169, 156, 114, 87, 197, 116, 170, 61, 177, 91, 198, 172, 120, 201, 62, 143, 103, 178, 93, 202, 151, 209, 180, 107, 94, 204, 155, 210, 109, 184, 115, 167, 157, 225, 110, 117, 212, 171, 226, 216, 158, 118, 173, 121, 199, 179, 228, 122, 174, 203, 181, 63, 232, 124, 205, 182, 211, 185, 240, 206, 95, 186, 213, 227, 111, 214, 188, 217, 229, 159, 119, 218, 230, 233, 175, 123, 220, 183, 234, 125, 241, 207, 187, 236, 126, 242, 244, 189, 215, 219, 231, 248, 190, 221, 235, 222, 237, 243, 238, 245, 127, 191, 246, 249, 250, 252, 223, 239, 251, 247, 253, 254, 255]

Table Q8, having a sequence length of 256:

| Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number |
|---|---|---|---|---|---|---|---|---|---|---|---|---|---|---|---|
| 0 | 0 | 32 | 48 | 64 | 52 | 96 | 152 | 128 | 163 | 160 | 178 | 192 | 203 | 224 | 207 |
| 1 | 1 | 33 | 14 | 65 | 23 | 97 | 77 | 129 | 150 | 161 | 93 | 193 | 181 | 225 | 187 |
| 2 | 2 | 34 | 72 | 66 | 134 | 98 | 164 | 130 | 208 | 162 | 202 | 194 | 63 | 226 | 236 |
| 3 | 4 | 35 | 21 | 67 | 76 | 99 | 54 | 131 | 153 | 163 | 151 | 195 | 232 | 227 | 126 |
| 4 | 8 | 36 | 132 | 68 | 82 | 100 | 83 | 132 | 165 | 164 | 209 | 196 | 124 | 228 | 242 |
| 5 | 16 | 37 | 35 | 69 | 56 | 101 | 57 | 133 | 106 | 165 | 180 | 197 | 205 | 229 | 244 |
| 6 | 32 | 38 | 26 | 70 | 137 | 102 | 112 | 134 | 55 | 166 | 107 | 198 | 182 | 230 | 189 |
| 7 | 3 | 39 | 80 | 71 | 97 | 103 | 135 | 135 | 113 | 167 | 94 | 199 | 211 | 231 | 215 |

| 8 | 5 | 40 | 37 | 72 | 27 | 104 | 78 | 136 | 154 | 168 | 204 | 200 | 185 | 232 | 219 |
|---|---|----|----|----|----|-----|----|-----|-----|-----|-----|-----|-----|-----|-----|
| 9 | 64 | 41 | 25 | 73 | 39 | 105 | 194 | 137 | 79 | 169 | 155 | 201 | 240 | 233 | 231 |
| 10 | 9 | 42 | 22 | 74 | 84 | 106 | 85 | 138 | 224 | 170 | 210 | 202 | 206 | 234 | 248 |
| 11 | 6 | 43 | 136 | 75 | 138 | 107 | 58 | 139 | 108 | 171 | 109 | 203 | 95 | 235 | 190 |
| 12 | 17 | 44 | 38 | 76 | 145 | 108 | 168 | 140 | 166 | 172 | 184 | 204 | 186 | 236 | 221 |
| 13 | 10 | 45 | 96 | 77 | 29 | 109 | 139 | 141 | 195 | 173 | 115 | 205 | 213 | 237 | 235 |
| 14 | 18 | 46 | 67 | 78 | 43 | 110 | 99 | 142 | 59 | 174 | 167 | 206 | 227 | 238 | 222 |
| 15 | 128 | 47 | 41 | 79 | 98 | 111 | 86 | 143 | 169 | 175 | 157 | 207 | 111 | 239 | 237 |
| 16 | 12 | 48 | 144 | 80 | 88 | 112 | 60 | 144 | 156 | 176 | 225 | 208 | 214 | 240 | 243 |
| 17 | 33 | 49 | 28 | 81 | 140 | 113 | 89 | 145 | 114 | 177 | 110 | 209 | 188 | 241 | 238 |
| 18 | 36 | 50 | 69 | 82 | 30 | 114 | 196 | 146 | 87 | 178 | 117 | 210 | 217 | 242 | 245 |
| 19 | 24 | 51 | 42 | 83 | 146 | 115 | 141 | 147 | 197 | 179 | 212 | 211 | 229 | 243 | 127 |
| 20 | 20 | 52 | 49 | 84 | 71 | 116 | 101 | 148 | 116 | 180 | 171 | 212 | 159 | 244 | 191 |
| 21 | 65 | 53 | 74 | 85 | 161 | 117 | 147 | 149 | 170 | 181 | 226 | 213 | 119 | 245 | 246 |
| 22 | 34 | 54 | 160 | 86 | 45 | 118 | 176 | 150 | 61 | 182 | 216 | 214 | 218 | 246 | 249 |
| 23 | 7 | 55 | 70 | 87 | 100 | 119 | 142 | 151 | 177 | 183 | 158 | 215 | 230 | 247 | 250 |
| 24 | 129 | 56 | 131 | 88 | 51 | 120 | 31 | 152 | 91 | 184 | 118 | 216 | 233 | 248 | 252 |
| 25 | 66 | 57 | 192 | 89 | 148 | 121 | 200 | 153 | 198 | 185 | 173 | 217 | 175 | 249 | 223 |
| 26 | 11 | 58 | 44 | 90 | 46 | 122 | 90 | 154 | 172 | 186 | 121 | 218 | 123 | 250 | 239 |
| 27 | 40 | 59 | 81 | 91 | 75 | 123 | 149 | 155 | 120 | 187 | 199 | 219 | 220 | 251 | 251 |
| 28 | 68 | 60 | 50 | 92 | 104 | 124 | 102 | 156 | 201 | 188 | 179 | 220 | 183 | 252 | 247 |
| 29 | 13 | 61 | 73 | 93 | 162 | 125 | 105 | 157 | 62 | 189 | 228 | 221 | 234 | 253 | 253 |
| 30 | 19 | 62 | 133 | 94 | 53 | 126 | 92 | 158 | 143 | 190 | 122 | 222 | 125 | 254 | 254 |
| 31 | 130 | 63 | 15 | 95 | 193 | 127 | 47 | 159 | 103 | 191 | 174 | 223 | 241 | 255 | 255 |

Sequence Q9, having a sequence length of 128:

[0, 1, 2, 4, 8, 16, 32, 3, 5, 64, 9, 6, 17, 10, 18, 12, 33, 36, 24, 20, 65, 34, 7, 66, 11, 40, 68, 13, 19, 48, 14, 72, 21, 35, 26, 80, 37, 25, 22, 38, 96, 67, 41, 28, 69, 42, 49, 74, 70, 44, 81, 50, 73, 15, 52, 23, 76, 82, 56, 97, 27, 39, 84, 29, 43, 98, 88, 30, 71, 45, 100, 51, 46, 75, 104, 53, 77, 54, 83, 57, 112, 78, 85, 58, 99, 86, 60, 89, 101, 31, 90, 102, 105, 92, 47, 106, 55, 113, 79, 108, 59, 114, 87, 116, 61, 91, 120, 62, 103, 93, 107, 94, 109, 115, 110, 117, 118, 121, 122, 63, 124, 95, 111, 119, 123, 125, 126, 127]

Table Q9, having a sequence length of 128:

| Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number |
|---|---|---|---|---|---|---|---|---|---|---|---|---|---|---|---|
| 0 | 0 | 16 | 33 | 32 | 21 | 48 | 70 | 64 | 43 | 80 | 112 | 96 | 55 | 112 | 109 |
| 1 | 1 | 17 | 36 | 33 | 35 | 49 | 44 | 65 | 98 | 81 | 78 | 97 | 113 | 113 | 115 |
| 2 | 2 | 18 | 24 | 34 | 26 | 50 | 81 | 66 | 88 | 82 | 85 | 98 | 79 | 114 | 110 |
| 3 | 4 | 19 | 20 | 35 | 80 | 51 | 50 | 67 | 30 | 83 | 58 | 99 | 108 | 115 | 117 |
| 4 | 8 | 20 | 65 | 36 | 37 | 52 | 73 | 68 | 71 | 84 | 99 | 100 | 59 | 116 | 118 |
| 5 | 16 | 21 | 34 | 37 | 25 | 53 | 15 | 69 | 45 | 85 | 86 | 101 | 114 | 117 | 121 |
| 6 | 32 | 22 | 7 | 38 | 22 | 54 | 52 | 70 | 100 | 86 | 60 | 102 | 87 | 118 | 122 |
| 7 | 3 | 23 | 66 | 39 | 38 | 55 | 23 | 71 | 51 | 87 | 89 | 103 | 116 | 119 | 63 |
| 8 | 5 | 24 | 11 | 40 | 96 | 56 | 76 | 72 | 46 | 88 | 101 | 104 | 61 | 120 | 124 |
| 9 | 64 | 25 | 40 | 41 | 67 | 57 | 82 | 73 | 75 | 89 | 31 | 105 | 91 | 121 | 95 |
| 10 | 9 | 26 | 68 | 42 | 41 | 58 | 56 | 74 | 104 | 90 | 90 | 106 | 120 | 122 | 111 |
| 11 | 6 | 27 | 13 | 43 | 28 | 59 | 97 | 75 | 53 | 91 | 102 | 107 | 62 | 123 | 119 |
| 12 | 17 | 28 | 19 | 44 | 69 | 60 | 27 | 76 | 77 | 92 | 105 | 108 | 103 | 124 | 123 |
| 13 | 10 | 29 | 48 | 45 | 42 | 61 | 39 | 77 | 54 | 93 | 92 | 109 | 93 | 125 | 125 |
| 14 | 18 | 30 | 14 | 46 | 49 | 62 | 84 | 78 | 83 | 94 | 47 | 110 | 107 | 126 | 126 |
| 15 | 12 | 31 | 72 | 47 | 74 | 63 | 29 | 79 | 57 | 95 | 106 | 111 | 94 | 127 | 127 |

Sequence Q10, having a sequence length of 64:
[0, 1, 2, 4, 8, 16, 32, 3, 5, 9, 6, 17, 10, 18, 12, 33, 36, 24, 20, 34, 7, 11, 40, 13, 19, 48, 14, 21, 35, 26, 37, 25, 22, 38, 41, 28, 42, 49, 44, 50, 15, 52, 23, 56, 27, 39, 29, 43, 30, 45, 51, 46, 53, 54, 57, 58, 60, 31, 47, 55, 59, 61, 62, 63]

Table Q10, having a sequence length of 64:

| Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number |
|---|---|---|---|---|---|---|---|---|---|---|---|---|---|---|---|
| 0 | 0 | 8 | 5 | 16 | 36 | 24 | 19 | 32 | 22 | 40 | 15 | 48 | 30 | 56 | 60 |
| 1 | 1 | 9 | 9 | 17 | 24 | 25 | 48 | 33 | 38 | 41 | 52 | 49 | 45 | 57 | 31 |
| 2 | 2 | 10 | 6 | 18 | 20 | 26 | 14 | 34 | 41 | 42 | 23 | 50 | 51 | 58 | 47 |
| 3 | 4 | 11 | 17 | 19 | 34 | 27 | 21 | 35 | 28 | 43 | 56 | 51 | 46 | 59 | 55 |

| 4 | 8 | 12 | 10 | 20 | 7 | 28 | 35 | 36 | 42 | 44 | 27 | 52 | 53 | 60 | 59 |
|---|---|---|---|---|---|---|---|---|---|---|---|---|---|---|---|
| 5 | 16 | 13 | 18 | 21 | 11 | 29 | 26 | 37 | 49 | 45 | 39 | 53 | 54 | 61 | 61 |
| 6 | 32 | 14 | 12 | 22 | 40 | 30 | 37 | 38 | 44 | 46 | 29 | 54 | 57 | 62 | 62 |
| 7 | 3 | 15 | 33 | 23 | 13 | 31 | 25 | 39 | 50 | 47 | 43 | 55 | 58 | 63 | 63 |

Sequence Z6, having a sequence length of 1024:

[0, 1, 2, 7, 3, 8, 11, 24, 4, 10, 13, 28, 16, 31, 35, 77, 5, 12, 14, 32, 21, 38, 47, 80, 20, 46, 42, 88, 57, 95, 101, 159, 6, 17, 23, 40, 19, 45, 49, 89, 29, 55, 59, 96, 72, 108, 113, 172, 34, 61, 74, 111, 78, 120, 129, 187, 84, 131, 141, 208, 146, 218, 236, 333, 9, 22, 26, 54, 30, 58, 68, 103, 36, 75, 62, 114, 82, 123, 135, 193, 44, 73, 83, 130, 91, 138, 145, 214, 99, 148, 163, 228, 171, 242, 254, 357, 51, 87, 97, 144, 109, 154, 167, 239, 118, 169, 186, 253, 195, 269, 282, 380, 133, 191, 213, 275, 216, 283, 299, 401, 233, 307, 317, 417, 337, 435, 460, 577, 15, 25, 33, 69, 39, 76, 81, 134, 48, 86, 92, 143, 100, 153, 157, 238, 56, 93, 102, 155, 112, 164, 175, 249, 122, 182, 192, 263, 210, 277, 297, 394, 64, 106, 119, 174, 124, 183, 197, 276, 142, 209, 217, 285, 232, 306, 322, 416, 156, 225, 240, 311, 252, 329, 342, 433, 270, 348, 366, 453, 386, 473, 511, 585, 71, 121, 137, 201, 152, 215, 231, 309, 161, 234, 244, 323, 255, 341, 356, 449, 177, 250, 264, 346, 284, 368, 382, 480, 293, 390, 403, 496, 425, 520, 531, 648, 194, 279, 287, 375, 312, 392, 406, 505, 336, 410, 434, 523, 459, 535, 567, 670, 355, 436, 461, 552, 471, 571, 590, 695, 508, 595, 611, 690, 627, 714, 743, 816, 18, 37, 41, 90, 50, 94, 104, 162, 53, 105, 115, 179, 126, 196, 202, 298, 63, 116, 127, 207, 139, 212, 223, 300, 147, 222, 237, 321, 251, 335, 343, 432, 66, 136, 149, 211, 160, 226, 241, 334, 173, 248, 258, 344, 268, 364, 379, 468, 180, 266, 280, 363, 292, 387, 399, 494, 314, 411, 418, 519, 443, 528, 555, 664, 79, 165, 166, 246, 181, 261, 273, 358, 188, 281, 286, 389, 302, 400, 412, 513, 235, 296, 313, 402, 324, 422, 444, 526, 350, 445, 464, 550, 481, 576, 587, 686, 259, 327, 345, 431, 362, 452, 466, 568, 381, 478, 490, 592, 514, 604, 619, 707, 404, 510, 521, 612, 527, 628, 608, 721, 557, 660, 672, 750, 678, 778, 794, 845, 85, 178, 185, 291, 227, 305, 316, 407, 247, 320, 328, 428, 349, 446, 462, 570, 265, 347, 361, 451, 367, 467, 483, 586, 391, 487, 501, 596, 525, 616, 639, 725, 294, 365, 369, 482, 395, 503, 518, 609, 427, 522, 533, 638, 565, 624, 666, 751, 448, 546, 572, 662, 588, 676, 688, 770, 605, 693, 692, 790, 722, 801, 814, 879, 325, 388, 423, 524, 447, 534, 554, 649, 465, 574, 569, 673, 591, 671, 691, 782, 484, 589, 610, 687, 620, 694, 723, 806, 647, 729, 740, 818, 760, 834, 844, 905, 512, 615, 635, 724, 665, 726, 756, 824, 677, 754, 772, 848, 786, 837, 870, 924, 680, 780, 798, 856, 809, 875, 865, 930, 828, 885, 893, 946, 909, 954, 963, 984, 27, 43, 52, 98, 60, 117, 128, 199, 65, 132, 140, 204, 151, 220, 224, 330, 67, 150, 158, 219, 170, 260, 271, 354, 184, 278, 290, 370, 304, 393, 408, 532, 70, 168, 176, 267, 190, 288, 301, 383, 200, 308, 318, 419, 332, 426, 439, 536, 206, 326, 340, 437, 359, 455, 476, 558, 371, 469, 491, 584, 493, 599, 618, 745, 107, 189, 198, 303, 205, 319, 331, 421, 229, 339, 351, 454, 377, 475, 486, 575, 245, 353, 372, 470, 396, 492, 497, 594, 420, 498, 506, 617, 545, 632, 656, 753, 262, 384, 409, 500, 415, 515, 529, 625, 440, 544, 559, 645, 581, 667, 675, 773, 457, 566, 583, 674, 606, 685, 709, 787, 634, 712, 730, 807, 741, 822, 842, 903, 110, 203, 221, 338, 243, 352, 378, 477, 257, 373, 397, 499, 424, 507, 517, 621, 274, 405, 414, 516, 438, 541, 553, 640, 456, 560, 578, 669, 597, 681, 700, 774, 295, 430, 442, 556, 474, 573, 580, 682, 488, 593, 603, 696, 630, 710, 718, 803, 509, 613, 633, 715, 650, 735, 742, 820, 659, 747, 764, 836, 789, 854, 871, 925, 315, 463, 479, 598, 495, 607, 626, 713, 539, 631, 644, 738, 653, 744, 758, 833, 547, 651, 658, 755, 683, 763, 783, 852, 704, 788, 797, 860, 813, 880, 888, 933, 561, 689, 698, 775, 719, 791, 800, 867, 731, 810, 825, 884, 838, 894, 907, 949, 766, 819, 846, 897, 858, 911, 916, 961, 868, 921, 929, 966, 940, 974, 983, 1003, 125, 230, 256, 374, 272, 398, 413, 530, 289, 429, 441, 543, 458, 564, 582, 701, 310, 450, 472, 579, 489, 600, 602, 706, 504, 614, 636, 728, 646, 736, 749, 829, 360, 485, 502, 601, 538, 623, 637, 739, 542, 643, 655, 746, 663, 759, 769, 850, 548, 661, 679, 768, 703, 781, 795, 864, 716, 804, 812, 873, 826, 889, 900, 944, 376, 537, 540, 641, 549, 652, 668, 762, 563, 684, 697, 785, 711, 792, 808, 876, 629, 702, 720, 796, 732, 817, 827, 886, 761, 831, 840, 898, 857, 910, 915, 960, 654, 734, 748, 821, 767, 847, 853, 902, 777, 841, 863, 914, 874, 922, 932, 969, 799, 869, 881, 928, 891, 935, 943, 976, 904, 947, 953, 981, 958, 989, 991, 1011, 385, 551, 562, 699, 622, 708, 717, 802, 642, 727, 737, 823, 757, 830, 849, 901, 657, 752, 765, 835, 776, 851, 862, 913, 793, 872, 859, 919, 887, 931, 939, 972, 705, 771, 779, 855, 805, 866, 878, 926, 815, 882, 892, 936, 899, 941, 950, 980, 839, 895, 906, 945, 917, 955, 959, 987, 923, 965, 968, 993, 975, 996, 998, 1008, 733, 784, 811, 883, 832, 890, 896, 942, 843, 908, 912, 952, 920, 956, 967, 990, 861, 918, 927, 964, 938, 970, 971, 997, 948, 977, 979, 999, 985, 1004, 1006, 1016, 877, 934, 937, 973, 951, 978, 982, 1001, 957, 986, 988, 1005, 994, 1007, 1012, 1018, 962, 992, 995, 1009, 1000, 1010, 1013, 1019, 1002, 1014, 1015, 1020, 1017, 1021, 1022, 1023]

Table Z6, having a sequence length of 1024:

| Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability |
|---|---|---|---|---|---|---|---|---|---|---|---|---|---|---|---|
| 0 | 0 | 128 | 15 | 256 | 18 | 384 | 85 | 512 | 27 | 640 | 110 | 768 | 125 | 896 | 385 |
| 1 | 1 | 129 | 25 | 257 | 37 | 385 | 178 | 513 | 43 | 641 | 203 | 769 | 230 | 897 | 551 |
| 2 | 2 | 130 | 33 | 258 | 41 | 386 | 185 | 514 | 52 | 642 | 221 | 770 | 256 | 898 | 562 |
| 3 | 7 | 131 | 69 | 259 | 90 | 387 | 291 | 515 | 98 | 643 | 338 | 771 | 374 | 899 | 699 |
| 4 | 3 | 132 | 39 | 260 | 50 | 388 | 227 | 516 | 60 | 644 | 243 | 772 | 272 | 900 | 622 |
| 5 | 8 | 133 | 76 | 261 | 94 | 389 | 305 | 517 | 117 | 645 | 352 | 773 | 398 | 901 | 708 |
| 6 | 11 | 134 | 81 | 262 | 104 | 390 | 316 | 518 | 128 | 646 | 378 | 774 | 413 | 902 | 717 |

| | | | | | | | | | | | | | | | |
|---|---|---|---|---|---|---|---|---|---|---|---|---|---|---|---|
| 7 | 24 | 135 | 134 | 263 | 162 | 391 | 407 | 519 | 199 | 647 | 477 | 775 | 530 | 903 | 802 |
| 8 | 4 | 136 | 48 | 264 | 53 | 392 | 247 | 520 | 65 | 648 | 257 | 776 | 289 | 904 | 642 |
| 9 | 10 | 137 | 86 | 265 | 105 | 393 | 320 | 521 | 132 | 649 | 373 | 777 | 429 | 905 | 727 |
| 10 | 13 | 138 | 92 | 266 | 115 | 394 | 328 | 522 | 140 | 650 | 397 | 778 | 441 | 906 | 737 |
| 11 | 28 | 139 | 143 | 267 | 179 | 395 | 428 | 523 | 204 | 651 | 499 | 779 | 543 | 907 | 823 |
| 12 | 16 | 140 | 100 | 268 | 126 | 396 | 349 | 524 | 151 | 652 | 424 | 780 | 458 | 908 | 757 |
| 13 | 31 | 141 | 153 | 269 | 196 | 397 | 446 | 525 | 220 | 653 | 507 | 781 | 564 | 909 | 830 |
| 14 | 35 | 142 | 157 | 270 | 202 | 398 | 462 | 526 | 224 | 654 | 517 | 782 | 582 | 910 | 849 |
| 15 | 77 | 143 | 238 | 271 | 298 | 399 | 570 | 527 | 330 | 655 | 621 | 783 | 701 | 911 | 901 |
| 16 | 5 | 144 | 56 | 272 | 63 | 400 | 265 | 528 | 67 | 656 | 274 | 784 | 310 | 912 | 657 |
| 17 | 12 | 145 | 93 | 273 | 116 | 401 | 347 | 529 | 150 | 657 | 405 | 785 | 450 | 913 | 752 |
| 18 | 14 | 146 | 102 | 274 | 127 | 402 | 361 | 530 | 158 | 658 | 414 | 786 | 472 | 914 | 765 |
| 19 | 32 | 147 | 155 | 275 | 207 | 403 | 451 | 531 | 219 | 659 | 516 | 787 | 579 | 915 | 835 |
| 20 | 21 | 148 | 112 | 276 | 139 | 404 | 367 | 532 | 170 | 660 | 438 | 788 | 489 | 916 | 776 |
| 21 | 38 | 149 | 164 | 277 | 212 | 405 | 467 | 533 | 260 | 661 | 541 | 789 | 600 | 917 | 851 |
| 22 | 47 | 150 | 175 | 278 | 223 | 406 | 483 | 534 | 271 | 662 | 553 | 790 | 602 | 918 | 862 |
| 23 | 80 | 151 | 249 | 279 | 300 | 407 | 586 | 535 | 354 | 663 | 640 | 791 | 706 | 919 | 913 |
| 24 | 20 | 152 | 122 | 280 | 147 | 408 | 391 | 536 | 184 | 664 | 456 | 792 | 504 | 920 | 793 |
| 25 | 46 | 153 | 182 | 281 | 222 | 409 | 487 | 537 | 278 | 665 | 560 | 793 | 614 | 921 | 872 |
| 26 | 42 | 154 | 192 | 282 | 237 | 410 | 501 | 538 | 290 | 666 | 578 | 794 | 636 | 922 | 859 |
| 27 | 88 | 155 | 263 | 283 | 321 | 411 | 596 | 539 | 370 | 667 | 669 | 795 | 728 | 923 | 919 |
| 28 | 57 | 156 | 210 | 284 | 251 | 412 | 525 | 540 | 304 | 668 | 597 | 796 | 646 | 924 | 887 |
| 29 | 95 | 157 | 277 | 285 | 335 | 413 | 616 | 541 | 393 | 669 | 681 | 797 | 736 | 925 | 931 |
| 30 | 101 | 158 | 297 | 286 | 343 | 414 | 639 | 542 | 408 | 670 | 700 | 798 | 749 | 926 | 939 |
| 31 | 159 | 159 | 394 | 287 | 432 | 415 | 725 | 543 | 532 | 671 | 774 | 799 | 829 | 927 | 972 |
| 32 | 6 | 160 | 64 | 288 | 66 | 416 | 294 | 544 | 70 | 672 | 295 | 800 | 360 | 928 | 705 |
| 33 | 17 | 161 | 106 | 289 | 136 | 417 | 365 | 545 | 168 | 673 | 430 | 801 | 485 | 929 | 771 |
| 34 | 23 | 162 | 119 | 290 | 149 | 418 | 369 | 546 | 176 | 674 | 442 | 802 | 502 | 930 | 779 |
| 35 | 40 | 163 | 174 | 291 | 211 | 419 | 482 | 547 | 267 | 675 | 556 | 803 | 601 | 931 | 855 |
| 36 | 19 | 164 | 124 | 292 | 160 | 420 | 395 | 548 | 190 | 676 | 474 | 804 | 538 | 932 | 805 |
| 37 | 45 | 165 | 183 | 293 | 226 | 421 | 503 | 549 | 288 | 677 | 573 | 805 | 623 | 933 | 866 |
| 38 | 49 | 166 | 197 | 294 | 241 | 422 | 518 | 550 | 301 | 678 | 580 | 806 | 637 | 934 | 878 |
| 39 | 89 | 167 | 276 | 295 | 334 | 423 | 609 | 551 | 383 | 679 | 682 | 807 | 739 | 935 | 926 |
| 40 | 29 | 168 | 142 | 296 | 173 | 424 | 427 | 552 | 200 | 680 | 488 | 808 | 542 | 936 | 815 |
| 41 | 55 | 169 | 209 | 297 | 248 | 425 | 522 | 553 | 308 | 681 | 593 | 809 | 643 | 937 | 882 |
| 42 | 59 | 170 | 217 | 298 | 258 | 426 | 533 | 554 | 318 | 682 | 603 | 810 | 655 | 938 | 892 |
| 43 | 96 | 171 | 285 | 299 | 344 | 427 | 638 | 555 | 419 | 683 | 696 | 811 | 746 | 939 | 936 |
| 44 | 72 | 172 | 232 | 300 | 268 | 428 | 565 | 556 | 332 | 684 | 630 | 812 | 663 | 940 | 899 |

| | | | | | | | | | | | | | | | |
|---|---|---|---|---|---|---|---|---|---|---|---|---|---|---|---|
| 45 | 108 | 173 | 306 | 301 | 364 | 429 | 624 | 557 | 426 | 685 | 710 | 813 | 759 | 941 | 941 |
| 46 | 113 | 174 | 322 | 302 | 379 | 430 | 666 | 558 | 439 | 686 | 718 | 814 | 769 | 942 | 950 |
| 47 | 172 | 175 | 416 | 303 | 468 | 431 | 751 | 559 | 536 | 687 | 803 | 815 | 850 | 943 | 980 |
| 48 | 34 | 176 | 156 | 304 | 180 | 432 | 448 | 560 | 206 | 688 | 509 | 816 | 548 | 944 | 839 |
| 49 | 61 | 177 | 225 | 305 | 266 | 433 | 546 | 561 | 326 | 689 | 613 | 817 | 661 | 945 | 895 |
| 50 | 74 | 178 | 240 | 306 | 280 | 434 | 572 | 562 | 340 | 690 | 633 | 818 | 679 | 946 | 906 |
| 51 | 111 | 179 | 311 | 307 | 363 | 435 | 662 | 563 | 437 | 691 | 715 | 819 | 768 | 947 | 945 |
| 52 | 78 | 180 | 252 | 308 | 292 | 436 | 588 | 564 | 359 | 692 | 650 | 820 | 703 | 948 | 917 |
| 53 | 120 | 181 | 329 | 309 | 387 | 437 | 676 | 565 | 455 | 693 | 735 | 821 | 781 | 949 | 955 |
| 54 | 129 | 182 | 342 | 310 | 399 | 438 | 688 | 566 | 476 | 694 | 742 | 822 | 795 | 950 | 959 |
| 55 | 187 | 183 | 433 | 311 | 494 | 439 | 770 | 567 | 558 | 695 | 820 | 823 | 864 | 951 | 987 |
| 56 | 84 | 184 | 270 | 312 | 314 | 440 | 605 | 568 | 371 | 696 | 659 | 824 | 716 | 952 | 923 |
| 57 | 131 | 185 | 348 | 313 | 411 | 441 | 693 | 569 | 469 | 697 | 747 | 825 | 804 | 953 | 965 |
| 58 | 141 | 186 | 366 | 314 | 418 | 442 | 692 | 570 | 491 | 698 | 764 | 826 | 812 | 954 | 968 |
| 59 | 208 | 187 | 453 | 315 | 519 | 443 | 790 | 571 | 584 | 699 | 836 | 827 | 873 | 955 | 993 |
| 60 | 146 | 188 | 386 | 316 | 443 | 444 | 722 | 572 | 493 | 700 | 789 | 828 | 826 | 956 | 975 |
| 61 | 218 | 189 | 473 | 317 | 528 | 445 | 801 | 573 | 599 | 701 | 854 | 829 | 889 | 957 | 996 |
| 62 | 236 | 190 | 511 | 318 | 555 | 446 | 814 | 574 | 618 | 702 | 871 | 830 | 900 | 958 | 998 |
| 63 | 333 | 191 | 585 | 319 | 664 | 447 | 879 | 575 | 745 | 703 | 925 | 831 | 944 | 959 | 1008 |
| 64 | 9 | 192 | 71 | 320 | 79 | 448 | 325 | 576 | 107 | 704 | 315 | 832 | 376 | 960 | 733 |
| 65 | 22 | 193 | 121 | 321 | 165 | 449 | 388 | 577 | 189 | 705 | 463 | 833 | 537 | 961 | 784 |
| 66 | 26 | 194 | 137 | 322 | 166 | 450 | 423 | 578 | 198 | 706 | 479 | 834 | 540 | 962 | 811 |
| 67 | 54 | 195 | 201 | 323 | 246 | 451 | 524 | 579 | 303 | 707 | 598 | 835 | 641 | 963 | 883 |
| 68 | 30 | 196 | 152 | 324 | 181 | 452 | 447 | 580 | 205 | 708 | 495 | 836 | 549 | 964 | 832 |
| 69 | 58 | 197 | 215 | 325 | 261 | 453 | 534 | 581 | 319 | 709 | 607 | 837 | 652 | 965 | 890 |
| 70 | 68 | 198 | 231 | 326 | 273 | 454 | 554 | 582 | 331 | 710 | 626 | 838 | 668 | 966 | 896 |
| 71 | 103 | 199 | 309 | 327 | 358 | 455 | 649 | 583 | 421 | 711 | 713 | 839 | 762 | 967 | 942 |
| 72 | 36 | 200 | 161 | 328 | 188 | 456 | 465 | 584 | 229 | 712 | 539 | 840 | 563 | 968 | 843 |
| 73 | 75 | 201 | 234 | 329 | 281 | 457 | 574 | 585 | 339 | 713 | 631 | 841 | 684 | 969 | 908 |
| 74 | 62 | 202 | 244 | 330 | 286 | 458 | 569 | 586 | 351 | 714 | 644 | 842 | 697 | 970 | 912 |
| 75 | 114 | 203 | 323 | 331 | 389 | 459 | 673 | 587 | 454 | 715 | 738 | 843 | 785 | 971 | 952 |
| 76 | 82 | 204 | 255 | 332 | 302 | 460 | 591 | 588 | 377 | 716 | 653 | 844 | 711 | 972 | 920 |
| 77 | 123 | 205 | 341 | 333 | 400 | 461 | 671 | 589 | 475 | 717 | 744 | 845 | 792 | 973 | 956 |
| 78 | 135 | 206 | 356 | 334 | 412 | 462 | 691 | 590 | 486 | 718 | 758 | 846 | 808 | 974 | 967 |
| 79 | 193 | 207 | 449 | 335 | 513 | 463 | 782 | 591 | 575 | 719 | 833 | 847 | 876 | 975 | 990 |
| 80 | 44 | 208 | 177 | 336 | 235 | 464 | 484 | 592 | 245 | 720 | 547 | 848 | 629 | 976 | 861 |
| 81 | 73 | 209 | 250 | 337 | 296 | 465 | 589 | 593 | 353 | 721 | 651 | 849 | 702 | 977 | 918 |
| 82 | 83 | 210 | 264 | 338 | 313 | 466 | 610 | 594 | 372 | 722 | 658 | 850 | 720 | 978 | 927 |

| 83 | 130 | 211 | 346 | 339 | 402 | 467 | 687 | 595 | 470 | 723 | 755 | 851 | 796 | 979 | 964 |
|---|---|---|---|---|---|---|---|---|---|---|---|---|---|---|---|
| 84 | 91 | 212 | 284 | 340 | 324 | 468 | 620 | 596 | 396 | 724 | 683 | 852 | 732 | 980 | 938 |
| 85 | 138 | 213 | 368 | 341 | 422 | 469 | 694 | 597 | 492 | 725 | 763 | 853 | 817 | 981 | 970 |
| 86 | 145 | 214 | 382 | 342 | 444 | 470 | 723 | 598 | 497 | 726 | 783 | 854 | 827 | 982 | 971 |
| 87 | 214 | 215 | 480 | 343 | 526 | 471 | 806 | 599 | 594 | 727 | 852 | 855 | 886 | 983 | 997 |
| 88 | 99 | 216 | 293 | 344 | 350 | 472 | 647 | 600 | 420 | 728 | 704 | 856 | 761 | 984 | 948 |
| 89 | 148 | 217 | 390 | 345 | 445 | 473 | 729 | 601 | 498 | 729 | 788 | 857 | 831 | 985 | 977 |
| 90 | 163 | 218 | 403 | 346 | 464 | 474 | 740 | 602 | 506 | 730 | 797 | 858 | 840 | 986 | 979 |
| 91 | 228 | 219 | 496 | 347 | 550 | 475 | 818 | 603 | 617 | 731 | 860 | 859 | 898 | 987 | 999 |
| 92 | 171 | 220 | 425 | 348 | 481 | 476 | 760 | 604 | 545 | 732 | 813 | 860 | 857 | 988 | 985 |
| 93 | 242 | 221 | 520 | 349 | 576 | 477 | 834 | 605 | 632 | 733 | 880 | 861 | 910 | 989 | 1004 |
| 94 | 254 | 222 | 531 | 350 | 587 | 478 | 844 | 606 | 656 | 734 | 888 | 862 | 915 | 990 | 1006 |
| 95 | 357 | 223 | 648 | 351 | 686 | 479 | 905 | 607 | 753 | 735 | 933 | 863 | 960 | 991 | 1016 |
| 96 | 51 | 224 | 194 | 352 | 259 | 480 | 512 | 608 | 262 | 736 | 561 | 864 | 654 | 992 | 877 |
| 97 | 87 | 225 | 279 | 353 | 327 | 481 | 615 | 609 | 384 | 737 | 689 | 865 | 734 | 993 | 934 |
| 98 | 97 | 226 | 287 | 354 | 345 | 482 | 635 | 610 | 409 | 738 | 698 | 866 | 748 | 994 | 937 |
| 99 | 144 | 227 | 375 | 355 | 431 | 483 | 724 | 611 | 500 | 739 | 775 | 867 | 821 | 995 | 973 |
| 100 | 109 | 228 | 312 | 356 | 362 | 484 | 665 | 612 | 415 | 740 | 719 | 868 | 767 | 996 | 951 |
| 101 | 154 | 229 | 392 | 357 | 452 | 485 | 726 | 613 | 515 | 741 | 791 | 869 | 847 | 997 | 978 |
| 102 | 167 | 230 | 406 | 358 | 466 | 486 | 756 | 614 | 529 | 742 | 800 | 870 | 853 | 998 | 982 |
| 103 | 239 | 231 | 505 | 359 | 568 | 487 | 824 | 615 | 625 | 743 | 867 | 871 | 902 | 999 | 1001 |
| 104 | 118 | 232 | 336 | 360 | 381 | 488 | 677 | 616 | 440 | 744 | 731 | 872 | 777 | 1000 | 957 |
| 105 | 169 | 233 | 410 | 361 | 478 | 489 | 754 | 617 | 544 | 745 | 810 | 873 | 841 | 1001 | 986 |
| 106 | 186 | 234 | 434 | 362 | 490 | 490 | 772 | 618 | 559 | 746 | 825 | 874 | 863 | 1002 | 988 |
| 107 | 253 | 235 | 523 | 363 | 592 | 491 | 848 | 619 | 645 | 747 | 884 | 875 | 914 | 1003 | 1005 |
| 108 | 195 | 236 | 459 | 364 | 514 | 492 | 786 | 620 | 581 | 748 | 838 | 876 | 874 | 1004 | 994 |
| 109 | 269 | 237 | 535 | 365 | 604 | 493 | 837 | 621 | 667 | 749 | 894 | 877 | 922 | 1005 | 1007 |
| 110 | 282 | 238 | 567 | 366 | 619 | 494 | 870 | 622 | 675 | 750 | 907 | 878 | 932 | 1006 | 1012 |
| 111 | 380 | 239 | 670 | 367 | 707 | 495 | 924 | 623 | 773 | 751 | 949 | 879 | 969 | 1007 | 1018 |
| 112 | 133 | 240 | 355 | 368 | 404 | 496 | 680 | 624 | 457 | 752 | 766 | 880 | 799 | 1008 | 962 |
| 113 | 191 | 241 | 436 | 369 | 510 | 497 | 780 | 625 | 566 | 753 | 819 | 881 | 869 | 1009 | 992 |
| 114 | 213 | 242 | 461 | 370 | 521 | 498 | 798 | 626 | 583 | 754 | 846 | 882 | 881 | 1010 | 995 |
| 115 | 275 | 243 | 552 | 371 | 612 | 499 | 856 | 627 | 674 | 755 | 897 | 883 | 928 | 1011 | 1009 |
| 116 | 216 | 244 | 471 | 372 | 527 | 500 | 809 | 628 | 606 | 756 | 858 | 884 | 891 | 1012 | 1000 |
| 117 | 283 | 245 | 571 | 373 | 628 | 501 | 875 | 629 | 685 | 757 | 911 | 885 | 935 | 1013 | 1010 |
| 118 | 299 | 246 | 590 | 374 | 608 | 502 | 865 | 630 | 709 | 758 | 916 | 886 | 943 | 1014 | 1013 |
| 119 | 401 | 247 | 695 | 375 | 721 | 503 | 930 | 631 | 787 | 759 | 961 | 887 | 976 | 1015 | 1019 |
| 120 | 233 | 248 | 508 | 376 | 557 | 504 | 828 | 632 | 634 | 760 | 868 | 888 | 904 | 1016 | 1002 |

| 121 | 307 | 249 | 595 | 377 | 660 | 505 | 885 | 633 | 712 | 761 | 921 | 889 | 947 | 1017 | 1014 |
| 122 | 317 | 250 | 611 | 378 | 672 | 506 | 893 | 634 | 730 | 762 | 929 | 890 | 953 | 1018 | 1015 |
| 123 | 417 | 251 | 690 | 379 | 750 | 507 | 946 | 635 | 807 | 763 | 966 | 891 | 981 | 1019 | 1020 |
| 124 | 337 | 252 | 627 | 380 | 678 | 508 | 909 | 636 | 741 | 764 | 940 | 892 | 958 | 1020 | 1017 |
| 125 | 435 | 253 | 714 | 381 | 778 | 509 | 954 | 637 | 822 | 765 | 974 | 893 | 989 | 1021 | 1021 |
| 126 | 460 | 254 | 743 | 382 | 794 | 510 | 963 | 638 | 842 | 766 | 983 | 894 | 991 | 1022 | 1022 |
| 127 | 577 | 255 | 816 | 383 | 845 | 511 | 984 | 639 | 903 | 767 | 1003 | 895 | 1011 | 1023 | 1023 |

Sequence Z7, having a sequence length of 512:

[0, 1, 2, 7, 3, 8, 11, 24, 4, 10, 13, 27, 16, 30, 34, 70, 5, 12, 14, 31, 21, 37, 45, 73, 20, 44, 41, 81, 54, 88, 93, 141, 6, 17, 23, 39, 19, 43, 47, 82, 28, 52, 56, 89, 65, 99, 103, 152, 33, 57, 67, 101, 71, 109, 116, 165, 77, 118, 126, 177, 131, 187, 199, 269, 9, 22, 26, 51, 29, 55, 62, 95, 35, 68, 58, 104, 75, 112, 121, 169, 42, 66, 76, 117, 84, 124, 130, 183, 91, 133, 145, 193, 151, 205, 215, 286, 49, 80, 90, 129, 100, 137, 149, 202, 107, 150, 164, 214, 171, 225, 234, 299, 119, 167, 182, 228, 185, 235, 247, 313, 196, 252, 259, 323, 273, 334, 347, 406, 15, 25, 32, 63, 38, 69, 74, 120, 46, 79, 85, 128, 92, 136, 140, 201, 53, 86, 94, 138, 102, 146, 155, 210, 111, 161, 168, 220, 179, 230, 245, 309, 60, 98, 108, 154, 113, 162, 173, 229, 127, 178, 186, 237, 195, 251, 262, 322, 139, 190, 203, 254, 213, 268, 275, 332, 226, 281, 293, 345, 302, 356, 372, 407, 64, 110, 123, 174, 135, 184, 194, 253, 143, 197, 206, 263, 216, 274, 285, 342, 156, 211, 221, 279, 236, 295, 301, 358, 242, 306, 315, 366, 327, 378, 387, 435, 170, 231, 239, 297, 255, 308, 317, 369, 272, 319, 333, 381, 346, 390, 398, 442, 284, 335, 348, 393, 355, 402, 412, 458, 370, 415, 422, 453, 429, 460, 469, 488, 18, 36, 40, 83, 48, 87, 96, 144, 50, 97, 105, 158, 114, 172, 175, 246, 59, 106, 115, 176, 125, 181, 189, 248, 132, 188, 200, 261, 212, 271, 276, 331, 61, 122, 134, 180, 142, 191, 204, 270, 153, 209, 217, 277, 224, 291, 298, 354, 159, 223, 232, 290, 241, 303, 311, 365, 257, 320, 324, 377, 336, 386, 395, 439, 72, 147, 148, 207, 160, 219, 227, 287, 166, 233, 238, 305, 249, 312, 321, 374, 198, 244, 256, 314, 264, 325, 337, 384, 283, 338, 350, 392, 359, 405, 409, 450, 218, 266, 278, 330, 289, 344, 352, 399, 300, 357, 364, 414, 375, 417, 426, 459, 316, 371, 379, 423, 385, 430, 419, 461, 396, 437, 444, 470, 448, 477, 482, 495, 78, 157, 163, 240, 192, 250, 258, 318, 208, 260, 267, 329, 282, 339, 349, 401, 222, 280, 288, 343, 294, 353, 361, 408, 307, 363, 367, 416, 383, 425, 433, 465, 243, 292, 296, 360, 310, 368, 376, 420, 328, 380, 388, 432, 397, 428, 441, 471, 341, 391, 403, 438, 410, 446, 452, 475, 418, 456, 455, 481, 462, 484, 487, 501, 265, 304, 326, 382, 340, 389, 394, 436, 351, 404, 400, 445, 413, 443, 454, 479, 362, 411, 421, 451, 427, 457, 463, 485, 434, 467, 468, 489, 474, 492, 494, 504, 373, 424, 431, 464, 440, 466, 473, 490, 447, 472, 476, 496, 480, 493, 499, 506, 449, 478, 483, 497, 486, 500, 498, 507, 491, 502, 503, 508, 505, 509, 510, 511]

# Table Z7, having a sequence length of 512:

| Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability |
|---|---|---|---|---|---|---|---|---|---|---|---|---|---|---|---|
| 0 | 0 | 64 | 9 | 128 | 15 | 192 | 64 | 256 | 18 | 320 | 72 | 384 | 78 | 448 | 265 |
| 1 | 1 | 65 | 22 | 129 | 25 | 193 | 110 | 257 | 36 | 321 | 147 | 385 | 157 | 449 | 304 |
| 2 | 2 | 66 | 26 | 130 | 32 | 194 | 123 | 258 | 40 | 322 | 148 | 386 | 163 | 450 | 326 |
| 3 | 7 | 67 | 51 | 131 | 63 | 195 | 174 | 259 | 83 | 323 | 207 | 387 | 240 | 451 | 382 |
| 4 | 3 | 68 | 29 | 132 | 38 | 196 | 135 | 260 | 48 | 324 | 160 | 388 | 192 | 452 | 340 |
| 5 | 8 | 69 | 55 | 133 | 69 | 197 | 184 | 261 | 87 | 325 | 219 | 389 | 250 | 453 | 389 |
| 6 | 11 | 70 | 62 | 134 | 74 | 198 | 194 | 262 | 96 | 326 | 227 | 390 | 258 | 454 | 394 |
| 7 | 24 | 71 | 95 | 135 | 120 | 199 | 253 | 263 | 144 | 327 | 287 | 391 | 318 | 455 | 436 |
| 8 | 4 | 72 | 35 | 136 | 46 | 200 | 143 | 264 | 50 | 328 | 166 | 392 | 208 | 456 | 351 |
| 9 | 10 | 73 | 68 | 137 | 79 | 201 | 197 | 265 | 97 | 329 | 233 | 393 | 260 | 457 | 404 |
| 10 | 13 | 74 | 58 | 138 | 85 | 202 | 206 | 266 | 105 | 330 | 238 | 394 | 267 | 458 | 400 |
| 11 | 27 | 75 | 104 | 139 | 128 | 203 | 263 | 267 | 158 | 331 | 305 | 395 | 329 | 459 | 445 |
| 12 | 16 | 76 | 75 | 140 | 92 | 204 | 216 | 268 | 114 | 332 | 249 | 396 | 282 | 460 | 413 |
| 13 | 30 | 77 | 112 | 141 | 136 | 205 | 274 | 269 | 172 | 333 | 312 | 397 | 339 | 461 | 443 |
| 14 | 34 | 78 | 121 | 142 | 140 | 206 | 285 | 270 | 175 | 334 | 321 | 398 | 349 | 462 | 454 |
| 15 | 70 | 79 | 169 | 143 | 201 | 207 | 342 | 271 | 246 | 335 | 374 | 399 | 401 | 463 | 479 |
| 16 | 5 | 80 | 42 | 144 | 53 | 208 | 156 | 272 | 59 | 336 | 198 | 400 | 222 | 464 | 362 |
| 17 | 12 | 81 | 66 | 145 | 86 | 209 | 211 | 273 | 106 | 337 | 244 | 401 | 280 | 465 | 411 |
| 18 | 14 | 82 | 76 | 146 | 94 | 210 | 221 | 274 | 115 | 338 | 256 | 402 | 288 | 466 | 421 |
| 19 | 31 | 83 | 117 | 147 | 138 | 211 | 279 | 275 | 176 | 339 | 314 | 403 | 343 | 467 | 451 |
| 20 | 21 | 84 | 84 | 148 | 102 | 212 | 236 | 276 | 125 | 340 | 264 | 404 | 294 | 468 | 427 |
| 21 | 37 | 85 | 124 | 149 | 146 | 213 | 295 | 277 | 181 | 341 | 325 | 405 | 353 | 469 | 457 |
| 22 | 45 | 86 | 130 | 150 | 155 | 214 | 301 | 278 | 189 | 342 | 337 | 406 | 361 | 470 | 463 |
| 23 | 73 | 87 | 183 | 151 | 210 | 215 | 358 | 279 | 248 | 343 | 384 | 407 | 408 | 471 | 485 |
| 24 | 20 | 88 | 91 | 152 | 111 | 216 | 242 | 280 | 132 | 344 | 283 | 408 | 307 | 472 | 434 |
| 25 | 44 | 89 | 133 | 153 | 161 | 217 | 306 | 281 | 188 | 345 | 338 | 409 | 363 | 473 | 467 |
| 26 | 41 | 90 | 145 | 154 | 168 | 218 | 315 | 282 | 200 | 346 | 350 | 410 | 367 | 474 | 468 |
| 27 | 81 | 91 | 193 | 155 | 220 | 219 | 366 | 283 | 261 | 347 | 392 | 411 | 416 | 475 | 489 |
| 28 | 54 | 92 | 151 | 156 | 179 | 220 | 327 | 284 | 212 | 348 | 359 | 412 | 383 | 476 | 474 |
| 29 | 88 | 93 | 205 | 157 | 230 | 221 | 378 | 285 | 271 | 349 | 405 | 413 | 425 | 477 | 492 |
| 30 | 93 | 94 | 215 | 158 | 245 | 222 | 387 | 286 | 276 | 350 | 409 | 414 | 433 | 478 | 494 |
| 31 | 141 | 95 | 286 | 159 | 309 | 223 | 435 | 287 | 331 | 351 | 450 | 415 | 465 | 479 | 504 |

| 32 | 6 | 96 | 49 | 160 | 60 | 224 | 170 | 288 | 61 | 352 | 218 | 416 | 243 | 480 | 373 |
| 33 | 17 | 97 | 80 | 161 | 98 | 225 | 231 | 289 | 122 | 353 | 266 | 417 | 292 | 481 | 424 |
| 34 | 23 | 98 | 90 | 162 | 108 | 226 | 239 | 290 | 134 | 354 | 278 | 418 | 296 | 482 | 431 |
| 35 | 39 | 99 | 129 | 163 | 154 | 227 | 297 | 291 | 180 | 355 | 330 | 419 | 360 | 483 | 464 |
| 36 | 19 | 100 | 100 | 164 | 113 | 228 | 255 | 292 | 142 | 356 | 289 | 420 | 310 | 484 | 440 |
| 37 | 43 | 101 | 137 | 165 | 162 | 229 | 308 | 293 | 191 | 357 | 344 | 421 | 368 | 485 | 466 |
| 38 | 47 | 102 | 149 | 166 | 173 | 230 | 317 | 294 | 204 | 358 | 352 | 422 | 376 | 486 | 473 |
| 39 | 82 | 103 | 202 | 167 | 229 | 231 | 369 | 295 | 270 | 359 | 399 | 423 | 420 | 487 | 490 |
| 40 | 28 | 104 | 107 | 168 | 127 | 232 | 272 | 296 | 153 | 360 | 300 | 424 | 328 | 488 | 447 |
| 41 | 52 | 105 | 150 | 169 | 178 | 233 | 319 | 297 | 209 | 361 | 357 | 425 | 380 | 489 | 472 |
| 42 | 56 | 106 | 164 | 170 | 186 | 234 | 333 | 298 | 217 | 362 | 364 | 426 | 388 | 490 | 476 |
| 43 | 89 | 107 | 214 | 171 | 237 | 235 | 381 | 299 | 277 | 363 | 414 | 427 | 432 | 491 | 496 |
| 44 | 65 | 108 | 171 | 172 | 195 | 236 | 346 | 300 | 224 | 364 | 375 | 428 | 397 | 492 | 480 |
| 45 | 99 | 109 | 225 | 173 | 251 | 237 | 390 | 301 | 291 | 365 | 417 | 429 | 428 | 493 | 493 |
| 46 | 103 | 110 | 234 | 174 | 262 | 238 | 398 | 302 | 298 | 366 | 426 | 430 | 441 | 494 | 499 |
| 47 | 152 | 111 | 299 | 175 | 322 | 239 | 442 | 303 | 354 | 367 | 459 | 431 | 471 | 495 | 506 |
| 48 | 33 | 112 | 119 | 176 | 139 | 240 | 284 | 304 | 159 | 368 | 316 | 432 | 341 | 496 | 449 |
| 49 | 57 | 113 | 167 | 177 | 190 | 241 | 335 | 305 | 223 | 369 | 371 | 433 | 391 | 497 | 478 |
| 50 | 67 | 114 | 182 | 178 | 203 | 242 | 348 | 306 | 232 | 370 | 379 | 434 | 403 | 498 | 483 |
| 51 | 101 | 115 | 228 | 179 | 254 | 243 | 393 | 307 | 290 | 371 | 423 | 435 | 438 | 499 | 497 |
| 52 | 71 | 116 | 185 | 180 | 213 | 244 | 355 | 308 | 241 | 372 | 385 | 436 | 410 | 500 | 486 |
| 53 | 109 | 117 | 235 | 181 | 268 | 245 | 402 | 309 | 303 | 373 | 430 | 437 | 446 | 501 | 500 |
| 54 | 116 | 118 | 247 | 182 | 275 | 246 | 412 | 310 | 311 | 374 | 419 | 438 | 452 | 502 | 498 |
| 55 | 165 | 119 | 313 | 183 | 332 | 247 | 458 | 311 | 365 | 375 | 461 | 439 | 475 | 503 | 507 |
| 56 | 77 | 120 | 196 | 184 | 226 | 248 | 370 | 312 | 257 | 376 | 396 | 440 | 418 | 504 | 491 |
| 57 | 118 | 121 | 252 | 185 | 281 | 249 | 415 | 313 | 320 | 377 | 437 | 441 | 456 | 505 | 502 |
| 58 | 126 | 122 | 259 | 186 | 293 | 250 | 422 | 314 | 324 | 378 | 444 | 442 | 455 | 506 | 503 |
| 59 | 177 | 123 | 323 | 187 | 345 | 251 | 453 | 315 | 377 | 379 | 470 | 443 | 481 | 507 | 508 |
| 60 | 131 | 124 | 273 | 188 | 302 | 252 | 429 | 316 | 336 | 380 | 448 | 444 | 462 | 508 | 505 |
| 61 | 187 | 125 | 334 | 189 | 356 | 253 | 460 | 317 | 386 | 381 | 477 | 445 | 484 | 509 | 509 |
| 62 | 199 | 126 | 347 | 190 | 372 | 254 | 469 | 318 | 395 | 382 | 482 | 446 | 487 | 510 | 510 |
| 63 | 269 | 127 | 406 | 191 | 407 | 255 | 488 | 319 | 439 | 383 | 495 | 447 | 501 | 511 | 511 |

Sequence Z8, having a sequence length of 256:
[0, 1, 2, 7, 3, 8, 11, 23, 4, 10, 13, 26, 16, 29, 33, 63, 5, 12, 14, 30, 20, 35, 42, 65, 19, 41, 38, 72, 49, 77, 82, 120, 6, 17, 22, 37, 18, 40, 44, 73, 27, 47, 51, 78, 58, 86, 90, 127, 32, 52, 60, 88, 64, 94, 99, 134, 69, 101, 107, 142, 112, 150, 157, 194, 9, 21, 25, 46, 28, 50, 55, 84, 34, 61, 53, 91, 67, 97, 104, 137, 39, 59, 68, 100, 74, 106, 111, 146, 80, 113, 122, 152, 126, 161, 167, 203, 45, 71, 79, 110, 87, 116, 124, 159, 92, 125, 133, 166, 139, 171, 177, 207, 102, 135, 145, 173, 148, 178, 184, 213, 155, 186, 190, 218, 196, 222, 227, 243, 15, 24, 31, 56, 36, 62, 66, 103, 43, 70, 75, 109, 81, 115, 119, 158, 48, 76, 83, 117, 89, 123, 129, 163, 96, 131, 136, 169, 144, 175, 183, 212, 54, 85, 93, 128, 98, 132, 140, 174, 108, 143, 149, 180, 154, 185, 191, 217, 118, 151, 160, 188, 165, 193, 198, 220, 172, 200, 204, 225, 209, 230, 235, 244, 57, 95, 105, 141, 114, 147, 153, 187, 121, 156, 162, 192, 168, 197, 202, 224, 130, 164, 170, 199, 179, 205, 208, 231, 182, 210, 214, 232, 219, 236, 238, 249, 138, 176, 181, 206, 189, 211, 215, 233, 195, 216, 221, 237, 226, 239, 241, 250, 201, 223, 228, 240, 229, 242, 245, 252, 234, 246, 247, 251, 248, 253, 254, 255]

Table Z8, having a sequence length of 256:

| Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability |
|---|---|---|---|---|---|---|---|---|---|---|---|---|---|---|---|
| 0 | 0 | 32 | 6 | 64 | 9 | 96 | 45 | 128 | 15 | 160 | 54 | 192 | 57 | 224 | 138 |
| 1 | 1 | 33 | 17 | 65 | 21 | 97 | 71 | 129 | 24 | 161 | 85 | 193 | 95 | 225 | 176 |
| 2 | 2 | 34 | 22 | 66 | 25 | 98 | 79 | 130 | 31 | 162 | 93 | 194 | 105 | 226 | 181 |
| 3 | 7 | 35 | 37 | 67 | 46 | 99 | 110 | 131 | 56 | 163 | 128 | 195 | 141 | 227 | 206 |
| 4 | 3 | 36 | 18 | 68 | 28 | 100 | 87 | 132 | 36 | 164 | 98 | 196 | 114 | 228 | 189 |
| 5 | 8 | 37 | 40 | 69 | 50 | 101 | 116 | 133 | 62 | 165 | 132 | 197 | 147 | 229 | 211 |
| 6 | 11 | 38 | 44 | 70 | 55 | 102 | 124 | 134 | 66 | 166 | 140 | 198 | 153 | 230 | 215 |
| 7 | 23 | 39 | 73 | 71 | 84 | 103 | 159 | 135 | 103 | 167 | 174 | 199 | 187 | 231 | 233 |
| 8 | 4 | 40 | 27 | 72 | 34 | 104 | 92 | 136 | 43 | 168 | 108 | 200 | 121 | 232 | 195 |
| 9 | 10 | 41 | 47 | 73 | 61 | 105 | 125 | 137 | 70 | 169 | 143 | 201 | 156 | 233 | 216 |
| 10 | 13 | 42 | 51 | 74 | 53 | 106 | 133 | 138 | 75 | 170 | 149 | 202 | 162 | 234 | 221 |
| 11 | 26 | 43 | 78 | 75 | 91 | 107 | 166 | 139 | 109 | 171 | 180 | 203 | 192 | 235 | 237 |
| 12 | 16 | 44 | 58 | 76 | 67 | 108 | 139 | 140 | 81 | 172 | 154 | 204 | 168 | 236 | 226 |
| 13 | 29 | 45 | 86 | 77 | 97 | 109 | 171 | 141 | 115 | 173 | 185 | 205 | 197 | 237 | 239 |
| 14 | 33 | 46 | 90 | 78 | 104 | 110 | 177 | 142 | 119 | 174 | 191 | 206 | 202 | 238 | 241 |
| 15 | 63 | 47 | 127 | 79 | 137 | 111 | 207 | 143 | 158 | 175 | 217 | 207 | 224 | 239 | 250 |
| 16 | 5 | 48 | 32 | 80 | 39 | 112 | 102 | 144 | 48 | 176 | 118 | 208 | 130 | 240 | 201 |
| 17 | 12 | 49 | 52 | 81 | 59 | 113 | 135 | 145 | 76 | 177 | 151 | 209 | 164 | 241 | 223 |
| 18 | 14 | 50 | 60 | 82 | 68 | 114 | 145 | 146 | 83 | 178 | 160 | 210 | 170 | 242 | 228 |
| 19 | 30 | 51 | 88 | 83 | 100 | 115 | 173 | 147 | 117 | 179 | 188 | 211 | 199 | 243 | 240 |
| 20 | 20 | 52 | 64 | 84 | 74 | 116 | 148 | 148 | 89 | 180 | 165 | 212 | 179 | 244 | 229 |
| 21 | 35 | 53 | 94 | 85 | 106 | 117 | 178 | 149 | 123 | 181 | 193 | 213 | 205 | 245 | 242 |

| 22 | 42 | 54 | 99 | 86 | 111 | 118 | 184 | 150 | 129 | 182 | 198 | 214 | 208 | 246 | 245 |
| 23 | 65 | 55 | 134 | 87 | 146 | 119 | 213 | 151 | 163 | 183 | 220 | 215 | 231 | 247 | 252 |
| 24 | 19 | 56 | 69 | 88 | 80 | 120 | 155 | 152 | 96 | 184 | 172 | 216 | 182 | 248 | 234 |
| 25 | 41 | 57 | 101 | 89 | 113 | 121 | 186 | 153 | 131 | 185 | 200 | 217 | 210 | 249 | 246 |
| 26 | 38 | 58 | 107 | 90 | 122 | 122 | 190 | 154 | 136 | 186 | 204 | 218 | 214 | 250 | 247 |
| 27 | 72 | 59 | 142 | 91 | 152 | 123 | 218 | 155 | 169 | 187 | 225 | 219 | 232 | 251 | 251 |
| 28 | 49 | 60 | 112 | 92 | 126 | 124 | 196 | 156 | 144 | 188 | 209 | 220 | 219 | 252 | 248 |
| 29 | 77 | 61 | 150 | 93 | 161 | 125 | 222 | 157 | 175 | 189 | 230 | 221 | 236 | 253 | 253 |
| 30 | 82 | 62 | 157 | 94 | 167 | 126 | 227 | 158 | 183 | 190 | 235 | 222 | 238 | 254 | 254 |
| 31 | 120 | 63 | 194 | 95 | 203 | 127 | 243 | 159 | 212 | 191 | 244 | 223 | 249 | 255 | 255 |

Sequence Z9, having a sequence length of 128:
[0, 1, 2, 7, 3, 8, 11, 22, 4, 10, 13, 24, 15, 27, 30, 53, 5, 12, 14, 28, 19, 32, 38, 55, 18, 37, 34, 60, 43, 63, 67, 89, 6, 16, 21, 33, 17, 36, 39, 61, 25, 42, 45, 64, 49, 69, 72, 94, 29, 46, 51, 71, 54, 75, 77, 96, 58, 79, 83, 100, 86, 104, 107, 119, 9, 20, 23, 41, 26, 44, 48, 68, 31, 52, 47, 73, 56, 76, 81, 98, 35, 50, 57, 78, 62, 82, 85, 102, 66, 87, 90, 105, 93, 109, 111, 121, 40, 59, 65, 84, 70, 88, 91, 108, 74, 92, 95, 110, 99, 112, 114, 122, 80, 97, 101, 113, 103, 115, 116, 123, 106, 117, 118, 124, 120, 125, 126, 127]

Table Z9, having a sequence length of 128:

| Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability |
|---|---|---|---|---|---|---|---|---|---|---|---|---|---|---|---|
| 0 | 0 | 16 | 5 | 32 | 6 | 48 | 29 | 64 | 9 | 80 | 35 | 96 | 40 | 112 | 80 |
| 1 | 1 | 17 | 12 | 33 | 16 | 49 | 46 | 65 | 20 | 81 | 50 | 97 | 59 | 113 | 97 |
| 2 | 2 | 18 | 14 | 34 | 21 | 50 | 51 | 66 | 23 | 82 | 57 | 98 | 65 | 114 | 101 |
| 3 | 7 | 19 | 28 | 35 | 33 | 51 | 71 | 67 | 41 | 83 | 78 | 99 | 84 | 115 | 113 |
| 4 | 3 | 20 | 19 | 36 | 17 | 52 | 54 | 68 | 26 | 84 | 62 | 100 | 70 | 116 | 103 |
| 5 | 8 | 21 | 32 | 37 | 36 | 53 | 75 | 69 | 44 | 85 | 82 | 101 | 88 | 117 | 115 |
| 6 | 11 | 22 | 38 | 38 | 39 | 54 | 77 | 70 | 48 | 86 | 85 | 102 | 91 | 118 | 116 |
| 7 | 22 | 23 | 55 | 39 | 61 | 55 | 96 | 71 | 68 | 87 | 102 | 103 | 108 | 119 | 123 |
| 8 | 4 | 24 | 18 | 40 | 25 | 56 | 58 | 72 | 31 | 88 | 66 | 104 | 74 | 120 | 106 |
| 9 | 10 | 25 | 37 | 41 | 42 | 57 | 79 | 73 | 52 | 89 | 87 | 105 | 92 | 121 | 117 |
| 10 | 13 | 26 | 34 | 42 | 45 | 58 | 83 | 74 | 47 | 90 | 90 | 106 | 95 | 122 | 118 |
| 11 | 24 | 27 | 60 | 43 | 64 | 59 | 100 | 75 | 73 | 91 | 105 | 107 | 110 | 123 | 124 |

| 12 | 15 | 28 | 43 | 44 | 49 | 60 | 86 | 76 | 56 | 92 | 93 | 108 | 99 | 124 | 120 |
| 13 | 27 | 29 | 63 | 45 | 69 | 61 | 104 | 77 | 76 | 93 | 109 | 109 | 112 | 125 | 125 |
| 14 | 30 | 30 | 67 | 46 | 72 | 62 | 107 | 78 | 81 | 94 | 111 | 110 | 114 | 126 | 126 |
| 15 | 53 | 31 | 89 | 47 | 94 | 63 | 119 | 79 | 98 | 95 | 121 | 111 | 122 | 127 | 127 |

Sequence Z10, having a sequence length of 64:

[0, 1, 2, 7, 3, 8, 10, 20, 4, 9, 12, 21, 14, 23, 26, 40, 5, 11, 13, 24, 18, 27, 32, 42, 17, 31, 29, 44, 35, 46, 48, 57, 6, 15, 19, 28, 16, 30, 33, 45, 22, 34, 36, 47, 38, 49, 51, 58, 25, 37, 39, 50, 41, 52, 53, 59, 43, 54, 55, 60, 56, 61, 62, 63]

## Table Z10, having a sequence length of 64:

| Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability |
|---|---|---|---|---|---|---|---|---|---|---|---|---|---|---|---|
| 0 | 0 | 8 | 4 | 16 | 5 | 24 | 17 | 32 | 6 | 40 | 22 | 48 | 25 | 56 | 43 |
| 1 | 1 | 9 | 9 | 17 | 11 | 25 | 31 | 33 | 15 | 41 | 34 | 49 | 37 | 57 | 54 |
| 2 | 2 | 10 | 12 | 18 | 13 | 26 | 29 | 34 | 19 | 42 | 36 | 50 | 39 | 58 | 55 |
| 3 | 7 | 11 | 21 | 19 | 24 | 27 | 44 | 35 | 28 | 43 | 47 | 51 | 50 | 59 | 60 |
| 4 | 3 | 12 | 14 | 20 | 18 | 28 | 35 | 36 | 16 | 44 | 38 | 52 | 41 | 60 | 56 |
| 5 | 8 | 13 | 23 | 21 | 27 | 29 | 46 | 37 | 30 | 45 | 49 | 53 | 52 | 61 | 61 |
| 6 | 10 | 14 | 26 | 22 | 32 | 30 | 48 | 38 | 33 | 46 | 51 | 54 | 53 | 62 | 62 |
| 7 | 20 | 15 | 40 | 23 | 42 | 31 | 57 | 39 | 45 | 47 | 58 | 55 | 59 | 63 | 63 |

Third group of sequences (a criterion that comprehensively considers performance obtained by List (list) whose sizes are respectively 1, 2, 4, 8, and 16, and preferentially considers performance of Lists 2, 4, and 8).

Sequence Q11 corresponding to the claimed invention, having a sequence length of 1024:

[0, 1, 2, 4, 8, 16, 32, 3, 5, 64, 9, 6, 17, 10, 18, 128, 12, 33, 65, 20, 256, 34, 24, 36, 7, 129, 66, 512, 11, 40, 68, 130, 19, 13, 48, 14, 72, 257, 21, 132, 35, 258, 26, 513, 80, 37, 25, 22, 136, 260, 264, 38, 514, 96, 67, 41, 144, 28, 69, 42, 516, 49, 74, 272, 160, 520, 288, 528, 192, 544, 70, 44, 131, 81, 50, 73, 15, 320, 133, 52, 23, 134, 384, 76, 137, 82, 56, 27, 97, 39, 259, 84, 138, 145, 261, 29, 43, 98, 515, 88, 140, 30, 146, 71, 262, 265, 161, 576, 45, 100, 640, 51, 148, 46, 75, 266, 273, 517, 104, 162, 53, 193, 152, 77, 164, 768, 268, 274, 518, 54, 83, 57, 521, 112, 135, 78, 289, 194, 85, 276, 522, 58, 168, 139, 99, 86, 60, 280, 89, 290, 529, 524, 196, 141, 101, 147, 176, 142, 530, 321, 31, 200, 90, 545, 292, 322, 532, 263, 149, 102, 105, 304, 296, 163, 92, 47, 267, 385, 546, 324, 208, 386, 150, 153, 165, 106, 55, 328, 536, 577, 548, 113, 154, 79, 269, 108, 578, 224, 166, 519, 552, 195, 270, 641, 523, 275, 580, 291, 59, 169, 560, 114, 277, 156, 87, 197, 116, 170, 61, 531, 525, 642, 281, 278, 526, 177, 293, 388, 91, 584, 769, 198, 172, 120, 201, 336, 62, 282, 143, 103, 178, 294, 93, 644, 202, 592, 323, 392, 297, 770, 107, 180, 151, 209, 284, 648, 94, 204, 298, 400, 608, 352, 325, 533, 155, 210, 305, 547, 300, 109, 184, 534, 537, 115, 167, 225, 326, 306, 772, 157, 656, 329, 110, 117, 212, 171, 776, 330, 226, 549, 538, 387, 308, 216, 416, 271, 279, 158, 337, 550, 672, 118, 332, 579, 540, 389, 173, 121, 553, 199, 784, 179, 228, 338, 312, 704, 390, 174, 554, 581, 393, 283, 122, 448, 353, 561, 203, 63, 340, 394, 527, 582, 556, 181, 295, 285, 232, 124, 205, 182, 643, 562, 286, 585, 299, 354, 211, 401, 185, 396, 344, 586, 645, 593, 535, 240, 206, 95, 327, 564, 800, 402, 356, 307, 301, 417, 213, 568, 832, 588, 186, 646, 404, 227, 896, 594, 418, 302, 649, 771, 360, 539, 111, 331, 214, 309, 188, 449, 217, 408, 609, 596, 551, 650, 229, 159, 420, 310, 541, 773, 610, 657, 333, 119, 600, 339, 218, 368, 652, 230, 391, 313, 450, 542, 334, 233, 555, 774, 175, 123, 658, 612, 341, 777, 220, 314, 424, 395, 673, 583, 355, 287, 183, 234, 125, 557, 660, 616, 342, 316, 241, 778, 563, 345, 452, 397, 403, 207, 674, 558, 785, 432, 357, 187, 236, 664, 624, 587, 780, 705, 126, 242, 565, 398, 346, 456, 358, 405, 303, 569, 244, 595, 189, 566, 676, 361, 706, 589, 215, 786, 647, 348, 419, 406, 464, 680, 801, 362, 590, 409, 570, 788, 597, 572, 219, 311, 708, 598, 601, 651, 421, 792, 802, 611, 602, 410, 231, 688, 653, 248, 369, 190, 364, 654, 659, 335, 480, 315, 221, 370, 613, 422, 425, 451, 614, 543, 235, 412, 343, 372, 775, 317, 222, 426, 453, 237, 559, 833, 804, 712, 834, 661, 808, 779, 617, 604, 433, 720, 816, 836, 347, 897, 243, 662, 454, 318, 675, 618, 898, 781, 376, 428, 665, 736, 567, 840, 625, 238, 359, 457, 399, 787, 591, 678, 434, 677, 349, 245, 458, 666, 620, 363, 127, 191, 782, 407, 436, 626, 571, 465, 681, 246, 707, 350, 599, 668, 790, 460, 249, 682, 573, 411, 803, 789, 709, 365, 440, 628, 689, 374, 423, 466, 793, 250, 371, 481, 574, 413, 603, 366, 468, 655, 900, 805, 615, 684, 710, 429, 794, 252, 373, 605, 848, 690, 713, 632, 482, 806, 427, 904, 414, 223, 663, 692, 835, 619, 472, 455, 796, 809, 714, 721, 837, 716, 864, 810, 606, 912, 722, 696, 377, 435, 817, 319, 621, 812, 484, 430, 838, 667, 488, 239, 378, 459, 622, 627, 437, 380, 818, 461, 496, 669, 679, 724, 841, 629, 351, 467, 438, 737, 251, 462, 442, 441, 469, 247, 683, 842, 738, 899, 670, 783, 849, 820, 728, 928, 791, 367, 901, 630, 685, 844, 633, 711, 253, 691, 824, 902, 686, 740, 850, 375, 444, 470, 483, 415, 485, 905, 795, 473, 634, 744, 852, 960, 865, 693, 797, 906, 715, 807, 474, 636, 694, 254, 717, 575, 913, 798, 811, 379, 697, 431, 607, 489, 866, 723, 486, 908, 718, 813, 476, 856, 839, 725, 698, 914, 752, 868, 819, 814, 439, 929, 490, 623, 671, 739, 916, 463, 843, 381, 497, 930, 821, 726, 961, 872, 492, 631, 729, 700, 443, 741, 845, 920, 382, 822, 851, 730, 498, 880, 742, 445, 471, 635, 932, 687, 903, 825, 500, 846, 745, 826, 732, 446, 962, 936, 475, 853, 867, 637, 907, 487, 695, 746, 828, 753, 854, 857, 504, 799, 255, 964, 909, 719, 477, 915, 638, 748, 944, 869, 491, 699, 754, 858, 478, 968, 383, 910, 815, 976, 870, 917, 727, 493, 873, 701, 931, 756, 860, 499, 731, 823, 922, 874, 918, 502, 933, 743, 760, 881, 494, 702, 921, 501, 876, 847, 992, 447, 733, 827, 934, 882, 937, 963, 747, 505, 855, 924, 734, 829, 965, 938, 884, 506, 749, 945, 966, 755, 859, 940, 830, 911, 871, 639, 888, 479, 946, 750, 969, 508, 861, 757, 970, 919, 875, 862, 758, 948, 977, 923, 972, 761, 877, 952, 495, 703, 935, 978, 883, 762, 503, 925, 878, 735, 993, 885, 939, 994, 980, 926, 764, 941, 967, 886, 831, 947, 507, 889, 984, 751, 942, 996, 971, 890, 509, 949, 973, 1000, 892, 950, 863, 759, 1008, 510, 979, 953, 763, 974, 954, 879, 981, 982, 927, 995, 765, 956, 887, 985, 997, 986, 943, 891, 998, 766, 511, 988, 1001, 951, 1002, 893, 975, 894, 1009, 955, 1004, 1010, 957, 983, 958, 987, 1012, 999, 1016, 767, 989, 1003, 990, 1005, 959, 1011, 1013, 895, 1006, 1014, 1017, 1018, 991, 1020, 1007, 1015, 1019, 1021, 1022, 1023]

Table Q11 corresponding to the claimed invention, having a sequence length of 1024:

| Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number |
|---|---|---|---|---|---|---|---|---|---|---|---|---|---|---|---|
| 0 | 0 | 128 | 518 | 256 | 94 | 384 | 214 | 512 | 364 | 640 | 414 | 768 | 819 | 896 | 966 |
| 1 | 1 | 129 | 54 | 257 | 204 | 385 | 309 | 513 | 654 | 641 | 223 | 769 | 814 | 897 | 755 |
| 2 | 2 | 130 | 83 | 258 | 298 | 386 | 188 | 514 | 659 | 642 | 663 | 770 | 439 | 898 | 859 |
| 3 | 4 | 131 | 57 | 259 | 400 | 387 | 449 | 515 | 335 | 643 | 692 | 771 | 929 | 899 | 940 |
| 4 | 8 | 132 | 521 | 260 | 608 | 388 | 217 | 516 | 480 | 644 | 835 | 772 | 490 | 900 | 830 |
| 5 | 16 | 133 | 112 | 261 | 352 | 389 | 408 | 517 | 315 | 645 | 619 | 773 | 623 | 901 | 911 |
| 6 | 32 | 134 | 135 | 262 | 325 | 390 | 609 | 518 | 221 | 646 | 472 | 774 | 671 | 902 | 871 |
| 7 | 3 | 135 | 78 | 263 | 533 | 391 | 596 | 519 | 370 | 647 | 455 | 775 | 739 | 903 | 639 |
| 8 | 5 | 136 | 289 | 264 | 155 | 392 | 551 | 520 | 613 | 648 | 796 | 776 | 916 | 904 | 888 |
| 9 | 64 | 137 | 194 | 265 | 210 | 393 | 650 | 521 | 422 | 649 | 809 | 777 | 463 | 905 | 479 |
| 10 | 9 | 138 | 85 | 266 | 305 | 394 | 229 | 522 | 425 | 650 | 714 | 778 | 843 | 906 | 946 |
| 11 | 6 | 139 | 276 | 267 | 547 | 395 | 159 | 523 | 451 | 651 | 721 | 779 | 381 | 907 | 750 |
| 12 | 17 | 140 | 522 | 268 | 300 | 396 | 420 | 524 | 614 | 652 | 837 | 780 | 497 | 908 | 969 |
| 13 | 10 | 141 | 58 | 269 | 109 | 397 | 310 | 525 | 543 | 653 | 716 | 781 | 930 | 909 | 508 |
| 14 | 18 | 142 | 168 | 270 | 184 | 398 | 541 | 526 | 235 | 654 | 864 | 782 | 821 | 910 | 861 |
| 15 | 128 | 143 | 139 | 271 | 534 | 399 | 773 | 527 | 412 | 655 | 810 | 783 | 726 | 911 | 757 |
| 16 | 12 | 144 | 99 | 272 | 537 | 400 | 610 | 528 | 343 | 656 | 606 | 784 | 961 | 912 | 970 |
| 17 | 33 | 145 | 86 | 273 | 115 | 401 | 657 | 529 | 372 | 657 | 912 | 785 | 872 | 913 | 919 |
| 18 | 65 | 146 | 60 | 274 | 167 | 402 | 333 | 530 | 775 | 658 | 722 | 786 | 492 | 914 | 875 |
| 19 | 20 | 147 | 280 | 275 | 225 | 403 | 119 | 531 | 317 | 659 | 696 | 787 | 631 | 915 | 862 |

54

| 20 | 256 | 148 | 89 | 276 | 326 | 404 | 600 | 532 | 222 | 660 | 377 | 788 | 729 | 916 | 758 |
|---|---|---|---|---|---|---|---|---|---|---|---|---|---|---|---|
| 21 | 34 | 149 | 290 | 277 | 306 | 405 | 339 | 533 | 426 | 661 | 435 | 789 | 700 | 917 | 948 |
| 22 | 24 | 150 | 529 | 278 | 772 | 406 | 218 | 534 | 453 | 662 | 817 | 790 | 443 | 918 | 977 |
| 23 | 36 | 151 | 524 | 279 | 157 | 407 | 368 | 535 | 237 | 663 | 319 | 791 | 741 | 919 | 923 |
| 24 | 7 | 152 | 196 | 280 | 656 | 408 | 652 | 536 | 559 | 664 | 621 | 792 | 845 | 920 | 972 |
| 25 | 129 | 153 | 141 | 281 | 329 | 409 | 230 | 537 | 833 | 665 | 812 | 793 | 920 | 921 | 761 |
| 26 | 66 | 154 | 101 | 282 | 110 | 410 | 391 | 538 | 804 | 666 | 484 | 794 | 382 | 922 | 877 |
| 27 | 512 | 155 | 147 | 283 | 117 | 411 | 313 | 539 | 712 | 667 | 430 | 795 | 822 | 923 | 952 |
| 28 | 11 | 156 | 176 | 284 | 212 | 412 | 450 | 540 | 834 | 668 | 838 | 796 | 851 | 924 | 495 |
| 29 | 40 | 157 | 142 | 285 | 171 | 413 | 542 | 541 | 661 | 669 | 667 | 797 | 730 | 925 | 703 |
| 30 | 68 | 158 | 530 | 286 | 776 | 414 | 334 | 542 | 808 | 670 | 488 | 798 | 498 | 926 | 935 |
| 31 | 130 | 159 | 321 | 287 | 330 | 415 | 233 | 543 | 779 | 671 | 239 | 799 | 880 | 927 | 978 |
| 32 | 19 | 160 | 31 | 288 | 226 | 416 | 555 | 544 | 617 | 672 | 378 | 800 | 742 | 928 | 883 |
| 33 | 13 | 161 | 200 | 289 | 549 | 417 | 774 | 545 | 604 | 673 | 459 | 801 | 445 | 929 | 762 |
| 34 | 48 | 162 | 90 | 290 | 538 | 418 | 175 | 546 | 433 | 674 | 622 | 802 | 471 | 930 | 503 |
| 35 | 14 | 163 | 545 | 291 | 387 | 419 | 123 | 547 | 720 | 675 | 627 | 803 | 635 | 931 | 925 |
| 36 | 72 | 164 | 292 | 292 | 308 | 420 | 658 | 548 | 816 | 676 | 437 | 804 | 932 | 932 | 878 |
| 37 | 257 | 165 | 322 | 293 | 216 | 421 | 612 | 549 | 836 | 677 | 380 | 805 | 687 | 933 | 735 |
| 38 | 21 | 166 | 532 | 294 | 416 | 422 | 341 | 550 | 347 | 678 | 818 | 806 | 903 | 934 | 993 |
| 39 | 132 | 167 | 263 | 295 | 271 | 423 | 777 | 551 | 897 | 679 | 461 | 807 | 825 | 935 | 885 |
| 40 | 35 | 168 | 149 | 296 | 279 | 424 | 220 | 552 | 243 | 680 | 496 | 808 | 500 | 936 | 939 |
| 41 | 258 | 169 | 102 | 297 | 158 | 425 | 314 | 553 | 662 | 681 | 669 | 809 | 846 | 937 | 994 |
| 42 | 26 | 170 | 105 | 298 | 337 | 426 | 424 | 554 | 454 | 682 | 679 | 810 | 745 | 938 | 980 |
| 43 | 513 | 171 | 304 | 299 | 550 | 427 | 395 | 555 | 318 | 683 | 724 | 811 | 826 | 939 | 926 |
| 44 | 80 | 172 | 296 | 300 | 672 | 428 | 673 | 556 | 675 | 684 | 841 | 812 | 732 | 940 | 764 |
| 45 | 37 | 173 | 163 | 301 | 118 | 429 | 583 | 557 | 618 | 685 | 629 | 813 | 446 | 941 | 941 |
| 46 | 25 | 174 | 92 | 302 | 332 | 430 | 355 | 558 | 898 | 686 | 351 | 814 | 962 | 942 | 967 |
| 47 | 22 | 175 | 47 | 303 | 579 | 431 | 287 | 559 | 781 | 687 | 467 | 815 | 936 | 943 | 886 |
| 48 | 136 | 176 | 267 | 304 | 540 | 432 | 183 | 560 | 376 | 688 | 438 | 816 | 475 | 944 | 831 |
| 49 | 260 | 177 | 385 | 305 | 389 | 433 | 234 | 561 | 428 | 689 | 737 | 817 | 853 | 945 | 947 |
| 50 | 264 | 178 | 546 | 306 | 173 | 434 | 125 | 562 | 665 | 690 | 251 | 818 | 867 | 946 | 507 |
| 51 | 38 | 179 | 324 | 307 | 121 | 435 | 557 | 563 | 736 | 691 | 462 | 819 | 637 | 947 | 889 |
| 52 | 514 | 180 | 208 | 308 | 553 | 436 | 660 | 564 | 567 | 692 | 442 | 820 | 907 | 948 | 984 |
| 53 | 96 | 181 | 386 | 309 | 199 | 437 | 616 | 565 | 840 | 693 | 441 | 821 | 487 | 949 | 751 |
| 54 | 67 | 182 | 150 | 310 | 784 | 438 | 342 | 566 | 625 | 694 | 469 | 822 | 695 | 950 | 942 |
| 55 | 41 | 183 | 153 | 311 | 179 | 439 | 316 | 567 | 238 | 695 | 247 | 823 | 746 | 951 | 996 |
| 56 | 144 | 184 | 165 | 312 | 228 | 440 | 241 | 568 | 359 | 696 | 683 | 824 | 828 | 952 | 971 |
| 57 | 28 | 185 | 106 | 313 | 338 | 441 | 778 | 569 | 457 | 697 | 842 | 825 | 753 | 953 | 890 |

| | | | | | | | | | | | | | | | |
|---|---|---|---|---|---|---|---|---|---|---|---|---|---|---|---|
| 58 | 69 | 186 | 55 | 314 | 312 | 442 | 563 | 570 | 399 | 698 | 738 | 826 | 854 | 954 | 509 |
| 59 | 42 | 187 | 328 | 315 | 704 | 443 | 345 | 571 | 787 | 699 | 899 | 827 | 857 | 955 | 949 |
| 60 | 516 | 188 | 536 | 316 | 390 | 444 | 452 | 572 | 591 | 700 | 670 | 828 | 504 | 956 | 973 |
| 61 | 49 | 189 | 577 | 317 | 174 | 445 | 397 | 573 | 678 | 701 | 783 | 829 | 799 | 957 | 1000 |
| 62 | 74 | 190 | 548 | 318 | 554 | 446 | 403 | 574 | 434 | 702 | 849 | 830 | 255 | 958 | 892 |
| 63 | 272 | 191 | 113 | 319 | 581 | 447 | 207 | 575 | 677 | 703 | 820 | 831 | 964 | 959 | 950 |
| 64 | 160 | 192 | 154 | 320 | 393 | 448 | 674 | 576 | 349 | 704 | 728 | 832 | 909 | 960 | 863 |
| 65 | 520 | 193 | 79 | 321 | 283 | 449 | 558 | 577 | 245 | 705 | 928 | 833 | 719 | 961 | 759 |
| 66 | 288 | 194 | 269 | 322 | 122 | 450 | 785 | 578 | 458 | 706 | 791 | 834 | 477 | 962 | 1008 |
| 67 | 528 | 195 | 108 | 323 | 448 | 451 | 432 | 579 | 666 | 707 | 367 | 835 | 915 | 963 | 510 |
| 68 | 192 | 196 | 578 | 324 | 353 | 452 | 357 | 580 | 620 | 708 | 901 | 836 | 638 | 964 | 979 |
| 69 | 544 | 197 | 224 | 325 | 561 | 453 | 187 | 581 | 363 | 709 | 630 | 837 | 748 | 965 | 953 |
| 70 | 70 | 198 | 166 | 326 | 203 | 454 | 236 | 582 | 127 | 710 | 685 | 838 | 944 | 966 | 763 |
| 71 | 44 | 199 | 519 | 327 | 63 | 455 | 664 | 583 | 191 | 711 | 844 | 839 | 869 | 967 | 974 |
| 72 | 131 | 200 | 552 | 328 | 340 | 456 | 624 | 584 | 782 | 712 | 633 | 840 | 491 | 968 | 954 |
| 73 | 81 | 201 | 195 | 329 | 394 | 457 | 587 | 585 | 407 | 713 | 711 | 841 | 699 | 969 | 879 |
| 74 | 50 | 202 | 270 | 330 | 527 | 458 | 780 | 586 | 436 | 714 | 253 | 842 | 754 | 970 | 981 |
| 75 | 73 | 203 | 641 | 331 | 582 | 459 | 705 | 587 | 626 | 715 | 691 | 843 | 858 | 971 | 982 |
| 76 | 15 | 204 | 523 | 332 | 556 | 460 | 126 | 588 | 571 | 716 | 824 | 844 | 478 | 972 | 927 |
| 77 | 320 | 205 | 275 | 333 | 181 | 461 | 242 | 589 | 465 | 717 | 902 | 845 | 968 | 973 | 995 |
| 78 | 133 | 206 | 580 | 334 | 295 | 462 | 565 | 590 | 681 | 718 | 686 | 846 | 383 | 974 | 765 |
| 79 | 52 | 207 | 291 | 335 | 285 | 463 | 398 | 591 | 246 | 719 | 740 | 847 | 910 | 975 | 956 |
| 80 | 23 | 208 | 59 | 336 | 232 | 464 | 346 | 592 | 707 | 720 | 850 | 848 | 815 | 976 | 887 |
| 81 | 134 | 209 | 169 | 337 | 124 | 465 | 456 | 593 | 350 | 721 | 375 | 849 | 976 | 977 | 985 |
| 82 | 384 | 210 | 560 | 338 | 205 | 466 | 358 | 594 | 599 | 722 | 444 | 850 | 870 | 978 | 997 |
| 83 | 76 | 211 | 114 | 339 | 182 | 467 | 405 | 595 | 668 | 723 | 470 | 851 | 917 | 979 | 986 |
| 84 | 137 | 212 | 277 | 340 | 643 | 468 | 303 | 596 | 790 | 724 | 483 | 852 | 727 | 980 | 943 |
| 85 | 82 | 213 | 156 | 341 | 562 | 469 | 569 | 597 | 460 | 725 | 415 | 853 | 493 | 981 | 891 |
| 86 | 56 | 214 | 87 | 342 | 286 | 470 | 244 | 598 | 249 | 726 | 485 | 854 | 873 | 982 | 998 |
| 87 | 27 | 215 | 197 | 343 | 585 | 471 | 595 | 599 | 682 | 727 | 905 | 855 | 701 | 983 | 766 |
| 88 | 97 | 216 | 116 | 344 | 299 | 472 | 189 | 600 | 573 | 728 | 795 | 856 | 931 | 984 | 511 |
| 89 | 39 | 217 | 170 | 345 | 354 | 473 | 566 | 601 | 411 | 729 | 473 | 857 | 756 | 985 | 988 |
| 90 | 259 | 218 | 61 | 346 | 211 | 474 | 676 | 602 | 803 | 730 | 634 | 858 | 860 | 986 | 1001 |
| 91 | 84 | 219 | 531 | 347 | 401 | 475 | 361 | 603 | 789 | 731 | 744 | 859 | 499 | 987 | 951 |
| 92 | 138 | 220 | 525 | 348 | 185 | 476 | 706 | 604 | 709 | 732 | 852 | 860 | 731 | 988 | 1002 |
| 93 | 145 | 221 | 642 | 349 | 396 | 477 | 589 | 605 | 365 | 733 | 960 | 861 | 823 | 989 | 893 |
| 94 | 261 | 222 | 281 | 350 | 344 | 478 | 215 | 606 | 440 | 734 | 865 | 862 | 922 | 990 | 975 |
| 95 | 29 | 223 | 278 | 351 | 586 | 479 | 786 | 607 | 628 | 735 | 693 | 863 | 874 | 991 | 894 |

| | | | | | | | | | | | | | | | |
|---|---|---|---|---|---|---|---|---|---|---|---|---|---|---|---|
| 96 | 43 | 224 | 526 | 352 | 645 | 480 | 647 | 608 | 689 | 736 | 797 | 864 | 918 | 992 | 1009 |
| 97 | 98 | 225 | 177 | 353 | 593 | 481 | 348 | 609 | 374 | 737 | 906 | 865 | 502 | 993 | 955 |
| 98 | 515 | 226 | 293 | 354 | 535 | 482 | 419 | 610 | 423 | 738 | 715 | 866 | 933 | 994 | 1004 |
| 99 | 88 | 227 | 388 | 355 | 240 | 483 | 406 | 611 | 466 | 739 | 807 | 867 | 743 | 995 | 1010 |
| 100 | 140 | 228 | 91 | 356 | 206 | 484 | 464 | 612 | 793 | 740 | 474 | 868 | 760 | 996 | 957 |
| 101 | 30 | 229 | 584 | 357 | 95 | 485 | 680 | 613 | 250 | 741 | 636 | 869 | 881 | 997 | 983 |
| 102 | 146 | 230 | 769 | 358 | 327 | 486 | 801 | 614 | 371 | 742 | 694 | 870 | 494 | 998 | 958 |
| 103 | 71 | 231 | 198 | 359 | 564 | 487 | 362 | 615 | 481 | 743 | 254 | 871 | 702 | 999 | 987 |
| 104 | 262 | 232 | 172 | 360 | 800 | 488 | 590 | 616 | 574 | 744 | 717 | 872 | 921 | 1000 | 1012 |
| 105 | 265 | 233 | 120 | 361 | 402 | 489 | 409 | 617 | 413 | 745 | 575 | 873 | 501 | 1001 | 999 |
| 106 | 161 | 234 | 201 | 362 | 356 | 490 | 570 | 618 | 603 | 746 | 913 | 874 | 876 | 1002 | 1016 |
| 107 | 576 | 235 | 336 | 363 | 307 | 491 | 788 | 619 | 366 | 747 | 798 | 875 | 847 | 1003 | 767 |
| 108 | 45 | 236 | 62 | 364 | 301 | 492 | 597 | 620 | 468 | 748 | 811 | 876 | 992 | 1004 | 989 |
| 109 | 100 | 237 | 282 | 365 | 417 | 493 | 572 | 621 | 655 | 749 | 379 | 877 | 447 | 1005 | 1003 |
| 110 | 640 | 238 | 143 | 366 | 213 | 494 | 219 | 622 | 900 | 750 | 697 | 878 | 733 | 1006 | 990 |
| 111 | 51 | 239 | 103 | 367 | 568 | 495 | 311 | 623 | 805 | 751 | 431 | 879 | 827 | 1007 | 1005 |
| 112 | 148 | 240 | 178 | 368 | 832 | 496 | 708 | 624 | 615 | 752 | 607 | 880 | 934 | 1008 | 959 |
| 113 | 46 | 241 | 294 | 369 | 588 | 497 | 598 | 625 | 684 | 753 | 489 | 881 | 882 | 1009 | 1011 |
| 114 | 75 | 242 | 93 | 370 | 186 | 498 | 601 | 626 | 710 | 754 | 866 | 882 | 937 | 1010 | 1013 |
| 115 | 266 | 243 | 644 | 371 | 646 | 499 | 651 | 627 | 429 | 755 | 723 | 883 | 963 | 1011 | 895 |
| 116 | 273 | 244 | 202 | 372 | 404 | 500 | 421 | 628 | 794 | 756 | 486 | 884 | 747 | 1012 | 1006 |
| 117 | 517 | 245 | 592 | 373 | 227 | 501 | 792 | 629 | 252 | 757 | 908 | 885 | 505 | 1013 | 1014 |
| 118 | 104 | 246 | 323 | 374 | 896 | 502 | 802 | 630 | 373 | 758 | 718 | 886 | 855 | 1014 | 1017 |
| 119 | 162 | 247 | 392 | 375 | 594 | 503 | 611 | 631 | 605 | 759 | 813 | 887 | 924 | 1015 | 1018 |
| 120 | 53 | 248 | 297 | 376 | 418 | 504 | 602 | 632 | 848 | 760 | 476 | 888 | 734 | 1016 | 991 |
| 121 | 193 | 249 | 770 | 377 | 302 | 505 | 410 | 633 | 690 | 761 | 856 | 889 | 829 | 1017 | 1020 |
| 122 | 152 | 250 | 107 | 378 | 649 | 506 | 231 | 634 | 713 | 762 | 839 | 890 | 965 | 1018 | 1007 |
| 123 | 77 | 251 | 180 | 379 | 771 | 507 | 688 | 635 | 632 | 763 | 725 | 891 | 938 | 1019 | 1015 |
| 124 | 164 | 252 | 151 | 380 | 360 | 508 | 653 | 636 | 482 | 764 | 698 | 892 | 884 | 1020 | 1019 |
| 125 | 768 | 253 | 209 | 381 | 539 | 509 | 248 | 637 | 806 | 765 | 914 | 893 | 506 | 1021 | 1021 |
| 126 | 268 | 254 | 284 | 382 | 111 | 510 | 369 | 638 | 427 | 766 | 752 | 894 | 749 | 1022 | 1022 |
| 127 | 274 | 255 | 648 | 383 | 331 | 511 | 190 | 639 | 904 | 767 | 868 | 895 | 945 | 1023 | 1023 |

Sequence Q12, having a sequence length of 512:
[0, 1, 2, 4, 8, 16, 32, 3, 5, 64, 9, 6, 17, 10, 18, 128, 12, 33, 65, 20, 256, 34, 24, 36, 7, 129, 66, 11, 40, 68, 130, 19, 13, 48, 14, 72, 257, 21, 132, 35, 258, 26, 80, 37, 25, 22, 136, 260, 264, 38, 96, 67, 41, 144, 28, 69, 42, 49, 74, 272, 160, 288, 192, 70, 44, 131, 81, 50, 73, 15, 320, 133, 52, 23, 134, 384, 76, 137, 82, 56, 27, 97, 39, 259, 84, 138, 145, 261, 29, 43, 98, 88, 140, 30, 146, 71, 262, 265, 161, 45, 100, 51, 148, 46, 75, 266, 273, 104, 162, 53, 193, 152, 77, 164, 268, 274, 54, 83, 57, 112, 135, 78, 289, 194, 85, 276, 58, 168, 139, 99, 86, 60, 280, 89, 290, 196, 141, 101, 147, 176, 142, 321, 31, 200, 90, 292, 322, 263, 149, 102, 105, 304, 296, 163, 92, 47, 267, 385, 324, 208, 386, 150, 153, 165, 106, 55, 328, 113, 154, 79, 269, 108, 224, 166, 195, 270, 275, 291, 59, 169, 114, 277, 156, 87, 197, 116, 170, 61, 281, 278, 177, 293, 388, 91, 198, 172, 120, 201, 336, 62, 282, 143, 103, 178, 294, 93, 202, 323, 392, 297, 107, 180, 151, 209, 284, 94, 204, 298, 400, 352, 325, 155, 210, 305, 300, 109, 184, 115, 167, 225, 326, 306, 157, 329, 110, 117, 212, 171, 330, 226, 387, 308, 216, 416, 271, 279, 158, 337, 118, 332, 389, 173, 121, 199, 179, 228, 338, 312, 390, 174, 393, 283, 122, 448, 353, 203, 63, 340, 394, 181, 295, 285, 232, 124, 205, 182, 286, 299, 354, 211, 401, 185, 396, 344, 240, 206, 95, 327, 402, 356, 307, 301, 417, 213, 186, 404, 227, 418, 302, 360, 111, 331, 214, 309, 188, 449, 217, 408, 229, 159, 420, 310, 333, 119, 339, 218, 368, 230, 391, 313, 450, 334, 233, 175, 123, 341, 220, 314, 424, 395, 355, 287, 183, 234, 125, 342, 316, 241, 345, 452, 397, 403, 207, 432, 357, 187, 236, 126, 242, 398, 346, 456, 358, 405, 303, 244, 189, 361, 215, 348, 419, 406, 464, 362, 409, 219, 311, 421, 410, 231, 248, 369, 190, 364, 335, 480, 315, 221, 370, 422, 425, 451, 235, 412, 343, 372, 317, 222, 426, 453, 237, 433, 347, 243, 454, 318, 376, 428, 238, 359, 457, 399, 434, 349, 245, 458, 363, 127, 191, 407, 436, 465, 246, 350, 460, 249, 411, 365, 440, 374, 423, 466, 250, 371, 481, 413, 366, 468, 429, 252, 373, 482, 427, 414, 223, 472, 455, 377, 435, 319, 484, 430, 488, 239, 378, 459, 437, 380, 461, 496, 351, 467, 438, 251, 462, 442, 441, 469, 247, 367, 253, 375, 444, 470, 483, 415, 485, 473, 474, 254, 379, 431, 489, 486, 476, 439, 490, 463, 381, 497, 492, 443, 382, 498, 445, 471, 500, 446, 475, 487, 504, 255, 477, 491, 478, 383, 493, 499, 502, 494, 501, 447, 505, 506, 479, 508, 495, 503,507,509,510,511]

## Table Q12, having a sequence length of 512:

| Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number |
|---|---|---|---|---|---|---|---|---|---|---|---|---|---|---|---|
| 0 | 0 | 64 | 44 | 128 | 139 | 192 | 388 | 256 | 338 | 320 | 450 | 384 | 343 | 448 | 461 |
| 1 | 1 | 65 | 131 | 129 | 99 | 193 | 91 | 257 | 312 | 321 | 334 | 385 | 372 | 449 | 496 |
| 2 | 2 | 66 | 81 | 130 | 86 | 194 | 198 | 258 | 390 | 322 | 233 | 386 | 317 | 450 | 351 |
| 3 | 4 | 67 | 50 | 131 | 60 | 195 | 172 | 259 | 174 | 323 | 175 | 387 | 222 | 451 | 467 |
| 4 | 8 | 68 | 73 | 132 | 280 | 196 | 120 | 260 | 393 | 324 | 123 | 388 | 426 | 452 | 438 |
| 5 | 16 | 69 | 15 | 133 | 89 | 197 | 201 | 261 | 283 | 325 | 341 | 389 | 453 | 453 | 251 |
| 6 | 32 | 70 | 320 | 134 | 290 | 198 | 336 | 262 | 122 | 326 | 220 | 390 | 237 | 454 | 462 |
| 7 | 3 | 71 | 133 | 135 | 196 | 199 | 62 | 263 | 448 | 327 | 314 | 391 | 433 | 455 | 442 |

| | | | | | | | | | | | | | | | |
|---|---|---|---|---|---|---|---|---|---|---|---|---|---|---|---|
| 8 | 5 | 72 | 52 | 136 | 141 | 200 | 282 | 264 | 353 | 328 | 424 | 392 | 347 | 456 | 441 |
| 9 | 64 | 73 | 23 | 137 | 101 | 201 | 143 | 265 | 203 | 329 | 395 | 393 | 243 | 457 | 469 |
| 10 | 9 | 74 | 134 | 138 | 147 | 202 | 103 | 266 | 63 | 330 | 355 | 394 | 454 | 458 | 247 |
| 11 | 6 | 75 | 384 | 139 | 176 | 203 | 178 | 267 | 340 | 331 | 287 | 395 | 318 | 459 | 367 |
| 12 | 17 | 76 | 76 | 140 | 142 | 204 | 294 | 268 | 394 | 332 | 183 | 396 | 376 | 460 | 253 |
| 13 | 10 | 77 | 137 | 141 | 321 | 205 | 93 | 269 | 181 | 333 | 234 | 397 | 428 | 461 | 375 |
| 14 | 18 | 78 | 82 | 142 | 31 | 206 | 202 | 270 | 295 | 334 | 125 | 398 | 238 | 462 | 444 |
| 15 | 128 | 79 | 56 | 143 | 200 | 207 | 323 | 271 | 285 | 335 | 342 | 399 | 359 | 463 | 470 |
| 16 | 12 | 80 | 27 | 144 | 90 | 208 | 392 | 272 | 232 | 336 | 316 | 400 | 457 | 464 | 483 |
| 17 | 33 | 81 | 97 | 145 | 292 | 209 | 297 | 273 | 124 | 337 | 241 | 401 | 399 | 465 | 415 |
| 18 | 65 | 82 | 39 | 146 | 322 | 210 | 107 | 274 | 205 | 338 | 345 | 402 | 434 | 466 | 485 |
| 19 | 20 | 83 | 259 | 147 | 263 | 211 | 180 | 275 | 182 | 339 | 452 | 403 | 349 | 467 | 473 |
| 20 | 256 | 84 | 84 | 148 | 149 | 212 | 151 | 276 | 286 | 340 | 397 | 404 | 245 | 468 | 474 |
| 21 | 34 | 85 | 138 | 149 | 102 | 213 | 209 | 277 | 299 | 341 | 403 | 405 | 458 | 469 | 254 |
| 22 | 24 | 86 | 145 | 150 | 105 | 214 | 284 | 278 | 354 | 342 | 207 | 406 | 363 | 470 | 379 |
| 23 | 36 | 87 | 261 | 151 | 304 | 215 | 94 | 279 | 211 | 343 | 432 | 407 | 127 | 471 | 431 |
| 24 | 7 | 88 | 29 | 152 | 296 | 216 | 204 | 280 | 401 | 344 | 357 | 408 | 191 | 472 | 489 |
| 25 | 129 | 89 | 43 | 153 | 163 | 217 | 298 | 281 | 185 | 345 | 187 | 409 | 407 | 473 | 486 |
| 26 | 66 | 90 | 98 | 154 | 92 | 218 | 400 | 282 | 396 | 346 | 236 | 410 | 436 | 474 | 476 |
| 27 | 11 | 91 | 88 | 155 | 47 | 219 | 352 | 283 | 344 | 347 | 126 | 411 | 465 | 475 | 439 |
| 28 | 40 | 92 | 140 | 156 | 267 | 220 | 325 | 284 | 240 | 348 | 242 | 412 | 246 | 476 | 490 |
| 29 | 68 | 93 | 30 | 157 | 385 | 221 | 155 | 285 | 206 | 349 | 398 | 413 | 350 | 477 | 463 |
| 30 | 130 | 94 | 146 | 158 | 324 | 222 | 210 | 286 | 95 | 350 | 346 | 414 | 460 | 478 | 381 |
| 31 | 19 | 95 | 71 | 159 | 208 | 223 | 305 | 287 | 327 | 351 | 456 | 415 | 249 | 479 | 497 |
| 32 | 13 | 96 | 262 | 160 | 386 | 224 | 300 | 288 | 402 | 352 | 358 | 416 | 411 | 480 | 492 |
| 33 | 48 | 97 | 265 | 161 | 150 | 225 | 109 | 289 | 356 | 353 | 405 | 417 | 365 | 481 | 443 |
| 34 | 14 | 98 | 161 | 162 | 153 | 226 | 184 | 290 | 307 | 354 | 303 | 418 | 440 | 482 | 382 |
| 35 | 72 | 99 | 45 | 163 | 165 | 227 | 115 | 291 | 301 | 355 | 244 | 419 | 374 | 483 | 498 |
| 36 | 257 | 100 | 100 | 164 | 106 | 228 | 167 | 292 | 417 | 356 | 189 | 420 | 423 | 484 | 445 |
| 37 | 21 | 101 | 51 | 165 | 55 | 229 | 225 | 293 | 213 | 357 | 361 | 421 | 466 | 485 | 471 |
| 38 | 132 | 102 | 148 | 166 | 328 | 230 | 326 | 294 | 186 | 358 | 215 | 422 | 250 | 486 | 500 |
| 39 | 35 | 103 | 46 | 167 | 113 | 231 | 306 | 295 | 404 | 359 | 348 | 423 | 371 | 487 | 446 |
| 40 | 258 | 104 | 75 | 168 | 154 | 232 | 157 | 296 | 227 | 360 | 419 | 424 | 481 | 488 | 475 |
| 41 | 26 | 105 | 266 | 169 | 79 | 233 | 329 | 297 | 418 | 361 | 406 | 425 | 413 | 489 | 487 |
| 42 | 80 | 106 | 273 | 170 | 269 | 234 | 110 | 298 | 302 | 362 | 464 | 426 | 366 | 490 | 504 |
| 43 | 37 | 107 | 104 | 171 | 108 | 235 | 117 | 299 | 360 | 363 | 362 | 427 | 468 | 491 | 255 |
| 44 | 25 | 108 | 162 | 172 | 224 | 236 | 212 | 300 | 111 | 364 | 409 | 428 | 429 | 492 | 477 |
| 45 | 22 | 109 | 53 | 173 | 166 | 237 | 171 | 301 | 331 | 365 | 219 | 429 | 252 | 493 | 491 |

| | | | | | | | | | | | | | | | |
|---|---|---|---|---|---|---|---|---|---|---|---|---|---|---|---|
| 46 | 136 | 110 | 193 | 174 | 195 | 238 | 330 | 302 | 214 | 366 | 311 | 430 | 373 | 494 | 478 |
| 47 | 260 | 111 | 152 | 175 | 270 | 239 | 226 | 303 | 309 | 367 | 421 | 431 | 482 | 495 | 383 |
| 48 | 264 | 112 | 77 | 176 | 275 | 240 | 387 | 304 | 188 | 368 | 410 | 432 | 427 | 496 | 493 |
| 49 | 38 | 113 | 164 | 177 | 291 | 241 | 308 | 305 | 449 | 369 | 231 | 433 | 414 | 497 | 499 |
| 50 | 96 | 114 | 268 | 178 | 59 | 242 | 216 | 306 | 217 | 370 | 248 | 434 | 223 | 498 | 502 |
| 51 | 67 | 115 | 274 | 179 | 169 | 243 | 416 | 307 | 408 | 371 | 369 | 435 | 472 | 499 | 494 |
| 52 | 41 | 116 | 54 | 180 | 114 | 244 | 271 | 308 | 229 | 372 | 190 | 436 | 455 | 500 | 501 |
| 53 | 144 | 117 | 83 | 181 | 277 | 245 | 279 | 309 | 159 | 373 | 364 | 437 | 377 | 501 | 447 |
| 54 | 28 | 118 | 57 | 182 | 156 | 246 | 158 | 310 | 420 | 374 | 335 | 438 | 435 | 502 | 505 |
| 55 | 69 | 119 | 112 | 183 | 87 | 247 | 337 | 311 | 310 | 375 | 480 | 439 | 319 | 503 | 506 |
| 56 | 42 | 120 | 135 | 184 | 197 | 248 | 118 | 312 | 333 | 376 | 315 | 440 | 484 | 504 | 479 |
| 57 | 49 | 121 | 78 | 185 | 116 | 249 | 332 | 313 | 119 | 377 | 221 | 441 | 430 | 505 | 508 |
| 58 | 74 | 122 | 289 | 186 | 170 | 250 | 389 | 314 | 339 | 378 | 370 | 442 | 488 | 506 | 495 |
| 59 | 272 | 123 | 194 | 187 | 61 | 251 | 173 | 315 | 218 | 379 | 422 | 443 | 239 | 507 | 503 |
| 60 | 160 | 124 | 85 | 188 | 281 | 252 | 121 | 316 | 368 | 380 | 425 | 444 | 378 | 508 | 507 |
| 61 | 288 | 125 | 276 | 189 | 278 | 253 | 199 | 317 | 230 | 381 | 451 | 445 | 459 | 509 | 509 |
| 62 | 192 | 126 | 58 | 190 | 177 | 254 | 179 | 318 | 391 | 382 | 235 | 446 | 437 | 510 | 510 |
| 63 | 70 | 127 | 168 | 191 | 293 | 255 | 228 | 319 | 313 | 383 | 412 | 447 | 380 | 511 | 511 |

Sequence Q13, having a sequence length of 256:
[0, 1, 2, 4, 8, 16, 32, 3, 5, 64, 9, 6, 17, 10, 18, 128, 12, 33, 65, 20, 34, 24, 36, 7, 129, 66, 11, 40, 68, 130, 19, 13, 48, 14, 72, 21, 132, 35, 26, 80, 37, 25, 22, 136, 38, 96, 67, 41, 144, 28, 69, 42, 49, 74, 160, 192, 70, 44, 131, 81, 50, 73, 15, 133, 52, 23, 134, 76, 137, 82, 56, 27, 97, 39, 84, 138, 145, 29, 43, 98, 88, 140, 30, 146, 71, 161, 45, 100, 51, 148, 46, 75, 104, 162, 53, 193, 152, 77, 164, 54, 83, 57, 112, 135, 78, 194, 85, 58, 168, 139, 99, 86, 60, 89, 196, 141, 101, 147, 176, 142, 31, 200, 90, 149, 102, 105, 163, 92, 47, 208, 150, 153, 165, 106, 55, 113, 154, 79, 108, 224, 166, 195, 59, 169, 114, 156, 87, 197, 116, 170, 61, 177, 91, 198, 172, 120, 201, 62, 143, 103, 178, 93, 202, 107, 180, 151, 209, 94, 204, 155, 210, 109, 184, 115, 167, 225, 157, 110, 117, 212, 171, 226, 216, 158, 118, 173, 121, 199, 179, 228, 174, 122, 203, 63, 181, 232, 124, 205, 182, 211, 185, 240, 206, 95, 213, 186, 227, 111, 214, 188, 217, 229, 159, 119, 218, 230, 233, 175, 123, 220, 183, 234, 125, 241, 207, 187, 236, 126, 242, 244, 189, 215, 219, 231, 248, 190, 221, 235, 222, 237, 243, 238, 245, 127, 191, 246, 249, 250, 252, 223, 239, 251, 247, 253, 254, 255]

Table Q13, having a sequence length of 256:

| Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number |
|---|---|---|---|---|---|---|---|---|---|---|---|---|---|---|---|
| 0 | 0 | 32 | 48 | 64 | 52 | 96 | 152 | 128 | 47 | 160 | 178 | 192 | 203 | 224 | 207 |
| 1 | 1 | 33 | 14 | 65 | 23 | 97 | 77 | 129 | 208 | 161 | 93 | 193 | 63 | 225 | 187 |
| 2 | 2 | 34 | 72 | 66 | 134 | 98 | 164 | 130 | 150 | 162 | 202 | 194 | 181 | 226 | 236 |
| 3 | 4 | 35 | 21 | 67 | 76 | 99 | 54 | 131 | 153 | 163 | 107 | 195 | 232 | 227 | 126 |
| 4 | 8 | 36 | 132 | 68 | 137 | 100 | 83 | 132 | 165 | 164 | 180 | 196 | 124 | 228 | 242 |
| 5 | 16 | 37 | 35 | 69 | 82 | 101 | 57 | 133 | 106 | 165 | 151 | 197 | 205 | 229 | 244 |
| 6 | 32 | 38 | 26 | 70 | 56 | 102 | 112 | 134 | 55 | 166 | 209 | 198 | 182 | 230 | 189 |
| 7 | 3 | 39 | 80 | 71 | 27 | 103 | 135 | 135 | 113 | 167 | 94 | 199 | 211 | 231 | 215 |
| 8 | 5 | 40 | 37 | 72 | 97 | 104 | 78 | 136 | 154 | 168 | 204 | 200 | 185 | 232 | 219 |
| 9 | 64 | 41 | 25 | 73 | 39 | 105 | 194 | 137 | 79 | 169 | 155 | 201 | 240 | 233 | 231 |
| 10 | 9 | 42 | 22 | 74 | 84 | 106 | 85 | 138 | 108 | 170 | 210 | 202 | 206 | 234 | 248 |
| 11 | 6 | 43 | 136 | 75 | 138 | 107 | 58 | 139 | 224 | 171 | 109 | 203 | 95 | 235 | 190 |
| 12 | 17 | 44 | 38 | 76 | 145 | 108 | 168 | 140 | 166 | 172 | 184 | 204 | 213 | 236 | 221 |
| 13 | 10 | 45 | 96 | 77 | 29 | 109 | 139 | 141 | 195 | 173 | 115 | 205 | 186 | 237 | 235 |
| 14 | 18 | 46 | 67 | 78 | 43 | 110 | 99 | 142 | 59 | 174 | 167 | 206 | 227 | 238 | 222 |
| 15 | 128 | 47 | 41 | 79 | 98 | 111 | 86 | 143 | 169 | 175 | 225 | 207 | 111 | 239 | 237 |
| 16 | 12 | 48 | 144 | 80 | 88 | 112 | 60 | 144 | 114 | 176 | 157 | 208 | 214 | 240 | 243 |
| 17 | 33 | 49 | 28 | 81 | 140 | 113 | 89 | 145 | 156 | 177 | 110 | 209 | 188 | 241 | 238 |
| 18 | 65 | 50 | 69 | 82 | 30 | 114 | 196 | 146 | 87 | 178 | 117 | 210 | 217 | 242 | 245 |
| 19 | 20 | 51 | 42 | 83 | 146 | 115 | 141 | 147 | 197 | 179 | 212 | 211 | 229 | 243 | 127 |
| 20 | 34 | 52 | 49 | 84 | 71 | 116 | 101 | 148 | 116 | 180 | 171 | 212 | 159 | 244 | 191 |
| 21 | 24 | 53 | 74 | 85 | 161 | 117 | 147 | 149 | 170 | 181 | 226 | 213 | 119 | 245 | 246 |
| 22 | 36 | 54 | 160 | 86 | 45 | 118 | 176 | 150 | 61 | 182 | 216 | 214 | 218 | 246 | 249 |
| 23 | 7 | 55 | 192 | 87 | 100 | 119 | 142 | 151 | 177 | 183 | 158 | 215 | 230 | 247 | 250 |
| 24 | 129 | 56 | 70 | 88 | 51 | 120 | 31 | 152 | 91 | 184 | 118 | 216 | 233 | 248 | 252 |
| 25 | 66 | 57 | 44 | 89 | 148 | 121 | 200 | 153 | 198 | 185 | 173 | 217 | 175 | 249 | 223 |
| 26 | 11 | 58 | 131 | 90 | 46 | 122 | 90 | 154 | 172 | 186 | 121 | 218 | 123 | 250 | 239 |
| 27 | 40 | 59 | 81 | 91 | 75 | 123 | 149 | 155 | 120 | 187 | 199 | 219 | 220 | 251 | 251 |
| 28 | 68 | 60 | 50 | 92 | 104 | 124 | 102 | 156 | 201 | 188 | 179 | 220 | 183 | 252 | 247 |
| 29 | 130 | 61 | 73 | 93 | 162 | 125 | 105 | 157 | 62 | 189 | 228 | 221 | 234 | 253 | 253 |
| 30 | 19 | 62 | 15 | 94 | 53 | 126 | 163 | 158 | 143 | 190 | 174 | 222 | 125 | 254 | 254 |
| 31 | 13 | 63 | 133 | 95 | 193 | 127 | 92 | 159 | 103 | 191 | 122 | 223 | 241 | 255 | 255 |

Sequence Q14, having a sequence length of 128:
[0, 1, 2, 4, 8, 16, 32, 3, 5, 64, 9, 6, 17, 10, 18, 12, 33, 65, 20, 34, 24, 36, 7, 66, 11, 40, 68, 19, 13, 48, 14, 72, 21, 35, 26, 80, 37, 25, 22, 38, 96, 67, 41, 28, 69, 42, 49, 74, 70, 44, 81, 50, 73, 15, 52, 23, 76, 82, 56, 27, 97, 39, 84, 29, 43, 98, 88, 30, 71, 45, 100, 51, 46, 75, 104, 53, 77, 54, 83, 57, 112, 78, 85, 58, 99, 86, 60, 89, 101, 31, 90, 102, 105, 92, 47, 106, 55, 113, 79, 108, 59, 114, 87, 116, 61, 91, 120, 62, 103, 93, 107, 94, 109, 115, 110, 117, 118, 121, 122, 63, 124, 95, 111, 119, 123, 125, 126, 127]

## Table Q14, having a sequence length of 128:

| Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number |
|---|---|---|---|---|---|---|---|---|---|---|---|---|---|---|---|
| 0 | 0 | 16 | 33 | 32 | 21 | 48 | 70 | 64 | 43 | 80 | 112 | 96 | 55 | 112 | 109 |
| 1 | 1 | 17 | 65 | 33 | 35 | 49 | 44 | 65 | 98 | 81 | 78 | 97 | 113 | 113 | 115 |
| 2 | 2 | 18 | 20 | 34 | 26 | 50 | 81 | 66 | 88 | 82 | 85 | 98 | 79 | 114 | 110 |
| 3 | 4 | 19 | 34 | 35 | 80 | 51 | 50 | 67 | 30 | 83 | 58 | 99 | 108 | 115 | 117 |
| 4 | 8 | 20 | 24 | 36 | 37 | 52 | 73 | 68 | 71 | 84 | 99 | 100 | 59 | 116 | 118 |
| 5 | 16 | 21 | 36 | 37 | 25 | 53 | 15 | 69 | 45 | 85 | 86 | 101 | 114 | 117 | 121 |
| 6 | 32 | 22 | 7 | 38 | 22 | 54 | 52 | 70 | 100 | 86 | 60 | 102 | 87 | 118 | 122 |
| 7 | 3 | 23 | 66 | 39 | 38 | 55 | 23 | 71 | 51 | 87 | 89 | 103 | 116 | 119 | 63 |
| 8 | 5 | 24 | 11 | 40 | 96 | 56 | 76 | 72 | 46 | 88 | 101 | 104 | 61 | 120 | 124 |
| 9 | 64 | 25 | 40 | 41 | 67 | 57 | 82 | 73 | 75 | 89 | 31 | 105 | 91 | 121 | 95 |
| 10 | 9 | 26 | 68 | 42 | 41 | 58 | 56 | 74 | 104 | 90 | 90 | 106 | 120 | 122 | 111 |
| 11 | 6 | 27 | 19 | 43 | 28 | 59 | 27 | 75 | 53 | 91 | 102 | 107 | 62 | 123 | 119 |
| 12 | 17 | 28 | 13 | 44 | 69 | 60 | 97 | 76 | 77 | 92 | 105 | 108 | 103 | 124 | 123 |
| 13 | 10 | 29 | 48 | 45 | 42 | 61 | 39 | 77 | 54 | 93 | 92 | 109 | 93 | 125 | 125 |
| 14 | 18 | 30 | 14 | 46 | 49 | 62 | 84 | 78 | 83 | 94 | 47 | 110 | 107 | 126 | 126 |
| 15 | 12 | 31 | 72 | 47 | 74 | 63 | 29 | 79 | 57 | 95 | 106 | 111 | 94 | 127 | 127 |

Sequence Q15, having a sequence length of 64:
[0, 1, 2, 4, 8, 16, 32, 3, 5, 9, 6, 17, 10, 18, 12, 33, 20, 34, 24, 36, 7, 11, 40, 19, 13, 48, 14, 21, 35, 26, 37, 25, 22, 38, 41, 28, 42, 49, 44, 50, 15, 52, 23, 56, 27, 39, 29, 43, 30, 45, 51, 46, 53, 54, 57, 58, 60, 31, 47, 55, 59, 61, 62, 63]

## Table Q15, having a sequence length of 64:

| Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number |
|---|---|---|---|---|---|---|---|---|---|---|---|---|---|---|---|
| 0 | 0 | 8 | 5 | 16 | 20 | 24 | 13 | 32 | 22 | 40 | 15 | 48 | 30 | 56 | 60 |
| 1 | 1 | 9 | 9 | 17 | 34 | 25 | 48 | 33 | 38 | 41 | 52 | 49 | 45 | 57 | 31 |
| 2 | 2 | 10 | 6 | 18 | 24 | 26 | 14 | 34 | 41 | 42 | 23 | 50 | 51 | 58 | 47 |
| 3 | 4 | 11 | 17 | 19 | 36 | 27 | 21 | 35 | 28 | 43 | 56 | 51 | 46 | 59 | 55 |
| 4 | 8 | 12 | 10 | 20 | 7 | 28 | 35 | 36 | 42 | 44 | 27 | 52 | 53 | 60 | 59 |
| 5 | 16 | 13 | 18 | 21 | 11 | 29 | 26 | 37 | 49 | 45 | 39 | 53 | 54 | 61 | 61 |
| 6 | 32 | 14 | 12 | 22 | 40 | 30 | 37 | 38 | 44 | 46 | 29 | 54 | 57 | 62 | 62 |
| 7 | 3 | 15 | 33 | 23 | 19 | 31 | 25 | 39 | 50 | 47 | 43 | 55 | 58 | 63 | 63 |

Sequence Z11, having a sequence length of 1024:

[0, 1, 2, 7, 3, 8, 11, 24, 4, 10, 13, 28, 16, 33, 35, 76, 5, 12, 14, 32, 19, 38, 47, 80, 22, 46, 42, 87, 57, 95, 101, 160, 6, 17, 21, 40, 23, 45, 51, 89, 29, 55, 59, 96, 71, 108, 113, 175, 34, 61, 74, 111, 79, 120, 129, 186, 86, 131, 141, 208, 146, 218, 236, 327, 9, 18, 26, 54, 30, 58, 70, 103, 36, 75, 62, 114, 83, 123, 135, 193, 44, 73, 85, 130, 91, 138, 145, 214, 99, 148, 162, 228, 174, 242, 256, 357, 53, 88, 97, 144, 109, 154, 169, 239, 118, 170, 185, 250, 195, 269, 282, 382, 133, 191, 211, 273, 216, 283, 301, 403, 233, 307, 322, 419, 337, 434, 460, 582, 15, 25, 31, 72, 39, 78, 81, 134, 48, 84, 92, 143, 100, 153, 157, 238, 56, 93, 102, 155, 112, 168, 182, 252, 122, 183, 192, 264, 213, 279, 297, 395, 64, 106, 119, 173, 124, 184, 198, 274, 142, 209, 217, 285, 232, 306, 317, 418, 156, 225, 240, 311, 251, 333, 339, 432, 270, 348, 370, 453, 386, 472, 511, 583, 68, 121, 137, 201, 152, 215, 231, 309, 161, 234, 244, 326, 257, 338, 356, 447, 180, 253, 265, 346, 284, 366, 384, 478, 293, 388, 406, 494, 424, 518, 532, 641, 197, 275, 288, 373, 312, 394, 409, 506, 336, 415, 433, 526, 454, 535, 567, 671, 355, 440, 461, 552, 470, 577, 591, 695, 509, 598, 613, 690, 629, 714, 743, 830, 20, 37, 41, 90, 49, 94, 104, 167, 50, 105, 115, 176, 126, 194, 202, 295, 63, 116, 127, 205, 139, 212, 223, 296, 147, 222, 237, 321, 254, 335, 342, 431, 66, 136, 149, 207, 164, 226, 241, 334, 172, 248, 258, 344, 268, 364, 377, 468, 171, 266, 277, 363, 292, 385, 397, 495, 314, 411, 425, 517, 439, 531, 555, 663, 77, 159, 165, 246, 179, 262, 276, 358, 187, 281, 287, 383, 302, 402, 414, 515, 235, 298, 313, 405, 328, 422, 438, 528, 350, 443, 464, 550, 481, 576, 593, 686, 261, 324, 345, 430, 362, 452, 466, 568, 380, 475, 487, 581, 512, 605, 619, 707, 407, 510, 519, 614, 529, 630, 609, 721, 560, 660, 672, 749, 677, 779, 794, 846, 82, 177, 181, 291, 227, 305, 316, 410, 247, 320, 329, 427, 349, 445, 463, 570, 259, 347, 361, 446, 372, 467, 483, 585, 389, 489, 505, 601, 527, 617, 640, 725, 294, 365, 376, 482, 396, 500, 521, 610, 426, 522, 533, 638, 561, 627, 667, 751, 451, 546, 574, 661, 586, 676, 688, 770, 606, 693, 692, 790, 722, 801, 813, 877, 323, 387, 412, 523, 444, 534, 554, 647, 465, 569, 578, 673, 597, 679, 691, 777, 484, 589, 611, 687, 620, 694, 723, 802, 646, 729, 740, 816, 760, 834, 844, 905, 516, 615, 636, 724, 666, 726, 756, 821, 670, 753, 772, 840, 786, 853, 870, 924, 680, 780, 798, 859, 808, 873, 865, 930, 828, 885, 893, 946, 909, 954, 963, 984, 27, 43, 52, 98, 60, 117, 128, 199, 65, 132, 140, 204, 151, 220, 224, 330, 67, 150, 158, 219, 166, 263, 271, 354, 188, 272, 290, 381, 304, 398, 413, 525, 69, 163, 178, 267, 190, 289, 299, 392, 200, 308, 318, 416, 332, 435, 449, 536, 210, 325, 341, 442, 359, 462, 473, 564, 367, 469, 490, 588, 493, 600, 616, 745, 107, 189, 196, 303, 206, 319, 331, 429, 229, 343, 351, 457, 369, 477, 488, 572, 245, 353, 375, 471, 391, 492, 497, 594, 404, 498, 504, 618, 545, 631, 656, 752, 260, 390, 400, 503, 421, 520, 524, 624, 437, 544, 557, 645, 580, 664, 674, 773, 456, 566, 587, 675, 607, 685, 709, 787, 635, 712, 730, 803, 741, 819, 836, 903, 110, 203, 221, 340, 243, 352, 371, 480, 255, 378, 393, 499, 408, 508, 513, 621, 280, 401, 420, 514, 436, 541, 553, 642, 455, 562, 579, 669, 595, 681, 700, 774, 300, 428, 448, 556, 474, 575, 573, 682, 485, 590, 599, 696, 625, 710, 718, 805, 507, 608, 633, 715, 643, 735, 742, 822, 659, 750, 764, 841, 789, 855, 871, 925, 315, 459, 476, 592, 496, 604, 626, 713, 539, 634, 650, 738, 653, 744, 758, 833, 547, 651, 658, 755, 683, 763, 783, 852, 704, 788, 797, 860, 812, 878, 888, 933, 563, 689, 698, 775, 719, 791, 800, 867, 731, 810, 823, 884, 837, 894, 907, 949, 766, 825, 842, 897, 857, 911, 916, 961, 868, 921, 929, 966, 940, 974, 983, 1003, 125, 230, 249, 379, 278, 399, 417, 530, 286, 423, 441, 543, 458, 559, 584, 701, 310, 450, 479, 571, 491, 603, 596, 706, 501, 612, 628, 728, 648, 736, 747, 829, 360, 486, 502, 602, 538, 623, 637, 739, 542, 649, 655, 748, 665, 759, 769, 848, 548, 662, 678, 768, 703, 782, 795, 861, 716, 807, 811, 879, 824, 889, 900, 944, 368, 537, 540, 644, 549, 652, 668, 762, 565, 684, 697, 778, 711, 792, 809, 875, 632, 702, 720, 796, 732, 817, 826, 886, 761, 827, 843, 898, 858, 910, 915, 960, 654, 734, 754, 818, 767, 839, 850, 902, 785, 854, 863, 914, 874, 922, 932, 969, 799, 869, 881, 928, 892, 935, 943, 976, 904, 947, 953, 981, 958, 989, 991, 1011, 374, 551, 558, 699, 622, 708, 717, 806, 639, 727, 737, 820, 757, 832, 847, 901, 657, 746, 765, 835, 776, 851, 864, 913, 793, 872, 862, 919, 887, 931, 939, 972, 705, 771, 781, 856, 804, 866, 880, 926, 815, 882, 891, 936, 899, 941, 950, 980, 838, 895, 906, 945, 917, 955, 959, 987, 923, 965, 968, 993, 975, 996, 998, 1008, 733, 784, 814, 883, 831, 890, 896, 942, 845, 908, 912, 952, 920, 956, 967, 990, 849, 918, 927, 964, 938, 970, 971, 997, 948, 977, 979, 999, 985, 1004, 1006, 1016, 876, 934, 937, 973, 951, 978, 982, 1001, 957, 986, 988, 1005, 994, 1007, 1012, 1018, 962, 992, 995, 1009, 1000, 1010, 1013, 1019, 1002, 1014, 1015, 1020, 1017, 1021, 1022, 1023]

Table Z11, having a sequence length of 1024:

| Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability |
|---|---|---|---|---|---|---|---|---|---|---|---|---|---|---|---|
| 0 | 0 | 128 | 15 | 256 | 20 | 384 | 82 | 512 | 27 | 640 | 110 | 768 | 125 | 896 | 374 |
| 1 | 1 | 129 | 25 | 257 | 37 | 385 | 177 | 513 | 43 | 641 | 203 | 769 | 230 | 897 | 551 |
| 2 | 2 | 130 | 31 | 258 | 41 | 386 | 181 | 514 | 52 | 642 | 221 | 770 | 249 | 898 | 558 |
| 3 | 7 | 131 | 72 | 259 | 90 | 387 | 291 | 515 | 98 | 643 | 340 | 771 | 379 | 899 | 699 |
| 4 | 3 | 132 | 39 | 260 | 49 | 388 | 227 | 516 | 60 | 644 | 243 | 772 | 278 | 900 | 622 |
| 5 | 8 | 133 | 78 | 261 | 94 | 389 | 305 | 517 | 117 | 645 | 352 | 773 | 399 | 901 | 708 |
| 6 | 11 | 134 | 81 | 262 | 104 | 390 | 316 | 518 | 128 | 646 | 371 | 774 | 417 | 902 | 717 |
| 7 | 24 | 135 | 134 | 263 | 167 | 391 | 410 | 519 | 199 | 647 | 480 | 775 | 530 | 903 | 806 |
| 8 | 4 | 136 | 48 | 264 | 50 | 392 | 247 | 520 | 65 | 648 | 255 | 776 | 286 | 904 | 639 |
| 9 | 10 | 137 | 84 | 265 | 105 | 393 | 320 | 521 | 132 | 649 | 378 | 777 | 423 | 905 | 727 |
| 10 | 13 | 138 | 92 | 266 | 115 | 394 | 329 | 522 | 140 | 650 | 393 | 778 | 441 | 906 | 737 |
| 11 | 28 | 139 | 143 | 267 | 176 | 395 | 427 | 523 | 204 | 651 | 499 | 779 | 543 | 907 | 820 |
| 12 | 16 | 140 | 100 | 268 | 126 | 396 | 349 | 524 | 151 | 652 | 408 | 780 | 458 | 908 | 757 |
| 13 | 33 | 141 | 153 | 269 | 194 | 397 | 445 | 525 | 220 | 653 | 508 | 781 | 559 | 909 | 832 |
| 14 | 35 | 142 | 157 | 270 | 202 | 398 | 463 | 526 | 224 | 654 | 513 | 782 | 584 | 910 | 847 |
| 15 | 76 | 143 | 238 | 271 | 295 | 399 | 570 | 527 | 330 | 655 | 621 | 783 | 701 | 911 | 901 |
| 16 | 5 | 144 | 56 | 272 | 63 | 400 | 259 | 528 | 67 | 656 | 280 | 784 | 310 | 912 | 657 |
| 17 | 12 | 145 | 93 | 273 | 116 | 401 | 347 | 529 | 150 | 657 | 401 | 785 | 450 | 913 | 746 |
| 18 | 14 | 146 | 102 | 274 | 127 | 402 | 361 | 530 | 158 | 658 | 420 | 786 | 479 | 914 | 765 |
| 19 | 32 | 147 | 155 | 275 | 205 | 403 | 446 | 531 | 219 | 659 | 514 | 787 | 571 | 915 | 835 |
| 20 | 19 | 148 | 112 | 276 | 139 | 404 | 372 | 532 | 166 | 660 | 436 | 788 | 491 | 916 | 776 |
| 21 | 38 | 149 | 168 | 277 | 212 | 405 | 467 | 533 | 263 | 661 | 541 | 789 | 603 | 917 | 851 |
| 22 | 47 | 150 | 182 | 278 | 223 | 406 | 483 | 534 | 271 | 662 | 553 | 790 | 596 | 918 | 864 |
| 23 | 80 | 151 | 252 | 279 | 296 | 407 | 585 | 535 | 354 | 663 | 642 | 791 | 706 | 919 | 913 |
| 24 | 22 | 152 | 122 | 280 | 147 | 408 | 389 | 536 | 188 | 664 | 455 | 792 | 501 | 920 | 793 |
| 25 | 46 | 153 | 183 | 281 | 222 | 409 | 489 | 537 | 272 | 665 | 562 | 793 | 612 | 921 | 872 |
| 26 | 42 | 154 | 192 | 282 | 237 | 410 | 505 | 538 | 290 | 666 | 579 | 794 | 628 | 922 | 862 |
| 27 | 87 | 155 | 264 | 283 | 321 | 411 | 601 | 539 | 381 | 667 | 669 | 795 | 728 | 923 | 919 |
| 28 | 57 | 156 | 213 | 284 | 254 | 412 | 527 | 540 | 304 | 668 | 595 | 796 | 648 | 924 | 887 |
| 29 | 95 | 157 | 279 | 285 | 335 | 413 | 617 | 541 | 398 | 669 | 681 | 797 | 736 | 925 | 931 |
| 30 | 101 | 158 | 297 | 286 | 342 | 414 | 640 | 542 | 413 | 670 | 700 | 798 | 747 | 926 | 939 |
| 31 | 160 | 159 | 395 | 287 | 431 | 415 | 725 | 543 | 525 | 671 | 774 | 799 | 829 | 927 | 972 |

| | | | | | | | | | | | | | | | |
|---|---|---|---|---|---|---|---|---|---|---|---|---|---|---|---|
| 32 | 6 | 160 | 64 | 288 | 66 | 416 | 294 | 544 | 69 | 672 | 300 | 800 | 360 | 928 | 705 |
| 33 | 17 | 161 | 106 | 289 | 136 | 417 | 365 | 545 | 163 | 673 | 428 | 801 | 486 | 929 | 771 |
| 34 | 21 | 162 | 119 | 290 | 149 | 418 | 376 | 546 | 178 | 674 | 448 | 802 | 502 | 930 | 781 |
| 35 | 40 | 163 | 173 | 291 | 207 | 419 | 482 | 547 | 267 | 675 | 556 | 803 | 602 | 931 | 856 |
| 36 | 23 | 164 | 124 | 292 | 164 | 420 | 396 | 548 | 190 | 676 | 474 | 804 | 538 | 932 | 804 |
| 37 | 45 | 165 | 184 | 293 | 226 | 421 | 500 | 549 | 289 | 677 | 575 | 805 | 623 | 933 | 866 |
| 38 | 51 | 166 | 198 | 294 | 241 | 422 | 521 | 550 | 299 | 678 | 573 | 806 | 637 | 934 | 880 |
| 39 | 89 | 167 | 274 | 295 | 334 | 423 | 610 | 551 | 392 | 679 | 682 | 807 | 739 | 935 | 926 |
| 40 | 29 | 168 | 142 | 296 | 172 | 424 | 426 | 552 | 200 | 680 | 485 | 808 | 542 | 936 | 815 |
| 41 | 55 | 169 | 209 | 297 | 248 | 425 | 522 | 553 | 308 | 681 | 590 | 809 | 649 | 937 | 882 |
| 42 | 59 | 170 | 217 | 298 | 258 | 426 | 533 | 554 | 318 | 682 | 599 | 810 | 655 | 938 | 891 |
| 43 | 96 | 171 | 285 | 299 | 344 | 427 | 638 | 555 | 416 | 683 | 696 | 811 | 748 | 939 | 936 |
| 44 | 71 | 172 | 232 | 300 | 268 | 428 | 561 | 556 | 332 | 684 | 625 | 812 | 665 | 940 | 899 |
| 45 | 108 | 173 | 306 | 301 | 364 | 429 | 627 | 557 | 435 | 685 | 710 | 813 | 759 | 941 | 941 |
| 46 | 113 | 174 | 317 | 302 | 377 | 430 | 667 | 558 | 449 | 686 | 718 | 814 | 769 | 942 | 950 |
| 47 | 175 | 175 | 418 | 303 | 468 | 431 | 751 | 559 | 536 | 687 | 805 | 815 | 848 | 943 | 980 |
| 48 | 34 | 176 | 156 | 304 | 171 | 432 | 451 | 560 | 210 | 688 | 507 | 816 | 548 | 944 | 838 |
| 49 | 61 | 177 | 225 | 305 | 266 | 433 | 546 | 561 | 325 | 689 | 608 | 817 | 662 | 945 | 895 |
| 50 | 74 | 178 | 240 | 306 | 277 | 434 | 574 | 562 | 341 | 690 | 633 | 818 | 678 | 946 | 906 |
| 51 | 111 | 179 | 311 | 307 | 363 | 435 | 661 | 563 | 442 | 691 | 715 | 819 | 768 | 947 | 945 |
| 52 | 79 | 180 | 251 | 308 | 292 | 436 | 586 | 564 | 359 | 692 | 643 | 820 | 703 | 948 | 917 |
| 53 | 120 | 181 | 333 | 309 | 385 | 437 | 676 | 565 | 462 | 693 | 735 | 821 | 782 | 949 | 955 |
| 54 | 129 | 182 | 339 | 310 | 397 | 438 | 688 | 566 | 473 | 694 | 742 | 822 | 795 | 950 | 959 |
| 55 | 186 | 183 | 432 | 311 | 495 | 439 | 770 | 567 | 564 | 695 | 822 | 823 | 861 | 951 | 987 |
| 56 | 86 | 184 | 270 | 312 | 314 | 440 | 606 | 568 | 367 | 696 | 659 | 824 | 716 | 952 | 923 |
| 57 | 131 | 185 | 348 | 313 | 411 | 441 | 693 | 569 | 469 | 697 | 750 | 825 | 807 | 953 | 965 |
| 58 | 141 | 186 | 370 | 314 | 425 | 442 | 692 | 570 | 490 | 698 | 764 | 826 | 811 | 954 | 968 |
| 59 | 208 | 187 | 453 | 315 | 517 | 443 | 790 | 571 | 588 | 699 | 841 | 827 | 879 | 955 | 993 |
| 60 | 146 | 188 | 386 | 316 | 439 | 444 | 722 | 572 | 493 | 700 | 789 | 828 | 824 | 956 | 975 |
| 61 | 218 | 189 | 472 | 317 | 531 | 445 | 801 | 573 | 600 | 701 | 855 | 829 | 889 | 957 | 996 |
| 62 | 236 | 190 | 511 | 318 | 555 | 446 | 813 | 574 | 616 | 702 | 871 | 830 | 900 | 958 | 998 |
| 63 | 327 | 191 | 583 | 319 | 663 | 447 | 877 | 575 | 745 | 703 | 925 | 831 | 944 | 959 | 1008 |
| 64 | 9 | 192 | 68 | 320 | 77 | 448 | 323 | 576 | 107 | 704 | 315 | 832 | 368 | 960 | 733 |
| 65 | 18 | 193 | 121 | 321 | 159 | 449 | 387 | 577 | 189 | 705 | 459 | 833 | 537 | 961 | 784 |
| 66 | 26 | 194 | 137 | 322 | 165 | 450 | 412 | 578 | 196 | 706 | 476 | 834 | 540 | 962 | 814 |
| 67 | 54 | 195 | 201 | 323 | 246 | 451 | 523 | 579 | 303 | 707 | 592 | 835 | 644 | 963 | 883 |
| 68 | 30 | 196 | 152 | 324 | 179 | 452 | 444 | 580 | 206 | 708 | 496 | 836 | 549 | 964 | 831 |
| 69 | 58 | 197 | 215 | 325 | 262 | 453 | 534 | 581 | 319 | 709 | 604 | 837 | 652 | 965 | 890 |

| | | | | | | | | | | | | | | | |
|---|---|---|---|---|---|---|---|---|---|---|---|---|---|---|---|
| 70 | 70 | 198 | 231 | 326 | 276 | 454 | 554 | 582 | 331 | 710 | 626 | 838 | 668 | 966 | 896 |
| 71 | 103 | 199 | 309 | 327 | 358 | 455 | 647 | 583 | 429 | 711 | 713 | 839 | 762 | 967 | 942 |
| 72 | 36 | 200 | 161 | 328 | 187 | 456 | 465 | 584 | 229 | 712 | 539 | 840 | 565 | 968 | 845 |
| 73 | 75 | 201 | 234 | 329 | 281 | 457 | 569 | 585 | 343 | 713 | 634 | 841 | 684 | 969 | 908 |
| 74 | 62 | 202 | 244 | 330 | 287 | 458 | 578 | 586 | 351 | 714 | 650 | 842 | 697 | 970 | 912 |
| 75 | 114 | 203 | 326 | 331 | 383 | 459 | 673 | 587 | 457 | 715 | 738 | 843 | 778 | 971 | 952 |
| 76 | 83 | 204 | 257 | 332 | 302 | 460 | 597 | 588 | 369 | 716 | 653 | 844 | 711 | 972 | 920 |
| 77 | 123 | 205 | 338 | 333 | 402 | 461 | 679 | 589 | 477 | 717 | 744 | 845 | 792 | 973 | 956 |
| 78 | 135 | 206 | 356 | 334 | 414 | 462 | 691 | 590 | 488 | 718 | 758 | 846 | 809 | 974 | 967 |
| 79 | 193 | 207 | 447 | 335 | 515 | 463 | 777 | 591 | 572 | 719 | 833 | 847 | 875 | 975 | 990 |
| 80 | 44 | 208 | 180 | 336 | 235 | 464 | 484 | 592 | 245 | 720 | 547 | 848 | 632 | 976 | 849 |
| 81 | 73 | 209 | 253 | 337 | 298 | 465 | 589 | 593 | 353 | 721 | 651 | 849 | 702 | 977 | 918 |
| 82 | 85 | 210 | 265 | 338 | 313 | 466 | 611 | 594 | 375 | 722 | 658 | 850 | 720 | 978 | 927 |
| 83 | 130 | 211 | 346 | 339 | 405 | 467 | 687 | 595 | 471 | 723 | 755 | 851 | 796 | 979 | 964 |
| 84 | 91 | 212 | 284 | 340 | 328 | 468 | 620 | 596 | 391 | 724 | 683 | 852 | 732 | 980 | 938 |
| 85 | 138 | 213 | 366 | 341 | 422 | 469 | 694 | 597 | 492 | 725 | 763 | 853 | 817 | 981 | 970 |
| 86 | 145 | 214 | 384 | 342 | 438 | 470 | 723 | 598 | 497 | 726 | 783 | 854 | 826 | 982 | 971 |
| 87 | 214 | 215 | 478 | 343 | 528 | 471 | 802 | 599 | 594 | 727 | 852 | 855 | 886 | 983 | 997 |
| 88 | 99 | 216 | 293 | 344 | 350 | 472 | 646 | 600 | 404 | 728 | 704 | 856 | 761 | 984 | 948 |
| 89 | 148 | 217 | 388 | 345 | 443 | 473 | 729 | 601 | 498 | 729 | 788 | 857 | 827 | 985 | 977 |
| 90 | 162 | 218 | 406 | 346 | 464 | 474 | 740 | 602 | 504 | 730 | 797 | 858 | 843 | 986 | 979 |
| 91 | 228 | 219 | 494 | 347 | 550 | 475 | 816 | 603 | 618 | 731 | 860 | 859 | 898 | 987 | 999 |
| 92 | 174 | 220 | 424 | 348 | 481 | 476 | 760 | 604 | 545 | 732 | 812 | 860 | 858 | 988 | 985 |
| 93 | 242 | 221 | 518 | 349 | 576 | 477 | 834 | 605 | 631 | 733 | 878 | 861 | 910 | 989 | 1004 |
| 94 | 256 | 222 | 532 | 350 | 593 | 478 | 844 | 606 | 656 | 734 | 888 | 862 | 915 | 990 | 1006 |
| 95 | 357 | 223 | 641 | 351 | 686 | 479 | 905 | 607 | 752 | 735 | 933 | 863 | 960 | 991 | 1016 |
| 96 | 53 | 224 | 197 | 352 | 261 | 480 | 516 | 608 | 260 | 736 | 563 | 864 | 654 | 992 | 876 |
| 97 | 88 | 225 | 275 | 353 | 324 | 481 | 615 | 609 | 390 | 737 | 689 | 865 | 734 | 993 | 934 |
| 98 | 97 | 226 | 288 | 354 | 345 | 482 | 636 | 610 | 400 | 738 | 698 | 866 | 754 | 994 | 937 |
| 99 | 144 | 227 | 373 | 355 | 430 | 483 | 724 | 611 | 503 | 739 | 775 | 867 | 818 | 995 | 973 |
| 100 | 109 | 228 | 312 | 356 | 362 | 484 | 666 | 612 | 421 | 740 | 719 | 868 | 767 | 996 | 951 |
| 101 | 154 | 229 | 394 | 357 | 452 | 485 | 726 | 613 | 520 | 741 | 791 | 869 | 839 | 997 | 978 |
| 102 | 169 | 230 | 409 | 358 | 466 | 486 | 756 | 614 | 524 | 742 | 800 | 870 | 850 | 998 | 982 |
| 103 | 239 | 231 | 506 | 359 | 568 | 487 | 821 | 615 | 624 | 743 | 867 | 871 | 902 | 999 | 1001 |
| 104 | 118 | 232 | 336 | 360 | 380 | 488 | 670 | 616 | 437 | 744 | 731 | 872 | 785 | 1000 | 957 |
| 105 | 170 | 233 | 415 | 361 | 475 | 489 | 753 | 617 | 544 | 745 | 810 | 873 | 854 | 1001 | 986 |
| 106 | 185 | 234 | 433 | 362 | 487 | 490 | 772 | 618 | 557 | 746 | 823 | 874 | 863 | 1002 | 988 |
| 107 | 250 | 235 | 526 | 363 | 581 | 491 | 840 | 619 | 645 | 747 | 884 | 875 | 914 | 1003 | 1005 |

| 108 | 195 | 236 | 454 | 364 | 512 | 492 | 786 | 620 | 580 | 748 | 837 | 876 | 874 | 1004 | 994 |
|---|---|---|---|---|---|---|---|---|---|---|---|---|---|---|---|
| 109 | 269 | 237 | 535 | 365 | 605 | 493 | 853 | 621 | 664 | 749 | 894 | 877 | 922 | 1005 | 1007 |
| 110 | 282 | 238 | 567 | 366 | 619 | 494 | 870 | 622 | 674 | 750 | 907 | 878 | 932 | 1006 | 1012 |
| 111 | 382 | 239 | 671 | 367 | 707 | 495 | 924 | 623 | 773 | 751 | 949 | 879 | 969 | 1007 | 1018 |
| 112 | 133 | 240 | 355 | 368 | 407 | 496 | 680 | 624 | 456 | 752 | 766 | 880 | 799 | 1008 | 962 |
| 113 | 191 | 241 | 440 | 369 | 510 | 497 | 780 | 625 | 566 | 753 | 825 | 881 | 869 | 1009 | 992 |
| 114 | 211 | 242 | 461 | 370 | 519 | 498 | 798 | 626 | 587 | 754 | 842 | 882 | 881 | 1010 | 995 |
| 115 | 273 | 243 | 552 | 371 | 614 | 499 | 859 | 627 | 675 | 755 | 897 | 883 | 928 | 1011 | 1009 |
| 116 | 216 | 244 | 470 | 372 | 529 | 500 | 808 | 628 | 607 | 756 | 857 | 884 | 892 | 1012 | 1000 |
| 117 | 283 | 245 | 577 | 373 | 630 | 501 | 873 | 629 | 685 | 757 | 911 | 885 | 935 | 1013 | 1010 |
| 118 | 301 | 246 | 591 | 374 | 609 | 502 | 865 | 630 | 709 | 758 | 916 | 886 | 943 | 1014 | 1013 |
| 119 | 403 | 247 | 695 | 375 | 721 | 503 | 930 | 631 | 787 | 759 | 961 | 887 | 976 | 1015 | 1019 |
| 120 | 233 | 248 | 509 | 376 | 560 | 504 | 828 | 632 | 635 | 760 | 868 | 888 | 904 | 1016 | 1002 |
| 121 | 307 | 249 | 598 | 377 | 660 | 505 | 885 | 633 | 712 | 761 | 921 | 889 | 947 | 1017 | 1014 |
| 122 | 322 | 250 | 613 | 378 | 672 | 506 | 893 | 634 | 730 | 762 | 929 | 890 | 953 | 1018 | 1015 |
| 123 | 419 | 251 | 690 | 379 | 749 | 507 | 946 | 635 | 803 | 763 | 966 | 891 | 981 | 1019 | 1020 |
| 124 | 337 | 252 | 629 | 380 | 677 | 508 | 909 | 636 | 741 | 764 | 940 | 892 | 958 | 1020 | 1017 |
| 125 | 434 | 253 | 714 | 381 | 779 | 509 | 954 | 637 | 819 | 765 | 974 | 893 | 989 | 1021 | 1021 |
| 126 | 460 | 254 | 743 | 382 | 794 | 510 | 963 | 638 | 836 | 766 | 983 | 894 | 991 | 1022 | 1022 |
| 127 | 582 | 255 | 830 | 383 | 846 | 511 | 984 | 639 | 903 | 767 | 1003 | 895 | 1011 | 1023 | 1023 |

Sequence Z12, having a sequence length of 512:

[0, 1, 2, 7, 3, 8, 11, 24, 4, 10, 13, 27, 16, 32, 34, 69, 5, 12, 14, 31, 19, 37, 45, 73, 22, 44, 41, 80, 54, 88, 93, 142, 6, 17, 21, 39, 23, 43, 49, 82, 28, 52, 56, 89, 64, 99, 103, 155, 33, 57, 67, 101, 72, 109, 116, 165, 79, 118, 126, 178, 131, 187, 199, 266, 9, 18, 26, 51, 29, 55, 63, 95, 35, 68, 58, 104, 76, 112, 121, 169, 42, 66, 78, 117, 84, 124, 130, 183, 91, 133, 144, 193, 154, 205, 215, 286, 50, 81, 90, 129, 100, 137, 149, 202, 107, 150, 164, 210, 171, 225, 234, 300, 119, 167, 180, 227, 185, 235, 248, 313, 196, 252, 262, 324, 273, 334, 347, 407, 15, 25, 30, 65, 38, 71, 74, 120, 46, 77, 85, 128, 92, 136, 140, 201, 53, 86, 94, 138, 102, 148, 161, 212, 111, 162, 168, 221, 182, 232, 246, 309, 60, 98, 108, 153, 113, 163, 173, 228, 127, 179, 186, 237, 195, 251, 259, 323, 139, 190, 203, 254, 211, 269, 275, 332, 226, 281, 294, 345, 304, 356, 372, 408, 62, 110, 123, 174, 135, 184, 194, 253, 143, 197, 206, 265, 216, 274, 285, 342, 159, 213, 222, 279, 236, 293, 302, 358, 242, 306, 315, 365, 326, 377, 387, 434, 172, 229, 239, 296, 255, 308, 317, 369, 272, 322, 333, 382, 346, 390, 398, 443, 284, 337, 348, 393, 355, 404, 412, 458, 370, 415, 422, 453, 429, 460, 469, 491, 20, 36, 40, 83, 47, 87, 96, 147, 48, 97, 105, 156, 114, 170, 175, 244, 59, 106, 115, 176, 125, 181, 189, 245, 132, 188, 200, 261, 214, 271, 276, 331, 61, 122, 134, 177, 145, 191, 204, 270, 152, 209, 217, 277, 224, 291, 298, 354, 151, 223, 231, 290, 241, 303, 311, 366, 257, 319, 327, 376, 336, 386, 395, 439, 70, 141, 146, 207, 158, 220, 230, 287, 166, 233, 238, 301, 249, 312, 321, 374, 198, 247, 256, 314, 267, 325, 335, 384, 283, 338, 350, 392, 359, 403, 413, 450, 219, 264, 278, 330, 289, 344, 352, 399, 299, 357, 363, 406, 373, 417, 426, 459, 316, 371, 378, 423, 385, 430, 419, 461, 396, 437, 444, 470, 447, 478, 482, 495, 75, 157, 160, 240, 192, 250, 258, 318, 208, 260, 268, 329, 282, 340, 349, 401, 218, 280, 288, 341, 295, 353, 361, 409, 307, 364, 368, 416, 383, 425, 433, 465, 243, 292, 297, 360, 310, 367, 379, 420, 328, 380, 388, 432, 397, 428, 441, 471, 343, 391, 402, 438, 410, 446, 452, 475, 418, 456, 455, 481, 462, 484, 487, 501, 263, 305, 320, 381, 339, 389, 394, 436, 351, 400, 405, 445, 414, 448, 454, 477, 362, 411, 421, 451, 427, 457, 463, 485, 435, 467, 468, 488, 474, 492, 494, 504, 375, 424, 431, 464, 440, 466, 473, 489, 442, 472, 476, 493, 480, 496, 499, 506, 449, 479, 483, 497, 486, 500, 498, 507, 490, 502, 503, 508, 505, 509, 510, 511]

## Table Z12, having a sequence length of 512:

| Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability |
|---|---|---|---|---|---|---|---|---|---|---|---|---|---|---|---|
| 0 | 0 | 64 | 9 | 128 | 15 | 192 | 62 | 256 | 20 | 320 | 70 | 384 | 75 | 448 | 263 |
| 1 | 1 | 65 | 18 | 129 | 25 | 193 | 110 | 257 | 36 | 321 | 141 | 385 | 157 | 449 | 305 |
| 2 | 2 | 66 | 26 | 130 | 30 | 194 | 123 | 258 | 40 | 322 | 146 | 386 | 160 | 450 | 320 |
| 3 | 7 | 67 | 51 | 131 | 65 | 195 | 174 | 259 | 83 | 323 | 207 | 387 | 240 | 451 | 381 |
| 4 | 3 | 68 | 29 | 132 | 38 | 196 | 135 | 260 | 47 | 324 | 158 | 388 | 192 | 452 | 339 |
| 5 | 8 | 69 | 55 | 133 | 71 | 197 | 184 | 261 | 87 | 325 | 220 | 389 | 250 | 453 | 389 |
| 6 | 11 | 70 | 63 | 134 | 74 | 198 | 194 | 262 | 96 | 326 | 230 | 390 | 258 | 454 | 394 |
| 7 | 24 | 71 | 95 | 135 | 120 | 199 | 253 | 263 | 147 | 327 | 287 | 391 | 318 | 455 | 436 |
| 8 | 4 | 72 | 35 | 136 | 46 | 200 | 143 | 264 | 48 | 328 | 166 | 392 | 208 | 456 | 351 |
| 9 | 10 | 73 | 68 | 137 | 77 | 201 | 197 | 265 | 97 | 329 | 233 | 393 | 260 | 457 | 400 |
| 10 | 13 | 74 | 58 | 138 | 85 | 202 | 206 | 266 | 105 | 330 | 238 | 394 | 268 | 458 | 405 |
| 11 | 27 | 75 | 104 | 139 | 128 | 203 | 265 | 267 | 156 | 331 | 301 | 395 | 329 | 459 | 445 |
| 12 | 16 | 76 | 76 | 140 | 92 | 204 | 216 | 268 | 114 | 332 | 249 | 396 | 282 | 460 | 414 |
| 13 | 32 | 77 | 112 | 141 | 136 | 205 | 274 | 269 | 170 | 333 | 312 | 397 | 340 | 461 | 448 |
| 14 | 34 | 78 | 121 | 142 | 140 | 206 | 285 | 270 | 175 | 334 | 321 | 398 | 349 | 462 | 454 |
| 15 | 69 | 79 | 169 | 143 | 201 | 207 | 342 | 271 | 244 | 335 | 374 | 399 | 401 | 463 | 477 |
| 16 | 5 | 80 | 42 | 144 | 53 | 208 | 159 | 272 | 59 | 336 | 198 | 400 | 218 | 464 | 362 |
| 17 | 12 | 81 | 66 | 145 | 86 | 209 | 213 | 273 | 106 | 337 | 247 | 401 | 280 | 465 | 411 |

| | | | | | | | | | | | | | | | |
|---|---|---|---|---|---|---|---|---|---|---|---|---|---|---|---|
| 18 | 14 | 82 | 78 | 146 | 94 | 210 | 222 | 274 | 115 | 338 | 256 | 402 | 288 | 466 | 421 |
| 19 | 31 | 83 | 117 | 147 | 138 | 211 | 279 | 275 | 176 | 339 | 314 | 403 | 341 | 467 | 451 |
| 20 | 19 | 84 | 84 | 148 | 102 | 212 | 236 | 276 | 125 | 340 | 267 | 404 | 295 | 468 | 427 |
| 21 | 37 | 85 | 124 | 149 | 148 | 213 | 293 | 277 | 181 | 341 | 325 | 405 | 353 | 469 | 457 |
| 22 | 45 | 86 | 130 | 150 | 161 | 214 | 302 | 278 | 189 | 342 | 335 | 406 | 361 | 470 | 463 |
| 23 | 73 | 87 | 183 | 151 | 212 | 215 | 358 | 279 | 245 | 343 | 384 | 407 | 409 | 471 | 485 |
| 24 | 22 | 88 | 91 | 152 | 111 | 216 | 242 | 280 | 132 | 344 | 283 | 408 | 307 | 472 | 435 |
| 25 | 44 | 89 | 133 | 153 | 162 | 217 | 306 | 281 | 188 | 345 | 338 | 409 | 364 | 473 | 467 |
| 26 | 41 | 90 | 144 | 154 | 168 | 218 | 315 | 282 | 200 | 346 | 350 | 410 | 368 | 474 | 468 |
| 27 | 80 | 91 | 193 | 155 | 221 | 219 | 365 | 283 | 261 | 347 | 392 | 411 | 416 | 475 | 488 |
| 28 | 54 | 92 | 154 | 156 | 182 | 220 | 326 | 284 | 214 | 348 | 359 | 412 | 383 | 476 | 474 |
| 29 | 88 | 93 | 205 | 157 | 232 | 221 | 377 | 285 | 271 | 349 | 403 | 413 | 425 | 477 | 492 |
| 30 | 93 | 94 | 215 | 158 | 246 | 222 | 387 | 286 | 276 | 350 | 413 | 414 | 433 | 478 | 494 |
| 31 | 142 | 95 | 286 | 159 | 309 | 223 | 434 | 287 | 331 | 351 | 450 | 415 | 465 | 479 | 504 |
| 32 | 6 | 96 | 50 | 160 | 60 | 224 | 172 | 288 | 61 | 352 | 219 | 416 | 243 | 480 | 375 |
| 33 | 17 | 97 | 81 | 161 | 98 | 225 | 229 | 289 | 122 | 353 | 264 | 417 | 292 | 481 | 424 |
| 34 | 21 | 98 | 90 | 162 | 108 | 226 | 239 | 290 | 134 | 354 | 278 | 418 | 297 | 482 | 431 |
| 35 | 39 | 99 | 129 | 163 | 153 | 227 | 296 | 291 | 177 | 355 | 330 | 419 | 360 | 483 | 464 |
| 36 | 23 | 100 | 100 | 164 | 113 | 228 | 255 | 292 | 145 | 356 | 289 | 420 | 310 | 484 | 440 |
| 37 | 43 | 101 | 137 | 165 | 163 | 229 | 308 | 293 | 191 | 357 | 344 | 421 | 367 | 485 | 466 |
| 38 | 49 | 102 | 149 | 166 | 173 | 230 | 317 | 294 | 204 | 358 | 352 | 422 | 379 | 486 | 473 |
| 39 | 82 | 103 | 202 | 167 | 228 | 231 | 369 | 295 | 270 | 359 | 399 | 423 | 420 | 487 | 489 |
| 40 | 28 | 104 | 107 | 168 | 127 | 232 | 272 | 296 | 152 | 360 | 299 | 424 | 328 | 488 | 442 |
| 41 | 52 | 105 | 150 | 169 | 179 | 233 | 322 | 297 | 209 | 361 | 357 | 425 | 380 | 489 | 472 |
| 42 | 56 | 106 | 164 | 170 | 186 | 234 | 333 | 298 | 217 | 362 | 363 | 426 | 388 | 490 | 476 |
| 43 | 89 | 107 | 210 | 171 | 237 | 235 | 382 | 299 | 277 | 363 | 406 | 427 | 432 | 491 | 493 |
| 44 | 64 | 108 | 171 | 172 | 195 | 236 | 346 | 300 | 224 | 364 | 373 | 428 | 397 | 492 | 480 |
| 45 | 99 | 109 | 225 | 173 | 251 | 237 | 390 | 301 | 291 | 365 | 417 | 429 | 428 | 493 | 496 |
| 46 | 103 | 110 | 234 | 174 | 259 | 238 | 398 | 302 | 298 | 366 | 426 | 430 | 441 | 494 | 499 |
| 47 | 155 | 111 | 300 | 175 | 323 | 239 | 443 | 303 | 354 | 367 | 459 | 431 | 471 | 495 | 506 |
| 48 | 33 | 112 | 119 | 176 | 139 | 240 | 284 | 304 | 151 | 368 | 316 | 432 | 343 | 496 | 449 |
| 49 | 57 | 113 | 167 | 177 | 190 | 241 | 337 | 305 | 223 | 369 | 371 | 433 | 391 | 497 | 479 |
| 50 | 67 | 114 | 180 | 178 | 203 | 242 | 348 | 306 | 231 | 370 | 378 | 434 | 402 | 498 | 483 |
| 51 | 101 | 115 | 227 | 179 | 254 | 243 | 393 | 307 | 290 | 371 | 423 | 435 | 438 | 499 | 497 |
| 52 | 72 | 116 | 185 | 180 | 211 | 244 | 355 | 308 | 241 | 372 | 385 | 436 | 410 | 500 | 486 |
| 53 | 109 | 117 | 235 | 181 | 269 | 245 | 404 | 309 | 303 | 373 | 430 | 437 | 446 | 501 | 500 |
| 54 | 116 | 118 | 248 | 182 | 275 | 246 | 412 | 310 | 311 | 374 | 419 | 438 | 452 | 502 | 498 |
| 55 | 165 | 119 | 313 | 183 | 332 | 247 | 458 | 311 | 366 | 375 | 461 | 439 | 475 | 503 | 507 |

| | | | | | | | | | | | | | | | |
|---|---|---|---|---|---|---|---|---|---|---|---|---|---|---|---|
| 56 | 79 | 120 | 196 | 184 | 226 | 248 | 370 | 312 | 257 | 376 | 396 | 440 | 418 | 504 | 490 |
| 57 | 118 | 121 | 252 | 185 | 281 | 249 | 415 | 313 | 319 | 377 | 437 | 441 | 456 | 505 | 502 |
| 58 | 126 | 122 | 262 | 186 | 294 | 250 | 422 | 314 | 327 | 378 | 444 | 442 | 455 | 506 | 503 |
| 59 | 178 | 123 | 324 | 187 | 345 | 251 | 453 | 315 | 376 | 379 | 470 | 443 | 481 | 507 | 508 |
| 60 | 131 | 124 | 273 | 188 | 304 | 252 | 429 | 316 | 336 | 380 | 447 | 444 | 462 | 508 | 505 |
| 61 | 187 | 125 | 334 | 189 | 356 | 253 | 460 | 317 | 386 | 381 | 478 | 445 | 484 | 509 | 509 |
| 62 | 199 | 126 | 347 | 190 | 372 | 254 | 469 | 318 | 395 | 382 | 482 | 446 | 487 | 510 | 510 |
| 63 | 266 | 127 | 407 | 191 | 408 | 255 | 491 | 319 | 439 | 383 | 495 | 447 | 501 | 511 | 511 |

Sequence Z13, having a sequence length of 256:

[0, 1, 2, 7, 3, 8, 11, 23, 4, 10, 13, 26, 16, 31, 33, 62, 5, 12, 14, 30, 19, 35, 42, 65, 21, 41, 38, 71, 49, 77, 82, 120, 6, 17, 20, 37, 22, 40, 44, 73, 27, 47, 51, 78, 57, 86, 90, 128, 32, 52, 60, 88, 64, 94, 99, 134, 70, 101, 107, 142, 112, 150, 157, 193, 9, 18, 25, 46, 28, 50, 56, 84, 34, 61, 53, 91, 67, 97, 104, 137, 39, 59, 69, 100, 74, 106, 111, 146, 80, 113, 122, 152, 127, 161, 167, 203, 45, 72, 79, 110, 87, 116, 124, 159, 92, 125, 133, 163, 138, 171, 177, 207, 102, 135, 144, 173, 148, 178, 184, 213, 155, 186, 191, 218, 196, 222, 227, 243, 15, 24, 29, 58, 36, 63, 66, 103, 43, 68, 75, 109, 81, 115, 119, 158, 48, 76, 83, 117, 89, 123, 130, 165, 96, 131, 136, 169, 145, 176, 183, 212, 54, 85, 93, 126, 98, 132, 140, 174, 108, 143, 149, 180, 154, 185, 190, 217, 118, 151, 160, 188, 164, 194, 198, 220, 172, 200, 205, 225, 209, 230, 235, 244, 55, 95, 105, 141, 114, 147, 153, 187, 121, 156, 162, 192, 168, 197, 202, 224, 129, 166, 170, 199, 179, 204, 208, 231, 182, 210, 214, 232, 219, 236, 238, 249, 139, 175, 181, 206, 189, 211, 215, 233, 195, 216, 221, 237, 226, 239, 241, 250, 201, 223, 228, 240, 229, 242, 245, 252, 234, 246, 247, 251, 248, 253, 254, 255]

Table Z13, having a sequence length of 256:

| Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability |
|---|---|---|---|---|---|---|---|---|---|---|---|---|---|---|---|
| 0 | 0 | 32 | 6 | 64 | 9 | 96 | 45 | 128 | 15 | 160 | 54 | 192 | 55 | 224 | 139 |
| 1 | 1 | 33 | 17 | 65 | 18 | 97 | 72 | 129 | 24 | 161 | 85 | 193 | 95 | 225 | 175 |
| 2 | 2 | 34 | 20 | 66 | 25 | 98 | 79 | 130 | 29 | 162 | 93 | 194 | 105 | 226 | 181 |
| 3 | 7 | 35 | 37 | 67 | 46 | 99 | 110 | 131 | 58 | 163 | 126 | 195 | 141 | 227 | 206 |
| 4 | 3 | 36 | 22 | 68 | 28 | 100 | 87 | 132 | 36 | 164 | 98 | 196 | 114 | 228 | 189 |
| 5 | 8 | 37 | 40 | 69 | 50 | 101 | 116 | 133 | 63 | 165 | 132 | 197 | 147 | 229 | 211 |
| 6 | 11 | 38 | 44 | 70 | 56 | 102 | 124 | 134 | 66 | 166 | 140 | 198 | 153 | 230 | 215 |

| 7 | 23 | 39 | 73 | 71 | 84 | 103 | 159 | 135 | 103 | 167 | 174 | 199 | 187 | 231 | 233 |
|---|---|---|---|---|---|---|---|---|---|---|---|---|---|---|---|
| 8 | 4 | 40 | 27 | 72 | 34 | 104 | 92 | 136 | 43 | 168 | 108 | 200 | 121 | 232 | 195 |
| 9 | 10 | 41 | 47 | 73 | 61 | 105 | 125 | 137 | 68 | 169 | 143 | 201 | 156 | 233 | 216 |
| 10 | 13 | 42 | 51 | 74 | 53 | 106 | 133 | 138 | 75 | 170 | 149 | 202 | 162 | 234 | 221 |
| 11 | 26 | 43 | 78 | 75 | 91 | 107 | 163 | 139 | 109 | 171 | 180 | 203 | 192 | 235 | 237 |
| 12 | 16 | 44 | 57 | 76 | 67 | 108 | 138 | 140 | 81 | 172 | 154 | 204 | 168 | 236 | 226 |
| 13 | 31 | 45 | 86 | 77 | 97 | 109 | 171 | 141 | 115 | 173 | 185 | 205 | 197 | 237 | 239 |
| 14 | 33 | 46 | 90 | 78 | 104 | 110 | 177 | 142 | 119 | 174 | 190 | 206 | 202 | 238 | 241 |
| 15 | 62 | 47 | 128 | 79 | 137 | 111 | 207 | 143 | 158 | 175 | 217 | 207 | 224 | 239 | 250 |
| 16 | 5 | 48 | 32 | 80 | 39 | 112 | 102 | 144 | 48 | 176 | 118 | 208 | 129 | 240 | 201 |
| 17 | 12 | 49 | 52 | 81 | 59 | 113 | 135 | 145 | 76 | 177 | 151 | 209 | 166 | 241 | 223 |
| 18 | 14 | 50 | 60 | 82 | 69 | 114 | 144 | 146 | 83 | 178 | 160 | 210 | 170 | 242 | 228 |
| 19 | 30 | 51 | 88 | 83 | 100 | 115 | 173 | 147 | 117 | 179 | 188 | 211 | 199 | 243 | 240 |
| 20 | 19 | 52 | 64 | 84 | 74 | 116 | 148 | 148 | 89 | 180 | 164 | 212 | 179 | 244 | 229 |
| 21 | 35 | 53 | 94 | 85 | 106 | 117 | 178 | 149 | 123 | 181 | 194 | 213 | 204 | 245 | 242 |
| 22 | 42 | 54 | 99 | 86 | 111 | 118 | 184 | 150 | 130 | 182 | 198 | 214 | 208 | 246 | 245 |
| 23 | 65 | 55 | 134 | 87 | 146 | 119 | 213 | 151 | 165 | 183 | 220 | 215 | 231 | 247 | 252 |
| 24 | 21 | 56 | 70 | 88 | 80 | 120 | 155 | 152 | 96 | 184 | 172 | 216 | 182 | 248 | 234 |
| 25 | 41 | 57 | 101 | 89 | 113 | 121 | 186 | 153 | 131 | 185 | 200 | 217 | 210 | 249 | 246 |
| 26 | 38 | 58 | 107 | 90 | 122 | 122 | 191 | 154 | 136 | 186 | 205 | 218 | 214 | 250 | 247 |
| 27 | 71 | 59 | 142 | 91 | 152 | 123 | 218 | 155 | 169 | 187 | 225 | 219 | 232 | 251 | 251 |
| 28 | 49 | 60 | 112 | 92 | 127 | 124 | 196 | 156 | 145 | 188 | 209 | 220 | 219 | 252 | 248 |
| 29 | 77 | 61 | 150 | 93 | 161 | 125 | 222 | 157 | 176 | 189 | 230 | 221 | 236 | 253 | 253 |
| 30 | 82 | 62 | 157 | 94 | 167 | 126 | 227 | 158 | 183 | 190 | 235 | 222 | 238 | 254 | 254 |
| 31 | 120 | 63 | 193 | 95 | 203 | 127 | 243 | 159 | 212 | 191 | 244 | 223 | 249 | 255 | 255 |

Sequence Z14, having a sequence length of 128:
[0, 1, 2, 7, 3, 8, 11, 22, 4, 10, 13, 24, 15, 28, 30, 53, 5, 12, 14, 27, 18, 32, 38, 55, 20, 37, 34, 59, 43, 63, 67, 89, 6, 16, 19, 33, 21, 36, 39, 61, 25, 42, 45, 64, 49, 69, 72, 94, 29, 46, 51, 71, 54, 75, 77, 96, 58, 79, 83, 100, 86, 104, 107, 119, 9, 17, 23, 41, 26, 44, 48, 68, 31, 52, 47, 73, 56, 76, 81, 98, 35, 50, 57, 78, 62, 82, 85, 102, 66, 87, 90, 105, 93, 109, 111, 121, 40, 60, 65, 84, 70, 88, 91, 108, 74, 92, 95, 110, 99, 112, 114, 122, 80, 97, 101, 113, 103, 115, 116, 123, 106, 117, 118, 124, 120, 125, 126, 127]


Table Z14, having a sequence length of 128:

| Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability |
|---|---|---|---|---|---|---|---|---|---|---|---|---|---|---|---|
| 0 | 0 | 16 | 5 | 32 | 6 | 48 | 29 | 64 | 9 | 80 | 35 | 96 | 40 | 112 | 80 |
| 1 | 1 | 17 | 12 | 33 | 16 | 49 | 46 | 65 | 17 | 81 | 50 | 97 | 60 | 113 | 97 |
| 2 | 2 | 18 | 14 | 34 | 19 | 50 | 51 | 66 | 23 | 82 | 57 | 98 | 65 | 114 | 101 |
| 3 | 7 | 19 | 27 | 35 | 33 | 51 | 71 | 67 | 41 | 83 | 78 | 99 | 84 | 115 | 113 |
| 4 | 3 | 20 | 18 | 36 | 21 | 52 | 54 | 68 | 26 | 84 | 62 | 100 | 70 | 116 | 103 |
| 5 | 8 | 21 | 32 | 37 | 36 | 53 | 75 | 69 | 44 | 85 | 82 | 101 | 88 | 117 | 115 |
| 6 | 11 | 22 | 38 | 38 | 39 | 54 | 77 | 70 | 48 | 86 | 85 | 102 | 91 | 118 | 116 |
| 7 | 22 | 23 | 55 | 39 | 61 | 55 | 96 | 71 | 68 | 87 | 102 | 103 | 108 | 119 | 123 |
| 8 | 4 | 24 | 20 | 40 | 25 | 56 | 58 | 72 | 31 | 88 | 66 | 104 | 74 | 120 | 106 |
| 9 | 10 | 25 | 37 | 41 | 42 | 57 | 79 | 73 | 52 | 89 | 87 | 105 | 92 | 121 | 117 |
| 10 | 13 | 26 | 34 | 42 | 45 | 58 | 83 | 74 | 47 | 90 | 90 | 106 | 95 | 122 | 118 |
| 11 | 24 | 27 | 59 | 43 | 64 | 59 | 100 | 75 | 73 | 91 | 105 | 107 | 110 | 123 | 124 |
| 12 | 15 | 28 | 43 | 44 | 49 | 60 | 86 | 76 | 56 | 92 | 93 | 108 | 99 | 124 | 120 |
| 13 | 28 | 29 | 63 | 45 | 69 | 61 | 104 | 77 | 76 | 93 | 109 | 109 | 112 | 125 | 125 |
| 14 | 30 | 30 | 67 | 46 | 72 | 62 | 107 | 78 | 81 | 94 | 111 | 110 | 114 | 126 | 126 |
| 15 | 53 | 31 | 89 | 47 | 94 | 63 | 119 | 79 | 98 | 95 | 121 | 111 | 122 | 127 | 127 |

Sequence Z15, having a sequence length of 64:
[0, 1, 2, 7, 3, 8, 10, 20, 4, 9, 12, 21, 14, 24, 26, 40, 5, 11, 13, 23, 16, 27, 32, 42, 18, 31, 29, 44, 35, 46, 48, 57, 6, 15, 17, 28, 19, 30, 33, 45, 22, 34, 36, 47, 38, 49, 51, 58, 25, 37, 39, 50, 41, 52, 53, 59, 43, 54, 55, 60, 56, 61, 62, 63]

Table Z15, having a sequence length of 64:

| Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability |
|---|---|---|---|---|---|---|---|---|---|---|---|---|---|---|---|
| 0 | 0 | 8 | 4 | 16 | 5 | 24 | 18 | 32 | 6 | 40 | 22 | 48 | 25 | 56 | 43 |
| 1 | 1 | 9 | 9 | 17 | 11 | 25 | 31 | 33 | 15 | 41 | 34 | 49 | 37 | 57 | 54 |
| 2 | 2 | 10 | 12 | 18 | 13 | 26 | 29 | 34 | 17 | 42 | 36 | 50 | 39 | 58 | 55 |
| 3 | 7 | 11 | 21 | 19 | 23 | 27 | 44 | 35 | 28 | 43 | 47 | 51 | 50 | 59 | 60 |

70

| 4 | 3 | 12 | 14 | 20 | 16 | 28 | 35 | 36 | 19 | 44 | 38 | 52 | 41 | 60 | 56 |
|---|---|----|----|----|----|----|----|----|----|----|----|----|----|----|----|
| 5 | 8 | 13 | 24 | 21 | 27 | 29 | 46 | 37 | 30 | 45 | 49 | 53 | 52 | 61 | 61 |
| 6 | 10 | 14 | 26 | 22 | 32 | 30 | 48 | 38 | 33 | 46 | 51 | 54 | 53 | 62 | 62 |
| 7 | 20 | 15 | 40 | 23 | 42 | 31 | 57 | 39 | 45 | 47 | 58 | 55 | 59 | 63 | 63 |

Fourth group of sequences (a criterion that considers a performance balance under partial-order (partial-order) constraints).

Sequence Q16, having a sequence length of 1024:

[0, 1, 2, 4, 8, 16, 32, 3, 5, 64, 9, 6, 17, 10, 18, 128, 12, 33, 65, 20, 256, 34, 24, 36, 7, 129, 66, 512, 11, 40, 68, 130, 19, 13, 48, 14, 72, 257, 21, 132, 35, 258, 22, 80, 136, 513, 25, 37, 260, 264, 26, 96, 514, 38, 67, 41, 144, 28, 69, 516, 42, 272, 49, 70, 520, 160, 44, 131, 73, 288, 528, 192, 50, 74, 544, 52, 15, 133, 320, 81, 23, 134, 384, 76, 56, 259, 82, 137, 27, 97, 39, 84, 138, 145, 261, 29, 43, 98, 515, 88, 140, 30, 146, 71, 262, 265, 161, 576, 45, 100, 640, 51, 148, 46, 75, 266, 273, 517, 104, 162, 53, 193, 152, 77, 164, 768, 268, 274, 518, 54, 83, 57, 521, 112, 135, 78, 289, 194, 85, 276, 522, 58, 168, 139, 99, 86, 60, 280, 89, 290, 529, 524, 196, 141, 101, 147, 176, 142, 530, 321, 90, 200, 31, 545, 292, 322, 532, 263, 149, 102, 105, 296, 304, 163, 92, 47, 267, 150, 208, 385, 546, 386, 324, 106, 153, 165, 55, 328, 536, 577, 548, 113, 154, 79, 269, 108, 578, 224, 166, 519, 552, 195, 270, 641, 523, 275, 580, 291, 169, 59, 560, 114, 277, 156, 87, 197, 116, 170, 61, 531, 525, 642, 281, 278, 526, 177, 293, 388, 91, 584, 769, 198, 172, 120, 201, 336, 62, 282, 143, 103, 178, 294, 93, 644, 202, 592, 323, 392, 297, 770, 107, 180, 151, 209, 284, 648, 94, 204, 298, 400, 352, 608, 325, 533, 155, 210, 305, 547, 300, 109, 184, 115, 534, 167, 225, 537, 326, 306, 772, 157, 656, 329, 110, 117, 212, 171, 330, 226, 549, 776, 538, 387, 308, 216, 416, 271, 279, 158, 337, 550, 672, 118, 332, 579, 540, 389, 173, 121, 553, 199, 784, 179, 228, 338, 390, 122, 554, 448, 312, 581, 393, 283, 704, 174, 394, 181, 340, 203, 353, 561, 527, 582, 556, 63, 295, 285, 232, 124, 286, 562, 205, 182, 643, 585, 299, 354, 211, 401, 185, 396, 344, 586, 645, 593, 535, 240, 206, 95, 327, 564, 800, 402, 356, 307, 301, 417, 213, 186, 539, 404, 227, 594, 568, 771, 418, 649, 302, 832, 551, 111, 896, 360, 588, 609, 331, 214, 309, 188, 449, 217, 646, 408, 229, 541, 159, 420, 596, 650, 773, 310, 333, 119, 657, 658, 610, 368, 339, 391, 313, 218, 334, 542, 230, 233, 774, 612, 175, 123, 652, 600, 450, 583, 341, 220, 555, 314, 557, 424, 395, 777, 673, 355, 287, 183, 234, 125, 616, 342, 563, 778, 660, 558, 452, 674, 397, 785, 432, 316, 345, 241, 207, 403, 357, 187, 587, 565, 664, 624, 780, 236, 126, 242, 398, 705, 346, 456, 358, 405, 303, 569, 189, 595, 215, 566, 676, 361, 706, 589, 244, 786, 647, 348, 419, 406, 464, 801, 590, 362, 570, 409, 680, 597, 788, 572, 219, 311, 708, 598, 601, 651, 421, 792, 802, 611, 602, 369, 190, 688, 653, 248, 231, 410, 364, 654, 659, 335, 480, 315, 221, 613, 422, 370, 425, 235, 451, 543, 614, 412, 343, 222, 775, 317, 372, 426, 453, 237, 559, 833, 804, 712, 834, 661, 808, 779, 617, 604, 433, 720, 816, 836, 347, 897, 243, 662, 454, 318, 675, 618, 898, 781, 376, 428, 665, 736, 567, 840, 625, 238, 359, 457, 399, 787, 677, 434, 349, 458, 678, 245, 666, 363, 591, 127, 620, 407, 782, 436, 465, 626, 571, 246, 681, 350, 707, 460, 599, 668, 789, 249, 411, 682, 573, 365, 803, 790, 709, 440, 466, 793, 574, 371, 423, 689, 603, 366, 628, 250, 413, 468, 655, 481, 900, 805, 191, 373, 615, 684, 427, 710, 794, 605, 414, 252, 713, 374, 848, 690, 632, 806, 482, 429, 904, 809, 455, 223, 663, 835, 692, 619, 472, 714, 796, 721, 837, 716, 864, 810, 606, 912, 722, 696, 377, 817, 435, 484, 621, 812, 319, 430, 838, 667, 239, 378, 459, 437, 622, 627, 488, 380, 818, 461, 496, 669, 679, 724, 841, 629, 351, 467, 438, 737, 247, 462, 441, 442, 469, 251, 683, 842, 738, 899, 670, 783, 849, 820, 728, 928, 791, 367, 901, 630, 685, 844, 633, 711, 253, 691, 824, 902, 686, 740, 850, 375, 444, 470, 483, 905, 415, 485, 795, 473, 634, 744, 852, 960, 865, 693, 797, 906, 715, 807, 474, 636, 694, 254, 717, 575, 811, 697, 866, 798, 379, 431, 913, 607, 489, 723, 486, 908, 718, 813, 476, 856, 839, 725, 698, 914, 752, 868, 819, 814, 439, 929, 490, 623, 671, 739, 916, 463, 843, 381, 497, 930, 821, 726, 961, 872, 492, 631, 729, 700, 443, 741, 845, 920, 382, 822, 851, 730, 498, 880, 742, 445, 471, 635, 932, 687, 903, 825, 500, 846, 745, 826, 732, 446, 962, 936, 475, 853, 867, 637, 907, 487, 695, 746, 828, 753, 854, 857, 504, 799, 909, 719, 638, 915, 477, 255, 964, 699, 748, 869, 944, 491, 754, 910, 858, 917, 478, 968, 870, 815, 383, 727, 493, 873, 701, 931, 756, 860, 499, 731, 823, 702, 918, 921, 874, 494, 976, 760, 933, 881, 501, 743, 922, 876, 847, 934, 827, 733, 882, 502, 447, 992, 937, 963, 747, 505, 855, 924, 734, 829, 938, 884, 506, 965, 749, 945, 966, 755, 859, 940, 830, 911, 871, 888, 479, 946, 750, 969, 861, 757, 970, 919, 875, 758, 508, 862, 639, 948, 977, 923, 972, 761, 877, 952, 495, 703, 935, 978, 883, 762, 503, 925, 878, 735, 993, 885, 939, 994, 980, 926, 764, 941, 967, 886, 831, 947, 507, 889, 984, 751, 942, 996, 971, 890, 509, 949, 973, 1000, 892, 950, 863, 759, 1008, 510, 979, 953, 763, 974, 954, 879, 981, 982, 927, 995, 765, 956, 887, 985, 997, 986, 943, 891, 998, 766, 511, 988, 1001, 951, 1002, 893, 975, 894, 1009, 955, 1004, 1010, 957, 983, 958, 987, 1012, 999, 1016, 767, 989, 1003, 990, 1005, 895, 1011, 1013, 959, 1006, 1014, 1017, 1018, 991, 1020, 1007, 1015, 1019, 1021, 1022, 1023]

Table Q16, having a sequence length of 1024:

| Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number |
|---|---|---|---|---|---|---|---|---|---|---|---|---|---|---|---|
| 0 | 0 | 128 | 518 | 256 | 94 | 384 | 331 | 512 | 364 | 640 | 904 | 768 | 819 | 896 | 966 |
| 1 | 1 | 129 | 54 | 257 | 204 | 385 | 214 | 513 | 654 | 641 | 809 | 769 | 814 | 897 | 755 |
| 2 | 2 | 130 | 83 | 258 | 298 | 386 | 309 | 514 | 659 | 642 | 455 | 770 | 439 | 898 | 859 |
| 3 | 4 | 131 | 57 | 259 | 400 | 387 | 188 | 515 | 335 | 643 | 223 | 771 | 929 | 899 | 940 |

| | | | | | | | | | | | | | | | |
|---|---|---|---|---|---|---|---|---|---|---|---|---|---|---|---|
| 4 | 8 | 132 | 521 | 260 | 352 | 388 | 449 | 516 | 480 | 644 | 663 | 772 | 490 | 900 | 830 |
| 5 | 16 | 133 | 112 | 261 | 608 | 389 | 217 | 517 | 315 | 645 | 835 | 773 | 623 | 901 | 911 |
| 6 | 32 | 134 | 135 | 262 | 325 | 390 | 646 | 518 | 221 | 646 | 692 | 774 | 671 | 902 | 871 |
| 7 | 3 | 135 | 78 | 263 | 533 | 391 | 408 | 519 | 613 | 647 | 619 | 775 | 739 | 903 | 888 |
| 8 | 5 | 136 | 289 | 264 | 155 | 392 | 229 | 520 | 422 | 648 | 472 | 776 | 916 | 904 | 479 |
| 9 | 64 | 137 | 194 | 265 | 210 | 393 | 541 | 521 | 370 | 649 | 714 | 777 | 463 | 905 | 946 |
| 10 | 9 | 138 | 85 | 266 | 305 | 394 | 159 | 522 | 425 | 650 | 796 | 778 | 843 | 906 | 750 |
| 11 | 6 | 139 | 276 | 267 | 547 | 395 | 420 | 523 | 235 | 651 | 721 | 779 | 381 | 907 | 969 |
| 12 | 17 | 140 | 522 | 268 | 300 | 396 | 596 | 524 | 451 | 652 | 837 | 780 | 497 | 908 | 861 |
| 13 | 10 | 141 | 58 | 269 | 109 | 397 | 650 | 525 | 543 | 653 | 716 | 781 | 930 | 909 | 757 |
| 14 | 18 | 142 | 168 | 270 | 184 | 398 | 773 | 526 | 614 | 654 | 864 | 782 | 821 | 910 | 970 |
| 15 | 128 | 143 | 139 | 271 | 115 | 399 | 310 | 527 | 412 | 655 | 810 | 783 | 726 | 911 | 919 |
| 16 | 12 | 144 | 99 | 272 | 534 | 400 | 333 | 528 | 343 | 656 | 606 | 784 | 961 | 912 | 875 |
| 17 | 33 | 145 | 86 | 273 | 167 | 401 | 119 | 529 | 222 | 657 | 912 | 785 | 872 | 913 | 758 |
| 18 | 65 | 146 | 60 | 274 | 225 | 402 | 657 | 530 | 775 | 658 | 722 | 786 | 492 | 914 | 508 |
| 19 | 20 | 147 | 280 | 275 | 537 | 403 | 658 | 531 | 317 | 659 | 696 | 787 | 631 | 915 | 862 |
| 20 | 256 | 148 | 89 | 276 | 326 | 404 | 610 | 532 | 372 | 660 | 377 | 788 | 729 | 916 | 639 |
| 21 | 34 | 149 | 290 | 277 | 306 | 405 | 368 | 533 | 426 | 661 | 817 | 789 | 700 | 917 | 948 |
| 22 | 24 | 150 | 529 | 278 | 772 | 406 | 339 | 534 | 453 | 662 | 435 | 790 | 443 | 918 | 977 |
| 23 | 36 | 151 | 524 | 279 | 157 | 407 | 391 | 535 | 237 | 663 | 484 | 791 | 741 | 919 | 923 |
| 24 | 7 | 152 | 196 | 280 | 656 | 408 | 313 | 536 | 559 | 664 | 621 | 792 | 845 | 920 | 972 |
| 25 | 129 | 153 | 141 | 281 | 329 | 409 | 218 | 537 | 833 | 665 | 812 | 793 | 920 | 921 | 761 |
| 26 | 66 | 154 | 101 | 282 | 110 | 410 | 334 | 538 | 804 | 666 | 319 | 794 | 382 | 922 | 877 |
| 27 | 512 | 155 | 147 | 283 | 117 | 411 | 542 | 539 | 712 | 667 | 430 | 795 | 822 | 923 | 952 |
| 28 | 11 | 156 | 176 | 284 | 212 | 412 | 230 | 540 | 834 | 668 | 838 | 796 | 851 | 924 | 495 |
| 29 | 40 | 157 | 142 | 285 | 171 | 413 | 233 | 541 | 661 | 669 | 667 | 797 | 730 | 925 | 703 |
| 30 | 68 | 158 | 530 | 286 | 330 | 414 | 774 | 542 | 808 | 670 | 239 | 798 | 498 | 926 | 935 |
| 31 | 130 | 159 | 321 | 287 | 226 | 415 | 612 | 543 | 779 | 671 | 378 | 799 | 880 | 927 | 978 |
| 32 | 19 | 160 | 90 | 288 | 549 | 416 | 175 | 544 | 617 | 672 | 459 | 800 | 742 | 928 | 883 |
| 33 | 13 | 161 | 200 | 289 | 776 | 417 | 123 | 545 | 604 | 673 | 437 | 801 | 445 | 929 | 762 |
| 34 | 48 | 162 | 31 | 290 | 538 | 418 | 652 | 546 | 433 | 674 | 622 | 802 | 471 | 930 | 503 |
| 35 | 14 | 163 | 545 | 291 | 387 | 419 | 600 | 547 | 720 | 675 | 627 | 803 | 635 | 931 | 925 |
| 36 | 72 | 164 | 292 | 292 | 308 | 420 | 450 | 548 | 816 | 676 | 488 | 804 | 932 | 932 | 878 |
| 37 | 257 | 165 | 322 | 293 | 216 | 421 | 583 | 549 | 836 | 677 | 380 | 805 | 687 | 933 | 735 |
| 38 | 21 | 166 | 532 | 294 | 416 | 422 | 341 | 550 | 347 | 678 | 818 | 806 | 903 | 934 | 993 |
| 39 | 132 | 167 | 263 | 295 | 271 | 423 | 220 | 551 | 897 | 679 | 461 | 807 | 825 | 935 | 885 |
| 40 | 35 | 168 | 149 | 296 | 279 | 424 | 555 | 552 | 243 | 680 | 496 | 808 | 500 | 936 | 939 |
| 41 | 258 | 169 | 102 | 297 | 158 | 425 | 314 | 553 | 662 | 681 | 669 | 809 | 846 | 937 | 994 |

| | | | | | | | | | | | | | | | |
|---|---|---|---|---|---|---|---|---|---|---|---|---|---|---|---|
| 42 | 22 | 170 | 105 | 298 | 337 | 426 | 557 | 554 | 454 | 682 | 679 | 810 | 745 | 938 | 980 |
| 43 | 80 | 171 | 296 | 299 | 550 | 427 | 424 | 555 | 318 | 683 | 724 | 811 | 826 | 939 | 926 |
| 44 | 136 | 172 | 304 | 300 | 672 | 428 | 395 | 556 | 675 | 684 | 841 | 812 | 732 | 940 | 764 |
| 45 | 513 | 173 | 163 | 301 | 118 | 429 | 777 | 557 | 618 | 685 | 629 | 813 | 446 | 941 | 941 |
| 46 | 25 | 174 | 92 | 302 | 332 | 430 | 673 | 558 | 898 | 686 | 351 | 814 | 962 | 942 | 967 |
| 47 | 37 | 175 | 47 | 303 | 579 | 431 | 355 | 559 | 781 | 687 | 467 | 815 | 936 | 943 | 886 |
| 48 | 260 | 176 | 267 | 304 | 540 | 432 | 287 | 560 | 376 | 688 | 438 | 816 | 475 | 944 | 831 |
| 49 | 264 | 177 | 150 | 305 | 389 | 433 | 183 | 561 | 428 | 689 | 737 | 817 | 853 | 945 | 947 |
| 50 | 26 | 178 | 208 | 306 | 173 | 434 | 234 | 562 | 665 | 690 | 247 | 818 | 867 | 946 | 507 |
| 51 | 96 | 179 | 385 | 307 | 121 | 435 | 125 | 563 | 736 | 691 | 462 | 819 | 637 | 947 | 889 |
| 52 | 514 | 180 | 546 | 308 | 553 | 436 | 616 | 564 | 567 | 692 | 441 | 820 | 907 | 948 | 984 |
| 53 | 38 | 181 | 386 | 309 | 199 | 437 | 342 | 565 | 840 | 693 | 442 | 821 | 487 | 949 | 751 |
| 54 | 67 | 182 | 324 | 310 | 784 | 438 | 563 | 566 | 625 | 694 | 469 | 822 | 695 | 950 | 942 |
| 55 | 41 | 183 | 106 | 311 | 179 | 439 | 778 | 567 | 238 | 695 | 251 | 823 | 746 | 951 | 996 |
| 56 | 144 | 184 | 153 | 312 | 228 | 440 | 660 | 568 | 359 | 696 | 683 | 824 | 828 | 952 | 971 |
| 57 | 28 | 185 | 165 | 313 | 338 | 441 | 558 | 569 | 457 | 697 | 842 | 825 | 753 | 953 | 890 |
| 58 | 69 | 186 | 55 | 314 | 390 | 442 | 452 | 570 | 399 | 698 | 738 | 826 | 854 | 954 | 509 |
| 59 | 516 | 187 | 328 | 315 | 122 | 443 | 674 | 571 | 787 | 699 | 899 | 827 | 857 | 955 | 949 |
| 60 | 42 | 188 | 536 | 316 | 554 | 444 | 397 | 572 | 677 | 700 | 670 | 828 | 504 | 956 | 973 |
| 61 | 272 | 189 | 577 | 317 | 448 | 445 | 785 | 573 | 434 | 701 | 783 | 829 | 799 | 957 | 1000 |
| 62 | 49 | 190 | 548 | 318 | 312 | 446 | 432 | 574 | 349 | 702 | 849 | 830 | 909 | 958 | 892 |
| 63 | 70 | 191 | 113 | 319 | 581 | 447 | 316 | 575 | 458 | 703 | 820 | 831 | 719 | 959 | 950 |
| 64 | 520 | 192 | 154 | 320 | 393 | 448 | 345 | 576 | 678 | 704 | 728 | 832 | 638 | 960 | 863 |
| 65 | 160 | 193 | 79 | 321 | 283 | 449 | 241 | 577 | 245 | 705 | 928 | 833 | 915 | 961 | 759 |
| 66 | 44 | 194 | 269 | 322 | 704 | 450 | 207 | 578 | 666 | 706 | 791 | 834 | 477 | 962 | 1008 |
| 67 | 131 | 195 | 108 | 323 | 174 | 451 | 403 | 579 | 363 | 707 | 367 | 835 | 255 | 963 | 510 |
| 68 | 73 | 196 | 578 | 324 | 394 | 452 | 357 | 580 | 591 | 708 | 901 | 836 | 964 | 964 | 979 |
| 69 | 288 | 197 | 224 | 325 | 181 | 453 | 187 | 581 | 127 | 709 | 630 | 837 | 699 | 965 | 953 |
| 70 | 528 | 198 | 166 | 326 | 340 | 454 | 587 | 582 | 620 | 710 | 685 | 838 | 748 | 966 | 763 |
| 71 | 192 | 199 | 519 | 327 | 203 | 455 | 565 | 583 | 407 | 711 | 844 | 839 | 869 | 967 | 974 |
| 72 | 50 | 200 | 552 | 328 | 353 | 456 | 664 | 584 | 782 | 712 | 633 | 840 | 944 | 968 | 954 |
| 73 | 74 | 201 | 195 | 329 | 561 | 457 | 624 | 585 | 436 | 713 | 711 | 841 | 491 | 969 | 879 |
| 74 | 544 | 202 | 270 | 330 | 527 | 458 | 780 | 586 | 465 | 714 | 253 | 842 | 754 | 970 | 981 |
| 75 | 52 | 203 | 641 | 331 | 582 | 459 | 236 | 587 | 626 | 715 | 691 | 843 | 910 | 971 | 982 |
| 76 | 15 | 204 | 523 | 332 | 556 | 460 | 126 | 588 | 571 | 716 | 824 | 844 | 858 | 972 | 927 |
| 77 | 133 | 205 | 275 | 333 | 63 | 461 | 242 | 589 | 246 | 717 | 902 | 845 | 917 | 973 | 995 |
| 78 | 320 | 206 | 580 | 334 | 295 | 462 | 398 | 590 | 681 | 718 | 686 | 846 | 478 | 974 | 765 |
| 79 | 81 | 207 | 291 | 335 | 285 | 463 | 705 | 591 | 350 | 719 | 740 | 847 | 968 | 975 | 956 |

| | | | | | | | | | | | | | | | |
|---|---|---|---|---|---|---|---|---|---|---|---|---|---|---|---|
| 80 | 23 | 208 | 169 | 336 | 232 | 464 | 346 | 592 | 707 | 720 | 850 | 848 | 870 | 976 | 887 |
| 81 | 134 | 209 | 59 | 337 | 124 | 465 | 456 | 593 | 460 | 721 | 375 | 849 | 815 | 977 | 985 |
| 82 | 384 | 210 | 560 | 338 | 286 | 466 | 358 | 594 | 599 | 722 | 444 | 850 | 383 | 978 | 997 |
| 83 | 76 | 211 | 114 | 339 | 562 | 467 | 405 | 595 | 668 | 723 | 470 | 851 | 727 | 979 | 986 |
| 84 | 56 | 212 | 277 | 340 | 205 | 468 | 303 | 596 | 789 | 724 | 483 | 852 | 493 | 980 | 943 |
| 85 | 259 | 213 | 156 | 341 | 182 | 469 | 569 | 597 | 249 | 725 | 905 | 853 | 873 | 981 | 891 |
| 86 | 82 | 214 | 87 | 342 | 643 | 470 | 189 | 598 | 411 | 726 | 415 | 854 | 701 | 982 | 998 |
| 87 | 137 | 215 | 197 | 343 | 585 | 471 | 595 | 599 | 682 | 727 | 485 | 855 | 931 | 983 | 766 |
| 88 | 27 | 216 | 116 | 344 | 299 | 472 | 215 | 600 | 573 | 728 | 795 | 856 | 756 | 984 | 511 |
| 89 | 97 | 217 | 170 | 345 | 354 | 473 | 566 | 601 | 365 | 729 | 473 | 857 | 860 | 985 | 988 |
| 90 | 39 | 218 | 61 | 346 | 211 | 474 | 676 | 602 | 803 | 730 | 634 | 858 | 499 | 986 | 1001 |
| 91 | 84 | 219 | 531 | 347 | 401 | 475 | 361 | 603 | 790 | 731 | 744 | 859 | 731 | 987 | 951 |
| 92 | 138 | 220 | 525 | 348 | 185 | 476 | 706 | 604 | 709 | 732 | 852 | 860 | 823 | 988 | 1002 |
| 93 | 145 | 221 | 642 | 349 | 396 | 477 | 589 | 605 | 440 | 733 | 960 | 861 | 702 | 989 | 893 |
| 94 | 261 | 222 | 281 | 350 | 344 | 478 | 244 | 606 | 466 | 734 | 865 | 862 | 918 | 990 | 975 |
| 95 | 29 | 223 | 278 | 351 | 586 | 479 | 786 | 607 | 793 | 735 | 693 | 863 | 921 | 991 | 894 |
| 96 | 43 | 224 | 526 | 352 | 645 | 480 | 647 | 608 | 574 | 736 | 797 | 864 | 874 | 992 | 1009 |
| 97 | 98 | 225 | 177 | 353 | 593 | 481 | 348 | 609 | 371 | 737 | 906 | 865 | 494 | 993 | 955 |
| 98 | 515 | 226 | 293 | 354 | 535 | 482 | 419 | 610 | 423 | 738 | 715 | 866 | 976 | 994 | 1004 |
| 99 | 88 | 227 | 388 | 355 | 240 | 483 | 406 | 611 | 689 | 739 | 807 | 867 | 760 | 995 | 1010 |
| 100 | 140 | 228 | 91 | 356 | 206 | 484 | 464 | 612 | 603 | 740 | 474 | 868 | 933 | 996 | 957 |
| 101 | 30 | 229 | 584 | 357 | 95 | 485 | 801 | 613 | 366 | 741 | 636 | 869 | 881 | 997 | 983 |
| 102 | 146 | 230 | 769 | 358 | 327 | 486 | 590 | 614 | 628 | 742 | 694 | 870 | 501 | 998 | 958 |
| 103 | 71 | 231 | 198 | 359 | 564 | 487 | 362 | 615 | 250 | 743 | 254 | 871 | 743 | 999 | 987 |
| 104 | 262 | 232 | 172 | 360 | 800 | 488 | 570 | 616 | 413 | 744 | 717 | 872 | 922 | 1000 | 1012 |
| 105 | 265 | 233 | 120 | 361 | 402 | 489 | 409 | 617 | 468 | 745 | 575 | 873 | 876 | 1001 | 999 |
| 106 | 161 | 234 | 201 | 362 | 356 | 490 | 680 | 618 | 655 | 746 | 811 | 874 | 847 | 1002 | 1016 |
| 107 | 576 | 235 | 336 | 363 | 307 | 491 | 597 | 619 | 481 | 747 | 697 | 875 | 934 | 1003 | 767 |
| 108 | 45 | 236 | 62 | 364 | 301 | 492 | 788 | 620 | 900 | 748 | 866 | 876 | 827 | 1004 | 989 |
| 109 | 100 | 237 | 282 | 365 | 417 | 493 | 572 | 621 | 805 | 749 | 798 | 877 | 733 | 1005 | 1003 |
| 110 | 640 | 238 | 143 | 366 | 213 | 494 | 219 | 622 | 191 | 750 | 379 | 878 | 882 | 1006 | 990 |
| 111 | 51 | 239 | 103 | 367 | 186 | 495 | 311 | 623 | 373 | 751 | 431 | 879 | 502 | 1007 | 1005 |
| 112 | 148 | 240 | 178 | 368 | 539 | 496 | 708 | 624 | 615 | 752 | 913 | 880 | 447 | 1008 | 895 |
| 113 | 46 | 241 | 294 | 369 | 404 | 497 | 598 | 625 | 684 | 753 | 607 | 881 | 992 | 1009 | 1011 |
| 114 | 75 | 242 | 93 | 370 | 227 | 498 | 601 | 626 | 427 | 754 | 489 | 882 | 937 | 1010 | 1013 |
| 115 | 266 | 243 | 644 | 371 | 594 | 499 | 651 | 627 | 710 | 755 | 723 | 883 | 963 | 1011 | 959 |
| 116 | 273 | 244 | 202 | 372 | 568 | 500 | 421 | 628 | 794 | 756 | 486 | 884 | 747 | 1012 | 1006 |
| 117 | 517 | 245 | 592 | 373 | 771 | 501 | 792 | 629 | 605 | 757 | 908 | 885 | 505 | 1013 | 1014 |

| 118 | 104 | 246 | 323 | 374 | 418 | 502 | 802 | 630 | 414 | 758 | 718 | 886 | 855 | 1014 | 1017 |
|---|---|---|---|---|---|---|---|---|---|---|---|---|---|---|---|
| 119 | 162 | 247 | 392 | 375 | 649 | 503 | 611 | 631 | 252 | 759 | 813 | 887 | 924 | 1015 | 1018 |
| 120 | 53 | 248 | 297 | 376 | 302 | 504 | 602 | 632 | 713 | 760 | 476 | 888 | 734 | 1016 | 991 |
| 121 | 193 | 249 | 770 | 377 | 832 | 505 | 369 | 633 | 374 | 761 | 856 | 889 | 829 | 1017 | 1020 |
| 122 | 152 | 250 | 107 | 378 | 551 | 506 | 190 | 634 | 848 | 762 | 839 | 890 | 938 | 1018 | 1007 |
| 123 | 77 | 251 | 180 | 379 | 111 | 507 | 688 | 635 | 690 | 763 | 725 | 891 | 884 | 1019 | 1015 |
| 124 | 164 | 252 | 151 | 380 | 896 | 508 | 653 | 636 | 632 | 764 | 698 | 892 | 506 | 1020 | 1019 |
| 125 | 768 | 253 | 209 | 381 | 360 | 509 | 248 | 637 | 806 | 765 | 914 | 893 | 965 | 1021 | 1021 |
| 126 | 268 | 254 | 284 | 382 | 588 | 510 | 231 | 638 | 482 | 766 | 752 | 894 | 749 | 1022 | 1022 |
| 127 | 274 | 255 | 648 | 383 | 609 | 511 | 410 | 639 | 429 | 767 | 868 | 895 | 945 | 1023 | 1023 |

Sequence Q17, having a sequence length of 512:

[0, 1, 2, 4, 8, 16, 32, 3, 5, 64, 9, 6, 17, 10, 18, 128, 12, 33, 65, 20, 256, 34, 24, 36, 7, 129, 66, 11, 40, 68, 130, 19, 13, 48, 14, 72, 257, 21, 132, 35,258, 22, 80, 136, 25, 37, 260, 264, 26, 96, 38, 67, 41, 144, 28, 69, 42, 272, 49, 70, 160, 44, 131, 73, 288, 192, 50, 74, 52, 15, 133, 320, 81, 23, 134, 384, 76, 56, 259, 82, 137, 27, 97, 39, 84, 138, 145, 261, 29, 43, 98, 88, 140, 30, 146, 71, 262, 265, 161, 45, 100, 51, 148, 46, 75, 266, 273, 104, 162, 53, 193, 152, 77, 164, 268, 274, 54, 83, 57, 112, 135, 78, 289, 194, 85, 276, 58, 168, 139, 99, 86, 60, 280, 89, 290, 196, 141, 101, 147, 176, 142, 321, 90, 200, 31, 292, 322, 263, 149, 102, 105, 296, 304, 163, 92, 47, 267, 150, 208, 385, 386, 324, 106, 153, 165, 55, 328, 113, 154, 79, 269, 108, 224, 166, 195, 270, 275, 291, 169, 59, 114, 277, 156, 87, 197, 116, 170, 61, 281, 278, 177, 293, 388, 91, 198, 172, 120, 201, 336, 62, 282, 143, 103, 178, 294, 93, 202, 323, 392, 297, 107, 180, 151, 209, 284, 94, 204, 298, 400, 352, 325, 155, 210, 305, 300, 109, 184, 115, 167, 225, 326, 306, 157, 329, 110, 117, 212, 171, 330, 226, 387, 308, 216, 416, 271, 279, 158, 337, 118, 332, 389, 173, 121, 199, 179, 228, 338, 390, 122, 448, 312, 393, 283, 174, 394, 181, 340, 203, 353, 63, 295, 285, 232, 124, 286, 205, 182, 299, 354, 211, 401, 185, 396, 344, 240, 206, 95, 327, 402, 356, 307, 301, 417, 213, 186, 404, 227, 418, 302, 111, 360, 331, 214, 309, 188, 449, 217, 408, 229, 159, 420, 310, 333, 119, 368, 339, 391, 313, 218, 334, 230, 233, 175, 123, 450, 341, 220, 314, 424, 395, 355, 287, 183, 234, 125, 342, 452, 397, 432, 316, 345, 241, 207, 403, 357, 187, 236, 126, 242, 398, 346, 456, 358, 405, 303, 189, 215, 361, 244, 348, 419, 406, 464, 362, 409, 219, 311, 421, 369, 190, 248, 231, 410, 364, 335, 480, 315, 221, 422, 370, 425, 235, 451, 412, 343, 222, 317, 372, 426, 453, 237, 433, 347, 243, 454, 318, 376, 428, 238, 359, 457, 399, 434, 349, 458, 245, 363, 127, 407, 436, 465, 246, 350, 460, 249, 411, 365, 440, 466, 371, 423, 366, 250, 413, 468, 481, 191, 373, 427, 414, 252, 374, 482, 429, 455, 223, 472, 377, 435, 484, 319, 430, 239, 378, 459, 437, 488, 380, 461, 496, 351, 467, 438, 247, 462, 441, 442, 469, 251, 367, 253, 375, 444, 470, 483, 415, 485, 473, 474, 254, 379, 431, 489, 486, 476, 439, 490, 463, 381, 497, 492, 443, 382, 498, 445, 471, 500, 446, 475, 487, 504, 477, 255, 491, 478, 383, 493, 499, 494, 501, 502, 447, 505, 506, 479, 508, 495, 503, 507, 509, 510, 511]

76

Table Q17, having a sequence length of 512:

| Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number |
|---|---|---|---|---|---|---|---|---|---|---|---|---|---|---|---|
| 0 | 0 | 64 | 288 | 128 | 139 | 192 | 388 | 256 | 338 | 320 | 230 | 384 | 343 | 448 | 461 |
| 1 | 1 | 65 | 192 | 129 | 99 | 193 | 91 | 257 | 390 | 321 | 233 | 385 | 222 | 449 | 496 |
| 2 | 2 | 66 | 50 | 130 | 86 | 194 | 198 | 258 | 122 | 322 | 175 | 386 | 317 | 450 | 351 |
| 3 | 4 | 67 | 74 | 131 | 60 | 195 | 172 | 259 | 448 | 323 | 123 | 387 | 372 | 451 | 467 |
| 4 | 8 | 68 | 52 | 132 | 280 | 196 | 120 | 260 | 312 | 324 | 450 | 388 | 426 | 452 | 438 |
| 5 | 16 | 69 | 15 | 133 | 89 | 197 | 201 | 261 | 393 | 325 | 341 | 389 | 453 | 453 | 247 |
| 6 | 32 | 70 | 133 | 134 | 290 | 198 | 336 | 262 | 283 | 326 | 220 | 390 | 237 | 454 | 462 |
| 7 | 3 | 71 | 320 | 135 | 196 | 199 | 62 | 263 | 174 | 327 | 314 | 391 | 433 | 455 | 441 |
| 8 | 5 | 72 | 81 | 136 | 141 | 200 | 282 | 264 | 394 | 328 | 424 | 392 | 347 | 456 | 442 |
| 9 | 64 | 73 | 23 | 137 | 101 | 201 | 143 | 265 | 181 | 329 | 395 | 393 | 243 | 457 | 469 |
| 10 | 9 | 74 | 134 | 138 | 147 | 202 | 103 | 266 | 340 | 330 | 355 | 394 | 454 | 458 | 251 |
| 11 | 6 | 75 | 384 | 139 | 176 | 203 | 178 | 267 | 203 | 331 | 287 | 395 | 318 | 459 | 367 |
| 12 | 17 | 76 | 76 | 140 | 142 | 204 | 294 | 268 | 353 | 332 | 183 | 396 | 376 | 460 | 253 |
| 13 | 10 | 77 | 56 | 141 | 321 | 205 | 93 | 269 | 63 | 333 | 234 | 397 | 428 | 461 | 375 |
| 14 | 18 | 78 | 259 | 142 | 90 | 206 | 202 | 270 | 295 | 334 | 125 | 398 | 238 | 462 | 444 |
| 15 | 128 | 79 | 82 | 143 | 200 | 207 | 323 | 271 | 285 | 335 | 342 | 399 | 359 | 463 | 470 |
| 16 | 12 | 80 | 137 | 144 | 31 | 208 | 392 | 272 | 232 | 336 | 452 | 400 | 457 | 464 | 483 |
| 17 | 33 | 81 | 27 | 145 | 292 | 209 | 297 | 273 | 124 | 337 | 397 | 401 | 399 | 465 | 415 |
| 18 | 65 | 82 | 97 | 146 | 322 | 210 | 107 | 274 | 286 | 338 | 432 | 402 | 434 | 466 | 485 |
| 19 | 20 | 83 | 39 | 147 | 263 | 211 | 180 | 275 | 205 | 339 | 316 | 403 | 349 | 467 | 473 |
| 20 | 256 | 84 | 84 | 148 | 149 | 212 | 151 | 276 | 182 | 340 | 345 | 404 | 458 | 468 | 474 |
| 21 | 34 | 85 | 138 | 149 | 102 | 213 | 209 | 277 | 299 | 341 | 241 | 405 | 245 | 469 | 254 |
| 22 | 24 | 86 | 145 | 150 | 105 | 214 | 284 | 278 | 354 | 342 | 207 | 406 | 363 | 470 | 379 |
| 23 | 36 | 87 | 261 | 151 | 296 | 215 | 94 | 279 | 211 | 343 | 403 | 407 | 127 | 471 | 431 |
| 24 | 7 | 88 | 29 | 152 | 304 | 216 | 204 | 280 | 401 | 344 | 357 | 408 | 407 | 472 | 489 |
| 25 | 129 | 89 | 43 | 153 | 163 | 217 | 298 | 281 | 185 | 345 | 187 | 409 | 436 | 473 | 486 |
| 26 | 66 | 90 | 98 | 154 | 92 | 218 | 400 | 282 | 396 | 346 | 236 | 410 | 465 | 474 | 476 |
| 27 | 11 | 91 | 88 | 155 | 47 | 219 | 352 | 283 | 344 | 347 | 126 | 411 | 246 | 475 | 439 |
| 28 | 40 | 92 | 140 | 156 | 267 | 220 | 325 | 284 | 240 | 348 | 242 | 412 | 350 | 476 | 490 |

| | | | | | | | | | | | | | | | |
|---|---|---|---|---|---|---|---|---|---|---|---|---|---|---|---|
| 29 | 68 | 93 | 30 | 157 | 150 | 221 | 155 | 285 | 206 | 349 | 398 | 413 | 460 | 477 | 463 |
| 30 | 130 | 94 | 146 | 158 | 208 | 222 | 210 | 286 | 95 | 350 | 346 | 414 | 249 | 478 | 381 |
| 31 | 19 | 95 | 71 | 159 | 385 | 223 | 305 | 287 | 327 | 351 | 456 | 415 | 411 | 479 | 497 |
| 32 | 13 | 96 | 262 | 160 | 386 | 224 | 300 | 288 | 402 | 352 | 358 | 416 | 365 | 480 | 492 |
| 33 | 48 | 97 | 265 | 161 | 324 | 225 | 109 | 289 | 356 | 353 | 405 | 417 | 440 | 481 | 443 |
| 34 | 14 | 98 | 161 | 162 | 106 | 226 | 184 | 290 | 307 | 354 | 303 | 418 | 466 | 482 | 382 |
| 35 | 72 | 99 | 45 | 163 | 153 | 227 | 115 | 291 | 301 | 355 | 189 | 419 | 371 | 483 | 498 |
| 36 | 257 | 100 | 100 | 164 | 165 | 228 | 167 | 292 | 417 | 356 | 215 | 420 | 423 | 484 | 445 |
| 37 | 21 | 101 | 51 | 165 | 55 | 229 | 225 | 293 | 213 | 357 | 361 | 421 | 366 | 485 | 471 |
| 38 | 132 | 102 | 148 | 166 | 328 | 230 | 326 | 294 | 186 | 358 | 244 | 422 | 250 | 486 | 500 |
| 39 | 35 | 103 | 46 | 167 | 113 | 231 | 306 | 295 | 404 | 359 | 348 | 423 | 413 | 487 | 446 |
| 40 | 258 | 104 | 75 | 168 | 154 | 232 | 157 | 296 | 227 | 360 | 419 | 424 | 468 | 488 | 475 |
| 41 | 22 | 105 | 266 | 169 | 79 | 233 | 329 | 297 | 418 | 361 | 406 | 425 | 481 | 489 | 487 |
| 42 | 80 | 106 | 273 | 170 | 269 | 234 | 110 | 298 | 302 | 362 | 464 | 426 | 191 | 490 | 504 |
| 43 | 136 | 107 | 104 | 171 | 108 | 235 | 117 | 299 | 111 | 363 | 362 | 427 | 373 | 491 | 477 |
| 44 | 25 | 108 | 162 | 172 | 224 | 236 | 212 | 300 | 360 | 364 | 409 | 428 | 427 | 492 | 255 |
| 45 | 37 | 109 | 53 | 173 | 166 | 237 | 171 | 301 | 331 | 365 | 219 | 429 | 414 | 493 | 491 |
| 46 | 260 | 110 | 193 | 174 | 195 | 238 | 330 | 302 | 214 | 366 | 311 | 430 | 252 | 494 | 478 |
| 47 | 264 | 111 | 152 | 175 | 270 | 239 | 226 | 303 | 309 | 367 | 421 | 431 | 374 | 495 | 383 |
| 48 | 26 | 112 | 77 | 176 | 275 | 240 | 387 | 304 | 188 | 368 | 369 | 432 | 482 | 496 | 493 |
| 49 | 96 | 113 | 164 | 177 | 291 | 241 | 308 | 305 | 449 | 369 | 190 | 433 | 429 | 497 | 499 |
| 50 | 38 | 114 | 268 | 178 | 169 | 242 | 216 | 306 | 217 | 370 | 248 | 434 | 455 | 498 | 494 |
| 51 | 67 | 115 | 274 | 179 | 59 | 243 | 416 | 307 | 408 | 371 | 231 | 435 | 223 | 499 | 501 |
| 52 | 41 | 116 | 54 | 180 | 114 | 244 | 271 | 308 | 229 | 372 | 410 | 436 | 472 | 500 | 502 |
| 53 | 144 | 117 | 83 | 181 | 277 | 245 | 279 | 309 | 159 | 373 | 364 | 437 | 377 | 501 | 447 |
| 54 | 28 | 118 | 57 | 182 | 156 | 246 | 158 | 310 | 420 | 374 | 335 | 438 | 435 | 502 | 505 |
| 55 | 69 | 119 | 112 | 183 | 87 | 247 | 337 | 311 | 310 | 375 | 480 | 439 | 484 | 503 | 506 |
| 56 | 42 | 120 | 135 | 184 | 197 | 248 | 118 | 312 | 333 | 376 | 315 | 440 | 319 | 504 | 479 |
| 57 | 272 | 121 | 78 | 185 | 116 | 249 | 332 | 313 | 119 | 377 | 221 | 441 | 430 | 505 | 508 |
| 58 | 49 | 122 | 289 | 186 | 170 | 250 | 389 | 314 | 368 | 378 | 422 | 442 | 239 | 506 | 495 |
| 59 | 70 | 123 | 194 | 187 | 61 | 251 | 173 | 315 | 339 | 379 | 370 | 443 | 378 | 507 | 503 |
| 60 | 160 | 124 | 85 | 188 | 281 | 252 | 121 | 316 | 391 | 380 | 425 | 444 | 459 | 508 | 507 |
| 61 | 44 | 125 | 276 | 189 | 278 | 253 | 199 | 317 | 313 | 381 | 235 | 445 | 437 | 509 | 509 |
| 62 | 131 | 126 | 58 | 190 | 177 | 254 | 179 | 318 | 218 | 382 | 451 | 446 | 488 | 510 | 510 |
| 63 | 73 | 127 | 168 | 191 | 293 | 255 | 228 | 319 | 334 | 383 | 412 | 447 | 380 | 511 | 511 |

Sequence Q18, having a sequence length of 256:
[0, 1, 2, 4, 8, 16, 32, 3, 5, 64, 9, 6, 17, 10, 18, 128, 12, 33, 65, 20, 34, 24, 36, 7, 129, 66, 11, 40, 68, 130, 19, 13, 48, 14, 72, 21, 132, 35, 22, 80, 136, 25, 37, 26, 96, 38, 67, 41, 144, 28, 69, 42, 49, 70, 160, 44, 131, 73, 192, 50, 74, 52, 15,

78

133, 81, 23, 134, 76, 56, 82, 137, 27, 97, 39, 84, 138, 145, 29, 43, 98, 88, 140, 30, 146, 71, 161, 45, 100, 51, 148, 46, 75, 104, 162, 53, 193, 152, 77, 164, 54, 83, 57, 112, 135, 78, 194, 85, 58, 168, 139, 99, 86, 60, 89, 196, 141, 101, 147, 176, 142, 90, 200, 31, 149, 102, 105, 163, 92, 47, 150, 208, 106, 153, 165, 55, 113, 154, 79, 108, 224, 166, 195, 169, 59, 114, 156, 87, 197, 116, 170, 61, 177, 91, 198, 172, 120, 201, 62, 143, 103, 178, 93, 202, 107, 180, 151, 209, 94, 204, 155, 210, 109, 184, 115, 167, 225, 157, 110, 117, 212, 171, 226, 216, 158, 118, 173, 121, 199, 179, 228, 122, 174, 181, 203, 63, 232, 124, 205, 182, 211, 185, 240, 206, 95, 213, 186, 227, 111, 214, 188, 217, 229, 159, 119, 218, 230, 233, 175, 123, 220, 183, 234, 125, 241, 207, 187, 236, 126, 242, 189, 215, 244, 219, 190, 248, 231, 221, 235, 222, 237, 243, 238, 245, 127, 246, 249, 250, 191, 252, 223, 239, 247, 251, 253, 254, 255]

Table Q18, having a sequence length of 256:

| Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number |
|---|---|---|---|---|---|---|---|---|---|---|---|---|---|---|---|
| 0 | 0 | 32 | 48 | 64 | 81 | 96 | 152 | 128 | 47 | 160 | 178 | 192 | 181 | 224 | 207 |
| 1 | 1 | 33 | 14 | 65 | 23 | 97 | 77 | 129 | 150 | 161 | 93 | 193 | 203 | 225 | 187 |
| 2 | 2 | 34 | 72 | 66 | 134 | 98 | 164 | 130 | 208 | 162 | 202 | 194 | 63 | 226 | 236 |
| 3 | 4 | 35 | 21 | 67 | 76 | 99 | 54 | 131 | 106 | 163 | 107 | 195 | 232 | 227 | 126 |
| 4 | 8 | 36 | 132 | 68 | 56 | 100 | 83 | 132 | 153 | 164 | 180 | 196 | 124 | 228 | 242 |
| 5 | 16 | 37 | 35 | 69 | 82 | 101 | 57 | 133 | 165 | 165 | 151 | 197 | 205 | 229 | 189 |
| 6 | 32 | 38 | 22 | 70 | 137 | 102 | 112 | 134 | 55 | 166 | 209 | 198 | 182 | 230 | 215 |
| 7 | 3 | 39 | 80 | 71 | 27 | 103 | 135 | 135 | 113 | 167 | 94 | 199 | 211 | 231 | 244 |
| 8 | 5 | 40 | 136 | 72 | 97 | 104 | 78 | 136 | 154 | 168 | 204 | 200 | 185 | 232 | 219 |
| 9 | 64 | 41 | 25 | 73 | 39 | 105 | 194 | 137 | 79 | 169 | 155 | 201 | 240 | 233 | 190 |
| 10 | 9 | 42 | 37 | 74 | 84 | 106 | 85 | 138 | 108 | 170 | 210 | 202 | 206 | 234 | 248 |
| 11 | 6 | 43 | 26 | 75 | 138 | 107 | 58 | 139 | 224 | 171 | 109 | 203 | 95 | 235 | 231 |
| 12 | 17 | 44 | 96 | 76 | 145 | 108 | 168 | 140 | 166 | 172 | 184 | 204 | 213 | 236 | 221 |
| 13 | 10 | 45 | 38 | 77 | 29 | 109 | 139 | 141 | 195 | 173 | 115 | 205 | 186 | 237 | 235 |
| 14 | 18 | 46 | 67 | 78 | 43 | 110 | 99 | 142 | 169 | 174 | 167 | 206 | 227 | 238 | 222 |
| 15 | 128 | 47 | 41 | 79 | 98 | 111 | 86 | 143 | 59 | 175 | 225 | 207 | 111 | 239 | 237 |
| 16 | 12 | 48 | 144 | 80 | 88 | 112 | 60 | 144 | 114 | 176 | 157 | 208 | 214 | 240 | 243 |
| 17 | 33 | 49 | 28 | 81 | 140 | 113 | 89 | 145 | 156 | 177 | 110 | 209 | 188 | 241 | 238 |
| 18 | 65 | 50 | 69 | 82 | 30 | 114 | 196 | 146 | 87 | 178 | 117 | 210 | 217 | 242 | 245 |

| 19 | 20 | 51 | 42 | 83 | 146 | 115 | 141 | 147 | 197 | 179 | 212 | 211 | 229 | 243 | 127 |
|---|---|---|---|---|---|---|---|---|---|---|---|---|---|---|---|
| 20 | 34 | 52 | 49 | 84 | 71 | 116 | 101 | 148 | 116 | 180 | 171 | 212 | 159 | 244 | 246 |
| 21 | 24 | 53 | 70 | 85 | 161 | 117 | 147 | 149 | 170 | 181 | 226 | 213 | 119 | 245 | 249 |
| 22 | 36 | 54 | 160 | 86 | 45 | 118 | 176 | 150 | 61 | 182 | 216 | 214 | 218 | 246 | 250 |
| 23 | 7 | 55 | 44 | 87 | 100 | 119 | 142 | 151 | 177 | 183 | 158 | 215 | 230 | 247 | 191 |
| 24 | 129 | 56 | 131 | 88 | 51 | 120 | 90 | 152 | 91 | 184 | 118 | 216 | 233 | 248 | 252 |
| 25 | 66 | 57 | 73 | 89 | 148 | 121 | 200 | 153 | 198 | 185 | 173 | 217 | 175 | 249 | 223 |
| 26 | 11 | 58 | 192 | 90 | 46 | 122 | 31 | 154 | 172 | 186 | 121 | 218 | 123 | 250 | 239 |
| 27 | 40 | 59 | 50 | 91 | 75 | 123 | 149 | 155 | 120 | 187 | 199 | 219 | 220 | 251 | 247 |
| 28 | 68 | 60 | 74 | 92 | 104 | 124 | 102 | 156 | 201 | 188 | 179 | 220 | 183 | 252 | 251 |
| 29 | 130 | 61 | 52 | 93 | 162 | 125 | 105 | 157 | 62 | 189 | 228 | 221 | 234 | 253 | 253 |
| 30 | 19 | 62 | 15 | 94 | 53 | 126 | 163 | 158 | 143 | 190 | 122 | 222 | 125 | 254 | 254 |
| 31 | 13 | 63 | 133 | 95 | 193 | 127 | 92 | 159 | 103 | 191 | 174 | 223 | 241 | 255 | 255 |

Sequence Q19, having a sequence length of 128:
[0, 1, 2, 4, 8, 16, 32, 3, 5, 64, 9, 6, 17, 10, 18, 12, 33, 65, 20, 34, 24, 36, 7, 66, 11, 40, 68, 19, 13, 48, 14, 72, 21, 35, 22, 80, 25, 37, 26, 96, 38, 67, 41, 28, 69, 42, 49, 70, 44, 73, 50, 74, 52, 15, 81, 23, 76, 56, 82, 27, 97, 39, 84, 29, 43, 98, 88, 30, 71, 45, 100, 51, 46, 75, 104, 53, 77, 54, 83, 57, 112, 78, 85, 58, 99, 86, 60, 89, 101, 90, 31, 102, 105, 92, 47, 106, 55, 113, 79, 108, 59, 114, 87, 116, 61, 91, 120, 62, 103, 93, 107, 94, 109, 115, 110, 117, 118, 121, 122, 63, 124, 95, 111, 119, 123, 125, 126, 127]

Table Q19, having a sequence length of 128:

| Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number |
|---|---|---|---|---|---|---|---|---|---|---|---|---|---|---|---|
| 0 | 0 | 16 | 33 | 32 | 21 | 48 | 44 | 64 | 43 | 80 | 112 | 96 | 55 | 112 | 109 |
| 1 | 1 | 17 | 65 | 33 | 35 | 49 | 73 | 65 | 98 | 81 | 78 | 97 | 113 | 113 | 115 |
| 2 | 2 | 18 | 20 | 34 | 22 | 50 | 50 | 66 | 88 | 82 | 85 | 98 | 79 | 114 | 110 |
| 3 | 4 | 19 | 34 | 35 | 80 | 51 | 74 | 67 | 30 | 83 | 58 | 99 | 108 | 115 | 117 |
| 4 | 8 | 20 | 24 | 36 | 25 | 52 | 52 | 68 | 71 | 84 | 99 | 100 | 59 | 116 | 118 |
| 5 | 16 | 21 | 36 | 37 | 37 | 53 | 15 | 69 | 45 | 85 | 86 | 101 | 114 | 117 | 121 |
| 6 | 32 | 22 | 7 | 38 | 26 | 54 | 81 | 70 | 100 | 86 | 60 | 102 | 87 | 118 | 122 |
| 7 | 3 | 23 | 66 | 39 | 96 | 55 | 23 | 71 | 51 | 87 | 89 | 103 | 116 | 119 | 63 |
| 8 | 5 | 24 | 11 | 40 | 38 | 56 | 76 | 72 | 46 | 88 | 101 | 104 | 61 | 120 | 124 |
| 9 | 64 | 25 | 40 | 41 | 67 | 57 | 56 | 73 | 75 | 89 | 90 | 105 | 91 | 121 | 95 |

| | | | | | | | | | | | | | | | |
|---|---|---|---|---|---|---|---|---|---|---|---|---|---|---|---|
| 10 | 9 | 26 | 68 | 42 | 41 | 58 | 82 | 74 | 104 | 90 | 31 | 106 | 120 | 122 | 111 |
| 11 | 6 | 27 | 19 | 43 | 28 | 59 | 27 | 75 | 53 | 91 | 102 | 107 | 62 | 123 | 119 |
| 12 | 17 | 28 | 13 | 44 | 69 | 60 | 97 | 76 | 77 | 92 | 105 | 108 | 103 | 124 | 123 |
| 13 | 10 | 29 | 48 | 45 | 42 | 61 | 39 | 77 | 54 | 93 | 92 | 109 | 93 | 125 | 125 |
| 14 | 18 | 30 | 14 | 46 | 49 | 62 | 84 | 78 | 83 | 94 | 47 | 110 | 107 | 126 | 126 |
| 15 | 12 | 31 | 72 | 47 | 70 | 63 | 29 | 79 | 57 | 95 | 106 | 111 | 94 | 127 | 127 |

Sequence Q20, having a sequence length of 64:
[0, 1, 2, 4, 8, 16, 32, 3, 5, 9, 6, 17, 10, 18, 12, 33, 20, 34, 24, 36, 7, 11, 40, 19, 13, 48, 14, 21, 35, 22, 25, 37, 26, 38, 41, 28, 42, 49, 44, 50, 52, 15, 23, 56, 27, 39, 29, 43, 30, 45, 51, 46, 53, 54, 57, 58, 60, 31, 47, 55, 59, 61, 62, 63]

## Table Q20, having a sequence length of 64:

| Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number |
|---|---|---|---|---|---|---|---|---|---|---|---|---|---|---|---|
| 0 | 0 | 8 | 5 | 16 | 20 | 24 | 13 | 32 | 26 | 40 | 52 | 48 | 30 | 56 | 60 |
| 1 | 1 | 9 | 9 | 17 | 34 | 25 | 48 | 33 | 38 | 41 | 15 | 49 | 45 | 57 | 31 |
| 2 | 2 | 10 | 6 | 18 | 24 | 26 | 14 | 34 | 41 | 42 | 23 | 50 | 51 | 58 | 47 |
| 3 | 4 | 11 | 17 | 19 | 36 | 27 | 21 | 35 | 28 | 43 | 56 | 51 | 46 | 59 | 55 |
| 4 | 8 | 12 | 10 | 20 | 7 | 28 | 35 | 36 | 42 | 44 | 27 | 52 | 53 | 60 | 59 |
| 5 | 16 | 13 | 18 | 21 | 11 | 29 | 22 | 37 | 49 | 45 | 39 | 53 | 54 | 61 | 61 |
| 6 | 32 | 14 | 12 | 22 | 40 | 30 | 25 | 38 | 44 | 46 | 29 | 54 | 57 | 62 | 62 |
| 7 | 3 | 15 | 33 | 23 | 19 | 31 | 37 | 39 | 50 | 47 | 43 | 55 | 58 | 63 | 63 |

Sequence Z16, having a sequence length of 1024:
[0, 1, 2, 7, 3, 8, 11, 24, 4, 10, 13, 28, 16, 33, 35, 76, 5, 12, 14, 32, 19, 38, 42, 80, 22, 46, 50, 88, 57, 95, 101, 162, 6, 17, 21, 40, 23, 47, 53, 90, 29, 55, 60, 96, 66, 108, 113, 175, 34, 62, 72, 111, 75, 120, 129, 186, 84, 131, 141, 209, 146, 218, 236, 333, 9, 18, 26, 54, 30, 58, 63, 103, 36, 68, 73, 114, 83, 123, 135, 193, 43, 79, 86, 130, 91, 138, 145, 214, 99, 148, 160, 228, 174, 242, 256, 357, 51, 89, 97, 144, 109, 154, 169, 239, 118, 170, 183, 250, 195, 269, 282, 379, 133, 191, 211, 271, 216, 283, 301, 401, 233, 307, 315, 417, 337, 435, 460, 581, 15, 25, 31, 67, 39, 77, 81, 134, 44, 87, 92, 143, 100, 153, 157, 238, 56, 93, 102, 155, 112, 168, 177, 252, 122, 184, 192, 264, 213, 279, 297, 394, 65, 106, 119, 173, 124, 185, 198, 273, 142, 208, 217, 285, 232, 306, 323, 416, 156, 225, 240, 311, 251, 325, 341, 433, 270, 348, 367, 453, 387, 470, 506, 622, 71, 121, 137, 201, 152, 215, 231, 309, 161, 234, 244, 327, 257, 340, 356, 450, 178, 253, 265, 346, 284, 366, 385, 472, 293, 389, 409, 494, 423, 518, 529, 643, 197, 274, 287, 370, 312, 392, 412, 510, 336, 413, 434, 523, 459, 535, 567, 670, 355, 449, 461, 552, 478, 577, 589, 690, 509, 597, 615, 695, 631, 714, 743, 835, 20, 37, 41, 85, 48, 94, 104, 167, 49, 105, 115, 176, 126, 194, 202, 295, 61, 116, 127, 205, 139, 212, 223, 296, 147, 222, 237, 321, 254, 335, 338, 432, 69, 136, 149, 207, 164, 226, 241, 334, 171, 248, 258, 344, 268, 364, 376, 468, 172, 266, 277, 363, 292, 386, 399, 495, 318, 408, 425, 517, 447, 531, 555, 666, 78, 159, 165, 246, 182, 262, 276, 358, 187, 281, 286, 384, 302, 400, 410, 515, 235, 298, 313, 406, 326, 422, 437, 528, 350, 448, 464, 550, 481, 574, 591, 686, 260, 328, 345, 431, 362, 452, 466, 568, 381, 475, 487, 579, 512, 601, 613, 707, 405, 505, 521, 609, 532, 623, 633, 721, 560, 660, 671, 750, 677, 779, 794, 850, 82, 179, 181, 291, 227, 305, 314, 407, 247, 320, 324, 428, 349, 444, 462, 570, 259, 347, 361, 451, 369, 467, 483, 583, 391, 489, 511, 598, 527, 616, 630, 726, 294, 365, 374, 482, 395, 500, 520, 610, 427, 522, 533, 626, 561, 639, 667, 751, 446, 546, 573, 662, 585, 673, 688, 770, 605, 692, 693, 790, 722, 801, 813, 880, 317, 388, 420, 524, 442, 534, 554, 642, 465, 569, 575, 672, 593, 679, 691, 777, 484, 586, 606, 687, 617, 694, 723, 802, 648, 729, 740, 816, 760, 834, 846, 904, 516, 619, 638, 724, 663, 727, 756, 821, 676, 754, 772, 841, 786, 852, 865, 924, 680, 780, 798, 858, 808, 870, 879, 930, 828, 885, 892, 946, 914, 954, 963, 984, 27, 45, 52, 98, 59, 117, 128, 199, 64, 132, 140,204, 151, 220, 224, 330, 70, 150, 158, 219, 166, 263, 272, 354, 188, 275, 290, 368, 304, 393, 411, 525, 74, 163, 180, 267, 190, 288, 299, 378, 200, 308, 316, 424, 332, 426, 441, 536, 210, 329, 339, 438, 359, 455, 473, 564, 372, 469, 488, 588, 493, 600, 608, 745, 107, 189, 196, 303, 206, 319, 331, 421, 229, 343, 351, 454, 382, 477, 486, 580, 245, 353, 371, 471, 396, 491, 497, 594, 419, 498, 504, 612, 545, 629, 656, 753, 261, 383, 404, 503, 415, 519, 526, 624, 436, 544, 557, 647, 582, 664, 674, 773, 457, 566, 587, 675, 614, 685, 709, 787, 636, 712, 730, 803, 741, 819, 832, 916, 110, 203, 221, 342, 243, 352, 390, 480, 255, 375, 397, 499, 418, 508, 513, 618, 280, 402, 403, 514, 440, 541, 553, 644, 456, 562, 578, 669, 595, 681, 700, 774, 300, 430, 443, 556, 474, 572, 576, 682, 490, 590, 599, 696, 625, 710, 718, 805, 507, 611, 635, 715, 646, 735, 742, 822, 659, 747, 764, 837, 789, 854, 861, 925, 322, 463, 476, 592, 496, 604, 627, 713, 539, 632, 649, 738, 653, 744, 758, 831, 547, 651, 658, 755, 683, 763, 783, 851, 704, 788, 797, 859, 812, 877, 888, 933, 563, 689, 698, 775, 719, 791, 800, 871, 731, 810, 823, 884, 838, 894, 906, 949, 766, 825, 842, 897, 856, 909, 913, 961, 867, 921, 929, 966, 940, 974, 983, 1003, 125, 230, 249, 373, 278, 398, 414, 530, 289, 429, 439, 543, 458, 559, 584, 701, 310, 445, 479, 571, 492, 596, 603, 706, 501, 607, 628, 728, 650, 736, 749, 829, 360, 485, 502, 602, 538, 621, 637, 739, 542, 641, 655, 746, 665, 759, 769, 849, 548, 661, 678, 768, 703, 782, 795, 860, 716, 807, 811, 876, 824, 889, 900, 944, 377, 537, 540, 645, 549, 652, 668, 762, 565, 684, 697, 778, 711, 792, 809, 874, 634, 702, 720, 796, 732, 817, 826, 886, 761, 827, 844, 898, 857, 908, 915, 960, 654, 734, 748, 818, 767, 839, 848, 902, 785, 853, 864, 912, 873, 922, 932, 969, 799, 869, 878, 928, 891, 935, 943, 976, 903, 947, 953, 981, 958, 989, 991, 1008, 380, 551, 558, 699, 620, 708, 717, 806, 640, 725, 737, 820, 757, 830, 843, 901, 657, 752, 765, 833, 776, 845, 862, 911, 793, 863, 872, 919, 887, 931, 939, 972, 705, 771, 781, 855, 804, 868, 875, 926, 815, 882, 890, 936, 899, 941, 950, 980, 840, 895, 905, 945, 917, 955, 959, 987, 923, 965, 968, 993, 975, 996, 998, 1011, 733, 784, 814, 883, 836, 893, 896, 942, 847, 907, 910, 952, 920, 956, 967, 990, 866, 918, 927, 964, 938, 970, 971, 997, 948, 977, 979, 999, 985, 1004, 1006, 1016, 881, 934, 937, 973, 951, 978, 982, 1001, 957, 986, 988, 1005, 994, 1007, 1012, 1018, 962, 992, 995, 1009, 1000, 1010, 1013, 1019, 1002, 1014, 1015, 1020, 1017, 1021, 1022, 1023]

Table Z16, having a sequence length of 1024:

| Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability |
|---|---|---|---|---|---|---|---|---|---|---|---|---|---|---|---|
| 0 | 0 | 128 | 15 | 256 | 20 | 384 | 82 | 512 | 27 | 640 | 110 | 768 | 125 | 896 | 380 |
| 1 | 1 | 129 | 25 | 257 | 37 | 385 | 179 | 513 | 45 | 641 | 203 | 769 | 230 | 897 | 551 |
| 2 | 2 | 130 | 31 | 258 | 41 | 386 | 181 | 514 | 52 | 642 | 221 | 770 | 249 | 898 | 558 |
| 3 | 7 | 131 | 67 | 259 | 85 | 387 | 291 | 515 | 98 | 643 | 342 | 771 | 373 | 899 | 699 |
| 4 | 3 | 132 | 39 | 260 | 48 | 388 | 227 | 516 | 59 | 644 | 243 | 772 | 278 | 900 | 620 |
| 5 | 8 | 133 | 77 | 261 | 94 | 389 | 305 | 517 | 117 | 645 | 352 | 773 | 398 | 901 | 708 |
| 6 | 11 | 134 | 81 | 262 | 104 | 390 | 314 | 518 | 128 | 646 | 390 | 774 | 414 | 902 | 717 |
| 7 | 24 | 135 | 134 | 263 | 167 | 391 | 407 | 519 | 199 | 647 | 480 | 775 | 530 | 903 | 806 |
| 8 | 4 | 136 | 44 | 264 | 49 | 392 | 247 | 520 | 64 | 648 | 255 | 776 | 289 | 904 | 640 |
| 9 | 10 | 137 | 87 | 265 | 105 | 393 | 320 | 521 | 132 | 649 | 375 | 777 | 429 | 905 | 725 |
| 10 | 13 | 138 | 92 | 266 | 115 | 394 | 324 | 522 | 140 | 650 | 397 | 778 | 439 | 906 | 737 |
| 11 | 28 | 139 | 143 | 267 | 176 | 395 | 428 | 523 | 204 | 651 | 499 | 779 | 543 | 907 | 820 |
| 12 | 16 | 140 | 100 | 268 | 126 | 396 | 349 | 524 | 151 | 652 | 418 | 780 | 458 | 908 | 757 |
| 13 | 33 | 141 | 153 | 269 | 194 | 397 | 444 | 525 | 220 | 653 | 508 | 781 | 559 | 909 | 830 |
| 14 | 35 | 142 | 157 | 270 | 202 | 398 | 462 | 526 | 224 | 654 | 513 | 782 | 584 | 910 | 843 |
| 15 | 76 | 143 | 238 | 271 | 295 | 399 | 570 | 527 | 330 | 655 | 618 | 783 | 701 | 911 | 901 |
| 16 | 5 | 144 | 56 | 272 | 61 | 400 | 259 | 528 | 70 | 656 | 280 | 784 | 310 | 912 | 657 |
| 17 | 12 | 145 | 93 | 273 | 116 | 401 | 347 | 529 | 150 | 657 | 402 | 785 | 445 | 913 | 752 |
| 18 | 14 | 146 | 102 | 274 | 127 | 402 | 361 | 530 | 158 | 658 | 403 | 786 | 479 | 914 | 765 |
| 19 | 32 | 147 | 155 | 275 | 205 | 403 | 451 | 531 | 219 | 659 | 514 | 787 | 571 | 915 | 833 |
| 20 | 19 | 148 | 112 | 276 | 139 | 404 | 369 | 532 | 166 | 660 | 440 | 788 | 492 | 916 | 776 |
| 21 | 38 | 149 | 168 | 277 | 212 | 405 | 467 | 533 | 263 | 661 | 541 | 789 | 596 | 917 | 845 |

| | | | | | | | | | | | | | | | |
|---|---|---|---|---|---|---|---|---|---|---|---|---|---|---|---|
| 22 | 42 | 150 | 177 | 278 | 223 | 406 | 483 | 534 | 272 | 662 | 553 | 790 | 603 | 918 | 862 |
| 23 | 80 | 151 | 252 | 279 | 296 | 407 | 583 | 535 | 354 | 663 | 644 | 791 | 706 | 919 | 911 |
| 24 | 22 | 152 | 122 | 280 | 147 | 408 | 391 | 536 | 188 | 664 | 456 | 792 | 501 | 920 | 793 |
| 25 | 46 | 153 | 184 | 281 | 222 | 409 | 489 | 537 | 275 | 665 | 562 | 793 | 607 | 921 | 863 |
| 26 | 50 | 154 | 192 | 282 | 237 | 410 | 511 | 538 | 290 | 666 | 578 | 794 | 628 | 922 | 872 |
| 27 | 88 | 155 | 264 | 283 | 321 | 411 | 598 | 539 | 368 | 667 | 669 | 795 | 728 | 923 | 919 |
| 28 | 57 | 156 | 213 | 284 | 254 | 412 | 527 | 540 | 304 | 668 | 595 | 796 | 650 | 924 | 887 |
| 29 | 95 | 157 | 279 | 285 | 335 | 413 | 616 | 541 | 393 | 669 | 681 | 797 | 736 | 925 | 931 |
| 30 | 101 | 158 | 297 | 286 | 338 | 414 | 630 | 542 | 411 | 670 | 700 | 798 | 749 | 926 | 939 |
| 31 | 162 | 159 | 394 | 287 | 432 | 415 | 726 | 543 | 525 | 671 | 774 | 799 | 829 | 927 | 972 |
| 32 | 6 | 160 | 65 | 288 | 69 | 416 | 294 | 544 | 74 | 672 | 300 | 800 | 360 | 928 | 705 |
| 33 | 17 | 161 | 106 | 289 | 136 | 417 | 365 | 545 | 163 | 673 | 430 | 801 | 485 | 929 | 771 |
| 34 | 21 | 162 | 119 | 290 | 149 | 418 | 374 | 546 | 180 | 674 | 443 | 802 | 502 | 930 | 781 |
| 35 | 40 | 163 | 173 | 291 | 207 | 419 | 482 | 547 | 267 | 675 | 556 | 803 | 602 | 931 | 855 |
| 36 | 23 | 164 | 124 | 292 | 164 | 420 | 395 | 548 | 190 | 676 | 474 | 804 | 538 | 932 | 804 |
| 37 | 47 | 165 | 185 | 293 | 226 | 421 | 500 | 549 | 288 | 677 | 572 | 805 | 621 | 933 | 868 |
| 38 | 53 | 166 | 198 | 294 | 241 | 422 | 520 | 550 | 299 | 678 | 576 | 806 | 637 | 934 | 875 |
| 39 | 90 | 167 | 273 | 295 | 334 | 423 | 610 | 551 | 378 | 679 | 682 | 807 | 739 | 935 | 926 |
| 40 | 29 | 168 | 142 | 296 | 171 | 424 | 427 | 552 | 200 | 680 | 490 | 808 | 542 | 936 | 815 |
| 41 | 55 | 169 | 208 | 297 | 248 | 425 | 522 | 553 | 308 | 681 | 590 | 809 | 641 | 937 | 882 |
| 42 | 60 | 170 | 217 | 298 | 258 | 426 | 533 | 554 | 316 | 682 | 599 | 810 | 655 | 938 | 890 |
| 43 | 96 | 171 | 285 | 299 | 344 | 427 | 626 | 555 | 424 | 683 | 696 | 811 | 746 | 939 | 936 |
| 44 | 66 | 172 | 232 | 300 | 268 | 428 | 561 | 556 | 332 | 684 | 625 | 812 | 665 | 940 | 899 |
| 45 | 108 | 173 | 306 | 301 | 364 | 429 | 639 | 557 | 426 | 685 | 710 | 813 | 759 | 941 | 941 |
| 46 | 113 | 174 | 323 | 302 | 376 | 430 | 667 | 558 | 441 | 686 | 718 | 814 | 769 | 942 | 950 |
| 47 | 175 | 175 | 416 | 303 | 468 | 431 | 751 | 559 | 536 | 687 | 805 | 815 | 849 | 943 | 980 |
| 48 | 34 | 176 | 156 | 304 | 172 | 432 | 446 | 560 | 210 | 688 | 507 | 816 | 548 | 944 | 840 |
| 49 | 62 | 177 | 225 | 305 | 266 | 433 | 546 | 561 | 329 | 689 | 611 | 817 | 661 | 945 | 895 |
| 50 | 72 | 178 | 240 | 306 | 277 | 434 | 573 | 562 | 339 | 690 | 635 | 818 | 678 | 946 | 905 |
| 51 | 111 | 179 | 311 | 307 | 363 | 435 | 662 | 563 | 438 | 691 | 715 | 819 | 768 | 947 | 945 |
| 52 | 75 | 180 | 251 | 308 | 292 | 436 | 585 | 564 | 359 | 692 | 646 | 820 | 703 | 948 | 917 |
| 53 | 120 | 181 | 325 | 309 | 386 | 437 | 673 | 565 | 455 | 693 | 735 | 821 | 782 | 949 | 955 |
| 54 | 129 | 182 | 341 | 310 | 399 | 438 | 688 | 566 | 473 | 694 | 742 | 822 | 795 | 950 | 959 |
| 55 | 186 | 183 | 433 | 311 | 495 | 439 | 770 | 567 | 564 | 695 | 822 | 823 | 860 | 951 | 987 |
| 56 | 84 | 184 | 270 | 312 | 318 | 440 | 605 | 568 | 372 | 696 | 659 | 824 | 716 | 952 | 923 |
| 57 | 131 | 185 | 348 | 313 | 408 | 441 | 692 | 569 | 469 | 697 | 747 | 825 | 807 | 953 | 965 |
| 58 | 141 | 186 | 367 | 314 | 425 | 442 | 693 | 570 | 488 | 698 | 764 | 826 | 811 | 954 | 968 |
| 59 | 209 | 187 | 453 | 315 | 517 | 443 | 790 | 571 | 588 | 699 | 837 | 827 | 876 | 955 | 993 |

| 60 | 146 | 188 | 387 | 316 | 447 | 444 | 722 | 572 | 493 | 700 | 789 | 828 | 824 | 956 | 975 |
|----|-----|-----|-----|-----|-----|-----|-----|-----|-----|-----|-----|-----|-----|-----|-----|
| 61 | 218 | 189 | 470 | 317 | 531 | 445 | 801 | 573 | 600 | 701 | 854 | 829 | 889 | 957 | 996 |
| 62 | 236 | 190 | 506 | 318 | 555 | 446 | 813 | 574 | 608 | 702 | 861 | 830 | 900 | 958 | 998 |
| 63 | 333 | 191 | 622 | 319 | 666 | 447 | 880 | 575 | 745 | 703 | 925 | 831 | 944 | 959 | 1011 |
| 64 | 9 | 192 | 71 | 320 | 78 | 448 | 317 | 576 | 107 | 704 | 322 | 832 | 377 | 960 | 733 |
| 65 | 18 | 193 | 121 | 321 | 159 | 449 | 388 | 577 | 189 | 705 | 463 | 833 | 537 | 961 | 784 |
| 66 | 26 | 194 | 137 | 322 | 165 | 450 | 420 | 578 | 196 | 706 | 476 | 834 | 540 | 962 | 814 |
| 67 | 54 | 195 | 201 | 323 | 246 | 451 | 524 | 579 | 303 | 707 | 592 | 835 | 645 | 963 | 883 |
| 68 | 30 | 196 | 152 | 324 | 182 | 452 | 442 | 580 | 206 | 708 | 496 | 836 | 549 | 964 | 836 |
| 69 | 58 | 197 | 215 | 325 | 262 | 453 | 534 | 581 | 319 | 709 | 604 | 837 | 652 | 965 | 893 |
| 70 | 63 | 198 | 231 | 326 | 276 | 454 | 554 | 582 | 331 | 710 | 627 | 838 | 668 | 966 | 896 |
| 71 | 103 | 199 | 309 | 327 | 358 | 455 | 642 | 583 | 421 | 711 | 713 | 839 | 762 | 967 | 942 |
| 72 | 36 | 200 | 161 | 328 | 187 | 456 | 465 | 584 | 229 | 712 | 539 | 840 | 565 | 968 | 847 |
| 73 | 68 | 201 | 234 | 329 | 281 | 457 | 569 | 585 | 343 | 713 | 632 | 841 | 684 | 969 | 907 |
| 74 | 73 | 202 | 244 | 330 | 286 | 458 | 575 | 586 | 351 | 714 | 649 | 842 | 697 | 970 | 910 |
| 75 | 114 | 203 | 327 | 331 | 384 | 459 | 672 | 587 | 454 | 715 | 738 | 843 | 778 | 971 | 952 |
| 76 | 83 | 204 | 257 | 332 | 302 | 460 | 593 | 588 | 382 | 716 | 653 | 844 | 711 | 972 | 920 |
| 77 | 123 | 205 | 340 | 333 | 400 | 461 | 679 | 589 | 477 | 717 | 744 | 845 | 792 | 973 | 956 |
| 78 | 135 | 206 | 356 | 334 | 410 | 462 | 691 | 590 | 486 | 718 | 758 | 846 | 809 | 974 | 967 |
| 79 | 193 | 207 | 450 | 335 | 515 | 463 | 777 | 591 | 580 | 719 | 831 | 847 | 874 | 975 | 990 |
| 80 | 43 | 208 | 178 | 336 | 235 | 464 | 484 | 592 | 245 | 720 | 547 | 848 | 634 | 976 | 866 |
| 81 | 79 | 209 | 253 | 337 | 298 | 465 | 586 | 593 | 353 | 721 | 651 | 849 | 702 | 977 | 918 |
| 82 | 86 | 210 | 265 | 338 | 313 | 466 | 606 | 594 | 371 | 722 | 658 | 850 | 720 | 978 | 927 |
| 83 | 130 | 211 | 346 | 339 | 406 | 467 | 687 | 595 | 471 | 723 | 755 | 851 | 796 | 979 | 964 |
| 84 | 91 | 212 | 284 | 340 | 326 | 468 | 617 | 596 | 396 | 724 | 683 | 852 | 732 | 980 | 938 |
| 85 | 138 | 213 | 366 | 341 | 422 | 469 | 694 | 597 | 491 | 725 | 763 | 853 | 817 | 981 | 970 |
| 86 | 145 | 214 | 385 | 342 | 437 | 470 | 723 | 598 | 497 | 726 | 783 | 854 | 826 | 982 | 971 |
| 87 | 214 | 215 | 472 | 343 | 528 | 471 | 802 | 599 | 594 | 727 | 851 | 855 | 886 | 983 | 997 |
| 88 | 99 | 216 | 293 | 344 | 350 | 472 | 648 | 600 | 419 | 728 | 704 | 856 | 761 | 984 | 948 |
| 89 | 148 | 217 | 389 | 345 | 448 | 473 | 729 | 601 | 498 | 729 | 788 | 857 | 827 | 985 | 977 |
| 90 | 160 | 218 | 409 | 346 | 464 | 474 | 740 | 602 | 504 | 730 | 797 | 858 | 844 | 986 | 979 |
| 91 | 228 | 219 | 494 | 347 | 550 | 475 | 816 | 603 | 612 | 731 | 859 | 859 | 898 | 987 | 999 |
| 92 | 174 | 220 | 423 | 348 | 481 | 476 | 760 | 604 | 545 | 732 | 812 | 860 | 857 | 988 | 985 |
| 93 | 242 | 221 | 518 | 349 | 574 | 477 | 834 | 605 | 629 | 733 | 877 | 861 | 908 | 989 | 1004 |
| 94 | 256 | 222 | 529 | 350 | 591 | 478 | 846 | 606 | 656 | 734 | 888 | 862 | 915 | 990 | 1006 |
| 95 | 357 | 223 | 643 | 351 | 686 | 479 | 904 | 607 | 753 | 735 | 933 | 863 | 960 | 991 | 1016 |
| 96 | 51 | 224 | 197 | 352 | 260 | 480 | 516 | 608 | 261 | 736 | 563 | 864 | 654 | 992 | 881 |
| 97 | 89 | 225 | 274 | 353 | 328 | 481 | 619 | 609 | 383 | 737 | 689 | 865 | 734 | 993 | 934 |

| | | | | | | | | | | | | | | | |
|---|---|---|---|---|---|---|---|---|---|---|---|---|---|---|---|
| 98 | 97 | 226 | 287 | 354 | 345 | 482 | 638 | 610 | 404 | 738 | 698 | 866 | 748 | 994 | 937 |
| 99 | 144 | 227 | 370 | 355 | 431 | 483 | 724 | 611 | 503 | 739 | 775 | 867 | 818 | 995 | 973 |
| 100 | 109 | 228 | 312 | 356 | 362 | 484 | 663 | 612 | 415 | 740 | 719 | 868 | 767 | 996 | 951 |
| 101 | 154 | 229 | 392 | 357 | 452 | 485 | 727 | 613 | 519 | 741 | 791 | 869 | 839 | 997 | 978 |
| 102 | 169 | 230 | 412 | 358 | 466 | 486 | 756 | 614 | 526 | 742 | 800 | 870 | 848 | 998 | 982 |
| 103 | 239 | 231 | 510 | 359 | 568 | 487 | 821 | 615 | 624 | 743 | 871 | 871 | 902 | 999 | 1001 |
| 104 | 118 | 232 | 336 | 360 | 381 | 488 | 676 | 616 | 436 | 744 | 731 | 872 | 785 | 1000 | 957 |
| 105 | 170 | 233 | 413 | 361 | 475 | 489 | 754 | 617 | 544 | 745 | 810 | 873 | 853 | 1001 | 986 |
| 106 | 183 | 234 | 434 | 362 | 487 | 490 | 772 | 618 | 557 | 746 | 823 | 874 | 864 | 1002 | 988 |
| 107 | 250 | 235 | 523 | 363 | 579 | 491 | 841 | 619 | 647 | 747 | 884 | 875 | 912 | 1003 | 1005 |
| 108 | 195 | 236 | 459 | 364 | 512 | 492 | 786 | 620 | 582 | 748 | 838 | 876 | 873 | 1004 | 994 |
| 109 | 269 | 237 | 535 | 365 | 601 | 493 | 852 | 621 | 664 | 749 | 894 | 877 | 922 | 1005 | 1007 |
| 110 | 282 | 238 | 567 | 366 | 613 | 494 | 865 | 622 | 674 | 750 | 906 | 878 | 932 | 1006 | 1012 |
| 111 | 379 | 239 | 670 | 367 | 707 | 495 | 924 | 623 | 773 | 751 | 949 | 879 | 969 | 1007 | 1018 |
| 112 | 133 | 240 | 355 | 368 | 405 | 496 | 680 | 624 | 457 | 752 | 766 | 880 | 799 | 1008 | 962 |
| 113 | 191 | 241 | 449 | 369 | 505 | 497 | 780 | 625 | 566 | 753 | 825 | 881 | 869 | 1009 | 992 |
| 114 | 211 | 242 | 461 | 370 | 521 | 498 | 798 | 626 | 587 | 754 | 842 | 882 | 878 | 1010 | 995 |
| 115 | 271 | 243 | 552 | 371 | 609 | 499 | 858 | 627 | 675 | 755 | 897 | 883 | 928 | 1011 | 1009 |
| 116 | 216 | 244 | 478 | 372 | 532 | 500 | 808 | 628 | 614 | 756 | 856 | 884 | 891 | 1012 | 1000 |
| 117 | 283 | 245 | 577 | 373 | 623 | 501 | 870 | 629 | 685 | 757 | 909 | 885 | 935 | 1013 | 1010 |
| 118 | 301 | 246 | 589 | 374 | 633 | 502 | 879 | 630 | 709 | 758 | 913 | 886 | 943 | 1014 | 1013 |
| 119 | 401 | 247 | 690 | 375 | 721 | 503 | 930 | 631 | 787 | 759 | 961 | 887 | 976 | 1015 | 1019 |
| 120 | 233 | 248 | 509 | 376 | 560 | 504 | 828 | 632 | 636 | 760 | 867 | 888 | 903 | 1016 | 1002 |
| 121 | 307 | 249 | 597 | 377 | 660 | 505 | 885 | 633 | 712 | 761 | 921 | 889 | 947 | 1017 | 1014 |
| 122 | 315 | 250 | 615 | 378 | 671 | 506 | 892 | 634 | 730 | 762 | 929 | 890 | 953 | 1018 | 1015 |
| 123 | 417 | 251 | 695 | 379 | 750 | 507 | 946 | 635 | 803 | 763 | 966 | 891 | 981 | 1019 | 1020 |
| 124 | 337 | 252 | 631 | 380 | 677 | 508 | 914 | 636 | 741 | 764 | 940 | 892 | 958 | 1020 | 1017 |
| 125 | 435 | 253 | 714 | 381 | 779 | 509 | 954 | 637 | 819 | 765 | 974 | 893 | 989 | 1021 | 1021 |
| 126 | 460 | 254 | 743 | 382 | 794 | 510 | 963 | 638 | 832 | 766 | 983 | 894 | 991 | 1022 | 1022 |
| 127 | 581 | 255 | 835 | 383 | 850 | 511 | 984 | 639 | 916 | 767 | 1003 | 895 | 1008 | 1023 | 1023 |

Sequence Z17, having a sequence length of 512:

[0, 1, 2, 7, 3, 8, 11, 24, 4, 10, 13, 27, 16, 32, 34, 69, 5, 12, 14, 31, 19, 37, 41, 73, 22, 44, 48, 81, 54, 88, 93, 144, 6, 17, 21, 39, 23, 45, 50, 83, 28, 52, 56, 89, 61, 99, 103, 155, 33, 58, 66, 101, 68, 109, 116, 165, 77, 118, 126, 179, 131, 187, 199, 269, 9, 18, 26, 51, 29, 55, 59, 95, 35, 63, 67, 104, 76, 112, 121, 169, 42, 72, 79, 117, 84, 124, 130, 183, 91, 133, 142, 193, 154, 205, 215, 286, 49, 82, 90, 129, 100, 137, 149, 202, 107, 150, 162, 210, 171, 225, 234, 299, 119, 167, 180, 227, 185, 235, 248, 313, 196, 252, 258, 323, 273, 334, 347, 407, 15, 25, 30, 62, 38, 70, 74, 120, 43, 80, 85, 128, 92, 136, 140, 201, 53, 86, 94, 138, 102, 148, 157, 212, 111, 163, 168, 221, 182, 232, 246, 309, 60, 98, 108, 153, 113, 164, 173, 228, 127, 178, 186, 237, 195, 251, 263, 322, 139, 190, 203, 254, 211, 265, 276, 332, 226, 281, 294, 345, 304, 355, 369, 426, 65, 110, 123, 174, 135, 184, 194, 253, 143, 197, 206, 267, 216, 275, 285, 342, 158, 213, 222, 279, 236, 293, 302, 356, 242, 306, 318, 365, 326, 377, 385, 435, 172, 229, 239, 296, 255, 308, 320, 371, 272, 321, 333, 381, 346, 390, 398, 442, 284, 341, 348, 393, 358, 405, 411, 453, 370, 414, 422, 458, 430, 460, 469, 492, 20, 36, 40, 78, 46, 87, 96, 147, 47, 97, 105, 156, 114, 170, 175, 244, 57, 106, 115, 176, 125, 181, 189, 245, 132, 188, 200, 262, 214, 271, 274, 331, 64, 122, 134, 177, 145, 191, 204, 270, 151, 209, 217, 277, 224, 291, 298, 354, 152, 223, 231, 290, 241, 303, 311, 366, 260, 317, 327, 376, 339, 386, 395, 440, 71, 141, 146, 207, 161, 220, 230, 287, 166, 233, 238, 301, 249, 312, 319, 374, 198, 247, 256, 315, 266, 325, 335, 384, 283, 340, 350, 392, 359, 403, 412, 450, 219, 268, 278, 330, 289, 344, 352, 399, 300, 357, 363, 406, 373, 416, 421, 459, 314, 368, 379, 419, 387, 427, 431, 461, 396, 437, 443, 470, 447, 478, 482, 495, 75, 159, 160, 240, 192, 250, 257, 316, 208, 261, 264, 329, 282, 337, 349, 401, 218, 280, 288, 343, 295, 353, 361, 408, 307, 364, 372, 415, 383, 423, 429, 465, 243, 292, 297, 360, 310, 367, 378, 420, 328, 380, 388, 428, 397, 433, 441, 471, 338, 391, 402, 438, 409, 445, 452, 475, 417, 455, 456, 481, 462, 484, 487, 501, 259, 305, 324, 382, 336, 389, 394, 434, 351, 400, 404, 444, 413, 448, 454, 477, 362, 410, 418, 451, 424, 457, 463, 485, 436, 467, 468, 488, 474, 491, 494, 504, 375, 425, 432, 464, 439, 466, 473, 489, 446, 472, 476, 493, 480, 496, 498, 506, 449, 479, 483, 497, 486, 499, 500, 507, 490, 502, 503, 508, 505, 509, 510, 511]

## Table Z17, having a sequence length of 512:

| Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability |
|---|---|---|---|---|---|---|---|---|---|---|---|---|---|---|---|
| 0 | 0 | 64 | 9 | 128 | 15 | 192 | 65 | 256 | 20 | 320 | 71 | 384 | 75 | 448 | 259 |
| 1 | 1 | 65 | 18 | 129 | 25 | 193 | 110 | 257 | 36 | 321 | 141 | 385 | 159 | 449 | 305 |
| 2 | 2 | 66 | 26 | 130 | 30 | 194 | 123 | 258 | 40 | 322 | 146 | 386 | 160 | 450 | 324 |
| 3 | 7 | 67 | 51 | 131 | 62 | 195 | 174 | 259 | 78 | 323 | 207 | 387 | 240 | 451 | 382 |
| 4 | 3 | 68 | 29 | 132 | 38 | 196 | 135 | 260 | 46 | 324 | 161 | 388 | 192 | 452 | 336 |
| 5 | 8 | 69 | 55 | 133 | 70 | 197 | 184 | 261 | 87 | 325 | 220 | 389 | 250 | 453 | 389 |
| 6 | 11 | 70 | 59 | 134 | 74 | 198 | 194 | 262 | 96 | 326 | 230 | 390 | 257 | 454 | 394 |
| 7 | 24 | 71 | 95 | 135 | 120 | 199 | 253 | 263 | 147 | 327 | 287 | 391 | 316 | 455 | 434 |
| 8 | 4 | 72 | 35 | 136 | 43 | 200 | 143 | 264 | 47 | 328 | 166 | 392 | 208 | 456 | 351 |

| | | | | | | | | | | | | | | | |
|---|---|---|---|---|---|---|---|---|---|---|---|---|---|---|---|
| 9 | 10 | 73 | 63 | 137 | 80 | 201 | 197 | 265 | 97 | 329 | 233 | 393 | 261 | 457 | 400 |
| 10 | 13 | 74 | 67 | 138 | 85 | 202 | 206 | 266 | 105 | 330 | 238 | 394 | 264 | 458 | 404 |
| 11 | 27 | 75 | 104 | 139 | 128 | 203 | 267 | 267 | 156 | 331 | 301 | 395 | 329 | 459 | 444 |
| 12 | 16 | 76 | 76 | 140 | 92 | 204 | 216 | 268 | 114 | 332 | 249 | 396 | 282 | 460 | 413 |
| 13 | 32 | 77 | 112 | 141 | 136 | 205 | 275 | 269 | 170 | 333 | 312 | 397 | 337 | 461 | 448 |
| 14 | 34 | 78 | 121 | 142 | 140 | 206 | 285 | 270 | 175 | 334 | 319 | 398 | 349 | 462 | 454 |
| 15 | 69 | 79 | 169 | 143 | 201 | 207 | 342 | 271 | 244 | 335 | 374 | 399 | 401 | 463 | 477 |
| 16 | 5 | 80 | 42 | 144 | 53 | 208 | 158 | 272 | 57 | 336 | 198 | 400 | 218 | 464 | 362 |
| 17 | 12 | 81 | 72 | 145 | 86 | 209 | 213 | 273 | 106 | 337 | 247 | 401 | 280 | 465 | 410 |
| 18 | 14 | 82 | 79 | 146 | 94 | 210 | 222 | 274 | 115 | 338 | 256 | 402 | 288 | 466 | 418 |
| 19 | 31 | 83 | 117 | 147 | 138 | 211 | 279 | 275 | 176 | 339 | 315 | 403 | 343 | 467 | 451 |
| 20 | 19 | 84 | 84 | 148 | 102 | 212 | 236 | 276 | 125 | 340 | 266 | 404 | 295 | 468 | 424 |
| 21 | 37 | 85 | 124 | 149 | 148 | 213 | 293 | 277 | 181 | 341 | 325 | 405 | 353 | 469 | 457 |
| 22 | 41 | 86 | 130 | 150 | 157 | 214 | 302 | 278 | 189 | 342 | 335 | 406 | 361 | 470 | 463 |
| 23 | 73 | 87 | 183 | 151 | 212 | 215 | 356 | 279 | 245 | 343 | 384 | 407 | 408 | 471 | 485 |
| 24 | 22 | 88 | 91 | 152 | 111 | 216 | 242 | 280 | 132 | 344 | 283 | 408 | 307 | 472 | 436 |
| 25 | 44 | 89 | 133 | 153 | 163 | 217 | 306 | 281 | 188 | 345 | 340 | 409 | 364 | 473 | 467 |
| 26 | 48 | 90 | 142 | 154 | 168 | 218 | 318 | 282 | 200 | 346 | 350 | 410 | 372 | 474 | 468 |
| 27 | 81 | 91 | 193 | 155 | 221 | 219 | 365 | 283 | 262 | 347 | 392 | 411 | 415 | 475 | 488 |
| 28 | 54 | 92 | 154 | 156 | 182 | 220 | 326 | 284 | 214 | 348 | 359 | 412 | 383 | 476 | 474 |
| 29 | 88 | 93 | 205 | 157 | 232 | 221 | 377 | 285 | 271 | 349 | 403 | 413 | 423 | 477 | 491 |
| 30 | 93 | 94 | 215 | 158 | 246 | 222 | 385 | 286 | 274 | 350 | 412 | 414 | 429 | 478 | 494 |
| 31 | 144 | 95 | 286 | 159 | 309 | 223 | 435 | 287 | 331 | 351 | 450 | 415 | 465 | 479 | 504 |
| 32 | 6 | 96 | 49 | 160 | 60 | 224 | 172 | 288 | 64 | 352 | 219 | 416 | 243 | 480 | 375 |
| 33 | 17 | 97 | 82 | 161 | 98 | 225 | 229 | 289 | 122 | 353 | 268 | 417 | 292 | 481 | 425 |
| 34 | 21 | 98 | 90 | 162 | 108 | 226 | 239 | 290 | 134 | 354 | 278 | 418 | 297 | 482 | 432 |
| 35 | 39 | 99 | 129 | 163 | 153 | 227 | 296 | 291 | 177 | 355 | 330 | 419 | 360 | 483 | 464 |
| 36 | 23 | 100 | 100 | 164 | 113 | 228 | 255 | 292 | 145 | 356 | 289 | 420 | 310 | 484 | 439 |
| 37 | 45 | 101 | 137 | 165 | 164 | 229 | 308 | 293 | 191 | 357 | 344 | 421 | 367 | 485 | 466 |
| 38 | 50 | 102 | 149 | 166 | 173 | 230 | 320 | 294 | 204 | 358 | 352 | 422 | 378 | 486 | 473 |
| 39 | 83 | 103 | 202 | 167 | 228 | 231 | 371 | 295 | 270 | 359 | 399 | 423 | 420 | 487 | 489 |
| 40 | 28 | 104 | 107 | 168 | 127 | 232 | 272 | 296 | 151 | 360 | 300 | 424 | 328 | 488 | 446 |
| 41 | 52 | 105 | 150 | 169 | 178 | 233 | 321 | 297 | 209 | 361 | 357 | 425 | 380 | 489 | 472 |
| 42 | 56 | 106 | 162 | 170 | 186 | 234 | 333 | 298 | 217 | 362 | 363 | 426 | 388 | 490 | 476 |
| 43 | 89 | 107 | 210 | 171 | 237 | 235 | 381 | 299 | 277 | 363 | 406 | 427 | 428 | 491 | 493 |
| 44 | 61 | 108 | 171 | 172 | 195 | 236 | 346 | 300 | 224 | 364 | 373 | 428 | 397 | 492 | 480 |
| 45 | 99 | 109 | 225 | 173 | 251 | 237 | 390 | 301 | 291 | 365 | 416 | 429 | 433 | 493 | 496 |
| 46 | 103 | 110 | 234 | 174 | 263 | 238 | 398 | 302 | 298 | 366 | 421 | 430 | 441 | 494 | 498 |

| | | | | | | | | | | | | | | | |
|---|---|---|---|---|---|---|---|---|---|---|---|---|---|---|---|
| 47 | 155 | 111 | 299 | 175 | 322 | 239 | 442 | 303 | 354 | 367 | 459 | 431 | 471 | 495 | 506 |
| 48 | 33 | 112 | 119 | 176 | 139 | 240 | 284 | 304 | 152 | 368 | 314 | 432 | 338 | 496 | 449 |
| 49 | 58 | 113 | 167 | 177 | 190 | 241 | 341 | 305 | 223 | 369 | 368 | 433 | 391 | 497 | 479 |
| 50 | 66 | 114 | 180 | 178 | 203 | 242 | 348 | 306 | 231 | 370 | 379 | 434 | 402 | 498 | 483 |
| 51 | 101 | 115 | 227 | 179 | 254 | 243 | 393 | 307 | 290 | 371 | 419 | 435 | 438 | 499 | 497 |
| 52 | 68 | 116 | 185 | 180 | 211 | 244 | 358 | 308 | 241 | 372 | 387 | 436 | 409 | 500 | 486 |
| 53 | 109 | 117 | 235 | 181 | 265 | 245 | 405 | 309 | 303 | 373 | 427 | 437 | 445 | 501 | 499 |
| 54 | 116 | 118 | 248 | 182 | 276 | 246 | 411 | 310 | 311 | 374 | 431 | 438 | 452 | 502 | 500 |
| 55 | 165 | 119 | 313 | 183 | 332 | 247 | 453 | 311 | 366 | 375 | 461 | 439 | 475 | 503 | 507 |
| 56 | 77 | 120 | 196 | 184 | 226 | 248 | 370 | 312 | 260 | 376 | 396 | 440 | 417 | 504 | 490 |
| 57 | 118 | 121 | 252 | 185 | 281 | 249 | 414 | 313 | 317 | 377 | 437 | 441 | 455 | 505 | 502 |
| 58 | 126 | 122 | 258 | 186 | 294 | 250 | 422 | 314 | 327 | 378 | 443 | 442 | 456 | 506 | 503 |
| 59 | 179 | 123 | 323 | 187 | 345 | 251 | 458 | 315 | 376 | 379 | 470 | 443 | 481 | 507 | 508 |
| 60 | 131 | 124 | 273 | 188 | 304 | 252 | 430 | 316 | 339 | 380 | 447 | 444 | 462 | 508 | 505 |
| 61 | 187 | 125 | 334 | 189 | 355 | 253 | 460 | 317 | 386 | 381 | 478 | 445 | 484 | 509 | 509 |
| 62 | 199 | 126 | 347 | 190 | 369 | 254 | 469 | 318 | 395 | 382 | 482 | 446 | 487 | 510 | 510 |
| 63 | 269 | 127 | 407 | 191 | 426 | 255 | 492 | 319 | 440 | 383 | 495 | 447 | 501 | 511 | 511 |

Sequence Z18, having a sequence length of 256:

[0, 1, 2, 7, 3, 8, 11, 23, 4, 10, 13, 26, 16, 31, 33, 62, 5, 12, 14, 30, 19, 35, 38, 65, 21, 41, 43, 71, 49, 77, 82, 122, 6, 17, 20, 37, 22, 42, 45, 73, 27, 47, 51, 78, 55, 86, 90, 128, 32, 52, 59, 88, 61, 94, 99, 134, 68, 101, 107, 143, 112, 150, 157, 194, 9, 18, 25, 46, 28, 50, 53, 84, 34, 57, 60, 91, 67, 97, 104, 137, 39, 64, 69, 100, 74, 106, 111, 146, 80, 113, 120, 152, 127, 161, 167, 203, 44, 72, 79, 110, 87, 116, 124, 159, 92, 125, 131, 163, 138, 171, 177, 207, 102, 135, 144, 173, 148, 178, 184, 213, 155, 186, 190, 218, 196, 222, 227, 243, 15, 24, 29, 56, 36, 63, 66, 103, 40, 70, 75, 109, 81, 115, 119, 158, 48, 76, 83, 117, 89, 123, 129, 165, 96, 132, 136, 169, 145, 176, 183, 212, 54, 85, 93, 126, 98, 133, 140, 174, 108, 142, 149, 180, 154, 185, 191, 217, 118, 151, 160, 188, 164, 192, 198, 220, 172, 200, 205, 225, 209, 229, 233, 247, 58, 95, 105, 141, 114, 147, 153, 187, 121, 156, 162, 193, 168, 197, 202, 224, 130, 166, 170, 199, 179, 204, 208, 230, 182, 210, 214, 232, 219, 236, 238, 249, 139, 175, 181, 206, 189, 211, 215, 235, 195, 216, 221, 237, 226, 239, 241, 250, 201, 223, 228, 240, 231, 242, 244, 251, 234, 245, 246, 252, 248, 253, 254, 255]

Table Z18, having a sequence length of 256:

| Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability |
|---|---|---|---|---|---|---|---|---|---|---|---|---|---|---|---|
| 0 | 0 | 32 | 6 | 64 | 9 | 96 | 44 | 128 | 15 | 160 | 54 | 192 | 58 | 224 | 139 |
| 1 | 1 | 33 | 17 | 65 | 18 | 97 | 72 | 129 | 24 | 161 | 85 | 193 | 95 | 225 | 175 |
| 2 | 2 | 34 | 20 | 66 | 25 | 98 | 79 | 130 | 29 | 162 | 93 | 194 | 105 | 226 | 181 |
| 3 | 7 | 35 | 37 | 67 | 46 | 99 | 110 | 131 | 56 | 163 | 126 | 195 | 141 | 227 | 206 |
| 4 | 3 | 36 | 22 | 68 | 28 | 100 | 87 | 132 | 36 | 164 | 98 | 196 | 114 | 228 | 189 |
| 5 | 8 | 37 | 42 | 69 | 50 | 101 | 116 | 133 | 63 | 165 | 133 | 197 | 147 | 229 | 211 |
| 6 | 11 | 38 | 45 | 70 | 53 | 102 | 124 | 134 | 66 | 166 | 140 | 198 | 153 | 230 | 215 |
| 7 | 23 | 39 | 73 | 71 | 84 | 103 | 159 | 135 | 103 | 167 | 174 | 199 | 187 | 231 | 235 |
| 8 | 4 | 40 | 27 | 72 | 34 | 104 | 92 | 136 | 40 | 168 | 108 | 200 | 121 | 232 | 195 |
| 9 | 10 | 41 | 47 | 73 | 57 | 105 | 125 | 137 | 70 | 169 | 142 | 201 | 156 | 233 | 216 |
| 10 | 13 | 42 | 51 | 74 | 60 | 106 | 131 | 138 | 75 | 170 | 149 | 202 | 162 | 234 | 221 |
| 11 | 26 | 43 | 78 | 75 | 91 | 107 | 163 | 139 | 109 | 171 | 180 | 203 | 193 | 235 | 237 |
| 12 | 16 | 44 | 55 | 76 | 67 | 108 | 138 | 140 | 81 | 172 | 154 | 204 | 168 | 236 | 226 |
| 13 | 31 | 45 | 86 | 77 | 97 | 109 | 171 | 141 | 115 | 173 | 185 | 205 | 197 | 237 | 239 |
| 14 | 33 | 46 | 90 | 78 | 104 | 110 | 177 | 142 | 119 | 174 | 191 | 206 | 202 | 238 | 241 |
| 15 | 62 | 47 | 128 | 79 | 137 | 111 | 207 | 143 | 158 | 175 | 217 | 207 | 224 | 239 | 250 |
| 16 | 5 | 48 | 32 | 80 | 39 | 112 | 102 | 144 | 48 | 176 | 118 | 208 | 130 | 240 | 201 |
| 17 | 12 | 49 | 52 | 81 | 64 | 113 | 135 | 145 | 76 | 177 | 151 | 209 | 166 | 241 | 223 |
| 18 | 14 | 50 | 59 | 82 | 69 | 114 | 144 | 146 | 83 | 178 | 160 | 210 | 170 | 242 | 228 |
| 19 | 30 | 51 | 88 | 83 | 100 | 115 | 173 | 147 | 117 | 179 | 188 | 211 | 199 | 243 | 240 |
| 20 | 19 | 52 | 61 | 84 | 74 | 116 | 148 | 148 | 89 | 180 | 164 | 212 | 179 | 244 | 231 |
| 21 | 35 | 53 | 94 | 85 | 106 | 117 | 178 | 149 | 123 | 181 | 192 | 213 | 204 | 245 | 242 |
| 22 | 38 | 54 | 99 | 86 | 111 | 118 | 184 | 150 | 129 | 182 | 198 | 214 | 208 | 246 | 244 |
| 23 | 65 | 55 | 134 | 87 | 146 | 119 | 213 | 151 | 165 | 183 | 220 | 215 | 230 | 247 | 251 |
| 24 | 21 | 56 | 68 | 88 | 80 | 120 | 155 | 152 | 96 | 184 | 172 | 216 | 182 | 248 | 234 |
| 25 | 41 | 57 | 101 | 89 | 113 | 121 | 186 | 153 | 132 | 185 | 200 | 217 | 210 | 249 | 245 |
| 26 | 43 | 58 | 107 | 90 | 120 | 122 | 190 | 154 | 136 | 186 | 205 | 218 | 214 | 250 | 246 |
| 27 | 71 | 59 | 143 | 91 | 152 | 123 | 218 | 155 | 169 | 187 | 225 | 219 | 232 | 251 | 252 |
| 28 | 49 | 60 | 112 | 92 | 127 | 124 | 196 | 156 | 145 | 188 | 209 | 220 | 219 | 252 | 248 |
| 29 | 77 | 61 | 150 | 93 | 161 | 125 | 222 | 157 | 176 | 189 | 229 | 221 | 236 | 253 | 253 |
| 30 | 82 | 62 | 157 | 94 | 167 | 126 | 227 | 158 | 183 | 190 | 233 | 222 | 238 | 254 | 254 |
| 31 | 122 | 63 | 194 | 95 | 203 | 127 | 243 | 159 | 212 | 191 | 247 | 223 | 249 | 255 | 255 |

Sequence Z19, having a sequence length of 128:
[0, 1, 2, 7, 3, 8, 11, 22, 4, 10, 13, 24, 15, 28, 30, 53, 5, 12, 14, 27, 18, 32, 34, 55, 20, 36, 38, 59, 43, 63, 67, 90, 6, 16, 19, 33, 21, 37, 40, 61, 25, 42, 45, 64, 48, 69, 72, 94, 29, 46, 50, 71, 52, 75, 77, 96, 57, 79, 83, 100, 86, 104, 107, 119, 9, 17, 23, 41, 26, 44, 47, 68, 31, 49, 51, 73, 56, 76, 81, 98, 35, 54, 58, 78, 62, 82, 85, 102, 66, 87, 89, 105, 93, 109, 111, 121, 39, 60, 65, 84, 70, 88, 91, 108, 74, 92, 95, 110, 99, 112, 114, 122, 80, 97, 101, 113, 103, 115, 116, 123, 106, 117, 118, 124, 120, 125, 126, 127]

Table Z19, having a sequence length of 128:

| Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability |
|---|---|---|---|---|---|---|---|---|---|---|---|---|---|---|---|
| 0 | 0 | 16 | 5 | 32 | 6 | 48 | 29 | 64 | 9 | 80 | 35 | 96 | 39 | 112 | 80 |
| 1 | 1 | 17 | 12 | 33 | 16 | 49 | 46 | 65 | 17 | 81 | 54 | 97 | 60 | 113 | 97 |
| 2 | 2 | 18 | 14 | 34 | 19 | 50 | 50 | 66 | 23 | 82 | 58 | 98 | 65 | 114 | 101 |
| 3 | 7 | 19 | 27 | 35 | 33 | 51 | 71 | 67 | 41 | 83 | 78 | 99 | 84 | 115 | 113 |
| 4 | 3 | 20 | 18 | 36 | 21 | 52 | 52 | 68 | 26 | 84 | 62 | 100 | 70 | 116 | 103 |
| 5 | 8 | 21 | 32 | 37 | 37 | 53 | 75 | 69 | 44 | 85 | 82 | 101 | 88 | 117 | 115 |
| 6 | 11 | 22 | 34 | 38 | 40 | 54 | 77 | 70 | 47 | 86 | 85 | 102 | 91 | 118 | 116 |
| 7 | 22 | 23 | 55 | 39 | 61 | 55 | 96 | 71 | 68 | 87 | 102 | 103 | 108 | 119 | 123 |
| 8 | 4 | 24 | 20 | 40 | 25 | 56 | 57 | 72 | 31 | 88 | 66 | 104 | 74 | 120 | 106 |
| 9 | 10 | 25 | 36 | 41 | 42 | 57 | 79 | 73 | 49 | 89 | 87 | 105 | 92 | 121 | 117 |
| 10 | 13 | 26 | 38 | 42 | 45 | 58 | 83 | 74 | 51 | 90 | 89 | 106 | 95 | 122 | 118 |
| 11 | 24 | 27 | 59 | 43 | 64 | 59 | 100 | 75 | 73 | 91 | 105 | 107 | 110 | 123 | 124 |
| 12 | 15 | 28 | 43 | 44 | 48 | 60 | 86 | 76 | 56 | 92 | 93 | 108 | 99 | 124 | 120 |
| 13 | 28 | 29 | 63 | 45 | 69 | 61 | 104 | 77 | 76 | 93 | 109 | 109 | 112 | 125 | 125 |
| 14 | 30 | 30 | 67 | 46 | 72 | 62 | 107 | 78 | 81 | 94 | 111 | 110 | 114 | 126 | 126 |
| 15 | 53 | 31 | 90 | 47 | 94 | 63 | 119 | 79 | 98 | 95 | 121 | 111 | 122 | 127 | 127 |

Sequence Z20, having a sequence length of 64:
[0, 1, 2, 7, 3, 8, 10, 20, 4, 9, 12, 21, 14, 24, 26, 41, 5, 11, 13, 23, 16, 27, 29, 42, 18, 30, 32, 44, 35, 46, 48, 57, 6, 15, 17, 28, 19, 31, 33, 45, 22, 34, 36, 47, 38, 49, 51, 58, 25, 37, 39, 50, 40, 52, 53, 59, 43, 54, 55, 60, 56, 61, 62, 63]

Table Z20, having a sequence length of 64:

| Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability |
|---|---|---|---|---|---|---|---|---|---|---|---|---|---|---|---|
| 0 | 0 | 8 | 4 | 16 | 5 | 24 | 18 | 32 | 6 | 40 | 22 | 48 | 25 | 56 | 43 |
| 1 | 1 | 9 | 9 | 17 | 11 | 25 | 30 | 33 | 15 | 41 | 34 | 49 | 37 | 57 | 54 |
| 2 | 2 | 10 | 12 | 18 | 13 | 26 | 32 | 34 | 17 | 42 | 36 | 50 | 39 | 58 | 55 |
| 3 | 7 | 11 | 21 | 19 | 23 | 27 | 44 | 35 | 28 | 43 | 47 | 51 | 50 | 59 | 60 |
| 4 | 3 | 12 | 14 | 20 | 16 | 28 | 35 | 36 | 19 | 44 | 38 | 52 | 40 | 60 | 56 |
| 5 | 8 | 13 | 24 | 21 | 27 | 29 | 46 | 37 | 31 | 45 | 49 | 53 | 52 | 61 | 61 |
| 6 | 10 | 14 | 26 | 22 | 29 | 30 | 48 | 38 | 33 | 46 | 51 | 54 | 53 | 62 | 62 |
| 7 | 20 | 15 | 41 | 23 | 42 | 31 | 57 | 39 | 45 | 47 | 58 | 55 | 59 | 63 | 63 |

Fifth group of sequences (a criterion that preferentially considers a minimum code distance).

Sequence Q21, having a sequence length of 1024:

[0, 1, 2, 4, 8, 16, 32, 3, 5, 64, 6, 9, 17, 10, 18, 128, 12, 33, 256, 20, 34, 24, 65, 36, 7, 129, 66, 512, 11, 40, 68, 19, 13, 130, 48, 14, 72, 257, 21, 132, 35, 258, 26, 513, 80, 37, 25, 22, 136, 96, 260, 38, 514, 264, 67, 41, 144, 28, 69, 42, 516, 49, 160,272, 70, 520, 288, 528, 131, 44, 544, 73, 192, 50, 74, 52, 15, 133, 320, 81, 23, 134, 76, 137, 82, 384, 56, 27, 97, 39, 259, 84, 138, 145, 261, 29, 43, 98, 515, 88, 140, 30, 146, 71, 262, 265, 517, 161, 45, 576, 518, 100, 51, 148, 521, 46, 75, 640, 266, 273, 522, 104, 162, 53, 193, 152, 77, 164, 268, 274, 54, 83, 530, 57, 112, 529, 524, 135, 78, 289, 194, 85, 276, 58, 168, 139, 99, 86, 60, 89, 768, 196, 290, 141, 101, 280, 545, 546, 532, 147, 176, 142, 90, 536, 292, 200, 263, 31, 149, 321, 322, 577, 102, 105, 296, 163, 92, 47, 150, 548, 208, 324, 385, 304, 267, 578, 106, 153, 386, 165, 55, 328, 113, 519, 552, 641, 154, 79, 108, 224, 269, 166, 523, 560, 580, 195, 277, 169, 275, 291, 59, 270, 114, 156, 87, 197, 116, 170, 61, 525, 531, 177, 278, 281, 526, 642, 293, 388, 91, 584, 769, 198, 172, 120, 201, 62, 143, 336, 282, 103, 178, 294, 93, 533, 644, 534, 547, 770, 392, 297, 592, 323, 202, 284, 151, 209, 180, 107, 325, 94, 537, 400, 298, 204, 352, 305, 155, 300, 210, 608, 648, 109, 184, 115, 167, 225, 326, 157, 110, 772, 549, 656, 538, 117, 212, 330, 171, 550, 329, 306, 226, 387, 308, 271, 579, 416, 216, 337, 158, 776, 118, 540, 553, 279, 332, 389, 173, 121, 199, 179, 228, 283, 122, 393, 174, 312, 672, 390, 554, 556, 203, 561, 181, 295, 448, 353, 338, 63, 581, 340, 285, 394, 232, 124, 354, 582, 784, 704, 527, 286, 182, 562, 643, 585, 205, 299, 211, 401, 185, 396, 240, 586, 645, 593, 535, 301, 402, 344, 206, 564, 800, 327, 356, 307, 95, 417, 213, 186, 404, 111, 539, 568, 594, 649, 771, 302, 832, 588, 646, 227, 360, 214, 188, 551, 609, 896, 331, 309, 418, 449, 217, 408, 229, 541, 159, 420, 596, 650, 773, 310, 333, 119, 368, 339, 391, 657, 313, 218, 542, 610, 334, 230, 233, 774, 658, 612, 175, 123, 450, 652, 341, 220, 557, 314, 555, 600, 583, 424, 395, 777, 673, 355, 287, 183, 234, 125, 342, 563, 674, 616, 558, 660, 778, 452, 397, 432, 316, 345, 241, 207, 785, 403, 357, 187, 587, 565, 664, 624, 780, 236, 126, 242, 398, 705, 346, 456, 358, 405, 303, 569, 595, 189, 786, 215, 676, 589, 566, 647, 361, 706, 244, 348, 419, 406, 311, 708, 219, 598, 601, 651, 611, 409, 680, 788, 362, 570, 597, 572, 464, 801, 590, 421, 802, 369, 792, 190, 602, 653, 248, 688, 231, 410, 364, 335, 422, 613, 659, 654, 315, 221, 370, 425, 235, 451, 480, 775, 412, 614, 343, 222, 317, 372, 543, 426, 453, 237, 559, 833, 804, 712, 834, 661, 808, 779, 617, 604, 433, 720, 816, 836, 347, 897, 243, 662, 454, 318, 675, 376, 428, 625, 238, 359, 567, 618, 665, 736, 898, 457, 399, 781, 591, 666, 678, 349, 434, 677, 840, 782, 626, 571, 620, 787, 363, 245, 458, 127, 407, 436, 465, 350, 246, 681, 460, 249, 599, 411, 365, 668, 707, 573, 789, 803, 790, 682, 440, 709, 466, 628, 371, 423, 366, 250, 413, 574, 468, 603, 481, 689, 793, 191, 373, 655, 900, 805, 427, 615, 710, 414, 252, 848, 684, 713, 605, 690, 632, 482, 794, 806, 472, 223, 663, 835, 904, 809, 714, 619, 796, 374, 429, 455, 692, 721, 837, 716, 864, 810, 606, 912, 722, 696, 377, 817, 435, 812, 484, 319, 430, 621, 838, 667, 239, 378, 459, 437, 627, 622, 488, 380, 461, 679, 841, 818, 724, 669, 496, 629, 928, 737, 899, 783, 738, 901, 842, 438, 467, 247, 820, 849, 683, 351, 791, 441, 728, 670, 462, 469, 442, 251, 367, 630, 740, 902, 711, 844, 850, 905, 685, 691, 824, 633, 483, 795, 744, 470, 852, 686, 444, 473, 253, 634, 485, 415, 375, 960, 865, 575, 807, 906, 715, 913, 693, 797, 866, 811, 717, 474, 254, 694, 723, 636, 486, 798, 607, 697, 489, 431, 379, 908, 752, 914, 856, 868, 839, 929, 813, 718, 819, 476, 916, 725, 698, 490, 739, 814, 843, 623, 497, 439, 381, 671, 463, 726, 930, 872, 821, 920, 700, 729, 492, 932, 961, 741, 903, 845, 498, 880, 382, 822, 851, 631, 443, 825, 730, 471, 445, 687, 635, 742, 846, 500, 745, 826, 732, 446, 962, 936, 255, 853, 504, 637, 907, 475, 746, 867, 487, 695, 799, 854, 828, 753, 857, 964, 909, 719, 477, 915, 869, 699, 748, 944, 638, 754, 491, 910, 858, 478, 815, 727, 917, 870, 493, 873, 701, 968, 383, 860, 756, 918, 931, 976, 499, 921, 874, 702, 823, 494, 731, 760, 881, 933, 501, 743, 922, 876, 847, 934, 827, 733, 502, 992, 882, 447, 963, 937, 747, 505, 855, 924, 734, 829, 884, 938, 506, 965, 749, 945, 966, 940, 969, 911, 946, 755, 888, 830, 859, 639, 871, 970, 750, 508, 948, 977, 757, 479, 919, 861, 875, 972, 978, 758, 862, 952, 761, 993, 923, 703, 495, 935, 877, 883, 980, 762, 925, 994, 878, 503, 885, 939, 984, 764, 996, 926, 735, 967, 886, 941, 507, 947, 889, 831, 1000, 942, 971, 751, 509, 949, 890, 973, 1008, 510, 950, 979, 759, 892, 863, 953, 974, 981, 954, 763, 995, 879, 982, 956, 985, 765, 997, 927, 887, 986, 766, 998, 1001, 943, 891, 988, 1002, 1009, 511, 951, 893, 1004, 975, 1010, 894, 955, 1012, 983, 957, 1016, 958, 987, 767, 999, 989, 1003, 990, 1005, 1011, 895, 1006, 1013, 1014, 1017, 959, 1018, 1020, 991, 1007, 1015, 1019, 1021, 1022, 1023]

Table Q21, having a sequence length of 1024:

| Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number |
|---|---|---|---|---|---|---|---|---|---|---|---|---|---|---|---|
| 0 | 0 | 128 | 268 | 256 | 180 | 384 | 609 | 512 | 364 | 640 | 663 | 768 | 916 | 896 | 966 |
| 1 | 1 | 129 | 274 | 257 | 107 | 385 | 896 | 513 | 335 | 641 | 835 | 769 | 725 | 897 | 940 |
| 2 | 2 | 130 | 54 | 258 | 325 | 386 | 331 | 514 | 422 | 642 | 904 | 770 | 698 | 898 | 969 |
| 3 | 4 | 131 | 83 | 259 | 94 | 387 | 309 | 515 | 613 | 643 | 809 | 771 | 490 | 899 | 911 |
| 4 | 8 | 132 | 530 | 260 | 537 | 388 | 418 | 516 | 659 | 644 | 714 | 772 | 739 | 900 | 946 |
| 5 | 16 | 133 | 57 | 261 | 400 | 389 | 449 | 517 | 654 | 645 | 619 | 773 | 814 | 901 | 755 |
| 6 | 32 | 134 | 112 | 262 | 298 | 390 | 217 | 518 | 315 | 646 | 796 | 774 | 843 | 902 | 888 |
| 7 | 3 | 135 | 529 | 263 | 204 | 391 | 408 | 519 | 221 | 647 | 374 | 775 | 623 | 903 | 830 |
| 8 | 5 | 136 | 524 | 264 | 352 | 392 | 229 | 520 | 370 | 648 | 429 | 776 | 497 | 904 | 859 |
| 9 | 64 | 137 | 135 | 265 | 305 | 393 | 541 | 521 | 425 | 649 | 455 | 777 | 439 | 905 | 639 |
| 10 | 6 | 138 | 78 | 266 | 155 | 394 | 159 | 522 | 235 | 650 | 692 | 778 | 381 | 906 | 871 |
| 11 | 9 | 139 | 289 | 267 | 300 | 395 | 420 | 523 | 451 | 651 | 721 | 779 | 671 | 907 | 970 |
| 12 | 17 | 140 | 194 | 268 | 210 | 396 | 596 | 524 | 480 | 652 | 837 | 780 | 463 | 908 | 750 |
| 13 | 10 | 141 | 85 | 269 | 608 | 397 | 650 | 525 | 775 | 653 | 716 | 781 | 726 | 909 | 508 |
| 14 | 18 | 142 | 276 | 270 | 648 | 398 | 773 | 526 | 412 | 654 | 864 | 782 | 930 | 910 | 948 |
| 15 | 128 | 143 | 58 | 271 | 109 | 399 | 310 | 527 | 614 | 655 | 810 | 783 | 872 | 911 | 977 |
| 16 | 12 | 144 | 168 | 272 | 184 | 400 | 333 | 528 | 343 | 656 | 606 | 784 | 821 | 912 | 757 |
| 17 | 33 | 145 | 139 | 273 | 115 | 401 | 119 | 529 | 222 | 657 | 912 | 785 | 920 | 913 | 479 |
| 18 | 256 | 146 | 99 | 274 | 167 | 402 | 368 | 530 | 317 | 658 | 722 | 786 | 700 | 914 | 919 |
| 19 | 20 | 147 | 86 | 275 | 225 | 403 | 339 | 531 | 372 | 659 | 696 | 787 | 729 | 915 | 861 |
| 20 | 34 | 148 | 60 | 276 | 326 | 404 | 391 | 532 | 543 | 660 | 377 | 788 | 492 | 916 | 875 |
| 21 | 24 | 149 | 89 | 277 | 157 | 405 | 657 | 533 | 426 | 661 | 817 | 789 | 932 | 917 | 972 |
| 22 | 65 | 150 | 768 | 278 | 110 | 406 | 313 | 534 | 453 | 662 | 435 | 790 | 961 | 918 | 978 |
| 23 | 36 | 151 | 196 | 279 | 772 | 407 | 218 | 535 | 237 | 663 | 812 | 791 | 741 | 919 | 758 |
| 24 | 7 | 152 | 290 | 280 | 549 | 408 | 542 | 536 | 559 | 664 | 484 | 792 | 903 | 920 | 862 |
| 25 | 129 | 153 | 141 | 281 | 656 | 409 | 610 | 537 | 833 | 665 | 319 | 793 | 845 | 921 | 952 |
| 26 | 66 | 154 | 101 | 282 | 538 | 410 | 334 | 538 | 804 | 666 | 430 | 794 | 498 | 922 | 761 |
| 27 | 512 | 155 | 280 | 283 | 117 | 411 | 230 | 539 | 712 | 667 | 621 | 795 | 880 | 923 | 993 |
| 28 | 11 | 156 | 545 | 284 | 212 | 412 | 233 | 540 | 834 | 668 | 838 | 796 | 382 | 924 | 923 |
| 29 | 40 | 157 | 546 | 285 | 330 | 413 | 774 | 541 | 661 | 669 | 667 | 797 | 822 | 925 | 703 |
| 30 | 68 | 158 | 532 | 286 | 171 | 414 | 658 | 542 | 808 | 670 | 239 | 798 | 851 | 926 | 495 |
| 31 | 19 | 159 | 147 | 287 | 550 | 415 | 612 | 543 | 779 | 671 | 378 | 799 | 631 | 927 | 935 |
| 32 | 13 | 160 | 176 | 288 | 329 | 416 | 175 | 544 | 617 | 672 | 459 | 800 | 443 | 928 | 877 |

| 33 | 130 | 161 | 142 | 289 | 306 | 417 | 123 | 545 | 604 | 673 | 437 | 801 | 825 | 929 | 883 |
|---|---|---|---|---|---|---|---|---|---|---|---|---|---|---|---|
| 34 | 48 | 162 | 90 | 290 | 226 | 418 | 450 | 546 | 433 | 674 | 627 | 802 | 730 | 930 | 980 |
| 35 | 14 | 163 | 536 | 291 | 387 | 419 | 652 | 547 | 720 | 675 | 622 | 803 | 471 | 931 | 762 |
| 36 | 72 | 164 | 292 | 292 | 308 | 420 | 341 | 548 | 816 | 676 | 488 | 804 | 445 | 932 | 925 |
| 37 | 257 | 165 | 200 | 293 | 271 | 421 | 220 | 549 | 836 | 677 | 380 | 805 | 687 | 933 | 994 |
| 38 | 21 | 166 | 263 | 294 | 579 | 422 | 557 | 550 | 347 | 678 | 461 | 806 | 635 | 934 | 878 |
| 39 | 132 | 167 | 31 | 295 | 416 | 423 | 314 | 551 | 897 | 679 | 679 | 807 | 742 | 935 | 503 |
| 40 | 35 | 168 | 149 | 296 | 216 | 424 | 555 | 552 | 243 | 680 | 841 | 808 | 846 | 936 | 885 |
| 41 | 258 | 169 | 321 | 297 | 337 | 425 | 600 | 553 | 662 | 681 | 818 | 809 | 500 | 937 | 939 |
| 42 | 26 | 170 | 322 | 298 | 158 | 426 | 583 | 554 | 454 | 682 | 724 | 810 | 745 | 938 | 984 |
| 43 | 513 | 171 | 577 | 299 | 776 | 427 | 424 | 555 | 318 | 683 | 669 | 811 | 826 | 939 | 764 |
| 44 | 80 | 172 | 102 | 300 | 118 | 428 | 395 | 556 | 675 | 684 | 496 | 812 | 732 | 940 | 996 |
| 45 | 37 | 173 | 105 | 301 | 540 | 429 | 777 | 557 | 376 | 685 | 629 | 813 | 446 | 941 | 926 |
| 46 | 25 | 174 | 296 | 302 | 553 | 430 | 673 | 558 | 428 | 686 | 928 | 814 | 962 | 942 | 735 |
| 47 | 22 | 175 | 163 | 303 | 279 | 431 | 355 | 559 | 625 | 687 | 737 | 815 | 936 | 943 | 967 |
| 48 | 136 | 176 | 92 | 304 | 332 | 432 | 287 | 560 | 238 | 688 | 899 | 816 | 255 | 944 | 886 |
| 49 | 96 | 177 | 47 | 305 | 389 | 433 | 183 | 561 | 359 | 689 | 783 | 817 | 853 | 945 | 941 |
| 50 | 260 | 178 | 150 | 306 | 173 | 434 | 234 | 562 | 567 | 690 | 738 | 818 | 504 | 946 | 507 |
| 51 | 38 | 179 | 548 | 307 | 121 | 435 | 125 | 563 | 618 | 691 | 901 | 819 | 637 | 947 | 947 |
| 52 | 514 | 180 | 208 | 308 | 199 | 436 | 342 | 564 | 665 | 692 | 842 | 820 | 907 | 948 | 889 |
| 53 | 264 | 181 | 324 | 309 | 179 | 437 | 563 | 565 | 736 | 693 | 438 | 821 | 475 | 949 | 831 |
| 54 | 67 | 182 | 385 | 310 | 228 | 438 | 674 | 566 | 898 | 694 | 467 | 822 | 746 | 950 | 1000 |
| 55 | 41 | 183 | 304 | 311 | 283 | 439 | 616 | 567 | 457 | 695 | 247 | 823 | 867 | 951 | 942 |
| 56 | 144 | 184 | 267 | 312 | 122 | 440 | 558 | 568 | 399 | 696 | 820 | 824 | 487 | 952 | 971 |
| 57 | 28 | 185 | 578 | 313 | 393 | 441 | 660 | 569 | 781 | 697 | 849 | 825 | 695 | 953 | 751 |
| 58 | 69 | 186 | 106 | 314 | 174 | 442 | 778 | 570 | 591 | 698 | 683 | 826 | 799 | 954 | 509 |
| 59 | 42 | 187 | 153 | 315 | 312 | 443 | 452 | 571 | 666 | 699 | 351 | 827 | 854 | 955 | 949 |
| 60 | 516 | 188 | 386 | 316 | 672 | 444 | 397 | 572 | 678 | 700 | 791 | 828 | 828 | 956 | 890 |
| 61 | 49 | 189 | 165 | 317 | 390 | 445 | 432 | 573 | 349 | 701 | 441 | 829 | 753 | 957 | 973 |
| 62 | 160 | 190 | 55 | 318 | 554 | 446 | 316 | 574 | 434 | 702 | 728 | 830 | 857 | 958 | 1008 |
| 63 | 272 | 191 | 328 | 319 | 556 | 447 | 345 | 575 | 677 | 703 | 670 | 831 | 964 | 959 | 510 |
| 64 | 70 | 192 | 113 | 320 | 203 | 448 | 241 | 576 | 840 | 704 | 462 | 832 | 909 | 960 | 950 |
| 65 | 520 | 193 | 519 | 321 | 561 | 449 | 207 | 577 | 782 | 705 | 469 | 833 | 719 | 961 | 979 |
| 66 | 288 | 194 | 552 | 322 | 181 | 450 | 785 | 578 | 626 | 706 | 442 | 834 | 477 | 962 | 759 |
| 67 | 528 | 195 | 641 | 323 | 295 | 451 | 403 | 579 | 571 | 707 | 251 | 835 | 915 | 963 | 892 |
| 68 | 131 | 196 | 154 | 324 | 448 | 452 | 357 | 580 | 620 | 708 | 367 | 836 | 869 | 964 | 863 |
| 69 | 44 | 197 | 79 | 325 | 353 | 453 | 187 | 581 | 787 | 709 | 630 | 837 | 699 | 965 | 953 |
| 70 | 544 | 198 | 108 | 326 | 338 | 454 | 587 | 582 | 363 | 710 | 740 | 838 | 748 | 966 | 974 |

| | | | | | | | | | | | | | | | |
|---|---|---|---|---|---|---|---|---|---|---|---|---|---|---|---|
| 71 | 73 | 199 | 224 | 327 | 63 | 455 | 565 | 583 | 245 | 711 | 902 | 839 | 944 | 967 | 981 |
| 72 | 192 | 200 | 269 | 328 | 581 | 456 | 664 | 584 | 458 | 712 | 711 | 840 | 638 | 968 | 954 |
| 73 | 50 | 201 | 166 | 329 | 340 | 457 | 624 | 585 | 127 | 713 | 844 | 841 | 754 | 969 | 763 |
| 74 | 74 | 202 | 523 | 330 | 285 | 458 | 780 | 586 | 407 | 714 | 850 | 842 | 491 | 970 | 995 |
| 75 | 52 | 203 | 560 | 331 | 394 | 459 | 236 | 587 | 436 | 715 | 905 | 843 | 910 | 971 | 879 |
| 76 | 15 | 204 | 580 | 332 | 232 | 460 | 126 | 588 | 465 | 716 | 685 | 844 | 858 | 972 | 982 |
| 77 | 133 | 205 | 195 | 333 | 124 | 461 | 242 | 589 | 350 | 717 | 691 | 845 | 478 | 973 | 956 |
| 78 | 320 | 206 | 277 | 334 | 354 | 462 | 398 | 590 | 246 | 718 | 824 | 846 | 815 | 974 | 985 |
| 79 | 81 | 207 | 169 | 335 | 582 | 463 | 705 | 591 | 681 | 719 | 633 | 847 | 727 | 975 | 765 |
| 80 | 23 | 208 | 275 | 336 | 784 | 464 | 346 | 592 | 460 | 720 | 483 | 848 | 917 | 976 | 997 |
| 81 | 134 | 209 | 291 | 337 | 704 | 465 | 456 | 593 | 249 | 721 | 795 | 849 | 870 | 977 | 927 |
| 82 | 76 | 210 | 59 | 338 | 527 | 466 | 358 | 594 | 599 | 722 | 744 | 850 | 493 | 978 | 887 |
| 83 | 137 | 211 | 270 | 339 | 286 | 467 | 405 | 595 | 411 | 723 | 470 | 851 | 873 | 979 | 986 |
| 84 | 82 | 212 | 114 | 340 | 182 | 468 | 303 | 596 | 365 | 724 | 852 | 852 | 701 | 980 | 766 |
| 85 | 384 | 213 | 156 | 341 | 562 | 469 | 569 | 597 | 668 | 725 | 686 | 853 | 968 | 981 | 998 |
| 86 | 56 | 214 | 87 | 342 | 643 | 470 | 595 | 598 | 707 | 726 | 444 | 854 | 383 | 982 | 1001 |
| 87 | 27 | 215 | 197 | 343 | 585 | 471 | 189 | 599 | 573 | 727 | 473 | 855 | 860 | 983 | 943 |
| 88 | 97 | 216 | 116 | 344 | 205 | 472 | 786 | 600 | 789 | 728 | 253 | 856 | 756 | 984 | 891 |
| 89 | 39 | 217 | 170 | 345 | 299 | 473 | 215 | 601 | 803 | 729 | 634 | 857 | 918 | 985 | 988 |
| 90 | 259 | 218 | 61 | 346 | 211 | 474 | 676 | 602 | 790 | 730 | 485 | 858 | 931 | 986 | 1002 |
| 91 | 84 | 219 | 525 | 347 | 401 | 475 | 589 | 603 | 682 | 731 | 415 | 859 | 976 | 987 | 1009 |
| 92 | 138 | 220 | 531 | 348 | 185 | 476 | 566 | 604 | 440 | 732 | 375 | 860 | 499 | 988 | 511 |
| 93 | 145 | 221 | 177 | 349 | 396 | 477 | 647 | 605 | 709 | 733 | 960 | 861 | 921 | 989 | 951 |
| 94 | 261 | 222 | 278 | 350 | 240 | 478 | 361 | 606 | 466 | 734 | 865 | 862 | 874 | 990 | 893 |
| 95 | 29 | 223 | 281 | 351 | 586 | 479 | 706 | 607 | 628 | 735 | 575 | 863 | 702 | 991 | 1004 |
| 96 | 43 | 224 | 526 | 352 | 645 | 480 | 244 | 608 | 371 | 736 | 807 | 864 | 823 | 992 | 975 |
| 97 | 98 | 225 | 642 | 353 | 593 | 481 | 348 | 609 | 423 | 737 | 906 | 865 | 494 | 993 | 1010 |
| 98 | 515 | 226 | 293 | 354 | 535 | 482 | 419 | 610 | 366 | 738 | 715 | 866 | 731 | 994 | 894 |
| 99 | 88 | 227 | 388 | 355 | 301 | 483 | 406 | 611 | 250 | 739 | 913 | 867 | 760 | 995 | 955 |
| 100 | 140 | 228 | 91 | 356 | 402 | 484 | 311 | 612 | 413 | 740 | 693 | 868 | 881 | 996 | 1012 |
| 101 | 30 | 229 | 584 | 357 | 344 | 485 | 708 | 613 | 574 | 741 | 797 | 869 | 933 | 997 | 983 |
| 102 | 146 | 230 | 769 | 358 | 206 | 486 | 219 | 614 | 468 | 742 | 866 | 870 | 501 | 998 | 957 |
| 103 | 71 | 231 | 198 | 359 | 564 | 487 | 598 | 615 | 603 | 743 | 811 | 871 | 743 | 999 | 1016 |
| 104 | 262 | 232 | 172 | 360 | 800 | 488 | 601 | 616 | 481 | 744 | 717 | 872 | 922 | 1000 | 958 |
| 105 | 265 | 233 | 120 | 361 | 327 | 489 | 651 | 617 | 689 | 745 | 474 | 873 | 876 | 1001 | 987 |
| 106 | 517 | 234 | 201 | 362 | 356 | 490 | 611 | 618 | 793 | 746 | 254 | 874 | 847 | 1002 | 767 |
| 107 | 161 | 235 | 62 | 363 | 307 | 491 | 409 | 619 | 191 | 747 | 694 | 875 | 934 | 1003 | 999 |
| 108 | 45 | 236 | 143 | 364 | 95 | 492 | 680 | 620 | 373 | 748 | 723 | 876 | 827 | 1004 | 989 |

| | | | | | | | | | | | | | | | |
|---|---|---|---|---|---|---|---|---|---|---|---|---|---|---|---|
| 109 | 576 | 237 | 336 | 365 | 417 | 493 | 788 | 621 | 655 | 749 | 636 | 877 | 733 | 1005 | 1003 |
| 110 | 518 | 238 | 282 | 366 | 213 | 494 | 362 | 622 | 900 | 750 | 486 | 878 | 502 | 1006 | 990 |
| 111 | 100 | 239 | 103 | 367 | 186 | 495 | 570 | 623 | 805 | 751 | 798 | 879 | 992 | 1007 | 1005 |
| 112 | 51 | 240 | 178 | 368 | 404 | 496 | 597 | 624 | 427 | 752 | 607 | 880 | 882 | 1008 | 1011 |
| 113 | 148 | 241 | 294 | 369 | 111 | 497 | 572 | 625 | 615 | 753 | 697 | 881 | 447 | 1009 | 895 |
| 114 | 521 | 242 | 93 | 370 | 539 | 498 | 464 | 626 | 710 | 754 | 489 | 882 | 963 | 1010 | 1006 |
| 115 | 46 | 243 | 533 | 371 | 568 | 499 | 801 | 627 | 414 | 755 | 431 | 883 | 937 | 1011 | 1013 |
| 116 | 75 | 244 | 644 | 372 | 594 | 500 | 590 | 628 | 252 | 756 | 379 | 884 | 747 | 1012 | 1014 |
| 117 | 640 | 245 | 534 | 373 | 649 | 501 | 421 | 629 | 848 | 757 | 908 | 885 | 505 | 1013 | 1017 |
| 118 | 266 | 246 | 547 | 374 | 771 | 502 | 802 | 630 | 684 | 758 | 752 | 886 | 855 | 1014 | 959 |
| 119 | 273 | 247 | 770 | 375 | 302 | 503 | 369 | 631 | 713 | 759 | 914 | 887 | 924 | 1015 | 1018 |
| 120 | 522 | 248 | 392 | 376 | 832 | 504 | 792 | 632 | 605 | 760 | 856 | 888 | 734 | 1016 | 1020 |
| 121 | 104 | 249 | 297 | 377 | 588 | 505 | 190 | 633 | 690 | 761 | 868 | 889 | 829 | 1017 | 991 |
| 122 | 162 | 250 | 592 | 378 | 646 | 506 | 602 | 634 | 632 | 762 | 839 | 890 | 884 | 1018 | 1007 |
| 123 | 53 | 251 | 323 | 379 | 227 | 507 | 653 | 635 | 482 | 763 | 929 | 891 | 938 | 1019 | 1015 |
| 124 | 193 | 252 | 202 | 380 | 360 | 508 | 248 | 636 | 794 | 764 | 813 | 892 | 506 | 1020 | 1019 |
| 125 | 152 | 253 | 284 | 381 | 214 | 509 | 688 | 637 | 806 | 765 | 718 | 893 | 965 | 1021 | 1021 |
| 126 | 77 | 254 | 151 | 382 | 188 | 510 | 231 | 638 | 472 | 766 | 819 | 894 | 749 | 1022 | 1022 |
| 127 | 164 | 255 | 209 | 383 | 551 | 511 | 410 | 639 | 223 | 767 | 476 | 895 | 945 | 1023 | 1023 |

Sequence Q22, having a sequence length of 512:

[0, 1, 2, 4, 8, 16, 32, 3, 5, 64, 6, 9, 17, 10, 18, 128, 12, 33, 256, 20, 34, 24, 65, 36, 7, 129, 66, 11, 40, 68, 19, 13, 130, 48, 14, 72, 257, 21, 132, 35, 258, 26, 80, 37, 25, 22, 136, 96, 260, 38, 264, 67, 41, 144, 28, 69, 42, 49, 160, 272, 70, 288, 131, 44, 73, 192, 50, 74, 52, 15, 133, 320, 81, 23, 134, 76, 137, 82, 384, 56, 27, 97, 39, 259, 84, 138, 145, 261, 29, 43, 98, 88, 140, 30, 146, 71, 262, 265, 161, 45, 100, 51, 148, 46, 75, 266, 273, 104, 162, 53, 193, 152, 77, 164, 268, 274, 54, 83, 57, 112, 135, 78, 289, 194, 85, 276, 58, 168, 139, 99, 86, 60, 89, 196, 290, 141, 101, 280, 147, 176, 142, 90, 292, 200, 263, 31, 149, 321, 322, 102, 105, 296, 163, 92, 47, 150, 208, 324, 385, 304, 267, 106, 153, 386, 165, 55, 328, 113, 154, 79, 108, 224, 269, 166, 195, 277, 169, 275, 291, 59, 270, 114, 156, 87, 197, 116, 170, 61, 177, 278, 281, 293, 388, 91, 198, 172, 120, 201, 62, 143, 336, 282, 103, 178, 294, 93, 392, 297, 323, 202, 284, 151, 209, 180, 107, 325, 94, 400, 298, 204, 352, 305, 155, 300, 210, 109, 184, 115, 167, 225, 326, 157, 110, 117, 212, 330, 171, 329, 306, 226, 387, 308, 271, 416, 216, 337, 158, 118, 279, 332, 389, 173, 121, 199, 179, 228, 283, 122, 393, 174, 312, 390, 203, 181, 295, 448, 353, 338, 63, 340, 285, 394, 232, 124, 354, 286, 182, 205, 299, 211, 401, 185, 396, 240, 301, 402, 344, 206, 327, 356, 307, 95, 417, 213, 186, 404, 111, 302, 227, 360, 214, 188, 331, 309, 418, 449, 217, 408, 229, 159, 420, 310, 333, 119, 368, 339, 391, 313, 218, 334, 230, 233, 175, 123, 450, 341, 220, 314, 424, 395, 355, 287, 183, 234, 125, 342, 452, 397, 432, 316, 345, 241, 207, 403, 357, 187, 236, 126, 242, 398, 346, 456, 358, 405, 303, 189, 215, 361, 244, 348, 419, 406, 311, 219, 409, 362, 464, 421, 369, 190, 248, 231, 410, 364, 335, 422, 315, 221, 370, 425, 235, 451, 480, 412, 343, 222, 317, 372, 426, 453, 237, 433, 347, 243, 454, 318, 376, 428, 238, 359, 457, 399, 349, 434, 363, 245, 458, 127, 407, 436, 465, 350, 246, 460, 249, 411, 365, 440, 466, 371, 423, 366, 250, 413, 468, 481, 191, 373, 427, 414, 252, 482, 472, 223, 374, 429, 455, 377, 435, 484, 319, 430, 239, 378, 459, 437, 488, 380, 461, 496, 438, 467, 247, 351, 441, 462, 469, 442, 251, 367, 483, 470, 444, 473, 253, 485, 415, 375, 474, 254, 486, 489, 431, 379, 476, 490, 497, 439, 381, 463, 492, 498, 382, 443, 471, 445, 500, 446, 255, 504, 475, 487, 477, 491, 478, 493, 383, 499, 494, 501, 502, 447, 505, 506, 508, 479, 495,503,507,509,510,511]

Table Q22, having a sequence length of 512:

| Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number |
|---|---|---|---|---|---|---|---|---|---|---|---|---|---|---|---|
| 0 | 0 | 64 | 73 | 128 | 139 | 192 | 388 | 256 | 283 | 320 | 230 | 384 | 343 | 448 | 461 |
| 1 | 1 | 65 | 192 | 129 | 99 | 193 | 91 | 257 | 122 | 321 | 233 | 385 | 222 | 449 | 496 |
| 2 | 2 | 66 | 50 | 130 | 86 | 194 | 198 | 258 | 393 | 322 | 175 | 386 | 317 | 450 | 438 |
| 3 | 4 | 67 | 74 | 131 | 60 | 195 | 172 | 259 | 174 | 323 | 123 | 387 | 372 | 451 | 467 |
| 4 | 8 | 68 | 52 | 132 | 89 | 196 | 120 | 260 | 312 | 324 | 450 | 388 | 426 | 452 | 247 |
| 5 | 16 | 69 | 15 | 133 | 196 | 197 | 201 | 261 | 390 | 325 | 341 | 389 | 453 | 453 | 351 |
| 6 | 32 | 70 | 133 | 134 | 290 | 198 | 62 | 262 | 203 | 326 | 220 | 390 | 237 | 454 | 441 |
| 7 | 3 | 71 | 320 | 135 | 141 | 199 | 143 | 263 | 181 | 327 | 314 | 391 | 433 | 455 | 462 |
| 8 | 5 | 72 | 81 | 136 | 101 | 200 | 336 | 264 | 295 | 328 | 424 | 392 | 347 | 456 | 469 |
| 9 | 64 | 73 | 23 | 137 | 280 | 201 | 282 | 265 | 448 | 329 | 395 | 393 | 243 | 457 | 442 |
| 10 | 6 | 74 | 134 | 138 | 147 | 202 | 103 | 266 | 353 | 330 | 355 | 394 | 454 | 458 | 251 |
| 11 | 9 | 75 | 76 | 139 | 176 | 203 | 178 | 267 | 338 | 331 | 287 | 395 | 318 | 459 | 367 |
| 12 | 17 | 76 | 137 | 140 | 142 | 204 | 294 | 268 | 63 | 332 | 183 | 396 | 376 | 460 | 483 |
| 13 | 10 | 77 | 82 | 141 | 90 | 205 | 93 | 269 | 340 | 333 | 234 | 397 | 428 | 461 | 470 |
| 14 | 18 | 78 | 384 | 142 | 292 | 206 | 392 | 270 | 285 | 334 | 125 | 398 | 238 | 462 | 444 |
| 15 | 128 | 79 | 56 | 143 | 200 | 207 | 297 | 271 | 394 | 335 | 342 | 399 | 359 | 463 | 473 |
| 16 | 12 | 80 | 27 | 144 | 263 | 208 | 323 | 272 | 232 | 336 | 452 | 400 | 457 | 464 | 253 |
| 17 | 33 | 81 | 97 | 145 | 31 | 209 | 202 | 273 | 124 | 337 | 397 | 401 | 399 | 465 | 485 |
| 18 | 256 | 82 | 39 | 146 | 149 | 210 | 284 | 274 | 354 | 338 | 432 | 402 | 349 | 466 | 415 |
| 19 | 20 | 83 | 259 | 147 | 321 | 211 | 151 | 275 | 286 | 339 | 316 | 403 | 434 | 467 | 375 |

| | | | | | | | | | | | | | | | |
|---|---|---|---|---|---|---|---|---|---|---|---|---|---|---|---|
| 20 | 34 | 84 | 84 | 148 | 322 | 212 | 209 | 276 | 182 | 340 | 345 | 404 | 363 | 468 | 474 |
| 21 | 24 | 85 | 138 | 149 | 102 | 213 | 180 | 277 | 205 | 341 | 241 | 405 | 245 | 469 | 254 |
| 22 | 65 | 86 | 145 | 150 | 105 | 214 | 107 | 278 | 299 | 342 | 207 | 406 | 458 | 470 | 486 |
| 23 | 36 | 87 | 261 | 151 | 296 | 215 | 325 | 279 | 211 | 343 | 403 | 407 | 127 | 471 | 489 |
| 24 | 7 | 88 | 29 | 152 | 163 | 216 | 94 | 280 | 401 | 344 | 357 | 408 | 407 | 472 | 431 |
| 25 | 129 | 89 | 43 | 153 | 92 | 217 | 400 | 281 | 185 | 345 | 187 | 409 | 436 | 473 | 379 |
| 26 | 66 | 90 | 98 | 154 | 47 | 218 | 298 | 282 | 396 | 346 | 236 | 410 | 465 | 474 | 476 |
| 27 | 11 | 91 | 88 | 155 | 150 | 219 | 204 | 283 | 240 | 347 | 126 | 411 | 350 | 475 | 490 |
| 28 | 40 | 92 | 140 | 156 | 208 | 220 | 352 | 284 | 301 | 348 | 242 | 412 | 246 | 476 | 497 |
| 29 | 68 | 93 | 30 | 157 | 324 | 221 | 305 | 285 | 402 | 349 | 398 | 413 | 460 | 477 | 439 |
| 30 | 19 | 94 | 146 | 158 | 385 | 222 | 155 | 286 | 344 | 350 | 346 | 414 | 249 | 478 | 381 |
| 31 | 13 | 95 | 71 | 159 | 304 | 223 | 300 | 287 | 206 | 351 | 456 | 415 | 411 | 479 | 463 |
| 32 | 130 | 96 | 262 | 160 | 267 | 224 | 210 | 288 | 327 | 352 | 358 | 416 | 365 | 480 | 492 |
| 33 | 48 | 97 | 265 | 161 | 106 | 225 | 109 | 289 | 356 | 353 | 405 | 417 | 440 | 481 | 498 |
| 34 | 14 | 98 | 161 | 162 | 153 | 226 | 184 | 290 | 307 | 354 | 303 | 418 | 466 | 482 | 382 |
| 35 | 72 | 99 | 45 | 163 | 386 | 227 | 115 | 291 | 95 | 355 | 189 | 419 | 371 | 483 | 443 |
| 36 | 257 | 100 | 100 | 164 | 165 | 228 | 167 | 292 | 417 | 356 | 215 | 420 | 423 | 484 | 471 |
| 37 | 21 | 101 | 51 | 165 | 55 | 229 | 225 | 293 | 213 | 357 | 361 | 421 | 366 | 485 | 445 |
| 38 | 132 | 102 | 148 | 166 | 328 | 230 | 326 | 294 | 186 | 358 | 244 | 422 | 250 | 486 | 500 |
| 39 | 35 | 103 | 46 | 167 | 113 | 231 | 157 | 295 | 404 | 359 | 348 | 423 | 413 | 487 | 446 |
| 40 | 258 | 104 | 75 | 168 | 154 | 232 | 110 | 296 | 111 | 360 | 419 | 424 | 468 | 488 | 255 |
| 41 | 26 | 105 | 266 | 169 | 79 | 233 | 117 | 297 | 302 | 361 | 406 | 425 | 481 | 489 | 504 |
| 42 | 80 | 106 | 273 | 170 | 108 | 234 | 212 | 298 | 227 | 362 | 311 | 426 | 191 | 490 | 475 |
| 43 | 37 | 107 | 104 | 171 | 224 | 235 | 330 | 299 | 360 | 363 | 219 | 427 | 373 | 491 | 487 |
| 44 | 25 | 108 | 162 | 172 | 269 | 236 | 171 | 300 | 214 | 364 | 409 | 428 | 427 | 492 | 477 |
| 45 | 22 | 109 | 53 | 173 | 166 | 237 | 329 | 301 | 188 | 365 | 362 | 429 | 414 | 493 | 491 |
| 46 | 136 | 110 | 193 | 174 | 195 | 238 | 306 | 302 | 331 | 366 | 464 | 430 | 252 | 494 | 478 |
| 47 | 96 | 111 | 152 | 175 | 277 | 239 | 226 | 303 | 309 | 367 | 421 | 431 | 482 | 495 | 493 |
| 48 | 260 | 112 | 77 | 176 | 169 | 240 | 387 | 304 | 418 | 368 | 369 | 432 | 472 | 496 | 383 |
| 49 | 38 | 113 | 164 | 177 | 275 | 241 | 308 | 305 | 449 | 369 | 190 | 433 | 223 | 497 | 499 |
| 50 | 264 | 114 | 268 | 178 | 291 | 242 | 271 | 306 | 217 | 370 | 248 | 434 | 374 | 498 | 494 |
| 51 | 67 | 115 | 274 | 179 | 59 | 243 | 416 | 307 | 408 | 371 | 231 | 435 | 429 | 499 | 501 |
| 52 | 41 | 116 | 54 | 180 | 270 | 244 | 216 | 308 | 229 | 372 | 410 | 436 | 455 | 500 | 502 |
| 53 | 144 | 117 | 83 | 181 | 114 | 245 | 337 | 309 | 159 | 373 | 364 | 437 | 377 | 501 | 447 |
| 54 | 28 | 118 | 57 | 182 | 156 | 246 | 158 | 310 | 420 | 374 | 335 | 438 | 435 | 502 | 505 |
| 55 | 69 | 119 | 112 | 183 | 87 | 247 | 118 | 311 | 310 | 375 | 422 | 439 | 484 | 503 | 506 |
| 56 | 42 | 120 | 135 | 184 | 197 | 248 | 279 | 312 | 333 | 376 | 315 | 440 | 319 | 504 | 508 |
| 57 | 49 | 121 | 78 | 185 | 116 | 249 | 332 | 313 | 119 | 377 | 221 | 441 | 430 | 505 | 479 |

| 58 | 160 | 122 | 289 | 186 | 170 | 250 | 389 | 314 | 368 | 378 | 370 | 442 | 239 | 506 | 495 |
|---|---|---|---|---|---|---|---|---|---|---|---|---|---|---|---|
| 59 | 272 | 123 | 194 | 187 | 61 | 251 | 173 | 315 | 339 | 379 | 425 | 443 | 378 | 507 | 503 |
| 60 | 70 | 124 | 85 | 188 | 177 | 252 | 121 | 316 | 391 | 380 | 235 | 444 | 459 | 508 | 507 |
| 61 | 288 | 125 | 276 | 189 | 278 | 253 | 199 | 317 | 313 | 381 | 451 | 445 | 437 | 509 | 509 |
| 62 | 131 | 126 | 58 | 190 | 281 | 254 | 179 | 318 | 218 | 382 | 480 | 446 | 488 | 510 | 510 |
| 63 | 44 | 127 | 168 | 191 | 293 | 255 | 228 | 319 | 334 | 383 | 412 | 447 | 380 | 511 | 511 |

Sequence Q23, having a sequence length of 256:
[0, 1, 2, 4, 8, 16, 32, 3, 5, 64, 6, 9, 17, 10, 18, 128, 12, 33, 20, 34, 24, 65, 36, 7, 129, 66, 11, 40, 68, 19, 13, 130, 48, 14, 72, 21, 132, 35, 26, 80, 37, 25, 22, 136, 96, 38, 67, 41, 144, 28, 69, 42, 49, 160, 70, 131, 44, 73, 192, 50, 74, 52, 15, 133, 81, 23, 134, 76, 137, 82, 56, 27, 97, 39, 84, 138, 145, 29, 43, 98, 88, 140, 30, 146, 71, 161, 45, 100, 51, 148, 46, 75, 104, 162, 53, 193, 152, 77, 164, 54, 83, 57, 112, 135, 78, 194, 85, 58, 168, 139, 99, 86, 60, 89, 196, 141, 101, 147, 176, 142, 90, 200, 31, 149, 102, 105, 163, 92, 47, 150, 208, 106, 153, 165, 55, 113, 154, 79, 108, 224, 166, 195, 169, 59, 114, 156, 87, 197, 116, 170, 61, 177, 91, 198, 172, 120, 201, 62, 143, 103, 178, 93, 202, 151, 209, 180, 107, 94, 204, 155, 210, 109, 184, 115, 167, 225, 157, 110, 117, 212, 171, 226, 216, 158, 118, 173, 121, 199, 179, 228, 122, 174, 203, 181, 63, 232, 124, 182, 205, 211, 185, 240, 206, 95, 213, 186, 111, 227, 214, 188, 217, 229, 159, 119, 218, 230, 233, 175, 123, 220, 183, 234, 125, 241, 207, 187, 236, 126, 242, 189, 215, 244, 219, 190, 248, 231, 221, 235, 222, 237, 243, 238, 245, 127, 246, 249, 250, 191, 252, 223, 239, 247, 251, 253, 254, 255]

## Table Q23, having a sequence length of 256:

| Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number |
|---|---|---|---|---|---|---|---|---|---|---|---|---|---|---|---|
| 0 | 0 | 32 | 48 | 64 | 81 | 96 | 152 | 128 | 47 | 160 | 178 | 192 | 203 | 224 | 207 |
| 1 | 1 | 33 | 14 | 65 | 23 | 97 | 77 | 129 | 150 | 161 | 93 | 193 | 181 | 225 | 187 |
| 2 | 2 | 34 | 72 | 66 | 134 | 98 | 164 | 130 | 208 | 162 | 202 | 194 | 63 | 226 | 236 |
| 3 | 4 | 35 | 21 | 67 | 76 | 99 | 54 | 131 | 106 | 163 | 151 | 195 | 232 | 227 | 126 |
| 4 | 8 | 36 | 132 | 68 | 137 | 100 | 83 | 132 | 153 | 164 | 209 | 196 | 124 | 228 | 242 |
| 5 | 16 | 37 | 35 | 69 | 82 | 101 | 57 | 133 | 165 | 165 | 180 | 197 | 182 | 229 | 189 |
| 6 | 32 | 38 | 26 | 70 | 56 | 102 | 112 | 134 | 55 | 166 | 107 | 198 | 205 | 230 | 215 |
| 7 | 3 | 39 | 80 | 71 | 27 | 103 | 135 | 135 | 113 | 167 | 94 | 199 | 211 | 231 | 244 |
| 8 | 5 | 40 | 37 | 72 | 97 | 104 | 78 | 136 | 154 | 168 | 204 | 200 | 185 | 232 | 219 |
| 9 | 64 | 41 | 25 | 73 | 39 | 105 | 194 | 137 | 79 | 169 | 155 | 201 | 240 | 233 | 190 |

| Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number |
|---|---|---|---|---|---|---|---|---|---|---|---|---|---|---|---|
| 10 | 6 | 42 | 22 | 74 | 84 | 106 | 85 | 138 | 108 | 170 | 210 | 202 | 206 | 234 | 248 |
| 11 | 9 | 43 | 136 | 75 | 138 | 107 | 58 | 139 | 224 | 171 | 109 | 203 | 95 | 235 | 231 |
| 12 | 17 | 44 | 96 | 76 | 145 | 108 | 168 | 140 | 166 | 172 | 184 | 204 | 213 | 236 | 221 |
| 13 | 10 | 45 | 38 | 77 | 29 | 109 | 139 | 141 | 195 | 173 | 115 | 205 | 186 | 237 | 235 |
| 14 | 18 | 46 | 67 | 78 | 43 | 110 | 99 | 142 | 169 | 174 | 167 | 206 | 111 | 238 | 222 |
| 15 | 128 | 47 | 41 | 79 | 98 | 111 | 86 | 143 | 59 | 175 | 225 | 207 | 227 | 239 | 237 |
| 16 | 12 | 48 | 144 | 80 | 88 | 112 | 60 | 144 | 114 | 176 | 157 | 208 | 214 | 240 | 243 |
| 17 | 33 | 49 | 28 | 81 | 140 | 113 | 89 | 145 | 156 | 177 | 110 | 209 | 188 | 241 | 238 |
| 18 | 20 | 50 | 69 | 82 | 30 | 114 | 196 | 146 | 87 | 178 | 117 | 210 | 217 | 242 | 245 |
| 19 | 34 | 51 | 42 | 83 | 146 | 115 | 141 | 147 | 197 | 179 | 212 | 211 | 229 | 243 | 127 |
| 20 | 24 | 52 | 49 | 84 | 71 | 116 | 101 | 148 | 116 | 180 | 171 | 212 | 159 | 244 | 246 |
| 21 | 65 | 53 | 160 | 85 | 161 | 117 | 147 | 149 | 170 | 181 | 226 | 213 | 119 | 245 | 249 |
| 22 | 36 | 54 | 70 | 86 | 45 | 118 | 176 | 150 | 61 | 182 | 216 | 214 | 218 | 246 | 250 |
| 23 | 7 | 55 | 131 | 87 | 100 | 119 | 142 | 151 | 177 | 183 | 158 | 215 | 230 | 247 | 191 |
| 24 | 129 | 56 | 44 | 88 | 51 | 120 | 90 | 152 | 91 | 184 | 118 | 216 | 233 | 248 | 252 |
| 25 | 66 | 57 | 73 | 89 | 148 | 121 | 200 | 153 | 198 | 185 | 173 | 217 | 175 | 249 | 223 |
| 26 | 11 | 58 | 192 | 90 | 46 | 122 | 31 | 154 | 172 | 186 | 121 | 218 | 123 | 250 | 239 |
| 27 | 40 | 59 | 50 | 91 | 75 | 123 | 149 | 155 | 120 | 187 | 199 | 219 | 220 | 251 | 247 |
| 28 | 68 | 60 | 74 | 92 | 104 | 124 | 102 | 156 | 201 | 188 | 179 | 220 | 183 | 252 | 251 |
| 29 | 19 | 61 | 52 | 93 | 162 | 125 | 105 | 157 | 62 | 189 | 228 | 221 | 234 | 253 | 253 |
| 30 | 13 | 62 | 15 | 94 | 53 | 126 | 163 | 158 | 143 | 190 | 122 | 222 | 125 | 254 | 254 |
| 31 | 130 | 63 | 133 | 95 | 193 | 127 | 92 | 159 | 103 | 191 | 174 | 223 | 241 | 255 | 255 |

Sequence Q24, having a sequence length of 128:

[0, 1, 2, 4, 8, 16, 32, 3, 5, 64, 6, 9, 17, 10, 18, 12, 33, 20, 34, 24, 65, 36, 7, 66, 11, 40, 68, 19, 13, 48, 14, 72, 21, 35, 26, 80, 37, 25, 22, 96, 38, 67, 41, 28, 69, 42, 49, 70, 44, 73, 50, 74, 52, 15, 81, 23, 76, 82, 56, 27, 97, 39, 84, 29, 43, 98, 88, 30, 71, 45, 100, 51, 46, 75, 104, 53, 77, 54, 83, 57, 112, 78, 85, 58, 99, 86, 60, 89, 101, 90, 31, 102, 105, 92, 47, 106, 55, 113, 79, 108, 59, 114, 87, 116, 61, 91, 120, 62, 103, 93, 107, 94, 109, 115, 110, 117, 118, 121, 122, 63, 124, 95, 111, 119, 123, 125, 126, 127]

Table Q24, having a sequence length of 128:

| | | | | | | | | | | | | | | | |
|---|---|---|---|---|---|---|---|---|---|---|---|---|---|---|---|
| 0 | 0 | 16 | 33 | 32 | 21 | 48 | 44 | 64 | 43 | 80 | 112 | 96 | 55 | 112 | 109 |
| 1 | 1 | 17 | 20 | 33 | 35 | 49 | 73 | 65 | 98 | 81 | 78 | 97 | 113 | 113 | 115 |
| 2 | 2 | 18 | 34 | 34 | 26 | 50 | 50 | 66 | 88 | 82 | 85 | 98 | 79 | 114 | 110 |
| 3 | 4 | 19 | 24 | 35 | 80 | 51 | 74 | 67 | 30 | 83 | 58 | 99 | 108 | 115 | 117 |
| 4 | 8 | 20 | 65 | 36 | 37 | 52 | 52 | 68 | 71 | 84 | 99 | 100 | 59 | 116 | 118 |
| 5 | 16 | 21 | 36 | 37 | 25 | 53 | 15 | 69 | 45 | 85 | 86 | 101 | 114 | 117 | 121 |
| 6 | 32 | 22 | 7 | 38 | 22 | 54 | 81 | 70 | 100 | 86 | 60 | 102 | 87 | 118 | 122 |
| 7 | 3 | 23 | 66 | 39 | 96 | 55 | 23 | 71 | 51 | 87 | 89 | 103 | 116 | 119 | 63 |
| 8 | 5 | 24 | 11 | 40 | 38 | 56 | 76 | 72 | 46 | 88 | 101 | 104 | 61 | 120 | 124 |
| 9 | 64 | 25 | 40 | 41 | 67 | 57 | 82 | 73 | 75 | 89 | 90 | 105 | 91 | 121 | 95 |
| 10 | 6 | 26 | 68 | 42 | 41 | 58 | 56 | 74 | 104 | 90 | 31 | 106 | 120 | 122 | 111 |
| 11 | 9 | 27 | 19 | 43 | 28 | 59 | 27 | 75 | 53 | 91 | 102 | 107 | 62 | 123 | 119 |
| 12 | 17 | 28 | 13 | 44 | 69 | 60 | 97 | 76 | 77 | 92 | 105 | 108 | 103 | 124 | 123 |
| 13 | 10 | 29 | 48 | 45 | 42 | 61 | 39 | 77 | 54 | 93 | 92 | 109 | 93 | 125 | 125 |
| 14 | 18 | 30 | 14 | 46 | 49 | 62 | 84 | 78 | 83 | 94 | 47 | 110 | 107 | 126 | 126 |
| 15 | 12 | 31 | 72 | 47 | 70 | 63 | 29 | 79 | 57 | 95 | 106 | 111 | 94 | 127 | 127 |

Sequence Q25, having a sequence length of 64:
[0, 1, 2, 4, 8, 16, 32, 3, 5, 6, 9, 17, 10, 18, 12, 33, 20, 34, 24, 36, 7, 11, 40, 19, 13, 48, 14, 21, 35, 26, 37, 25, 22, 38, 41, 28, 42, 49, 44, 50, 52, 15, 23, 56, 27, 39, 29, 43, 30, 45, 51, 46, 53, 54, 57, 58, 60, 31, 47, 55, 59, 61, 62, 63]

Table Q25, having a sequence length of 64:

| Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number |
|---|---|---|---|---|---|---|---|---|---|---|---|---|---|---|---|
| 0 | 0 | 8 | 5 | 16 | 20 | 24 | 13 | 32 | 22 | 40 | 52 | 48 | 30 | 56 | 60 |
| 1 | 1 | 9 | 6 | 17 | 34 | 25 | 48 | 33 | 38 | 41 | 15 | 49 | 45 | 57 | 31 |
| 2 | 2 | 10 | 9 | 18 | 24 | 26 | 14 | 34 | 41 | 42 | 23 | 50 | 51 | 58 | 47 |
| 3 | 4 | 11 | 17 | 19 | 36 | 27 | 21 | 35 | 28 | 43 | 56 | 51 | 46 | 59 | 55 |
| 4 | 8 | 12 | 10 | 20 | 7 | 28 | 35 | 36 | 42 | 44 | 27 | 52 | 53 | 60 | 59 |
| 5 | 16 | 13 | 18 | 21 | 11 | 29 | 26 | 37 | 49 | 45 | 39 | 53 | 54 | 61 | 61 |
| 6 | 32 | 14 | 12 | 22 | 40 | 30 | 37 | 38 | 44 | 46 | 29 | 54 | 57 | 62 | 62 |
| 7 | 3 | 15 | 33 | 23 | 19 | 31 | 25 | 39 | 50 | 47 | 43 | 55 | 58 | 63 | 63 |

Sequence Z21, having a sequence length of 1024:
[0, 1, 2, 7, 3, 8, 10, 24, 4, 11, 13, 28, 16, 32, 35, 76, 5, 12, 14, 31, 19, 38, 47, 80, 21, 46, 42, 87, 57, 95, 101, 167, 6, 17, 20, 40, 23, 45, 51, 89, 29, 55, 59, 96, 69, 108, 115, 177, 34, 61, 73, 112, 75, 123, 130, 190, 86, 133, 143, 210, 148, 218, 235, 327, 9, 22, 26, 54, 30, 58, 64, 103, 36, 71, 74, 116, 82, 126, 138, 197, 44, 79, 84, 131, 91, 141, 147, 214, 99, 149, 162, 228, 176, 242, 259, 364, 49, 88, 97, 146, 111, 154, 172, 239, 121, 173, 186, 257, 198, 271, 278, 369, 134, 192, 212, 273, 216, 283, 300, 401, 233, 307, 312, 417, 333, 435, 460, 585, 15, 25, 33, 68, 39, 77, 81, 137, 48, 83, 92, 145, 100, 153, 161, 236, 56, 93, 102, 159, 113, 168, 178, 254, 125, 187, 196, 266, 213, 277, 298, 394, 62, 107, 122, 175, 127, 189, 201, 274, 144, 207, 217, 286, 232, 306, 314, 416, 160, 221, 240, 309, 256, 322, 340, 433, 272, 348, 367, 453, 382, 471, 505, 619, 72, 124, 140, 205, 151, 215, 231, 308, 165, 234, 252, 320, 263, 344, 358, 449, 180, 255, 268, 346, 284, 366, 381, 473, 296, 390, 407, 486, 421, 519, 529, 639, 199, 275, 290, 379, 310, 392, 411, 510, 332, 412, 434, 522, 459, 535, 560, 670, 350, 448, 461, 552, 480, 583, 590, 695, 508, 593, 611, 707, 628, 728, 746, 816, 18, 37, 41, 90, 50, 94, 104, 166, 53, 105, 118, 184, 128, 200, 211, 293, 63, 119, 129, 208, 142, 206, 222, 303, 155, 223, 238, 311, 253, 330, 339, 432, 66, 139, 152, 209, 164, 226, 241, 323, 174, 249, 262, 345, 267, 355, 375, 468, 183, 265, 289, 363, 292, 387, 399, 484, 315, 406, 423, 518, 446, 530, 555, 665, 78, 169, 170, 251, 181, 258, 276, 361, 191, 288, 285, 386, 304, 400, 410, 513, 237, 297, 326, 403, 329, 420, 436, 528, 357, 447, 464, 550, 481, 573, 589, 699, 264, 325, 334, 431, 362, 452, 466, 561, 380, 478, 494, 582, 512, 596, 610, 708, 402, 503, 520, 608, 531, 620, 647, 732, 557, 660, 671, 756, 677, 778, 796, 854, 85, 182, 188, 291, 227, 305, 317, 404, 248, 313, 331, 428, 349, 444, 462, 568, 261, 347, 356, 451, 368, 467, 483, 586, 391, 491, 511, 595, 526, 612, 627, 731, 295, 365, 388, 482, 395, 501, 514, 609, 427, 521, 533, 624, 558, 648, 666, 755, 445, 546, 574, 662, 587, 673, 693, 777, 604, 701, 706, 800, 726, 804, 813, 881, 324, 389, 418, 523, 443, 534, 554, 649, 465, 567, 584, 672, 592, 678, 704, 780, 498, 588, 606, 694, 614, 705, 723, 803, 638, 727, 745, 821, 767, 834, 845, 913, 524, 616, 635, 720, 664, 730, 750, 824, 676, 754, 771, 842, 788, 850, 865, 926, 684, 776, 794, 860, 809, 870, 878, 935, 818, 885, 892, 946, 909, 954, 959, 988, 27, 43, 52, 98, 60, 106, 110, 193, 65, 114, 120, 202, 136, 219, 224, 338, 67, 135, 132, 220, 158, 243, 245, 354, 163, 260, 282, 370, 301, 393, 408, 532, 70, 156, 157, 246, 179, 280, 287, 383, 194, 302, 318, 424, 319, 422, 440, 536, 203, 321, 341, 437, 359, 455, 476, 562, 371, 469, 495, 579, 497, 599, 613, 735, 109, 171, 185, 294, 204, 328, 335, 426, 229, 343, 351, 454, 377, 475, 500, 570, 250, 353, 372, 470, 396, 496, 487, 594, 425, 488, 506, 615, 545, 632, 656, 752, 269, 384, 409, 490, 415, 515, 527, 625, 439, 544, 563, 645, 580, 667, 675, 775, 457, 559, 578, 674, 607, 685, 709, 799, 634, 719, 729, 806, 749, 819, 840, 905, 117, 195, 225, 342, 244, 352, 378, 477, 270, 373, 397, 489, 419, 507, 517, 621, 281, 405, 414, 516, 441, 541, 553, 640, 456, 564, 571, 669, 597, 683, 703, 779, 316, 430, 438, 556, 474, 575, 572, 679, 492, 591, 603, 698, 630, 716, 725, 805, 509, 617, 633, 717, 650, 740, 747, 825, 659, 753, 770, 837, 786, 852, 863, 925, 337, 463, 479, 598, 485, 605, 626, 712, 539, 631, 644, 738, 653, 744, 765, 833, 547, 651, 658, 748, 682, 769, 781, 847, 702, 787, 802, 866, 812, 877, 888, 942, 565, 687, 690, 772, 710, 791, 807, 871, 722, 810, 822, 884, 838, 894, 908, 953, 758, 829, 841, 901, 856, 912, 919, 962, 867, 922, 931, 969, 939, 975, 980, 1002, 150, 230, 247, 374, 279, 398, 413, 525, 299, 429, 442, 543, 458, 569, 577, 689, 336, 450, 472, 581, 493, 600, 602, 700, 504, 618, 636, 721, 646, 741, 751, 826, 360, 499, 502, 601, 538, 623, 637, 736, 542, 643, 655, 743, 663, 764, 773, 846, 548, 661, 681, 766, 696, 784, 797, 864, 718, 801, 811, 876, 828, 889, 903, 949, 376, 537, 540, 641, 549, 652, 668, 762, 576, 680, 692, 774, 713, 793, 808, 874, 629, 697, 714, 798, 724, 817, 827, 886, 760, 830, 844, 904, 855, 915, 920, 964, 654, 734, 742, 823, 761, 836, 849, 906, 783, 851, 862, 916, 873, 928, 934, 971, 795, 868, 880, 929, 890, 936, 944, 978, 902, 948, 956, 984, 963, 990, 994, 1009, 385, 551, 566, 688, 622, 691, 711, 792, 642, 715, 737, 820, 757, 832, 843, 899, 657, 739, 759, 835, 768, 848, 857, 914, 785, 861, 872, 924, 887, 932, 941, 977, 686, 763, 782, 858, 789, 869, 875, 927, 815, 883, 891, 937, 897, 945, 951, 983, 839, 895, 900, 947, 910, 955, 960, 989, 921, 965, 968, 995, 973, 998, 1000, 1014, 733, 790, 814, 882, 831, 893, 896, 943, 853, 898, 907, 952, 917, 957, 966, 992, 859, 911, 918, 961, 930, 967, 972, 997, 938, 974, 979, 1001, 985, 1004, 1006, 1017, 879, 923, 933, 970, 940, 976, 981, 1003, 950, 982, 986, 1005, 991, 1007, 1010, 1018, 958, 987, 993, 1008, 996, 1011, 1012, 1019, 999, 1013, 1015, 1020, 1016, 1021, 1022, 1023]

Table Z21, having a sequence length of 1024:

| Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability |
|---|---|---|---|---|---|---|---|---|---|---|---|---|---|---|---|
| 0 | 0 | 128 | 15 | 256 | 18 | 384 | 85 | 512 | 27 | 640 | 117 | 768 | 150 | 896 | 385 |
| 1 | 1 | 129 | 25 | 257 | 37 | 385 | 182 | 513 | 43 | 641 | 195 | 769 | 230 | 897 | 551 |
| 2 | 2 | 130 | 33 | 258 | 41 | 386 | 188 | 514 | 52 | 642 | 225 | 770 | 247 | 898 | 566 |
| 3 | 7 | 131 | 68 | 259 | 90 | 387 | 291 | 515 | 98 | 643 | 342 | 771 | 374 | 899 | 688 |
| 4 | 3 | 132 | 39 | 260 | 50 | 388 | 227 | 516 | 60 | 644 | 244 | 772 | 279 | 900 | 622 |
| 5 | 8 | 133 | 77 | 261 | 94 | 389 | 305 | 517 | 106 | 645 | 352 | 773 | 398 | 901 | 691 |
| 6 | 10 | 134 | 81 | 262 | 104 | 390 | 317 | 518 | 110 | 646 | 378 | 774 | 413 | 902 | 711 |
| 7 | 24 | 135 | 137 | 263 | 166 | 391 | 404 | 519 | 193 | 647 | 477 | 775 | 525 | 903 | 792 |
| 8 | 4 | 136 | 48 | 264 | 53 | 392 | 248 | 520 | 65 | 648 | 270 | 776 | 299 | 904 | 642 |
| 9 | 11 | 137 | 83 | 265 | 105 | 393 | 313 | 521 | 114 | 649 | 373 | 777 | 429 | 905 | 715 |
| 10 | 13 | 138 | 92 | 266 | 118 | 394 | 331 | 522 | 120 | 650 | 397 | 778 | 442 | 906 | 737 |
| 11 | 28 | 139 | 145 | 267 | 184 | 395 | 428 | 523 | 202 | 651 | 489 | 779 | 543 | 907 | 820 |
| 12 | 16 | 140 | 100 | 268 | 128 | 396 | 349 | 524 | 136 | 652 | 419 | 780 | 458 | 908 | 757 |

| | | | | | | | | | | | | | | | |
|---|---|---|---|---|---|---|---|---|---|---|---|---|---|---|---|
| 13 | 32 | 141 | 153 | 269 | 200 | 397 | 444 | 525 | 219 | 653 | 507 | 781 | 569 | 909 | 832 |
| 14 | 35 | 142 | 161 | 270 | 211 | 398 | 462 | 526 | 224 | 654 | 517 | 782 | 577 | 910 | 843 |
| 15 | 76 | 143 | 236 | 271 | 293 | 399 | 568 | 527 | 338 | 655 | 621 | 783 | 689 | 911 | 899 |
| 16 | 5 | 144 | 56 | 272 | 63 | 400 | 261 | 528 | 67 | 656 | 281 | 784 | 336 | 912 | 657 |
| 17 | 12 | 145 | 93 | 273 | 119 | 401 | 347 | 529 | 135 | 657 | 405 | 785 | 450 | 913 | 739 |
| 18 | 14 | 146 | 102 | 274 | 129 | 402 | 356 | 530 | 132 | 658 | 414 | 786 | 472 | 914 | 759 |
| 19 | 31 | 147 | 159 | 275 | 208 | 403 | 451 | 531 | 220 | 659 | 516 | 787 | 581 | 915 | 835 |
| 20 | 19 | 148 | 113 | 276 | 142 | 404 | 368 | 532 | 158 | 660 | 441 | 788 | 493 | 916 | 768 |
| 21 | 38 | 149 | 168 | 277 | 206 | 405 | 467 | 533 | 243 | 661 | 541 | 789 | 600 | 917 | 848 |
| 22 | 47 | 150 | 178 | 278 | 222 | 406 | 483 | 534 | 245 | 662 | 553 | 790 | 602 | 918 | 857 |
| 23 | 80 | 151 | 254 | 279 | 303 | 407 | 586 | 535 | 354 | 663 | 640 | 791 | 700 | 919 | 914 |
| 24 | 21 | 152 | 125 | 280 | 155 | 408 | 391 | 536 | 163 | 664 | 456 | 792 | 504 | 920 | 785 |
| 25 | 46 | 153 | 187 | 281 | 223 | 409 | 491 | 537 | 260 | 665 | 564 | 793 | 618 | 921 | 861 |
| 26 | 42 | 154 | 196 | 282 | 238 | 410 | 511 | 538 | 282 | 666 | 571 | 794 | 636 | 922 | 872 |
| 27 | 87 | 155 | 266 | 283 | 311 | 411 | 595 | 539 | 370 | 667 | 669 | 795 | 721 | 923 | 924 |
| 28 | 57 | 156 | 213 | 284 | 253 | 412 | 526 | 540 | 301 | 668 | 597 | 796 | 646 | 924 | 887 |
| 29 | 95 | 157 | 277 | 285 | 330 | 413 | 612 | 541 | 393 | 669 | 683 | 797 | 741 | 925 | 932 |
| 30 | 101 | 158 | 298 | 286 | 339 | 414 | 627 | 542 | 408 | 670 | 703 | 798 | 751 | 926 | 941 |
| 31 | 167 | 159 | 394 | 287 | 432 | 415 | 731 | 543 | 532 | 671 | 779 | 799 | 826 | 927 | 977 |
| 32 | 6 | 160 | 62 | 288 | 66 | 416 | 295 | 544 | 70 | 672 | 316 | 800 | 360 | 928 | 686 |
| 33 | 17 | 161 | 107 | 289 | 139 | 417 | 365 | 545 | 156 | 673 | 430 | 801 | 499 | 929 | 763 |
| 34 | 20 | 162 | 122 | 290 | 152 | 418 | 388 | 546 | 157 | 674 | 438 | 802 | 502 | 930 | 782 |
| 35 | 40 | 163 | 175 | 291 | 209 | 419 | 482 | 547 | 246 | 675 | 556 | 803 | 601 | 931 | 858 |
| 36 | 23 | 164 | 127 | 292 | 164 | 420 | 395 | 548 | 179 | 676 | 474 | 804 | 538 | 932 | 789 |
| 37 | 45 | 165 | 189 | 293 | 226 | 421 | 501 | 549 | 280 | 677 | 575 | 805 | 623 | 933 | 869 |
| 38 | 51 | 166 | 201 | 294 | 241 | 422 | 514 | 550 | 287 | 678 | 572 | 806 | 637 | 934 | 875 |
| 39 | 89 | 167 | 274 | 295 | 323 | 423 | 609 | 551 | 383 | 679 | 679 | 807 | 736 | 935 | 927 |
| 40 | 29 | 168 | 144 | 296 | 174 | 424 | 427 | 552 | 194 | 680 | 492 | 808 | 542 | 936 | 815 |
| 41 | 55 | 169 | 207 | 297 | 249 | 425 | 521 | 553 | 302 | 681 | 591 | 809 | 643 | 937 | 883 |
| 42 | 59 | 170 | 217 | 298 | 262 | 426 | 533 | 554 | 318 | 682 | 603 | 810 | 655 | 938 | 891 |
| 43 | 96 | 171 | 286 | 299 | 345 | 427 | 624 | 555 | 424 | 683 | 698 | 811 | 743 | 939 | 937 |
| 44 | 69 | 172 | 232 | 300 | 267 | 428 | 558 | 556 | 319 | 684 | 630 | 812 | 663 | 940 | 897 |
| 45 | 108 | 173 | 306 | 301 | 355 | 429 | 648 | 557 | 422 | 685 | 716 | 813 | 764 | 941 | 945 |
| 46 | 115 | 174 | 314 | 302 | 375 | 430 | 666 | 558 | 440 | 686 | 725 | 814 | 773 | 942 | 951 |
| 47 | 177 | 175 | 416 | 303 | 468 | 431 | 755 | 559 | 536 | 687 | 805 | 815 | 846 | 943 | 983 |
| 48 | 34 | 176 | 160 | 304 | 183 | 432 | 445 | 560 | 203 | 688 | 509 | 816 | 548 | 944 | 839 |
| 49 | 61 | 177 | 221 | 305 | 265 | 433 | 546 | 561 | 321 | 689 | 617 | 817 | 661 | 945 | 895 |
| 50 | 73 | 178 | 240 | 306 | 289 | 434 | 574 | 562 | 341 | 690 | 633 | 818 | 681 | 946 | 900 |

| | | | | | | | | | | | | | | | |
|---|---|---|---|---|---|---|---|---|---|---|---|---|---|---|---|
| 51 | 112 | 179 | 309 | 307 | 363 | 435 | 662 | 563 | 437 | 691 | 717 | 819 | 766 | 947 | 947 |
| 52 | 75 | 180 | 256 | 308 | 292 | 436 | 587 | 564 | 359 | 692 | 650 | 820 | 696 | 948 | 910 |
| 53 | 123 | 181 | 322 | 309 | 387 | 437 | 673 | 565 | 455 | 693 | 740 | 821 | 784 | 949 | 955 |
| 54 | 130 | 182 | 340 | 310 | 399 | 438 | 693 | 566 | 476 | 694 | 747 | 822 | 797 | 950 | 960 |
| 55 | 190 | 183 | 433 | 311 | 484 | 439 | 777 | 567 | 562 | 695 | 825 | 823 | 864 | 951 | 989 |
| 56 | 86 | 184 | 272 | 312 | 315 | 440 | 604 | 568 | 371 | 696 | 659 | 824 | 718 | 952 | 921 |
| 57 | 133 | 185 | 348 | 313 | 406 | 441 | 701 | 569 | 469 | 697 | 753 | 825 | 801 | 953 | 965 |
| 58 | 143 | 186 | 367 | 314 | 423 | 442 | 706 | 570 | 495 | 698 | 770 | 826 | 811 | 954 | 968 |
| 59 | 210 | 187 | 453 | 315 | 518 | 443 | 800 | 571 | 579 | 699 | 837 | 827 | 876 | 955 | 995 |
| 60 | 148 | 188 | 382 | 316 | 446 | 444 | 726 | 572 | 497 | 700 | 786 | 828 | 828 | 956 | 973 |
| 61 | 218 | 189 | 471 | 317 | 530 | 445 | 804 | 573 | 599 | 701 | 852 | 829 | 889 | 957 | 998 |
| 62 | 235 | 190 | 505 | 318 | 555 | 446 | 813 | 574 | 613 | 702 | 863 | 830 | 903 | 958 | 1000 |
| 63 | 327 | 191 | 619 | 319 | 665 | 447 | 881 | 575 | 735 | 703 | 925 | 831 | 949 | 959 | 1014 |
| 64 | 9 | 192 | 72 | 320 | 78 | 448 | 324 | 576 | 109 | 704 | 337 | 832 | 376 | 960 | 733 |
| 65 | 22 | 193 | 124 | 321 | 169 | 449 | 389 | 577 | 171 | 705 | 463 | 833 | 537 | 961 | 790 |
| 66 | 26 | 194 | 140 | 322 | 170 | 450 | 418 | 578 | 185 | 706 | 479 | 834 | 540 | 962 | 814 |
| 67 | 54 | 195 | 205 | 323 | 251 | 451 | 523 | 579 | 294 | 707 | 598 | 835 | 641 | 963 | 882 |
| 68 | 30 | 196 | 151 | 324 | 181 | 452 | 443 | 580 | 204 | 708 | 485 | 836 | 549 | 964 | 831 |
| 69 | 58 | 197 | 215 | 325 | 258 | 453 | 534 | 581 | 328 | 709 | 605 | 837 | 652 | 965 | 893 |
| 70 | 64 | 198 | 231 | 326 | 276 | 454 | 554 | 582 | 335 | 710 | 626 | 838 | 668 | 966 | 896 |
| 71 | 103 | 199 | 308 | 327 | 361 | 455 | 649 | 583 | 426 | 711 | 712 | 839 | 762 | 967 | 943 |
| 72 | 36 | 200 | 165 | 328 | 191 | 456 | 465 | 584 | 229 | 712 | 539 | 840 | 576 | 968 | 853 |
| 73 | 71 | 201 | 234 | 329 | 288 | 457 | 567 | 585 | 343 | 713 | 631 | 841 | 680 | 969 | 898 |
| 74 | 74 | 202 | 252 | 330 | 285 | 458 | 584 | 586 | 351 | 714 | 644 | 842 | 692 | 970 | 907 |
| 75 | 116 | 203 | 320 | 331 | 386 | 459 | 672 | 587 | 454 | 715 | 738 | 843 | 774 | 971 | 952 |
| 76 | 82 | 204 | 263 | 332 | 304 | 460 | 592 | 588 | 377 | 716 | 653 | 844 | 713 | 972 | 917 |
| 77 | 126 | 205 | 344 | 333 | 400 | 461 | 678 | 589 | 475 | 717 | 744 | 845 | 793 | 973 | 957 |
| 78 | 138 | 206 | 358 | 334 | 410 | 462 | 704 | 590 | 500 | 718 | 765 | 846 | 808 | 974 | 966 |
| 79 | 197 | 207 | 449 | 335 | 513 | 463 | 780 | 591 | 570 | 719 | 833 | 847 | 874 | 975 | 992 |
| 80 | 44 | 208 | 180 | 336 | 237 | 464 | 498 | 592 | 250 | 720 | 547 | 848 | 629 | 976 | 859 |
| 81 | 79 | 209 | 255 | 337 | 297 | 465 | 588 | 593 | 353 | 721 | 651 | 849 | 697 | 977 | 911 |
| 82 | 84 | 210 | 268 | 338 | 326 | 466 | 606 | 594 | 372 | 722 | 658 | 850 | 714 | 978 | 918 |
| 83 | 131 | 211 | 346 | 339 | 403 | 467 | 694 | 595 | 470 | 723 | 748 | 851 | 798 | 979 | 961 |
| 84 | 91 | 212 | 284 | 340 | 329 | 468 | 614 | 596 | 396 | 724 | 682 | 852 | 724 | 980 | 930 |
| 85 | 141 | 213 | 366 | 341 | 420 | 469 | 705 | 597 | 496 | 725 | 769 | 853 | 817 | 981 | 967 |
| 86 | 147 | 214 | 381 | 342 | 436 | 470 | 723 | 598 | 487 | 726 | 781 | 854 | 827 | 982 | 972 |
| 87 | 214 | 215 | 473 | 343 | 528 | 471 | 803 | 599 | 594 | 727 | 847 | 855 | 886 | 983 | 997 |
| 88 | 99 | 216 | 296 | 344 | 357 | 472 | 638 | 600 | 425 | 728 | 702 | 856 | 760 | 984 | 938 |

| | | | | | | | | | | | | | | | |
|---|---|---|---|---|---|---|---|---|---|---|---|---|---|---|---|
| 89 | 149 | 217 | 390 | 345 | 447 | 473 | 727 | 601 | 488 | 729 | 787 | 857 | 830 | 985 | 974 |
| 90 | 162 | 218 | 407 | 346 | 464 | 474 | 745 | 602 | 506 | 730 | 802 | 858 | 844 | 986 | 979 |
| 91 | 228 | 219 | 486 | 347 | 550 | 475 | 821 | 603 | 615 | 731 | 866 | 859 | 904 | 987 | 1001 |
| 92 | 176 | 220 | 421 | 348 | 481 | 476 | 767 | 604 | 545 | 732 | 812 | 860 | 855 | 988 | 985 |
| 93 | 242 | 221 | 519 | 349 | 573 | 477 | 834 | 605 | 632 | 733 | 877 | 861 | 915 | 989 | 1004 |
| 94 | 259 | 222 | 529 | 350 | 589 | 478 | 845 | 606 | 656 | 734 | 888 | 862 | 920 | 990 | 1006 |
| 95 | 364 | 223 | 639 | 351 | 699 | 479 | 913 | 607 | 752 | 735 | 942 | 863 | 964 | 991 | 1017 |
| 96 | 49 | 224 | 199 | 352 | 264 | 480 | 524 | 608 | 269 | 736 | 565 | 864 | 654 | 992 | 879 |
| 97 | 88 | 225 | 275 | 353 | 325 | 481 | 616 | 609 | 384 | 737 | 687 | 865 | 734 | 993 | 923 |
| 98 | 97 | 226 | 290 | 354 | 334 | 482 | 635 | 610 | 409 | 738 | 690 | 866 | 742 | 994 | 933 |
| 99 | 146 | 227 | 379 | 355 | 431 | 483 | 720 | 611 | 490 | 739 | 772 | 867 | 823 | 995 | 970 |
| 100 | 111 | 228 | 310 | 356 | 362 | 484 | 664 | 612 | 415 | 740 | 710 | 868 | 761 | 996 | 940 |
| 101 | 154 | 229 | 392 | 357 | 452 | 485 | 730 | 613 | 515 | 741 | 791 | 869 | 836 | 997 | 976 |
| 102 | 172 | 230 | 411 | 358 | 466 | 486 | 750 | 614 | 527 | 742 | 807 | 870 | 849 | 998 | 981 |
| 103 | 239 | 231 | 510 | 359 | 561 | 487 | 824 | 615 | 625 | 743 | 871 | 871 | 906 | 999 | 1003 |
| 104 | 121 | 232 | 332 | 360 | 380 | 488 | 676 | 616 | 439 | 744 | 722 | 872 | 783 | 1000 | 950 |
| 105 | 173 | 233 | 412 | 361 | 478 | 489 | 754 | 617 | 544 | 745 | 810 | 873 | 851 | 1001 | 982 |
| 106 | 186 | 234 | 434 | 362 | 494 | 490 | 771 | 618 | 563 | 746 | 822 | 874 | 862 | 1002 | 986 |
| 107 | 257 | 235 | 522 | 363 | 582 | 491 | 842 | 619 | 645 | 747 | 884 | 875 | 916 | 1003 | 1005 |
| 108 | 198 | 236 | 459 | 364 | 512 | 492 | 788 | 620 | 580 | 748 | 838 | 876 | 873 | 1004 | 991 |
| 109 | 271 | 237 | 535 | 365 | 596 | 493 | 850 | 621 | 667 | 749 | 894 | 877 | 928 | 1005 | 1007 |
| 110 | 278 | 238 | 560 | 366 | 610 | 494 | 865 | 622 | 675 | 750 | 908 | 878 | 934 | 1006 | 1010 |
| 111 | 369 | 239 | 670 | 367 | 708 | 495 | 926 | 623 | 775 | 751 | 953 | 879 | 971 | 1007 | 1018 |
| 112 | 134 | 240 | 350 | 368 | 402 | 496 | 684 | 624 | 457 | 752 | 758 | 880 | 795 | 1008 | 958 |
| 113 | 192 | 241 | 448 | 369 | 503 | 497 | 776 | 625 | 559 | 753 | 829 | 881 | 868 | 1009 | 987 |
| 114 | 212 | 242 | 461 | 370 | 520 | 498 | 794 | 626 | 578 | 754 | 841 | 882 | 880 | 1010 | 993 |
| 115 | 273 | 243 | 552 | 371 | 608 | 499 | 860 | 627 | 674 | 755 | 901 | 883 | 929 | 1011 | 1008 |
| 116 | 216 | 244 | 480 | 372 | 531 | 500 | 809 | 628 | 607 | 756 | 856 | 884 | 890 | 1012 | 996 |
| 117 | 283 | 245 | 583 | 373 | 620 | 501 | 870 | 629 | 685 | 757 | 912 | 885 | 936 | 1013 | 1011 |
| 118 | 300 | 246 | 590 | 374 | 647 | 502 | 878 | 630 | 709 | 758 | 919 | 886 | 944 | 1014 | 1012 |
| 119 | 401 | 247 | 695 | 375 | 732 | 503 | 935 | 631 | 799 | 759 | 962 | 887 | 978 | 1015 | 1019 |
| 120 | 233 | 248 | 508 | 376 | 557 | 504 | 818 | 632 | 634 | 760 | 867 | 888 | 902 | 1016 | 999 |
| 121 | 307 | 249 | 593 | 377 | 660 | 505 | 885 | 633 | 719 | 761 | 922 | 889 | 948 | 1017 | 1013 |
| 122 | 312 | 250 | 611 | 378 | 671 | 506 | 892 | 634 | 729 | 762 | 931 | 890 | 956 | 1018 | 1015 |
| 123 | 417 | 251 | 707 | 379 | 756 | 507 | 946 | 635 | 806 | 763 | 969 | 891 | 984 | 1019 | 1020 |
| 124 | 333 | 252 | 628 | 380 | 677 | 508 | 909 | 636 | 749 | 764 | 939 | 892 | 963 | 1020 | 1016 |
| 125 | 435 | 253 | 728 | 381 | 778 | 509 | 954 | 637 | 819 | 765 | 975 | 893 | 990 | 1021 | 1021 |
| 126 | 460 | 254 | 746 | 382 | 796 | 510 | 959 | 638 | 840 | 766 | 980 | 894 | 994 | 1022 | 1022 |

| 127 | 585 | 255 | 816 | 383 | 854 | 511 | 988 | 639 | 905 | 767 | 1002 | 895 | 1009 | 1023 | 1023 |
|-----|-----|-----|-----|-----|-----|-----|-----|-----|-----|-----|------|-----|------|------|------|

Sequence Z22, having a sequence length of 512:
[0, 1, 2, 7, 3, 8, 10, 24, 4, 11, 13, 27, 16, 31, 34, 69, 5, 12, 14, 30, 19, 37, 45, 73, 21, 44, 41, 80, 54, 88, 93, 145, 6, 17, 20, 39, 23, 43, 49, 82, 28, 52, 56, 89, 63, 99, 103, 154, 33, 57, 66, 101, 68, 109, 116, 165, 79, 118, 126, 179, 131, 187, 198, 268, 9, 22, 26, 51, 29, 55, 60, 95, 35, 64, 67, 104, 75, 112, 121, 169, 42, 72, 77, 117, 84, 124, 130, 183, 91, 132, 141, 193, 153, 205, 216, 291, 47, 81, 90, 129, 100, 136, 149, 202, 107, 150, 161, 214, 170, 225, 232, 296, 119, 167, 181, 227, 185, 233, 247, 313, 196, 252, 257, 323, 273, 334, 347, 407, 15, 25, 32, 62, 38, 70, 74, 120, 46, 76, 85, 128, 92, 135, 140, 199, 53, 86, 94, 138, 102, 146, 155, 211, 111, 162, 168, 222, 182, 231, 246, 309, 58, 98, 108, 152, 113, 164, 173, 228, 127, 176, 186, 236, 195, 251, 259, 322, 139, 188, 203, 254, 213, 263, 276, 332, 226, 281, 294, 345, 301, 355, 369, 426, 65, 110, 123, 174, 133, 184, 194, 253, 143, 197, 209, 262, 219, 277, 287, 342, 156, 212, 224, 279, 234, 293, 300, 356, 244, 306, 318, 363, 326, 377, 385, 433, 171, 229, 239, 298, 255, 308, 320, 371, 272, 321, 333, 380, 346, 390, 398, 442, 283, 341, 348, 393, 358, 405, 412, 452, 370, 414, 422, 458, 430, 464, 469, 488, 18, 36, 40, 83, 48, 87, 96, 144, 50, 97, 105, 160, 114, 172, 180, 242, 59, 106, 115, 177, 125, 175, 189, 248, 137, 190, 201, 256, 210, 270, 275, 331, 61, 122, 134, 178, 142, 191, 204, 264, 151, 207, 218, 278, 223, 284, 297, 354, 159, 221, 238, 290, 241, 303, 311, 362, 260, 317, 327, 376, 339, 386, 395, 440, 71, 147, 148, 208, 157, 215, 230, 288, 166, 237, 235, 302, 249, 312, 319, 374, 200, 245, 267, 315, 269, 325, 335, 384, 286, 340, 350, 392, 359, 402, 411, 453, 220, 266, 274, 330, 289, 344, 352, 399, 299, 357, 365, 404, 373, 416, 421, 459, 314, 368, 378, 419, 387, 427, 434, 467, 396, 437, 443, 473, 447, 478, 482, 496, 78, 158, 163, 240, 192, 250, 261, 316, 206, 258, 271, 329, 282, 337, 349, 401, 217, 280, 285, 343, 295, 353, 361, 408, 307, 364, 372, 415, 383, 423, 429, 466, 243, 292, 304, 360, 310, 367, 375, 420, 328, 379, 388, 428, 397, 435, 441, 472, 338, 391, 403, 438, 409, 445, 450, 477, 417, 454, 457, 483, 462, 485, 487, 501, 265, 305, 324, 381, 336, 389, 394, 436, 351, 400, 406, 444, 413, 448, 455, 479, 366, 410, 418, 451, 424, 456, 461, 484, 432, 463, 468, 490, 474, 492, 494, 505, 382, 425, 431, 460, 439, 465, 470, 491, 446, 471, 475, 493, 480, 495, 498, 506, 449, 476, 481, 497, 486, 499, 500, 507, 489, 502, 503, 508, 504, 509, 510, 511]

Table Z22, having a sequence length of 512:

| Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability |
|---|---|---|---|---|---|---|---|---|---|---|---|---|---|---|---|

| | | | | | | | | | | | | | | | |
|---|---|---|---|---|---|---|---|---|---|---|---|---|---|---|---|
| 0 | 0 | 64 | 9 | 128 | 15 | 192 | 65 | 256 | 18 | 320 | 71 | 384 | 78 | 448 | 265 |
| 1 | 1 | 65 | 22 | 129 | 25 | 193 | 110 | 257 | 36 | 321 | 147 | 385 | 158 | 449 | 305 |
| 2 | 2 | 66 | 26 | 130 | 32 | 194 | 123 | 258 | 40 | 322 | 148 | 386 | 163 | 450 | 324 |
| 3 | 7 | 67 | 51 | 131 | 62 | 195 | 174 | 259 | 83 | 323 | 208 | 387 | 240 | 451 | 381 |
| 4 | 3 | 68 | 29 | 132 | 38 | 196 | 133 | 260 | 48 | 324 | 157 | 388 | 192 | 452 | 336 |
| 5 | 8 | 69 | 55 | 133 | 70 | 197 | 184 | 261 | 87 | 325 | 215 | 389 | 250 | 453 | 389 |
| 6 | 10 | 70 | 60 | 134 | 74 | 198 | 194 | 262 | 96 | 326 | 230 | 390 | 261 | 454 | 394 |
| 7 | 24 | 71 | 95 | 135 | 120 | 199 | 253 | 263 | 144 | 327 | 288 | 391 | 316 | 455 | 436 |
| 8 | 4 | 72 | 35 | 136 | 46 | 200 | 143 | 264 | 50 | 328 | 166 | 392 | 206 | 456 | 351 |
| 9 | 11 | 73 | 64 | 137 | 76 | 201 | 197 | 265 | 97 | 329 | 237 | 393 | 258 | 457 | 400 |
| 10 | 13 | 74 | 67 | 138 | 85 | 202 | 209 | 266 | 105 | 330 | 235 | 394 | 271 | 458 | 406 |
| 11 | 27 | 75 | 104 | 139 | 128 | 203 | 262 | 267 | 160 | 331 | 302 | 395 | 329 | 459 | 444 |
| 12 | 16 | 76 | 75 | 140 | 92 | 204 | 219 | 268 | 114 | 332 | 249 | 396 | 282 | 460 | 413 |
| 13 | 31 | 77 | 112 | 141 | 135 | 205 | 277 | 269 | 172 | 333 | 312 | 397 | 337 | 461 | 448 |
| 14 | 34 | 78 | 121 | 142 | 140 | 206 | 287 | 270 | 180 | 334 | 319 | 398 | 349 | 462 | 455 |
| 15 | 69 | 79 | 169 | 143 | 199 | 207 | 342 | 271 | 242 | 335 | 374 | 399 | 401 | 463 | 479 |
| 16 | 5 | 80 | 42 | 144 | 53 | 208 | 156 | 272 | 59 | 336 | 200 | 400 | 217 | 464 | 366 |
| 17 | 12 | 81 | 72 | 145 | 86 | 209 | 212 | 273 | 106 | 337 | 245 | 401 | 280 | 465 | 410 |
| 18 | 14 | 82 | 77 | 146 | 94 | 210 | 224 | 274 | 115 | 338 | 267 | 402 | 285 | 466 | 418 |
| 19 | 30 | 83 | 117 | 147 | 138 | 211 | 279 | 275 | 177 | 339 | 315 | 403 | 343 | 467 | 451 |
| 20 | 19 | 84 | 84 | 148 | 102 | 212 | 234 | 276 | 125 | 340 | 269 | 404 | 295 | 468 | 424 |
| 21 | 37 | 85 | 124 | 149 | 146 | 213 | 293 | 277 | 175 | 341 | 325 | 405 | 353 | 469 | 456 |
| 22 | 45 | 86 | 130 | 150 | 155 | 214 | 300 | 278 | 189 | 342 | 335 | 406 | 361 | 470 | 461 |
| 23 | 73 | 87 | 183 | 151 | 211 | 215 | 356 | 279 | 248 | 343 | 384 | 407 | 408 | 471 | 484 |
| 24 | 21 | 88 | 91 | 152 | 111 | 216 | 244 | 280 | 137 | 344 | 286 | 408 | 307 | 472 | 432 |
| 25 | 44 | 89 | 132 | 153 | 162 | 217 | 306 | 281 | 190 | 345 | 340 | 409 | 364 | 473 | 463 |
| 26 | 41 | 90 | 141 | 154 | 168 | 218 | 318 | 282 | 201 | 346 | 350 | 410 | 372 | 474 | 468 |
| 27 | 80 | 91 | 193 | 155 | 222 | 219 | 363 | 283 | 256 | 347 | 392 | 411 | 415 | 475 | 490 |
| 28 | 54 | 92 | 153 | 156 | 182 | 220 | 326 | 284 | 210 | 348 | 359 | 412 | 383 | 476 | 474 |
| 29 | 88 | 93 | 205 | 157 | 231 | 221 | 377 | 285 | 270 | 349 | 402 | 413 | 423 | 477 | 492 |
| 30 | 93 | 94 | 216 | 158 | 246 | 222 | 385 | 286 | 275 | 350 | 411 | 414 | 429 | 478 | 494 |
| 31 | 145 | 95 | 291 | 159 | 309 | 223 | 433 | 287 | 331 | 351 | 453 | 415 | 466 | 479 | 505 |
| 32 | 6 | 96 | 47 | 160 | 58 | 224 | 171 | 288 | 61 | 352 | 220 | 416 | 243 | 480 | 382 |
| 33 | 17 | 97 | 81 | 161 | 98 | 225 | 229 | 289 | 122 | 353 | 266 | 417 | 292 | 481 | 425 |
| 34 | 20 | 98 | 90 | 162 | 108 | 226 | 239 | 290 | 134 | 354 | 274 | 418 | 304 | 482 | 431 |
| 35 | 39 | 99 | 129 | 163 | 152 | 227 | 298 | 291 | 178 | 355 | 330 | 419 | 360 | 483 | 460 |
| 36 | 23 | 100 | 100 | 164 | 113 | 228 | 255 | 292 | 142 | 356 | 289 | 420 | 310 | 484 | 439 |
| 37 | 43 | 101 | 136 | 165 | 164 | 229 | 308 | 293 | 191 | 357 | 344 | 421 | 367 | 485 | 465 |

| | | | | | | | | | | | | | | | |
|---|---|---|---|---|---|---|---|---|---|---|---|---|---|---|---|
| 38 | 49 | 102 | 149 | 166 | 173 | 230 | 320 | 294 | 204 | 358 | 352 | 422 | 375 | 486 | 470 |
| 39 | 82 | 103 | 202 | 167 | 228 | 231 | 371 | 295 | 264 | 359 | 399 | 423 | 420 | 487 | 491 |
| 40 | 28 | 104 | 107 | 168 | 127 | 232 | 272 | 296 | 151 | 360 | 299 | 424 | 328 | 488 | 446 |
| 41 | 52 | 105 | 150 | 169 | 176 | 233 | 321 | 297 | 207 | 361 | 357 | 425 | 379 | 489 | 471 |
| 42 | 56 | 106 | 161 | 170 | 186 | 234 | 333 | 298 | 218 | 362 | 365 | 426 | 388 | 490 | 475 |
| 43 | 89 | 107 | 214 | 171 | 236 | 235 | 380 | 299 | 278 | 363 | 404 | 427 | 428 | 491 | 493 |
| 44 | 63 | 108 | 170 | 172 | 195 | 236 | 346 | 300 | 223 | 364 | 373 | 428 | 397 | 492 | 480 |
| 45 | 99 | 109 | 225 | 173 | 251 | 237 | 390 | 301 | 284 | 365 | 416 | 429 | 435 | 493 | 495 |
| 46 | 103 | 110 | 232 | 174 | 259 | 238 | 398 | 302 | 297 | 366 | 421 | 430 | 441 | 494 | 498 |
| 47 | 154 | 111 | 296 | 175 | 322 | 239 | 442 | 303 | 354 | 367 | 459 | 431 | 472 | 495 | 506 |
| 48 | 33 | 112 | 119 | 176 | 139 | 240 | 283 | 304 | 159 | 368 | 314 | 432 | 338 | 496 | 449 |
| 49 | 57 | 113 | 167 | 177 | 188 | 241 | 341 | 305 | 221 | 369 | 368 | 433 | 391 | 497 | 476 |
| 50 | 66 | 114 | 181 | 178 | 203 | 242 | 348 | 306 | 238 | 370 | 378 | 434 | 403 | 498 | 481 |
| 51 | 101 | 115 | 227 | 179 | 254 | 243 | 393 | 307 | 290 | 371 | 419 | 435 | 438 | 499 | 497 |
| 52 | 68 | 116 | 185 | 180 | 213 | 244 | 358 | 308 | 241 | 372 | 387 | 436 | 409 | 500 | 486 |
| 53 | 109 | 117 | 233 | 181 | 263 | 245 | 405 | 309 | 303 | 373 | 427 | 437 | 445 | 501 | 499 |
| 54 | 116 | 118 | 247 | 182 | 276 | 246 | 412 | 310 | 311 | 374 | 434 | 438 | 450 | 502 | 500 |
| 55 | 165 | 119 | 313 | 183 | 332 | 247 | 452 | 311 | 362 | 375 | 467 | 439 | 477 | 503 | 507 |
| 56 | 79 | 120 | 196 | 184 | 226 | 248 | 370 | 312 | 260 | 376 | 396 | 440 | 417 | 504 | 489 |
| 57 | 118 | 121 | 252 | 185 | 281 | 249 | 414 | 313 | 317 | 377 | 437 | 441 | 454 | 505 | 502 |
| 58 | 126 | 122 | 257 | 186 | 294 | 250 | 422 | 314 | 327 | 378 | 443 | 442 | 457 | 506 | 503 |
| 59 | 179 | 123 | 323 | 187 | 345 | 251 | 458 | 315 | 376 | 379 | 473 | 443 | 483 | 507 | 508 |
| 60 | 131 | 124 | 273 | 188 | 301 | 252 | 430 | 316 | 339 | 380 | 447 | 444 | 462 | 508 | 504 |
| 61 | 187 | 125 | 334 | 189 | 355 | 253 | 464 | 317 | 386 | 381 | 478 | 445 | 485 | 509 | 509 |
| 62 | 198 | 126 | 347 | 190 | 369 | 254 | 469 | 318 | 395 | 382 | 482 | 446 | 487 | 510 | 510 |
| 63 | 268 | 127 | 407 | 191 | 426 | 255 | 488 | 319 | 440 | 383 | 496 | 447 | 501 | 511 | 511 |

Sequence Z23, having a sequence length of 256:
[0, 1, 2, 7, 3, 8, 10, 23, 4, 11, 13, 26, 16, 30, 33, 62, 5, 12, 14, 29, 18, 35, 42, 65, 20, 41, 38, 71, 49, 77, 82, 122, 6, 17, 19, 37, 22, 40, 45, 73, 27, 47, 51, 78, 56, 86, 90, 128, 32, 52, 59, 88, 61, 94, 99, 134, 70, 101, 107, 143, 112, 150, 157, 194, 9, 21, 25, 46, 28, 50, 54, 84, 34, 57, 60, 91, 67, 97, 104, 137, 39, 64, 69, 100, 74, 106, 111, 146, 80, 113, 120, 152, 127, 161, 167, 203, 44, 72, 79, 110, 87, 116, 124, 159, 92, 125, 131, 166, 138, 171, 177, 206, 102, 135, 144, 173, 148, 178, 184, 213, 155, 186, 190, 218, 196, 222, 227, 243, 15, 24, 31, 55, 36, 63, 66, 103, 43, 68, 75, 109, 81, 115, 119, 158, 48, 76, 83, 117, 89, 123, 129, 163, 96, 132, 136, 169, 145, 176, 183, 212, 53, 85, 93, 126, 98, 133, 140, 174, 108, 142, 149, 180, 154, 185, 191, 217, 118, 151, 160, 188, 165, 193, 197, 220, 172, 200, 205, 225, 209, 229, 233, 247, 58, 95, 105, 141, 114, 147, 153, 187, 121, 156, 162, 192, 168, 198, 202, 224, 130, 164, 170, 199, 179, 204, 208, 230, 182, 210, 214, 232, 219, 236, 238, 249, 139, 175, 181, 207, 189, 211, 215, 235, 195, 216, 221, 237, 226, 239, 241, 250, 201, 223, 228, 240, 231, 242, 244, 251, 234, 245, 246, 252, 248, 253, 254, 255]

Table Z23, having a sequence length of 256:

| Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability |
|---|---|---|---|---|---|---|---|---|---|---|---|---|---|---|---|
| 0 | 0 | 32 | 6 | 64 | 9 | 96 | 44 | 128 | 15 | 160 | 53 | 192 | 58 | 224 | 139 |
| 1 | 1 | 33 | 17 | 65 | 21 | 97 | 72 | 129 | 24 | 161 | 85 | 193 | 95 | 225 | 175 |
| 2 | 2 | 34 | 19 | 66 | 25 | 98 | 79 | 130 | 31 | 162 | 93 | 194 | 105 | 226 | 181 |
| 3 | 7 | 35 | 37 | 67 | 46 | 99 | 110 | 131 | 55 | 163 | 126 | 195 | 141 | 227 | 207 |
| 4 | 3 | 36 | 22 | 68 | 28 | 100 | 87 | 132 | 36 | 164 | 98 | 196 | 114 | 228 | 189 |
| 5 | 8 | 37 | 40 | 69 | 50 | 101 | 116 | 133 | 63 | 165 | 133 | 197 | 147 | 229 | 211 |
| 6 | 10 | 38 | 45 | 70 | 54 | 102 | 124 | 134 | 66 | 166 | 140 | 198 | 153 | 230 | 215 |
| 7 | 23 | 39 | 73 | 71 | 84 | 103 | 159 | 135 | 103 | 167 | 174 | 199 | 187 | 231 | 235 |
| 8 | 4 | 40 | 27 | 72 | 34 | 104 | 92 | 136 | 43 | 168 | 108 | 200 | 121 | 232 | 195 |
| 9 | 11 | 41 | 47 | 73 | 57 | 105 | 125 | 137 | 68 | 169 | 142 | 201 | 156 | 233 | 216 |
| 10 | 13 | 42 | 51 | 74 | 60 | 106 | 131 | 138 | 75 | 170 | 149 | 202 | 162 | 234 | 221 |
| 11 | 26 | 43 | 78 | 75 | 91 | 107 | 166 | 139 | 109 | 171 | 180 | 203 | 192 | 235 | 237 |
| 12 | 16 | 44 | 56 | 76 | 67 | 108 | 138 | 140 | 81 | 172 | 154 | 204 | 168 | 236 | 226 |
| 13 | 30 | 45 | 86 | 77 | 97 | 109 | 171 | 141 | 115 | 173 | 185 | 205 | 198 | 237 | 239 |
| 14 | 33 | 46 | 90 | 78 | 104 | 110 | 177 | 142 | 119 | 174 | 191 | 206 | 202 | 238 | 241 |
| 15 | 62 | 47 | 128 | 79 | 137 | 111 | 206 | 143 | 158 | 175 | 217 | 207 | 224 | 239 | 250 |
| 16 | 5 | 48 | 32 | 80 | 39 | 112 | 102 | 144 | 48 | 176 | 118 | 208 | 130 | 240 | 201 |
| 17 | 12 | 49 | 52 | 81 | 64 | 113 | 135 | 145 | 76 | 177 | 151 | 209 | 164 | 241 | 223 |
| 18 | 14 | 50 | 59 | 82 | 69 | 114 | 144 | 146 | 83 | 178 | 160 | 210 | 170 | 242 | 228 |
| 19 | 29 | 51 | 88 | 83 | 100 | 115 | 173 | 147 | 117 | 179 | 188 | 211 | 199 | 243 | 240 |
| 20 | 18 | 52 | 61 | 84 | 74 | 116 | 148 | 148 | 89 | 180 | 165 | 212 | 179 | 244 | 231 |
| 21 | 35 | 53 | 94 | 85 | 106 | 117 | 178 | 149 | 123 | 181 | 193 | 213 | 204 | 245 | 242 |
| 22 | 42 | 54 | 99 | 86 | 111 | 118 | 184 | 150 | 129 | 182 | 197 | 214 | 208 | 246 | 244 |
| 23 | 65 | 55 | 134 | 87 | 146 | 119 | 213 | 151 | 163 | 183 | 220 | 215 | 230 | 247 | 251 |
| 24 | 20 | 56 | 70 | 88 | 80 | 120 | 155 | 152 | 96 | 184 | 172 | 216 | 182 | 248 | 234 |
| 25 | 41 | 57 | 101 | 89 | 113 | 121 | 186 | 153 | 132 | 185 | 200 | 217 | 210 | 249 | 245 |
| 26 | 38 | 58 | 107 | 90 | 120 | 122 | 190 | 154 | 136 | 186 | 205 | 218 | 214 | 250 | 246 |
| 27 | 71 | 59 | 143 | 91 | 152 | 123 | 218 | 155 | 169 | 187 | 225 | 219 | 232 | 251 | 252 |

| 28 | 49 | 60 | 112 | 92 | 127 | 124 | 196 | 156 | 145 | 188 | 209 | 220 | 219 | 252 | 248 |
| 29 | 77 | 61 | 150 | 93 | 161 | 125 | 222 | 157 | 176 | 189 | 229 | 221 | 236 | 253 | 253 |
| 30 | 82 | 62 | 157 | 94 | 167 | 126 | 227 | 158 | 183 | 190 | 233 | 222 | 238 | 254 | 254 |
| 31 | 122 | 63 | 194 | 95 | 203 | 127 | 243 | 159 | 212 | 191 | 247 | 223 | 249 | 255 | 255 |

Sequence Z24, having a sequence length of 128:
[0, 1, 2, 7, 3, 8, 10, 22, 4, 11, 13, 24, 15, 28, 30, 53, 5, 12, 14, 27, 17, 32, 38, 55, 19, 37, 34, 59, 43, 63, 67, 90, 6, 16, 18, 33, 21, 36, 40, 61, 25, 42, 45, 64, 48, 69, 72, 94, 29, 46, 50, 71, 52, 75, 77, 96, 58, 79, 83, 100, 86, 104, 107, 119, 9, 20, 23, 41, 26, 44, 47, 68, 31, 49, 51, 73, 56, 76, 81, 98, 35, 54, 57, 78, 62, 82, 85, 102, 66, 87, 89, 105, 93, 109, 111, 121, 39, 60, 65, 84, 70, 88, 91, 108, 74, 92, 95, 110, 99, 112, 114, 122, 80, 97, 101, 113, 103, 115, 116, 123, 106, 117, 118, 124, 120, 125, 126, 127]

## Table Z24, having a length of 128:

| Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability |
|---|---|---|---|---|---|---|---|---|---|---|---|---|---|---|---|
| 0 | 0 | 16 | 5 | 32 | 6 | 48 | 29 | 64 | 9 | 80 | 35 | 96 | 39 | 112 | 80 |
| 1 | 1 | 17 | 12 | 33 | 16 | 49 | 46 | 65 | 20 | 81 | 54 | 97 | 60 | 113 | 97 |
| 2 | 2 | 18 | 14 | 34 | 18 | 50 | 50 | 66 | 23 | 82 | 57 | 98 | 65 | 114 | 101 |
| 3 | 7 | 19 | 27 | 35 | 33 | 51 | 71 | 67 | 41 | 83 | 78 | 99 | 84 | 115 | 113 |
| 4 | 3 | 20 | 17 | 36 | 21 | 52 | 52 | 68 | 26 | 84 | 62 | 100 | 70 | 116 | 103 |
| 5 | 8 | 21 | 32 | 37 | 36 | 53 | 75 | 69 | 44 | 85 | 82 | 101 | 88 | 117 | 115 |
| 6 | 10 | 22 | 38 | 38 | 40 | 54 | 77 | 70 | 47 | 86 | 85 | 102 | 91 | 118 | 116 |
| 7 | 22 | 23 | 55 | 39 | 61 | 55 | 96 | 71 | 68 | 87 | 102 | 103 | 108 | 119 | 123 |
| 8 | 4 | 24 | 19 | 40 | 25 | 56 | 58 | 72 | 31 | 88 | 66 | 104 | 74 | 120 | 106 |
| 9 | 11 | 25 | 37 | 41 | 42 | 57 | 79 | 73 | 49 | 89 | 87 | 105 | 92 | 121 | 117 |
| 10 | 13 | 26 | 34 | 42 | 45 | 58 | 83 | 74 | 51 | 90 | 89 | 106 | 95 | 122 | 118 |
| 11 | 24 | 27 | 59 | 43 | 64 | 59 | 100 | 75 | 73 | 91 | 105 | 107 | 110 | 123 | 124 |
| 12 | 15 | 28 | 43 | 44 | 48 | 60 | 86 | 76 | 56 | 92 | 93 | 108 | 99 | 124 | 120 |
| 13 | 28 | 29 | 63 | 45 | 69 | 61 | 104 | 77 | 76 | 93 | 109 | 109 | 112 | 125 | 125 |
| 14 | 30 | 30 | 67 | 46 | 72 | 62 | 107 | 78 | 81 | 94 | 111 | 110 | 114 | 126 | 126 |
| 15 | 53 | 31 | 90 | 47 | 94 | 63 | 119 | 79 | 98 | 95 | 121 | 111 | 122 | 127 | 127 |

Sequence Z25, having a sequence length of 64:
[0, 1, 2, 7, 3, 8, 9, 20, 4, 10, 12, 21, 14, 24, 26, 41, 5, 11, 13, 23, 16, 27, 32, 42, 18, 31, 29, 44, 35, 46, 48, 57, 6, 15, 17, 28, 19, 30, 33, 45, 22, 34, 36, 47, 38, 49, 51, 58, 25, 37, 39, 50, 40, 52, 53, 59, 43, 54, 55, 60, 56, 61, 62, 63]

Table Z25, having a sequence length of 64:

| Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability |
|---|---|---|---|---|---|---|---|---|---|---|---|---|---|---|---|
| 0 | 0 | 8 | 4 | 16 | 5 | 24 | 18 | 32 | 6 | 40 | 22 | 48 | 25 | 56 | 43 |
| 1 | 1 | 9 | 10 | 17 | 11 | 25 | 31 | 33 | 15 | 41 | 34 | 49 | 37 | 57 | 54 |
| 2 | 2 | 10 | 12 | 18 | 13 | 26 | 29 | 34 | 17 | 42 | 36 | 50 | 39 | 58 | 55 |
| 3 | 7 | 11 | 21 | 19 | 23 | 27 | 44 | 35 | 28 | 43 | 47 | 51 | 50 | 59 | 60 |
| 4 | 3 | 12 | 14 | 20 | 16 | 28 | 35 | 36 | 19 | 44 | 38 | 52 | 40 | 60 | 56 |
| 5 | 8 | 13 | 24 | 21 | 27 | 29 | 46 | 37 | 30 | 45 | 49 | 53 | 52 | 61 | 61 |
| 6 | 9 | 14 | 26 | 22 | 32 | 30 | 48 | 38 | 33 | 46 | 51 | 54 | 53 | 62 | 62 |
| 7 | 20 | 15 | 41 | 23 | 42 | 31 | 57 | 39 | 45 | 47 | 58 | 55 | 59 | 63 | 63 |

Sixth group of sequences (a criterion that considers optimal performance of List 4).

Sequence Q26, having a sequence length of 1024:

[0, 1, 4, 8, 2, 16, 32, 6, 64, 512, 3, 12, 5, 18, 128, 9, 33, 17, 10, 36, 66, 24, 256, 20, 65, 34, 7, 129, 40, 11, 72, 132, 513, 19, 48, 68, 13, 257, 14, 21, 130, 26, 80, 35, 258, 38, 136, 96, 22, 516, 37, 25, 67, 264, 41, 144, 28, 69, 260, 49, 74, 160, 42, 520, 134, 70, 44, 81, 272, 15, 50, 131, 192, 73, 23, 514, 137, 52, 288, 76, 133, 82, 27, 97, 259, 39, 528, 56, 138, 84, 29, 145, 261, 43, 320, 544, 98, 140, 265, 30, 88, 146, 262, 100, 518, 161, 71, 45, 273, 51, 148, 266, 576, 46, 75, 104, 164, 193, 53, 162, 515, 384, 268, 77, 152, 54, 85, 524, 289, 112, 274, 57, 78, 135, 517, 194, 83, 290, 168, 276, 86, 530, 58, 139, 322, 196, 101, 640, 60, 147, 176, 280, 99, 89, 521, 292, 141, 321, 200, 90, 545, 31, 142, 102, 263, 529, 47, 386, 105, 296, 208, 522, 153, 92, 149, 267, 548, 163, 324, 113, 150, 578, 165, 55, 304, 106, 275, 536, 269, 385, 154, 768, 79, 108, 224, 166, 532, 59, 169, 114, 195, 577, 328, 270, 277, 87, 546, 156, 116, 388, 519, 336, 291, 278, 197, 641, 61, 177, 170, 552, 91, 281, 201, 198, 523, 62, 143, 294, 584, 172, 392, 103, 644, 120, 293, 282, 531, 352, 178, 202, 560, 323, 297, 93, 580, 107, 151, 209, 525, 284, 180, 400, 769, 94, 204, 298, 526, 326, 155, 533, 305, 109, 325, 642, 210, 184, 225, 538, 167, 300, 592, 115, 387, 329, 547, 110, 416, 770, 212, 271, 117, 550, 306, 157, 648, 226, 171, 330, 608, 337, 389, 534, 308, 216, 549, 121, 390, 537, 158, 279, 332, 579, 118, 173, 776, 338, 179, 553, 199, 353, 656, 283, 312, 540, 448, 228, 581, 393, 122, 181, 772, 232, 295, 561, 174, 394, 586, 63, 203, 672, 354, 554, 401, 340, 646, 124, 285, 582, 182, 299, 556, 240, 211, 593, 286, 344, 784, 396, 205, 527, 95, 418, 562, 185, 643, 213, 402, 704, 307, 327, 585, 356, 535, 206, 186, 649, 301, 111, 564, 302, 800, 360, 227, 588, 417, 159, 645, 404, 594, 309, 214, 539, 449, 331, 609, 119, 771, 217, 188, 551, 229, 568, 333, 408, 650, 310, 596, 339, 420, 541, 218, 657, 368, 773, 123, 230, 555, 175, 832, 391, 313, 610, 241, 652, 450, 334, 777, 220, 542, 341, 600, 424, 314, 658, 183, 774, 233, 612, 355, 673, 125, 287, 583, 395, 557, 234, 785, 316, 345, 563, 187, 660, 452, 778, 403, 558, 342, 397, 587, 207, 616, 236, 676, 432, 705, 346, 565, 361, 674, 126, 242, 896, 357, 780, 405, 589, 215, 664, 398, 566, 303, 597, 358, 801, 419, 624, 456, 786, 348, 189, 569, 244, 590, 410, 647, 219, 706, 311, 595, 362, 802, 464, 680, 406, 788, 421, 598, 231, 570, 248, 651, 369, 834, 190, 708, 409, 613, 315, 572, 364, 659, 422, 335, 221, 688, 451, 792, 370, 611, 425, 601, 235, 804, 343, 653, 412, 833, 480, 712, 222, 602, 317, 543, 453, 654, 426, 614, 372, 775, 433, 559, 237, 898, 617, 347, 808, 243, 720, 454, 665, 318, 604, 376, 661, 428, 779, 238, 675, 359, 836, 458, 625, 399, 662, 677, 245, 567, 434, 816, 457, 618, 349, 787, 465, 781, 897, 363, 666, 407, 591, 127, 620, 246, 736, 436, 678, 571, 350, 681, 249, 626, 460, 707, 840, 411, 782, 365, 789, 440, 599, 374, 668, 628, 423, 900, 466, 848, 803, 250, 790, 371, 709, 191, 573, 689, 481, 682, 413, 603, 793, 366, 713, 468, 710, 429, 574, 655, 252, 806, 414, 684, 904, 373, 615, 482, 632, 805, 223, 794, 864, 427, 690, 472, 714, 835, 455, 809, 377, 605, 619, 435, 663, 721, 319, 796, 430, 692, 912, 239, 606, 716, 461, 810, 484, 838, 667, 378, 817, 621, 437, 837, 722, 247, 696, 380, 737, 679, 459, 812, 627, 488, 899, 841, 441, 622, 928, 351, 724, 783, 469, 629, 818, 438, 669, 462, 738, 683, 251, 842, 849, 496, 901, 820, 728, 467, 633, 902, 367, 670, 791, 442, 844, 630, 474, 685, 850, 483, 691, 711, 379, 865, 795, 415, 824, 960, 740, 253, 905, 634, 444, 693, 744, 485, 807, 686, 906, 470, 575, 715, 375, 866, 913, 473, 852, 636, 797, 431, 694, 811, 486, 752, 723, 798, 489, 856, 908, 254, 717, 607, 930, 476, 697, 725, 914, 439, 819, 839, 868, 492, 718, 698, 381, 813, 623, 814, 498, 872, 739, 929, 445, 671, 916, 821, 463, 726, 961, 843, 490, 631, 729, 700, 382, 741, 845, 920, 471, 822, 851, 932, 730, 497, 880, 635, 742, 443, 687, 903, 825, 475, 753, 962, 846, 732, 500, 853, 936, 826, 446, 695, 745, 867, 637, 487, 799, 907, 746, 828, 493, 857, 699, 964, 915, 477, 854, 909, 719, 504, 748, 944, 858, 873, 638, 478, 754, 869, 917, 727, 499, 910, 815, 870, 931, 255, 968, 860, 701, 756, 922, 491, 731, 823, 874, 976, 918, 502, 933, 743, 760, 881, 494, 702, 921, 827, 876, 934, 847, 505, 733, 963, 882, 937, 747, 383, 855, 924, 992, 734, 829, 965, 501, 938, 884, 945, 749, 859, 755, 479, 966, 830, 888, 940, 750, 871, 506, 970, 911, 757, 946, 969, 861, 977, 447, 875, 919, 639, 758, 948, 862, 761, 508, 972, 923, 877, 952, 886, 935, 978, 762, 503, 883, 703, 993, 925, 878, 980, 941, 764, 495, 926, 885, 994, 735, 939, 984, 967, 889, 947, 831, 507, 942, 751, 973, 996, 890, 949, 759, 892, 971, 1000, 953, 509, 863, 981, 950, 974, 763, 1008, 979, 879, 954, 986, 995, 891, 927, 510, 765, 956, 997, 982, 887, 985, 943, 998, 1001, 766, 988, 951, 1004, 893, 1010, 957, 975, 511, 1002, 894, 983, 1009, 955, 987, 1012, 958, 999, 1005, 989, 1016, 990, 1011, 767, 1003, 1014, 1006, 1017, 895, 1013, 991, 1018, 959, 1020, 1015, 1007, 1019, 1021, 1022, 1023]

## Table Q26, having a sequence length of 1024:

| Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number |
|---|---|---|---|---|---|---|---|---|---|---|---|---|---|---|---|
| 0 | 0 | 128 | 289 | 256 | 526 | 384 | 609 | 512 | 335 | 640 | 427 | 768 | 492 | 896 | 479 |
| 1 | 1 | 129 | 112 | 257 | 326 | 385 | 119 | 513 | 221 | 641 | 690 | 769 | 718 | 897 | 966 |
| 2 | 4 | 130 | 274 | 258 | 155 | 386 | 771 | 514 | 688 | 642 | 472 | 770 | 698 | 898 | 830 |
| 3 | 8 | 131 | 57 | 259 | 533 | 387 | 217 | 515 | 451 | 643 | 714 | 771 | 381 | 899 | 888 |
| 4 | 2 | 132 | 78 | 260 | 305 | 388 | 188 | 516 | 792 | 644 | 835 | 772 | 813 | 900 | 940 |
| 5 | 16 | 133 | 135 | 261 | 109 | 389 | 551 | 517 | 370 | 645 | 455 | 773 | 623 | 901 | 750 |
| 6 | 32 | 134 | 517 | 262 | 325 | 390 | 229 | 518 | 611 | 646 | 809 | 774 | 814 | 902 | 871 |
| 7 | 6 | 135 | 194 | 263 | 642 | 391 | 568 | 519 | 425 | 647 | 377 | 775 | 498 | 903 | 506 |
| 8 | 64 | 136 | 83 | 264 | 210 | 392 | 333 | 520 | 601 | 648 | 605 | 776 | 872 | 904 | 970 |
| 9 | 512 | 137 | 290 | 265 | 184 | 393 | 408 | 521 | 235 | 649 | 619 | 777 | 739 | 905 | 911 |
| 10 | 3 | 138 | 168 | 266 | 225 | 394 | 650 | 522 | 804 | 650 | 435 | 778 | 929 | 906 | 757 |
| 11 | 12 | 139 | 276 | 267 | 538 | 395 | 310 | 523 | 343 | 651 | 663 | 779 | 445 | 907 | 946 |
| 12 | 5 | 140 | 86 | 268 | 167 | 396 | 596 | 524 | 653 | 652 | 721 | 780 | 671 | 908 | 969 |
| 13 | 18 | 141 | 530 | 269 | 300 | 397 | 339 | 525 | 412 | 653 | 319 | 781 | 916 | 909 | 861 |
| 14 | 128 | 142 | 58 | 270 | 592 | 398 | 420 | 526 | 833 | 654 | 796 | 782 | 821 | 910 | 977 |
| 15 | 9 | 143 | 139 | 271 | 115 | 399 | 541 | 527 | 480 | 655 | 430 | 783 | 463 | 911 | 447 |
| 16 | 33 | 144 | 322 | 272 | 387 | 400 | 218 | 528 | 712 | 656 | 692 | 784 | 726 | 912 | 875 |
| 17 | 17 | 145 | 196 | 273 | 329 | 401 | 657 | 529 | 222 | 657 | 912 | 785 | 961 | 913 | 919 |
| 18 | 10 | 146 | 101 | 274 | 547 | 402 | 368 | 530 | 602 | 658 | 239 | 786 | 843 | 914 | 639 |
| 19 | 36 | 147 | 640 | 275 | 110 | 403 | 773 | 531 | 317 | 659 | 606 | 787 | 490 | 915 | 758 |
| 20 | 66 | 148 | 60 | 276 | 416 | 404 | 123 | 532 | 543 | 660 | 716 | 788 | 631 | 916 | 948 |
| 21 | 24 | 149 | 147 | 277 | 770 | 405 | 230 | 533 | 453 | 661 | 461 | 789 | 729 | 917 | 862 |
| 22 | 256 | 150 | 176 | 278 | 212 | 406 | 555 | 534 | 654 | 662 | 810 | 790 | 700 | 918 | 761 |
| 23 | 20 | 151 | 280 | 279 | 271 | 407 | 175 | 535 | 426 | 663 | 484 | 791 | 382 | 919 | 508 |
| 24 | 65 | 152 | 99 | 280 | 117 | 408 | 832 | 536 | 614 | 664 | 838 | 792 | 741 | 920 | 972 |
| 25 | 34 | 153 | 89 | 281 | 550 | 409 | 391 | 537 | 372 | 665 | 667 | 793 | 845 | 921 | 923 |
| 26 | 7 | 154 | 521 | 282 | 306 | 410 | 313 | 538 | 775 | 666 | 378 | 794 | 920 | 922 | 877 |
| 27 | 129 | 155 | 292 | 283 | 157 | 411 | 610 | 539 | 433 | 667 | 817 | 795 | 471 | 923 | 952 |
| 28 | 40 | 156 | 141 | 284 | 648 | 412 | 241 | 540 | 559 | 668 | 621 | 796 | 822 | 924 | 886 |

| 29 | 11 | 157 | 321 | 285 | 226 | 413 | 652 | 541 | 237 | 669 | 437 | 797 | 851 | 925 | 935 |
|---|---|---|---|---|---|---|---|---|---|---|---|---|---|---|---|
| 30 | 72 | 158 | 200 | 286 | 171 | 414 | 450 | 542 | 898 | 670 | 837 | 798 | 932 | 926 | 978 |
| 31 | 132 | 159 | 90 | 287 | 330 | 415 | 334 | 543 | 617 | 671 | 722 | 799 | 730 | 927 | 762 |
| 32 | 513 | 160 | 545 | 288 | 608 | 416 | 777 | 544 | 347 | 672 | 247 | 800 | 497 | 928 | 503 |
| 33 | 19 | 161 | 31 | 289 | 337 | 417 | 220 | 545 | 808 | 673 | 696 | 801 | 880 | 929 | 883 |
| 34 | 48 | 162 | 142 | 290 | 389 | 418 | 542 | 546 | 243 | 674 | 380 | 802 | 635 | 930 | 703 |
| 35 | 68 | 163 | 102 | 291 | 534 | 419 | 341 | 547 | 720 | 675 | 737 | 803 | 742 | 931 | 993 |
| 36 | 13 | 164 | 263 | 292 | 308 | 420 | 600 | 548 | 454 | 676 | 679 | 804 | 443 | 932 | 925 |
| 37 | 257 | 165 | 529 | 293 | 216 | 421 | 424 | 549 | 665 | 677 | 459 | 805 | 687 | 933 | 878 |
| 38 | 14 | 166 | 47 | 294 | 549 | 422 | 314 | 550 | 318 | 678 | 812 | 806 | 903 | 934 | 980 |
| 39 | 21 | 167 | 386 | 295 | 121 | 423 | 658 | 551 | 604 | 679 | 627 | 807 | 825 | 935 | 941 |
| 40 | 130 | 168 | 105 | 296 | 390 | 424 | 183 | 552 | 376 | 680 | 488 | 808 | 475 | 936 | 764 |
| 41 | 26 | 169 | 296 | 297 | 537 | 425 | 774 | 553 | 661 | 681 | 899 | 809 | 753 | 937 | 495 |
| 42 | 80 | 170 | 208 | 298 | 158 | 426 | 233 | 554 | 428 | 682 | 841 | 810 | 962 | 938 | 926 |
| 43 | 35 | 171 | 522 | 299 | 279 | 427 | 612 | 555 | 779 | 683 | 441 | 811 | 846 | 939 | 885 |
| 44 | 258 | 172 | 153 | 300 | 332 | 428 | 355 | 556 | 238 | 684 | 622 | 812 | 732 | 940 | 994 |
| 45 | 38 | 173 | 92 | 301 | 579 | 429 | 673 | 557 | 675 | 685 | 928 | 813 | 500 | 941 | 735 |
| 46 | 136 | 174 | 149 | 302 | 118 | 430 | 125 | 558 | 359 | 686 | 351 | 814 | 853 | 942 | 939 |
| 47 | 96 | 175 | 267 | 303 | 173 | 431 | 287 | 559 | 836 | 687 | 724 | 815 | 936 | 943 | 984 |
| 48 | 22 | 176 | 548 | 304 | 776 | 432 | 583 | 560 | 458 | 688 | 783 | 816 | 826 | 944 | 967 |
| 49 | 516 | 177 | 163 | 305 | 338 | 433 | 395 | 561 | 625 | 689 | 469 | 817 | 446 | 945 | 889 |
| 50 | 37 | 178 | 324 | 306 | 179 | 434 | 557 | 562 | 399 | 690 | 629 | 818 | 695 | 946 | 947 |
| 51 | 25 | 179 | 113 | 307 | 553 | 435 | 234 | 563 | 662 | 691 | 818 | 819 | 745 | 947 | 831 |
| 52 | 67 | 180 | 150 | 308 | 199 | 436 | 785 | 564 | 677 | 692 | 438 | 820 | 867 | 948 | 507 |
| 53 | 264 | 181 | 578 | 309 | 353 | 437 | 316 | 565 | 245 | 693 | 669 | 821 | 637 | 949 | 942 |
| 54 | 41 | 182 | 165 | 310 | 656 | 438 | 345 | 566 | 567 | 694 | 462 | 822 | 487 | 950 | 751 |
| 55 | 144 | 183 | 55 | 311 | 283 | 439 | 563 | 567 | 434 | 695 | 738 | 823 | 799 | 951 | 973 |
| 56 | 28 | 184 | 304 | 312 | 312 | 440 | 187 | 568 | 816 | 696 | 683 | 824 | 907 | 952 | 996 |
| 57 | 69 | 185 | 106 | 313 | 540 | 441 | 660 | 569 | 457 | 697 | 251 | 825 | 746 | 953 | 890 |
| 58 | 260 | 186 | 275 | 314 | 448 | 442 | 452 | 570 | 618 | 698 | 842 | 826 | 828 | 954 | 949 |
| 59 | 49 | 187 | 536 | 315 | 228 | 443 | 778 | 571 | 349 | 699 | 849 | 827 | 493 | 955 | 759 |
| 60 | 74 | 188 | 269 | 316 | 581 | 444 | 403 | 572 | 787 | 700 | 496 | 828 | 857 | 956 | 892 |
| 61 | 160 | 189 | 385 | 317 | 393 | 445 | 558 | 573 | 465 | 701 | 901 | 829 | 699 | 957 | 971 |
| 62 | 42 | 190 | 154 | 318 | 122 | 446 | 342 | 574 | 781 | 702 | 820 | 830 | 964 | 958 | 1000 |
| 63 | 520 | 191 | 768 | 319 | 181 | 447 | 397 | 575 | 897 | 703 | 728 | 831 | 915 | 959 | 953 |
| 64 | 134 | 192 | 79 | 320 | 772 | 448 | 587 | 576 | 363 | 704 | 467 | 832 | 477 | 960 | 509 |
| 65 | 70 | 193 | 108 | 321 | 232 | 449 | 207 | 577 | 666 | 705 | 633 | 833 | 854 | 961 | 863 |
| 66 | 44 | 194 | 224 | 322 | 295 | 450 | 616 | 578 | 407 | 706 | 902 | 834 | 909 | 962 | 981 |

| | | | | | | | | | | | | | | | |
|---|---|---|---|---|---|---|---|---|---|---|---|---|---|---|---|
| 67 | 81 | 195 | 166 | 323 | 561 | 451 | 236 | 579 | 591 | 707 | 367 | 835 | 719 | 963 | 950 |
| 68 | 272 | 196 | 532 | 324 | 174 | 452 | 676 | 580 | 127 | 708 | 670 | 836 | 504 | 964 | 974 |
| 69 | 15 | 197 | 59 | 325 | 394 | 453 | 432 | 581 | 620 | 709 | 791 | 837 | 748 | 965 | 763 |
| 70 | 50 | 198 | 169 | 326 | 586 | 454 | 705 | 582 | 246 | 710 | 442 | 838 | 944 | 966 | 1008 |
| 71 | 131 | 199 | 114 | 327 | 63 | 455 | 346 | 583 | 736 | 711 | 844 | 839 | 858 | 967 | 979 |
| 72 | 192 | 200 | 195 | 328 | 203 | 456 | 565 | 584 | 436 | 712 | 630 | 840 | 873 | 968 | 879 |
| 73 | 73 | 201 | 577 | 329 | 672 | 457 | 361 | 585 | 678 | 713 | 474 | 841 | 638 | 969 | 954 |
| 74 | 23 | 202 | 328 | 330 | 354 | 458 | 674 | 586 | 571 | 714 | 685 | 842 | 478 | 970 | 986 |
| 75 | 514 | 203 | 270 | 331 | 554 | 459 | 126 | 587 | 350 | 715 | 850 | 843 | 754 | 971 | 995 |
| 76 | 137 | 204 | 277 | 332 | 401 | 460 | 242 | 588 | 681 | 716 | 483 | 844 | 869 | 972 | 891 |
| 77 | 52 | 205 | 87 | 333 | 340 | 461 | 896 | 589 | 249 | 717 | 691 | 845 | 917 | 973 | 927 |
| 78 | 288 | 206 | 546 | 334 | 646 | 462 | 357 | 590 | 626 | 718 | 711 | 846 | 727 | 974 | 510 |
| 79 | 76 | 207 | 156 | 335 | 124 | 463 | 780 | 591 | 460 | 719 | 379 | 847 | 499 | 975 | 765 |
| 80 | 133 | 208 | 116 | 336 | 285 | 464 | 405 | 592 | 707 | 720 | 865 | 848 | 910 | 976 | 956 |
| 81 | 82 | 209 | 388 | 337 | 582 | 465 | 589 | 593 | 840 | 721 | 795 | 849 | 815 | 977 | 997 |
| 82 | 27 | 210 | 519 | 338 | 182 | 466 | 215 | 594 | 411 | 722 | 415 | 850 | 870 | 978 | 982 |
| 83 | 97 | 211 | 336 | 339 | 299 | 467 | 664 | 595 | 782 | 723 | 824 | 851 | 931 | 979 | 887 |
| 84 | 259 | 212 | 291 | 340 | 556 | 468 | 398 | 596 | 365 | 724 | 960 | 852 | 255 | 980 | 985 |
| 85 | 39 | 213 | 278 | 341 | 240 | 469 | 566 | 597 | 789 | 725 | 740 | 853 | 968 | 981 | 943 |
| 86 | 528 | 214 | 197 | 342 | 211 | 470 | 303 | 598 | 440 | 726 | 253 | 854 | 860 | 982 | 998 |
| 87 | 56 | 215 | 641 | 343 | 593 | 471 | 597 | 599 | 599 | 727 | 905 | 855 | 701 | 983 | 1001 |
| 88 | 138 | 216 | 61 | 344 | 286 | 472 | 358 | 600 | 374 | 728 | 634 | 856 | 756 | 984 | 766 |
| 89 | 84 | 217 | 177 | 345 | 344 | 473 | 801 | 601 | 668 | 729 | 444 | 857 | 922 | 985 | 988 |
| 90 | 29 | 218 | 170 | 346 | 784 | 474 | 419 | 602 | 628 | 730 | 693 | 858 | 491 | 986 | 951 |
| 91 | 145 | 219 | 552 | 347 | 396 | 475 | 624 | 603 | 423 | 731 | 744 | 859 | 731 | 987 | 1004 |
| 92 | 261 | 220 | 91 | 348 | 205 | 476 | 456 | 604 | 900 | 732 | 485 | 860 | 823 | 988 | 893 |
| 93 | 43 | 221 | 281 | 349 | 527 | 477 | 786 | 605 | 466 | 733 | 807 | 861 | 874 | 989 | 1010 |
| 94 | 320 | 222 | 201 | 350 | 95 | 478 | 348 | 606 | 848 | 734 | 686 | 862 | 976 | 990 | 957 |
| 95 | 544 | 223 | 198 | 351 | 418 | 479 | 189 | 607 | 803 | 735 | 906 | 863 | 918 | 991 | 975 |
| 96 | 98 | 224 | 523 | 352 | 562 | 480 | 569 | 608 | 250 | 736 | 470 | 864 | 502 | 992 | 511 |
| 97 | 140 | 225 | 62 | 353 | 185 | 481 | 244 | 609 | 790 | 737 | 575 | 865 | 933 | 993 | 1002 |
| 98 | 265 | 226 | 143 | 354 | 643 | 482 | 590 | 610 | 371 | 738 | 715 | 866 | 743 | 994 | 894 |
| 99 | 30 | 227 | 294 | 355 | 213 | 483 | 410 | 611 | 709 | 739 | 375 | 867 | 760 | 995 | 983 |
| 100 | 88 | 228 | 584 | 356 | 402 | 484 | 647 | 612 | 191 | 740 | 866 | 868 | 881 | 996 | 1009 |
| 101 | 146 | 229 | 172 | 357 | 704 | 485 | 219 | 613 | 573 | 741 | 913 | 869 | 494 | 997 | 955 |
| 102 | 262 | 230 | 392 | 358 | 307 | 486 | 706 | 614 | 689 | 742 | 473 | 870 | 702 | 998 | 987 |
| 103 | 100 | 231 | 103 | 359 | 327 | 487 | 311 | 615 | 481 | 743 | 852 | 871 | 921 | 999 | 1012 |
| 104 | 518 | 232 | 644 | 360 | 585 | 488 | 595 | 616 | 682 | 744 | 636 | 872 | 827 | 1000 | 958 |

| 105 | 161 | 233 | 120 | 361 | 356 | 489 | 362 | 617 | 413 | 745 | 797 | 873 | 876 | 1001 | 999 |
|---|---|---|---|---|---|---|---|---|---|---|---|---|---|---|---|
| 106 | 71 | 234 | 293 | 362 | 535 | 490 | 802 | 618 | 603 | 746 | 431 | 874 | 934 | 1002 | 1005 |
| 107 | 45 | 235 | 282 | 363 | 206 | 491 | 464 | 619 | 793 | 747 | 694 | 875 | 847 | 1003 | 989 |
| 108 | 273 | 236 | 531 | 364 | 186 | 492 | 680 | 620 | 366 | 748 | 811 | 876 | 505 | 1004 | 1016 |
| 109 | 51 | 237 | 352 | 365 | 649 | 493 | 406 | 621 | 713 | 749 | 486 | 877 | 733 | 1005 | 990 |
| 110 | 148 | 238 | 178 | 366 | 301 | 494 | 788 | 622 | 468 | 750 | 752 | 878 | 963 | 1006 | 1011 |
| 111 | 266 | 239 | 202 | 367 | 111 | 495 | 421 | 623 | 710 | 751 | 723 | 879 | 882 | 1007 | 767 |
| 112 | 576 | 240 | 560 | 368 | 564 | 496 | 598 | 624 | 429 | 752 | 798 | 880 | 937 | 1008 | 1003 |
| 113 | 46 | 241 | 323 | 369 | 302 | 497 | 231 | 625 | 574 | 753 | 489 | 881 | 747 | 1009 | 1014 |
| 114 | 75 | 242 | 297 | 370 | 800 | 498 | 570 | 626 | 655 | 754 | 856 | 882 | 383 | 1010 | 1006 |
| 115 | 104 | 243 | 93 | 371 | 360 | 499 | 248 | 627 | 252 | 755 | 908 | 883 | 855 | 1011 | 1017 |
| 116 | 164 | 244 | 580 | 372 | 227 | 500 | 651 | 628 | 806 | 756 | 254 | 884 | 924 | 1012 | 895 |
| 117 | 193 | 245 | 107 | 373 | 588 | 501 | 369 | 629 | 414 | 757 | 717 | 885 | 992 | 1013 | 1013 |
| 118 | 53 | 246 | 151 | 374 | 417 | 502 | 834 | 630 | 684 | 758 | 607 | 886 | 734 | 1014 | 991 |
| 119 | 162 | 247 | 209 | 375 | 159 | 503 | 190 | 631 | 904 | 759 | 930 | 887 | 829 | 1015 | 1018 |
| 120 | 515 | 248 | 525 | 376 | 645 | 504 | 708 | 632 | 373 | 760 | 476 | 888 | 965 | 1016 | 959 |
| 121 | 384 | 249 | 284 | 377 | 404 | 505 | 409 | 633 | 615 | 761 | 697 | 889 | 501 | 1017 | 1020 |
| 122 | 268 | 250 | 180 | 378 | 594 | 506 | 613 | 634 | 482 | 762 | 725 | 890 | 938 | 1018 | 1015 |
| 123 | 77 | 251 | 400 | 379 | 309 | 507 | 315 | 635 | 632 | 763 | 914 | 891 | 884 | 1019 | 1007 |
| 124 | 152 | 252 | 769 | 380 | 214 | 508 | 572 | 636 | 805 | 764 | 439 | 892 | 945 | 1020 | 1019 |
| 125 | 54 | 253 | 94 | 381 | 539 | 509 | 364 | 637 | 223 | 765 | 819 | 893 | 749 | 1021 | 1021 |
| 126 | 85 | 254 | 204 | 382 | 449 | 510 | 659 | 638 | 794 | 766 | 839 | 894 | 859 | 1022 | 1022 |
| 127 | 524 | 255 | 298 | 383 | 331 | 511 | 422 | 639 | 864 | 767 | 868 | 895 | 755 | 1023 | 1023 |

Sequence Q27, having a sequence length of 512:
[0, 1, 4, 8, 2, 16, 32, 6, 64, 3, 12, 5, 18, 128, 9, 33, 17, 10, 36, 66, 24, 256, 20, 65, 34, 7, 129, 40, 11, 72, 132, 19, 48, 68, 13, 257, 14, 21, 130, 26, 80, 35, 258, 38, 136, 96, 22, 37, 25, 67, 264, 41, 144, 28, 69, 260, 49, 74, 160, 42, 134, 70, 44, 81, 272, 15, 50, 131, 192, 73, 23, 137, 52, 288, 76, 133, 82, 27, 97, 259, 39, 56, 138, 84, 29, 145, 261, 43, 320, 98, 140, 265, 30, 88, 146, 262, 100, 161, 71, 45, 273, 51, 148, 266, 46, 75, 104, 164, 193, 53, 162, 384, 268, 77, 152, 54, 85, 289, 112, 274, 57, 78, 135, 194, 83, 290, 168, 276, 86, 58, 139, 322, 196, 101, 60, 147, 176, 280, 99, 89, 292, 141, 321, 200, 90, 31, 142, 102, 263, 47, 386, 105, 296, 208, 153, 92, 149, 267, 163, 324, 113, 150, 165, 55, 304, 106, 275, 269, 385, 154, 79, 108, 224, 166, 59, 169, 114, 195, 328, 270, 277, 87, 156, 116, 388, 336, 291, 278, 197, 61, 177, 170, 91, 281, 201, 198, 62, 143, 294, 172, 392, 103, 120, 293, 282, 352, 178, 202, 323, 297, 93, 107, 151, 209, 284, 180, 400, 94, 204, 298, 326, 155, 305, 109, 325, 210, 184, 225, 167, 300, 115, 387, 329, 110, 416, 212, 271, 117, 306, 157, 226, 171, 330, 337, 389, 308, 216, 121, 390, 158, 279, 332, 118, 173, 338, 179, 199, 353, 283, 312, 448, 228, 393, 122, 181, 232, 295, 174, 394, 63, 203, 354, 401, 340, 124, 285, 182, 299, 240, 211, 286, 344, 396, 205, 95, 418, 185, 213, 402, 307, 327, 356, 206, 186, 301, 111, 302, 360, 227, 417, 159, 404, 309, 214, 449, 331, 119, 217, 188, 229, 333, 408, 310, 339, 420, 218, 368, 123, 230, 175, 391, 313, 241, 450, 334, 220, 341, 424, 314, 183, 233, 355, 125, 287, 395, 234, 316, 345, 187, 452, 403, 342, 397, 207, 236, 432, 346, 361, 126, 242, 357, 405, 215, 398, 303, 358, 419, 456, 348, 189, 244, 410, 219, 311, 362, 464, 406, 421, 231, 248, 369, 190, 409, 315, 364, 422, 335, 221, 451, 370, 425, 235, 343, 412, 480, 222, 317, 453, 426, 372, 433, 237, 347, 243, 454, 318, 376, 428, 238, 359, 458, 399, 245, 434, 457, 349, 465, 363, 407, 127, 246, 436, 350, 249, 460, 411, 365, 440, 374, 423, 466, 250, 371, 191, 481, 413, 366, 468, 429, 252, 414, 373, 482, 223, 427, 472, 455, 377, 435, 319, 430, 239, 461, 484, 378, 437, 247, 380, 459, 488, 441, 351, 469, 438, 462, 251, 496, 467, 367, 442, 474, 483, 379, 415, 253, 444, 485, 470, 375, 473, 431, 486, 489, 254, 476, 439, 492, 381, 498, 445, 463, 490, 382, 471, 497, 443, 475, 500, 446, 487, 493, 477, 504, 478, 499, 255, 491, 502, 494, 505, 383, 501, 479, 506, 447, 508, 503, 495, 507, 509, 510, 511]

## Table Q27, having a sequence length of 512:

| Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number |
|---|---|---|---|---|---|---|---|---|---|---|---|---|---|---|---|
| 0 | 0 | 64 | 272 | 128 | 86 | 192 | 91 | 256 | 199 | 320 | 391 | 384 | 480 | 448 | 459 |
| 1 | 1 | 65 | 15 | 129 | 58 | 193 | 281 | 257 | 353 | 321 | 313 | 385 | 222 | 449 | 488 |
| 2 | 4 | 66 | 50 | 130 | 139 | 194 | 201 | 258 | 283 | 322 | 241 | 386 | 317 | 450 | 441 |
| 3 | 8 | 67 | 131 | 131 | 322 | 195 | 198 | 259 | 312 | 323 | 450 | 387 | 453 | 451 | 351 |
| 4 | 2 | 68 | 192 | 132 | 196 | 196 | 62 | 260 | 448 | 324 | 334 | 388 | 426 | 452 | 469 |
| 5 | 16 | 69 | 73 | 133 | 101 | 197 | 143 | 261 | 228 | 325 | 220 | 389 | 372 | 453 | 438 |
| 6 | 32 | 70 | 23 | 134 | 60 | 198 | 294 | 262 | 393 | 326 | 341 | 390 | 433 | 454 | 462 |
| 7 | 6 | 71 | 137 | 135 | 147 | 199 | 172 | 263 | 122 | 327 | 424 | 391 | 237 | 455 | 251 |
| 8 | 64 | 72 | 52 | 136 | 176 | 200 | 392 | 264 | 181 | 328 | 314 | 392 | 347 | 456 | 496 |
| 9 | 3 | 73 | 288 | 137 | 280 | 201 | 103 | 265 | 232 | 329 | 183 | 393 | 243 | 457 | 467 |
| 10 | 12 | 74 | 76 | 138 | 99 | 202 | 120 | 266 | 295 | 330 | 233 | 394 | 454 | 458 | 367 |
| 11 | 5 | 75 | 133 | 139 | 89 | 203 | 293 | 267 | 174 | 331 | 355 | 395 | 318 | 459 | 442 |
| 12 | 18 | 76 | 82 | 140 | 292 | 204 | 282 | 268 | 394 | 332 | 125 | 396 | 376 | 460 | 474 |
| 13 | 128 | 77 | 27 | 141 | 141 | 205 | 352 | 269 | 63 | 333 | 287 | 397 | 428 | 461 | 483 |
| 14 | 9 | 78 | 97 | 142 | 321 | 206 | 178 | 270 | 203 | 334 | 395 | 398 | 238 | 462 | 379 |
| 15 | 33 | 79 | 259 | 143 | 200 | 207 | 202 | 271 | 354 | 335 | 234 | 399 | 359 | 463 | 415 |
| 16 | 17 | 80 | 39 | 144 | 90 | 208 | 323 | 272 | 401 | 336 | 316 | 400 | 458 | 464 | 253 |

| 17 | 10 | 81 | 56 | 145 | 31 | 209 | 297 | 273 | 340 | 337 | 345 | 401 | 399 | 465 | 444 |
|---|---|---|---|---|---|---|---|---|---|---|---|---|---|---|---|
| 18 | 36 | 82 | 138 | 146 | 142 | 210 | 93 | 274 | 124 | 338 | 187 | 402 | 245 | 466 | 485 |
| 19 | 66 | 83 | 84 | 147 | 102 | 211 | 107 | 275 | 285 | 339 | 452 | 403 | 434 | 467 | 470 |
| 20 | 24 | 84 | 29 | 148 | 263 | 212 | 151 | 276 | 182 | 340 | 403 | 404 | 457 | 468 | 375 |
| 21 | 256 | 85 | 145 | 149 | 47 | 213 | 209 | 277 | 299 | 341 | 342 | 405 | 349 | 469 | 473 |
| 22 | 20 | 86 | 261 | 150 | 386 | 214 | 284 | 278 | 240 | 342 | 397 | 406 | 465 | 470 | 431 |
| 23 | 65 | 87 | 43 | 151 | 105 | 215 | 180 | 279 | 211 | 343 | 207 | 407 | 363 | 471 | 486 |
| 24 | 34 | 88 | 320 | 152 | 296 | 216 | 400 | 280 | 286 | 344 | 236 | 408 | 407 | 472 | 489 |
| 25 | 7 | 89 | 98 | 153 | 208 | 217 | 94 | 281 | 344 | 345 | 432 | 409 | 127 | 473 | 254 |
| 26 | 129 | 90 | 140 | 154 | 153 | 218 | 204 | 282 | 396 | 346 | 346 | 410 | 246 | 474 | 476 |
| 27 | 40 | 91 | 265 | 155 | 92 | 219 | 298 | 283 | 205 | 347 | 361 | 411 | 436 | 475 | 439 |
| 28 | 11 | 92 | 30 | 156 | 149 | 220 | 326 | 284 | 95 | 348 | 126 | 412 | 350 | 476 | 492 |
| 29 | 72 | 93 | 88 | 157 | 267 | 221 | 155 | 285 | 418 | 349 | 242 | 413 | 249 | 477 | 381 |
| 30 | 132 | 94 | 146 | 158 | 163 | 222 | 305 | 286 | 185 | 350 | 357 | 414 | 460 | 478 | 498 |
| 31 | 19 | 95 | 262 | 159 | 324 | 223 | 109 | 287 | 213 | 351 | 405 | 415 | 411 | 479 | 445 |
| 32 | 48 | 96 | 100 | 160 | 113 | 224 | 325 | 288 | 402 | 352 | 215 | 416 | 365 | 480 | 463 |
| 33 | 68 | 97 | 161 | 161 | 150 | 225 | 210 | 289 | 307 | 353 | 398 | 417 | 440 | 481 | 490 |
| 34 | 13 | 98 | 71 | 162 | 165 | 226 | 184 | 290 | 327 | 354 | 303 | 418 | 374 | 482 | 382 |
| 35 | 257 | 99 | 45 | 163 | 55 | 227 | 225 | 291 | 356 | 355 | 358 | 419 | 423 | 483 | 471 |
| 36 | 14 | 100 | 273 | 164 | 304 | 228 | 167 | 292 | 206 | 356 | 419 | 420 | 466 | 484 | 497 |
| 37 | 21 | 101 | 51 | 165 | 106 | 229 | 300 | 293 | 186 | 357 | 456 | 421 | 250 | 485 | 443 |
| 38 | 130 | 102 | 148 | 166 | 275 | 230 | 115 | 294 | 301 | 358 | 348 | 422 | 371 | 486 | 475 |
| 39 | 26 | 103 | 266 | 167 | 269 | 231 | 387 | 295 | 111 | 359 | 189 | 423 | 191 | 487 | 500 |
| 40 | 80 | 104 | 46 | 168 | 385 | 232 | 329 | 296 | 302 | 360 | 244 | 424 | 481 | 488 | 446 |
| 41 | 35 | 105 | 75 | 169 | 154 | 233 | 110 | 297 | 360 | 361 | 410 | 425 | 413 | 489 | 487 |
| 42 | 258 | 106 | 104 | 170 | 79 | 234 | 416 | 298 | 227 | 362 | 219 | 426 | 366 | 490 | 493 |
| 43 | 38 | 107 | 164 | 171 | 108 | 235 | 212 | 299 | 417 | 363 | 311 | 427 | 468 | 491 | 477 |
| 44 | 136 | 108 | 193 | 172 | 224 | 236 | 271 | 300 | 159 | 364 | 362 | 428 | 429 | 492 | 504 |
| 45 | 96 | 109 | 53 | 173 | 166 | 237 | 117 | 301 | 404 | 365 | 464 | 429 | 252 | 493 | 478 |
| 46 | 22 | 110 | 162 | 174 | 59 | 238 | 306 | 302 | 309 | 366 | 406 | 430 | 414 | 494 | 499 |
| 47 | 37 | 111 | 384 | 175 | 169 | 239 | 157 | 303 | 214 | 367 | 421 | 431 | 373 | 495 | 255 |
| 48 | 25 | 112 | 268 | 176 | 114 | 240 | 226 | 304 | 449 | 368 | 231 | 432 | 482 | 496 | 491 |
| 49 | 67 | 113 | 77 | 177 | 195 | 241 | 171 | 305 | 331 | 369 | 248 | 433 | 223 | 497 | 502 |
| 50 | 264 | 114 | 152 | 178 | 328 | 242 | 330 | 306 | 119 | 370 | 369 | 434 | 427 | 498 | 494 |
| 51 | 41 | 115 | 54 | 179 | 270 | 243 | 337 | 307 | 217 | 371 | 190 | 435 | 472 | 499 | 505 |
| 52 | 144 | 116 | 85 | 180 | 277 | 244 | 389 | 308 | 188 | 372 | 409 | 436 | 455 | 500 | 383 |
| 53 | 28 | 117 | 289 | 181 | 87 | 245 | 308 | 309 | 229 | 373 | 315 | 437 | 377 | 501 | 501 |
| 54 | 69 | 118 | 112 | 182 | 156 | 246 | 216 | 310 | 333 | 374 | 364 | 438 | 435 | 502 | 479 |

| 55 | 260 | 119 | 274 | 183 | 116 | 247 | 121 | 311 | 408 | 375 | 422 | 439 | 319 | 503 | 506 |
|----|-----|-----|-----|-----|-----|-----|-----|-----|-----|-----|-----|-----|-----|-----|-----|
| 56 | 49 | 120 | 57 | 184 | 388 | 248 | 390 | 312 | 310 | 376 | 335 | 440 | 430 | 504 | 447 |
| 57 | 74 | 121 | 78 | 185 | 336 | 249 | 158 | 313 | 339 | 377 | 221 | 441 | 239 | 505 | 508 |
| 58 | 160 | 122 | 135 | 186 | 291 | 250 | 279 | 314 | 420 | 378 | 451 | 442 | 461 | 506 | 503 |
| 59 | 42 | 123 | 194 | 187 | 278 | 251 | 332 | 315 | 218 | 379 | 370 | 443 | 484 | 507 | 495 |
| 60 | 134 | 124 | 83 | 188 | 197 | 252 | 118 | 316 | 368 | 380 | 425 | 444 | 378 | 508 | 507 |
| 61 | 70 | 125 | 290 | 189 | 61 | 253 | 173 | 317 | 123 | 381 | 235 | 445 | 437 | 509 | 509 |
| 62 | 44 | 126 | 168 | 190 | 177 | 254 | 338 | 318 | 230 | 382 | 343 | 446 | 247 | 510 | 510 |
| 63 | 81 | 127 | 276 | 191 | 170 | 255 | 179 | 319 | 175 | 383 | 412 | 447 | 380 | 511 | 511 |

Sequence Q28, having a sequence length of 256:

[0, 1, 4, 8, 2, 16, 32, 6, 64, 3, 12, 5, 18, 128, 9, 33, 17, 10, 36, 66, 24, 20, 65, 34, 7, 129, 40, 11, 72, 132, 19, 48, 68, 13, 14, 21, 130, 26, 80, 35, 38, 136, 96, 22, 37, 25, 67, 41, 144, 28, 69, 49, 74, 160, 42, 134, 70, 44, 81, 15, 50, 131, 192, 73, 23, 137, 52, 76, 133, 82, 27, 97, 39, 56, 138, 84, 29, 145, 43, 98, 140, 30, 88, 146, 100, 161, 71, 45, 51, 148, 46, 75, 104, 164, 193, 53, 162, 77, 152, 54, 85, 112, 57, 78, 135, 194, 83, 168, 86, 58, 139, 196, 101, 60, 147, 176, 99, 89, 141, 200, 90, 31, 142, 102, 47, 105, 208, 153, 92, 149, 163, 113, 150, 165, 55, 106, 154, 79, 108, 224, 166, 59, 169, 114, 195, 87, 156, 116, 197, 61, 177, 170, 91, 201, 198, 62, 143, 172, 103, 120, 178, 202, 93, 107, 151, 209, 180, 94, 204, 155, 109, 210, 184, 225, 167, 115, 110, 212, 117, 157, 226, 171, 216, 121, 158, 118, 173, 179, 199, 228, 122, 181, 232, 174, 63, 203, 124, 182, 240, 211, 205, 95, 185, 213, 206, 186, 111, 227, 159, 214, 119, 217, 188, 229, 218, 123, 230, 175, 241, 220, 183, 233, 125, 234, 187, 207, 236, 126, 242, 215, 189, 244, 219, 231, 248, 190, 221, 235, 222, 237, 243, 238, 245, 127, 246, 249, 250, 191, 252, 223, 239, 247, 251, 253, 254, 255]

## Table Q28, having a sequence length of 256:

| Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number |
|----|----|----|----|----|----|----|----|----|----|----|----|----|----|----|----|
| 0 | 0 | 32 | 68 | 64 | 23 | 96 | 162 | 128 | 92 | 160 | 178 | 192 | 232 | 224 | 187 |
| 1 | 1 | 33 | 13 | 65 | 137 | 97 | 77 | 129 | 149 | 161 | 202 | 193 | 174 | 225 | 207 |
| 2 | 4 | 34 | 14 | 66 | 52 | 98 | 152 | 130 | 163 | 162 | 93 | 194 | 63 | 226 | 236 |
| 3 | 8 | 35 | 21 | 67 | 76 | 99 | 54 | 131 | 113 | 163 | 107 | 195 | 203 | 227 | 126 |
| 4 | 2 | 36 | 130 | 68 | 133 | 100 | 85 | 132 | 150 | 164 | 151 | 196 | 124 | 228 | 242 |
| 5 | 16 | 37 | 26 | 69 | 82 | 101 | 112 | 133 | 165 | 165 | 209 | 197 | 182 | 229 | 215 |
| 6 | 32 | 38 | 80 | 70 | 27 | 102 | 57 | 134 | 55 | 166 | 180 | 198 | 240 | 230 | 189 |

| 7 | 6 | 39 | 35 | 71 | 97 | 103 | 78 | 135 | 106 | 167 | 94 | 199 | 211 | 231 | 244 |
|---|---|---|---|---|---|---|---|---|---|---|---|---|---|---|---|
| 8 | 64 | 40 | 38 | 72 | 39 | 104 | 135 | 136 | 154 | 168 | 204 | 200 | 205 | 232 | 219 |
| 9 | 3 | 41 | 136 | 73 | 56 | 105 | 194 | 137 | 79 | 169 | 155 | 201 | 95 | 233 | 231 |
| 10 | 12 | 42 | 96 | 74 | 138 | 106 | 83 | 138 | 108 | 170 | 109 | 202 | 185 | 234 | 248 |
| 11 | 5 | 43 | 22 | 75 | 84 | 107 | 168 | 139 | 224 | 171 | 210 | 203 | 213 | 235 | 190 |
| 12 | 18 | 44 | 37 | 76 | 29 | 108 | 86 | 140 | 166 | 172 | 184 | 204 | 206 | 236 | 221 |
| 13 | 128 | 45 | 25 | 77 | 145 | 109 | 58 | 141 | 59 | 173 | 225 | 205 | 186 | 237 | 235 |
| 14 | 9 | 46 | 67 | 78 | 43 | 110 | 139 | 142 | 169 | 174 | 167 | 206 | 111 | 238 | 222 |
| 15 | 33 | 47 | 41 | 79 | 98 | 111 | 196 | 143 | 114 | 175 | 115 | 207 | 227 | 239 | 237 |
| 16 | 17 | 48 | 144 | 80 | 140 | 112 | 101 | 144 | 195 | 176 | 110 | 208 | 159 | 240 | 243 |
| 17 | 10 | 49 | 28 | 81 | 30 | 113 | 60 | 145 | 87 | 177 | 212 | 209 | 214 | 241 | 238 |
| 18 | 36 | 50 | 69 | 82 | 88 | 114 | 147 | 146 | 156 | 178 | 117 | 210 | 119 | 242 | 245 |
| 19 | 66 | 51 | 49 | 83 | 146 | 115 | 176 | 147 | 116 | 179 | 157 | 211 | 217 | 243 | 127 |
| 20 | 24 | 52 | 74 | 84 | 100 | 116 | 99 | 148 | 197 | 180 | 226 | 212 | 188 | 244 | 246 |
| 21 | 20 | 53 | 160 | 85 | 161 | 117 | 89 | 149 | 61 | 181 | 171 | 213 | 229 | 245 | 249 |
| 22 | 65 | 54 | 42 | 86 | 71 | 118 | 141 | 150 | 177 | 182 | 216 | 214 | 218 | 246 | 250 |
| 23 | 34 | 55 | 134 | 87 | 45 | 119 | 200 | 151 | 170 | 183 | 121 | 215 | 123 | 247 | 191 |
| 24 | 7 | 56 | 70 | 88 | 51 | 120 | 90 | 152 | 91 | 184 | 158 | 216 | 230 | 248 | 252 |
| 25 | 129 | 57 | 44 | 89 | 148 | 121 | 31 | 153 | 201 | 185 | 118 | 217 | 175 | 249 | 223 |
| 26 | 40 | 58 | 81 | 90 | 46 | 122 | 142 | 154 | 198 | 186 | 173 | 218 | 241 | 250 | 239 |
| 27 | 11 | 59 | 15 | 91 | 75 | 123 | 102 | 155 | 62 | 187 | 179 | 219 | 220 | 251 | 247 |
| 28 | 72 | 60 | 50 | 92 | 104 | 124 | 47 | 156 | 143 | 188 | 199 | 220 | 183 | 252 | 251 |
| 29 | 132 | 61 | 131 | 93 | 164 | 125 | 105 | 157 | 172 | 189 | 228 | 221 | 233 | 253 | 253 |
| 30 | 19 | 62 | 192 | 94 | 193 | 126 | 208 | 158 | 103 | 190 | 122 | 222 | 125 | 254 | 254 |
| 31 | 48 | 63 | 73 | 95 | 53 | 127 | 153 | 159 | 120 | 191 | 181 | 223 | 234 | 255 | 255 |

Sequence Q29, having a sequence length of 128:
[0, 1, 4, 8, 2, 16, 32, 6, 64, 3, 12, 5, 18, 9, 33, 17, 10, 36, 66, 24, 20, 65, 34, 7, 40, 11, 72, 19, 48, 68, 13, 14, 21, 26, 80, 35, 38, 96, 22, 37, 25, 67, 41, 28, 69, 49, 74, 42, 70, 44, 81, 15, 50, 73, 23, 52, 76, 82, 27, 97, 39, 56, 84, 29, 43, 98, 30, 88, 100, 71, 45, 51, 46, 75, 104, 53, 77, 54, 85, 112, 57, 78, 83, 86, 58, 101, 60, 99, 89, 90, 31, 102, 47, 105, 92, 113, 55, 106, 79, 108, 59, 114, 87, 116, 61, 91, 62, 103, 120, 93, 107, 94, 109, 115, 110, 117, 121, 118, 122, 63, 124, 95, 111, 119, 123, 125, 126, 127]

Table Q29, having a sequence length of 128:

| Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number |
|---|---|---|---|---|---|---|---|---|---|---|---|---|---|---|---|
| 0 | 0 | 16 | 10 | 32 | 21 | 48 | 70 | 64 | 43 | 80 | 57 | 96 | 55 | 112 | 109 |
| 1 | 1 | 17 | 36 | 33 | 26 | 49 | 44 | 65 | 98 | 81 | 78 | 97 | 106 | 113 | 115 |
| 2 | 4 | 18 | 66 | 34 | 80 | 50 | 81 | 66 | 30 | 82 | 83 | 98 | 79 | 114 | 110 |
| 3 | 8 | 19 | 24 | 35 | 35 | 51 | 15 | 67 | 88 | 83 | 86 | 99 | 108 | 115 | 117 |
| 4 | 2 | 20 | 20 | 36 | 38 | 52 | 50 | 68 | 100 | 84 | 58 | 100 | 59 | 116 | 121 |
| 5 | 16 | 21 | 65 | 37 | 96 | 53 | 73 | 69 | 71 | 85 | 101 | 101 | 114 | 117 | 118 |
| 6 | 32 | 22 | 34 | 38 | 22 | 54 | 23 | 70 | 45 | 86 | 60 | 102 | 87 | 118 | 122 |
| 7 | 6 | 23 | 7 | 39 | 37 | 55 | 52 | 71 | 51 | 87 | 99 | 103 | 116 | 119 | 63 |
| 8 | 64 | 24 | 40 | 40 | 25 | 56 | 76 | 72 | 46 | 88 | 89 | 104 | 61 | 120 | 124 |
| 9 | 3 | 25 | 11 | 41 | 67 | 57 | 82 | 73 | 75 | 89 | 90 | 105 | 91 | 121 | 95 |
| 10 | 12 | 26 | 72 | 42 | 41 | 58 | 27 | 74 | 104 | 90 | 31 | 106 | 62 | 122 | 111 |
| 11 | 5 | 27 | 19 | 43 | 28 | 59 | 97 | 75 | 53 | 91 | 102 | 107 | 103 | 123 | 119 |
| 12 | 18 | 28 | 48 | 44 | 69 | 60 | 39 | 76 | 77 | 92 | 47 | 108 | 120 | 124 | 123 |
| 13 | 9 | 29 | 68 | 45 | 49 | 61 | 56 | 77 | 54 | 93 | 105 | 109 | 93 | 125 | 125 |
| 14 | 33 | 30 | 13 | 46 | 74 | 62 | 84 | 78 | 85 | 94 | 92 | 110 | 107 | 126 | 126 |
| 15 | 17 | 31 | 14 | 47 | 42 | 63 | 29 | 79 | 112 | 95 | 113 | 111 | 94 | 127 | 127 |

Sequence Q30, having a sequence length of 64:
[0, 1, 4, 8, 2, 16, 32, 6, 3, 12, 5, 18, 9, 33, 17, 10, 36, 24, 20, 34, 7, 40, 11, 19, 48, 13, 14, 21, 26, 35, 38, 22, 37, 25, 41, 28, 49, 42, 44, 15, 50, 23, 52, 27, 39, 56, 29, 43, 30, 45, 51, 46, 53, 54, 57, 58, 60, 31, 47, 55, 59, 61, 62, 63]

Table Q30, having a sequence length of 64:

| Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number |
|---|---|---|---|---|---|---|---|---|---|---|---|---|---|---|---|
| 0 | 0 | 8 | 3 | 16 | 36 | 24 | 48 | 32 | 37 | 40 | 50 | 48 | 30 | 56 | 60 |
| 1 | 1 | 9 | 12 | 17 | 24 | 25 | 13 | 33 | 25 | 41 | 23 | 49 | 45 | 57 | 31 |
| 2 | 4 | 10 | 5 | 18 | 20 | 26 | 14 | 34 | 41 | 42 | 52 | 50 | 51 | 58 | 47 |
| 3 | 8 | 11 | 18 | 19 | 34 | 27 | 21 | 35 | 28 | 43 | 27 | 51 | 46 | 59 | 55 |

| 4 | 2 | 12 | 9 | 20 | 7 | 28 | 26 | 36 | 49 | 44 | 39 | 52 | 53 | 60 | 59 |
|---|---|----|---|----|---|----|----|----|----|----|----|----|----|----|----|
| 5 | 16 | 13 | 33 | 21 | 40 | 29 | 35 | 37 | 42 | 45 | 56 | 53 | 54 | 61 | 61 |
| 6 | 32 | 14 | 17 | 22 | 11 | 30 | 38 | 38 | 44 | 46 | 29 | 54 | 57 | 62 | 62 |
| 7 | 6 | 15 | 10 | 23 | 19 | 31 | 22 | 39 | 15 | 47 | 43 | 55 | 58 | 63 | 63 |

Sequence Z26, having a sequence length of 1024:

[0, 1, 4, 10, 2, 12, 7, 26, 3, 15, 18, 29, 11, 36, 38, 69, 5, 17, 13, 33, 23, 39, 48, 74, 21, 51, 41, 82, 56, 90, 99, 161, 6, 16, 25, 43, 19, 50, 45, 85, 28, 54, 62, 93, 66, 107, 113, 166, 34, 59, 70, 109, 77, 118, 125, 183, 87, 131, 142, 197, 148, 216, 225, 327, 8, 24, 20, 52, 35, 57, 65, 106, 30, 73, 60, 114, 79, 123, 132, 192, 42, 67, 81, 136, 89, 126, 140, 205, 100, 153, 159, 220, 173, 243, 253, 350, 47, 83, 96, 152, 103, 146, 163, 231, 115, 168, 185, 245, 193, 261, 275, 367, 129, 179, 199, 271, 208, 280, 302, 385, 233, 295, 318, 404, 335, 430, 459, 580, 14, 27, 40, 71, 31, 80, 64, 133, 46, 76, 88, 143, 97, 156, 162, 226, 55, 91, 101, 149, 110, 174, 180, 246, 124, 172, 190, 258, 207, 283, 298, 375, 61, 105, 119, 177, 116, 182, 195, 268, 138, 198, 218, 286, 229, 303, 324, 407, 150, 217, 238, 306, 250, 319, 338, 424, 265, 353, 364, 440, 388, 479, 503, 612, 72, 117, 135, 200, 145, 214, 223, 308, 158, 222, 239, 328, 254, 348, 363, 449, 170, 247, 264, 342, 278, 355, 380, 466, 293, 387, 400, 485, 417, 513, 529, 637, 194, 266, 285, 372, 315, 390, 405, 497, 321, 426, 435, 521, 451, 541, 556, 658, 341, 412, 460, 546, 481, 565, 582, 672, 499, 589, 608, 697, 627, 726, 756, 852, 22, 37, 44, 84, 58, 92, 102, 164, 53, 98, 111, 175, 122, 188, 203, 279, 68, 108, 130, 186, 139, 204, 213, 299, 151, 221, 235, 311, 249, 336, 344, 431, 78, 128, 137, 212, 155, 234, 227, 322, 169, 242, 255, 339, 269, 366, 369, 470, 184, 260, 282, 358, 292, 379, 395, 487, 312, 410, 422, 507, 437, 531, 550, 653, 94, 157, 144, 241, 178, 262, 257, 359, 202, 273, 287, 383, 300, 392, 415, 512, 211, 289, 305, 397, 333, 419, 446, 523, 345, 438, 455, 544, 478, 571, 587, 686, 237, 309, 330, 428, 361, 462, 472, 558, 371, 457, 489, 576, 509, 596, 620, 707, 402, 501, 517, 610, 537, 632, 600, 739, 552, 647, 666, 719, 674, 771, 791, 882, 121, 189, 167, 272, 209, 290, 296, 409, 230, 317, 325, 433, 347, 447, 468, 562, 251, 332, 356, 444, 377, 464, 493, 578, 393, 505, 483, 594, 525, 617, 629, 722, 276, 374, 351, 474, 398, 495, 511, 603, 421, 519, 535, 640, 554, 624, 655, 746, 453, 539, 567, 650, 584, 669, 692, 764, 598, 683, 710, 804, 729, 779, 817, 911, 314, 382, 414, 515, 442, 533, 548, 645, 476, 569, 560, 677, 591, 661, 694, 783, 491, 573, 605, 704, 622, 689, 736, 795, 642, 742, 713, 808, 760, 832, 842, 896, 527, 615, 634, 716, 663, 732, 749, 822, 680, 753, 787, 858, 768, 827, 869, 937, 700, 800, 775, 847, 813, 889, 864, 928, 836, 876, 903, 948, 919, 960, 974, 992, 9, 32, 75, 120, 49, 134, 104, 210, 63, 154, 171, 224, 127, 248, 256, 349, 86, 165, 141, 236, 196, 259, 291, 362, 187, 297, 267, 381, 313, 399, 418, 532, 95, 160, 206, 274, 176, 294, 281, 389, 219, 307, 331, 406, 340, 434, 445, 540, 240, 323, 352, 439, 368, 456, 469, 566, 391, 480, 498, 586, 508, 613, 625, 737, 112, 201, 181, 301, 244, 316, 337, 432, 228, 360, 326, 448, 373, 465, 482, 579, 270, 343, 378, 488, 396, 471, 496, 599, 420, 520, 530, 618, 551, 648, 659, 758, 288, 384, 411, 518, 427, 506, 536, 633, 450, 543, 570, 649, 581, 668, 684, 773, 475, 561, 590, 679, 602, 690, 712, 788, 635, 705, 728, 802, 744, 821, 841, 914, 147, 215, 263, 354, 232, 376, 334, 484, 284, 365, 394, 500, 413, 524, 534, 626, 310, 401, 423, 510, 441, 553, 563, 651, 467, 549, 577, 665, 601, 693, 708, 780, 329, 429, 458, 557, 452, 564, 585, 676, 492, 588, 616, 696, 630, 714, 734, 805, 514, 614, 641, 717, 656, 730, 747, 818, 673, 761, 770, 829, 790, 855, 870, 930, 357, 454, 486, 592, 504, 611, 623, 718, 528, 621, 643, 738, 660, 757, 769, 835, 547, 652, 671, 751, 687, 762, 784, 846, 703, 789, 799, 859, 812, 877, 886, 941, 583, 675, 695, 777, 725, 792, 803, 866, 731, 819, 825, 881, 837, 893, 901, 950, 750, 809, 843, 895, 856, 906, 915, 955, 867, 918, 927, 965, 936, 975, 984, 1007, 191, 252, 277, 386, 320, 403, 425, 538, 304, 416, 443, 555, 463, 574, 595, 688, 346, 436, 477, 572, 494, 597, 609, 709, 516, 619, 638, 721, 654, 745, 752, 823, 370, 473, 490, 607, 522, 636, 628, 733, 545, 646, 662, 748, 678, 772, 774, 849, 568, 667, 691, 765, 702, 782, 796, 860, 723, 807, 816, 872, 826, 887, 898, 947, 408, 526, 502, 644, 559, 670, 664, 766, 593, 682, 698, 786, 711, 793, 811, 875, 606, 699, 715, 797, 743, 814, 833, 883, 754, 828, 839, 894, 854, 909, 917, 961, 639, 720, 740, 820, 767, 844, 850, 902, 776, 840, 861, 912, 873, 922, 933, 968, 801, 868, 879, 929, 891, 939, 924, 979, 899, 945, 953, 972, 956, 988, 994, 1012, 461, 575, 542, 681, 604, 701, 706, 806, 631, 727, 735, 824, 755, 834, 848, 905, 657, 741, 763, 831, 781, 845, 863, 913, 794, 871, 857, 921, 884, 932, 938, 973, 685, 778, 759, 851, 798, 865, 874, 925, 815, 880, 890, 942, 900, 935, 949, 981, 838, 892, 907, 946, 916, 954, 963, 986, 923, 959, 969, 997, 976, 990, 1000, 1016, 724, 785, 810, 878, 830, 888, 897, 944, 853, 908, 904, 957, 920, 951, 964, 991, 862, 910, 926, 967, 934, 962, 978, 995, 943, 980, 970, 998, 985, 1003, 1005, 1014, 885, 931, 940, 971, 952, 977, 982, 1001, 958, 983, 993, 1008, 987, 1002, 1010, 1019, 966, 996, 989, 1006, 999, 1013, 1009, 1018, 1004, 1011, 1015, 1020, 1017, 1021, 1022, 1023]

Table Z26, having a sequence length of 1024:

| Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability |
|---|---|---|---|---|---|---|---|---|---|---|---|---|---|---|---|
| 0 | 0 | 128 | 14 | 256 | 22 | 384 | 121 | 512 | 9 | 640 | 147 | 768 | 191 | 896 | 461 |
| 1 | 1 | 129 | 27 | 257 | 37 | 385 | 189 | 513 | 32 | 641 | 215 | 769 | 252 | 897 | 575 |
| 2 | 4 | 130 | 40 | 258 | 44 | 386 | 167 | 514 | 75 | 642 | 263 | 770 | 277 | 898 | 542 |
| 3 | 10 | 131 | 71 | 259 | 84 | 387 | 272 | 515 | 120 | 643 | 354 | 771 | 386 | 899 | 681 |
| 4 | 2 | 132 | 31 | 260 | 58 | 388 | 209 | 516 | 49 | 644 | 232 | 772 | 320 | 900 | 604 |
| 5 | 12 | 133 | 80 | 261 | 92 | 389 | 290 | 517 | 134 | 645 | 376 | 773 | 403 | 901 | 701 |
| 6 | 7 | 134 | 64 | 262 | 102 | 390 | 296 | 518 | 104 | 646 | 334 | 774 | 425 | 902 | 706 |

| | | | | | | | | | | | | | | | |
|---|---|---|---|---|---|---|---|---|---|---|---|---|---|---|---|
| 7 | 26 | 135 | 133 | 263 | 164 | 391 | 409 | 519 | 210 | 647 | 484 | 775 | 538 | 903 | 806 |
| 8 | 3 | 136 | 46 | 264 | 53 | 392 | 230 | 520 | 63 | 648 | 284 | 776 | 304 | 904 | 631 |
| 9 | 15 | 137 | 76 | 265 | 98 | 393 | 317 | 521 | 154 | 649 | 365 | 777 | 416 | 905 | 727 |
| 10 | 18 | 138 | 88 | 266 | 111 | 394 | 325 | 522 | 171 | 650 | 394 | 778 | 443 | 906 | 735 |
| 11 | 29 | 139 | 143 | 267 | 175 | 395 | 433 | 523 | 224 | 651 | 500 | 779 | 555 | 907 | 824 |
| 12 | 11 | 140 | 97 | 268 | 122 | 396 | 347 | 524 | 127 | 652 | 413 | 780 | 463 | 908 | 755 |
| 13 | 36 | 141 | 156 | 269 | 188 | 397 | 447 | 525 | 248 | 653 | 524 | 781 | 574 | 909 | 834 |
| 14 | 38 | 142 | 162 | 270 | 203 | 398 | 468 | 526 | 256 | 654 | 534 | 782 | 595 | 910 | 848 |
| 15 | 69 | 143 | 226 | 271 | 279 | 399 | 562 | 527 | 349 | 655 | 626 | 783 | 688 | 911 | 905 |
| 16 | 5 | 144 | 55 | 272 | 68 | 400 | 251 | 528 | 86 | 656 | 310 | 784 | 346 | 912 | 657 |
| 17 | 17 | 145 | 91 | 273 | 108 | 401 | 332 | 529 | 165 | 657 | 401 | 785 | 436 | 913 | 741 |
| 18 | 13 | 146 | 101 | 274 | 130 | 402 | 356 | 530 | 141 | 658 | 423 | 786 | 477 | 914 | 763 |
| 19 | 33 | 147 | 149 | 275 | 186 | 403 | 444 | 531 | 236 | 659 | 510 | 787 | 572 | 915 | 831 |
| 20 | 23 | 148 | 110 | 276 | 139 | 404 | 377 | 532 | 196 | 660 | 441 | 788 | 494 | 916 | 781 |
| 21 | 39 | 149 | 174 | 277 | 204 | 405 | 464 | 533 | 259 | 661 | 553 | 789 | 597 | 917 | 845 |
| 22 | 48 | 150 | 180 | 278 | 213 | 406 | 493 | 534 | 291 | 662 | 563 | 790 | 609 | 918 | 863 |
| 23 | 74 | 151 | 246 | 279 | 299 | 407 | 578 | 535 | 362 | 663 | 651 | 791 | 709 | 919 | 913 |
| 24 | 21 | 152 | 124 | 280 | 151 | 408 | 393 | 536 | 187 | 664 | 467 | 792 | 516 | 920 | 794 |
| 25 | 51 | 153 | 172 | 281 | 221 | 409 | 505 | 537 | 297 | 665 | 549 | 793 | 619 | 921 | 871 |
| 26 | 41 | 154 | 190 | 282 | 235 | 410 | 483 | 538 | 267 | 666 | 577 | 794 | 638 | 922 | 857 |
| 27 | 82 | 155 | 258 | 283 | 311 | 411 | 594 | 539 | 381 | 667 | 665 | 795 | 721 | 923 | 921 |
| 28 | 56 | 156 | 207 | 284 | 249 | 412 | 525 | 540 | 313 | 668 | 601 | 796 | 654 | 924 | 884 |
| 29 | 90 | 157 | 283 | 285 | 336 | 413 | 617 | 541 | 399 | 669 | 693 | 797 | 745 | 925 | 932 |
| 30 | 99 | 158 | 298 | 286 | 344 | 414 | 629 | 542 | 418 | 670 | 708 | 798 | 752 | 926 | 938 |
| 31 | 161 | 159 | 375 | 287 | 431 | 415 | 722 | 543 | 532 | 671 | 780 | 799 | 823 | 927 | 973 |
| 32 | 6 | 160 | 61 | 288 | 78 | 416 | 276 | 544 | 95 | 672 | 329 | 800 | 370 | 928 | 685 |
| 33 | 16 | 161 | 105 | 289 | 128 | 417 | 374 | 545 | 160 | 673 | 429 | 801 | 473 | 929 | 778 |
| 34 | 25 | 162 | 119 | 290 | 137 | 418 | 351 | 546 | 206 | 674 | 458 | 802 | 490 | 930 | 759 |
| 35 | 43 | 163 | 177 | 291 | 212 | 419 | 474 | 547 | 274 | 675 | 557 | 803 | 607 | 931 | 851 |
| 36 | 19 | 164 | 116 | 292 | 155 | 420 | 398 | 548 | 176 | 676 | 452 | 804 | 522 | 932 | 798 |
| 37 | 50 | 165 | 182 | 293 | 234 | 421 | 495 | 549 | 294 | 677 | 564 | 805 | 636 | 933 | 865 |
| 38 | 45 | 166 | 195 | 294 | 227 | 422 | 511 | 550 | 281 | 678 | 585 | 806 | 628 | 934 | 874 |
| 39 | 85 | 167 | 268 | 295 | 322 | 423 | 603 | 551 | 389 | 679 | 676 | 807 | 733 | 935 | 925 |
| 40 | 28 | 168 | 138 | 296 | 169 | 424 | 421 | 552 | 219 | 680 | 492 | 808 | 545 | 936 | 815 |
| 41 | 54 | 169 | 198 | 297 | 242 | 425 | 519 | 553 | 307 | 681 | 588 | 809 | 646 | 937 | 880 |
| 42 | 62 | 170 | 218 | 298 | 255 | 426 | 535 | 554 | 331 | 682 | 616 | 810 | 662 | 938 | 890 |
| 43 | 93 | 171 | 286 | 299 | 339 | 427 | 640 | 555 | 406 | 683 | 696 | 811 | 748 | 939 | 942 |
| 44 | 66 | 172 | 229 | 300 | 269 | 428 | 554 | 556 | 340 | 684 | 630 | 812 | 678 | 940 | 900 |

| | | | | | | | | | | | | | | | |
|---|---|---|---|---|---|---|---|---|---|---|---|---|---|---|---|
| 45 | 107 | 173 | 303 | 301 | 366 | 429 | 624 | 557 | 434 | 685 | 714 | 813 | 772 | 941 | 935 |
| 46 | 113 | 174 | 324 | 302 | 369 | 430 | 655 | 558 | 445 | 686 | 734 | 814 | 774 | 942 | 949 |
| 47 | 166 | 175 | 407 | 303 | 470 | 431 | 746 | 559 | 540 | 687 | 805 | 815 | 849 | 943 | 981 |
| 48 | 34 | 176 | 150 | 304 | 184 | 432 | 453 | 560 | 240 | 688 | 514 | 816 | 568 | 944 | 838 |
| 49 | 59 | 177 | 217 | 305 | 260 | 433 | 539 | 561 | 323 | 689 | 614 | 817 | 667 | 945 | 892 |
| 50 | 70 | 178 | 238 | 306 | 282 | 434 | 567 | 562 | 352 | 690 | 641 | 818 | 691 | 946 | 907 |
| 51 | 109 | 179 | 306 | 307 | 358 | 435 | 650 | 563 | 439 | 691 | 717 | 819 | 765 | 947 | 946 |
| 52 | 77 | 180 | 250 | 308 | 292 | 436 | 584 | 564 | 368 | 692 | 656 | 820 | 702 | 948 | 916 |
| 53 | 118 | 181 | 319 | 309 | 379 | 437 | 669 | 565 | 456 | 693 | 730 | 821 | 782 | 949 | 954 |
| 54 | 125 | 182 | 338 | 310 | 395 | 438 | 692 | 566 | 469 | 694 | 747 | 822 | 796 | 950 | 963 |
| 55 | 183 | 183 | 424 | 311 | 487 | 439 | 764 | 567 | 566 | 695 | 818 | 823 | 860 | 951 | 986 |
| 56 | 87 | 184 | 265 | 312 | 312 | 440 | 598 | 568 | 391 | 696 | 673 | 824 | 723 | 952 | 923 |
| 57 | 131 | 185 | 353 | 313 | 410 | 441 | 683 | 569 | 480 | 697 | 761 | 825 | 807 | 953 | 959 |
| 58 | 142 | 186 | 364 | 314 | 422 | 442 | 710 | 570 | 498 | 698 | 770 | 826 | 816 | 954 | 969 |
| 59 | 197 | 187 | 440 | 315 | 507 | 443 | 804 | 571 | 586 | 699 | 829 | 827 | 872 | 955 | 997 |
| 60 | 148 | 188 | 388 | 316 | 437 | 444 | 729 | 572 | 508 | 700 | 790 | 828 | 826 | 956 | 976 |
| 61 | 216 | 189 | 479 | 317 | 531 | 445 | 779 | 573 | 613 | 701 | 855 | 829 | 887 | 957 | 990 |
| 62 | 225 | 190 | 503 | 318 | 550 | 446 | 817 | 574 | 625 | 702 | 870 | 830 | 898 | 958 | 1000 |
| 63 | 327 | 191 | 612 | 319 | 653 | 447 | 911 | 575 | 737 | 703 | 930 | 831 | 947 | 959 | 1016 |
| 64 | 8 | 192 | 72 | 320 | 94 | 448 | 314 | 576 | 112 | 704 | 357 | 832 | 408 | 960 | 724 |
| 65 | 24 | 193 | 117 | 321 | 157 | 449 | 382 | 577 | 201 | 705 | 454 | 833 | 526 | 961 | 785 |
| 66 | 20 | 194 | 135 | 322 | 144 | 450 | 414 | 578 | 181 | 706 | 486 | 834 | 502 | 962 | 810 |
| 67 | 52 | 195 | 200 | 323 | 241 | 451 | 515 | 579 | 301 | 707 | 592 | 835 | 644 | 963 | 878 |
| 68 | 35 | 196 | 145 | 324 | 178 | 452 | 442 | 580 | 244 | 708 | 504 | 836 | 559 | 964 | 830 |
| 69 | 57 | 197 | 214 | 325 | 262 | 453 | 533 | 581 | 316 | 709 | 611 | 837 | 670 | 965 | 888 |
| 70 | 65 | 198 | 223 | 326 | 257 | 454 | 548 | 582 | 337 | 710 | 623 | 838 | 664 | 966 | 897 |
| 71 | 106 | 199 | 308 | 327 | 359 | 455 | 645 | 583 | 432 | 711 | 718 | 839 | 766 | 967 | 944 |
| 72 | 30 | 200 | 158 | 328 | 202 | 456 | 476 | 584 | 228 | 712 | 528 | 840 | 593 | 968 | 853 |
| 73 | 73 | 201 | 222 | 329 | 273 | 457 | 569 | 585 | 360 | 713 | 621 | 841 | 682 | 969 | 908 |
| 74 | 60 | 202 | 239 | 330 | 287 | 458 | 560 | 586 | 326 | 714 | 643 | 842 | 698 | 970 | 904 |
| 75 | 114 | 203 | 328 | 331 | 383 | 459 | 677 | 587 | 448 | 715 | 738 | 843 | 786 | 971 | 957 |
| 76 | 79 | 204 | 254 | 332 | 300 | 460 | 591 | 588 | 373 | 716 | 660 | 844 | 711 | 972 | 920 |
| 77 | 123 | 205 | 348 | 333 | 392 | 461 | 661 | 589 | 465 | 717 | 757 | 845 | 793 | 973 | 951 |
| 78 | 132 | 206 | 363 | 334 | 415 | 462 | 694 | 590 | 482 | 718 | 769 | 846 | 811 | 974 | 964 |
| 79 | 192 | 207 | 449 | 335 | 512 | 463 | 783 | 591 | 579 | 719 | 835 | 847 | 875 | 975 | 991 |
| 80 | 42 | 208 | 170 | 336 | 211 | 464 | 491 | 592 | 270 | 720 | 547 | 848 | 606 | 976 | 862 |
| 81 | 67 | 209 | 247 | 337 | 289 | 465 | 573 | 593 | 343 | 721 | 652 | 849 | 699 | 977 | 910 |
| 82 | 81 | 210 | 264 | 338 | 305 | 466 | 605 | 594 | 378 | 722 | 671 | 850 | 715 | 978 | 926 |

| | | | | | | | | | | | | | | | |
|---|---|---|---|---|---|---|---|---|---|---|---|---|---|---|---|
| 83 | 136 | 211 | 342 | 339 | 397 | 467 | 704 | 595 | 488 | 723 | 751 | 851 | 797 | 979 | 967 |
| 84 | 89 | 212 | 278 | 340 | 333 | 468 | 622 | 596 | 396 | 724 | 687 | 852 | 743 | 980 | 934 |
| 85 | 126 | 213 | 355 | 341 | 419 | 469 | 689 | 597 | 471 | 725 | 762 | 853 | 814 | 981 | 962 |
| 86 | 140 | 214 | 380 | 342 | 446 | 470 | 736 | 598 | 496 | 726 | 784 | 854 | 833 | 982 | 978 |
| 87 | 205 | 215 | 466 | 343 | 523 | 471 | 795 | 599 | 599 | 727 | 846 | 855 | 883 | 983 | 995 |
| 88 | 100 | 216 | 293 | 344 | 345 | 472 | 642 | 600 | 420 | 728 | 703 | 856 | 754 | 984 | 943 |
| 89 | 153 | 217 | 387 | 345 | 438 | 473 | 742 | 601 | 520 | 729 | 789 | 857 | 828 | 985 | 980 |
| 90 | 159 | 218 | 400 | 346 | 455 | 474 | 713 | 602 | 530 | 730 | 799 | 858 | 839 | 986 | 970 |
| 91 | 220 | 219 | 485 | 347 | 544 | 475 | 808 | 603 | 618 | 731 | 859 | 859 | 894 | 987 | 998 |
| 92 | 173 | 220 | 417 | 348 | 478 | 476 | 760 | 604 | 551 | 732 | 812 | 860 | 854 | 988 | 985 |
| 93 | 243 | 221 | 513 | 349 | 571 | 477 | 832 | 605 | 648 | 733 | 877 | 861 | 909 | 989 | 1003 |
| 94 | 253 | 222 | 529 | 350 | 587 | 478 | 842 | 606 | 659 | 734 | 886 | 862 | 917 | 990 | 1005 |
| 95 | 350 | 223 | 637 | 351 | 686 | 479 | 896 | 607 | 758 | 735 | 941 | 863 | 961 | 991 | 1014 |
| 96 | 47 | 224 | 194 | 352 | 237 | 480 | 527 | 608 | 288 | 736 | 583 | 864 | 639 | 992 | 885 |
| 97 | 83 | 225 | 266 | 353 | 309 | 481 | 615 | 609 | 384 | 737 | 675 | 865 | 720 | 993 | 931 |
| 98 | 96 | 226 | 285 | 354 | 330 | 482 | 634 | 610 | 411 | 738 | 695 | 866 | 740 | 994 | 940 |
| 99 | 152 | 227 | 372 | 355 | 428 | 483 | 716 | 611 | 518 | 739 | 777 | 867 | 820 | 995 | 971 |
| 100 | 103 | 228 | 315 | 356 | 361 | 484 | 663 | 612 | 427 | 740 | 725 | 868 | 767 | 996 | 952 |
| 101 | 146 | 229 | 390 | 357 | 462 | 485 | 732 | 613 | 506 | 741 | 792 | 869 | 844 | 997 | 977 |
| 102 | 163 | 230 | 405 | 358 | 472 | 486 | 749 | 614 | 536 | 742 | 803 | 870 | 850 | 998 | 982 |
| 103 | 231 | 231 | 497 | 359 | 558 | 487 | 822 | 615 | 633 | 743 | 866 | 871 | 902 | 999 | 1001 |
| 104 | 115 | 232 | 321 | 360 | 371 | 488 | 680 | 616 | 450 | 744 | 731 | 872 | 776 | 1000 | 958 |
| 105 | 168 | 233 | 426 | 361 | 457 | 489 | 753 | 617 | 543 | 745 | 819 | 873 | 840 | 1001 | 983 |
| 106 | 185 | 234 | 435 | 362 | 489 | 490 | 787 | 618 | 570 | 746 | 825 | 874 | 861 | 1002 | 993 |
| 107 | 245 | 235 | 521 | 363 | 576 | 491 | 858 | 619 | 649 | 747 | 881 | 875 | 912 | 1003 | 1008 |
| 108 | 193 | 236 | 451 | 364 | 509 | 492 | 768 | 620 | 581 | 748 | 837 | 876 | 873 | 1004 | 987 |
| 109 | 261 | 237 | 541 | 365 | 596 | 493 | 827 | 621 | 668 | 749 | 893 | 877 | 922 | 1005 | 1002 |
| 110 | 275 | 238 | 556 | 366 | 620 | 494 | 869 | 622 | 684 | 750 | 901 | 878 | 933 | 1006 | 1010 |
| 111 | 367 | 239 | 658 | 367 | 707 | 495 | 937 | 623 | 773 | 751 | 950 | 879 | 968 | 1007 | 1019 |
| 112 | 129 | 240 | 341 | 368 | 402 | 496 | 700 | 624 | 475 | 752 | 750 | 880 | 801 | 1008 | 966 |
| 113 | 179 | 241 | 412 | 369 | 501 | 497 | 800 | 625 | 561 | 753 | 809 | 881 | 868 | 1009 | 996 |
| 114 | 199 | 242 | 460 | 370 | 517 | 498 | 775 | 626 | 590 | 754 | 843 | 882 | 879 | 1010 | 989 |
| 115 | 271 | 243 | 546 | 371 | 610 | 499 | 847 | 627 | 679 | 755 | 895 | 883 | 929 | 1011 | 1006 |
| 116 | 208 | 244 | 481 | 372 | 537 | 500 | 813 | 628 | 602 | 756 | 856 | 884 | 891 | 1012 | 999 |
| 117 | 280 | 245 | 565 | 373 | 632 | 501 | 889 | 629 | 690 | 757 | 906 | 885 | 939 | 1013 | 1013 |
| 118 | 302 | 246 | 582 | 374 | 600 | 502 | 864 | 630 | 712 | 758 | 915 | 886 | 924 | 1014 | 1009 |
| 119 | 385 | 247 | 672 | 375 | 739 | 503 | 928 | 631 | 788 | 759 | 955 | 887 | 979 | 1015 | 1018 |
| 120 | 233 | 248 | 499 | 376 | 552 | 504 | 836 | 632 | 635 | 760 | 867 | 888 | 899 | 1016 | 1004 |

| 121 | 295 | 249 | 589 | 377 | 647 | 505 | 876 | 633 | 705 | 761 | 918 | 889 | 945 | 1017 | 1011 |
|---|---|---|---|---|---|---|---|---|---|---|---|---|---|---|---|
| 122 | 318 | 250 | 608 | 378 | 666 | 506 | 903 | 634 | 728 | 762 | 927 | 890 | 953 | 1018 | 1015 |
| 123 | 404 | 251 | 697 | 379 | 719 | 507 | 948 | 635 | 802 | 763 | 965 | 891 | 972 | 1019 | 1020 |
| 124 | 335 | 252 | 627 | 380 | 674 | 508 | 919 | 636 | 744 | 764 | 936 | 892 | 956 | 1020 | 1017 |
| 125 | 430 | 253 | 726 | 381 | 771 | 509 | 960 | 637 | 821 | 765 | 975 | 893 | 988 | 1021 | 1021 |
| 126 | 459 | 254 | 756 | 382 | 791 | 510 | 974 | 638 | 841 | 766 | 984 | 894 | 994 | 1022 | 1022 |
| 127 | 580 | 255 | 852 | 383 | 882 | 511 | 992 | 639 | 914 | 767 | 1007 | 895 | 1012 | 1023 | 1023 |

Sequence Z27, having a sequence length of 512:

[0, 1, 4, 9, 2, 11, 7, 25, 3, 14, 17, 28, 10, 34, 36, 65, 5, 16, 12, 31, 22, 37, 46, 70, 20, 48, 39, 77, 53, 84, 92, 145, 6, 15, 24, 41, 18, 47, 43, 80, 27, 51, 59, 87, 62, 99, 104, 149, 32, 56, 66, 101, 72, 109, 115, 163, 81, 120, 129, 174, 134, 189, 196, 269, 8, 23, 19, 49, 33, 54, 61, 98, 29, 69, 57, 105, 74, 113, 121, 170, 40, 63, 76, 124, 83, 116, 128, 181, 93, 139, 144, 192, 155, 210, 217, 284, 45, 78, 89, 138, 96, 133, 147, 201, 106, 151, 165, 211, 171, 223, 233, 295, 118, 160, 176, 230, 183, 237, 252, 306, 202, 247, 263, 317, 274, 332, 348, 409, 13, 26, 38, 67, 30, 75, 60, 122, 44, 71, 82, 130, 90, 141, 146, 197, 52, 85, 94, 135, 102, 156, 161, 212, 114, 154, 169, 221, 182, 239, 249, 300, 58, 97, 110, 158, 107, 162, 173, 228, 126, 175, 191, 241, 199, 253, 267, 319, 136, 190, 206, 255, 215, 264, 276, 329, 226, 286, 293, 338, 308, 359, 371, 423, 68, 108, 123, 177, 132, 188, 195, 256, 143, 194, 207, 270, 218, 283, 292, 343, 153, 213, 225, 279, 235, 287, 303, 352, 246, 307, 315, 362, 325, 377, 385, 433, 172, 227, 240, 298, 261, 309, 318, 368, 265, 330, 335, 381, 344, 391, 398, 441, 278, 322, 349, 393, 360, 402, 410, 446, 369, 413, 421, 455, 429, 464, 473, 495, 21, 35, 42, 79, 55, 86, 95, 148, 50, 91, 103, 157, 112, 167, 179, 236, 64, 100, 119, 166, 127, 180, 187, 250, 137, 193, 204, 258, 214, 275, 280, 333, 73, 117, 125, 186, 140, 203, 198, 266, 152, 209, 219, 277, 229, 294, 296, 354, 164, 222, 238, 289, 245, 302, 312, 363, 259, 321, 328, 373, 336, 386, 395, 439, 88, 142, 131, 208, 159, 224, 220, 290, 178, 232, 242, 305, 251, 310, 324, 376, 185, 243, 254, 313, 273, 326, 341, 382, 281, 337, 346, 392, 358, 405, 412, 451, 205, 257, 271, 331, 291, 350, 355, 399, 297, 347, 364, 407, 374, 416, 426, 458, 316, 370, 379, 422, 389, 431, 418, 468, 396, 437, 444, 462, 447, 477, 482, 500, 111, 168, 150, 231, 184, 244, 248, 320, 200, 262, 268, 334, 282, 342, 353, 401, 216, 272, 288, 340, 301, 351, 366, 408, 311, 372, 361, 415, 383, 425, 430, 463, 234, 299, 285, 356, 314, 367, 375, 419, 327, 380, 388, 434, 397, 428, 440, 470, 345, 390, 403, 438, 411, 445, 453, 475, 417, 450, 459, 485, 465, 479, 488, 504, 260, 304, 323, 378, 339, 387, 394, 436, 357, 404, 400, 448, 414, 442, 454, 480, 365, 406, 420, 457, 427, 452, 467, 483, 435, 469, 460, 486, 474, 491, 493, 502, 384, 424, 432, 461, 443, 466, 471, 489, 449, 472, 481, 496, 476, 490, 498, 507, 456, 484, 478, 494, 487, 501, 497, 506, 492, 499, 503, 508, 505, 509, 510, 511]

## Table Z27, having a sequence length of 512:

| Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability |
|---|---|---|---|---|---|---|---|---|---|---|---|---|---|---|---|
| 0 | 0 | 64 | 8 | 128 | 13 | 192 | 68 | 256 | 21 | 320 | 88 | 384 | 111 | 448 | 260 |
| 1 | 1 | 65 | 23 | 129 | 26 | 193 | 108 | 257 | 35 | 321 | 142 | 385 | 168 | 449 | 304 |
| 2 | 4 | 66 | 19 | 130 | 38 | 194 | 123 | 258 | 42 | 322 | 131 | 386 | 150 | 450 | 323 |
| 3 | 9 | 67 | 49 | 131 | 67 | 195 | 177 | 259 | 79 | 323 | 208 | 387 | 231 | 451 | 378 |
| 4 | 2 | 68 | 33 | 132 | 30 | 196 | 132 | 260 | 55 | 324 | 159 | 388 | 184 | 452 | 339 |
| 5 | 11 | 69 | 54 | 133 | 75 | 197 | 188 | 261 | 86 | 325 | 224 | 389 | 244 | 453 | 387 |
| 6 | 7 | 70 | 61 | 134 | 60 | 198 | 195 | 262 | 95 | 326 | 220 | 390 | 248 | 454 | 394 |
| 7 | 25 | 71 | 98 | 135 | 122 | 199 | 256 | 263 | 148 | 327 | 290 | 391 | 320 | 455 | 436 |
| 8 | 3 | 72 | 29 | 136 | 44 | 200 | 143 | 264 | 50 | 328 | 178 | 392 | 200 | 456 | 357 |
| 9 | 14 | 73 | 69 | 137 | 71 | 201 | 194 | 265 | 91 | 329 | 232 | 393 | 262 | 457 | 404 |
| 10 | 17 | 74 | 57 | 138 | 82 | 202 | 207 | 266 | 103 | 330 | 242 | 394 | 268 | 458 | 400 |
| 11 | 28 | 75 | 105 | 139 | 130 | 203 | 270 | 267 | 157 | 331 | 305 | 395 | 334 | 459 | 448 |
| 12 | 10 | 76 | 74 | 140 | 90 | 204 | 218 | 268 | 112 | 332 | 251 | 396 | 282 | 460 | 414 |
| 13 | 34 | 77 | 113 | 141 | 141 | 205 | 283 | 269 | 167 | 333 | 310 | 397 | 342 | 461 | 442 |
| 14 | 36 | 78 | 121 | 142 | 146 | 206 | 292 | 270 | 179 | 334 | 324 | 398 | 353 | 462 | 454 |
| 15 | 65 | 79 | 170 | 143 | 197 | 207 | 343 | 271 | 236 | 335 | 376 | 399 | 401 | 463 | 480 |
| 16 | 5 | 80 | 40 | 144 | 52 | 208 | 153 | 272 | 64 | 336 | 185 | 400 | 216 | 464 | 365 |
| 17 | 16 | 81 | 63 | 145 | 85 | 209 | 213 | 273 | 100 | 337 | 243 | 401 | 272 | 465 | 406 |
| 18 | 12 | 82 | 76 | 146 | 94 | 210 | 225 | 274 | 119 | 338 | 254 | 402 | 288 | 466 | 420 |
| 19 | 31 | 83 | 124 | 147 | 135 | 211 | 279 | 275 | 166 | 339 | 313 | 403 | 340 | 467 | 457 |
| 20 | 22 | 84 | 83 | 148 | 102 | 212 | 235 | 276 | 127 | 340 | 273 | 404 | 301 | 468 | 427 |
| 21 | 37 | 85 | 116 | 149 | 156 | 213 | 287 | 277 | 180 | 341 | 326 | 405 | 351 | 469 | 452 |
| 22 | 46 | 86 | 128 | 150 | 161 | 214 | 303 | 278 | 187 | 342 | 341 | 406 | 366 | 470 | 467 |
| 23 | 70 | 87 | 181 | 151 | 212 | 215 | 352 | 279 | 250 | 343 | 382 | 407 | 408 | 471 | 483 |
| 24 | 20 | 88 | 93 | 152 | 114 | 216 | 246 | 280 | 137 | 344 | 281 | 408 | 311 | 472 | 435 |
| 25 | 48 | 89 | 139 | 153 | 154 | 217 | 307 | 281 | 193 | 345 | 337 | 409 | 372 | 473 | 469 |
| 26 | 39 | 90 | 144 | 154 | 169 | 218 | 315 | 282 | 204 | 346 | 346 | 410 | 361 | 474 | 460 |
| 27 | 77 | 91 | 192 | 155 | 221 | 219 | 362 | 283 | 258 | 347 | 392 | 411 | 415 | 475 | 486 |
| 28 | 53 | 92 | 155 | 156 | 182 | 220 | 325 | 284 | 214 | 348 | 358 | 412 | 383 | 476 | 474 |
| 29 | 84 | 93 | 210 | 157 | 239 | 221 | 377 | 285 | 275 | 349 | 405 | 413 | 425 | 477 | 491 |
| 30 | 92 | 94 | 217 | 158 | 249 | 222 | 385 | 286 | 280 | 350 | 412 | 414 | 430 | 478 | 493 |
| 31 | 145 | 95 | 284 | 159 | 300 | 223 | 433 | 287 | 333 | 351 | 451 | 415 | 463 | 479 | 502 |

| | | | | | | | | | | | | | | | |
|---|---|---|---|---|---|---|---|---|---|---|---|---|---|---|---|
| 32 | 6 | 96 | 45 | 160 | 58 | 224 | 172 | 288 | 73 | 352 | 205 | 416 | 234 | 480 | 384 |
| 33 | 15 | 97 | 78 | 161 | 97 | 225 | 227 | 289 | 117 | 353 | 257 | 417 | 299 | 481 | 424 |
| 34 | 24 | 98 | 89 | 162 | 110 | 226 | 240 | 290 | 125 | 354 | 271 | 418 | 285 | 482 | 432 |
| 35 | 41 | 99 | 138 | 163 | 158 | 227 | 298 | 291 | 186 | 355 | 331 | 419 | 356 | 483 | 461 |
| 36 | 18 | 100 | 96 | 164 | 107 | 228 | 261 | 292 | 140 | 356 | 291 | 420 | 314 | 484 | 443 |
| 37 | 47 | 101 | 133 | 165 | 162 | 229 | 309 | 293 | 203 | 357 | 350 | 421 | 367 | 485 | 466 |
| 38 | 43 | 102 | 147 | 166 | 173 | 230 | 318 | 294 | 198 | 358 | 355 | 422 | 375 | 486 | 471 |
| 39 | 80 | 103 | 201 | 167 | 228 | 231 | 368 | 295 | 266 | 359 | 399 | 423 | 419 | 487 | 489 |
| 40 | 27 | 104 | 106 | 168 | 126 | 232 | 265 | 296 | 152 | 360 | 297 | 424 | 327 | 488 | 449 |
| 41 | 51 | 105 | 151 | 169 | 175 | 233 | 330 | 297 | 209 | 361 | 347 | 425 | 380 | 489 | 472 |
| 42 | 59 | 106 | 165 | 170 | 191 | 234 | 335 | 298 | 219 | 362 | 364 | 426 | 388 | 490 | 481 |
| 43 | 87 | 107 | 211 | 171 | 241 | 235 | 381 | 299 | 277 | 363 | 407 | 427 | 434 | 491 | 496 |
| 44 | 62 | 108 | 171 | 172 | 199 | 236 | 344 | 300 | 229 | 364 | 374 | 428 | 397 | 492 | 476 |
| 45 | 99 | 109 | 223 | 173 | 253 | 237 | 391 | 301 | 294 | 365 | 416 | 429 | 428 | 493 | 490 |
| 46 | 104 | 110 | 233 | 174 | 267 | 238 | 398 | 302 | 296 | 366 | 426 | 430 | 440 | 494 | 498 |
| 47 | 149 | 111 | 295 | 175 | 319 | 239 | 441 | 303 | 354 | 367 | 458 | 431 | 470 | 495 | 507 |
| 48 | 32 | 112 | 118 | 176 | 136 | 240 | 278 | 304 | 164 | 368 | 316 | 432 | 345 | 496 | 456 |
| 49 | 56 | 113 | 160 | 177 | 190 | 241 | 322 | 305 | 222 | 369 | 370 | 433 | 390 | 497 | 484 |
| 50 | 66 | 114 | 176 | 178 | 206 | 242 | 349 | 306 | 238 | 370 | 379 | 434 | 403 | 498 | 478 |
| 51 | 101 | 115 | 230 | 179 | 255 | 243 | 393 | 307 | 289 | 371 | 422 | 435 | 438 | 499 | 494 |
| 52 | 72 | 116 | 183 | 180 | 215 | 244 | 360 | 308 | 245 | 372 | 389 | 436 | 411 | 500 | 487 |
| 53 | 109 | 117 | 237 | 181 | 264 | 245 | 402 | 309 | 302 | 373 | 431 | 437 | 445 | 501 | 501 |
| 54 | 115 | 118 | 252 | 182 | 276 | 246 | 410 | 310 | 312 | 374 | 418 | 438 | 453 | 502 | 497 |
| 55 | 163 | 119 | 306 | 183 | 329 | 247 | 446 | 311 | 363 | 375 | 468 | 439 | 475 | 503 | 506 |
| 56 | 81 | 120 | 202 | 184 | 226 | 248 | 369 | 312 | 259 | 376 | 396 | 440 | 417 | 504 | 492 |
| 57 | 120 | 121 | 247 | 185 | 286 | 249 | 413 | 313 | 321 | 377 | 437 | 441 | 450 | 505 | 499 |
| 58 | 129 | 122 | 263 | 186 | 293 | 250 | 421 | 314 | 328 | 378 | 444 | 442 | 459 | 506 | 503 |
| 59 | 174 | 123 | 317 | 187 | 338 | 251 | 455 | 315 | 373 | 379 | 462 | 443 | 485 | 507 | 508 |
| 60 | 134 | 124 | 274 | 188 | 308 | 252 | 429 | 316 | 336 | 380 | 447 | 444 | 465 | 508 | 505 |
| 61 | 189 | 125 | 332 | 189 | 359 | 253 | 464 | 317 | 386 | 381 | 477 | 445 | 479 | 509 | 509 |
| 62 | 196 | 126 | 348 | 190 | 371 | 254 | 473 | 318 | 395 | 382 | 482 | 446 | 488 | 510 | 510 |
| 63 | 269 | 127 | 409 | 191 | 423 | 255 | 495 | 319 | 439 | 383 | 500 | 447 | 504 | 511 | 511 |

Sequence Z28, having a sequence length of 256:
[0, 1, 4, 9, 2, 11, 7, 24, 3, 14, 17, 27, 10, 33, 34, 59, 5, 16, 12, 30, 21, 35, 43, 64, 20, 45, 37, 70, 49, 76, 81, 121, 6, 15, 23, 39, 18, 44, 40, 72, 26, 47, 54, 78, 57, 87, 90, 124, 31, 51, 60, 88, 66, 95, 99, 134, 73, 102, 109, 141, 113, 149, 155, 194, 8, 22, 19, 46, 32, 50, 56, 86, 28, 63, 52, 91, 67, 97, 103, 137, 38, 58, 69, 106, 75, 100, 108, 145, 82, 117, 120, 152, 128, 162, 167, 201, 42, 71, 79, 116, 84, 112, 123, 158, 92, 125, 135, 163, 138, 170, 176, 206, 101, 131, 143, 175, 147, 178, 185, 210, 159, 183, 190, 215, 196, 222, 227, 243, 13, 25, 36, 61, 29, 68, 55, 104, 41, 65, 74, 110, 80, 118, 122, 156, 48, 77, 83, 114, 89, 129, 132, 164, 98, 127, 136, 169, 146, 179, 184, 208, 53, 85, 96, 130, 93, 133, 140, 174, 107, 142, 151, 181, 157, 186, 193, 217, 115, 150, 160, 187, 166, 191, 197, 220, 172, 202, 205, 224, 212, 230, 235, 247, 62, 94, 105, 144, 111, 148, 154, 188, 119, 153, 161, 195, 168, 200, 204, 225, 126, 165, 171, 199, 177, 203, 209, 229, 182, 211, 214, 232, 219, 236, 238, 249, 139, 173, 180, 207, 189, 213, 216, 233, 192, 221, 223, 237, 226, 239, 241, 250, 198, 218, 228, 240, 231, 242, 244, 251, 234, 245, 246, 252, 248, 253, 254, 255]

Table Z28, having a sequence length of 256:

| Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability |
|---|---|---|---|---|---|---|---|---|---|---|---|---|---|---|---|
| 0 | 0 | 32 | 6 | 64 | 8 | 96 | 42 | 128 | 13 | 160 | 53 | 192 | 62 | 224 | 139 |
| 1 | 1 | 33 | 15 | 65 | 22 | 97 | 71 | 129 | 25 | 161 | 85 | 193 | 94 | 225 | 173 |
| 2 | 4 | 34 | 23 | 66 | 19 | 98 | 79 | 130 | 36 | 162 | 96 | 194 | 105 | 226 | 180 |
| 3 | 9 | 35 | 39 | 67 | 46 | 99 | 116 | 131 | 61 | 163 | 130 | 195 | 144 | 227 | 207 |
| 4 | 2 | 36 | 18 | 68 | 32 | 100 | 84 | 132 | 29 | 164 | 93 | 196 | 111 | 228 | 189 |
| 5 | 11 | 37 | 44 | 69 | 50 | 101 | 112 | 133 | 68 | 165 | 133 | 197 | 148 | 229 | 213 |
| 6 | 7 | 38 | 40 | 70 | 56 | 102 | 123 | 134 | 55 | 166 | 140 | 198 | 154 | 230 | 216 |
| 7 | 24 | 39 | 72 | 71 | 86 | 103 | 158 | 135 | 104 | 167 | 174 | 199 | 188 | 231 | 233 |
| 8 | 3 | 40 | 26 | 72 | 28 | 104 | 92 | 136 | 41 | 168 | 107 | 200 | 119 | 232 | 192 |
| 9 | 14 | 41 | 47 | 73 | 63 | 105 | 125 | 137 | 65 | 169 | 142 | 201 | 153 | 233 | 221 |
| 10 | 17 | 42 | 54 | 74 | 52 | 106 | 135 | 138 | 74 | 170 | 151 | 202 | 161 | 234 | 223 |
| 11 | 27 | 43 | 78 | 75 | 91 | 107 | 163 | 139 | 110 | 171 | 181 | 203 | 195 | 235 | 237 |
| 12 | 10 | 44 | 57 | 76 | 67 | 108 | 138 | 140 | 80 | 172 | 157 | 204 | 168 | 236 | 226 |
| 13 | 33 | 45 | 87 | 77 | 97 | 109 | 170 | 141 | 118 | 173 | 186 | 205 | 200 | 237 | 239 |
| 14 | 34 | 46 | 90 | 78 | 103 | 110 | 176 | 142 | 122 | 174 | 193 | 206 | 204 | 238 | 241 |
| 15 | 59 | 47 | 124 | 79 | 137 | 111 | 206 | 143 | 156 | 175 | 217 | 207 | 225 | 239 | 250 |
| 16 | 5 | 48 | 31 | 80 | 38 | 112 | 101 | 144 | 48 | 176 | 115 | 208 | 126 | 240 | 198 |
| 17 | 16 | 49 | 51 | 81 | 58 | 113 | 131 | 145 | 77 | 177 | 150 | 209 | 165 | 241 | 218 |
| 18 | 12 | 50 | 60 | 82 | 69 | 114 | 143 | 146 | 83 | 178 | 160 | 210 | 171 | 242 | 228 |
| 19 | 30 | 51 | 88 | 83 | 106 | 115 | 175 | 147 | 114 | 179 | 187 | 211 | 199 | 243 | 240 |
| 20 | 21 | 52 | 66 | 84 | 75 | 116 | 147 | 148 | 89 | 180 | 166 | 212 | 177 | 244 | 231 |
| 21 | 35 | 53 | 95 | 85 | 100 | 117 | 178 | 149 | 129 | 181 | 191 | 213 | 203 | 245 | 242 |

| 22 | 43 | 54 | 99 | 86 | 108 | 118 | 185 | 150 | 132 | 182 | 197 | 214 | 209 | 246 | 244 |
| 23 | 64 | 55 | 134 | 87 | 145 | 119 | 210 | 151 | 164 | 183 | 220 | 215 | 229 | 247 | 251 |
| 24 | 20 | 56 | 73 | 88 | 82 | 120 | 159 | 152 | 98 | 184 | 172 | 216 | 182 | 248 | 234 |
| 25 | 45 | 57 | 102 | 89 | 117 | 121 | 183 | 153 | 127 | 185 | 202 | 217 | 211 | 249 | 245 |
| 26 | 37 | 58 | 109 | 90 | 120 | 122 | 190 | 154 | 136 | 186 | 205 | 218 | 214 | 250 | 246 |
| 27 | 70 | 59 | 141 | 91 | 152 | 123 | 215 | 155 | 169 | 187 | 224 | 219 | 232 | 251 | 252 |
| 28 | 49 | 60 | 113 | 92 | 128 | 124 | 196 | 156 | 146 | 188 | 212 | 220 | 219 | 252 | 248 |
| 29 | 76 | 61 | 149 | 93 | 162 | 125 | 222 | 157 | 179 | 189 | 230 | 221 | 236 | 253 | 253 |
| 30 | 81 | 62 | 155 | 94 | 167 | 126 | 227 | 158 | 184 | 190 | 235 | 222 | 238 | 254 | 254 |
| 31 | 121 | 63 | 194 | 95 | 201 | 127 | 243 | 159 | 208 | 191 | 247 | 223 | 249 | 255 | 255 |

Sequence Z29, having a sequence length of 128:
[0, 1, 4, 9, 2, 11, 7, 23, 3, 13, 16, 25, 10, 30, 31, 51, 5, 15, 12, 27, 20, 32, 38, 54, 19, 40, 33, 58, 43, 63, 66, 90, 6, 14, 22, 35, 17, 39, 36, 60, 24, 42, 47, 64, 49, 70, 72, 92, 28, 45, 52, 71, 55, 75, 77, 96, 61, 80, 84, 100, 86, 104, 106, 119, 8, 21, 18, 41, 29, 44, 48, 69, 26, 53, 46, 73, 56, 76, 81, 98, 34, 50, 57, 82, 62, 78, 83, 102, 67, 88, 89, 105, 94, 109, 111, 121, 37, 59, 65, 87, 68, 85, 91, 107, 74, 93, 97, 110, 99, 112, 114, 122, 79, 95, 101, 113, 103, 115, 117, 123, 108, 116, 118, 124, 120, 125, 126, 127]

## Table Z29, having a sequence length of 128:

| Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability |
|---|---|---|---|---|---|---|---|---|---|---|---|---|---|---|---|
| 0 | 0 | 16 | 5 | 32 | 6 | 48 | 28 | 64 | 8 | 80 | 34 | 96 | 37 | 112 | 79 |
| 1 | 1 | 17 | 15 | 33 | 14 | 49 | 45 | 65 | 21 | 81 | 50 | 97 | 59 | 113 | 95 |
| 2 | 4 | 18 | 12 | 34 | 22 | 50 | 52 | 66 | 18 | 82 | 57 | 98 | 65 | 114 | 101 |
| 3 | 9 | 19 | 27 | 35 | 35 | 51 | 71 | 67 | 41 | 83 | 82 | 99 | 87 | 115 | 113 |
| 4 | 2 | 20 | 20 | 36 | 17 | 52 | 55 | 68 | 29 | 84 | 62 | 100 | 68 | 116 | 103 |
| 5 | 11 | 21 | 32 | 37 | 39 | 53 | 75 | 69 | 44 | 85 | 78 | 101 | 85 | 117 | 115 |
| 6 | 7 | 22 | 38 | 38 | 36 | 54 | 77 | 70 | 48 | 86 | 83 | 102 | 91 | 118 | 117 |
| 7 | 23 | 23 | 54 | 39 | 60 | 55 | 96 | 71 | 69 | 87 | 102 | 103 | 107 | 119 | 123 |
| 8 | 3 | 24 | 19 | 40 | 24 | 56 | 61 | 72 | 26 | 88 | 67 | 104 | 74 | 120 | 108 |
| 9 | 13 | 25 | 40 | 41 | 42 | 57 | 80 | 73 | 53 | 89 | 88 | 105 | 93 | 121 | 116 |
| 10 | 16 | 26 | 33 | 42 | 47 | 58 | 84 | 74 | 46 | 90 | 89 | 106 | 97 | 122 | 118 |

| 11 | 25 | 27 | 58 | 43 | 64 | 59 | 100 | 75 | 73 | 91 | 105 | 107 | 110 | 123 | 124 |
| 12 | 10 | 28 | 43 | 44 | 49 | 60 | 86 | 76 | 56 | 92 | 94 | 108 | 99 | 124 | 120 |
| 13 | 30 | 29 | 63 | 45 | 70 | 61 | 104 | 77 | 76 | 93 | 109 | 109 | 112 | 125 | 125 |
| 14 | 31 | 30 | 66 | 46 | 72 | 62 | 106 | 78 | 81 | 94 | 111 | 110 | 114 | 126 | 126 |
| 15 | 51 | 31 | 90 | 47 | 92 | 63 | 119 | 79 | 98 | 95 | 121 | 111 | 122 | 127 | 127 |

Sequence Z30, having a sequence length of 64:
[0, 1, 4, 8, 2, 10, 7, 20, 3, 12, 15, 22, 9, 25, 26, 39, 5, 14, 11, 23, 18, 27, 31, 41, 17, 33, 28, 43, 35, 46, 48, 57, 6, 13, 19, 29, 16, 32, 30, 44, 21, 34, 37, 47, 38, 49, 51, 58, 24, 36, 40, 50, 42, 52, 53, 59, 45, 54, 55, 60, 56, 61, 62, 63]

## Table Z30, having a sequence length of 64:

| Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability |
|---|---|---|---|---|---|---|---|---|---|---|---|---|---|---|---|
| 0 | 0 | 8 | 3 | 16 | 5 | 24 | 17 | 32 | 6 | 40 | 21 | 48 | 24 | 56 | 45 |
| 1 | 1 | 9 | 12 | 17 | 14 | 25 | 33 | 33 | 13 | 41 | 34 | 49 | 36 | 57 | 54 |
| 2 | 4 | 10 | 15 | 18 | 11 | 26 | 28 | 34 | 19 | 42 | 37 | 50 | 40 | 58 | 55 |
| 3 | 8 | 11 | 22 | 19 | 23 | 27 | 43 | 35 | 29 | 43 | 47 | 51 | 50 | 59 | 60 |
| 4 | 2 | 12 | 9 | 20 | 18 | 28 | 35 | 36 | 16 | 44 | 38 | 52 | 42 | 60 | 56 |
| 5 | 10 | 13 | 25 | 21 | 27 | 29 | 46 | 37 | 32 | 45 | 49 | 53 | 52 | 61 | 61 |
| 6 | 7 | 14 | 26 | 22 | 31 | 30 | 48 | 38 | 30 | 46 | 51 | 54 | 53 | 62 | 62 |
| 7 | 20 | 15 | 39 | 23 | 41 | 31 | 57 | 39 | 44 | 47 | 58 | 55 | 59 | 63 | 63 |

It should be noted that, the foregoing sequences are merely some examples. Use of the foregoing sequences in a polar code encoding process helps improve encoding/decoding performance of a polar code. In any one of the sequences described, adjustments or equivalent replacements in the following aspects may be made without affecting an overall effect.

1. Positions of a small quantity of elements in a sequence are interchanged. For example, a position of a sequence number may be adjusted within a specified range. For example, the specified range is 5, and a position of an element whose sequence number is 10 may be adjusted within five positions to the left or right.
2. Some of the elements in the sequence are adjusted, but channel sets for transmitting T bit information that are selected based on the sequence are consistent or similar.
3. The sequence includes N elements starting from 0 and ending with N-1, and the N elements starting from 0 and ending with N-1 represent sequence numbers of N polarized channels. Actually, the sequence numbers of the N polarized channels may also start from 1 and end with N. This can be achieved by adding 1 to each sequence number in the foregoing sequence, and this is also a sequence number form in the foregoing calculation manners. Certainly, the sequence number or an identifier of the foregoing polarized channel may also be represented by using another manner. The specific representation manner does not affect a specific position of a polarized channel in a sequence;
4. The sequence numbers of the N polarized channels in the foregoing sequence are arranged in ascending order of the reliability of the N polarized channels. In this case, selecting K polarized channels in descending order of reliability is selecting polarized channels that correspond to the last K sequence numbers in any of the foregoing sequences. Actually, the sequence numbers of the N polarized channels may also be arranged in descending order of the reliability of the N polarized channels. This can be achieved by arranging the elements in the foregoing sequence in a reverse or inverted order. In this case, selecting K polarized channels in descending order of reliability is selecting polarized channels that correspond to the first K sequence numbers; and

5. The foregoing sequences may further be represented by using a normalized reliability or an equivalent reliability of each channel. For example, if a sequential position of a channel x in the foregoing sequence is n (a leftmost position is denoted as 1), a reliability of the channel may be represented as n or normalized n/N, where N is a length of the sequence.

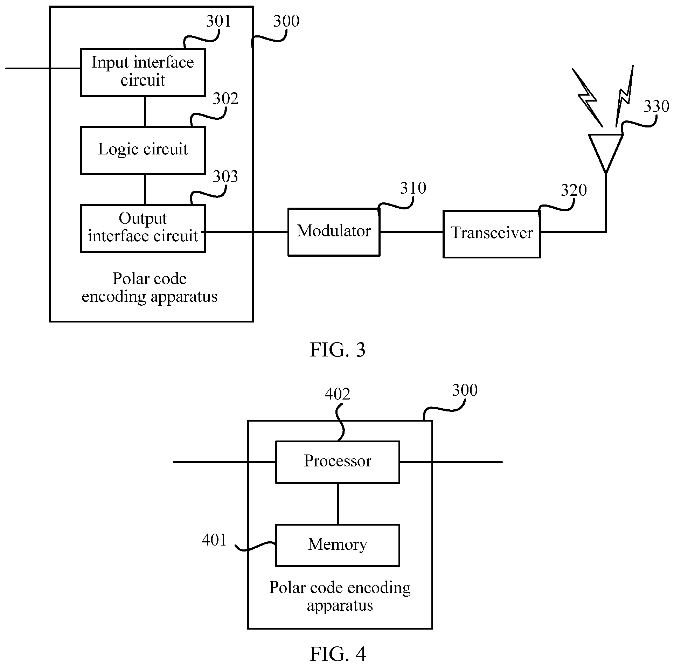

Based on a same invention concept of the polar code encoding method shown in FIG. 2, as shown in FIG. 3, an embodiment of this application further provides a polar code encoding apparatus 300. The polar code encoding apparatus 300 is configured to perform the polar code encoding method shown in FIG. 2. Part or all of the polar code encoding method shown in FIG. 3 may be implemented by using hardware or may be implemented by using software. When part or all of the polar code encoding method is implemented by using hardware, the polar code encoding apparatus 300 includes: an input interface circuit 301, configured to obtain to-be-encoded bits; a logic circuit 302, configured to perform the polar code encoding method shown in FIG. 2, where for details, refer to the descriptions in the foregoing method embodiments, and details are not described herein again; and an output interface circuit 303, configured to output a bit sequence after encoding.

Further, the bit sequence that is obtained after the encoding and that is output by the encoding apparatus 300 is output to a transceiver 320 after being modulated by a modulator 310. The transceiver 320 performs corresponding processing (including but not limited to processing such as digital-to-analog conversion and/or frequency conversion) on the modulated sequence and sends the processed sequence by using an antenna 330.

Optionally, the polar code encoding apparatus 300 may be a chip or an integrated circuit during specific implementation.

Optionally, when part or all of the polar code encoding method in the foregoing embodiment is implemented by using software, as shown in FIG. 4, the polar code encoding apparatus 300 includes: a memory 401, configured to store a program; a processor 402, configured to execute the program stored in the memory 401. When the program is executed, the polar code encoding apparatus 300 is caused to implement the polar code encoding method provided in the embodiment in FIG. 2.

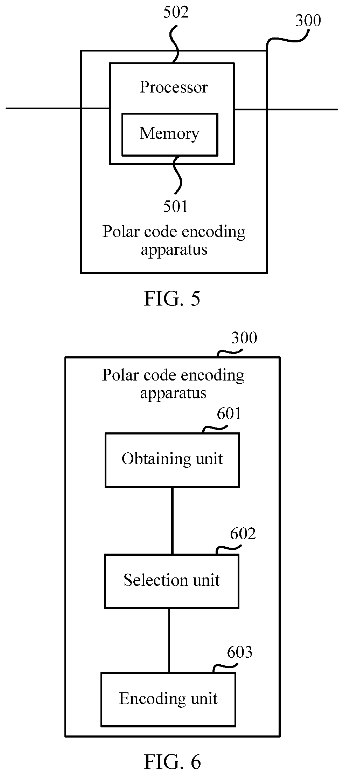

Optionally, the memory 401 may be a physically independent unit. Alternatively, as shown in FIG. 5, a memory 501 is integrated with a processor 502.

Optionally, when part of or all of the encoding method in the embodiment in FIG. 2 is implemented by using software, the polar code encoding apparatus 300 may include only the processor 402. The memory 401 configured to store the program is located outside the polar code encoding apparatus 300. The processor 402 is connected to the memory 401 by using a circuit/wire and is configured to read and execute the program stored in the memory 401.

The processor 402 may be a central processing unit (central processing unit, CPU), a network processor (network processor, NP), or a combination of a CPU and an NP.

The processor 402 may further include a hardware chip. The foregoing hardware chip may be an application-specific integrated circuit (application-specific integrated circuit, ASIC), a programmable logic device (programmable logic device, PLD), or a combination of an ASIC and a PLD. The foregoing PLD may be a complex programmable logical device (complex programmable logical device, CPLD), a field-programmable gate array (field-programmable gate array, FPGA), a generic array logic (generic array logic, GAL), or any combination thereof.

The memory in the foregoing embodiment may include a volatile memory (volatile memory), for example, a random-access memory (random-access memory, RAM). Alternatively, the memory may include a non-volatile memory (non-volatile memory), for example, a flash memory (flash memory), a hard disk drive (hard disk drive, HDD), or a solid-state drive (solid-state drive, SSD). Alternatively, the memory may include a combination of the foregoing types of memories.

Based on the polar code encoding method shown in FIG. 2, as shown in FIG. 6, an embodiment of this application further provides a polar code encoding apparatus 300. The polar code encoding apparatus 300 is configured to perform the polar code encoding method shown in FIG. 2. The polar code encoding apparatus 300 includes:

an obtaining unit 601, configured to obtain a first sequence used to encode K to-be-encoded bits, where the first sequence includes sequence numbers of N polarized channels, the sequence numbers of the N polarized channels are arranged in the first sequence based on reliability of the N polarized channels, K is a positive integer, N is a mother code length of a polar code, N is a positive integer power of 2, and $K \leq N$;

a selection unit 602, configured to select sequence numbers of K polarized channels from the first sequence in ascending order of the reliability; and

an encoding unit 603, configured to place the to-be-encoded bits based on the selected sequence numbers of the K polarized channels, and perform polar code encoding on the to-be-encoded bits.

The first sequence may be any one of the sequences described above, or may be a sequence obtained by selecting, from a second sequence having a length of $N_{max}$, sequence numbers (starting from 0) less than N. The second sequence may be any one of the sequences described above. A reliability of an $i^{th}$ polarized channel in the N polarized channels may be determined by using any one of the formulas described above.

An embodiment of this application further provides a computer storage medium storing a computer program. The computer program is configured to perform the polar code encoding method shown in FIG. 2.

An embodiment of this application further provides a computer program product including an instruction. When run on a computer, the instruction causes the computer to perform the polar code encoding method shown in FIG. 2.

Persons skilled in the art should understand that the embodiments of this application may be provided as a method, a system, or a computer program product. Therefore, this application may use a form of hardware only embodiments, software only embodiments, or embodiments with a combination of software and hardware. Moreover, this application may use a form of a computer program product that is implemented on one or more computer-usable storage media (including but not limited to a disk memory, a CD-ROM, an optical memory, and the like) that include computer usable program code.

This application is described with reference to the flowcharts and/or block diagrams of the method, the device (system), and the computer program product according to the embodiments of this application. It should be understood that computer program instructions may be used to implement each process and/or each block in the flowcharts and/or the block diagrams and a combination of a process and/or a block in the flowcharts and/or the block diagrams. These computer program instructions may be provided for a general-purpose computer, a dedicated computer, an embedded processor, or a processor of any other programmable data processing device to generate a machine, so that the instructions executed by a computer or a processor of any other programmable data processing device generate an apparatus for implementing a specific function in one or more processes in the flowcharts and/or in one or more blocks in the block diagrams.

These computer program instructions may be stored in a computer readable memory that can instruct the computer or any other programmable data processing device to work in a specific manner, so that the instructions stored in the computer readable memory generate an artifact that includes an instruction apparatus. The instruction apparatus implements a specific function in one or more processes in the flowcharts and/or in one or more blocks in the block diagrams.

These computer program instructions may be loaded onto a computer or another programmable data processing device, so that a series of operations and steps are performed on the computer or the another programmable device, thereby generating computer-implemented processing. Therefore, the instructions executed on the computer or the another programmable device provide steps for implementing a specific function in one or more processes in the flowcharts and/or in one or more blocks in the block diagrams.

Although some preferred embodiments of this application have been described, persons skilled in the art can make changes and modifications to these embodiments once they learn the basic inventive concept. Therefore, the following claims are intended to be construed as to cover the preferred embodiments and all changes and modifications falling within the scope of this application.

Obviously, persons skilled in the art can make various modifications and variations to the embodiments of this application without departing from the scope of the embodiments of this application. This application is intended to cover these modifications and variations provided that they fall within the scope of protection defined by the following claims and their equivalent technologies.

**Claims**

1. An encoding method performed by an encoding apparatus, comprising:

    obtaining (201) a first sequence used to encode K to-be-encoded bits, K being a positive integer, wherein the first sequence comprises sequence numbers of N polarized channels, the sequence numbers of the N polarized channels are arranged in the first sequence based on reliability of the N polarized channels, N is a mother code length of a polar code, $N = 2^n$, n is a positive integer, and $K \leq N$, wherein the first sequence is all of or a subset of a second sequence, the second sequence comprises sequence numbers of $N_{max}$ polarized channels, the sequence numbers of the $N_{max}$ polarized channels are arranged in the second sequence based on reliability of the $N_{max}$ polarized channels, an order in which the sequence numbers of the polarized channels in the first sequence are arranged is consistent with an order in which sequence numbers less than N in the sequence numbers of the polarized channels in the second sequence are arranged, $N \geq 64$, $N_{max}$ is a positive integer, $N_{max} \geq N$;

selecting (202) sequence numbers of K polarized channels from the first sequence based on a reliability order; and

placing (203) the K to-be-encoded bits based on the selected sequence numbers of the K polarized channels, and performing polar code encoding on the K to-be-encoded bits,

wherein $N_{max}=1024$, the second sequence is the sequence in Table Q11,

**characterized in that** the Table Q11 is:

| Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number |
|---|---|---|---|---|---|---|---|---|---|---|---|---|---|---|---|
| 0 | 0 | 128 | 518 | 256 | 94 | 384 | 214 | 512 | 364 | 640 | 414 | 768 | 819 | 896 | 966 |
| 1 | 1 | 129 | 54 | 257 | 204 | 385 | 309 | 513 | 654 | 641 | 223 | 769 | 814 | 897 | 755 |
| 2 | 2 | 130 | 83 | 258 | 298 | 386 | 188 | 514 | 659 | 642 | 663 | 770 | 439 | 898 | 859 |
| 3 | 4 | 131 | 57 | 259 | 400 | 387 | 449 | 515 | 335 | 643 | 692 | 771 | 929 | 899 | 940 |
| 4 | 8 | 132 | 521 | 260 | 608 | 388 | 217 | 516 | 480 | 644 | 835 | 772 | 490 | 900 | 830 |
| 5 | 16 | 133 | 112 | 261 | 352 | 389 | 408 | 517 | 315 | 645 | 619 | 773 | 623 | 901 | 911 |
| 6 | 32 | 134 | 135 | 262 | 325 | 390 | 609 | 518 | 221 | 646 | 472 | 774 | 671 | 902 | 871 |
| 7 | 3 | 135 | 78 | 263 | 533 | 391 | 596 | 519 | 370 | 647 | 455 | 775 | 739 | 903 | 639 |
| 8 | 5 | 136 | 289 | 264 | 155 | 392 | 551 | 520 | 613 | 648 | 796 | 776 | 916 | 904 | 888 |
| 9 | 64 | 137 | 194 | 265 | 210 | 393 | 650 | 521 | 422 | 649 | 809 | 777 | 463 | 905 | 479 |
| 10 | 9 | 138 | 85 | 266 | 305 | 394 | 229 | 522 | 425 | 650 | 714 | 778 | 843 | 906 | 946 |

| 11 | 6 | 139 | 276 | 267 | 547 | 395 | 159 | 523 | 451 | 651 | 721 | 779 | 381 | 907 | 750 |
|----|----|-----|-----|-----|-----|-----|-----|-----|-----|-----|-----|-----|-----|-----|-----|
| 12 | 17 | 140 | 522 | 268 | 300 | 396 | 420 | 524 | 614 | 652 | 837 | 780 | 497 | 908 | 969 |
| 13 | 10 | 141 | 58 | 269 | 109 | 397 | 310 | 525 | 543 | 653 | 716 | 781 | 930 | 909 | 508 |
| 14 | 18 | 142 | 168 | 270 | 184 | 398 | 541 | 526 | 235 | 654 | 864 | 782 | 821 | 910 | 861 |
| 15 | 128 | 143 | 139 | 271 | 534 | 399 | 773 | 527 | 412 | 655 | 810 | 783 | 726 | 911 | 757 |
| 16 | 12 | 144 | 99 | 272 | 537 | 400 | 610 | 528 | 343 | 656 | 606 | 784 | 961 | 912 | 970 |
| 17 | 33 | 145 | 86 | 273 | 115 | 401 | 657 | 529 | 372 | 657 | 912 | 785 | 872 | 913 | 919 |
| 18 | 65 | 146 | 60 | 274 | 167 | 402 | 333 | 530 | 775 | 658 | 722 | 786 | 492 | 914 | 875 |
| 19 | 20 | 147 | 280 | 275 | 225 | 403 | 119 | 531 | 317 | 659 | 696 | 787 | 631 | 915 | 862 |
| 20 | 256 | 148 | 89 | 276 | 326 | 404 | 600 | 532 | 222 | 660 | 377 | 788 | 729 | 916 | 758 |
| 21 | 34 | 149 | 290 | 277 | 306 | 405 | 339 | 533 | 426 | 661 | 435 | 789 | 700 | 917 | 948 |
| 22 | 24 | 150 | 529 | 278 | 772 | 406 | 218 | 534 | 453 | 662 | 817 | 790 | 443 | 918 | 977 |
| 23 | 36 | 151 | 524 | 279 | 157 | 407 | 368 | 535 | 237 | 663 | 319 | 791 | 741 | 919 | 923 |
| 24 | 7 | 152 | 196 | 280 | 656 | 408 | 652 | 536 | 559 | 664 | 621 | 792 | 845 | 920 | 972 |
| 25 | 129 | 153 | 141 | 281 | 329 | 409 | 230 | 537 | 833 | 665 | 812 | 793 | 920 | 921 | 761 |
| 26 | 66 | 154 | 101 | 282 | 110 | 410 | 391 | 538 | 804 | 666 | 484 | 794 | 382 | 922 | 877 |
| 27 | 512 | 155 | 147 | 283 | 117 | 411 | 313 | 539 | 712 | 667 | 430 | 795 | 822 | 923 | 952 |
| 28 | 11 | 156 | 176 | 284 | 212 | 412 | 450 | 540 | 834 | 668 | 838 | 796 | 851 | 924 | 495 |
| 29 | 40 | 157 | 142 | 285 | 171 | 413 | 542 | 541 | 661 | 669 | 667 | 797 | 730 | 925 | 703 |
| 30 | 68 | 158 | 530 | 286 | 776 | 414 | 334 | 542 | 808 | 670 | 488 | 798 | 498 | 926 | 935 |
| 31 | 130 | 159 | 321 | 287 | 330 | 415 | 233 | 543 | 779 | 671 | 239 | 799 | 880 | 927 | 978 |
| 32 | 19 | 160 | 31 | 288 | 226 | 416 | 555 | 544 | 617 | 672 | 378 | 800 | 742 | 928 | 883 |
| 33 | 13 | 161 | 200 | 289 | 549 | 417 | 774 | 545 | 604 | 673 | 459 | 801 | 445 | 929 | 762 |
| 34 | 48 | 162 | 90 | 290 | 538 | 418 | 175 | 546 | 433 | 674 | 622 | 802 | 471 | 930 | 503 |
| 35 | 14 | 163 | 545 | 291 | 387 | 419 | 123 | 547 | 720 | 675 | 627 | 803 | 635 | 931 | 925 |
| 36 | 72 | 164 | 292 | 292 | 308 | 420 | 658 | 548 | 816 | 676 | 437 | 804 | 932 | 932 | 878 |
| 37 | 257 | 165 | 322 | 293 | 216 | 421 | 612 | 549 | 836 | 677 | 380 | 805 | 687 | 933 | 735 |
| 38 | 21 | 166 | 532 | 294 | 416 | 422 | 341 | 550 | 347 | 678 | 818 | 806 | 903 | 934 | 993 |
| 39 | 132 | 167 | 263 | 295 | 271 | 423 | 777 | 551 | 897 | 679 | 461 | 807 | 825 | 935 | 885 |
| 40 | 35 | 168 | 149 | 296 | 279 | 424 | 220 | 552 | 243 | 680 | 496 | 808 | 500 | 936 | 939 |
| 41 | 258 | 169 | 102 | 297 | 158 | 425 | 314 | 553 | 662 | 681 | 669 | 809 | 846 | 937 | 994 |
| 42 | 26 | 170 | 105 | 298 | 337 | 426 | 424 | 554 | 454 | 682 | 679 | 810 | 745 | 938 | 980 |
| 43 | 513 | 171 | 304 | 299 | 550 | 427 | 395 | 555 | 318 | 683 | 724 | 811 | 826 | 939 | 926 |
| 44 | 80 | 172 | 296 | 300 | 672 | 428 | 673 | 556 | 675 | 684 | 841 | 812 | 732 | 940 | 764 |
| 45 | 37 | 173 | 163 | 301 | 118 | 429 | 583 | 557 | 618 | 685 | 629 | 813 | 446 | 941 | 941 |
| 46 | 25 | 174 | 92 | 302 | 332 | 430 | 355 | 558 | 898 | 686 | 351 | 814 | 962 | 942 | 967 |
| 47 | 22 | 175 | 47 | 303 | 579 | 431 | 287 | 559 | 781 | 687 | 467 | 815 | 936 | 943 | 886 |
| 48 | 136 | 176 | 267 | 304 | 540 | 432 | 183 | 560 | 376 | 688 | 438 | 816 | 475 | 944 | 831 |
| 49 | 260 | 177 | 385 | 305 | 389 | 433 | 234 | 561 | 428 | 689 | 737 | 817 | 853 | 945 | 947 |

| 50 | 264 | 178 | 546 | 306 | 173 | 434 | 125 | 562 | 665 | 690 | 251 | 818 | 867 | 946 | 507 |
|----|-----|-----|-----|-----|-----|-----|-----|-----|-----|-----|-----|-----|-----|-----|-----|
| 51 | 38 | 179 | 324 | 307 | 121 | 435 | 557 | 563 | 736 | 691 | 462 | 819 | 637 | 947 | 889 |
| 52 | 514 | 180 | 208 | 308 | 553 | 436 | 660 | 564 | 567 | 692 | 442 | 820 | 907 | 948 | 984 |
| 53 | 96 | 181 | 386 | 309 | 199 | 437 | 616 | 565 | 840 | 693 | 441 | 821 | 487 | 949 | 751 |
| 54 | 67 | 182 | 150 | 310 | 784 | 438 | 342 | 566 | 625 | 694 | 469 | 822 | 695 | 950 | 942 |
| 55 | 41 | 183 | 153 | 311 | 179 | 439 | 316 | 567 | 238 | 695 | 247 | 823 | 746 | 951 | 996 |
| 56 | 144 | 184 | 165 | 312 | 228 | 440 | 241 | 568 | 359 | 696 | 683 | 824 | 828 | 952 | 971 |
| 57 | 28 | 185 | 106 | 313 | 338 | 441 | 778 | 569 | 457 | 697 | 842 | 825 | 753 | 953 | 890 |
| 58 | 69 | 186 | 55 | 314 | 312 | 442 | 563 | 570 | 399 | 698 | 738 | 826 | 854 | 954 | 509 |
| 59 | 42 | 187 | 328 | 315 | 704 | 443 | 345 | 571 | 787 | 699 | 899 | 827 | 857 | 955 | 949 |
| 60 | 516 | 188 | 536 | 316 | 390 | 444 | 452 | 572 | 591 | 700 | 670 | 828 | 504 | 956 | 973 |
| 61 | 49 | 189 | 577 | 317 | 174 | 445 | 397 | 573 | 678 | 701 | 783 | 829 | 799 | 957 | 1000 |
| 62 | 74 | 190 | 548 | 318 | 554 | 446 | 403 | 574 | 434 | 702 | 849 | 830 | 255 | 958 | 892 |
| 63 | 272 | 191 | 113 | 319 | 581 | 447 | 207 | 575 | 677 | 703 | 820 | 831 | 964 | 959 | 950 |
| 64 | 160 | 192 | 154 | 320 | 393 | 448 | 674 | 576 | 349 | 704 | 728 | 832 | 909 | 960 | 863 |
| 65 | 520 | 193 | 79 | 321 | 283 | 449 | 558 | 577 | 245 | 705 | 928 | 833 | 719 | 961 | 759 |
| 66 | 288 | 194 | 269 | 322 | 122 | 450 | 785 | 578 | 458 | 706 | 791 | 834 | 477 | 962 | 1008 |
| 67 | 528 | 195 | 108 | 323 | 448 | 451 | 432 | 579 | 666 | 707 | 367 | 835 | 915 | 963 | 510 |
| 68 | 192 | 196 | 578 | 324 | 353 | 452 | 357 | 580 | 620 | 708 | 901 | 836 | 638 | 964 | 979 |
| 69 | 544 | 197 | 224 | 325 | 561 | 453 | 187 | 581 | 363 | 709 | 630 | 837 | 748 | 965 | 953 |
| 70 | 70 | 198 | 166 | 326 | 203 | 454 | 236 | 582 | 127 | 710 | 685 | 838 | 944 | 966 | 763 |
| 71 | 44 | 199 | 519 | 327 | 63 | 455 | 664 | 583 | 191 | 711 | 844 | 839 | 869 | 967 | 974 |
| 72 | 131 | 200 | 552 | 328 | 340 | 456 | 624 | 584 | 782 | 712 | 633 | 840 | 491 | 968 | 954 |
| 73 | 81 | 201 | 195 | 329 | 394 | 457 | 587 | 585 | 407 | 713 | 711 | 841 | 699 | 969 | 879 |
| 74 | 50 | 202 | 270 | 330 | 527 | 458 | 780 | 586 | 436 | 714 | 253 | 842 | 754 | 970 | 981 |
| 75 | 73 | 203 | 641 | 331 | 582 | 459 | 705 | 587 | 626 | 715 | 691 | 843 | 858 | 971 | 982 |
| 76 | 15 | 204 | 523 | 332 | 556 | 460 | 126 | 588 | 571 | 716 | 824 | 844 | 478 | 972 | 927 |
| 77 | 320 | 205 | 275 | 333 | 181 | 461 | 242 | 589 | 465 | 717 | 902 | 845 | 968 | 973 | 995 |
| 78 | 133 | 206 | 580 | 334 | 295 | 462 | 565 | 590 | 681 | 718 | 686 | 846 | 383 | 974 | 765 |
| 79 | 52 | 207 | 291 | 335 | 285 | 463 | 398 | 591 | 246 | 719 | 740 | 847 | 910 | 975 | 956 |
| 80 | 23 | 208 | 59 | 336 | 232 | 464 | 346 | 592 | 707 | 720 | 850 | 848 | 815 | 976 | 887 |
| 81 | 134 | 209 | 169 | 337 | 124 | 465 | 456 | 593 | 350 | 721 | 375 | 849 | 976 | 977 | 985 |
| 82 | 384 | 210 | 560 | 338 | 205 | 466 | 358 | 594 | 599 | 722 | 444 | 850 | 870 | 978 | 997 |
| 83 | 76 | 211 | 114 | 339 | 182 | 467 | 405 | 595 | 668 | 723 | 470 | 851 | 917 | 979 | 986 |
| 84 | 137 | 212 | 277 | 340 | 643 | 468 | 303 | 596 | 790 | 724 | 483 | 852 | 727 | 980 | 943 |
| 85 | 82 | 213 | 156 | 341 | 562 | 469 | 569 | 597 | 460 | 725 | 415 | 853 | 493 | 981 | 891 |
| 86 | 56 | 214 | 87 | 342 | 286 | 470 | 244 | 598 | 249 | 726 | 485 | 854 | 873 | 982 | 998 |
| 87 | 27 | 215 | 197 | 343 | 585 | 471 | 595 | 599 | 682 | 727 | 905 | 855 | 701 | 983 | 766 |
| 88 | 97 | 216 | 116 | 344 | 299 | 472 | 189 | 600 | 573 | 728 | 795 | 856 | 931 | 984 | 511 |

| | | | | | | | | | | | | | | | |
|---|---|---|---|---|---|---|---|---|---|---|---|---|---|---|---|
| 89 | 39 | 217 | 170 | 345 | 354 | 473 | 566 | 601 | 411 | 729 | 473 | 857 | 756 | 985 | 988 |
| 90 | 259 | 218 | 61 | 346 | 211 | 474 | 676 | 602 | 803 | 730 | 634 | 858 | 860 | 986 | 1001 |
| 91 | 84 | 219 | 531 | 347 | 401 | 475 | 361 | 603 | 789 | 731 | 744 | 859 | 499 | 987 | 951 |
| 92 | 138 | 220 | 525 | 348 | 185 | 476 | 706 | 604 | 709 | 732 | 852 | 860 | 731 | 988 | 1002 |
| 93 | 145 | 221 | 642 | 349 | 396 | 477 | 589 | 605 | 365 | 733 | 960 | 861 | 823 | 989 | 893 |
| 94 | 261 | 222 | 281 | 350 | 344 | 478 | 215 | 606 | 440 | 734 | 865 | 862 | 922 | 990 | 975 |
| 95 | 29 | 223 | 278 | 351 | 586 | 479 | 786 | 607 | 628 | 735 | 693 | 863 | 874 | 991 | 894 |
| 96 | 43 | 224 | 526 | 352 | 645 | 480 | 647 | 608 | 689 | 736 | 797 | 864 | 918 | 992 | 1009 |
| 97 | 98 | 225 | 177 | 353 | 593 | 481 | 348 | 609 | 374 | 737 | 906 | 865 | 502 | 993 | 955 |
| 98 | 515 | 226 | 293 | 354 | 535 | 482 | 419 | 610 | 423 | 738 | 715 | 866 | 933 | 994 | 1004 |
| 99 | 88 | 227 | 388 | 355 | 240 | 483 | 406 | 611 | 466 | 739 | 807 | 867 | 743 | 995 | 1010 |
| 100 | 140 | 228 | 91 | 356 | 206 | 484 | 464 | 612 | 793 | 740 | 474 | 868 | 760 | 996 | 957 |
| 101 | 30 | 229 | 584 | 357 | 95 | 485 | 680 | 613 | 250 | 741 | 636 | 869 | 881 | 997 | 983 |
| 102 | 146 | 230 | 769 | 358 | 327 | 486 | 801 | 614 | 371 | 742 | 694 | 870 | 494 | 998 | 958 |
| 103 | 71 | 231 | 198 | 359 | 564 | 487 | 362 | 615 | 481 | 743 | 254 | 871 | 702 | 999 | 987 |
| 104 | 262 | 232 | 172 | 360 | 800 | 488 | 590 | 616 | 574 | 744 | 717 | 872 | 921 | 1000 | 1012 |
| 105 | 265 | 233 | 120 | 361 | 402 | 489 | 409 | 617 | 413 | 745 | 575 | 873 | 501 | 1001 | 999 |
| 106 | 161 | 234 | 201 | 362 | 356 | 490 | 570 | 618 | 603 | 746 | 913 | 874 | 876 | 1002 | 1016 |
| 107 | 576 | 235 | 336 | 363 | 307 | 491 | 788 | 619 | 366 | 747 | 798 | 875 | 847 | 1003 | 767 |
| 108 | 45 | 236 | 62 | 364 | 301 | 492 | 597 | 620 | 468 | 748 | 811 | 876 | 992 | 1004 | 989 |
| 109 | 100 | 237 | 282 | 365 | 417 | 493 | 572 | 621 | 655 | 749 | 379 | 877 | 447 | 1005 | 1003 |
| 110 | 640 | 238 | 143 | 366 | 213 | 494 | 219 | 622 | 900 | 750 | 697 | 878 | 733 | 1006 | 990 |
| 111 | 51 | 239 | 103 | 367 | 568 | 495 | 311 | 623 | 805 | 751 | 431 | 879 | 827 | 1007 | 1005 |
| 112 | 148 | 240 | 178 | 368 | 832 | 496 | 708 | 624 | 615 | 752 | 607 | 880 | 934 | 1008 | 959 |
| 113 | 46 | 241 | 294 | 369 | 588 | 497 | 598 | 625 | 684 | 753 | 489 | 881 | 882 | 1009 | 1011 |
| 114 | 75 | 242 | 93 | 370 | 186 | 498 | 601 | 626 | 710 | 754 | 866 | 882 | 937 | 1010 | 1013 |
| 115 | 266 | 243 | 644 | 371 | 646 | 499 | 651 | 627 | 429 | 755 | 723 | 883 | 963 | 1011 | 895 |
| 116 | 273 | 244 | 202 | 372 | 404 | 500 | 421 | 628 | 794 | 756 | 486 | 884 | 747 | 1012 | 1006 |
| 117 | 517 | 245 | 592 | 373 | 227 | 501 | 792 | 629 | 252 | 757 | 908 | 885 | 505 | 1013 | 1014 |
| 118 | 104 | 246 | 323 | 374 | 896 | 502 | 802 | 630 | 373 | 758 | 718 | 886 | 855 | 1014 | 1017 |
| 119 | 162 | 247 | 392 | 375 | 594 | 503 | 611 | 631 | 605 | 759 | 813 | 887 | 924 | 1015 | 1018 |
| 120 | 53 | 248 | 297 | 376 | 418 | 504 | 602 | 632 | 848 | 760 | 476 | 888 | 734 | 1016 | 991 |
| 121 | 193 | 249 | 770 | 377 | 302 | 505 | 410 | 633 | 690 | 761 | 856 | 889 | 829 | 1017 | 1020 |
| 122 | 152 | 250 | 107 | 378 | 649 | 506 | 231 | 634 | 713 | 762 | 839 | 890 | 965 | 1018 | 1007 |
| 123 | 77 | 251 | 180 | 379 | 771 | 507 | 688 | 635 | 632 | 763 | 725 | 891 | 938 | 1019 | 1015 |
| 124 | 164 | 252 | 151 | 380 | 360 | 508 | 653 | 636 | 482 | 764 | 698 | 892 | 884 | 1020 | 1019 |
| 125 | 768 | 253 | 209 | 381 | 539 | 509 | 248 | 637 | 806 | 765 | 914 | 893 | 506 | 1021 | 1021 |
| 126 | 268 | 254 | 284 | 382 | 111 | 510 | 369 | 638 | 427 | 766 | 752 | 894 | 749 | 1022 | 1022 |
| 127 | 274 | 255 | 648 | 383 | 331 | 511 | 190 | 639 | 904 | 767 | 868 | 895 | 945 | 1023 | 1023 |

2. The method according to claim 1, wherein the second sequence is prestored.

3. The method according to claim 1 or 2, wherein the K to-be-encoded bits comprise a cyclic redundancy check bit.

4. The method according to any one of claims 1 to 3, wherein the K to-be-encoded bits comprise a parity check bit.

5. The method according to any one of claims 1 to 4, wherein the sequence numbers of the N polarized channels are from 0 to N-1.

6. An encoding apparatus (300), comprising:

an obtaining unit (601) configured to obtain a first sequence used to encode K to-be-encoded bits, K being a positive integer, wherein the first sequence comprises sequence numbers of N polarized channels, the sequence numbers of the N polarized channels are arranged in the first sequence based on reliability of the N polarized channels, N is a mother code length of a polar code, $N = 2^n$, n is a positive integer, and $K \leq N$, wherein the first sequence is all of or a subset of a second sequence, the second sequence comprises sequence numbers of $N_{max}$ polarized channels, the sequence numbers of the $N_{max}$ polarized channels are arranged in the second sequence based on reliability of the $N_{max}$ polarized channels, an order in which the sequence numbers of the polarized channels in the first sequence are arranged is consistent with an order in which sequence numbers less than N in the sequence numbers of the polarized channels in the second sequence are arranged, $N \geq 64$, $N_{max}$ is a positive integer, $N_{max} \geq N$;
a selection unit (602) configured to select sequence numbers of K polarized channels from the first sequence based on a reliability order; and
an encoding unit (603) configured to place the K to-be-encoded bits based on the selected sequence numbers of the K polarized channels, and perform polar code encoding on the K to-be-encoded bits,
wherein $N_{max}=1024$, the second sequence is the sequence in Table Q11,
**characterized in that** the Table Q11 is:

| Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number | Reliability or sequence number of reliability | Polarized channel sequence number |
|---|---|---|---|---|---|---|---|---|---|---|---|---|---|---|---|
| 0 | 0 | 128 | 518 | 256 | 94 | 384 | 214 | 512 | 364 | 640 | 414 | 768 | 819 | 896 | 966 |
| 1 | 1 | 129 | 54 | 257 | 204 | 385 | 309 | 513 | 654 | 641 | 223 | 769 | 814 | 897 | 755 |
| 2 | 2 | 130 | 83 | 258 | 298 | 386 | 188 | 514 | 659 | 642 | 663 | 770 | 439 | 898 | 859 |

| | | | | | | | | | | | | | | | |
|---|---|---|---|---|---|---|---|---|---|---|---|---|---|---|---|
| 3 | 4 | 131 | 57 | 259 | 400 | 387 | 449 | 515 | 335 | 643 | 692 | 771 | 929 | 899 | 940 |
| 4 | 8 | 132 | 521 | 260 | 608 | 388 | 217 | 516 | 480 | 644 | 835 | 772 | 490 | 900 | 830 |
| 5 | 16 | 133 | 112 | 261 | 352 | 389 | 408 | 517 | 315 | 645 | 619 | 773 | 623 | 901 | 911 |
| 6 | 32 | 134 | 135 | 262 | 325 | 390 | 609 | 518 | 221 | 646 | 472 | 774 | 671 | 902 | 871 |
| 7 | 3 | 135 | 78 | 263 | 533 | 391 | 596 | 519 | 370 | 647 | 455 | 775 | 739 | 903 | 639 |
| 8 | 5 | 136 | 289 | 264 | 155 | 392 | 551 | 520 | 613 | 648 | 796 | 776 | 916 | 904 | 888 |
| 9 | 64 | 137 | 194 | 265 | 210 | 393 | 650 | 521 | 422 | 649 | 809 | 777 | 463 | 905 | 479 |
| 10 | 9 | 138 | 85 | 266 | 305 | 394 | 229 | 522 | 425 | 650 | 714 | 778 | 843 | 906 | 946 |
| 11 | 6 | 139 | 276 | 267 | 547 | 395 | 159 | 523 | 451 | 651 | 721 | 779 | 381 | 907 | 750 |
| 12 | 17 | 140 | 522 | 268 | 300 | 396 | 420 | 524 | 614 | 652 | 837 | 780 | 497 | 908 | 969 |
| 13 | 10 | 141 | 58 | 269 | 109 | 397 | 310 | 525 | 543 | 653 | 716 | 781 | 930 | 909 | 508 |
| 14 | 18 | 142 | 168 | 270 | 184 | 398 | 541 | 526 | 235 | 654 | 864 | 782 | 821 | 910 | 861 |
| 15 | 128 | 143 | 139 | 271 | 534 | 399 | 773 | 527 | 412 | 655 | 810 | 783 | 726 | 911 | 757 |
| 16 | 12 | 144 | 99 | 272 | 537 | 400 | 610 | 528 | 343 | 656 | 606 | 784 | 961 | 912 | 970 |
| 17 | 33 | 145 | 86 | 273 | 115 | 401 | 657 | 529 | 372 | 657 | 912 | 785 | 872 | 913 | 919 |
| 18 | 65 | 146 | 60 | 274 | 167 | 402 | 333 | 530 | 775 | 658 | 722 | 786 | 492 | 914 | 875 |
| 19 | 20 | 147 | 280 | 275 | 225 | 403 | 119 | 531 | 317 | 659 | 696 | 787 | 631 | 915 | 862 |
| 20 | 256 | 148 | 89 | 276 | 326 | 404 | 600 | 532 | 222 | 660 | 377 | 788 | 729 | 916 | 758 |
| 21 | 34 | 149 | 290 | 277 | 306 | 405 | 339 | 533 | 426 | 661 | 435 | 789 | 700 | 917 | 948 |
| 22 | 24 | 150 | 529 | 278 | 772 | 406 | 218 | 534 | 453 | 662 | 817 | 790 | 443 | 918 | 977 |
| 23 | 36 | 151 | 524 | 279 | 157 | 407 | 368 | 535 | 237 | 663 | 319 | 791 | 741 | 919 | 923 |
| 24 | 7 | 152 | 196 | 280 | 656 | 408 | 652 | 536 | 559 | 664 | 621 | 792 | 845 | 920 | 972 |
| 25 | 129 | 153 | 141 | 281 | 329 | 409 | 230 | 537 | 833 | 665 | 812 | 793 | 920 | 921 | 761 |
| 26 | 66 | 154 | 101 | 282 | 110 | 410 | 391 | 538 | 804 | 666 | 484 | 794 | 382 | 922 | 877 |
| 27 | 512 | 155 | 147 | 283 | 117 | 411 | 313 | 539 | 712 | 667 | 430 | 795 | 822 | 923 | 952 |
| 28 | 11 | 156 | 176 | 284 | 212 | 412 | 450 | 540 | 834 | 668 | 838 | 796 | 851 | 924 | 495 |
| 29 | 40 | 157 | 142 | 285 | 171 | 413 | 542 | 541 | 661 | 669 | 667 | 797 | 730 | 925 | 703 |
| 30 | 68 | 158 | 530 | 286 | 776 | 414 | 334 | 542 | 808 | 670 | 488 | 798 | 498 | 926 | 935 |
| 31 | 130 | 159 | 321 | 287 | 330 | 415 | 233 | 543 | 779 | 671 | 239 | 799 | 880 | 927 | 978 |
| 32 | 19 | 160 | 31 | 288 | 226 | 416 | 555 | 544 | 617 | 672 | 378 | 800 | 742 | 928 | 883 |
| 33 | 13 | 161 | 200 | 289 | 549 | 417 | 774 | 545 | 604 | 673 | 459 | 801 | 445 | 929 | 762 |
| 34 | 48 | 162 | 90 | 290 | 538 | 418 | 175 | 546 | 433 | 674 | 622 | 802 | 471 | 930 | 503 |
| 35 | 14 | 163 | 545 | 291 | 387 | 419 | 123 | 547 | 720 | 675 | 627 | 803 | 635 | 931 | 925 |
| 36 | 72 | 164 | 292 | 292 | 308 | 420 | 658 | 548 | 816 | 676 | 437 | 804 | 932 | 932 | 878 |
| 37 | 257 | 165 | 322 | 293 | 216 | 421 | 612 | 549 | 836 | 677 | 380 | 805 | 687 | 933 | 735 |
| 38 | 21 | 166 | 532 | 294 | 416 | 422 | 341 | 550 | 347 | 678 | 818 | 806 | 903 | 934 | 993 |
| 39 | 132 | 167 | 263 | 295 | 271 | 423 | 777 | 551 | 897 | 679 | 461 | 807 | 825 | 935 | 885 |
| 40 | 35 | 168 | 149 | 296 | 279 | 424 | 220 | 552 | 243 | 680 | 496 | 808 | 500 | 936 | 939 |
| 41 | 258 | 169 | 102 | 297 | 158 | 425 | 314 | 553 | 662 | 681 | 669 | 809 | 846 | 937 | 994 |

| | | | | | | | | | | | | | | | |
|---|---|---|---|---|---|---|---|---|---|---|---|---|---|---|---|
| 42 | 26 | 170 | 105 | 298 | 337 | 426 | 424 | 554 | 454 | 682 | 679 | 810 | 745 | 938 | 980 |
| 43 | 513 | 171 | 304 | 299 | 550 | 427 | 395 | 555 | 318 | 683 | 724 | 811 | 826 | 939 | 926 |
| 44 | 80 | 172 | 296 | 300 | 672 | 428 | 673 | 556 | 675 | 684 | 841 | 812 | 732 | 940 | 764 |
| 45 | 37 | 173 | 163 | 301 | 118 | 429 | 583 | 557 | 618 | 685 | 629 | 813 | 446 | 941 | 941 |
| 46 | 25 | 174 | 92 | 302 | 332 | 430 | 355 | 558 | 898 | 686 | 351 | 814 | 962 | 942 | 967 |
| 47 | 22 | 175 | 47 | 303 | 579 | 431 | 287 | 559 | 781 | 687 | 467 | 815 | 936 | 943 | 886 |
| 48 | 136 | 176 | 267 | 304 | 540 | 432 | 183 | 560 | 376 | 688 | 438 | 816 | 475 | 944 | 831 |
| 49 | 260 | 177 | 385 | 305 | 389 | 433 | 234 | 561 | 428 | 689 | 737 | 817 | 853 | 945 | 947 |
| 50 | 264 | 178 | 546 | 306 | 173 | 434 | 125 | 562 | 665 | 690 | 251 | 818 | 867 | 946 | 507 |
| 51 | 38 | 179 | 324 | 307 | 121 | 435 | 557 | 563 | 736 | 691 | 462 | 819 | 637 | 947 | 889 |
| 52 | 514 | 180 | 208 | 308 | 553 | 436 | 660 | 564 | 567 | 692 | 442 | 820 | 907 | 948 | 984 |
| 53 | 96 | 181 | 386 | 309 | 199 | 437 | 616 | 565 | 840 | 693 | 441 | 821 | 487 | 949 | 751 |
| 54 | 67 | 182 | 150 | 310 | 784 | 438 | 342 | 566 | 625 | 694 | 469 | 822 | 695 | 950 | 942 |
| 55 | 41 | 183 | 153 | 311 | 179 | 439 | 316 | 567 | 238 | 695 | 247 | 823 | 746 | 951 | 996 |
| 56 | 144 | 184 | 165 | 312 | 228 | 440 | 241 | 568 | 359 | 696 | 683 | 824 | 828 | 952 | 971 |
| 57 | 28 | 185 | 106 | 313 | 338 | 441 | 778 | 569 | 457 | 697 | 842 | 825 | 753 | 953 | 890 |
| 58 | 69 | 186 | 55 | 314 | 312 | 442 | 563 | 570 | 399 | 698 | 738 | 826 | 854 | 954 | 509 |
| 59 | 42 | 187 | 328 | 315 | 704 | 443 | 345 | 571 | 787 | 699 | 899 | 827 | 857 | 955 | 949 |
| 60 | 516 | 188 | 536 | 316 | 390 | 444 | 452 | 572 | 591 | 700 | 670 | 828 | 504 | 956 | 973 |
| 61 | 49 | 189 | 577 | 317 | 174 | 445 | 397 | 573 | 678 | 701 | 783 | 829 | 799 | 957 | 1000 |
| 62 | 74 | 190 | 548 | 318 | 554 | 446 | 403 | 574 | 434 | 702 | 849 | 830 | 255 | 958 | 892 |
| 63 | 272 | 191 | 113 | 319 | 581 | 447 | 207 | 575 | 677 | 703 | 820 | 831 | 964 | 959 | 950 |
| 64 | 160 | 192 | 154 | 320 | 393 | 448 | 674 | 576 | 349 | 704 | 728 | 832 | 909 | 960 | 863 |
| 65 | 520 | 193 | 79 | 321 | 283 | 449 | 558 | 577 | 245 | 705 | 928 | 833 | 719 | 961 | 759 |
| 66 | 288 | 194 | 269 | 322 | 122 | 450 | 785 | 578 | 458 | 706 | 791 | 834 | 477 | 962 | 1008 |
| 67 | 528 | 195 | 108 | 323 | 448 | 451 | 432 | 579 | 666 | 707 | 367 | 835 | 915 | 963 | 510 |
| 68 | 192 | 196 | 578 | 324 | 353 | 452 | 357 | 580 | 620 | 708 | 901 | 836 | 638 | 964 | 979 |
| 69 | 544 | 197 | 224 | 325 | 561 | 453 | 187 | 581 | 363 | 709 | 630 | 837 | 748 | 965 | 953 |
| 70 | 70 | 198 | 166 | 326 | 203 | 454 | 236 | 582 | 127 | 710 | 685 | 838 | 944 | 966 | 763 |
| 71 | 44 | 199 | 519 | 327 | 63 | 455 | 664 | 583 | 191 | 711 | 844 | 839 | 869 | 967 | 974 |
| 72 | 131 | 200 | 552 | 328 | 340 | 456 | 624 | 584 | 782 | 712 | 633 | 840 | 491 | 968 | 954 |
| 73 | 81 | 201 | 195 | 329 | 394 | 457 | 587 | 585 | 407 | 713 | 711 | 841 | 699 | 969 | 879 |
| 74 | 50 | 202 | 270 | 330 | 527 | 458 | 780 | 586 | 436 | 714 | 253 | 842 | 754 | 970 | 981 |
| 75 | 73 | 203 | 641 | 331 | 582 | 459 | 705 | 587 | 626 | 715 | 691 | 843 | 858 | 971 | 982 |
| 76 | 15 | 204 | 523 | 332 | 556 | 460 | 126 | 588 | 571 | 716 | 824 | 844 | 478 | 972 | 927 |
| 77 | 320 | 205 | 275 | 333 | 181 | 461 | 242 | 589 | 465 | 717 | 902 | 845 | 968 | 973 | 995 |
| 78 | 133 | 206 | 580 | 334 | 295 | 462 | 565 | 590 | 681 | 718 | 686 | 846 | 383 | 974 | 765 |
| 79 | 52 | 207 | 291 | 335 | 285 | 463 | 398 | 591 | 246 | 719 | 740 | 847 | 910 | 975 | 956 |
| 80 | 23 | 208 | 59 | 336 | 232 | 464 | 346 | 592 | 707 | 720 | 850 | 848 | 815 | 976 | 887 |

| | | | | | | | | | | | | | | | |
|---|---|---|---|---|---|---|---|---|---|---|---|---|---|---|---|
| 81 | 134 | 209 | 169 | 337 | 124 | 465 | 456 | 593 | 350 | 721 | 375 | 849 | 976 | 977 | 985 |
| 82 | 384 | 210 | 560 | 338 | 205 | 466 | 358 | 594 | 599 | 722 | 444 | 850 | 870 | 978 | 997 |
| 83 | 76 | 211 | 114 | 339 | 182 | 467 | 405 | 595 | 668 | 723 | 470 | 851 | 917 | 979 | 986 |
| 84 | 137 | 212 | 277 | 340 | 643 | 468 | 303 | 596 | 790 | 724 | 483 | 852 | 727 | 980 | 943 |
| 85 | 82 | 213 | 156 | 341 | 562 | 469 | 569 | 597 | 460 | 725 | 415 | 853 | 493 | 981 | 891 |
| 86 | 56 | 214 | 87 | 342 | 286 | 470 | 244 | 598 | 249 | 726 | 485 | 854 | 873 | 982 | 998 |
| 87 | 27 | 215 | 197 | 343 | 585 | 471 | 595 | 599 | 682 | 727 | 905 | 855 | 701 | 983 | 766 |
| 88 | 97 | 216 | 116 | 344 | 299 | 472 | 189 | 600 | 573 | 728 | 795 | 856 | 931 | 984 | 511 |
| 89 | 39 | 217 | 170 | 345 | 354 | 473 | 566 | 601 | 411 | 729 | 473 | 857 | 756 | 985 | 988 |
| 90 | 259 | 218 | 61 | 346 | 211 | 474 | 676 | 602 | 803 | 730 | 634 | 858 | 860 | 986 | 1001 |
| 91 | 84 | 219 | 531 | 347 | 401 | 475 | 361 | 603 | 789 | 731 | 744 | 859 | 499 | 987 | 951 |
| 92 | 138 | 220 | 525 | 348 | 185 | 476 | 706 | 604 | 709 | 732 | 852 | 860 | 731 | 988 | 1002 |
| 93 | 145 | 221 | 642 | 349 | 396 | 477 | 589 | 605 | 365 | 733 | 960 | 861 | 823 | 989 | 893 |
| 94 | 261 | 222 | 281 | 350 | 344 | 478 | 215 | 606 | 440 | 734 | 865 | 862 | 922 | 990 | 975 |
| 95 | 29 | 223 | 278 | 351 | 586 | 479 | 786 | 607 | 628 | 735 | 693 | 863 | 874 | 991 | 894 |
| 96 | 43 | 224 | 526 | 352 | 645 | 480 | 647 | 608 | 689 | 736 | 797 | 864 | 918 | 992 | 1009 |
| 97 | 98 | 225 | 177 | 353 | 593 | 481 | 348 | 609 | 374 | 737 | 906 | 865 | 502 | 993 | 955 |
| 98 | 515 | 226 | 293 | 354 | 535 | 482 | 419 | 610 | 423 | 738 | 715 | 866 | 933 | 994 | 1004 |
| 99 | 88 | 227 | 388 | 355 | 240 | 483 | 406 | 611 | 466 | 739 | 807 | 867 | 743 | 995 | 1010 |
| 100 | 140 | 228 | 91 | 356 | 206 | 484 | 464 | 612 | 793 | 740 | 474 | 868 | 760 | 996 | 957 |
| 101 | 30 | 229 | 584 | 357 | 95 | 485 | 680 | 613 | 250 | 741 | 636 | 869 | 881 | 997 | 983 |
| 102 | 146 | 230 | 769 | 358 | 327 | 486 | 801 | 614 | 371 | 742 | 694 | 870 | 494 | 998 | 958 |
| 103 | 71 | 231 | 198 | 359 | 564 | 487 | 362 | 615 | 481 | 743 | 254 | 871 | 702 | 999 | 987 |
| 104 | 262 | 232 | 172 | 360 | 800 | 488 | 590 | 616 | 574 | 744 | 717 | 872 | 921 | 1000 | 1012 |
| 105 | 265 | 233 | 120 | 361 | 402 | 489 | 409 | 617 | 413 | 745 | 575 | 873 | 501 | 1001 | 999 |
| 106 | 161 | 234 | 201 | 362 | 356 | 490 | 570 | 618 | 603 | 746 | 913 | 874 | 876 | 1002 | 1016 |
| 107 | 576 | 235 | 336 | 363 | 307 | 491 | 788 | 619 | 366 | 747 | 798 | 875 | 847 | 1003 | 767 |
| 108 | 45 | 236 | 62 | 364 | 301 | 492 | 597 | 620 | 468 | 748 | 811 | 876 | 992 | 1004 | 989 |
| 109 | 100 | 237 | 282 | 365 | 417 | 493 | 572 | 621 | 655 | 749 | 379 | 877 | 447 | 1005 | 1003 |
| 110 | 640 | 238 | 143 | 366 | 213 | 494 | 219 | 622 | 900 | 750 | 697 | 878 | 733 | 1006 | 990 |
| 111 | 51 | 239 | 103 | 367 | 568 | 495 | 311 | 623 | 805 | 751 | 431 | 879 | 827 | 1007 | 1005 |
| 112 | 148 | 240 | 178 | 368 | 832 | 496 | 708 | 624 | 615 | 752 | 607 | 880 | 934 | 1008 | 959 |
| 113 | 46 | 241 | 294 | 369 | 588 | 497 | 598 | 625 | 684 | 753 | 489 | 881 | 882 | 1009 | 1011 |
| 114 | 75 | 242 | 93 | 370 | 186 | 498 | 601 | 626 | 710 | 754 | 866 | 882 | 937 | 1010 | 1013 |
| 115 | 266 | 243 | 644 | 371 | 646 | 499 | 651 | 627 | 429 | 755 | 723 | 883 | 963 | 1011 | 895 |
| 116 | 273 | 244 | 202 | 372 | 404 | 500 | 421 | 628 | 794 | 756 | 486 | 884 | 747 | 1012 | 1006 |
| 117 | 517 | 245 | 592 | 373 | 227 | 501 | 792 | 629 | 252 | 757 | 908 | 885 | 505 | 1013 | 1014 |
| 118 | 104 | 246 | 323 | 374 | 896 | 502 | 802 | 630 | 373 | 758 | 718 | 886 | 855 | 1014 | 1017 |
| 119 | 162 | 247 | 392 | 375 | 594 | 503 | 611 | 631 | 605 | 759 | 813 | 887 | 924 | 1015 | 1018 |

| 120 | 53 | 248 | 297 | 376 | 418 | 504 | 602 | 632 | 848 | 760 | 476 | 888 | 734 | 1016 | 991 |
| 121 | 193 | 249 | 770 | 377 | 302 | 505 | 410 | 633 | 690 | 761 | 856 | 889 | 829 | 1017 | 1020 |
| 122 | 152 | 250 | 107 | 378 | 649 | 506 | 231 | 634 | 713 | 762 | 839 | 890 | 965 | 1018 | 1007 |
| 123 | 77 | 251 | 180 | 379 | 771 | 507 | 688 | 635 | 632 | 763 | 725 | 891 | 938 | 1019 | 1015 |
| 124 | 164 | 252 | 151 | 380 | 360 | 508 | 653 | 636 | 482 | 764 | 698 | 892 | 884 | 1020 | 1019 |
| 125 | 768 | 253 | 209 | 381 | 539 | 509 | 248 | 637 | 806 | 765 | 914 | 893 | 506 | 1021 | 1021 |
| 126 | 268 | 254 | 284 | 382 | 111 | 510 | 369 | 638 | 427 | 766 | 752 | 894 | 749 | 1022 | 1022 |
| 127 | 274 | 255 | 648 | 383 | 331 | 511 | 190 | 639 | 904 | 767 | 868 | 895 | 945 | 1023 | 1023 |

7. The apparatus according to claim 6, wherein the second sequence is prestored.

8. The apparatus according to claim 6 or 7, wherein the K to-be-encoded bits comprise a cyclic redundancy check bit.

9. The apparatus according to any one of claims 6 to 8, wherein the K to-be-encoded bits comprise a parity check bit.

10. The apparatus according to any one of claims 6 to 9, wherein the sequence numbers of the N polarized channels are from 0 to N-1.

11. The apparatus according to any one of claims 6 to 10, wherein the apparatus is a chip or or an integrated circuit.

12. A wireless device, comprising the encoding apparatus (300) according to any one of claims 6 to 10, a modulator (310), and a transceiver,

   wherein the modulator (310) is configured to modulate a bit sequence obtained after polar encoding to obtain a modulated sequence, and
   the transceiver (320) is configured to send the modulated sequence.

13. The wireless device according to claim 12, wherein the wireless device is a terminal or a network device.

14. A computer storage medium, wherein the storage medium stores a computer program, and the computer program comprises instructions which, when the program is executed by a computer, cause the computer to to perform the method according to any one of claims 1 to 5.

15. A computer program product comprising instructions which,
   when the program is executed by a computer, cause the computer to carry out the method according to any one of claims 1 to 5.

**Patentansprüche**

1. Codierverfahren, das von einer Codiereinrichtung durchgeführt wird, umfassend:

   Erhalten (201) einer ersten Sequenz, die verwendet wird, um K zu codierende Bits zu codieren, K eine positive ganze Zahl ist, wobei die erste Sequenz Sequenznummern von N polarisierten Kanälen umfasst, die Sequenznummern der N polarisierten Kanäle in der ersten Sequenz basierend auf der Zuverlässigkeit der N polarisierten Kanäle angeordnet sind, N eine Muttercodelänge eines Polarcodes ist, $N = 2^n$ ist, n eine positive ganze Zahl ist und $K \leq N$ ist, wobei die erste Sequenz die Gesamtheit oder eine Teilmenge einer zweiten Sequenz ist, die zweite Sequenz Sequenznummern von $N_{max}$ polarisierten Kanälen umfasst, die Sequenznummern der $N_{max}$ polarisierten Kanäle in der zweiten Sequenz basierend auf der Zuverlässigkeit der $N_{max}$ polarisierten Kanäle angeordnet sind, eine Reihenfolge, in der die Sequenznummern der polarisierten Kanäle in der ersten Sequenz angeordnet sind, mit einer Reihenfolge übereinstimmt, in der Sequenznummern kleiner als N in den Sequenznummern der polarisierten Kanäle in der zweiten Sequenz angeordnet sind, $N \geq 64$ ist, $N_{max}$ eine positive ganze Zahl ist, $N_{max} \geq N$ ist;

Auswählen (202) von Sequenznummern von K polarisierten Kanälen aus der ersten Sequenz basierend auf einer Zuverlässigkeitsreihenfolge; und

Platzieren (203) der K zu codierenden Bits basierend auf den ausgewählten Sequenznummern der K polarisierten Kanäle und Durchführen einer Polarcode-Codierung an den K zu codierenden Bits,

wobei $N_{max}=1024$ ist, die zweite Sequenz die Sequenz in Tabelle Q11 ist,

**dadurch gekennzeichnet, dass** die Tabelle Q11 Folgendes ist:

| Zuverlässigkeit oder der Sequenznummer der Zuverlässigkeit | Polarisierte Kanalsequenznummer | Zuverlässigkeit oder der Sequenznummer der Zuverlässigkeit | Polarisierte Kanalsequenznummer | Zuverlässigkeit oder der Sequenznummer der Zuverlässigkeit | Polarisierte Kanalsequenznummer | Zuverlässigkeit oder der Sequenznummer der Zuverlässigkeit | Polarisierte Kanalsequenznummer | Zuverlässigkeit oder der Sequenznummer der Zuverlässigkeit | Polarisierte Kanalsequenznummer | Zuverlässigkeit oder der Sequenznummer der Zuverlässigkeit | Polarisierte Kanalsequenznummer | Zuverlässigkeit oder der Sequenznummer der Zuverlässigkeit | Polarisierte Kanalsequenznummer | Zuverlässigkeit oder der Sequenznummer der Zuverlässigkeit | Polarisierte Kanalsequenznummer |
|---|---|---|---|---|---|---|---|---|---|---|---|---|---|---|---|
| 0 | 0 | 128 | 518 | 256 | 94 | 384 | 214 | 512 | 364 | 640 | 414 | 768 | 819 | 896 | 966 |
| 1 | 1 | 129 | 54 | 257 | 204 | 385 | 309 | 513 | 654 | 641 | 223 | 769 | 814 | 897 | 755 |
| 2 | 2 | 130 | 83 | 258 | 298 | 386 | 188 | 514 | 659 | 642 | 663 | 770 | 439 | 898 | 859 |
| 3 | 4 | 131 | 57 | 259 | 400 | 387 | 449 | 515 | 335 | 643 | 692 | 771 | 929 | 899 | 940 |
| 4 | 8 | 132 | 521 | 260 | 608 | 388 | 217 | 516 | 480 | 644 | 835 | 772 | 490 | 900 | 830 |
| 5 | 16 | 133 | 112 | 261 | 352 | 389 | 408 | 517 | 315 | 645 | 619 | 773 | 623 | 901 | 911 |
| 6 | 32 | 134 | 135 | 262 | 325 | 390 | 609 | 518 | 221 | 646 | 472 | 774 | 671 | 902 | 871 |
| 7 | 3 | 135 | 78 | 263 | 533 | 391 | 596 | 519 | 370 | 647 | 455 | 775 | 739 | 903 | 639 |
| 8 | 5 | 136 | 289 | 264 | 155 | 392 | 551 | 520 | 613 | 648 | 796 | 776 | 916 | 904 | 888 |
| 9 | 64 | 137 | 194 | 265 | 210 | 393 | 650 | 521 | 422 | 649 | 809 | 777 | 463 | 905 | 479 |
| 10 | 9 | 138 | 85 | 266 | 305 | 394 | 229 | 522 | 425 | 650 | 714 | 778 | 843 | 906 | 946 |

| | | | | | | | | | | | | | | | |
|---|---|---|---|---|---|---|---|---|---|---|---|---|---|---|---|
| 11 | 6 | 139 | 276 | 267 | 547 | 395 | 159 | 523 | 451 | 651 | 721 | 779 | 381 | 907 | 750 |
| 12 | 17 | 140 | 522 | 268 | 300 | 396 | 420 | 524 | 614 | 652 | 837 | 780 | 497 | 908 | 969 |
| 13 | 10 | 141 | 58 | 269 | 109 | 397 | 310 | 525 | 543 | 653 | 716 | 781 | 930 | 909 | 508 |
| 14 | 18 | 142 | 168 | 270 | 184 | 398 | 541 | 526 | 235 | 654 | 864 | 782 | 821 | 910 | 861 |
| 15 | 128 | 143 | 139 | 271 | 534 | 399 | 773 | 527 | 412 | 655 | 810 | 783 | 726 | 911 | 757 |
| 16 | 12 | 144 | 99 | 272 | 537 | 400 | 610 | 528 | 343 | 656 | 606 | 784 | 961 | 912 | 970 |
| 17 | 33 | 145 | 86 | 273 | 115 | 401 | 657 | 529 | 372 | 657 | 912 | 785 | 872 | 913 | 919 |
| 18 | 65 | 146 | 60 | 274 | 167 | 402 | 333 | 530 | 775 | 658 | 722 | 786 | 492 | 914 | 875 |
| 19 | 20 | 147 | 280 | 275 | 225 | 403 | 119 | 531 | 317 | 659 | 696 | 787 | 631 | 915 | 862 |
| 20 | 256 | 148 | 89 | 276 | 326 | 404 | 600 | 532 | 222 | 660 | 377 | 788 | 729 | 916 | 758 |
| 21 | 34 | 149 | 290 | 277 | 306 | 405 | 339 | 533 | 426 | 661 | 435 | 789 | 700 | 917 | 948 |
| 22 | 24 | 150 | 529 | 278 | 772 | 406 | 218 | 534 | 453 | 662 | 817 | 790 | 443 | 918 | 977 |
| 23 | 36 | 151 | 524 | 279 | 157 | 407 | 368 | 535 | 237 | 663 | 319 | 791 | 741 | 919 | 923 |
| 24 | 7 | 152 | 196 | 280 | 656 | 408 | 652 | 536 | 559 | 664 | 621 | 792 | 845 | 920 | 972 |
| 25 | 129 | 153 | 141 | 281 | 329 | 409 | 230 | 537 | 833 | 665 | 812 | 793 | 920 | 921 | 761 |
| 26 | 66 | 154 | 101 | 282 | 110 | 410 | 391 | 538 | 804 | 666 | 484 | 794 | 382 | 922 | 877 |
| 27 | 512 | 155 | 147 | 283 | 117 | 411 | 313 | 539 | 712 | 667 | 430 | 795 | 822 | 923 | 952 |
| 28 | 11 | 156 | 176 | 284 | 212 | 412 | 450 | 540 | 834 | 668 | 838 | 796 | 851 | 924 | 495 |
| 29 | 40 | 157 | 142 | 285 | 171 | 413 | 542 | 541 | 661 | 669 | 667 | 797 | 730 | 925 | 703 |
| 30 | 68 | 158 | 530 | 286 | 776 | 414 | 334 | 542 | 808 | 670 | 488 | 798 | 498 | 926 | 935 |
| 31 | 130 | 159 | 321 | 287 | 330 | 415 | 233 | 543 | 779 | 671 | 239 | 799 | 880 | 927 | 978 |
| 32 | 19 | 160 | 31 | 288 | 226 | 416 | 555 | 544 | 617 | 672 | 378 | 800 | 742 | 928 | 883 |
| 33 | 13 | 161 | 200 | 289 | 549 | 417 | 774 | 545 | 604 | 673 | 459 | 801 | 445 | 929 | 762 |
| 34 | 48 | 162 | 90 | 290 | 538 | 418 | 175 | 546 | 433 | 674 | 622 | 802 | 471 | 930 | 503 |
| 35 | 14 | 163 | 545 | 291 | 387 | 419 | 123 | 547 | 720 | 675 | 627 | 803 | 635 | 931 | 925 |
| 36 | 72 | 164 | 292 | 292 | 308 | 420 | 658 | 548 | 816 | 676 | 437 | 804 | 932 | 932 | 878 |
| 37 | 257 | 165 | 322 | 293 | 216 | 421 | 612 | 549 | 836 | 677 | 380 | 805 | 687 | 933 | 735 |
| 38 | 21 | 166 | 532 | 294 | 416 | 422 | 341 | 550 | 347 | 678 | 818 | 806 | 903 | 934 | 993 |
| 39 | 132 | 167 | 263 | 295 | 271 | 423 | 777 | 551 | 897 | 679 | 461 | 807 | 825 | 935 | 885 |
| 40 | 35 | 168 | 149 | 296 | 279 | 424 | 220 | 552 | 243 | 680 | 496 | 808 | 500 | 936 | 939 |
| 41 | 258 | 169 | 102 | 297 | 158 | 425 | 314 | 553 | 662 | 681 | 669 | 809 | 846 | 937 | 994 |
| 42 | 26 | 170 | 105 | 298 | 337 | 426 | 424 | 554 | 454 | 682 | 679 | 810 | 745 | 938 | 980 |
| 43 | 513 | 171 | 304 | 299 | 550 | 427 | 395 | 555 | 318 | 683 | 724 | 811 | 826 | 939 | 926 |
| 44 | 80 | 172 | 296 | 300 | 672 | 428 | 673 | 556 | 675 | 684 | 841 | 812 | 732 | 940 | 764 |
| 45 | 37 | 173 | 163 | 301 | 118 | 429 | 583 | 557 | 618 | 685 | 629 | 813 | 446 | 941 | 941 |
| 46 | 25 | 174 | 92 | 302 | 332 | 430 | 355 | 558 | 898 | 686 | 351 | 814 | 962 | 942 | 967 |
| 47 | 22 | 175 | 47 | 303 | 579 | 431 | 287 | 559 | 781 | 687 | 467 | 815 | 936 | 943 | 886 |
| 48 | 136 | 176 | 267 | 304 | 540 | 432 | 183 | 560 | 376 | 688 | 438 | 816 | 475 | 944 | 831 |
| 49 | 260 | 177 | 385 | 305 | 389 | 433 | 234 | 561 | 428 | 689 | 737 | 817 | 853 | 945 | 947 |

| | | | | | | | | | | | | | | | |
|---|---|---|---|---|---|---|---|---|---|---|---|---|---|---|---|
| 50 | 264 | 178 | 546 | 306 | 173 | 434 | 125 | 562 | 665 | 690 | 251 | 818 | 867 | 946 | 507 |
| 51 | 38 | 179 | 324 | 307 | 121 | 435 | 557 | 563 | 736 | 691 | 462 | 819 | 637 | 947 | 889 |
| 52 | 514 | 180 | 208 | 308 | 553 | 436 | 660 | 564 | 567 | 692 | 442 | 820 | 907 | 948 | 984 |
| 53 | 96 | 181 | 386 | 309 | 199 | 437 | 616 | 565 | 840 | 693 | 441 | 821 | 487 | 949 | 751 |
| 54 | 67 | 182 | 150 | 310 | 784 | 438 | 342 | 566 | 625 | 694 | 469 | 822 | 695 | 950 | 942 |
| 55 | 41 | 183 | 153 | 311 | 179 | 439 | 316 | 567 | 238 | 695 | 247 | 823 | 746 | 951 | 996 |
| 56 | 144 | 184 | 165 | 312 | 228 | 440 | 241 | 568 | 359 | 696 | 683 | 824 | 828 | 952 | 971 |
| 57 | 28 | 185 | 106 | 313 | 338 | 441 | 778 | 569 | 457 | 697 | 842 | 825 | 753 | 953 | 890 |
| 58 | 69 | 186 | 55 | 314 | 312 | 442 | 563 | 570 | 399 | 698 | 738 | 826 | 854 | 954 | 509 |
| 59 | 42 | 187 | 328 | 315 | 704 | 443 | 345 | 571 | 787 | 699 | 899 | 827 | 857 | 955 | 949 |
| 60 | 516 | 188 | 536 | 316 | 390 | 444 | 452 | 572 | 591 | 700 | 670 | 828 | 504 | 956 | 973 |
| 61 | 49 | 189 | 577 | 317 | 174 | 445 | 397 | 573 | 678 | 701 | 783 | 829 | 799 | 957 | 1000 |
| 62 | 74 | 190 | 548 | 318 | 554 | 446 | 403 | 574 | 434 | 702 | 849 | 830 | 255 | 958 | 892 |
| 63 | 272 | 191 | 113 | 319 | 581 | 447 | 207 | 575 | 677 | 703 | 820 | 831 | 964 | 959 | 950 |
| 64 | 160 | 192 | 154 | 320 | 393 | 448 | 674 | 576 | 349 | 704 | 728 | 832 | 909 | 960 | 863 |
| 65 | 520 | 193 | 79 | 321 | 283 | 449 | 558 | 577 | 245 | 705 | 928 | 833 | 719 | 961 | 759 |
| 66 | 288 | 194 | 269 | 322 | 122 | 450 | 785 | 578 | 458 | 706 | 791 | 834 | 477 | 962 | 1008 |
| 67 | 528 | 195 | 108 | 323 | 448 | 451 | 432 | 579 | 666 | 707 | 367 | 835 | 915 | 963 | 510 |
| 68 | 192 | 196 | 578 | 324 | 353 | 452 | 357 | 580 | 620 | 708 | 901 | 836 | 638 | 964 | 979 |
| 69 | 544 | 197 | 224 | 325 | 561 | 453 | 187 | 581 | 363 | 709 | 630 | 837 | 748 | 965 | 953 |
| 70 | 70 | 198 | 166 | 326 | 203 | 454 | 236 | 582 | 127 | 710 | 685 | 838 | 944 | 966 | 763 |
| 71 | 44 | 199 | 519 | 327 | 63 | 455 | 664 | 583 | 191 | 711 | 844 | 839 | 869 | 967 | 974 |
| 72 | 131 | 200 | 552 | 328 | 340 | 456 | 624 | 584 | 782 | 712 | 633 | 840 | 491 | 968 | 954 |
| 73 | 81 | 201 | 195 | 329 | 394 | 457 | 587 | 585 | 407 | 713 | 711 | 841 | 699 | 969 | 879 |
| 74 | 50 | 202 | 270 | 330 | 527 | 458 | 780 | 586 | 436 | 714 | 253 | 842 | 754 | 970 | 981 |
| 75 | 73 | 203 | 641 | 331 | 582 | 459 | 705 | 587 | 626 | 715 | 691 | 843 | 858 | 971 | 982 |
| 76 | 15 | 204 | 523 | 332 | 556 | 460 | 126 | 588 | 571 | 716 | 824 | 844 | 478 | 972 | 927 |
| 77 | 320 | 205 | 275 | 333 | 181 | 461 | 242 | 589 | 465 | 717 | 902 | 845 | 968 | 973 | 995 |
| 78 | 133 | 206 | 580 | 334 | 295 | 462 | 565 | 590 | 681 | 718 | 686 | 846 | 383 | 974 | 765 |
| 79 | 52 | 207 | 291 | 335 | 285 | 463 | 398 | 591 | 246 | 719 | 740 | 847 | 910 | 975 | 956 |
| 80 | 23 | 208 | 59 | 336 | 232 | 464 | 346 | 592 | 707 | 720 | 850 | 848 | 815 | 976 | 887 |
| 81 | 134 | 209 | 169 | 337 | 124 | 465 | 456 | 593 | 350 | 721 | 375 | 849 | 976 | 977 | 985 |
| 82 | 384 | 210 | 560 | 338 | 205 | 466 | 358 | 594 | 599 | 722 | 444 | 850 | 870 | 978 | 997 |
| 83 | 76 | 211 | 114 | 339 | 182 | 467 | 405 | 595 | 668 | 723 | 470 | 851 | 917 | 979 | 986 |
| 84 | 137 | 212 | 277 | 340 | 643 | 468 | 303 | 596 | 790 | 724 | 483 | 852 | 727 | 980 | 943 |
| 85 | 82 | 213 | 156 | 341 | 562 | 469 | 569 | 597 | 460 | 725 | 415 | 853 | 493 | 981 | 891 |
| 86 | 56 | 214 | 87 | 342 | 286 | 470 | 244 | 598 | 249 | 726 | 485 | 854 | 873 | 982 | 998 |
| 87 | 27 | 215 | 197 | 343 | 585 | 471 | 595 | 599 | 682 | 727 | 905 | 855 | 701 | 983 | 766 |
| 88 | 97 | 216 | 116 | 344 | 299 | 472 | 189 | 600 | 573 | 728 | 795 | 856 | 931 | 984 | 511 |

| 89 | 39 | 217 | 170 | 345 | 354 | 473 | 566 | 601 | 411 | 729 | 473 | 857 | 756 | 985 | 988 |
|---|---|---|---|---|---|---|---|---|---|---|---|---|---|---|---|
| 90 | 259 | 218 | 61 | 346 | 211 | 474 | 676 | 602 | 803 | 730 | 634 | 858 | 860 | 986 | 1001 |
| 91 | 84 | 219 | 531 | 347 | 401 | 475 | 361 | 603 | 789 | 731 | 744 | 859 | 499 | 987 | 951 |
| 92 | 138 | 220 | 525 | 348 | 185 | 476 | 706 | 604 | 709 | 732 | 852 | 860 | 731 | 988 | 1002 |
| 93 | 145 | 221 | 642 | 349 | 396 | 477 | 589 | 605 | 365 | 733 | 960 | 861 | 823 | 989 | 893 |
| 94 | 261 | 222 | 281 | 350 | 344 | 478 | 215 | 606 | 440 | 734 | 865 | 862 | 922 | 990 | 975 |
| 95 | 29 | 223 | 278 | 351 | 586 | 479 | 786 | 607 | 628 | 735 | 693 | 863 | 874 | 991 | 894 |
| 96 | 43 | 224 | 526 | 352 | 645 | 480 | 647 | 608 | 689 | 736 | 797 | 864 | 918 | 992 | 1009 |
| 97 | 98 | 225 | 177 | 353 | 593 | 481 | 348 | 609 | 374 | 737 | 906 | 865 | 502 | 993 | 955 |
| 98 | 515 | 226 | 293 | 354 | 535 | 482 | 419 | 610 | 423 | 738 | 715 | 866 | 933 | 994 | 1004 |
| 99 | 88 | 227 | 388 | 355 | 240 | 483 | 406 | 611 | 466 | 739 | 807 | 867 | 743 | 995 | 1010 |
| 100 | 140 | 228 | 91 | 356 | 206 | 484 | 464 | 612 | 793 | 740 | 474 | 868 | 760 | 996 | 957 |
| 101 | 30 | 229 | 584 | 357 | 95 | 485 | 680 | 613 | 250 | 741 | 636 | 869 | 881 | 997 | 983 |
| 102 | 146 | 230 | 769 | 358 | 327 | 486 | 801 | 614 | 371 | 742 | 694 | 870 | 494 | 998 | 958 |
| 103 | 71 | 231 | 198 | 359 | 564 | 487 | 362 | 615 | 481 | 743 | 254 | 871 | 702 | 999 | 987 |
| 104 | 262 | 232 | 172 | 360 | 800 | 488 | 590 | 616 | 574 | 744 | 717 | 872 | 921 | 1000 | 1012 |
| 105 | 265 | 233 | 120 | 361 | 402 | 489 | 409 | 617 | 413 | 745 | 575 | 873 | 501 | 1001 | 999 |
| 106 | 161 | 234 | 201 | 362 | 356 | 490 | 570 | 618 | 603 | 746 | 913 | 874 | 876 | 1002 | 1016 |
| 107 | 576 | 235 | 336 | 363 | 307 | 491 | 788 | 619 | 366 | 747 | 798 | 875 | 847 | 1003 | 767 |
| 108 | 45 | 236 | 62 | 364 | 301 | 492 | 597 | 620 | 468 | 748 | 811 | 876 | 992 | 1004 | 989 |
| 109 | 100 | 237 | 282 | 365 | 417 | 493 | 572 | 621 | 655 | 749 | 379 | 877 | 447 | 1005 | 1003 |
| 110 | 640 | 238 | 143 | 366 | 213 | 494 | 219 | 622 | 900 | 750 | 697 | 878 | 733 | 1006 | 990 |
| 111 | 51 | 239 | 103 | 367 | 568 | 495 | 311 | 623 | 805 | 751 | 431 | 879 | 827 | 1007 | 1005 |
| 112 | 148 | 240 | 178 | 368 | 832 | 496 | 708 | 624 | 615 | 752 | 607 | 880 | 934 | 1008 | 959 |
| 113 | 46 | 241 | 294 | 369 | 588 | 497 | 598 | 625 | 684 | 753 | 489 | 881 | 882 | 1009 | 1011 |
| 114 | 75 | 242 | 93 | 370 | 186 | 498 | 601 | 626 | 710 | 754 | 866 | 882 | 937 | 1010 | 1013 |
| 115 | 266 | 243 | 644 | 371 | 646 | 499 | 651 | 627 | 429 | 755 | 723 | 883 | 963 | 1011 | 895 |
| 116 | 273 | 244 | 202 | 372 | 404 | 500 | 421 | 628 | 794 | 756 | 486 | 884 | 747 | 1012 | 1006 |
| 117 | 517 | 245 | 592 | 373 | 227 | 501 | 792 | 629 | 252 | 757 | 908 | 885 | 505 | 1013 | 1014 |
| 118 | 104 | 246 | 323 | 374 | 896 | 502 | 802 | 630 | 373 | 758 | 718 | 886 | 855 | 1014 | 1017 |
| 119 | 162 | 247 | 392 | 375 | 594 | 503 | 611 | 631 | 605 | 759 | 813 | 887 | 924 | 1015 | 1018 |
| 120 | 53 | 248 | 297 | 376 | 418 | 504 | 602 | 632 | 848 | 760 | 476 | 888 | 734 | 1016 | 991 |
| 121 | 193 | 249 | 770 | 377 | 302 | 505 | 410 | 633 | 690 | 761 | 856 | 889 | 829 | 1017 | 1020 |
| 122 | 152 | 250 | 107 | 378 | 649 | 506 | 231 | 634 | 713 | 762 | 839 | 890 | 965 | 1018 | 1007 |
| 123 | 77 | 251 | 180 | 379 | 771 | 507 | 688 | 635 | 632 | 763 | 725 | 891 | 938 | 1019 | 1015 |
| 124 | 164 | 252 | 151 | 380 | 360 | 508 | 653 | 636 | 482 | 764 | 698 | 892 | 884 | 1020 | 1019 |
| 125 | 768 | 253 | 209 | 381 | 539 | 509 | 248 | 637 | 806 | 765 | 914 | 893 | 506 | 1021 | 1021 |
| 126 | 268 | 254 | 284 | 382 | 111 | 510 | 369 | 638 | 427 | 766 | 752 | 894 | 749 | 1022 | 1022 |
| 127 | 274 | 255 | 648 | 383 | 331 | 511 | 190 | 639 | 904 | 767 | 868 | 895 | 945 | 1023 | 1023 |

**2.** Verfahren nach Anspruch 1, wobei die zweite Sequenz vorgespeichert wird.

**3.** Verfahren nach Anspruch 1 oder 2, wobei die K zu codierenden Bits ein zyklisches Redundanzprüfbit umfassen.

**4.** Verfahren nach einem der Ansprüche 1 bis 3, wobei die K zu codierenden Bits ein Paritätsprüfbit umfassen.

**5.** Verfahren nach einem der Ansprüche 1 bis 4, wobei die Sequenznummern der N polarisierten Kanäle von 0 bis N-1 reichen.

**6.** Codiereinrichtung (300), umfassend:

eine Erhaltungseinheit (601), die konfiguriert ist, um eine erste Sequenz zu erhalten, die verwendet wird, um K zu codierende Bits zu codieren, K eine positive ganze Zahl ist, wobei die erste Sequenz Sequenznummern von N polarisierten Kanälen umfasst, die Sequenznummern der N polarisierten Kanäle in der ersten Sequenz basierend auf der Zuverlässigkeit der N polarisierten Kanäle angeordnet sind, N eine Muttercodelänge eines Polarcodes ist, $N = 2^n$ ist, n eine positive ganze Zahl ist und $K \leq N$ ist, wobei die erste Sequenz die Gesamtheit oder eine Teilmenge einer zweiten Sequenz ist, die zweite Sequenz Sequenznummern von $N_{max}$ polarisierten Kanälen umfasst, die Sequenznummern der $N_{max}$ polarisierten Kanäle in der zweiten Sequenz basierend auf der Zuverlässigkeit der $N_{max}$ polarisierten Kanäle angeordnet sind, eine Reihenfolge, in der die Sequenznummern der polarisierten Kanäle in der ersten Sequenz angeordnet sind, mit einer Reihenfolge übereinstimmt, in der Sequenznummern kleiner als N in den Sequenznummern der polarisierten Kanäle in der zweiten Sequenz angeordnet sind, $N \geq 64$ ist, $N_{max}$ eine positive ganze Zahl ist, $N_{max} \geq N$ ist;
eine Auswahleinheit (602), die konfiguriert ist, um Sequenznummern von K polarisierten Kanälen aus der ersten Sequenz basierend auf einer Zuverlässigkeitsreihenfolge auszuwählen; und
eine Codiereinheit (603), die konfiguriert ist, um die K zu codierenden Bits basierend auf den ausgewählten Sequenznummern der K polarisierten Kanäle zu platzieren und eine Polarcode-Codierung an den K zu codierenden Bits durchzuführen,
wobei $N_{max}$=1024 ist, die zweite Sequenz die Sequenz in Tabelle Q11 ist,
**dadurch gekennzeichnet, dass** die Tabelle Q11 Folgendes ist:

| Zuverlässigkeit oder der Zuverlässigkeit | Polarisierte Kanalsequenznummer | Zuverlässigkeit oder der Sequenznummer der Zuverlässigkeit | Polarisierte Kanalsequenznummer | Zuverlässigkeit oder der Sequenznummer der Zuverlässigkeit | Polarisierte Kanalsequenznummer | Zuverlässigkeit oder der Sequenznummer der Zuverlässigkeit | Polarisierte Kanalsequenznummer | Zuverlässigkeit oder der Sequenznummer der Zuverlässigkeit | Polarisierte Kanalsequenznummer | Zuverlässigkeit oder der Sequenznummer der Zuverlässigkeit | Polarisierte Kanalsequenznummer | Zuverlässigkeit oder der Sequenznummer der Zuverlässigkeit | Polarisierte Kanalsequenznummer | Zuverlässigkeit oder der Sequenznummer der Zuverlässigkeit | Polarisierte Kanalsequenznummer |
|---|---|---|---|---|---|---|---|---|---|---|---|---|---|---|---|
| 0 | 0 | 128 | 518 | 256 | 94 | 384 | 214 | 512 | 364 | 640 | 414 | 768 | 819 | 896 | 966 |
| 1 | 1 | 129 | 54 | 257 | 204 | 385 | 309 | 513 | 654 | 641 | 223 | 769 | 814 | 897 | 755 |
| 2 | 2 | 130 | 83 | 258 | 298 | 386 | 188 | 514 | 659 | 642 | 663 | 770 | 439 | 898 | 859 |

| | | | | | | | | | | | | | | | |
|---|---|---|---|---|---|---|---|---|---|---|---|---|---|---|---|
| 3 | 4 | 131 | 57 | 259 | 400 | 387 | 449 | 515 | 335 | 643 | 692 | 771 | 929 | 899 | 940 |
| 4 | 8 | 132 | 521 | 260 | 608 | 388 | 217 | 516 | 480 | 644 | 835 | 772 | 490 | 900 | 830 |
| 5 | 16 | 133 | 112 | 261 | 352 | 389 | 408 | 517 | 315 | 645 | 619 | 773 | 623 | 901 | 911 |
| 6 | 32 | 134 | 135 | 262 | 325 | 390 | 609 | 518 | 221 | 646 | 472 | 774 | 671 | 902 | 871 |
| 7 | 3 | 135 | 78 | 263 | 533 | 391 | 596 | 519 | 370 | 647 | 455 | 775 | 739 | 903 | 639 |
| 8 | 5 | 136 | 289 | 264 | 155 | 392 | 551 | 520 | 613 | 648 | 796 | 776 | 916 | 904 | 888 |
| 9 | 64 | 137 | 194 | 265 | 210 | 393 | 650 | 521 | 422 | 649 | 809 | 777 | 463 | 905 | 479 |
| 10 | 9 | 138 | 85 | 266 | 305 | 394 | 229 | 522 | 425 | 650 | 714 | 778 | 843 | 906 | 946 |
| 11 | 6 | 139 | 276 | 267 | 547 | 395 | 159 | 523 | 451 | 651 | 721 | 779 | 381 | 907 | 750 |
| 12 | 17 | 140 | 522 | 268 | 300 | 396 | 420 | 524 | 614 | 652 | 837 | 780 | 497 | 908 | 969 |
| 13 | 10 | 141 | 58 | 269 | 109 | 397 | 310 | 525 | 543 | 653 | 716 | 781 | 930 | 909 | 508 |
| 14 | 18 | 142 | 168 | 270 | 184 | 398 | 541 | 526 | 235 | 654 | 864 | 782 | 821 | 910 | 861 |
| 15 | 128 | 143 | 139 | 271 | 534 | 399 | 773 | 527 | 412 | 655 | 810 | 783 | 726 | 911 | 757 |
| 16 | 12 | 144 | 99 | 272 | 537 | 400 | 610 | 528 | 343 | 656 | 606 | 784 | 961 | 912 | 970 |
| 17 | 33 | 145 | 86 | 273 | 115 | 401 | 657 | 529 | 372 | 657 | 912 | 785 | 872 | 913 | 919 |
| 18 | 65 | 146 | 60 | 274 | 167 | 402 | 333 | 530 | 775 | 658 | 722 | 786 | 492 | 914 | 875 |
| 19 | 20 | 147 | 280 | 275 | 225 | 403 | 119 | 531 | 317 | 659 | 696 | 787 | 631 | 915 | 862 |
| 20 | 256 | 148 | 89 | 276 | 326 | 404 | 600 | 532 | 222 | 660 | 377 | 788 | 729 | 916 | 758 |
| 21 | 34 | 149 | 290 | 277 | 306 | 405 | 339 | 533 | 426 | 661 | 435 | 789 | 700 | 917 | 948 |
| 22 | 24 | 150 | 529 | 278 | 772 | 406 | 218 | 534 | 453 | 662 | 817 | 790 | 443 | 918 | 977 |
| 23 | 36 | 151 | 524 | 279 | 157 | 407 | 368 | 535 | 237 | 663 | 319 | 791 | 741 | 919 | 923 |
| 24 | 7 | 152 | 196 | 280 | 656 | 408 | 652 | 536 | 559 | 664 | 621 | 792 | 845 | 920 | 972 |
| 25 | 129 | 153 | 141 | 281 | 329 | 409 | 230 | 537 | 833 | 665 | 812 | 793 | 920 | 921 | 761 |
| 26 | 66 | 154 | 101 | 282 | 110 | 410 | 391 | 538 | 804 | 666 | 484 | 794 | 382 | 922 | 877 |
| 27 | 512 | 155 | 147 | 283 | 117 | 411 | 313 | 539 | 712 | 667 | 430 | 795 | 822 | 923 | 952 |
| 28 | 11 | 156 | 176 | 284 | 212 | 412 | 450 | 540 | 834 | 668 | 838 | 796 | 851 | 924 | 495 |
| 29 | 40 | 157 | 142 | 285 | 171 | 413 | 542 | 541 | 661 | 669 | 667 | 797 | 730 | 925 | 703 |
| 30 | 68 | 158 | 530 | 286 | 776 | 414 | 334 | 542 | 808 | 670 | 488 | 798 | 498 | 926 | 935 |
| 31 | 130 | 159 | 321 | 287 | 330 | 415 | 233 | 543 | 779 | 671 | 239 | 799 | 880 | 927 | 978 |
| 32 | 19 | 160 | 31 | 288 | 226 | 416 | 555 | 544 | 617 | 672 | 378 | 800 | 742 | 928 | 883 |
| 33 | 13 | 161 | 200 | 289 | 549 | 417 | 774 | 545 | 604 | 673 | 459 | 801 | 445 | 929 | 762 |
| 34 | 48 | 162 | 90 | 290 | 538 | 418 | 175 | 546 | 433 | 674 | 622 | 802 | 471 | 930 | 503 |
| 35 | 14 | 163 | 545 | 291 | 387 | 419 | 123 | 547 | 720 | 675 | 627 | 803 | 635 | 931 | 925 |
| 36 | 72 | 164 | 292 | 292 | 308 | 420 | 658 | 548 | 816 | 676 | 437 | 804 | 932 | 932 | 878 |
| 37 | 257 | 165 | 322 | 293 | 216 | 421 | 612 | 549 | 836 | 677 | 380 | 805 | 687 | 933 | 735 |
| 38 | 21 | 166 | 532 | 294 | 416 | 422 | 341 | 550 | 347 | 678 | 818 | 806 | 903 | 934 | 993 |
| 39 | 132 | 167 | 263 | 295 | 271 | 423 | 777 | 551 | 897 | 679 | 461 | 807 | 825 | 935 | 885 |
| 40 | 35 | 168 | 149 | 296 | 279 | 424 | 220 | 552 | 243 | 680 | 496 | 808 | 500 | 936 | 939 |
| 41 | 258 | 169 | 102 | 297 | 158 | 425 | 314 | 553 | 662 | 681 | 669 | 809 | 846 | 937 | 994 |

| 42 | 26 | 170 | 105 | 298 | 337 | 426 | 424 | 554 | 454 | 682 | 679 | 810 | 745 | 938 | 980 |
|---|---|---|---|---|---|---|---|---|---|---|---|---|---|---|---|
| 43 | 513 | 171 | 304 | 299 | 550 | 427 | 395 | 555 | 318 | 683 | 724 | 811 | 826 | 939 | 926 |
| 44 | 80 | 172 | 296 | 300 | 672 | 428 | 673 | 556 | 675 | 684 | 841 | 812 | 732 | 940 | 764 |
| 45 | 37 | 173 | 163 | 301 | 118 | 429 | 583 | 557 | 618 | 685 | 629 | 813 | 446 | 941 | 941 |
| 46 | 25 | 174 | 92 | 302 | 332 | 430 | 355 | 558 | 898 | 686 | 351 | 814 | 962 | 942 | 967 |
| 47 | 22 | 175 | 47 | 303 | 579 | 431 | 287 | 559 | 781 | 687 | 467 | 815 | 936 | 943 | 886 |
| 48 | 136 | 176 | 267 | 304 | 540 | 432 | 183 | 560 | 376 | 688 | 438 | 816 | 475 | 944 | 831 |
| 49 | 260 | 177 | 385 | 305 | 389 | 433 | 234 | 561 | 428 | 689 | 737 | 817 | 853 | 945 | 947 |
| 50 | 264 | 178 | 546 | 306 | 173 | 434 | 125 | 562 | 665 | 690 | 251 | 818 | 867 | 946 | 507 |
| 51 | 38 | 179 | 324 | 307 | 121 | 435 | 557 | 563 | 736 | 691 | 462 | 819 | 637 | 947 | 889 |
| 52 | 514 | 180 | 208 | 308 | 553 | 436 | 660 | 564 | 567 | 692 | 442 | 820 | 907 | 948 | 984 |
| 53 | 96 | 181 | 386 | 309 | 199 | 437 | 616 | 565 | 840 | 693 | 441 | 821 | 487 | 949 | 751 |
| 54 | 67 | 182 | 150 | 310 | 784 | 438 | 342 | 566 | 625 | 694 | 469 | 822 | 695 | 950 | 942 |
| 55 | 41 | 183 | 153 | 311 | 179 | 439 | 316 | 567 | 238 | 695 | 247 | 823 | 746 | 951 | 996 |
| 56 | 144 | 184 | 165 | 312 | 228 | 440 | 241 | 568 | 359 | 696 | 683 | 824 | 828 | 952 | 971 |
| 57 | 28 | 185 | 106 | 313 | 338 | 441 | 778 | 569 | 457 | 697 | 842 | 825 | 753 | 953 | 890 |
| 58 | 69 | 186 | 55 | 314 | 312 | 442 | 563 | 570 | 399 | 698 | 738 | 826 | 854 | 954 | 509 |
| 59 | 42 | 187 | 328 | 315 | 704 | 443 | 345 | 571 | 787 | 699 | 899 | 827 | 857 | 955 | 949 |
| 60 | 516 | 188 | 536 | 316 | 390 | 444 | 452 | 572 | 591 | 700 | 670 | 828 | 504 | 956 | 973 |
| 61 | 49 | 189 | 577 | 317 | 174 | 445 | 397 | 573 | 678 | 701 | 783 | 829 | 799 | 957 | 1000 |
| 62 | 74 | 190 | 548 | 318 | 554 | 446 | 403 | 574 | 434 | 702 | 849 | 830 | 255 | 958 | 892 |
| 63 | 272 | 191 | 113 | 319 | 581 | 447 | 207 | 575 | 677 | 703 | 820 | 831 | 964 | 959 | 950 |
| 64 | 160 | 192 | 154 | 320 | 393 | 448 | 674 | 576 | 349 | 704 | 728 | 832 | 909 | 960 | 863 |
| 65 | 520 | 193 | 79 | 321 | 283 | 449 | 558 | 577 | 245 | 705 | 928 | 833 | 719 | 961 | 759 |
| 66 | 288 | 194 | 269 | 322 | 122 | 450 | 785 | 578 | 458 | 706 | 791 | 834 | 477 | 962 | 1008 |
| 67 | 528 | 195 | 108 | 323 | 448 | 451 | 432 | 579 | 666 | 707 | 367 | 835 | 915 | 963 | 510 |
| 68 | 192 | 196 | 578 | 324 | 353 | 452 | 357 | 580 | 620 | 708 | 901 | 836 | 638 | 964 | 979 |
| 69 | 544 | 197 | 224 | 325 | 561 | 453 | 187 | 581 | 363 | 709 | 630 | 837 | 748 | 965 | 953 |
| 70 | 70 | 198 | 166 | 326 | 203 | 454 | 236 | 582 | 127 | 710 | 685 | 838 | 944 | 966 | 763 |
| 71 | 44 | 199 | 519 | 327 | 63 | 455 | 664 | 583 | 191 | 711 | 844 | 839 | 869 | 967 | 974 |
| 72 | 131 | 200 | 552 | 328 | 340 | 456 | 624 | 584 | 782 | 712 | 633 | 840 | 491 | 968 | 954 |
| 73 | 81 | 201 | 195 | 329 | 394 | 457 | 587 | 585 | 407 | 713 | 711 | 841 | 699 | 969 | 879 |
| 74 | 50 | 202 | 270 | 330 | 527 | 458 | 780 | 586 | 436 | 714 | 253 | 842 | 754 | 970 | 981 |
| 75 | 73 | 203 | 641 | 331 | 582 | 459 | 705 | 587 | 626 | 715 | 691 | 843 | 858 | 971 | 982 |
| 76 | 15 | 204 | 523 | 332 | 556 | 460 | 126 | 588 | 571 | 716 | 824 | 844 | 478 | 972 | 927 |
| 77 | 320 | 205 | 275 | 333 | 181 | 461 | 242 | 589 | 465 | 717 | 902 | 845 | 968 | 973 | 995 |
| 78 | 133 | 206 | 580 | 334 | 295 | 462 | 565 | 590 | 681 | 718 | 686 | 846 | 383 | 974 | 765 |
| 79 | 52 | 207 | 291 | 335 | 285 | 463 | 398 | 591 | 246 | 719 | 740 | 847 | 910 | 975 | 956 |
| 80 | 23 | 208 | 59 | 336 | 232 | 464 | 346 | 592 | 707 | 720 | 850 | 848 | 815 | 976 | 887 |

| | | | | | | | | | | | | | | | |
|---|---|---|---|---|---|---|---|---|---|---|---|---|---|---|---|
| 81 | 134 | 209 | 169 | 337 | 124 | 465 | 456 | 593 | 350 | 721 | 375 | 849 | 976 | 977 | 985 |
| 82 | 384 | 210 | 560 | 338 | 205 | 466 | 358 | 594 | 599 | 722 | 444 | 850 | 870 | 978 | 997 |
| 83 | 76 | 211 | 114 | 339 | 182 | 467 | 405 | 595 | 668 | 723 | 470 | 851 | 917 | 979 | 986 |
| 84 | 137 | 212 | 277 | 340 | 643 | 468 | 303 | 596 | 790 | 724 | 483 | 852 | 727 | 980 | 943 |
| 85 | 82 | 213 | 156 | 341 | 562 | 469 | 569 | 597 | 460 | 725 | 415 | 853 | 493 | 981 | 891 |
| 86 | 56 | 214 | 87 | 342 | 286 | 470 | 244 | 598 | 249 | 726 | 485 | 854 | 873 | 982 | 998 |
| 87 | 27 | 215 | 197 | 343 | 585 | 471 | 595 | 599 | 682 | 727 | 905 | 855 | 701 | 983 | 766 |
| 88 | 97 | 216 | 116 | 344 | 299 | 472 | 189 | 600 | 573 | 728 | 795 | 856 | 931 | 984 | 511 |
| 89 | 39 | 217 | 170 | 345 | 354 | 473 | 566 | 601 | 411 | 729 | 473 | 857 | 756 | 985 | 988 |
| 90 | 259 | 218 | 61 | 346 | 211 | 474 | 676 | 602 | 803 | 730 | 634 | 858 | 860 | 986 | 1001 |
| 91 | 84 | 219 | 531 | 347 | 401 | 475 | 361 | 603 | 789 | 731 | 744 | 859 | 499 | 987 | 951 |
| 92 | 138 | 220 | 525 | 348 | 185 | 476 | 706 | 604 | 709 | 732 | 852 | 860 | 731 | 988 | 1002 |
| 93 | 145 | 221 | 642 | 349 | 396 | 477 | 589 | 605 | 365 | 733 | 960 | 861 | 823 | 989 | 893 |
| 94 | 261 | 222 | 281 | 350 | 344 | 478 | 215 | 606 | 440 | 734 | 865 | 862 | 922 | 990 | 975 |
| 95 | 29 | 223 | 278 | 351 | 586 | 479 | 786 | 607 | 628 | 735 | 693 | 863 | 874 | 991 | 894 |
| 96 | 43 | 224 | 526 | 352 | 645 | 480 | 647 | 608 | 689 | 736 | 797 | 864 | 918 | 992 | 1009 |
| 97 | 98 | 225 | 177 | 353 | 593 | 481 | 348 | 609 | 374 | 737 | 906 | 865 | 502 | 993 | 955 |
| 98 | 515 | 226 | 293 | 354 | 535 | 482 | 419 | 610 | 423 | 738 | 715 | 866 | 933 | 994 | 1004 |
| 99 | 88 | 227 | 388 | 355 | 240 | 483 | 406 | 611 | 466 | 739 | 807 | 867 | 743 | 995 | 1010 |
| 100 | 140 | 228 | 91 | 356 | 206 | 484 | 464 | 612 | 793 | 740 | 474 | 868 | 760 | 996 | 957 |
| 101 | 30 | 229 | 584 | 357 | 95 | 485 | 680 | 613 | 250 | 741 | 636 | 869 | 881 | 997 | 983 |
| 102 | 146 | 230 | 769 | 358 | 327 | 486 | 801 | 614 | 371 | 742 | 694 | 870 | 494 | 998 | 958 |
| 103 | 71 | 231 | 198 | 359 | 564 | 487 | 362 | 615 | 481 | 743 | 254 | 871 | 702 | 999 | 987 |
| 104 | 262 | 232 | 172 | 360 | 800 | 488 | 590 | 616 | 574 | 744 | 717 | 872 | 921 | 1000 | 1012 |
| 105 | 265 | 233 | 120 | 361 | 402 | 489 | 409 | 617 | 413 | 745 | 575 | 873 | 501 | 1001 | 999 |
| 106 | 161 | 234 | 201 | 362 | 356 | 490 | 570 | 618 | 603 | 746 | 913 | 874 | 876 | 1002 | 1016 |
| 107 | 576 | 235 | 336 | 363 | 307 | 491 | 788 | 619 | 366 | 747 | 798 | 875 | 847 | 1003 | 767 |
| 108 | 45 | 236 | 62 | 364 | 301 | 492 | 597 | 620 | 468 | 748 | 811 | 876 | 992 | 1004 | 989 |
| 109 | 100 | 237 | 282 | 365 | 417 | 493 | 572 | 621 | 655 | 749 | 379 | 877 | 447 | 1005 | 1003 |
| 110 | 640 | 238 | 143 | 366 | 213 | 494 | 219 | 622 | 900 | 750 | 697 | 878 | 733 | 1006 | 990 |
| 111 | 51 | 239 | 103 | 367 | 568 | 495 | 311 | 623 | 805 | 751 | 431 | 879 | 827 | 1007 | 1005 |
| 112 | 148 | 240 | 178 | 368 | 832 | 496 | 708 | 624 | 615 | 752 | 607 | 880 | 934 | 1008 | 959 |
| 113 | 46 | 241 | 294 | 369 | 588 | 497 | 598 | 625 | 684 | 753 | 489 | 881 | 882 | 1009 | 1011 |
| 114 | 75 | 242 | 93 | 370 | 186 | 498 | 601 | 626 | 710 | 754 | 866 | 882 | 937 | 1010 | 1013 |
| 115 | 266 | 243 | 644 | 371 | 646 | 499 | 651 | 627 | 429 | 755 | 723 | 883 | 963 | 1011 | 895 |
| 116 | 273 | 244 | 202 | 372 | 404 | 500 | 421 | 628 | 794 | 756 | 486 | 884 | 747 | 1012 | 1006 |
| 117 | 517 | 245 | 592 | 373 | 227 | 501 | 792 | 629 | 252 | 757 | 908 | 885 | 505 | 1013 | 1014 |
| 118 | 104 | 246 | 323 | 374 | 896 | 502 | 802 | 630 | 373 | 758 | 718 | 886 | 855 | 1014 | 1017 |
| 119 | 162 | 247 | 392 | 375 | 594 | 503 | 611 | 631 | 605 | 759 | 813 | 887 | 924 | 1015 | 1018 |

| 120 | 53 | 248 | 297 | 376 | 418 | 504 | 602 | 632 | 848 | 760 | 476 | 888 | 734 | 1016 | 991 |
| 121 | 193 | 249 | 770 | 377 | 302 | 505 | 410 | 633 | 690 | 761 | 856 | 889 | 829 | 1017 | 1020 |
| 122 | 152 | 250 | 107 | 378 | 649 | 506 | 231 | 634 | 713 | 762 | 839 | 890 | 965 | 1018 | 1007 |
| 123 | 77 | 251 | 180 | 379 | 771 | 507 | 688 | 635 | 632 | 763 | 725 | 891 | 938 | 1019 | 1015 |
| 124 | 164 | 252 | 151 | 380 | 360 | 508 | 653 | 636 | 482 | 764 | 698 | 892 | 884 | 1020 | 1019 |
| 125 | 768 | 253 | 209 | 381 | 539 | 509 | 248 | 637 | 806 | 765 | 914 | 893 | 506 | 1021 | 1021 |
| 126 | 268 | 254 | 284 | 382 | 111 | 510 | 369 | 638 | 427 | 766 | 752 | 894 | 749 | 1022 | 1022 |
| 127 | 274 | 255 | 648 | 383 | 331 | 511 | 190 | 639 | 904 | 767 | 868 | 895 | 945 | 1023 | 1023 |

**7.** Einrichtung nach Anspruch 6, wobei die zweite Sequenz vorgespeichert ist.

**8.** Einrichtung nach Anspruch 6 oder 7, wobei die K zu codierenden Bits ein zyklisches Redundanzprüfbit umfassen.

**9.** Einrichtung nach einem der Ansprüche 6 bis 8, wobei die K zu codierenden Bits ein Paritätsprüfbit umfassen.

**10.** Einrichtung nach einem der Ansprüche 6 bis 9, wobei die Sequenznummern der N polarisierten Kanäle von 0 bis N-1 reichen.

**11.** Einrichtung nach einem der Ansprüche 6 bis 10, wobei die Einrichtung ein Chip oder eine integrierte Schaltung ist.

**12.** Drahtlose Vorrichtung, umfassend die Codiereinrichtung (300) nach einem der Ansprüche 6 bis 10, einen Modulator (310) und einen Transceiver,

wobei der Modulator (310) konfiguriert ist, um eine Bitsequenz zu modulieren, die nach der Polarcodierung erhalten wurde, um eine modulierte Sequenz zu erhalten, und
der Transceiver (320) konfiguriert ist, um die modulierte Sequenz zu senden.

**13.** Drahtlose Vorrichtung nach Anspruch 12, wobei die drahtlose Vorrichtung ein Endgerät oder eine Netzwerkvorrichtung ist.

**14.** Computerspeichermedium, wobei das Computerspeichermedium ein Computerprogramm speichert und das Computerprogramm Anweisungen umfasst, die, wenn sie von einem Computer ausgeführt werden, den Computer veranlassen, das Verfahren nach einem der Ansprüche 1 bis 5 durchzuführen.

**15.** Computerprogrammprodukt, das Anweisungen umfasst, wenn sie von einem Computer ausgeführt werden, den Computer veranlassen, das Verfahren nach einem der Ansprüche 1 bis 5 auszuüben.

## Revendications

**1.** Procédé de codage exécuté par un appareil de codage, comprenant :

l'obtention (201) d'une première séquence utilisée pour coder K bits à coder, K étant un entier positif, dans lequel la première séquence comprend des numéros de séquence de N canaux polarisés, les numéros de séquence des N canaux polarisés sont agencés dans la première séquence sur la base de la fiabilité des N canaux polarisés, N est une longueur de code mère d'un code polaire, $N = 2^n$, n est un entier positif, et $K \leq N$, dans lequel la première séquence est la totalité ou un sous-ensemble d'une seconde séquence, la seconde séquence comprend des numéros de séquence de $N_{max}$ canaux polarisés, les numéros de séquence des $N_{max}$ canaux polarisés sont agencés dans la seconde séquence sur la base de la fiabilité des $N_{max}$ canaux polarisés, un ordre dans lequel les numéros de séquence des canaux polarisés dans la première séquence sont agencés est cohérent avec un ordre dans lequel les numéros de séquence inférieurs à N dans les numéros de séquence des canaux polarisés dans la seconde séquence sont agencés, $N \geq 64$, $N_{max}$ est un entier positif, $N_{max} \geq N$ ; la sélection (202) de numéros de séquence de K canaux polarisés à partir de la première séquence sur la base d'un ordre de fiabilité ; et

le placement (203) des K bits à coder sur la base des numéros de séquence sélectionnés des K canaux polarisés, et l'exécution d'un codage de code polaire sur les K bits à coder,

dans lequel $N_{max}=1\ 024$, la seconde séquence est la séquence du tableau Q11,

**caractérisé en ce que** le tableau Q11 est :

| Fiabilité ou numéro de séquence de fiabilité | Numéro de séquence de canal polarisé | Fiabilité ou numéro de séquence de fiabilité | Numéro de séquence de canal polarisé | Fiabilité ou numéro de séquence de fiabilité | Numéro de séquence de canal polarisé | Fiabilité ou numéro de séquence de fiabilité | Numéro de séquence de canal polarisé | Fiabilité ou numéro de séquence de fiabilité | Numéro de séquence de canal polarisé | Fiabilité ou numéro de séquence de fiabilité | Numéro de séquence de canal polarisé | Fiabilité ou numéro de séquence de fiabilité | Numéro de séquence de canal polarisé | Fiabilité ou numéro de séquence de fiabilité | Numéro de séquence de canal polarisé |
|---|---|---|---|---|---|---|---|---|---|---|---|---|---|---|---|
| 0 | 0 | 128 | 518 | 256 | 94 | 384 | 214 | 512 | 364 | 640 | 414 | 768 | 819 | 896 | 966 |
| 1 | 1 | 129 | 54 | 257 | 204 | 385 | 309 | 513 | 654 | 641 | 223 | 769 | 814 | 897 | 755 |
| 2 | 2 | 130 | 83 | 258 | 298 | 386 | 188 | 514 | 659 | 642 | 663 | 770 | 439 | 898 | 859 |
| 3 | 4 | 131 | 57 | 259 | 400 | 387 | 449 | 515 | 335 | 643 | 692 | 771 | 929 | 899 | 940 |
| 4 | 8 | 132 | 521 | 260 | 608 | 388 | 217 | 516 | 480 | 644 | 835 | 772 | 490 | 900 | 830 |
| 5 | 16 | 133 | 112 | 261 | 352 | 389 | 408 | 517 | 315 | 645 | 619 | 773 | 623 | 901 | 911 |
| 6 | 32 | 134 | 135 | 262 | 325 | 390 | 609 | 518 | 221 | 646 | 472 | 774 | 671 | 902 | 871 |
| 7 | 3 | 135 | 78 | 263 | 533 | 391 | 596 | 519 | 370 | 647 | 455 | 775 | 739 | 903 | 639 |
| 8 | 5 | 136 | 289 | 264 | 155 | 392 | 551 | 520 | 613 | 648 | 796 | 776 | 916 | 904 | 888 |
| 9 | 64 | 137 | 194 | 265 | 210 | 393 | 650 | 521 | 422 | 649 | 809 | 777 | 463 | 905 | 479 |
| 10 | 9 | 138 | 85 | 266 | 305 | 394 | 229 | 522 | 425 | 650 | 714 | 778 | 843 | 906 | 946 |

| | | | | | | | | | | | | | | | |
|---|---|---|---|---|---|---|---|---|---|---|---|---|---|---|---|
| 11 | 6 | 139 | 276 | 267 | 547 | 395 | 159 | 523 | 451 | 651 | 721 | 779 | 381 | 907 | 750 |
| 12 | 17 | 140 | 522 | 268 | 300 | 396 | 420 | 524 | 614 | 652 | 837 | 780 | 497 | 908 | 969 |
| 13 | 10 | 141 | 58 | 269 | 109 | 397 | 310 | 525 | 543 | 653 | 716 | 781 | 930 | 909 | 508 |
| 14 | 18 | 142 | 168 | 270 | 184 | 398 | 541 | 526 | 235 | 654 | 864 | 782 | 821 | 910 | 861 |
| 15 | 128 | 143 | 139 | 271 | 534 | 399 | 773 | 527 | 412 | 655 | 810 | 783 | 726 | 911 | 757 |
| 16 | 12 | 144 | 99 | 272 | 537 | 400 | 610 | 528 | 343 | 656 | 606 | 784 | 961 | 912 | 970 |
| 17 | 33 | 145 | 86 | 273 | 115 | 401 | 657 | 529 | 372 | 657 | 912 | 785 | 872 | 913 | 919 |
| 18 | 65 | 146 | 60 | 274 | 167 | 402 | 333 | 530 | 775 | 658 | 722 | 786 | 492 | 914 | 875 |
| 19 | 20 | 147 | 280 | 275 | 225 | 403 | 119 | 531 | 317 | 659 | 696 | 787 | 631 | 915 | 862 |
| 20 | 256 | 148 | 89 | 276 | 326 | 404 | 600 | 532 | 222 | 660 | 377 | 788 | 729 | 916 | 758 |
| 21 | 34 | 149 | 290 | 277 | 306 | 405 | 339 | 533 | 426 | 661 | 435 | 789 | 700 | 917 | 948 |
| 22 | 24 | 150 | 529 | 278 | 772 | 406 | 218 | 534 | 453 | 662 | 817 | 790 | 443 | 918 | 977 |
| 23 | 36 | 151 | 524 | 279 | 157 | 407 | 368 | 535 | 237 | 663 | 319 | 791 | 741 | 919 | 923 |
| 24 | 7 | 152 | 196 | 280 | 656 | 408 | 652 | 536 | 559 | 664 | 621 | 792 | 845 | 920 | 972 |
| 25 | 129 | 153 | 141 | 281 | 329 | 409 | 230 | 537 | 833 | 665 | 812 | 793 | 920 | 921 | 761 |
| 26 | 66 | 154 | 101 | 282 | 110 | 410 | 391 | 538 | 804 | 666 | 484 | 794 | 382 | 922 | 877 |
| 27 | 512 | 155 | 147 | 283 | 117 | 411 | 313 | 539 | 712 | 667 | 430 | 795 | 822 | 923 | 952 |
| 28 | 11 | 156 | 176 | 284 | 212 | 412 | 450 | 540 | 834 | 668 | 838 | 796 | 851 | 924 | 495 |
| 29 | 40 | 157 | 142 | 285 | 171 | 413 | 542 | 541 | 661 | 669 | 667 | 797 | 730 | 925 | 703 |
| 30 | 68 | 158 | 530 | 286 | 776 | 414 | 334 | 542 | 808 | 670 | 488 | 798 | 498 | 926 | 935 |
| 31 | 130 | 159 | 321 | 287 | 330 | 415 | 233 | 543 | 779 | 671 | 239 | 799 | 880 | 927 | 978 |
| 32 | 19 | 160 | 31 | 288 | 226 | 416 | 555 | 544 | 617 | 672 | 378 | 800 | 742 | 928 | 883 |
| 33 | 13 | 161 | 200 | 289 | 549 | 417 | 774 | 545 | 604 | 673 | 459 | 801 | 445 | 929 | 762 |
| 34 | 48 | 162 | 90 | 290 | 538 | 418 | 175 | 546 | 433 | 674 | 622 | 802 | 471 | 930 | 503 |
| 35 | 14 | 163 | 545 | 291 | 387 | 419 | 123 | 547 | 720 | 675 | 627 | 803 | 635 | 931 | 925 |
| 36 | 72 | 164 | 292 | 292 | 308 | 420 | 658 | 548 | 816 | 676 | 437 | 804 | 932 | 932 | 878 |
| 37 | 257 | 165 | 322 | 293 | 216 | 421 | 612 | 549 | 836 | 677 | 380 | 805 | 687 | 933 | 735 |
| 38 | 21 | 166 | 532 | 294 | 416 | 422 | 341 | 550 | 347 | 678 | 818 | 806 | 903 | 934 | 993 |
| 39 | 132 | 167 | 263 | 295 | 271 | 423 | 777 | 551 | 897 | 679 | 461 | 807 | 825 | 935 | 885 |
| 40 | 35 | 168 | 149 | 296 | 279 | 424 | 220 | 552 | 243 | 680 | 496 | 808 | 500 | 936 | 939 |
| 41 | 258 | 169 | 102 | 297 | 158 | 425 | 314 | 553 | 662 | 681 | 669 | 809 | 846 | 937 | 994 |
| 42 | 26 | 170 | 105 | 298 | 337 | 426 | 424 | 554 | 454 | 682 | 679 | 810 | 745 | 938 | 980 |
| 43 | 513 | 171 | 304 | 299 | 550 | 427 | 395 | 555 | 318 | 683 | 724 | 811 | 826 | 939 | 926 |
| 44 | 80 | 172 | 296 | 300 | 672 | 428 | 673 | 556 | 675 | 684 | 841 | 812 | 732 | 940 | 764 |
| 45 | 37 | 173 | 163 | 301 | 118 | 429 | 583 | 557 | 618 | 685 | 629 | 813 | 446 | 941 | 941 |
| 46 | 25 | 174 | 92 | 302 | 332 | 430 | 355 | 558 | 898 | 686 | 351 | 814 | 962 | 942 | 967 |
| 47 | 22 | 175 | 47 | 303 | 579 | 431 | 287 | 559 | 781 | 687 | 467 | 815 | 936 | 943 | 886 |
| 48 | 136 | 176 | 267 | 304 | 540 | 432 | 183 | 560 | 376 | 688 | 438 | 816 | 475 | 944 | 831 |
| 49 | 260 | 177 | 385 | 305 | 389 | 433 | 234 | 561 | 428 | 689 | 737 | 817 | 853 | 945 | 947 |

| | | | | | | | | | | | | | | | |
|---|---|---|---|---|---|---|---|---|---|---|---|---|---|---|---|
| 50 | 264 | 178 | 546 | 306 | 173 | 434 | 125 | 562 | 665 | 690 | 251 | 818 | 867 | 946 | 507 |
| 51 | 38 | 179 | 324 | 307 | 121 | 435 | 557 | 563 | 736 | 691 | 462 | 819 | 637 | 947 | 889 |
| 52 | 514 | 180 | 208 | 308 | 553 | 436 | 660 | 564 | 567 | 692 | 442 | 820 | 907 | 948 | 984 |
| 53 | 96 | 181 | 386 | 309 | 199 | 437 | 616 | 565 | 840 | 693 | 441 | 821 | 487 | 949 | 751 |
| 54 | 67 | 182 | 150 | 310 | 784 | 438 | 342 | 566 | 625 | 694 | 469 | 822 | 695 | 950 | 942 |
| 55 | 41 | 183 | 153 | 311 | 179 | 439 | 316 | 567 | 238 | 695 | 247 | 823 | 746 | 951 | 996 |
| 56 | 144 | 184 | 165 | 312 | 228 | 440 | 241 | 568 | 359 | 696 | 683 | 824 | 828 | 952 | 971 |
| 57 | 28 | 185 | 106 | 313 | 338 | 441 | 778 | 569 | 457 | 697 | 842 | 825 | 753 | 953 | 890 |
| 58 | 69 | 186 | 55 | 314 | 312 | 442 | 563 | 570 | 399 | 698 | 738 | 826 | 854 | 954 | 509 |
| 59 | 42 | 187 | 328 | 315 | 704 | 443 | 345 | 571 | 787 | 699 | 899 | 827 | 857 | 955 | 949 |
| 60 | 516 | 188 | 536 | 316 | 390 | 444 | 452 | 572 | 591 | 700 | 670 | 828 | 504 | 956 | 973 |
| 61 | 49 | 189 | 577 | 317 | 174 | 445 | 397 | 573 | 678 | 701 | 783 | 829 | 799 | 957 | 1000 |
| 62 | 74 | 190 | 548 | 318 | 554 | 446 | 403 | 574 | 434 | 702 | 849 | 830 | 255 | 958 | 892 |
| 63 | 272 | 191 | 113 | 319 | 581 | 447 | 207 | 575 | 677 | 703 | 820 | 831 | 964 | 959 | 950 |
| 64 | 160 | 192 | 154 | 320 | 393 | 448 | 674 | 576 | 349 | 704 | 728 | 832 | 909 | 960 | 863 |
| 65 | 520 | 193 | 79 | 321 | 283 | 449 | 558 | 577 | 245 | 705 | 928 | 833 | 719 | 961 | 759 |
| 66 | 288 | 194 | 269 | 322 | 122 | 450 | 785 | 578 | 458 | 706 | 791 | 834 | 477 | 962 | 1008 |
| 67 | 528 | 195 | 108 | 323 | 448 | 451 | 432 | 579 | 666 | 707 | 367 | 835 | 915 | 963 | 510 |
| 68 | 192 | 196 | 578 | 324 | 353 | 452 | 357 | 580 | 620 | 708 | 901 | 836 | 638 | 964 | 979 |
| 69 | 544 | 197 | 224 | 325 | 561 | 453 | 187 | 581 | 363 | 709 | 630 | 837 | 748 | 965 | 953 |
| 70 | 70 | 198 | 166 | 326 | 203 | 454 | 236 | 582 | 127 | 710 | 685 | 838 | 944 | 966 | 763 |
| 71 | 44 | 199 | 519 | 327 | 63 | 455 | 664 | 583 | 191 | 711 | 844 | 839 | 869 | 967 | 974 |
| 72 | 131 | 200 | 552 | 328 | 340 | 456 | 624 | 584 | 782 | 712 | 633 | 840 | 491 | 968 | 954 |
| 73 | 81 | 201 | 195 | 329 | 394 | 457 | 587 | 585 | 407 | 713 | 711 | 841 | 699 | 969 | 879 |
| 74 | 50 | 202 | 270 | 330 | 527 | 458 | 780 | 586 | 436 | 714 | 253 | 842 | 754 | 970 | 981 |
| 75 | 73 | 203 | 641 | 331 | 582 | 459 | 705 | 587 | 626 | 715 | 691 | 843 | 858 | 971 | 982 |
| 76 | 15 | 204 | 523 | 332 | 556 | 460 | 126 | 588 | 571 | 716 | 824 | 844 | 478 | 972 | 927 |
| 77 | 320 | 205 | 275 | 333 | 181 | 461 | 242 | 589 | 465 | 717 | 902 | 845 | 968 | 973 | 995 |
| 78 | 133 | 206 | 580 | 334 | 295 | 462 | 565 | 590 | 681 | 718 | 686 | 846 | 383 | 974 | 765 |
| 79 | 52 | 207 | 291 | 335 | 285 | 463 | 398 | 591 | 246 | 719 | 740 | 847 | 910 | 975 | 956 |
| 80 | 23 | 208 | 59 | 336 | 232 | 464 | 346 | 592 | 707 | 720 | 850 | 848 | 815 | 976 | 887 |
| 81 | 134 | 209 | 169 | 337 | 124 | 465 | 456 | 593 | 350 | 721 | 375 | 849 | 976 | 977 | 985 |
| 82 | 384 | 210 | 560 | 338 | 205 | 466 | 358 | 594 | 599 | 722 | 444 | 850 | 870 | 978 | 997 |
| 83 | 76 | 211 | 114 | 339 | 182 | 467 | 405 | 595 | 668 | 723 | 470 | 851 | 917 | 979 | 986 |
| 84 | 137 | 212 | 277 | 340 | 643 | 468 | 303 | 596 | 790 | 724 | 483 | 852 | 727 | 980 | 943 |
| 85 | 82 | 213 | 156 | 341 | 562 | 469 | 569 | 597 | 460 | 725 | 415 | 853 | 493 | 981 | 891 |
| 86 | 56 | 214 | 87 | 342 | 286 | 470 | 244 | 598 | 249 | 726 | 485 | 854 | 873 | 982 | 998 |
| 87 | 27 | 215 | 197 | 343 | 585 | 471 | 595 | 599 | 682 | 727 | 905 | 855 | 701 | 983 | 766 |
| 88 | 97 | 216 | 116 | 344 | 299 | 472 | 189 | 600 | 573 | 728 | 795 | 856 | 931 | 984 | 511 |

| | | | | | | | | | | | | | | | |
|---|---|---|---|---|---|---|---|---|---|---|---|---|---|---|---|
| 89 | 39 | 217 | 170 | 345 | 354 | 473 | 566 | 601 | 411 | 729 | 473 | 857 | 756 | 985 | 988 |
| 90 | 259 | 218 | 61 | 346 | 211 | 474 | 676 | 602 | 803 | 730 | 634 | 858 | 860 | 986 | 1001 |
| 91 | 84 | 219 | 531 | 347 | 401 | 475 | 361 | 603 | 789 | 731 | 744 | 859 | 499 | 987 | 951 |
| 92 | 138 | 220 | 525 | 348 | 185 | 476 | 706 | 604 | 709 | 732 | 852 | 860 | 731 | 988 | 1002 |
| 93 | 145 | 221 | 642 | 349 | 396 | 477 | 589 | 605 | 365 | 733 | 960 | 861 | 823 | 989 | 893 |
| 94 | 261 | 222 | 281 | 350 | 344 | 478 | 215 | 606 | 440 | 734 | 865 | 862 | 922 | 990 | 975 |
| 95 | 29 | 223 | 278 | 351 | 586 | 479 | 786 | 607 | 628 | 735 | 693 | 863 | 874 | 991 | 894 |
| 96 | 43 | 224 | 526 | 352 | 645 | 480 | 647 | 608 | 689 | 736 | 797 | 864 | 918 | 992 | 1009 |
| 97 | 98 | 225 | 177 | 353 | 593 | 481 | 348 | 609 | 374 | 737 | 906 | 865 | 502 | 993 | 955 |
| 98 | 515 | 226 | 293 | 354 | 535 | 482 | 419 | 610 | 423 | 738 | 715 | 866 | 933 | 994 | 1004 |
| 99 | 88 | 227 | 388 | 355 | 240 | 483 | 406 | 611 | 466 | 739 | 807 | 867 | 743 | 995 | 1010 |
| 100 | 140 | 228 | 91 | 356 | 206 | 484 | 464 | 612 | 793 | 740 | 474 | 868 | 760 | 996 | 957 |
| 101 | 30 | 229 | 584 | 357 | 95 | 485 | 680 | 613 | 250 | 741 | 636 | 869 | 881 | 997 | 983 |
| 102 | 146 | 230 | 769 | 358 | 327 | 486 | 801 | 614 | 371 | 742 | 694 | 870 | 494 | 998 | 958 |
| 103 | 71 | 231 | 198 | 359 | 564 | 487 | 362 | 615 | 481 | 743 | 254 | 871 | 702 | 999 | 987 |
| 104 | 262 | 232 | 172 | 360 | 800 | 488 | 590 | 616 | 574 | 744 | 717 | 872 | 921 | 1000 | 1012 |
| 105 | 265 | 233 | 120 | 361 | 402 | 489 | 409 | 617 | 413 | 745 | 575 | 873 | 501 | 1001 | 999 |
| 106 | 161 | 234 | 201 | 362 | 356 | 490 | 570 | 618 | 603 | 746 | 913 | 874 | 876 | 1002 | 1016 |
| 107 | 576 | 235 | 336 | 363 | 307 | 491 | 788 | 619 | 366 | 747 | 798 | 875 | 847 | 1003 | 767 |
| 108 | 45 | 236 | 62 | 364 | 301 | 492 | 597 | 620 | 468 | 748 | 811 | 876 | 992 | 1004 | 989 |
| 109 | 100 | 237 | 282 | 365 | 417 | 493 | 572 | 621 | 655 | 749 | 379 | 877 | 447 | 1005 | 1003 |
| 110 | 640 | 238 | 143 | 366 | 213 | 494 | 219 | 622 | 900 | 750 | 697 | 878 | 733 | 1006 | 990 |
| 111 | 51 | 239 | 103 | 367 | 568 | 495 | 311 | 623 | 805 | 751 | 431 | 879 | 827 | 1007 | 1005 |
| 112 | 148 | 240 | 178 | 368 | 832 | 496 | 708 | 624 | 615 | 752 | 607 | 880 | 934 | 1008 | 959 |
| 113 | 46 | 241 | 294 | 369 | 588 | 497 | 598 | 625 | 684 | 753 | 489 | 881 | 882 | 1009 | 1011 |
| 114 | 75 | 242 | 93 | 370 | 186 | 498 | 601 | 626 | 710 | 754 | 866 | 882 | 937 | 1010 | 1013 |
| 115 | 266 | 243 | 644 | 371 | 646 | 499 | 651 | 627 | 429 | 755 | 723 | 883 | 963 | 1011 | 895 |
| 116 | 273 | 244 | 202 | 372 | 404 | 500 | 421 | 628 | 794 | 756 | 486 | 884 | 747 | 1012 | 1006 |
| 117 | 517 | 245 | 592 | 373 | 227 | 501 | 792 | 629 | 252 | 757 | 908 | 885 | 505 | 1013 | 1014 |
| 118 | 104 | 246 | 323 | 374 | 896 | 502 | 802 | 630 | 373 | 758 | 718 | 886 | 855 | 1014 | 1017 |
| 119 | 162 | 247 | 392 | 375 | 594 | 503 | 611 | 631 | 605 | 759 | 813 | 887 | 924 | 1015 | 1018 |
| 120 | 53 | 248 | 297 | 376 | 418 | 504 | 602 | 632 | 848 | 760 | 476 | 888 | 734 | 1016 | 991 |
| 121 | 193 | 249 | 770 | 377 | 302 | 505 | 410 | 633 | 690 | 761 | 856 | 889 | 829 | 1017 | 1020 |
| 122 | 152 | 250 | 107 | 378 | 649 | 506 | 231 | 634 | 713 | 762 | 839 | 890 | 965 | 1018 | 1007 |
| 123 | 77 | 251 | 180 | 379 | 771 | 507 | 688 | 635 | 632 | 763 | 725 | 891 | 938 | 1019 | 1015 |
| 124 | 164 | 252 | 151 | 380 | 360 | 508 | 653 | 636 | 482 | 764 | 698 | 892 | 884 | 1020 | 1019 |
| 125 | 768 | 253 | 209 | 381 | 539 | 509 | 248 | 637 | 806 | 765 | 914 | 893 | 506 | 1021 | 1021 |
| 126 | 268 | 254 | 284 | 382 | 111 | 510 | 369 | 638 | 427 | 766 | 752 | 894 | 749 | 1022 | 1022 |
| 127 | 274 | 255 | 648 | 383 | 331 | 511 | 190 | 639 | 904 | 767 | 868 | 895 | 945 | 1023 | 1023 |

**2.** Procédé selon la revendication 1, dans lequel la seconde séquence est préstockée.

**3.** Procédé selon la revendication 1 ou 2, dans lequel les K bits à coder comprennent un bit de contrôle de redondance cyclique.

**4.** Procédé selon l'une quelconque des revendications 1 à 3, dans lequel les K bits à coder comprennent un bit de contrôle de parité.

**5.** Procédé selon l'une quelconque des revendications 1 à 4, dans lequel les numéros de séquence des N canaux polarisés sont de 0 à N-1.

**6.** Appareil de codage (300), comprenant :

une unité d'obtention (601) configurée pour obtenir une première séquence utilisée pour coder K bits à coder, K étant un entier positif, dans lequel la première séquence comprend des numéros de séquence de N canaux polarisés, les numéros de séquence des N canaux polarisés sont agencés dans la première séquence sur la base de la fiabilité des N canaux polarisés, N est une longueur de code mère d'un code polaire, $N = 2^n$, n est un entier positif, et $K \leq N$, dans lequel la première séquence est la totalité ou un sous-ensemble d'une seconde séquence, la seconde séquence comprend des numéros de séquence de $N_{max}$ canaux polarisés, les numéros de séquence des $N_{max}$ canaux polarisés sont agencés dans la seconde séquence sur la base de la fiabilité des $N_{max}$ canaux polarisés, un ordre dans lequel les numéros de séquence des canaux polarisés dans la première séquence sont agencés est cohérent avec un ordre dans lequel les numéros de séquence inférieurs à N dans les numéros de séquence des canaux polarisés dans la seconde séquence sont agencés, $N \geq 64$, $N_{max}$ est un entier positif, $N_{max} \geq N$ ;
une unité de sélection (602) configurée pour sélectionner des numéros de séquence de K canaux polarisés à partir de la première séquence sur la base d'un ordre de fiabilité ; et
une unité de codage (603) configurée pour placer les K bits à coder sur la base des numéros de séquence sélectionnés des K canaux polarisés, et exécuter un codage de code polaire sur les K bits à coder,
dans lequel $N_{max}$=1 024, la seconde séquence est la séquence du tableau Q11,
**caractérisé en ce que** le tableau Q11 est :

| Fiabilité ou numéro de séquence de fiabilité | Numéro de séquence de canal polarisé | Fiabilité ou numéro de séquence de fiabilité | Numéro de séquence de canal polarisé | Fiabilité ou numéro de séquence de fiabilité | Numéro de séquence de canal polarisé | Fiabilité ou numéro de séquence de fiabilité | Numéro de séquence de canal polarisé | Fiabilité ou numéro de séquence de fiabilité | Numéro de séquence de canal polarisé | Fiabilité ou numéro de séquence de fiabilité | Numéro de séquence de canal polarisé | Fiabilité ou numéro de séquence de fiabilité | Numéro de séquence de canal polarisé | Fiabilité ou numéro de séquence de fiabilité | Numéro de séquence de canal polarisé |
|---|---|---|---|---|---|---|---|---|---|---|---|---|---|---|---|
| 0 | 0 | 128 | 518 | 256 | 94 | 384 | 214 | 512 | 364 | 640 | 414 | 768 | 819 | 896 | 966 |
| 1 | 1 | 129 | 54 | 257 | 204 | 385 | 309 | 513 | 654 | 641 | 223 | 769 | 814 | 897 | 755 |
| 2 | 2 | 130 | 83 | 258 | 298 | 386 | 188 | 514 | 659 | 642 | 663 | 770 | 439 | 898 | 859 |

| 3 | 4 | 131 | 57 | 259 | 400 | 387 | 449 | 515 | 335 | 643 | 692 | 771 | 929 | 899 | 940 |
|---|---|---|---|---|---|---|---|---|---|---|---|---|---|---|---|
| 4 | 8 | 132 | 521 | 260 | 608 | 388 | 217 | 516 | 480 | 644 | 835 | 772 | 490 | 900 | 830 |
| 5 | 16 | 133 | 112 | 261 | 352 | 389 | 408 | 517 | 315 | 645 | 619 | 773 | 623 | 901 | 911 |
| 6 | 32 | 134 | 135 | 262 | 325 | 390 | 609 | 518 | 221 | 646 | 472 | 774 | 671 | 902 | 871 |
| 7 | 3 | 135 | 78 | 263 | 533 | 391 | 596 | 519 | 370 | 647 | 455 | 775 | 739 | 903 | 639 |
| 8 | 5 | 136 | 289 | 264 | 155 | 392 | 551 | 520 | 613 | 648 | 796 | 776 | 916 | 904 | 888 |
| 9 | 64 | 137 | 194 | 265 | 210 | 393 | 650 | 521 | 422 | 649 | 809 | 777 | 463 | 905 | 479 |
| 10 | 9 | 138 | 85 | 266 | 305 | 394 | 229 | 522 | 425 | 650 | 714 | 778 | 843 | 906 | 946 |
| 11 | 6 | 139 | 276 | 267 | 547 | 395 | 159 | 523 | 451 | 651 | 721 | 779 | 381 | 907 | 750 |
| 12 | 17 | 140 | 522 | 268 | 300 | 396 | 420 | 524 | 614 | 652 | 837 | 780 | 497 | 908 | 969 |
| 13 | 10 | 141 | 58 | 269 | 109 | 397 | 310 | 525 | 543 | 653 | 716 | 781 | 930 | 909 | 508 |
| 14 | 18 | 142 | 168 | 270 | 184 | 398 | 541 | 526 | 235 | 654 | 864 | 782 | 821 | 910 | 861 |
| 15 | 128 | 143 | 139 | 271 | 534 | 399 | 773 | 527 | 412 | 655 | 810 | 783 | 726 | 911 | 757 |
| 16 | 12 | 144 | 99 | 272 | 537 | 400 | 610 | 528 | 343 | 656 | 606 | 784 | 961 | 912 | 970 |
| 17 | 33 | 145 | 86 | 273 | 115 | 401 | 657 | 529 | 372 | 657 | 912 | 785 | 872 | 913 | 919 |
| 18 | 65 | 146 | 60 | 274 | 167 | 402 | 333 | 530 | 775 | 658 | 722 | 786 | 492 | 914 | 875 |
| 19 | 20 | 147 | 280 | 275 | 225 | 403 | 119 | 531 | 317 | 659 | 696 | 787 | 631 | 915 | 862 |
| 20 | 256 | 148 | 89 | 276 | 326 | 404 | 600 | 532 | 222 | 660 | 377 | 788 | 729 | 916 | 758 |
| 21 | 34 | 149 | 290 | 277 | 306 | 405 | 339 | 533 | 426 | 661 | 435 | 789 | 700 | 917 | 948 |
| 22 | 24 | 150 | 529 | 278 | 772 | 406 | 218 | 534 | 453 | 662 | 817 | 790 | 443 | 918 | 977 |
| 23 | 36 | 151 | 524 | 279 | 157 | 407 | 368 | 535 | 237 | 663 | 319 | 791 | 741 | 919 | 923 |
| 24 | 7 | 152 | 196 | 280 | 656 | 408 | 652 | 536 | 559 | 664 | 621 | 792 | 845 | 920 | 972 |
| 25 | 129 | 153 | 141 | 281 | 329 | 409 | 230 | 537 | 833 | 665 | 812 | 793 | 920 | 921 | 761 |
| 26 | 66 | 154 | 101 | 282 | 110 | 410 | 391 | 538 | 804 | 666 | 484 | 794 | 382 | 922 | 877 |
| 27 | 512 | 155 | 147 | 283 | 117 | 411 | 313 | 539 | 712 | 667 | 430 | 795 | 822 | 923 | 952 |
| 28 | 11 | 156 | 176 | 284 | 212 | 412 | 450 | 540 | 834 | 668 | 838 | 796 | 851 | 924 | 495 |
| 29 | 40 | 157 | 142 | 285 | 171 | 413 | 542 | 541 | 661 | 669 | 667 | 797 | 730 | 925 | 703 |
| 30 | 68 | 158 | 530 | 286 | 776 | 414 | 334 | 542 | 808 | 670 | 488 | 798 | 498 | 926 | 935 |
| 31 | 130 | 159 | 321 | 287 | 330 | 415 | 233 | 543 | 779 | 671 | 239 | 799 | 880 | 927 | 978 |
| 32 | 19 | 160 | 31 | 288 | 226 | 416 | 555 | 544 | 617 | 672 | 378 | 800 | 742 | 928 | 883 |
| 33 | 13 | 161 | 200 | 289 | 549 | 417 | 774 | 545 | 604 | 673 | 459 | 801 | 445 | 929 | 762 |
| 34 | 48 | 162 | 90 | 290 | 538 | 418 | 175 | 546 | 433 | 674 | 622 | 802 | 471 | 930 | 503 |
| 35 | 14 | 163 | 545 | 291 | 387 | 419 | 123 | 547 | 720 | 675 | 627 | 803 | 635 | 931 | 925 |
| 36 | 72 | 164 | 292 | 292 | 308 | 420 | 658 | 548 | 816 | 676 | 437 | 804 | 932 | 932 | 878 |
| 37 | 257 | 165 | 322 | 293 | 216 | 421 | 612 | 549 | 836 | 677 | 380 | 805 | 687 | 933 | 735 |
| 38 | 21 | 166 | 532 | 294 | 416 | 422 | 341 | 550 | 347 | 678 | 818 | 806 | 903 | 934 | 993 |
| 39 | 132 | 167 | 263 | 295 | 271 | 423 | 777 | 551 | 897 | 679 | 461 | 807 | 825 | 935 | 885 |
| 40 | 35 | 168 | 149 | 296 | 279 | 424 | 220 | 552 | 243 | 680 | 496 | 808 | 500 | 936 | 939 |
| 41 | 258 | 169 | 102 | 297 | 158 | 425 | 314 | 553 | 662 | 681 | 669 | 809 | 846 | 937 | 994 |

| | | | | | | | | | | | | | | | |
|---|---|---|---|---|---|---|---|---|---|---|---|---|---|---|---|
| 42 | 26 | 170 | 105 | 298 | 337 | 426 | 424 | 554 | 454 | 682 | 679 | 810 | 745 | 938 | 980 |
| 43 | 513 | 171 | 304 | 299 | 550 | 427 | 395 | 555 | 318 | 683 | 724 | 811 | 826 | 939 | 926 |
| 44 | 80 | 172 | 296 | 300 | 672 | 428 | 673 | 556 | 675 | 684 | 841 | 812 | 732 | 940 | 764 |
| 45 | 37 | 173 | 163 | 301 | 118 | 429 | 583 | 557 | 618 | 685 | 629 | 813 | 446 | 941 | 941 |
| 46 | 25 | 174 | 92 | 302 | 332 | 430 | 355 | 558 | 898 | 686 | 351 | 814 | 962 | 942 | 967 |
| 47 | 22 | 175 | 47 | 303 | 579 | 431 | 287 | 559 | 781 | 687 | 467 | 815 | 936 | 943 | 886 |
| 48 | 136 | 176 | 267 | 304 | 540 | 432 | 183 | 560 | 376 | 688 | 438 | 816 | 475 | 944 | 831 |
| 49 | 260 | 177 | 385 | 305 | 389 | 433 | 234 | 561 | 428 | 689 | 737 | 817 | 853 | 945 | 947 |
| 50 | 264 | 178 | 546 | 306 | 173 | 434 | 125 | 562 | 665 | 690 | 251 | 818 | 867 | 946 | 507 |
| 51 | 38 | 179 | 324 | 307 | 121 | 435 | 557 | 563 | 736 | 691 | 462 | 819 | 637 | 947 | 889 |
| 52 | 514 | 180 | 208 | 308 | 553 | 436 | 660 | 564 | 567 | 692 | 442 | 820 | 907 | 948 | 984 |
| 53 | 96 | 181 | 386 | 309 | 199 | 437 | 616 | 565 | 840 | 693 | 441 | 821 | 487 | 949 | 751 |
| 54 | 67 | 182 | 150 | 310 | 784 | 438 | 342 | 566 | 625 | 694 | 469 | 822 | 695 | 950 | 942 |
| 55 | 41 | 183 | 153 | 311 | 179 | 439 | 316 | 567 | 238 | 695 | 247 | 823 | 746 | 951 | 996 |
| 56 | 144 | 184 | 165 | 312 | 228 | 440 | 241 | 568 | 359 | 696 | 683 | 824 | 828 | 952 | 971 |
| 57 | 28 | 185 | 106 | 313 | 338 | 441 | 778 | 569 | 457 | 697 | 842 | 825 | 753 | 953 | 890 |
| 58 | 69 | 186 | 55 | 314 | 312 | 442 | 563 | 570 | 399 | 698 | 738 | 826 | 854 | 954 | 509 |
| 59 | 42 | 187 | 328 | 315 | 704 | 443 | 345 | 571 | 787 | 699 | 899 | 827 | 857 | 955 | 949 |
| 60 | 516 | 188 | 536 | 316 | 390 | 444 | 452 | 572 | 591 | 700 | 670 | 828 | 504 | 956 | 973 |
| 61 | 49 | 189 | 577 | 317 | 174 | 445 | 397 | 573 | 678 | 701 | 783 | 829 | 799 | 957 | 1000 |
| 62 | 74 | 190 | 548 | 318 | 554 | 446 | 403 | 574 | 434 | 702 | 849 | 830 | 255 | 958 | 892 |
| 63 | 272 | 191 | 113 | 319 | 581 | 447 | 207 | 575 | 677 | 703 | 820 | 831 | 964 | 959 | 950 |
| 64 | 160 | 192 | 154 | 320 | 393 | 448 | 674 | 576 | 349 | 704 | 728 | 832 | 909 | 960 | 863 |
| 65 | 520 | 193 | 79 | 321 | 283 | 449 | 558 | 577 | 245 | 705 | 928 | 833 | 719 | 961 | 759 |
| 66 | 288 | 194 | 269 | 322 | 122 | 450 | 785 | 578 | 458 | 706 | 791 | 834 | 477 | 962 | 1008 |
| 67 | 528 | 195 | 108 | 323 | 448 | 451 | 432 | 579 | 666 | 707 | 367 | 835 | 915 | 963 | 510 |
| 68 | 192 | 196 | 578 | 324 | 353 | 452 | 357 | 580 | 620 | 708 | 901 | 836 | 638 | 964 | 979 |
| 69 | 544 | 197 | 224 | 325 | 561 | 453 | 187 | 581 | 363 | 709 | 630 | 837 | 748 | 965 | 953 |
| 70 | 70 | 198 | 166 | 326 | 203 | 454 | 236 | 582 | 127 | 710 | 685 | 838 | 944 | 966 | 763 |
| 71 | 44 | 199 | 519 | 327 | 63 | 455 | 664 | 583 | 191 | 711 | 844 | 839 | 869 | 967 | 974 |
| 72 | 131 | 200 | 552 | 328 | 340 | 456 | 624 | 584 | 782 | 712 | 633 | 840 | 491 | 968 | 954 |
| 73 | 81 | 201 | 195 | 329 | 394 | 457 | 587 | 585 | 407 | 713 | 711 | 841 | 699 | 969 | 879 |
| 74 | 50 | 202 | 270 | 330 | 527 | 458 | 780 | 586 | 436 | 714 | 253 | 842 | 754 | 970 | 981 |
| 75 | 73 | 203 | 641 | 331 | 582 | 459 | 705 | 587 | 626 | 715 | 691 | 843 | 858 | 971 | 982 |
| 76 | 15 | 204 | 523 | 332 | 556 | 460 | 126 | 588 | 571 | 716 | 824 | 844 | 478 | 972 | 927 |
| 77 | 320 | 205 | 275 | 333 | 181 | 461 | 242 | 589 | 465 | 717 | 902 | 845 | 968 | 973 | 995 |
| 78 | 133 | 206 | 580 | 334 | 295 | 462 | 565 | 590 | 681 | 718 | 686 | 846 | 383 | 974 | 765 |
| 79 | 52 | 207 | 291 | 335 | 285 | 463 | 398 | 591 | 246 | 719 | 740 | 847 | 910 | 975 | 956 |
| 80 | 23 | 208 | 59 | 336 | 232 | 464 | 346 | 592 | 707 | 720 | 850 | 848 | 815 | 976 | 887 |

| | | | | | | | | | | | | | | | |
|---|---|---|---|---|---|---|---|---|---|---|---|---|---|---|---|
| 81 | 134 | 209 | 169 | 337 | 124 | 465 | 456 | 593 | 350 | 721 | 375 | 849 | 976 | 977 | 985 |
| 82 | 384 | 210 | 560 | 338 | 205 | 466 | 358 | 594 | 599 | 722 | 444 | 850 | 870 | 978 | 997 |
| 83 | 76 | 211 | 114 | 339 | 182 | 467 | 405 | 595 | 668 | 723 | 470 | 851 | 917 | 979 | 986 |
| 84 | 137 | 212 | 277 | 340 | 643 | 468 | 303 | 596 | 790 | 724 | 483 | 852 | 727 | 980 | 943 |
| 85 | 82 | 213 | 156 | 341 | 562 | 469 | 569 | 597 | 460 | 725 | 415 | 853 | 493 | 981 | 891 |
| 86 | 56 | 214 | 87 | 342 | 286 | 470 | 244 | 598 | 249 | 726 | 485 | 854 | 873 | 982 | 998 |
| 87 | 27 | 215 | 197 | 343 | 585 | 471 | 595 | 599 | 682 | 727 | 905 | 855 | 701 | 983 | 766 |
| 88 | 97 | 216 | 116 | 344 | 299 | 472 | 189 | 600 | 573 | 728 | 795 | 856 | 931 | 984 | 511 |
| 89 | 39 | 217 | 170 | 345 | 354 | 473 | 566 | 601 | 411 | 729 | 473 | 857 | 756 | 985 | 988 |
| 90 | 259 | 218 | 61 | 346 | 211 | 474 | 676 | 602 | 803 | 730 | 634 | 858 | 860 | 986 | 1001 |
| 91 | 84 | 219 | 531 | 347 | 401 | 475 | 361 | 603 | 789 | 731 | 744 | 859 | 499 | 987 | 951 |
| 92 | 138 | 220 | 525 | 348 | 185 | 476 | 706 | 604 | 709 | 732 | 852 | 860 | 731 | 988 | 1002 |
| 93 | 145 | 221 | 642 | 349 | 396 | 477 | 589 | 605 | 365 | 733 | 960 | 861 | 823 | 989 | 893 |
| 94 | 261 | 222 | 281 | 350 | 344 | 478 | 215 | 606 | 440 | 734 | 865 | 862 | 922 | 990 | 975 |
| 95 | 29 | 223 | 278 | 351 | 586 | 479 | 786 | 607 | 628 | 735 | 693 | 863 | 874 | 991 | 894 |
| 96 | 43 | 224 | 526 | 352 | 645 | 480 | 647 | 608 | 689 | 736 | 797 | 864 | 918 | 992 | 1009 |
| 97 | 98 | 225 | 177 | 353 | 593 | 481 | 348 | 609 | 374 | 737 | 906 | 865 | 502 | 993 | 955 |
| 98 | 515 | 226 | 293 | 354 | 535 | 482 | 419 | 610 | 423 | 738 | 715 | 866 | 933 | 994 | 1004 |
| 99 | 88 | 227 | 388 | 355 | 240 | 483 | 406 | 611 | 466 | 739 | 807 | 867 | 743 | 995 | 1010 |
| 100 | 140 | 228 | 91 | 356 | 206 | 484 | 464 | 612 | 793 | 740 | 474 | 868 | 760 | 996 | 957 |
| 101 | 30 | 229 | 584 | 357 | 95 | 485 | 680 | 613 | 250 | 741 | 636 | 869 | 881 | 997 | 983 |
| 102 | 146 | 230 | 769 | 358 | 327 | 486 | 801 | 614 | 371 | 742 | 694 | 870 | 494 | 998 | 958 |
| 103 | 71 | 231 | 198 | 359 | 564 | 487 | 362 | 615 | 481 | 743 | 254 | 871 | 702 | 999 | 987 |
| 104 | 262 | 232 | 172 | 360 | 800 | 488 | 590 | 616 | 574 | 744 | 717 | 872 | 921 | 1000 | 1012 |
| 105 | 265 | 233 | 120 | 361 | 402 | 489 | 409 | 617 | 413 | 745 | 575 | 873 | 501 | 1001 | 999 |
| 106 | 161 | 234 | 201 | 362 | 356 | 490 | 570 | 618 | 603 | 746 | 913 | 874 | 876 | 1002 | 1016 |
| 107 | 576 | 235 | 336 | 363 | 307 | 491 | 788 | 619 | 366 | 747 | 798 | 875 | 847 | 1003 | 767 |
| 108 | 45 | 236 | 62 | 364 | 301 | 492 | 597 | 620 | 468 | 748 | 811 | 876 | 992 | 1004 | 989 |
| 109 | 100 | 237 | 282 | 365 | 417 | 493 | 572 | 621 | 655 | 749 | 379 | 877 | 447 | 1005 | 1003 |
| 110 | 640 | 238 | 143 | 366 | 213 | 494 | 219 | 622 | 900 | 750 | 697 | 878 | 733 | 1006 | 990 |
| 111 | 51 | 239 | 103 | 367 | 568 | 495 | 311 | 623 | 805 | 751 | 431 | 879 | 827 | 1007 | 1005 |
| 112 | 148 | 240 | 178 | 368 | 832 | 496 | 708 | 624 | 615 | 752 | 607 | 880 | 934 | 1008 | 959 |
| 113 | 46 | 241 | 294 | 369 | 588 | 497 | 598 | 625 | 684 | 753 | 489 | 881 | 882 | 1009 | 1011 |
| 114 | 75 | 242 | 93 | 370 | 186 | 498 | 601 | 626 | 710 | 754 | 866 | 882 | 937 | 1010 | 1013 |
| 115 | 266 | 243 | 644 | 371 | 646 | 499 | 651 | 627 | 429 | 755 | 723 | 883 | 963 | 1011 | 895 |
| 116 | 273 | 244 | 202 | 372 | 404 | 500 | 421 | 628 | 794 | 756 | 486 | 884 | 747 | 1012 | 1006 |
| 117 | 517 | 245 | 592 | 373 | 227 | 501 | 792 | 629 | 252 | 757 | 908 | 885 | 505 | 1013 | 1014 |
| 118 | 104 | 246 | 323 | 374 | 896 | 502 | 802 | 630 | 373 | 758 | 718 | 886 | 855 | 1014 | 1017 |
| 119 | 162 | 247 | 392 | 375 | 594 | 503 | 611 | 631 | 605 | 759 | 813 | 887 | 924 | 1015 | 1018 |

| | | | | | | | | | | | | | | | |
|---|---|---|---|---|---|---|---|---|---|---|---|---|---|---|---|
| 120 | 53 | 248 | 297 | 376 | 418 | 504 | 602 | 632 | 848 | 760 | 476 | 888 | 734 | 1016 | 991 |
| 121 | 193 | 249 | 770 | 377 | 302 | 505 | 410 | 633 | 690 | 761 | 856 | 889 | 829 | 1017 | 1020 |
| 122 | 152 | 250 | 107 | 378 | 649 | 506 | 231 | 634 | 713 | 762 | 839 | 890 | 965 | 1018 | 1007 |
| 123 | 77 | 251 | 180 | 379 | 771 | 507 | 688 | 635 | 632 | 763 | 725 | 891 | 938 | 1019 | 1015 |
| 124 | 164 | 252 | 151 | 380 | 360 | 508 | 653 | 636 | 482 | 764 | 698 | 892 | 884 | 1020 | 1019 |
| 125 | 768 | 253 | 209 | 381 | 539 | 509 | 248 | 637 | 806 | 765 | 914 | 893 | 506 | 1021 | 1021 |
| 126 | 268 | 254 | 284 | 382 | 111 | 510 | 369 | 638 | 427 | 766 | 752 | 894 | 749 | 1022 | 1022 |
| 127 | 274 | 255 | 648 | 383 | 331 | 511 | 190 | 639 | 904 | 767 | 868 | 895 | 945 | 1023 | 1023 |

7. Appareil selon la revendication 6, dans lequel la seconde séquence est préstockée.

8. Appareil selon la revendication 6 ou 7, dans lequel les K bits à coder comprennent un bit de contrôle de redondance cyclique.

9. Appareil selon l'une quelconque des revendications 6 à 8, dans lequel les K bits à coder comprennent un bit de contrôle de parité.

10. Appareil selon l'une quelconque des revendications 6 à 9, dans lequel les numéros de séquence des N canaux polarisés sont de 0 à N-1.

11. Appareil selon l'une quelconque des revendications 6 à 10, dans lequel l'appareil est une puce ou ou un circuit intégré.

12. Dispositif sans fil, comprenant l'appareil de codage (300) selon l'une quelconque des revendications 6 à 10, un modulateur (310) et un émetteur-récepteur,

dans lequel le modulateur (310) est configuré pour moduler une séquence de bits obtenue après codage polaire pour obtenir une séquence modulée, et
l'émetteur-récepteur (320) est configuré pour envoyer la séquence modulée.

13. Dispositif sans fil selon la revendication 12, dans lequel le dispositif sans fil est un terminal ou un dispositif de réseau.

14. Support de stockage informatique, dans lequel le support de stockage stocke un programme informatique, et le programme informatique comprend des instructions qui, lorsque le programme est exécuté par un ordinateur, amènent l'ordinateur à exécuter le procédé selon l'une quelconque des revendications 1 à 5.

15. Produit de programme informatique comprenant des instructions qui, lorsque le programme est exécuté par un ordinateur, amènent l'ordinateur à mettre en œuvre le procédé selon l'une quelconque des revendications 1 à 5.

FIG. 1

| Obtain a first sequence used to encode K to-be-encoded bits | 201 |

| Select sequence numbers of K polarized channels from the first sequence in descending order of reliabilities | 202 |

| Place the to-be-encoded bits based on the selected sequence numbers of the K polarized channels, and perform polar code encoding on the to-be-encoded bits | 203 |

FIG. 2

301
300
Input interface
circuit

302

Logic circuit

303

Output
interface circuit

Polar code
encoding apparatus

310
Modulator

320
Transceiver

330

FIG. 3

402
300

Processor

Memory

401

Polar code encoding
apparatus

FIG. 4

502    300

Processor

Memory

501

Polar code encoding
apparatus

FIG. 5

300

Polar code encoding
apparatus

601

Obtaining unit

602

Selection unit

603

Encoding unit

FIG. 6